(19) Europäisches Patentamt
European Patent Office
Office européen des brevets

(11) EP 4 152 427 B1

(12) **EUROPEAN PATENT SPECIFICATION**

(45) Date of publication and mention of the grant of the patent:
**22.05.2024 Bulletin 2024/21**

(21) Application number: **22163793.7**

(22) Date of filing: **23.03.2022**

(51) International Patent Classification (IPC):
***C07F 1/12*** (2006.01) ***H10K 85/30*** (2023.01)
*H10K 50/11* (2023.01) *H10K 50/12* (2023.01)
*H10K 59/32* (2023.01) *H10K 85/60* (2023.01)

(52) Cooperative Patent Classification (CPC):
**H10K 85/371;** C07F 1/005; C07F 5/022; C07F 5/027; C07F 7/0816; H10K 50/11; H10K 50/121; H10K 59/32; H10K 85/615; H10K 85/622; H10K 85/623; H10K 85/626; H10K 85/631; H10K 85/633; H10K 85/636; (Cont.)

(54) **ORGANIC LIGHT-EMITTING DEVICE**

ORGANISCHE LICHTEMITTIERENDE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.09.2021 KR 20210125203**

(43) Date of publication of application:
**22.03.2023 Bulletin 2023/12**

(73) Proprietors:
- **Samsung Electronics Co., Ltd.**
  **Gyeonggi-do, 16677 (KR)**
- **Ewha University-Industry Collaboration Foundation**
  **Seoul 03760 (KR)**

(72) Inventors:
- **JUNG, Yongsik**
  **16678 Suwon-si (KR)**
- **YOU, Youngmin**
  **03760 Seodaemun-gu (KR)**
- **HEO, Seunga**
  **03760 Seodaemun-gu (KR)**
- **KIM, Joonghyuk**
  **16678 Suwon-si (KR)**
- **CHOI, Hyeonho**
  **16678 Suwon-si (KR)**
- **KIM, Inkoo**
  **16678 Suwon-si (KR)**
- **BAE, Hyejin**
  **16678 Suwon-si (KR)**

(74) Representative: **Elkington and Fife LLP**
**Prospect House**
**8 Pembroke Road**
**Sevenoaks, Kent TN13 1XR (GB)**

(56) References cited:
**EP-A2- 3 772 758** **US-A1- 2021 288 271**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
H10K 85/654; H10K 85/6572; H10K 85/6574;
H10K 85/6576; H10K 2101/20; H10K 2101/30;
H10K 2101/40; H10K 2101/90

**Description**

FIELD OF THE INVENTION

The present disclosure relates to a composition that may satisfy certain conditions and an organic light-emitting device including the same.

BACKGROUND OF THE INVENTION

Organic light-emitting devices (OLEDs) are self-emissive devices that, as compared with conventional devices, have wide viewing angles, high contrast ratios, short response times, excellent brightness, driving voltage, and response speed characteristics, and OLEDs can produce full-color images.

OLEDs include an anode, a cathode, and an organic layer located between the anode and the cathode and including an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating light.

US2021288271 (A1) discloses OLED devices comprising an emmision layer comprising gold, silver, and copper complexes as sensitizers.

SUMMARY OF THE INVENTION

One or more embodiments include a composition that may satisfy certain conditions and an organic light-emitting device including the same.

Additional aspects will be set forth in part in the description which follows and, in part, will be apparent from the description, or may be learned by practice of the presented embodiments of the disclosure.

According to an aspect, an organic light-emitting device includes a first electrode; a second electrode; and an organic layer located between the first electrode and the second electrode and including an emission layer, wherein the emission layer includes a host, a sensitizer, and an emitter, the host, the sensitizer, and the emitter are different from each other, and the sensitizer is represented by Formula 1:

Formula 1 $M_1(L_1)(L_2)$

wherein, in Formula 1,

$M_1$ is Au, Ag, or Cu,
$L_1$ is a ligand represented by Formula 2-1 or Formula 2-2, and
$L_2$ is a ligand represented by one of Formula 3-3:

Formula 2-1

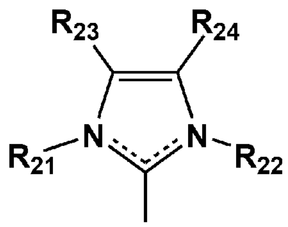

Formula 2-2

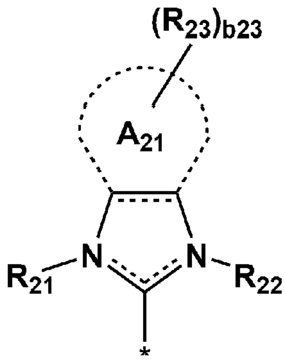

Formula 3-3

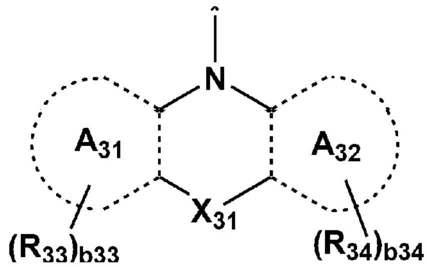

wherein, in Formulae 2-1, 2-2, and 3-3,

$A_{21}$, $A_{31}$, and $A_{32}$ are each independently a monocyclic or polycyclic $C_5$-$C_{30}$ carbocyclic group or a monocyclic or polycyclic $C_1$-$C_{30}$ heterocyclic group,
$X_{31}$ is a single bond, O, S, $N(R_{36})$, $C(R_{36})=C(R_{37})$, $[C(R_{36})(R_{37})]_{n31}$, or $[Si(R_{36})(R_{37})]_{n31}$, and n31 is 1 or 2,
$R_{21}$ and $R_{22}$ are each independently a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group,
$R_{23}$, $R_{24}$, $R_{36}$ and $R_{37}$ are each independently hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, - $C(Q_1)(Q_2)(Q_3)$, $-B(Q_1)(Q_2)$, $-N(Q_1)(Q_2)$, $-P(Q_1)(Q_2)$, $-S(=O)(Q_1)$, - $S(=O)_2(Q_1)$, $-P(=O)(Q_1)(Q_2)$, or $-P(=S)(Q_1)(Q_2)$, and $R_{36}$ and $R_{37}$ are optionally linked to each other to form a substituted or unsubstituted $C_5$-$C_{30}$ carbocyclic group or a substituted or unsubstituted $C_1$-$C_{30}$ heterocyclic group,
$R_{33}$ and $R_{34}$ are each independently a substituted $C_1$-$C_{60}$ alkyl group, and b23 and b33 are each independently 1, 2, 3, 4, 5, 6, 7, 8, 9, or 1C b34 is 2, 3, 4, 5, 6, 7, 8, 9, or 10,
wherein $Q_1$ to $Q_3$ are each independently hydrogen, deuterium, -F, -Cl, - Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each of which is unsubstituted or substituted with at least one of deuterium, -F, a cyano group, a $C_1$-$C_{20}$ alkyl group, a $C_6$-$C_{30}$ aryl group, or a combination thereof, and
each * indicates a binding site to $M_1$ in Formula 1.

According to another aspect, an organic light-emitting device includes: a first electrode; a second electrode; m emission units stacked between the first electrode and the second electrode, each including at least one emission layer; and m-1 charge generating layers located between each two adjacent emission units from among the m emission units,

wherein each of the m-1 charge generating layers includes an n-type charge generating layer and a p-type charge generating layer, wherein m is an integer of 2 or greater, a maximum emission wavelength of light emitted from at least one of the m emission units may differ from a maximum emission wavelength of light emitted from at least one of the other emission units, at least one of the m emission layers includes a host, a dopant, and a sensitizer, the host, the sensitizer, and the emitter are different from each other, and the sensitizer is represented by Formula 1.

According to still another aspect, an organic light-emitting device includes: a first electrode; a second electrode; and m emission layers located between the first electrode and the second electrode, wherein m is an integer of 2 or greater, a maximum emission wavelength of light emitted from at least one of the m emission layers differs from a maximum emission wavelength of light emitted from at least one of the other emission layers, at least one of the m emission layers includes a host, a sensitizer, and an emitter, the host, the sensitizer, and the emitter are different from each other, and the sensitizer is represented by Formula 1.

## BRIEF DESCRIPTION OF THE DRAWINGS

The above and other aspects, features, and advantages of certain exemplary embodiments of the disclosure will be more apparent from the following description taken in conjunction with the accompanying drawings, in which:

FIG. 1 is a schematic view of an organic light-emitting device 10 according to an embodiment;
FIG. 2 is a schematic view of an organic light-emitting device 100 according to an embodiment; and
FIG. 3 is a schematic view of an organic light-emitting device 200 according to an embodiment.

## DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the descriptions set forth herein. Accordingly, the exemplary embodiments are merely described below, by referring to the figures, to explain particular aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not

be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 eV" of the vacuum level, while when the work function or the HOMO energy level is referred to be "shallow," "low," or "small," the work function or HOMO energy level has a small absolute value based on "0 eV" of the vacuum level.

Description of FIG. 1

FIG. 1 is a schematic view of an organic light-emitting device 10 according to an exemplary embodiment. Hereinafter a structure and a method of manufacturing the organic light-emitting device 10, according to an embodiment, will be described with reference to FIG. 1.

In FIG. 1, an organic light-emitting device 10 includes a first electrode 11, a second electrode 19 facing the first electrode 11, and an organic layer 10A located between the first electrode 11 and the second electrode 19.

In FIG. 1, the organic layer 10A includes an emission layer 15, a hole transport region 12 is located between the first electrode 11 and an emission layer 15, and an electron transport region 17 is located between the emission layer 15 and the second electrode 19.

A substrate may be additionally disposed or located under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

First electrode 11

The first electrode 11 may be produced by depositing or sputtering, onto the substrate, a material for forming the first electrode 11. The first electrode 11 may be an anode. The material for forming the first electrode 11 may be selected from materials with a high work function for easy hole injection.

The first electrode 11 may be a reflective electrode, a semi-transmissive electrode, or a transmissive electrode. When the first electrode 110 is a transmissive electrode, a material for forming the first electrode 110 may be indium tin oxide (ITO), indium zinc oxide (IZO), tin oxide ($SnO_2$), zinc oxide (ZnO), or a combination thereof, but embodiments are not limited thereto. In some embodiments, when the first electrode 110 is a semi-transmissive electrode or a reflective electrode, as a material for forming the first electrode 110, at least one of magnesium (Mg), silver (Ag), aluminum (Al), aluminum-lithium (Al-Li), calcium (Ca), magnesium-indium (Mg-In), magnesium-silver (Mg-Ag), or a combination thereof may be used, but embodiments are not limited thereto.

The first electrode 11 may have a single-layered structure or a multi-layered structure including a plurality of layers.

Emission layer 15

The emission layer may include a host, a sensitizer, and an emitter, and the host, the sensitizer, and the emitter may be different from each other.

Sensitizer

The sensitizer is represented by Formula 1:

Formula 1 $M_1(L_1)(L_2)$

wherein, in Formula 1,

$M_1$ is Au, Ag, or Cu,
$L_1$ is a ligand represented by Formula 2-1 or Formula 2-2, and
$L_2$ is a ligand represented by Formula 3-3:

Formula 2-1

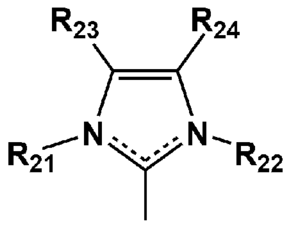

Formula 2-2

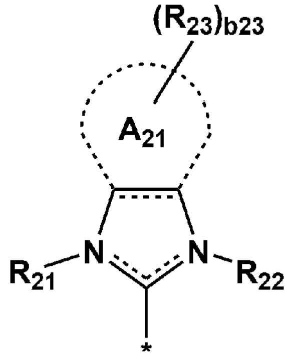

Formula 3-3

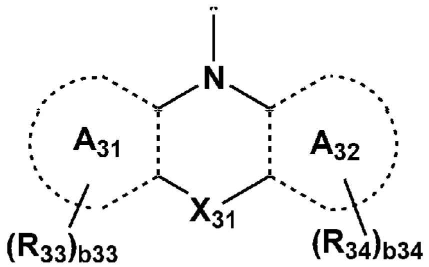

For example, in Formula 1, $M_1$ may be Au.

In Formulae 2-2, and 3-3, $A_{21}$, $A_{31}$, and $A_{32}$ are each independently a monocyclic or polycyclic $C_5$-$C_{30}$ carbocyclic group or a monocyclic or polycyclic $C_1$-$C_{30}$ heterocyclic group.

For example, in Formulae 2-2, and 3-3, $A_{21}$, $A_{31}$, and $A_{32}$ may each independently be a benzene group, a naphthalene group, a phenanthrene group, a furan group, a thiophene group, a pyrrole group, a cyclopentene group, a silole group, a germole group, a benzofuran group, a benzothiophene group, an indole group, an indene group, a benzosilole group, a benzogermole group, a dibenzofuran group, a dibenzothiophene group, a carbazole group, a fluorene group, a dibenzosilole group, a dibenzogermole group, a pyridine group, a pyrimidine group, a pyridazine group, or a pyrazine group.

In some embodiments, in Formula 2-2, $A_{21}$ may be a benzene group, a naphthalene group, a pyridine group, a pyrimidine group, a pyridazine group, or a pyrazine group.

In some embodiments, in Formula 3-3, $A_{31}$ and $A_{32}$ may each independently be a benzene group, a naphthalene group, a dibenzofuran group, a dibenzothiophene group, a carbazole group, a pyridine group, a pyrimidine group, a pyridazine group, or a pyrazine group.

In Formula 3-3, $X_{31}$ is a single bond, O, S, $N(R_{36})$, $C(R_{36})=C(R_{37})$, $[C(R_{36})(R_{37})]_{n31}$, or $[Si(R_{36})(R_{37})]_{n31}$, and n31 is 1 or 2, wherein $R_{36}$ and $R_{37}$ may respectively be understood by referring to the descriptions of $R_{36}$ and $R_{37}$ provided herein.

For example, in Formula 3-3, $X_{31}$ may be a single bond, O, S, $N(R_{36})$, $C(R_{36})=C(R_{37})$, $C(R_{36})(R_{37})$, or $Si(R_{36})(R_{37})$.

In Formula 2-1, 2-2, $R_{21}$, $R_{22}$, $R_{31}$, and $R_{32}$ are each independently a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group.

In some embodiments, in Formulae 2-1, 2-2, $R_{21}$, $R_{22}$, may each independently be:

a $C_1$-$C_{20}$ alkyl group unsubstituted or substituted with at least one of deuterium, - F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]a hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{11})(Q_{12})(Q_{13})$, $-Ge(Q_{11})(Q_{12})(Q_{13})$, $-C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, $-S(=O)_2(Q_{11})$, $-P(=O)(Q_{11})(Q_{12})$, $-P(=S)(Q_{11})(Q_{12})$, or a combination thereof; or

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, or a combination thereof,

wherein $Q_{11}$ to $Q_{13}$ and $Q_{21}$ to $Q_{23}$ are each independently:

hydrogen, deuterium, -F, a cyano group, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$,

- $CH_2CF_2H$, $-CH_2CFH_2$, $-CHFCH_3$, $-CHFCF_2H$, $-CHFCFH_2$, $-CHFCF_3$, $-CF_2CF_3$, - $CF_2CF_2H$, or $-CF_2CFH_2$; or
an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof.

In some embodiments, in Formulae 2-1, 2-2, $R_{21}$, $R_{22}$, may each independently be:

a $C_1$-$C_{20}$ alkyl group unsubstituted or substituted with at least one of deuterium, - F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, $-Si(Q_{11})(Q_{12})(Q_{13})$, $-Ge(Q_{11})(Q_{12})(Q_{13})$, - $C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, - $S(=O)_2(Q_{11})$, $-P(=O)(Q_{11})(Q_{12})$, $-P(=S)(Q_{11})(Q_{12})$, or a combination thereof; or
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, - $Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, - $P(Q_{21})(Q_{22})$, $-C(=O)(Q_{21})$, $-S(=O)(Q_{21})$, $-S(=O)_2(O_{21})$, $-P(=O)(Q_{21})(Q_{22})$, $-P(=S)(Q_{21})(Q_{22})$, or a combination thereof;
wherein $Q_{11}$ to $Q_{13}$ and $Q_{21}$ to $Q_{23}$ are each independently:
deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, - $CHFCF_2H$, $-CHFCFH_2$, $-CHFCF_3$, $-CF_2CF_3$, $-CF_2CF_2H$, or $-CF_2CFH_2$; or
an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination

thereof.

In one or more embodiments, in Formulae 2-1, 2-2, $R_{21}$, $R_{22}$, may each independently be $-CH_3$, $-CD_3$, $-CD_2H$, $-CDH_2$, $-CF_3$, $-CF_2H$, $-CFH_2$, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-236, a group represented by one of Formulae 9-201 to 9-236 in which at least one hydrogen is substituted with deuterium, a group represented by one of Formulae 9-201 to 9-236 in which at least one hydrogen is substituted with -F, a group represented by one of Formulae 10-1 to 10-130, a group represented by one of Formulae 10-1 to 10-130 in which at least one hydrogen is substituted with deuterium, a group represented by one of Formulae 10-1 to 10-130 in which at least one hydrogen is substituted with -F, a group represented by one of Formulae 10-201 to 10-358, a group represented by one of Formulae 10-201 to 10-358 in which at least one hydrogen is substituted with deuterium, or a group represented by one of Formulae 10-201 to 10-358 in which at least one hydrogen is substituted with -F:

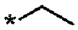
9-1
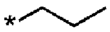
9-2
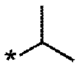
9-3
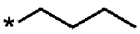
9-4
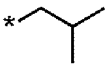
9-5
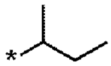
9-6
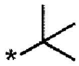
9-7
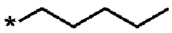
9-8

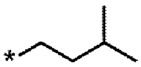
9-9
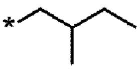
9-10
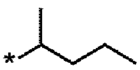
9-11
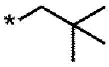
9-12
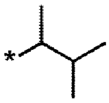
9-13
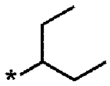
9-14
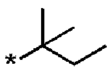
9-15

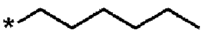
9-16
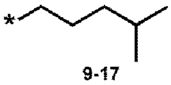
9-17
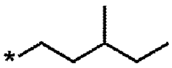
9-18
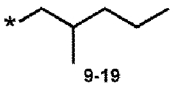
9-19
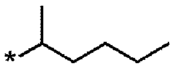
9-20
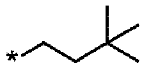
9-21

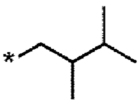
9-22
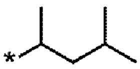
9-23
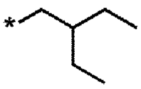
9-24
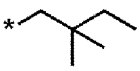
9-25
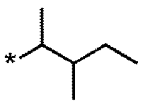
9-26
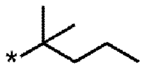
9-27
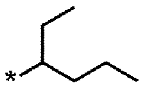
9-28

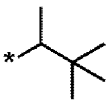
9-29
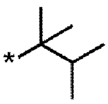
9-30
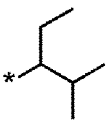
9-31
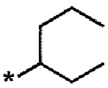
9-32
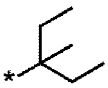
9-33
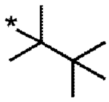
9-34
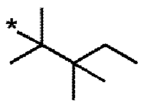
9-35
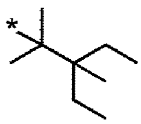
9-36

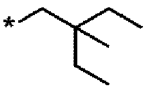
9-37
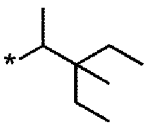
9-38
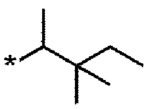
9-39

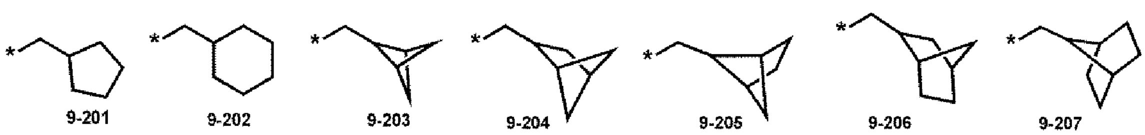
9-201 9-202 9-203 9-204 9-205 9-206 9-207

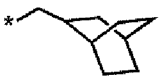
9-208

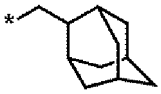
9-209

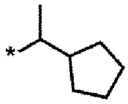
9-210

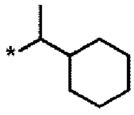
9-211

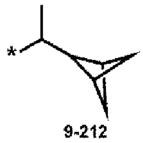
9-212

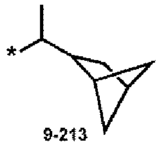
9-213

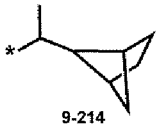
9-214

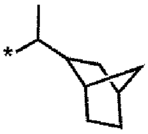
9-215

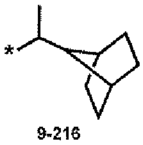
9-216

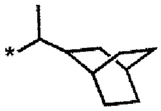
9-217

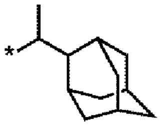
9-218

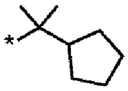
9-219

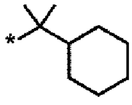
9-220

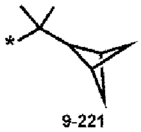
9-221

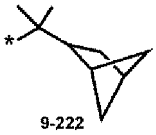
9-222

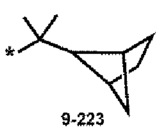
9-223

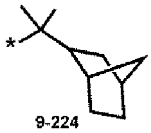
9-224

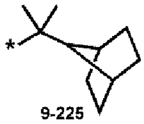
9-225

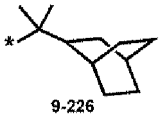
9-226

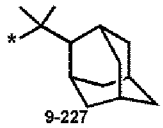
9-227

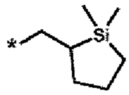
9-228

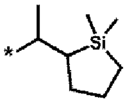
9-229

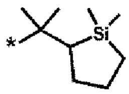
9-230

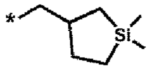
9-231

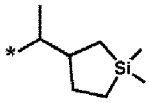
9-232

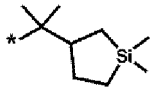
9-233

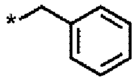
9-234

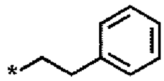
9-235

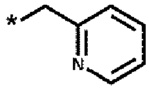
9-236

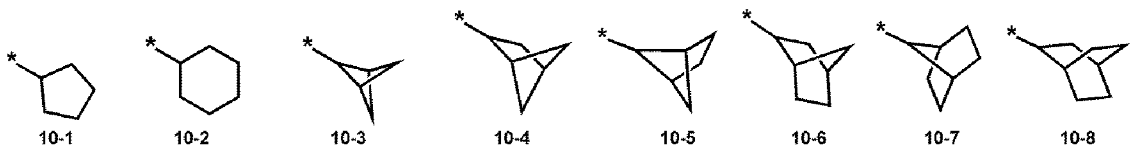
10-1 10-2 10-3 10-4 10-5 10-6 10-7 10-8

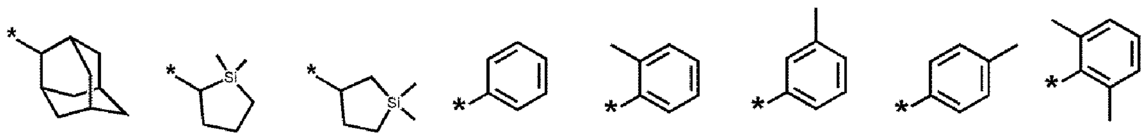
10-9 10-10 10-11 10-12 10-13 10-14 10-15 10-16

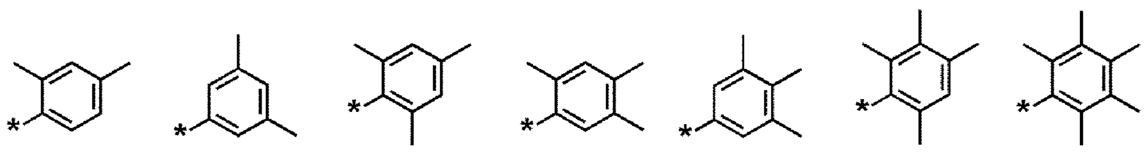
10-17 10-18 10-19 10-20 10-21 10-22 10-23

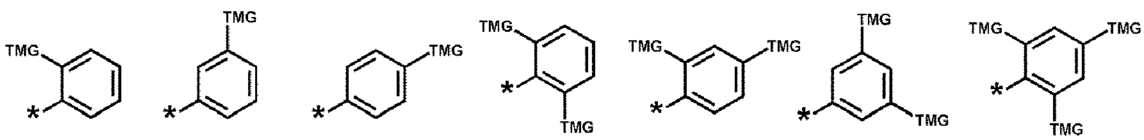
10-24 10-25 10-26 10-27 10-28 10-29 10-30

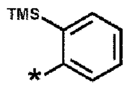
10-31
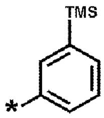
10-32
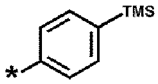
10-33
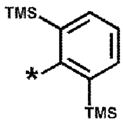
10-34
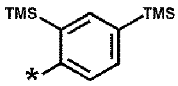
10-35
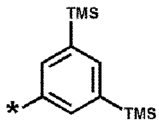
10-36
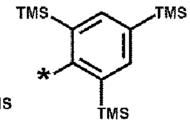
10-37

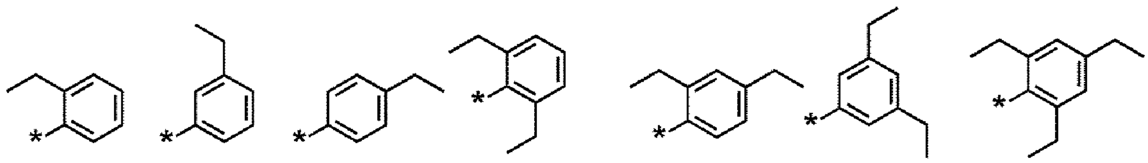
10-38 10-39 10-40 10-41 10-42 10-43 10-44

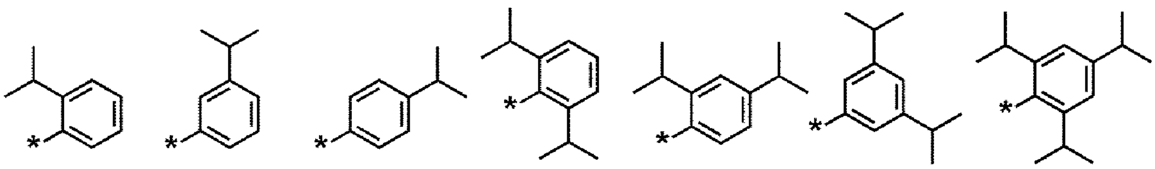
10-45 10-46 10-47 10-48 10-49 10-50 10-51

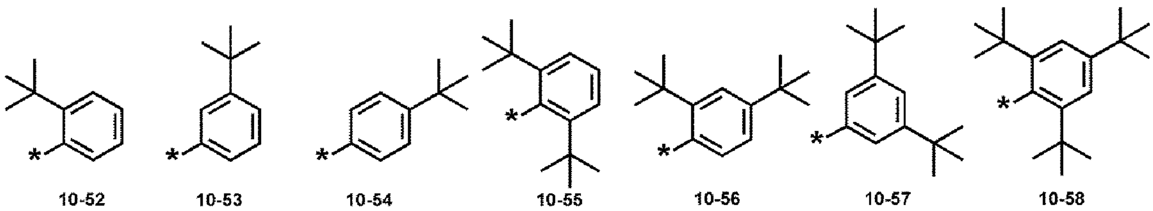
10-52 10-53 10-54 10-55 10-56 10-57 10-58

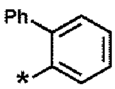
10-59
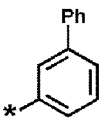
10-60
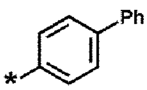
10-61
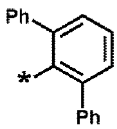
10-62
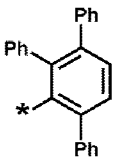
10-63
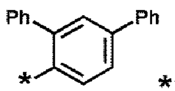
10-64
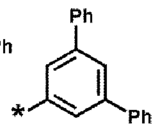
10-65
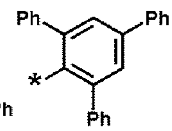
10-66

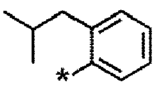
10-67
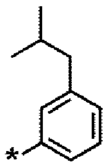
10-68
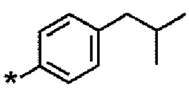
10-69
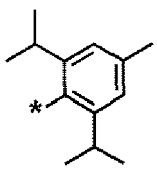
10-70
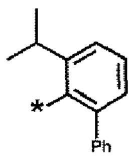
10-71
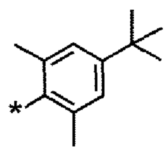
10-72

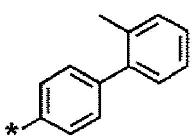
10-73
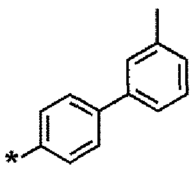
10-74
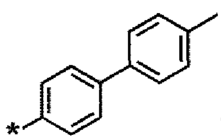
10-75
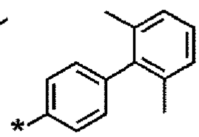
10-76
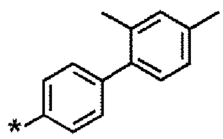
10-77

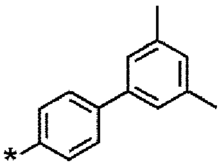
10-78

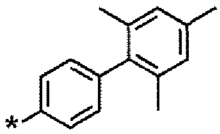
10-79

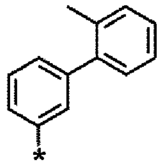
10-80

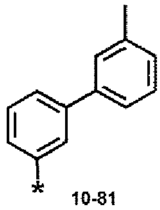
10-81

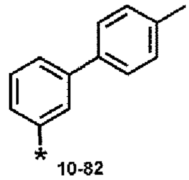
10-82

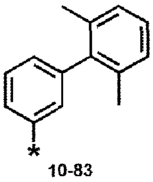
10-83

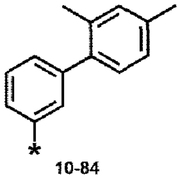
10-84

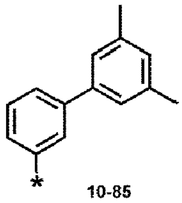
10-85

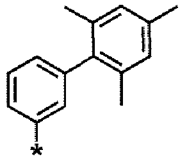
10-86

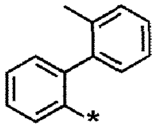
10-87

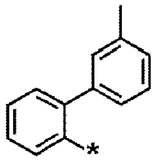
10-88

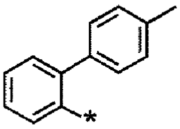
10-89

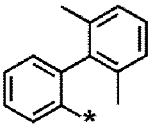
10-90

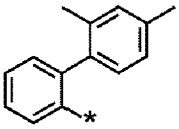
10-91

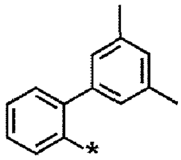
10-92

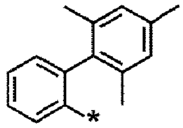
10-93

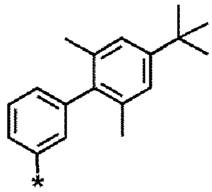
10-94

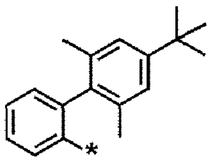
10-95

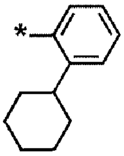
10-96

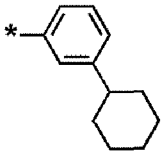
10-97

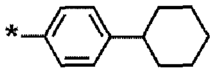
10-98

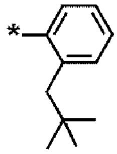
10-99

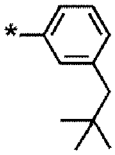
10-100

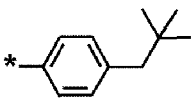
10-101

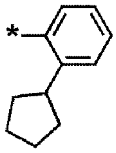
10-102

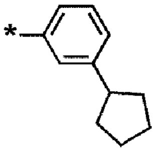
10-103

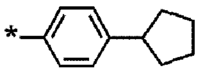
10-104

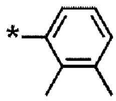
10-105

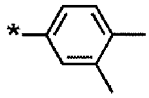
10-106

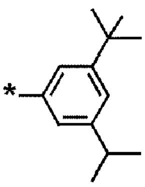
10-107

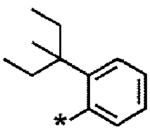
10-108

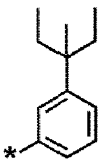
10-109

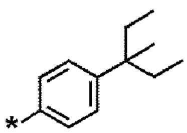
10-110

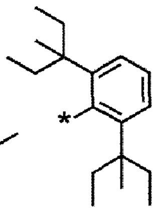
10-111

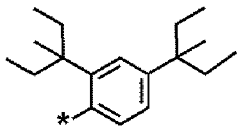
10-112

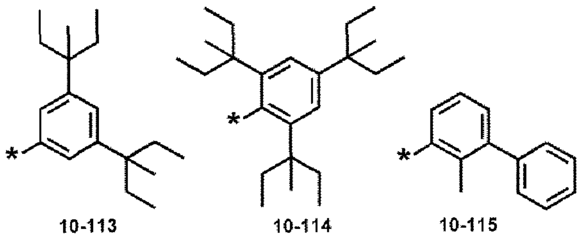

10-113 10-114 10-115

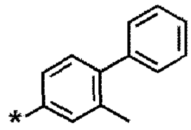

10-116

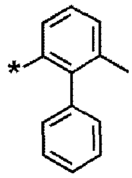

10-117

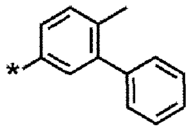

10-118

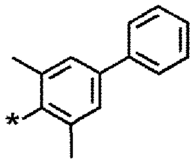

10-119

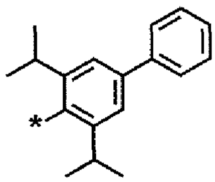

10-120

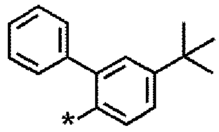

10-121

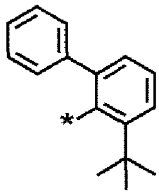

10-122

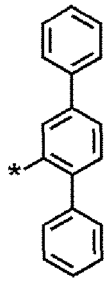

10-123

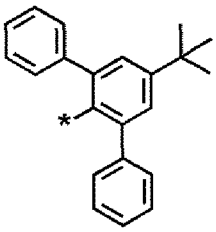

10-124

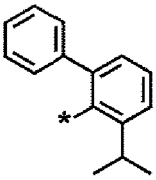

10-125

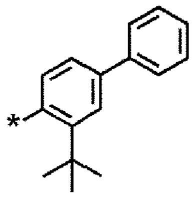

10-126

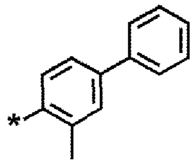

10-127

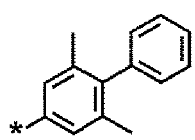

10-128

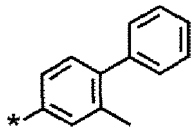

10-129

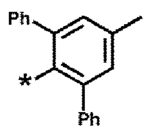

10-130

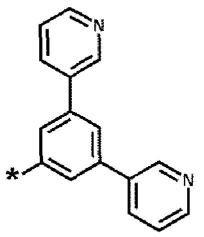

10-201

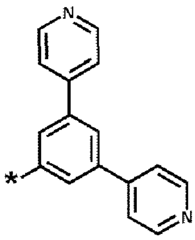

10-202

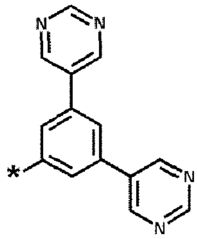

10-203

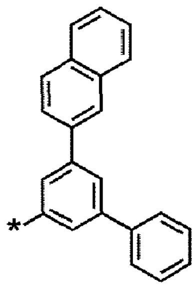

10-204

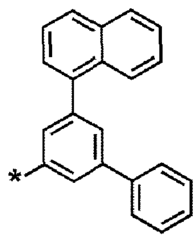

10-205

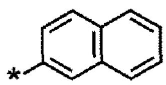

10-206

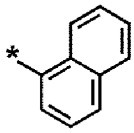

10-207

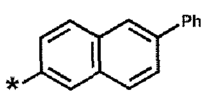

10-208

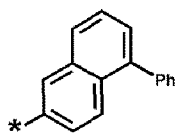

10-209

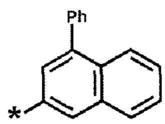

10-210

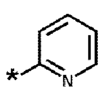
10-211
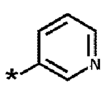
10-212
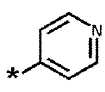
10-213
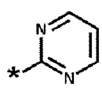
10-214
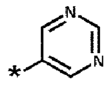
10-215
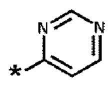
10-216
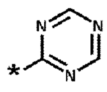
10-217

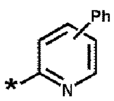
10-218
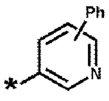
10-219
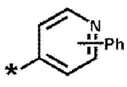
10-220
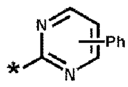
10-221
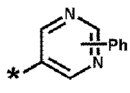
10-222
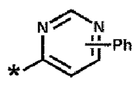
10-223
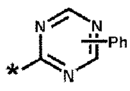
10-224

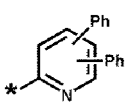
10-225
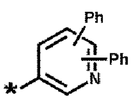
10-226
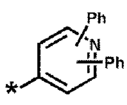
10-227
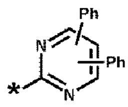
10-228
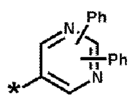
10-229
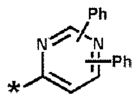
10-230
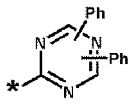
10-231

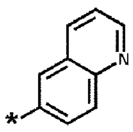
10-232
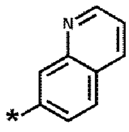
10-233
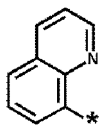
10-234
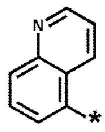
10-235
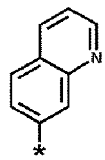
10-236
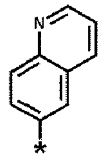
10-237

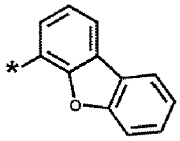
10-238
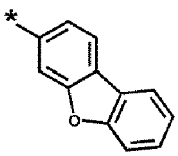
10-239
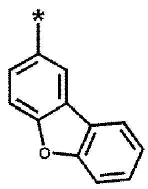
10-240
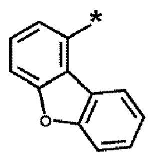
10-241
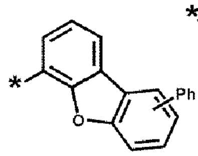
10-242
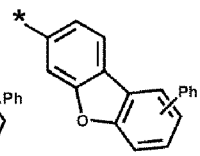
10-243

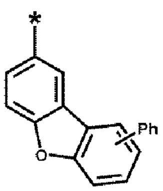
10-244
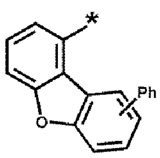
10-245
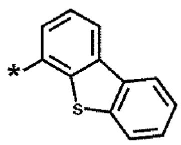
10-246
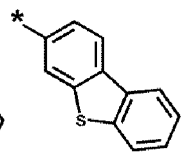
10-247
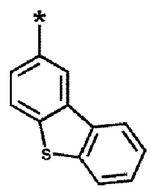
10-248
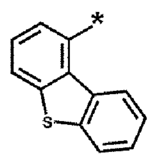
10-249

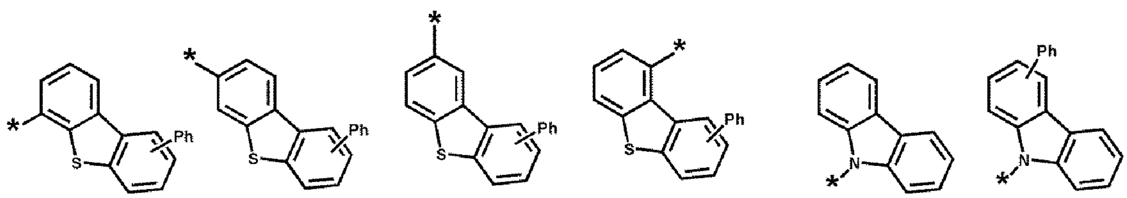
10-250
10-251
10-252
10-253
10-254
10-255

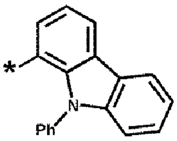
10-256
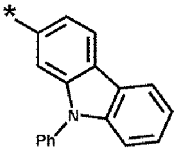
10-257
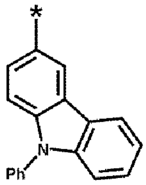
10-258
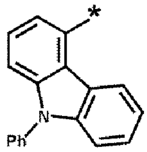
10-259
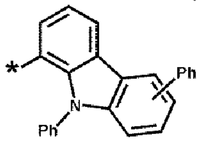
10-260
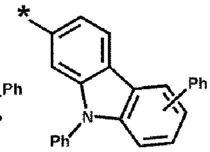
10-261

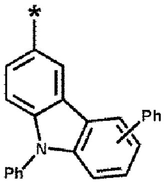
10-262
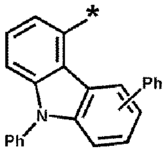
10-263
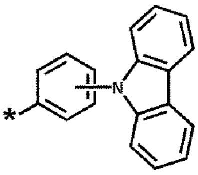
10-264
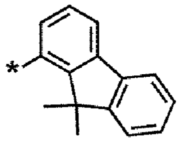
10-265
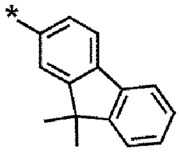
10-266
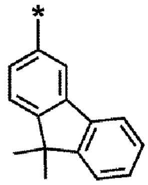
10-267

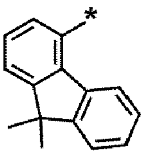
10-268
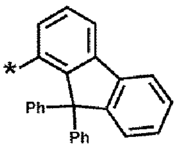
10-269
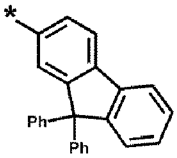
10-270
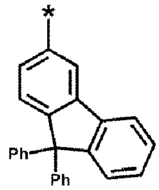
10-271
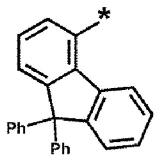
10-272

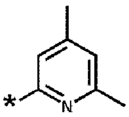
10-273
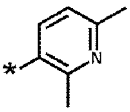
10-274
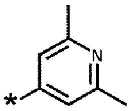
10-275
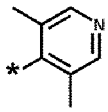
10-276
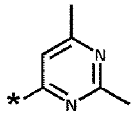
10-277
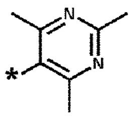
10-278
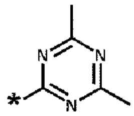
10-279

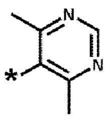
10-280
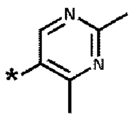
10-281
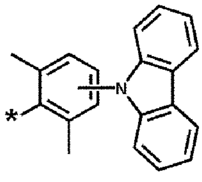
10-282
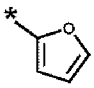
10-283
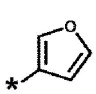
10-284
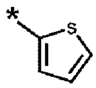
10-285
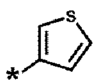
10-286

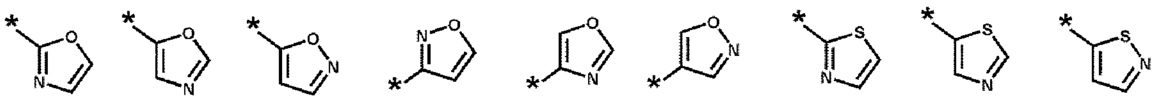
10-287 10-288 10-289 10-290 10-291 10-292 10-293 10-294 10-295

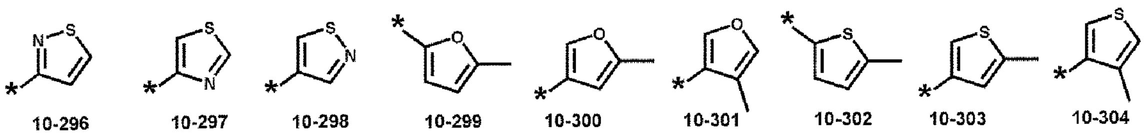
10-296 10-297 10-298 10-299 10-300 10-301 10-302 10-303 10-304

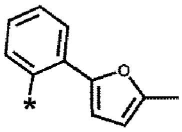
10-305

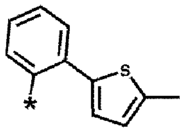
10-306

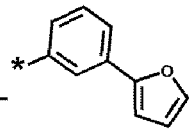
10-307

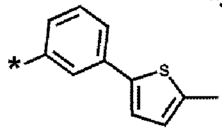
10-308

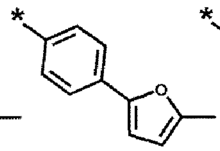
10-309

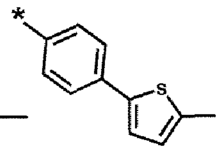
10-310

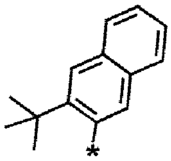
10-311

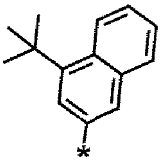
10-312

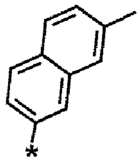
10-313

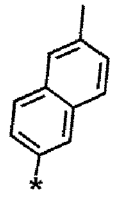
10-314

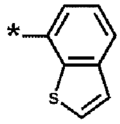
10-315

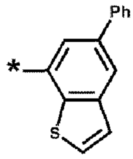
10-316

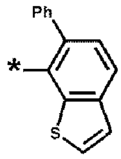
10-317

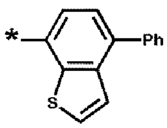
10-318

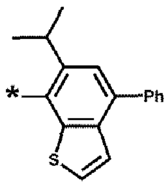
10-319

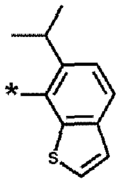
10-320

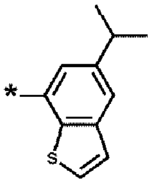
10-321

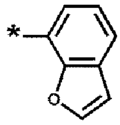
10-322

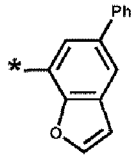
10-323

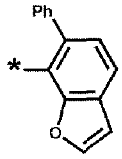
10-324

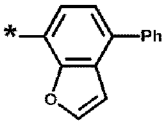
10-325

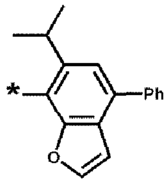
10-326

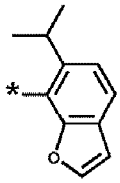
10-327

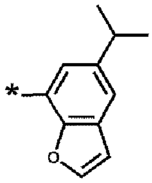
10-328

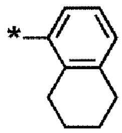
10-329

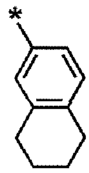
10-330

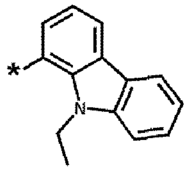
10-331

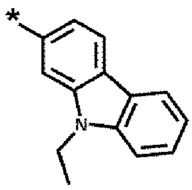
10-332

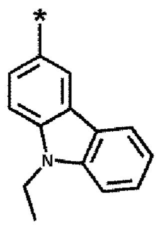
10-333

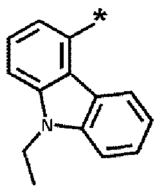
10-334

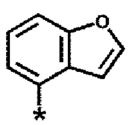
10-335

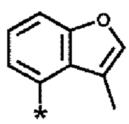
10-336

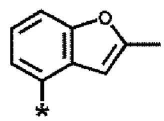
10-337

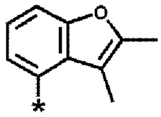
10-338

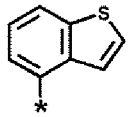
10-339

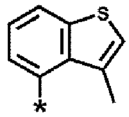
10-340

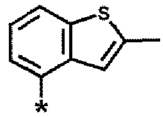
10-341

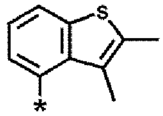
10-342

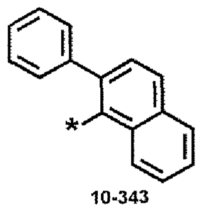
10-343

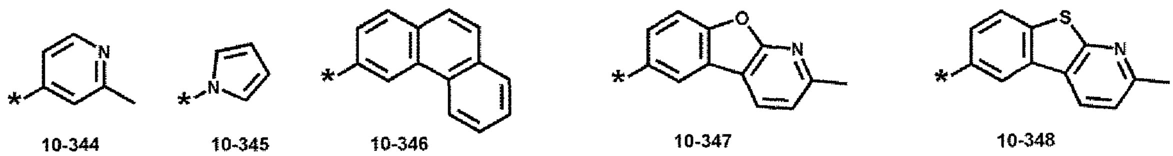
10-344 10-345 10-346 10-347 10-348

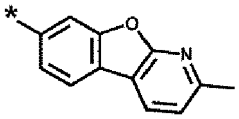

10-349

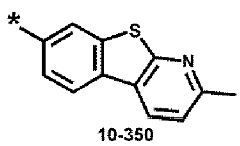

10-350

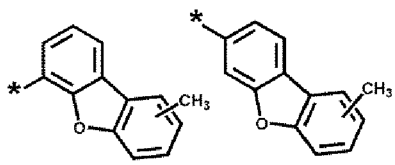

10-351 10-352

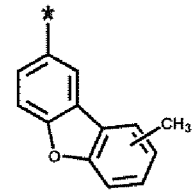

10-353

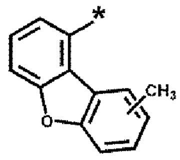

10-354

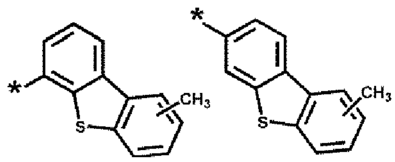

10-355 10-356

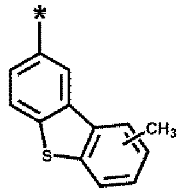

10-357

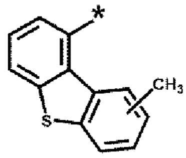

10-358

In Formulae 9-1 to 9-39, 9-201 to 9-236, 10-1 to 10-130, and 10-201 to 10-358, * indicates a binding site to an adjacent atom, "Ph" represents a phenyl group, "TMS" and "$SiMe_3$" each represent a trimethylsilyl group, and "TMG" and "$GeMe_3$" each represent a trimethylgermyl group.

In some embodiments, in Formulae 2-1, 2-2, $R_{21}$, $R_{22}$, may each independently be $-CH_3$, $-CD_3$, $-CD_2H$, $-CDH_2$, $-CF_3$, $-CF_2H$, $-CFH_2$, a group represented by one of Formulae 9-1 to 9-39, a group represented by one of Formulae 9-1 to 9-39 in which at least one hydrogen atom is substituted with a deuterium atom, a group represented by one of Formulae 9-1 to 9-39 in which at least one hydrogen atom is substituted with -F, a group represented by one of Formulae 10-1 to 10-130, a group represented by one of Formulae 10-1 to 10-130 in which at least one hydrogen atom is substituted with a deuterium atom, or a group represented by one of Formulae 10-1 to 10-130 in which at least one hydrogen atom is substituted with -F.

The "group represented by Formulae 9-1 to 9-39 in which at least one hydrogen is substituted with deuterium" and the "group represented by Formulae 9-201 to 9-236 in which at least one hydrogen is substituted with deuterium" may each be, for example, a group represented by one of Formulae 9-501 to 9-514 and 9-601 to 9-636:

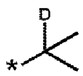

9-501

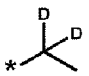

9-502

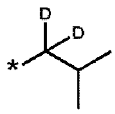

9-503

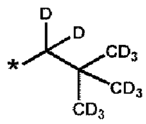

9-504

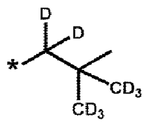

9-505

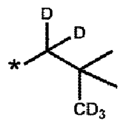

9-506

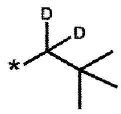

9-507

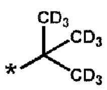

9-508

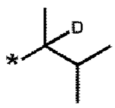

9-509

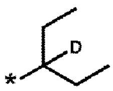

9-510

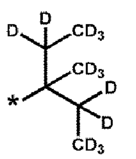

9-511

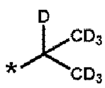

9-512

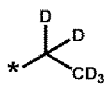

9-513

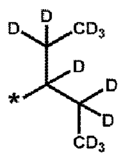

9-514

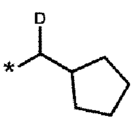

9-601

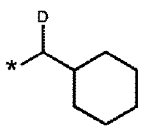

9-602

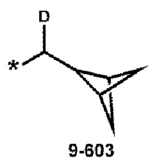

9-603

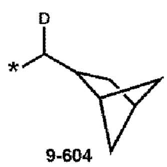

9-604

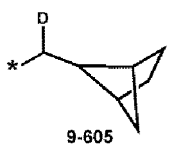

9-605

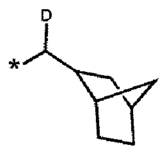

9-606

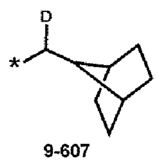

9-607

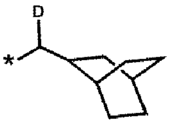
9-608

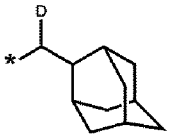
9-609

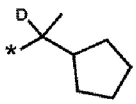
9-610

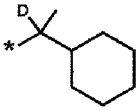
9-611

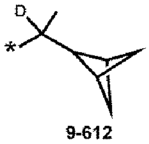
9-612

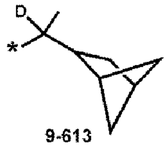
9-613

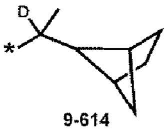
9-614

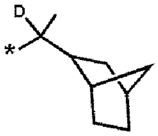
9-615

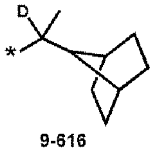
9-616

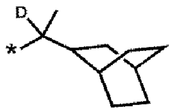
9-617

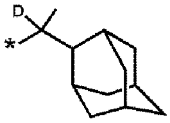
9-618

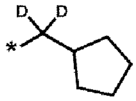
9-619

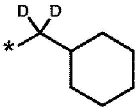
9-620

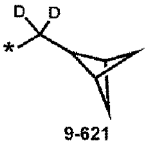
9-621

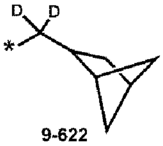
9-622

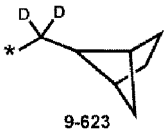
9-623

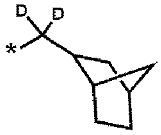
9-624

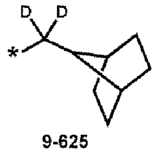
9-625

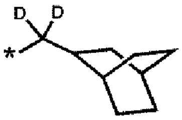
9-626

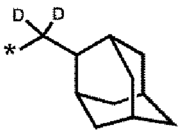
9-627

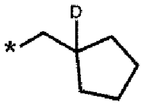
9-628

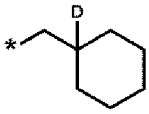
9-629

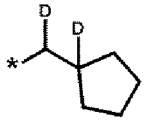
9-630

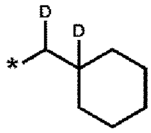
9-631

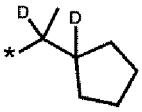
9-632

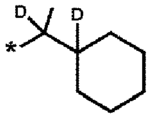
9-633

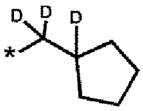
9-634

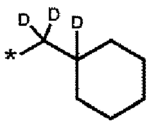
9-635

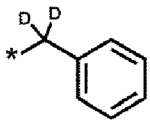
9-636

The "group represented by Formulae 9-1 to 9-39 in which at least one hydrogen is substituted with -F" and the "group represented by Formulae 9-201 to 9-236 in which at least one hydrogen is substituted with -F" may each be, for example, a group represented by one of Formulae 9-701 to 9-710:

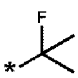
9-701

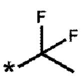
9-702

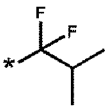
9-703

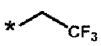
9-704

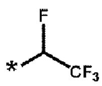
9-705

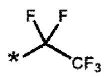
9-706

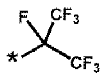
9-707

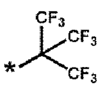
9-708

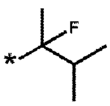
9-709

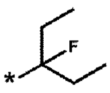
9-710

The "group represented by Formulae 10-1 to 10-130 in which at least one hydrogen is substituted with a deuterium" and the "group represented by Formulae 10-201 to 10-358 in which at least one hydrogen is substituted with deuterium" may each be, for example, a group represented by one of Formulae 10-501 to 576:

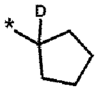 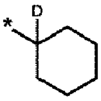 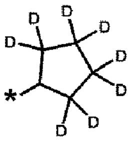 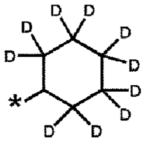 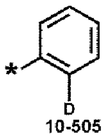 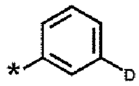 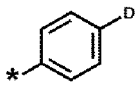 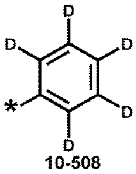

10-501 10-502 10-503 10-504 10-505 10-506 10-507 10-508

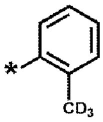 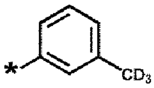 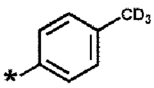 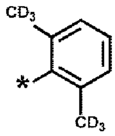 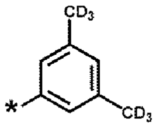 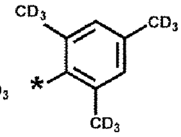 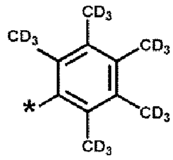

10-509 10-510 10-511 10-512 10-513 10-514 10-515

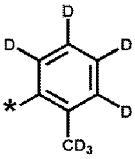 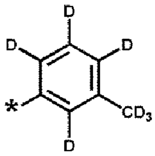 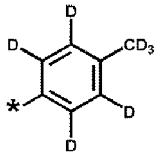 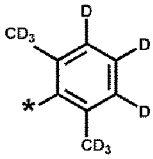 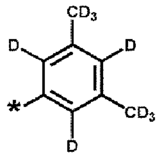 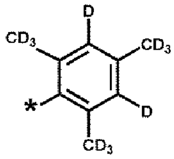

10-516 10-517 10-518 10-519 10-520 10-521

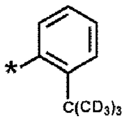 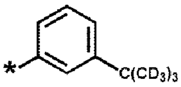 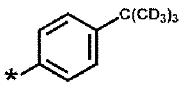 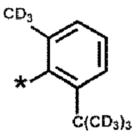 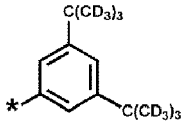 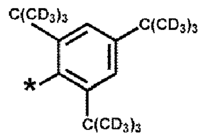

10-522 10-523 10-524 10-525 10-526 10-527

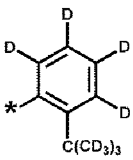 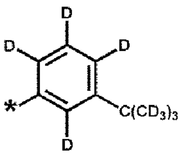 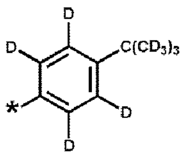 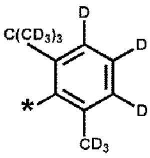 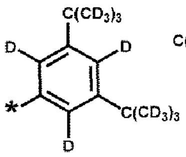 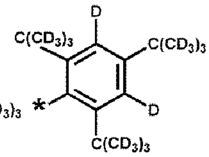

10-528 10-529 10-530 10-531 10-532 10-533

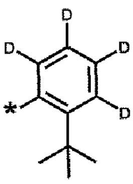 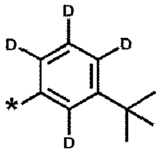 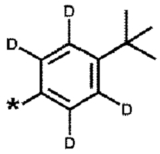 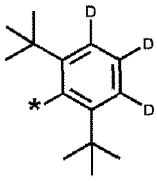 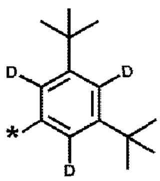 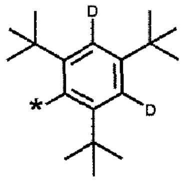

10-534 10-535 10-536 10-537 10-538 10-540

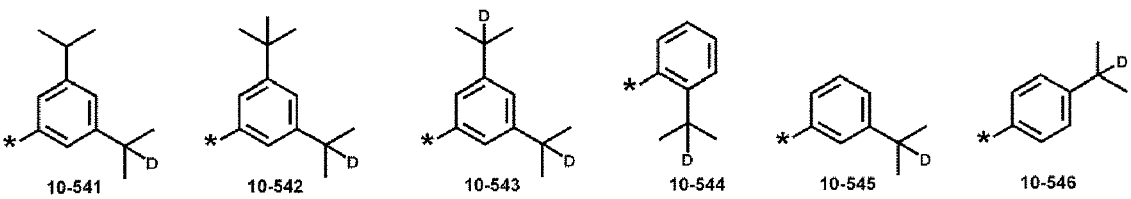

10-541 10-542 10-543 10-544 10-545 10-546

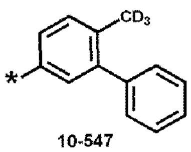
10-547
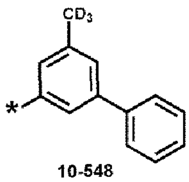
10-548
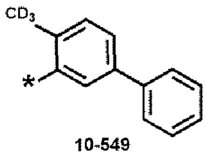
10-549
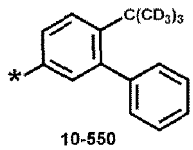
10-550
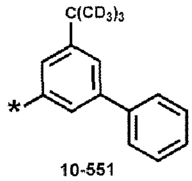
10-551

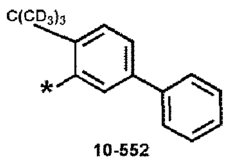
10-552
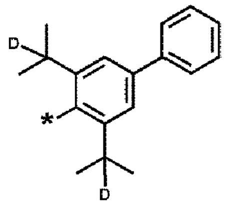
10-553

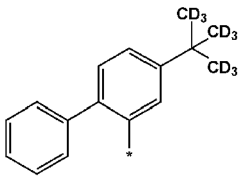
10-554
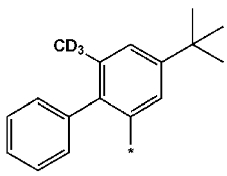
10-555
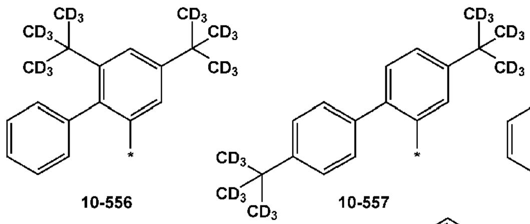
10-556
10-557
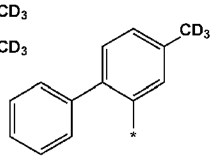
10-558

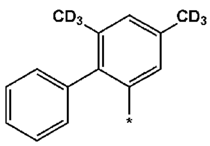
10-559
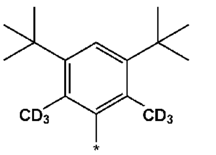
10-560
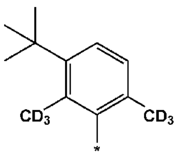
10-561
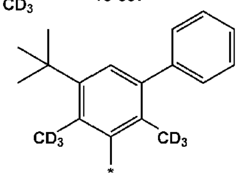
10-562
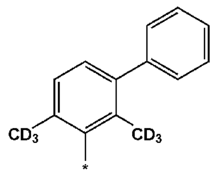
10-563

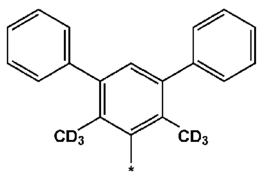
10-564
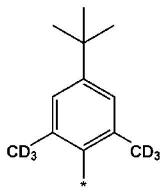
10-565
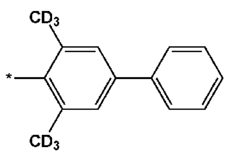
10-566
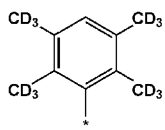
10-567
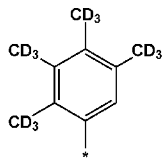
10-568

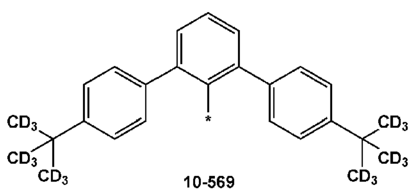
10-569
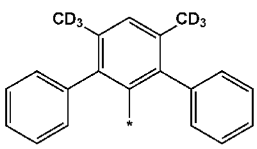
10-570
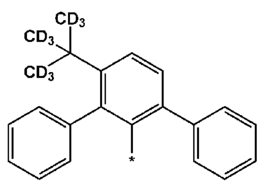
10-571

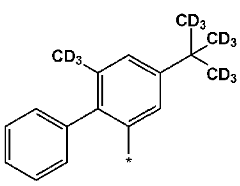
10-572
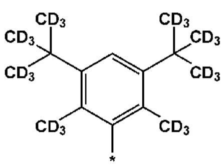
10-573
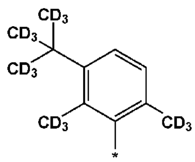
10-574
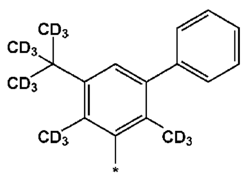
10-575
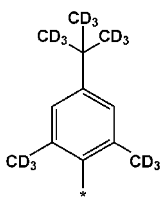
10-576

The "group represented by Formulae 10-1 to 10-130 in which at least one hydrogen is substituted with -F" and

the "group represented by Formulae 10-201 to 10-358 in which at least one hydrogen is substituted with -F" may each be, for example, a group represented by one of Formulae 10-601 to 617:

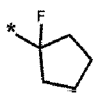
10-601

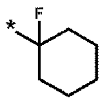
10-602

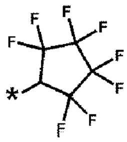
10-603

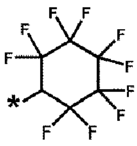
10-604

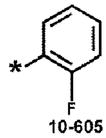
10-605

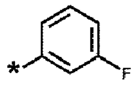
10-606

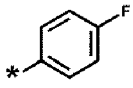
10-607

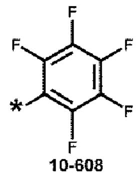
10-608

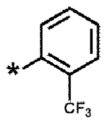
10-609

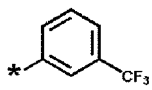
10-610

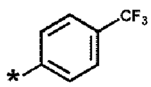
10-611

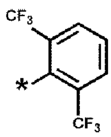
10-612

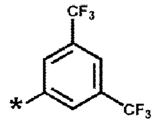
10-613

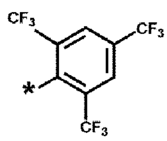
10-614

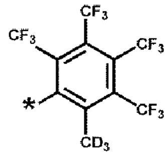
10-615

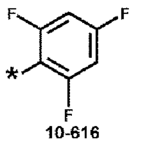
10-616

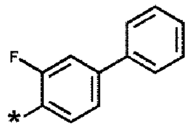
10-617

wherein, in Formulae 2-1, 2-2, and 3-3, $R_{23}$, $R_{24}$, and $R_{36}$ to $R_{37}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, - $Ge(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, - $S(=O)(Q_1)$, $-S(=O)_2(Q_1)$, $-P(=O)(Q_1)(Q_2)$, or $-P(=S)(Q_1)(Q_2)$,

$R_{36}$ and $R_{37}$ may optionally be linked to each other to form a substituted or unsubstituted $C_5$-$C_{30}$ carbocyclic group or a substituted or unsubstituted $C_1$-$C_{30}$ heterocyclic group,
wherein $Q_1$ to $Q_3$ are each independently hydrogen, deuterium, -F, -Cl, - Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each of which is unsubstituted or substituted with at least one of deuterium, -F, a cyano group, a $C_1$-$C_{20}$ alkyl group, a $C_6$-$C_{30}$ aryl group, or a combination thereof.

For example, in Formulae 2-1, 2-2, and 3-3, $R_{23}$, $R_{24}$, and $R_{36}$ to $R_{37}$ may each independently be:
hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt

thereof, or a phosphoric acid group or a salt thereof;

a $C_1$-$C_{20}$ alkyl group, a $C_1$-$C_{20}$ alkenyl group, a $C_1$-$C_{20}$ alkoxy group, or a $C_1$-$C_{20}$ alkylthio group, each unsubstituted or substituted with at least one of deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]a hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, -Si($Q_{11}$)($Q_{12}$)($Q_{13}$), - Ge($Q_{11}$)($Q_{12}$)($Q_{13}$), -C($Q_{11}$)($Q_{12}$)($Q_{13}$), -B($Q_{11}$)($Q_{12}$), -N($Q_{11}$)($Q_{12}$), -P($Q_{11}$)($Q_{12}$), - C(=O)($Q_{11}$), -S(=O)($Q_{11}$), -$S(=O)_2$($Q_{11}$), -P(=O)($Q_{11}$)($Q_{12}$), -P(=S)($Q_{11}$)($Q_{12}$), or a combination thereof; or

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, or a combination thereof; or

$-Si(Q_1)(Q_2)(Q_3)$, $-Ge(Q_1)(Q_2)(Q_3)$, $-C(Q_1)(Q_2)(Q_3)$, $-B(Q_1)(Q_2)$, $-N(Q_1)(Q_2)$, $-P(Q_1)(Q_2)$, $-C(=O)(Q_1)$, $-S(=O)(Q_1)$, $-S(=O)_2(Q_1)$, $-P(=O)(Q_1)(Q_2)$, or $-P(=S)(Q_1)(Q_2)$,

wherein $Q_1$ to $Q_3$, $Q_{11}$ to $Q_{13}$, and $Q_{21}$ to $Q_{23}$ may each independently be:

hydrogen, deuterium, -F, a cyano group, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof.

In some embodiments, in Formulae 2-1, 2-2, and 3-3, $R_{23}$, $R_{24}$, and $R_{36}$ to $R_{37}$ may each independently be: hydrogen, deuterium, -F, -Cl, -Br, -I, $-SF_5$, a hydroxyl group, a cyano group, or a nitro group;

a $C_1$-$C_{20}$ alkyl group unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, $-Si(Q_{11})(Q_{12})(Q_{13})$, $-Ge(Q_{11})(Q_{12})(Q_{13})$, $-C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, $-S(=O)_2(Q_{11})$, $-P(=O)(Q_{11})(Q_{12})$, $-P(=S)(Q_{11})(Q_{12})$, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$

alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, - $Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, - $P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, or a combination thereof; or

$-Si(Q_1)(Q_2)(Q_3)$, $-Ge(Q_1)(Q_2)(Q_3)$, $-C(Q_1)(Q_2)(Q_3)$, $-B(Q_1)(Q_2)$, or $-N(Q_1)(Q_2)$, and

$R_{36}$ and $R_{37}$ may optionally be linked to each other to form a substituted or unsubstituted $C_5$-$C_{30}$ carbocyclic group or a substituted or unsubstituted $C_1$-$C_{30}$ heterocyclic group,

wherein $Q_1$ to $Q_3$, $Q_{11}$ to $Q_{13}$, and $Q_{21}$ to $Q_{23}$ may each independently be:

deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, - $CHFCF_2H$, $-CHFCFH_2$, $-CHFCF_3$, $-CF_2CF_3$, $-CF_2CF_2H$, or $-CF_2CFH_2$; or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof.

In some embodiments, in Formulae 2-1, 2-2, and 3-3, $R_{23}$, $R_{24}$, and $R_{36}$ to $R_{37}$ may each independently be:

hydrogen, deuterium, -F, a cyano group, $-CH_3$, $-CD_3$, $-CD_2H$, $-CDH_2$, $-CF_3$, $-CF_2H$, $-CFH_2$, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-236, a group represented by one of Formulae 9-201 to 9-236 in which at least one hydrogen is substituted with deuterium, a group represented by one of Formulae 9-201 to 9-236 in which at least one hydrogen is substituted with -F, a group represented by one of Formulae 10-1 to 10-130, a group represented by one of Formulae 10-1 to 10-130 in which at least one hydrogen is substituted with deuterium, a group represented by one of Formulae 10-1 to 10-130 in which at least one hydrogen is substituted with -F, a group represented by one of Formulae 10-201 to 10-358, a group represented by one of Formulae 10-201 to 10-358 in which at least one hydrogen is substituted with deuterium, a group represented by one of Formulae 10-201 to 10-358 in which at least one hydrogen is substituted with -F, $-Si(Q_1)(Q_2)(Q_3)$, $-Ge(Q_1)(Q_2)(Q_3)$, or - $C(Q_1)(Q_2)(Q_3)$,

$R_{36}$ and $R_{37}$ may optionally be linked to each other to form a substituted or unsubstituted $C_5$-$C_{30}$ carbocyclic group or a substituted or unsubstituted $C_1$-$C_{30}$ heterocyclic group,

wherein $Q_1$ to $Q_3$ may be each independently:

deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, - $CHFCF_2H$, $-CHFCFH_2$, $-CHFCF_3$, $-CF_2CF_3$, $-CF_2CF_2H$, or $-CF_2CFH_2$; or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a phenyl group, or a combination thereof.

In some embodiments, in Formulae 2-1, 2-2, and 3-3, $R_{23}$, $R_{24}$, and $R_{36}$ to $R_{37}$ may each independently be hydrogen, deuterium, -F, a cyano group, $-CH_3$, $-CD_3$, - $CD_2H$, $-CDH_2$, $-CF_3$, $-CF_2H$, $-CFH_2$, a group represented by one of Formulae 9-1 to 9-39, a group represented by one of Formulae 9-1 to 9-39 in which at least one hydrogen atom is substituted with a deuterium atom, a group represented by one of Formulae 9-1 to 9-39 in which at least one hydrogen atom is substituted with -F, a group represented by one of Formulae 10-1 to 10-130, a group represented by one of Formulae 10-1 to 10-130 in which at least one hydrogen atom is substituted with a deuterium atom, a group represented by one of Formulae 10-1 to 10-130 in which at least one hydrogen atom is substituted with -F, $-Si(Q_1)(Q_2)(Q_3)$, or-$Ge(Q_1)(Q_2)(Q_3)$,

$R_{36}$ and $R_{37}$ may optionally be linked to each other to form a substituted or unsubstituted $C_5$-$C_{30}$ carbocyclic group or a substituted or unsubstituted $C_1$-$C_{30}$ heterocyclic group,

wherein $Q_1$ to $Q_3$ may be each independently:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$,

$-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, - $CHFCFH_2$, $-CHFCF_3$, $-CF_2CF_3$, $-CF_2CF_2H$, or $-CF_2CFH_2$; or

a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof.

In Formulae 2-2, and 3-3, b23, b33, and b34 indicate the number of substitution of $R_{23}$, $R_{33}$, and $R_{34}$, and b23, b33, are each independently 1, 2, 3, 4, 5, 6, 7, 8, 9, or 10 b34 is 2, 3, 4, 5, 6, 7, 8, 9, or 10.

In Formulae 2-1, 2-2, and 3-1 to 3-3, * indicates a binding site to $M_1$ in Formula 1.

In some embodiments, in Formula 1, $L_1$ may be a ligand represented by Formula 2-11 or Formula 2-12. In Formula 1, $L_2$ may be a ligand represented by one of Formulae 3-13 to 3-17:

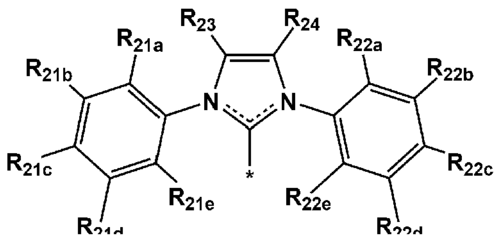

2-11

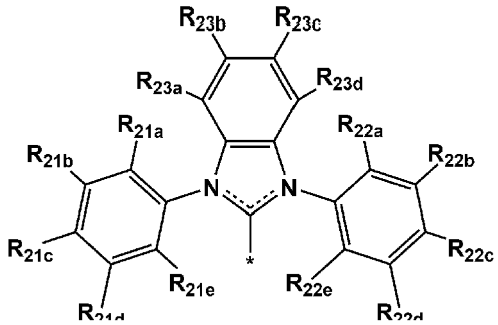

2-12

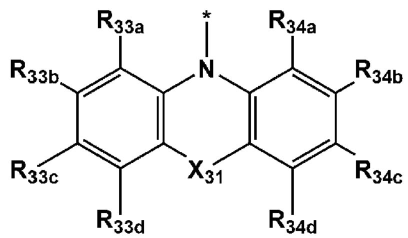

3-13

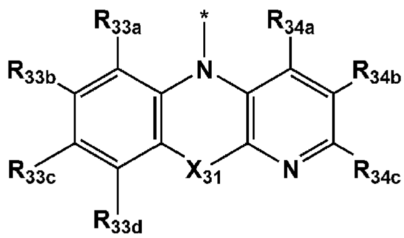

3-14

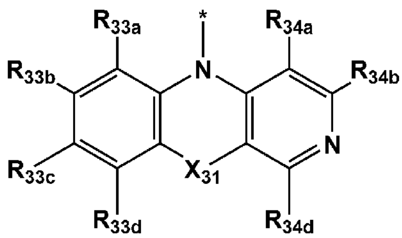

3-15

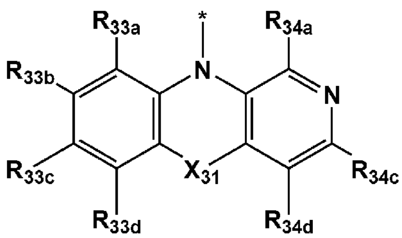

3-16

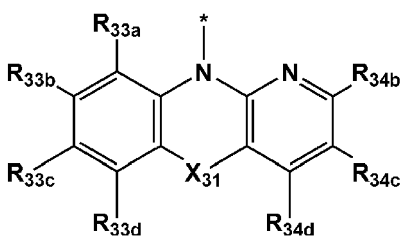

3-17

wherein, in Formulae 2-11, 2-12, and 3-13 to 3-17,

$X_{31}$, $R_{23}$, $R_{24}$, $R_{34}$, and $R_{35}$ are respectively understood by referring to the descriptions of $X_{31}$, $R_{23}$, $R_{24}$, $R_{34}$, and $R_{35}$ in Formula in the claims. and

$R_{21a}$ to $R_{21e}$, $R_{22a}$ to $R_{22e}$, $R_{23a}$ to $R_{23d}$, may each independently be hydrogen, deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(O_{21})$, $-P(=O)(Q_{21})(Q_{22})$, or $-P(=S)(Q_{21})(Q_{22})$,

wherein $Q_{21}$ to $Q_{23}$ may each independently be:

hydrogen, deuterium, -F, a cyano group, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$, or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof, and

* indicates a binding site to $M_1$ in Formula 1.

In some embodiments, in Formula 1, $L_1$ may be a ligand represented by Formula 2-11 or Formula 2-12, and $L_2$ may be a ligand represented by Formula 3-13.

In some embodiments, in Formula 1, $L_1$ may be a ligand represented by one of Formulae 2-21 to 2-26:

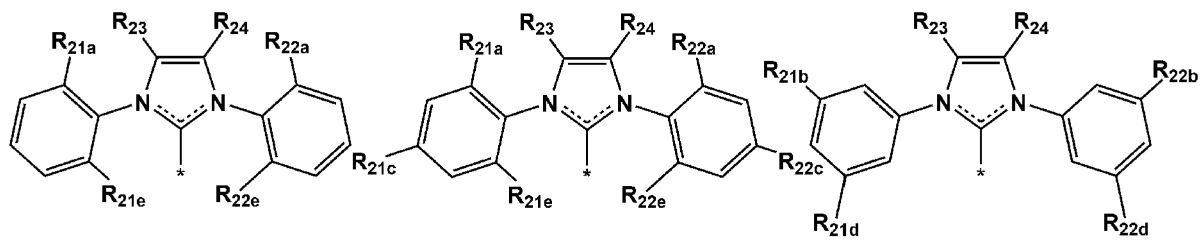

2-21 2-22 2-23

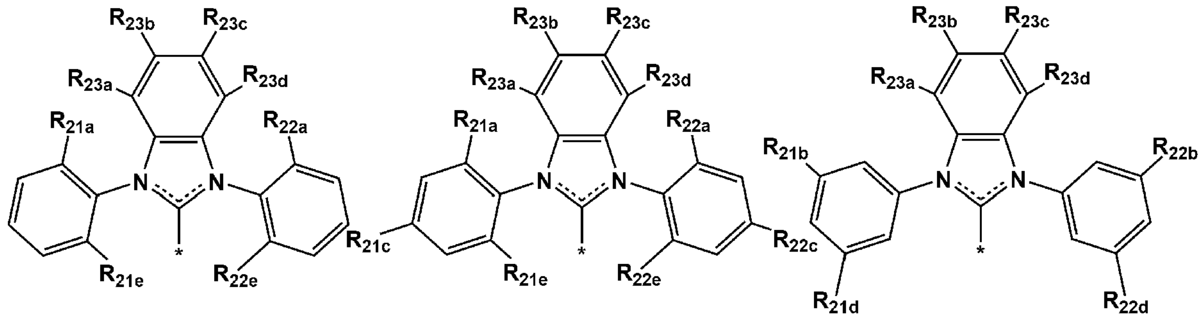

2-24 2-25 2-26

wherein, in Formulae 2-21 to 2-26,

$R_{23}$, $R_{24}$, and $R_{23a}$ to $R_{23d}$ may each independently be: hydrogen, deuterium, -F, -Cl, -Br, -I, $-SF_5$, a hydroxyl group, a cyano group, or a nitro group;

a $C_1$-$C_{20}$ alkyl group unsubstituted or substituted with at least one of deuterium, - F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, $-Si(Q_{11})(Q_{12})(Q_{13})$, $-Ge(Q_{11})(Q_{12})(Q_{13})$, $-C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, $-S(=O)_2(Q_{11})$, $-P(=O)(Q_{11})(Q_{12})$, $-P(=S)(Q_{11})(Q_{12})$, or combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, or a combination thereof; or

$-Si(Q_1)(Q_2)(Q_3)$, $-Ge(Q_1)(Q_2)(Q_3)$, $-C(Q_1)(Q_2)(Q_3)$, $-B(Q_1)(Q_2)$, or $-N(Q_1)(Q_2)$, and

$R_{21a}$, $R_{21b}$, $R_{21c}$, $R_{21d}$, $R_{21a}$, $R_{22a}$, $R_{22b}$, $R_{22c}$, $R_{22d}$, and $R_{22a}$ may each independently be hydrogen, deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, or $-P(=S)(Q_{21})(Q_{22})$,

wherein $Q_1$ to $Q_3$, $Q_{11}$ to $Q_{13}$, and $Q_{21}$ to $Q_{23}$ may each independently be:

hydrogen, deuterium, -F, a cyano group, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof, and

* indicates a binding site to $M_1$ in Formula 1.

In some embodiments, in Formulae 2-21, 2-22, 2-24, and 2-25, at least one of $R_{21a}$, $R_{21b}$, $R_{22a}$, and $R_{21b}$ may not be hydrogen.

In some embodiments, in Formula 1, $L_2$ may be a ligand represented by one of Formulae 3-21 to 3-26:

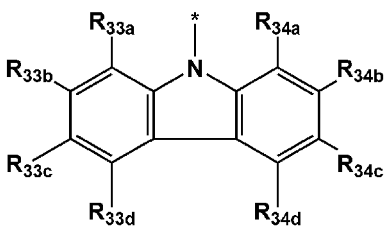

3-21

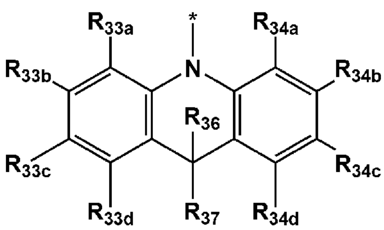

3-22

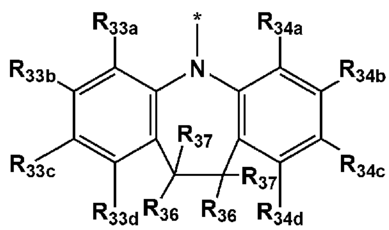

3-23

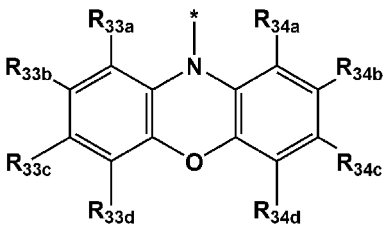

3-24

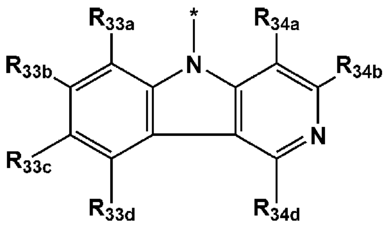

3-25

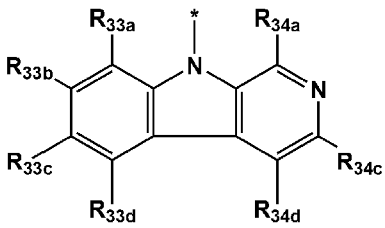

3-26

wherein, in Formulae 3-21 to 3-26,

$R_{36}$ and $R_{37}$ may each independently be: hydrogen, deuterium, -F, -Cl, - Br, -I, $-SF_5$, a hydroxyl group, a cyano group, or a nitro group;

a $C_1$-$C_{20}$ alkyl group unsubstituted or substituted with at least one of deuterium, - F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, $-Si(Q_{11})(Q_{12})(Q_{13})$, $-Ge(Q_{11})(Q_{12})(Q_{13})$, $- C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, $- S(=O)_2(Q_{11})$, $-P(=O)(Q_{11})(Q_{12})$, $-P(=S)(Q_{11})(Q_{12})$, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, $- Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $- P(Q_{21})(Q_{22})$, $-C(=O)(Q_{21})$, $-S(=O)(Q_{21})$, $-S(=O)_2(O_{21})$, $-P(=O)(Q_{21})(Q_{22})$, $-P(=S)(Q_{21})(Q_{22})$, or a combination thereof; or

$-Si(Q_1)(Q_2)(Q_3)$, $-Ge(Q_1)(Q_2)(Q_3)$, $-C(Q_1)(Q_2)(Q_3)$, $-B(Q_1)(Q_2)$, or $- N(Q_1)(Q_2)$, and

$R_{33a}$ to $R_{33d}$ and $R_{34a}$ to $R_{34d}$ are each independently a $C_1$-$C_{20}$ alkyl group or a deuterated C2-C20 alkyl group.

In some embodiments, the sensitizer may be a compound represented by Group I, but embodiments are not limited thereto:

Group I

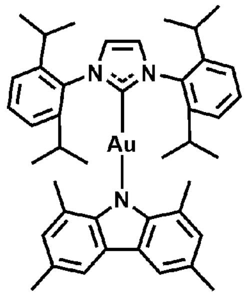

**1**

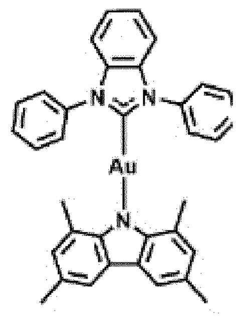

**3**

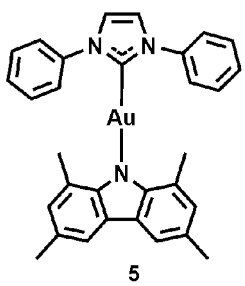

**5**

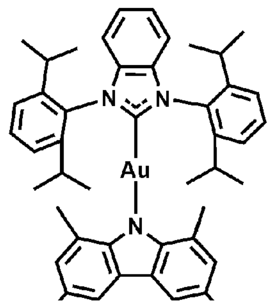

**7**

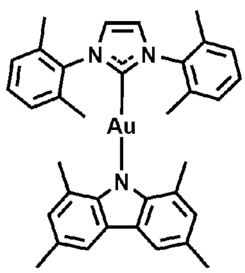

**9**

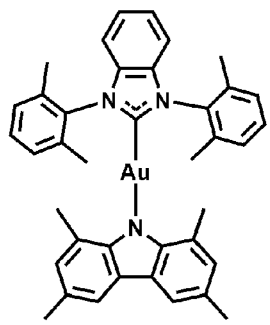

**11**

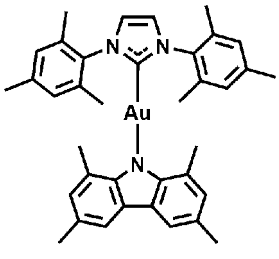

13

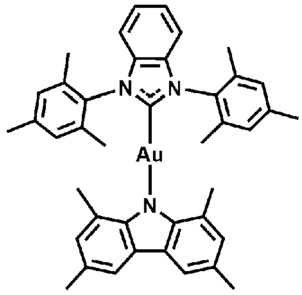

15

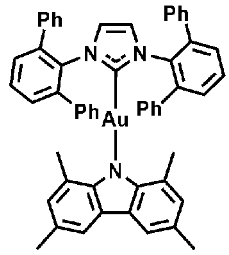

17

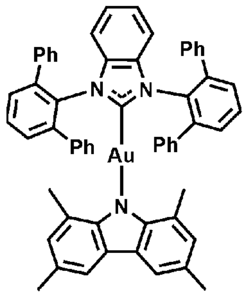

19

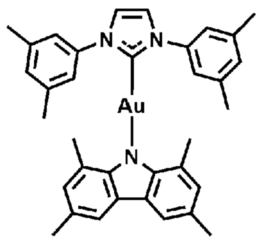

21

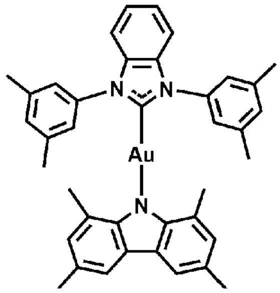

23

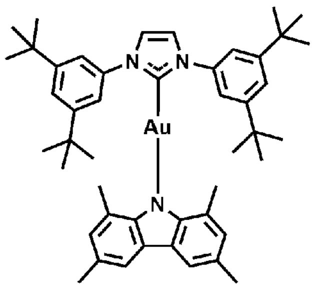

25

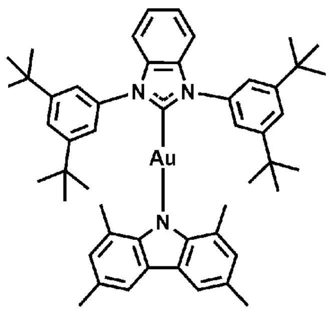

27

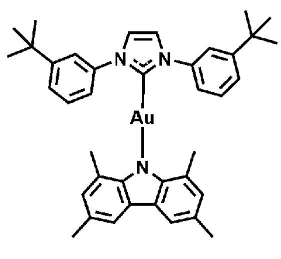

29

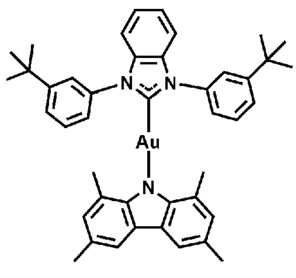

31

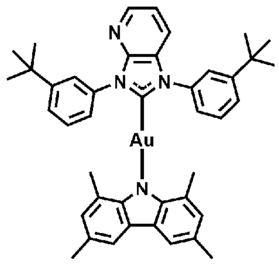

33

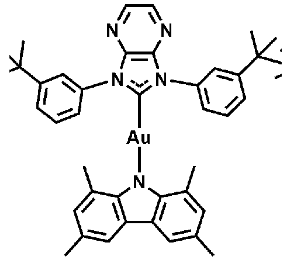

35

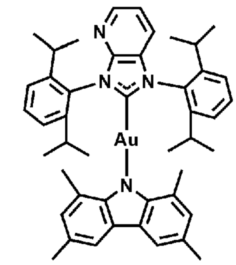

37

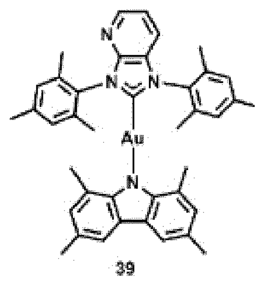

39

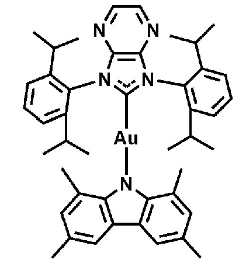

41

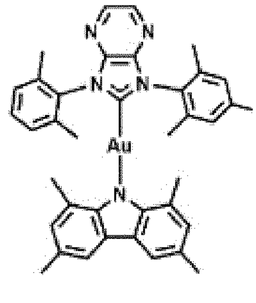

43

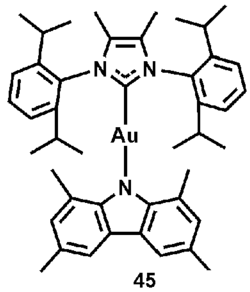

45

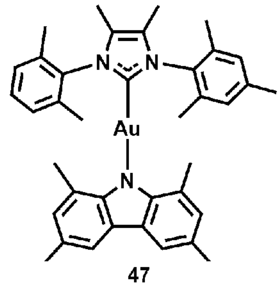

47

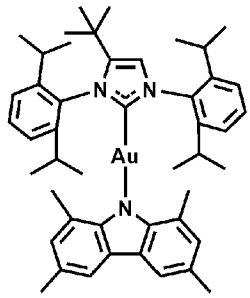

49

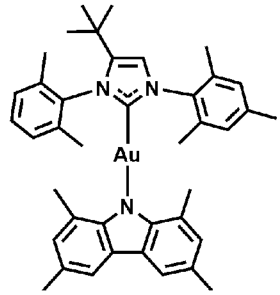

51

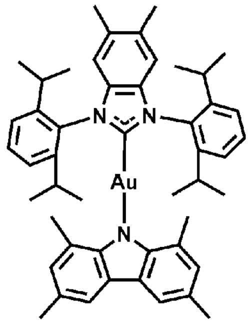

53

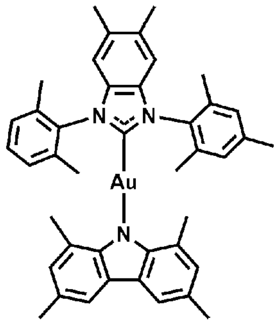

55

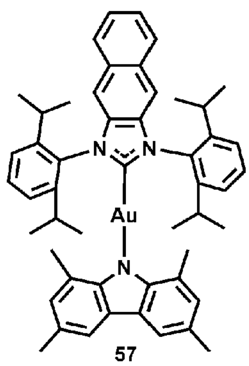

57

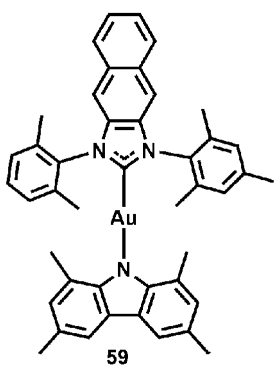

59

wherein, in Group 1, "Ph" represents a phenyl group.

A content (i.e., an amount) of the sensitizer in the emission layer may be in a range of about 1 weight (wt%) to about 50 wt%, or for example, about 10 wt% to about 20 wt%. When the content of the sensitizer in the emission layer is within this range, energy transfer in the emission layer may be effectively achieved. Thus, the organic light-emitting device may have high efficiency and long lifespan.

A difference (in electron volts, eV) between a lowest excited singlet energy level ($S_1$) of the sensitizer and a lowest excited triplet energy level ($T_1$) of the sensitizer may be about 0.3 eV or less, but embodiments are not limited thereto. For example, the $S_1$ and $T_1$ energy levels may be evaluated by density functional theory (DFT) using the Gaussian 09 program with the molecular structure optimization obtained at the B3LYP-basis level. When the difference is within this range, the reverse intersystem crossing of the sensitizer may be facilitated, thus providing improved efficiency and colorimetric purity of an organic light-emitting device.

In one or more embodiments, the sensitizer does not emit light.For example, the sensitizer may not emit light.

Host

In one or more embodiments, the host does not include a metal atom. For example, the host may not include a metal atom.

In some embodiments, the host may include at least one of a hole transporting host, an electron transporting host, or a bipolar host.

When the host includes a first compound and a second compound, the first compound and the second compound may respectively include a hole transporting host, an electron transporting host, or a bipolar host.

In some embodiments, the first compound may include a hole transporting host, and the second compound may include an electron transporting host; the first compound may include an electron transporting host, and the second compound may include a hole transporting host; the first compound and the second compound may respectively include a bipolar host; the first compound may include a hole transporting host, and the second compound may include a bipolar host; the first compound may include an electron transporting host, and the second compound may include a bipolar host; the first compound may include a bipolar host, and the second compound may include a hole transporting host; or the first compound may include a bipolar host, and the second compound may include an electron transporting host.

The electron transporting host may include at least one electron transporting moiety. The hole transporting host may include a hole transporting moiety and may not include an electron transporting moiety. The bipolar host may include at least one electron transporting moiety and at least one hole transporting moiety.

The electron transporting moiety may be a cyano group, -F, $-CFH_2$, $-CF_2H$, $-CF_3$, a $\pi$ electron-depleted nitrogen-containing $C_1$-$C_{60}$ cyclic group, or a group represented by one of Formulae ET-moiety:

ET-moiety

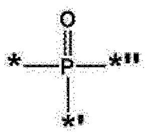 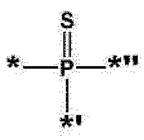 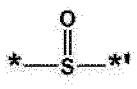 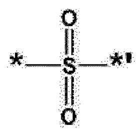

wherein, in Formulae ET-moiety, *, *', and *" may each indicate a binding site to an adjacent atom.

The hole transporting moiety may be a $\pi$ electron-rich $C_3$-$C_{60}$ cyclic group or a group represented by Formula HT-moiety:

HT-moiety

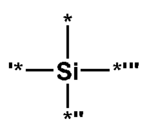

wherein, in Formula HT-moiety, *, *', *", and *'" each indicate a binding site to an adjacent atom.

In an embodiment, an electron transporting host may include at least one of a cyano group or a π electron-depleted nitrogen-containing $C_1$-$C_{60}$ cyclic group.

In one or more embodiments, the electron transporting host may include at least one cyano group.

In one or more embodiments, an electron transporting host may include a cyano group and at least one π electron-depleted nitrogen-containing $C_1$-$C_{60}$ cyclic group.

In some embodiments, the hole transporting host may include at least one π electron-rich $C_3$-$C_{60}$ cyclic group, and does not include an electron transporting moiety.

The term "π electron-depleted nitrogen-containing $C_1$-$C_{60}$ cyclic group" as used herein refers to a cyclic group having 1 to 60 carbon atoms and including at least one *-N=*' as a ring-forming moiety (wherein * and *' each indicate a binding site to an adjacent atom). For example, the π electron-depleted nitrogen-containing $C_1$-$C_{60}$ cyclic group may be a) a first ring, b) a condensed ring in which at least two first rings are condensed, or c) a condensed ring in which at least one first ring and at least one second ring are condensed.

The "first ring" as used herein may be an imidazole group, a pyrazole group, a thiazole group, an isothiazole group, an oxazole group, an isoxazole group, a pyridine group, a pyrazine group, a pyridazine group, a pyrimidine group, a triazole group, a tetrazole group, an oxadiazole group, a triazine group, or a thiadiazole group.

The "second ring" as used herein may be a benzene group, a cyclopentadiene group, a pyrrole group, a furan group, a thiophene group, or a silole group.

In some embodiments, the π electron-depleted nitrogen-containing $C_1$-$C_{60}$ cyclic group may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, an acridine group, or a pyridopyrazine group:

The term "π electron-rich $C_3$-$C_{60}$ cyclic group" as used herein refers to a cyclic group having 3 to 60 carbon atoms and not including *-N=*' as a ring-forming moiety (wherein * and *' each indicate a binding site to an adjacent atom). For example, the π electron-rich $C_3$-$C_{60}$ cyclic group may be a) a second ring or b) a condensed ring in which at least two second rings are condensed.

In some embodiments, the π electron-rich $C_3$-$C_{60}$ cyclic group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a carbazole group, a dibenzosilole group, an indenocarbazole group, an indolocarbazole group, a benzofurocarbazole group, a benzothienocarbazole group, a benzosilolocarbazole group, a triindolobenzene group, a pyrrolophenanthrene group, a furanophenanthrene group, a thienophenanthrene group, a benzonaphthofuran group, a benzonaphthothiophene group, an (indolo)phenanthrene group, a (benzofurano)phenanthrene group, or a (benzothieno)phenanthrene group.

In some embodiments, the electron transporting host may be a compound represented by Formula E-1, and the hole transporting host may be a compound represented by Formula H-1, but embodiments are not limited thereto:

Formula E-1 $$[Ar_{301}]_{xb11}\text{-}[(L_{301})_{xb1}\text{-}R_{301}]_{xb21}$$

wherein, in Formula E-1,

$Ar_{301}$ may be a substituted or unsubstituted $C_5$-$C_{60}$ carbocyclic group or a substituted or unsubstituted $C_1$-$C_{60}$ heterocyclic group,

xb11 may be 1, 2, or 3,

$L_{301}$ may each independently be a single bond, a substituted or unsubstituted $C_5$-$C_{60}$ carbocyclic group, a substituted or unsubstituted $C_1$-$C_{60}$ heterocyclic group, or a group represented by one of following Formulae, wherein in the following Formulae, *, *', and *" may each indicate a binding site to an adjacent atom,

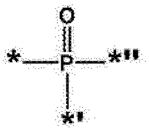 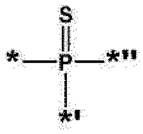 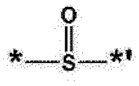 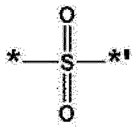

xb1 may be an integer from 1 to 5,

$R_{301}$ may be hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_{301}$)($Q_{302}$)($Q_{303}$), -N($Q_{301}$)($Q_{302}$), -B($Q_{301}$)($Q_{302}$), - C(=O)($Q_{301}$), -S(=O)$_2$($Q_{301}$), -S(=O)($Q_{301}$), -P(=O)($Q_{301}$)($Q_{302}$), or - P(=S)($Q_{301}$)($Q_{302}$),

xb21 may be an integer from 1 to 5,

wherein $Q_{301}$ to $Q_{303}$ may each independently be a $C_1$-$C_{10}$ alkyl group, a $C_1$-$C_{10}$ alkoxy group, a $C_1$-$C_{10}$alkylthio group, a phenyl group, a biphenyl group, a terphenyl group, or a naphthyl group, and

at least one of Conditions A, B, and C may be satisfied:

Condition A

wherein, at least one of $Ar_{301}$, $L_{301}$, and $R_{301}$ in Formula E-1 may each independently include a $\pi$ electron-depleted nitrogen-containing $C_1$-$C_{60}$ cyclic group,

Condition B

wherein, in Formula E-1, $L_{301}$ may be a group represented by one of the following Formulae, and

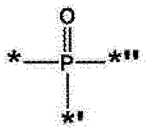 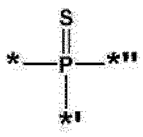 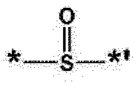 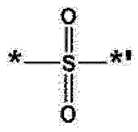

Condition C

wherein, in Formula E-1, $R_{301}$ may be a cyano group, -S(=O)$_2$($Q_{301}$), - S(=O)($Q_{301}$), -P(=O)($Q_{301}$)($Q_{302}$), or -P(=S)($Q_{301}$)($Q_{302}$)

Formula H-1 $Ar_{401}$-$(L_{401})_{xd1}$-$(Ar_{402})_{xd11}$

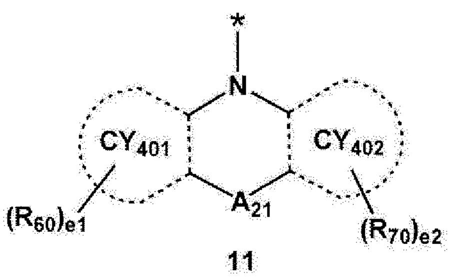

11

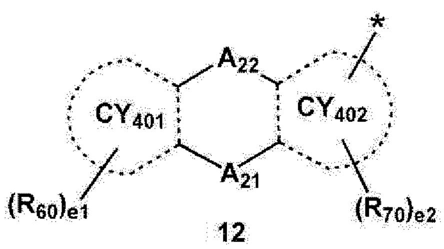

12

wherein, in Formulae H-1, 11, and 12,

$L_{401}$ may be:

a single bond; or

a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a corozene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group, each unsubstituted or substituted with at least one of deuterium, a $C_1$-$C_{10}$ alkyl group, a $C_1$-$C_{10}$ alkoxy group, a $C_1$-$C_{10}$alkylthio group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, or - Si(Q401)(Q402)(Q403),

xd1 may be an integer from 1 to 10; and when xd1 is 2 or greater, at least two $L_{401}$ groups may be identical to or different from each other,

$Ar_{401}$ may be a group represented by Formulae 11 or 12,

$Ar_{402}$ may be:

a group represented by Formulae 11 or 12, a phenyl group, a naphthyl group, a fluorenyl group, a carbazolyl group, a dibenzofuranyl group, a dibenzothiophenyl group, a biphenyl group, a terphenyl group, or a triphenylenyl group; or

a phenyl group, a naphthyl group, a fluorenyl group, a carbazolyl group, a dibenzofuranyl group, a dibenzothiophenyl group, a biphenyl group, a terphenyl group, and a triphenylenyl group, each substituted with at least one of deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$alkylthio group, a phenyl group, a naphthyl group, a fluorenyl group, a carbazolyl group, a dibenzofuranyl group, a dibenzothiophenyl group, a biphenyl group, a terphenyl group, a triphenylenyl group, or a combination thereof;

xd11 may be an integer from 1 to 5

$CY_{401}$ and $CY_{402}$ may each independently be a benzene group, a naphthalene group, a fluorene group, a carbazole group, a benzocarbazole group, an indolocarbazole group, a dibenzofuran group, a dibenzothiophene group, a dibenzosilole group, a benzonaphthofuran group, a benzonaphthothiophene group, or a benzonaphthosilole group,

$A_{21}$ may be a single bond, O, S, $N(R_{51})$, $C(R_{51})(R_{52})$, or $Si(R_{51})(R_{52})$,

$A_{22}$ may be a single bond, O, S, $N(R_{53})$, $C(R_{53})(R_{54})$, or $Si(R_{53})(R_{54})$,

at least one of $A_{21}$ and $A_{22}$ in Formula 12 may not be a single bond,

$R_{51}$ to $R_{54}$, $R_{60}$, and $R_{70}$ may each independently be:

hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, or a $C_1$-$C_{20}$alkylthio group;

a $C_1$-$C_{20}$ alkyl group, a $C_1$-$C_{20}$ alkoxy group, or a $C_1$-$C_{30}$ alkylthio group, each substituted with at least one of deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, a dibenzothiophenyl group, or a combination thereof;

a $\pi$ electron-rich nitrogen-free $C_3$-$C_{60}$ cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group);

a $\pi$ electron-rich nitrogen-free $C_3$-$C_{60}$ cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group) substituted with at least one of deuterium, a hydroxyl group, an amino group, an amidino group, a hydrazine group, a hydrazone group, a carboxylic acid group or a salt thereof, a sulfonic acid group or a salt

thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a naphthyl group, a fluorenyl group, a carbazolyl group, a dibenzofuranyl group, a dibenzothiophenyl group, a biphenyl group, or a combination thereof, or

-Si(Q404)(Q405)(Q406),

e1 and e2 may each independently be an integer from 0 to 10,
wherein $Q_{401}$ to $Q_{406}$ may each independently be hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, a dibenzothiophenyl group, a biphenyl group, a terphenyl group, or a triphenylenyl group, and
* indicates a binding site to an adjacent atom.

In some embodiments, in Formula E-1, $Ar_{301}$ and $L_{301}$ may each independently be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one of deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, $-P(=O)(Q_{31})(Q_{32})$, or a combination thereof,

at least one of $L_{301}$ in the number of xb1 may each independently be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one of deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, $-P(=O)(Q_{31})(Q_{32})$, or a combination thereof, and

$R_{301}$ may be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$alkylthio group, a phenyl group, a biphenyl group, a terphenyl group, a tetraphenyl group, a naphthyl group, a cyano group-containing phenyl group, a cyano group-containing biphenyl group, a cyano group-containing terphenyl group, a cyano group-containing tetraphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$,

wherein $Q_{31}$ to $Q_{33}$ may each independently be a $C_1$-$C_{10}$ alkyl group, a $C_1$-$C_{10}$ alkoxy group, a $C_1$-$C_{10}$alkylthio group, a phenyl group, a biphenyl group, a terphenyl group, or a naphthyl group, but embodiments are not limited thereto.

According to another embodiment, $Ar_{301}$ may be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, or a dibenzothiophene group, each unsubstituted or substituted with at least one of deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{10}$alkylthio group, a phenyl group, a biphenyl group, a terphenyl group, a naphthyl group, a phenyl group substituted with at least one cyano group, a biphenyl group substituted with at least one cyano group, a terphenyl group substituted with at least one cyano group, a naphthyl group substituted with at least one cyano group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$; or

a group represented by one of Formulae 5-1 to 5-3 or 6-1 to 6-33, and

$L_{301}$ may be a group represented by one of Formulae 5-1 to 5-3 or 6-1 to 6-33:

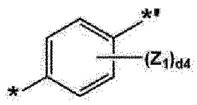
5-1

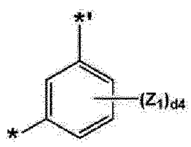
5-2

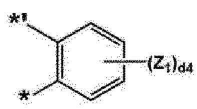
5-3

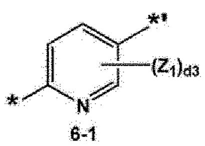
6-1

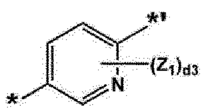
6-2

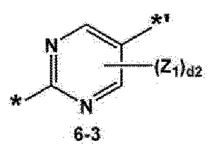
6-3

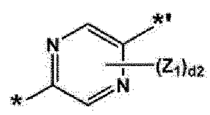
6-4

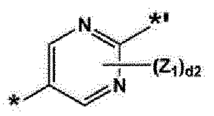
6-5

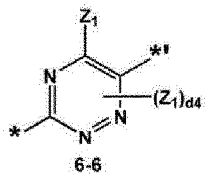
6-6

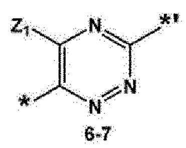
6-7

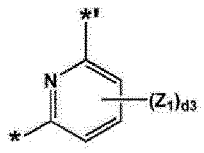
6-8

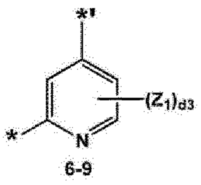
6-9

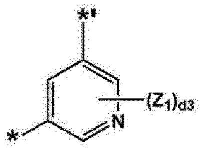
6-10

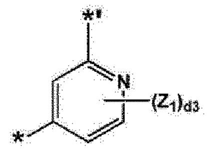
6-11

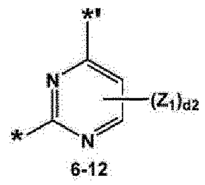
6-12

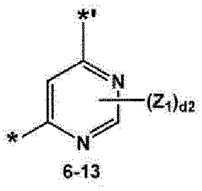
6-13

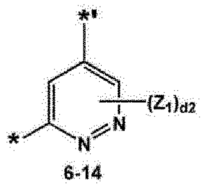
6-14

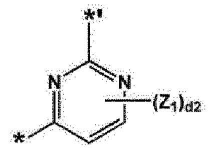
6-15

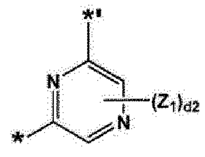
6-16

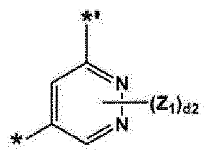
6-17

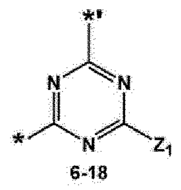
6-18

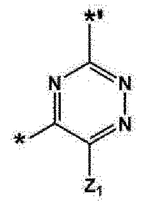
6-19

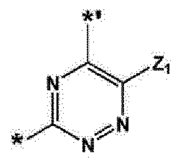
6-20

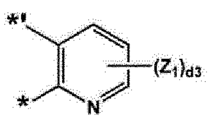
6-21

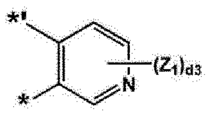
6-22

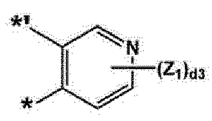
6-23

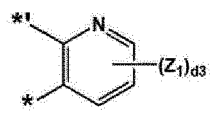
6-24

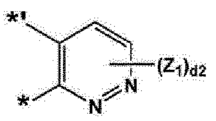
6-25

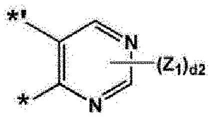
6-26

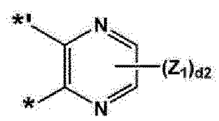
6-27

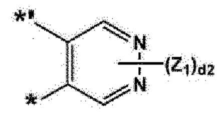
6-28

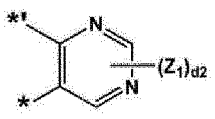
6-29

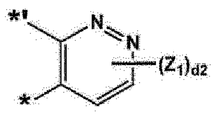
6-30

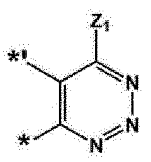
6-31

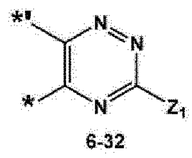
6-32

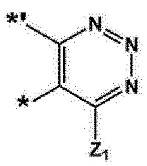
6-33

wherein, in Formulae 5-1 to 5-3 and 6-1 to 6-33,

$Z_1$ may be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a

$C_1$-$C_{20}$alkylthio group, a phenyl group, a biphenyl group, a terphenyl group, a naphthyl group, a phenyl group substituted with at least one cyano group, a biphenyl group substituted with at least one cyano group, a terphenyl group substituted with at least one cyano group, a naphthyl group substituted with at least one cyano group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$, - $S(=O)_2(Q_{31})$, or $-P(=O)(Q_{31})(Q_{32})$,
d4 may be 0, 1, 2, 3, or 4,
d3 may be 0, 1, 2, or 3,
d2 may be 0, 1, or 2, and
* and *' each indicate a binding site to an adjacent atom,
wherein $Q_{31}$ to $Q_{33}$ may respectively be understood by referring to the descriptions of $Q_{31}$ to $Q_{33}$ provided herein.

In one or more embodiments, $L_{301}$ may be a group represented by one of Formulae 5-2, 5-3, or 6-8 to 6-33.

In one or more embodiments, $R_{301}$ may be a cyano group or a group represented by one of Formulae 7-1 to 7-18, and at least one of $Ar_{402}$ in the number of xd11 may be a group represented by one of Formulae 7-1 to 7-18, but embodiments are not limited thereto:

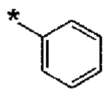
7-1
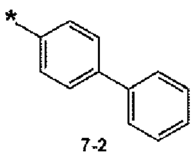
7-2
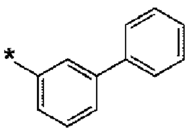
7-3
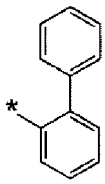
7-4
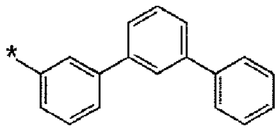
7-5

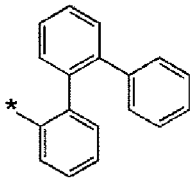
7-6
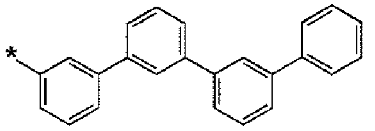
7-7
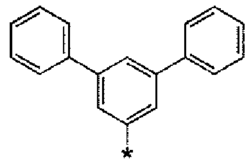
7-8
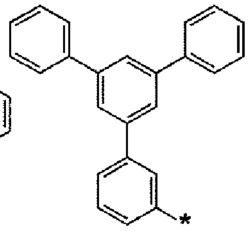
7-9

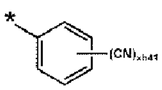
7-10
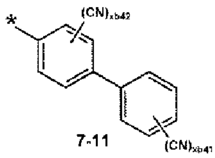
7-11
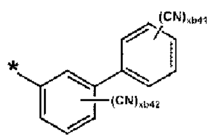
7-12
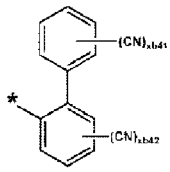
7-13

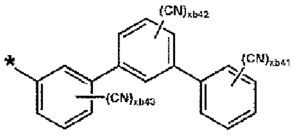
7-14
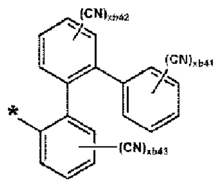
7-15
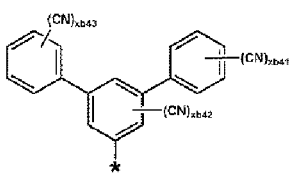
7-16

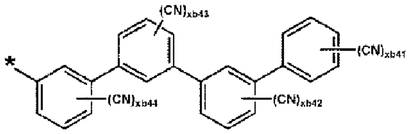

7-17

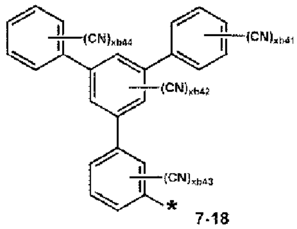

7-18

wherein, in Formulae 7-1 to 7-18,

xb41 to xb44 may each be 0, 1, or 2, provided that xb41 in Formula 7-10 may not be 0, xb41 +xb42 in Formulae 7-11 to 7-13 may not be 0, xb41 +xb42+xb43 in Formulae 7-14 to 7-16 may not be 0, xb41+xb42+xb43+xb44 in Formulae 7-17 and 7-18 may not be 0, and * indicates a binding site to an adjacent atom.

In Formula E-1, at least two $Ar_{301}$(s) may be identical to or different from each other, and at least two $L_{301}$(s) may be identical to or different from each other. In Formula H-1, at least two $L_{401}$(s) may be identical to or different from each other, and at least two $Ar_{402}$(s) may be identical to or different from each other.

The electron transporting host may be, for example, a compound represented by one of Groups HE1 to HE7, but embodiments are not limited thereto:

## Group HE1

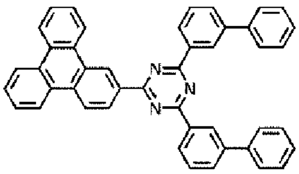

H-E1

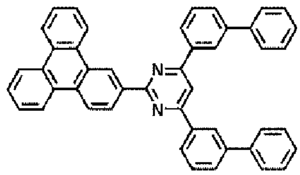

H-E2

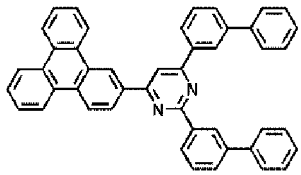

H-E3

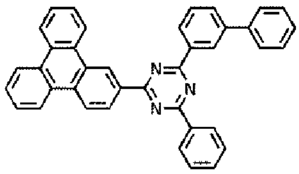

H-E4

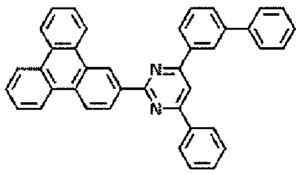

H-E5

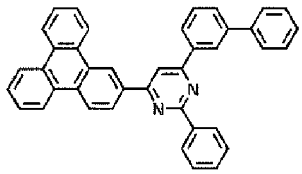

H-E6

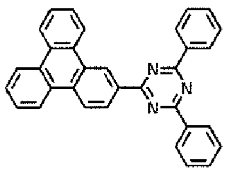

H-E7

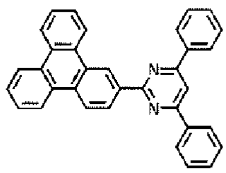

H-E8

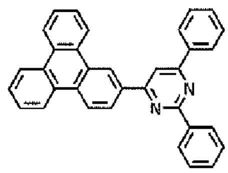

H-E9

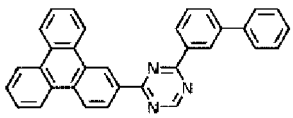

H-E10

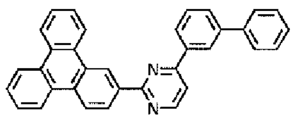

H-E11

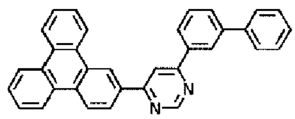

H-E12

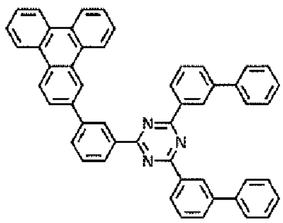

H-E13

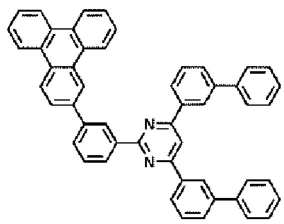

H-E14

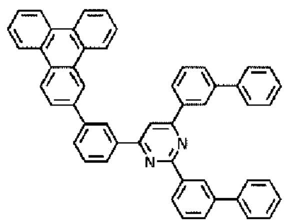

H-E15

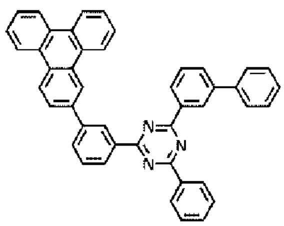

H-E16

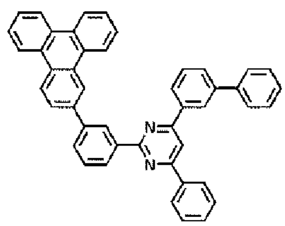

H-E17

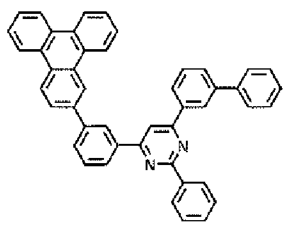

H-E18

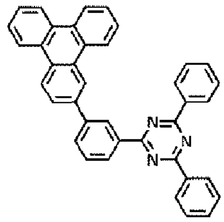

H-E19

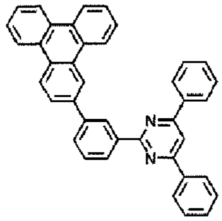

H-E20

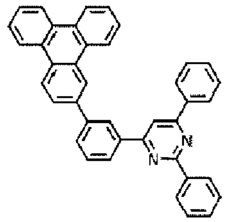

H-E21

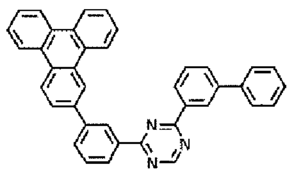

H-E22

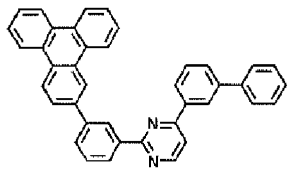

H-E23

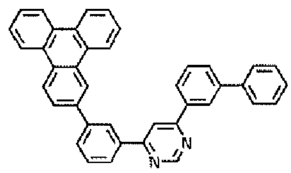

H-E24

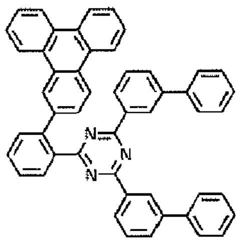

H-E25

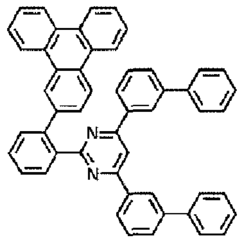

H-E26

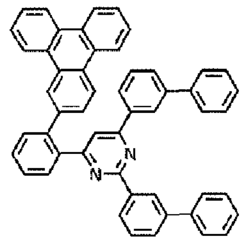

H-E27

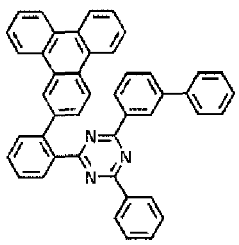

H-E28

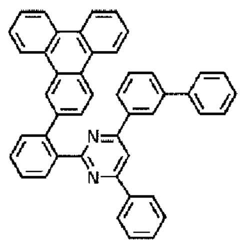

H-E29

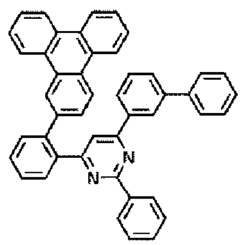

H-E30

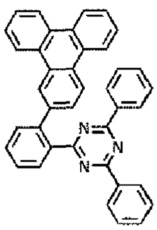

H-E31

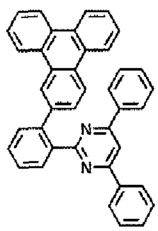

H-E32

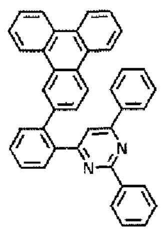

H-E33

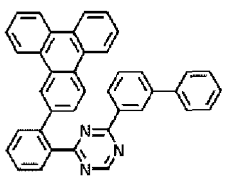

H-E34

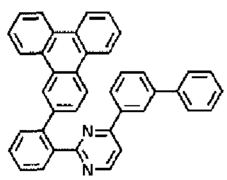

H-E35

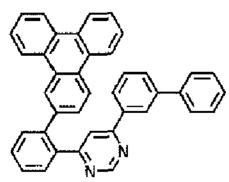

H-E36

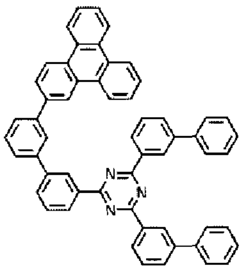

H-E37

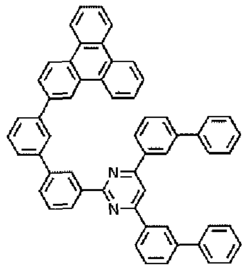

H-E38

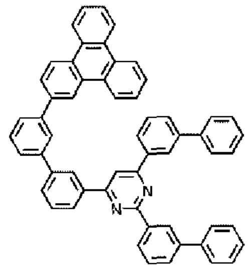

H-E39

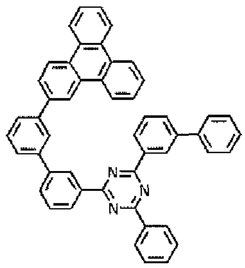

H-E40

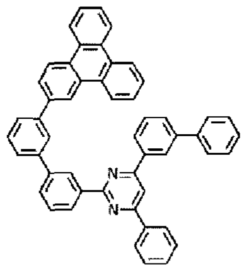

H-E41

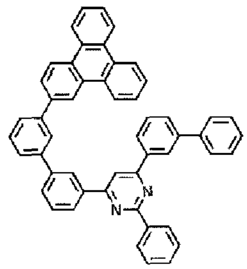

H-E42

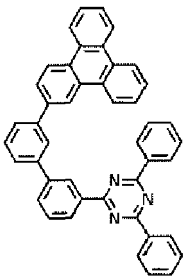

H-E43

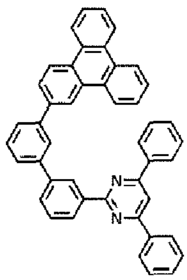

H-E44

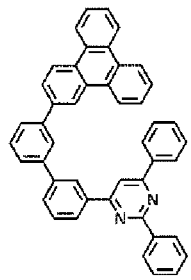

H-E45

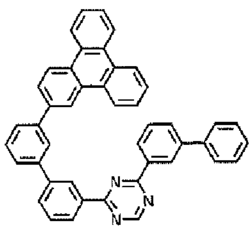

H-E46

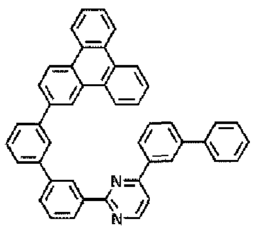

H-E47

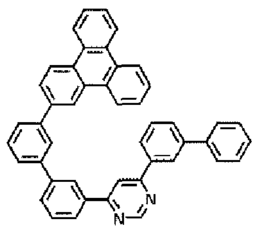

H-E48

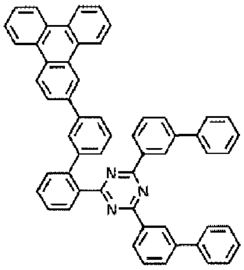
H-E49

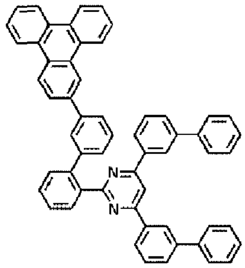
H-E50

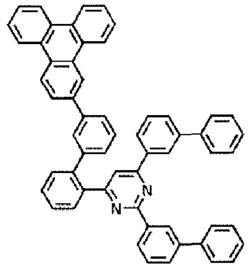
H-E51

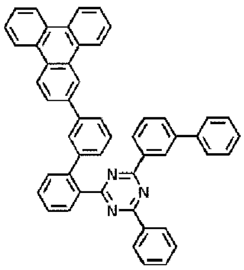
H-E52

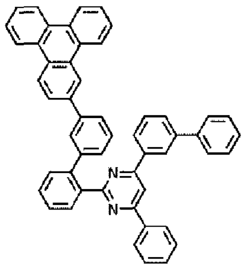
H-E53

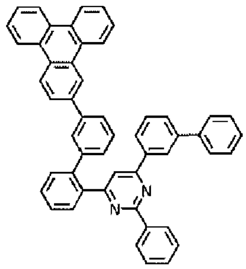
H-E54

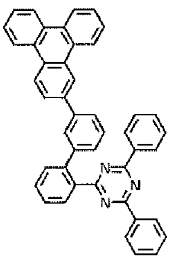
H-E55

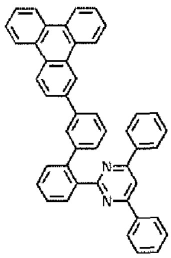
H-E56

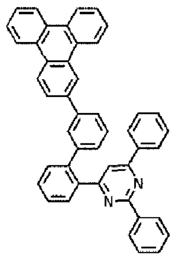
H-E57

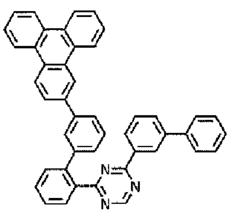
H-E58

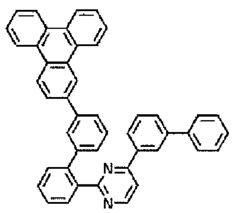
H-E59

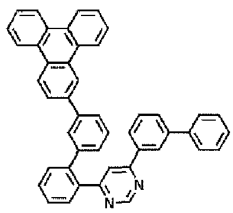
H-E60

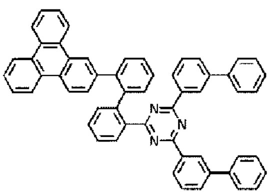
H-E61

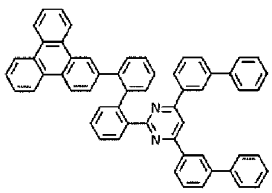
H-E62

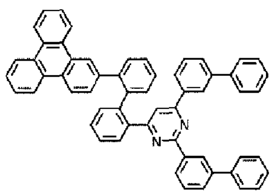
H-E63

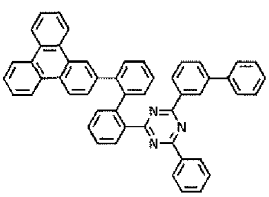
H-E64

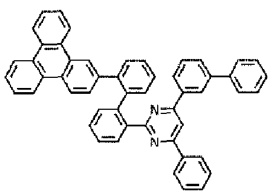
H-E65

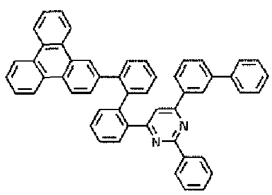
H-E66

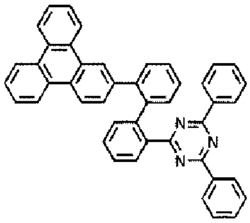
H-E67

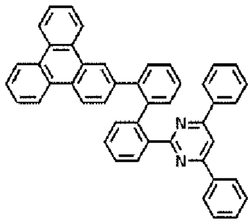
H-E68

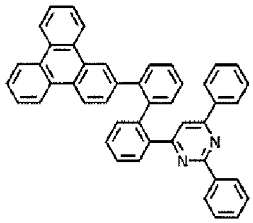
H-E69

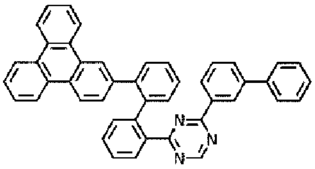
H-E70

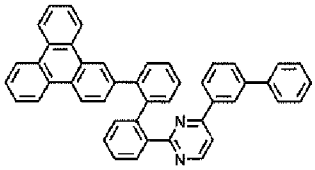
H-E71

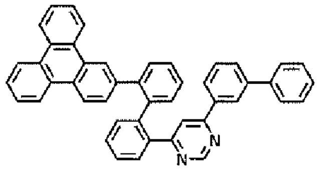
H-E72

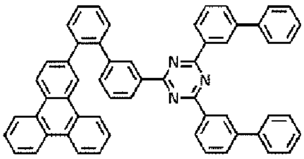
H-E73

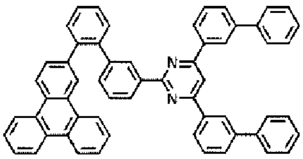
H-E74

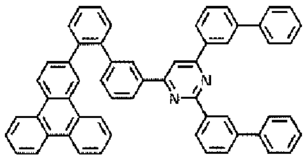
H-E75

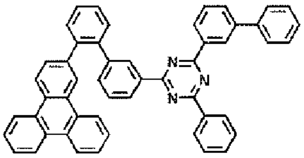
H-E76

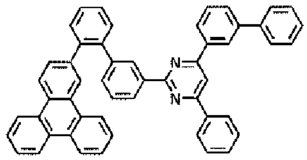
H-E77

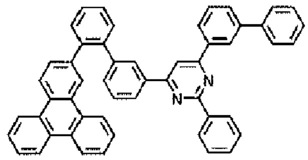
H-E78

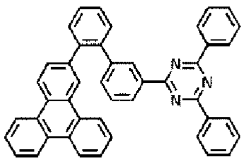
H-E79

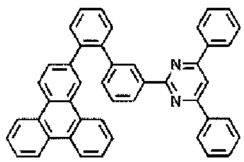
H-E80

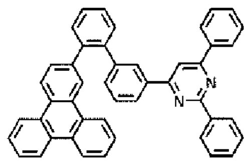
H-E81

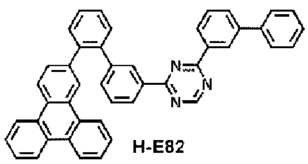
H-E82

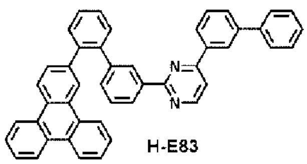
H-E83

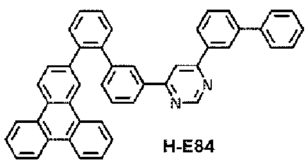
H-E84

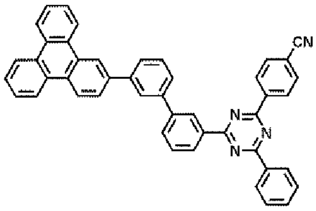
H-E(1)

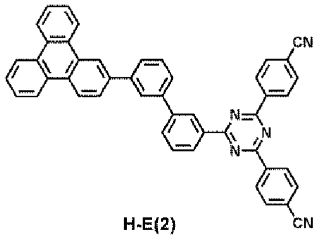
H-E(2)

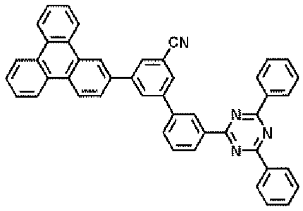
H-E(3)

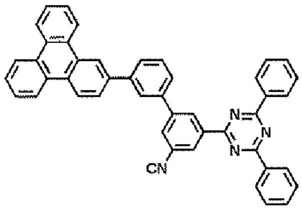
H-E(4)

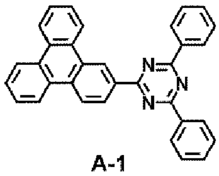
A-1

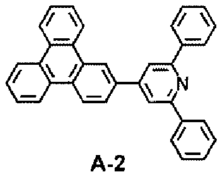
A-2

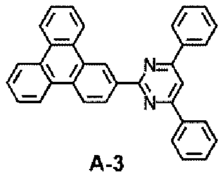
A-3

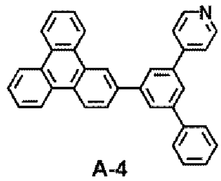
A-4

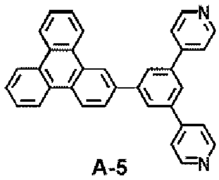
A-5

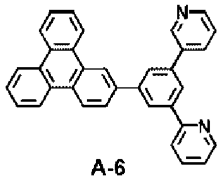
A-6

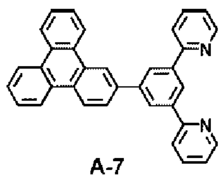
A-7

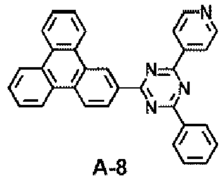
A-8

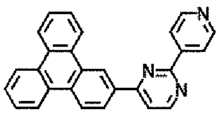
A-9

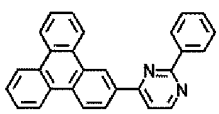
A-10

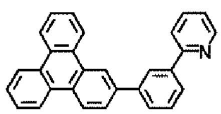
A-11

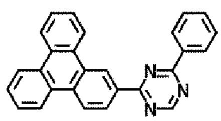
A-12

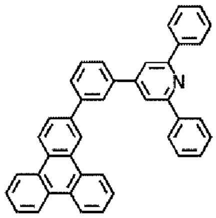
A-13

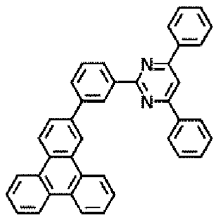
A-14

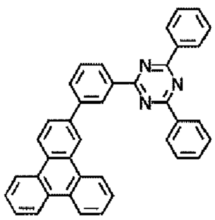
A-15

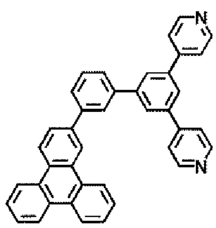
A-16

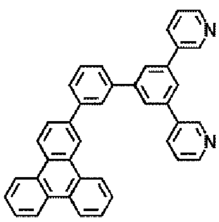
A-17

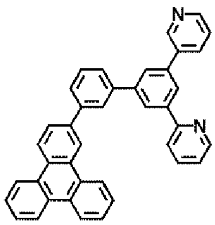
A-18

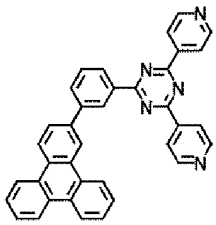
A-19

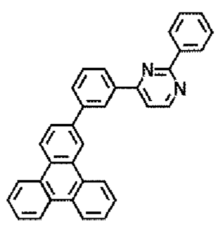
A-20

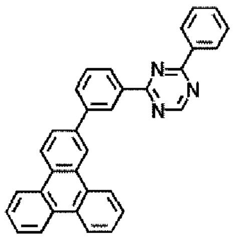
A-21

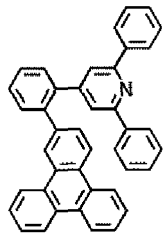
A-22

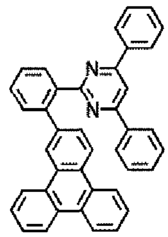
A-23

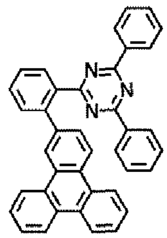
A-24

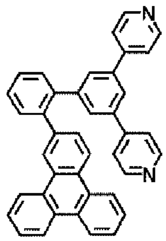
A-25

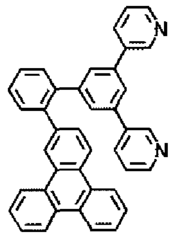
A-26

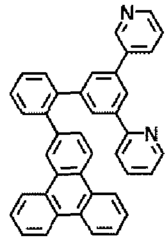
A-27

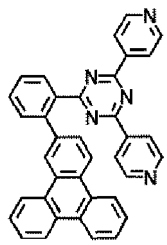
A-28

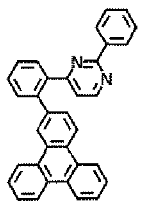
A-29

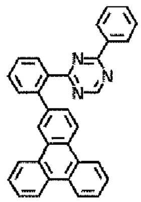
A-30

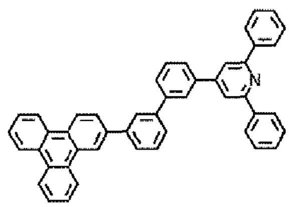
A-31

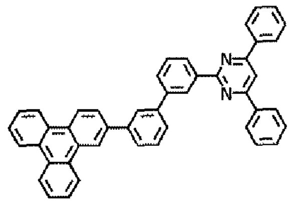
A-32

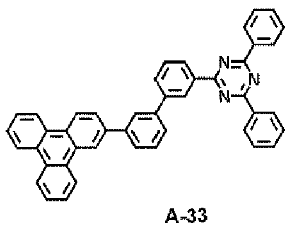
A-33

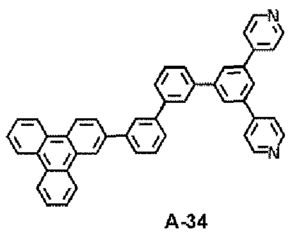
A-34

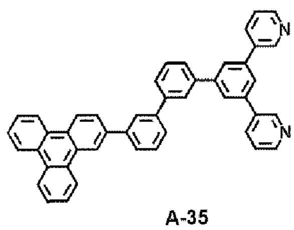
A-35

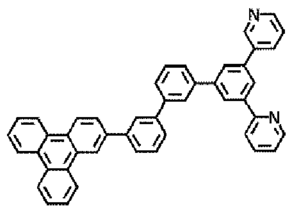
A-36

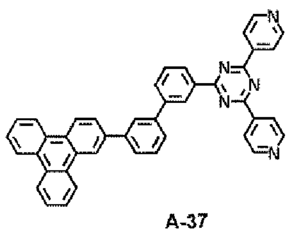
A-37

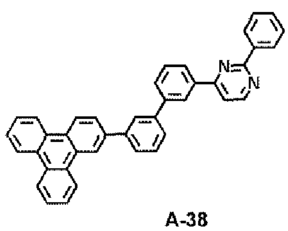
A-38

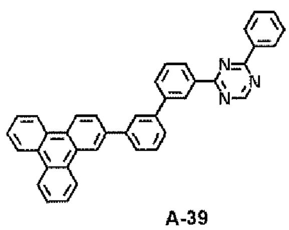
A-39

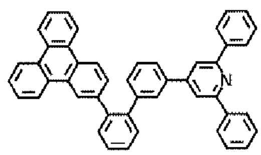
A-40

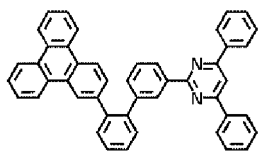

A-41

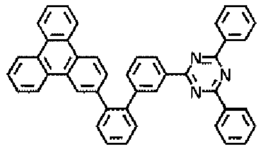

A-42

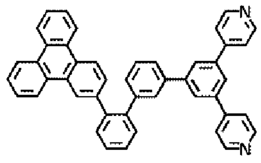

A-43

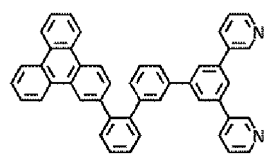

A-44

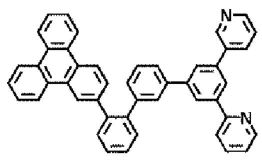

A-45

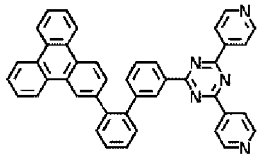

A-46

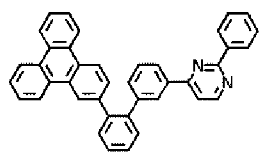

A-47

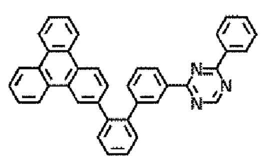

A-48

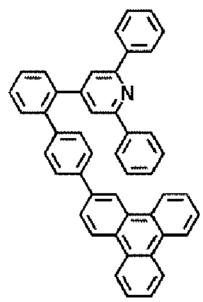

A-49

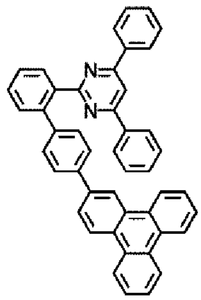

A-50

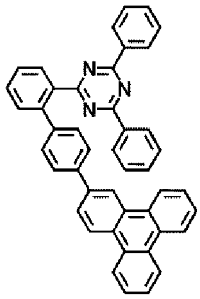

A-51

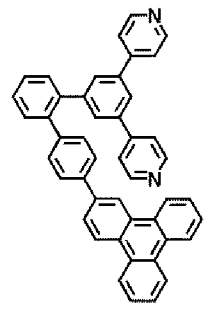

A-52

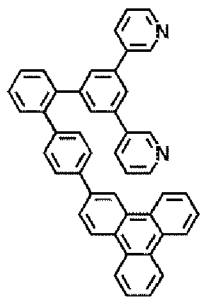

A-53

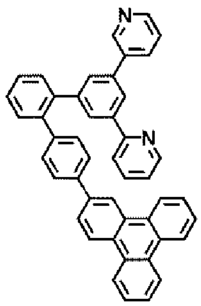

A-54

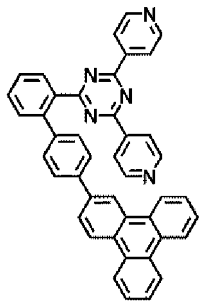

A-55

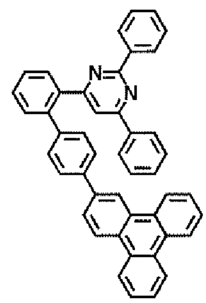

A-56

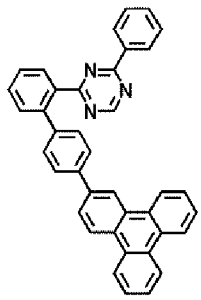

A-57

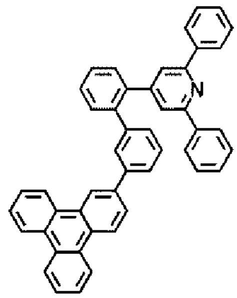

A-58

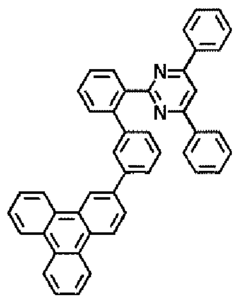

A-59

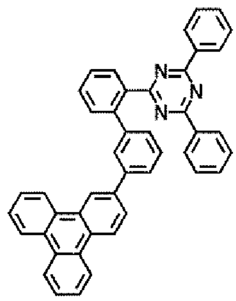

A-60

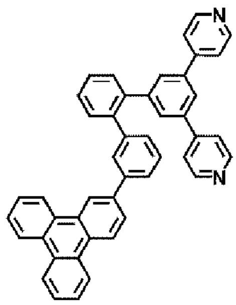

A-61

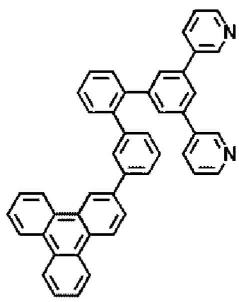

A-62

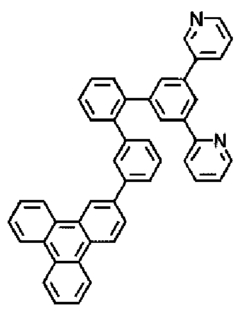

A-63

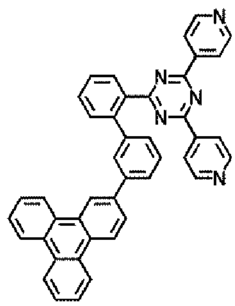

A-64

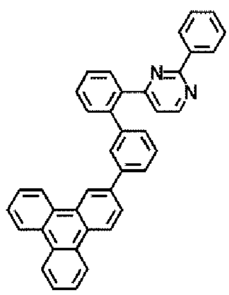

A-65

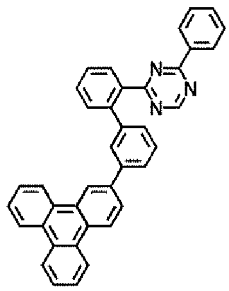

A-66

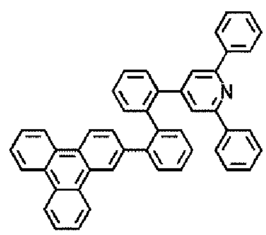

A-67

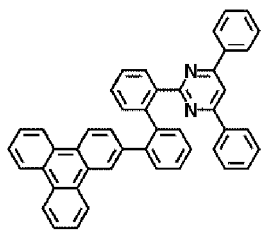

A-68

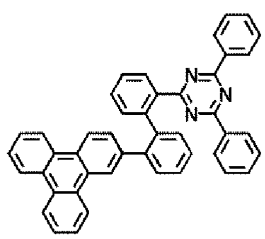

A-69

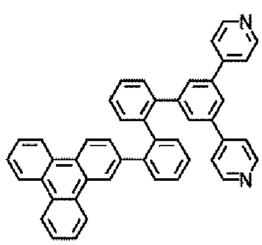

A-70

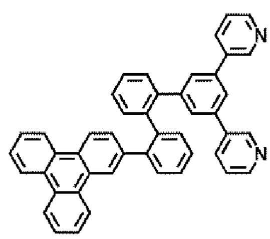

A-71

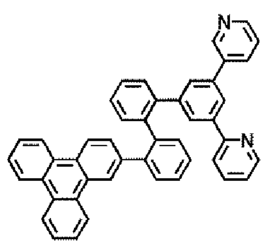

A-72

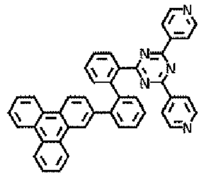
A-73

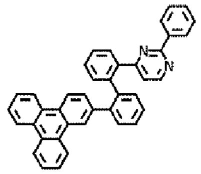
A-74

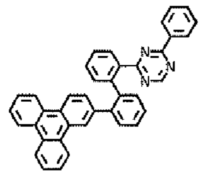
A-75

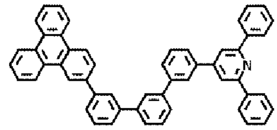
A-76

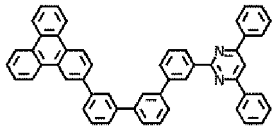
A-77

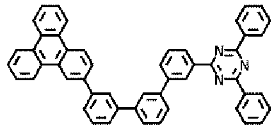
A-78

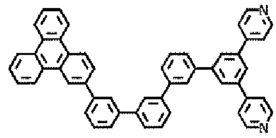
A-79

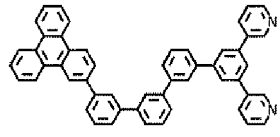
A-80

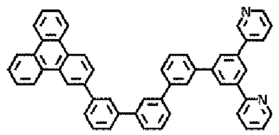
A-81

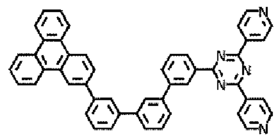
A-82

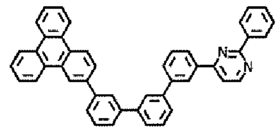
A-83

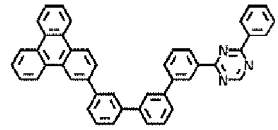
A-84

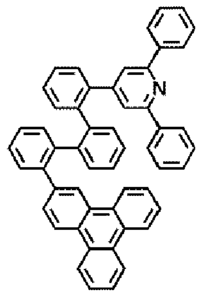
A-85

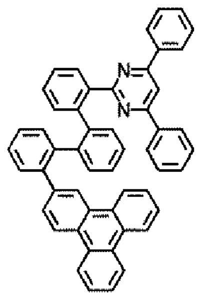
A-86

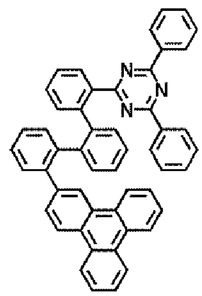
A-87

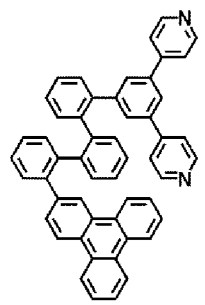
A-88

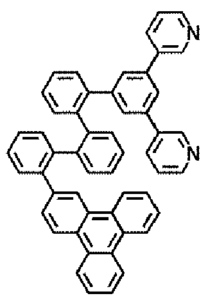
A-89

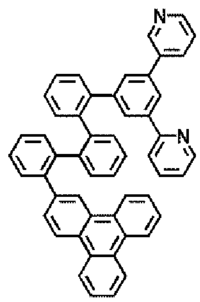
A-90

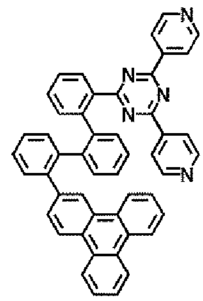
A-91

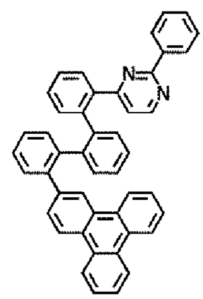
A-92

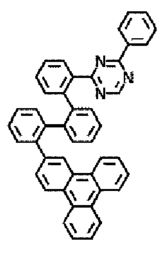
A-93

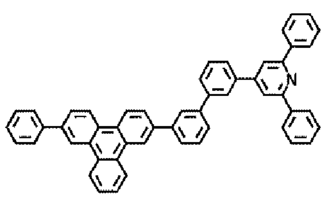
A-94

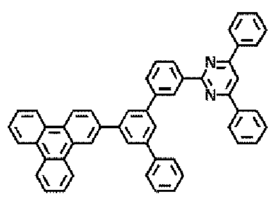
A-95

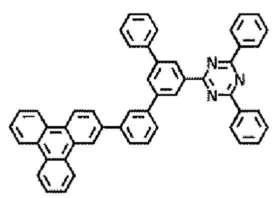
A-96

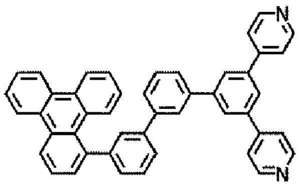

A-97

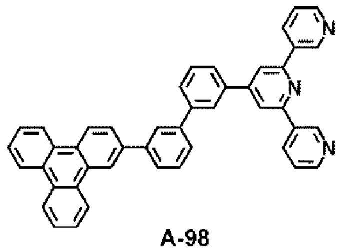

A-98

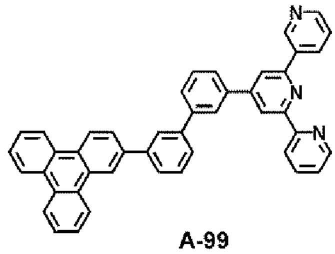

A-99

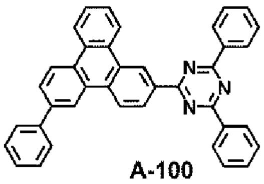

A-100

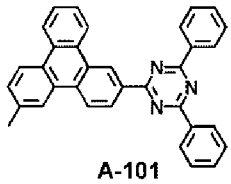

A-101

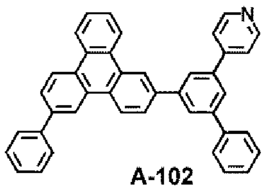

A-102

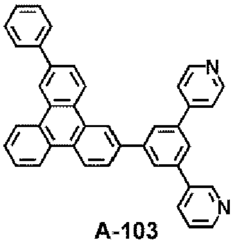

A-103

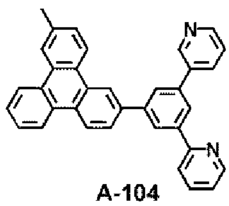

A-104

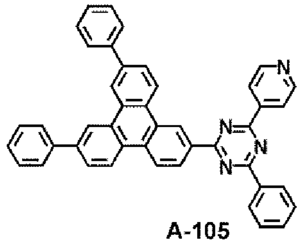

A-105

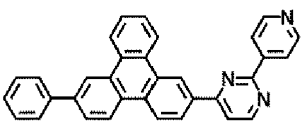

A-106

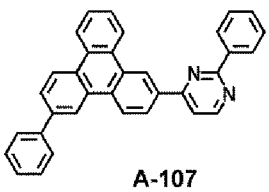

A-107

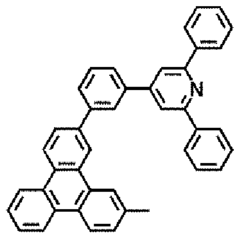

A-108

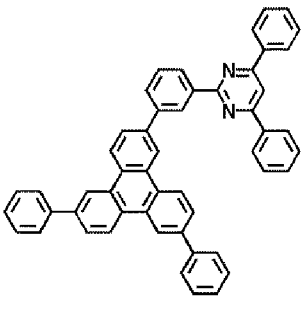

A-109

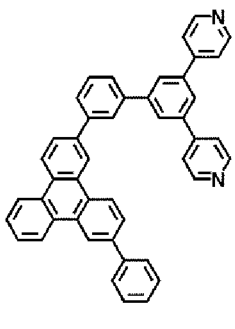

A-110

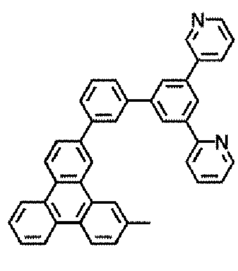

A-111

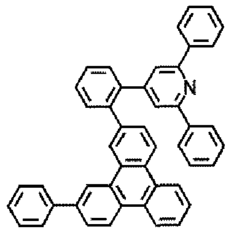

A-112

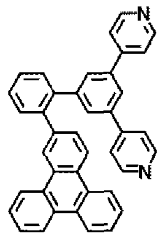

A-113

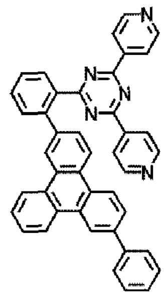

A-114

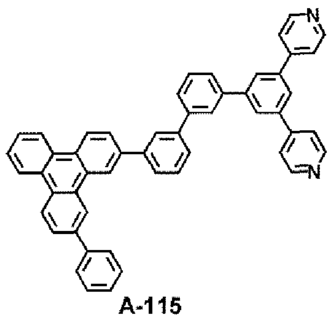

A-115

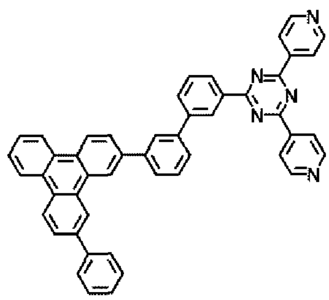

A-116

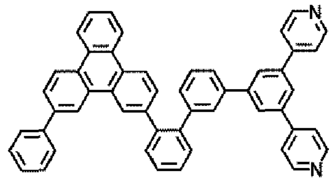

A-117

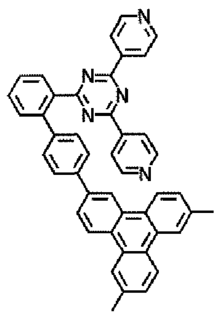

A-118

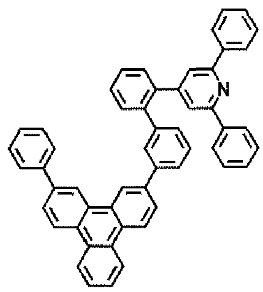

A-119

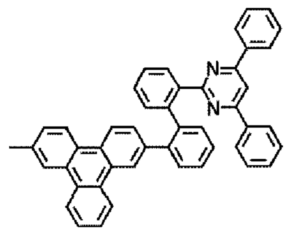

A-120

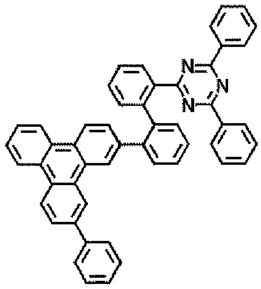

A-121

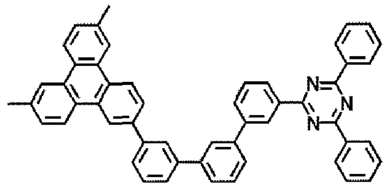

A-122

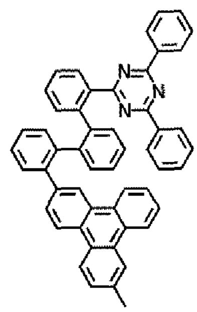

A-123

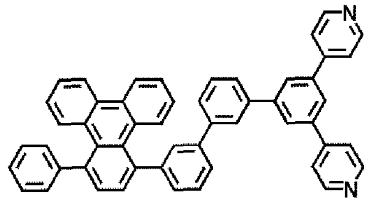

A-124

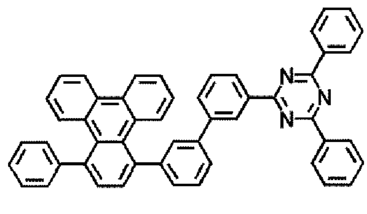

A-125

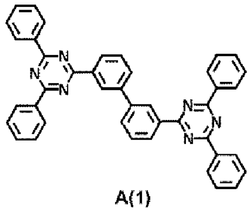

A(1)

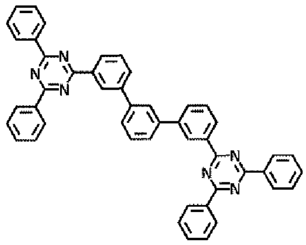

A(2)

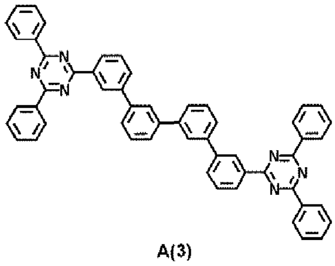

A(3)

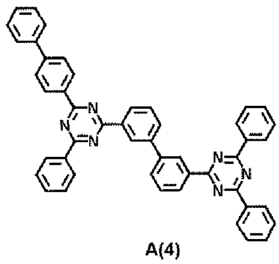

A(4)

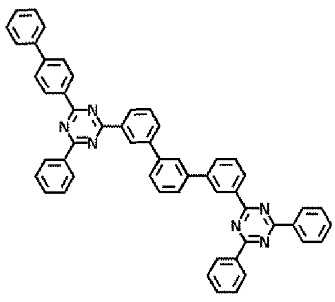

A(5)

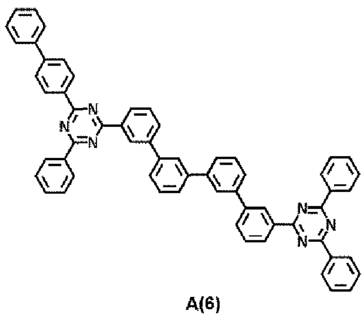

A(6)

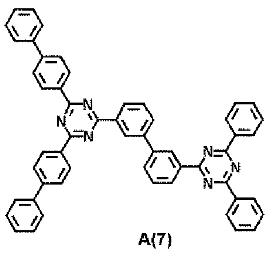

A(7)

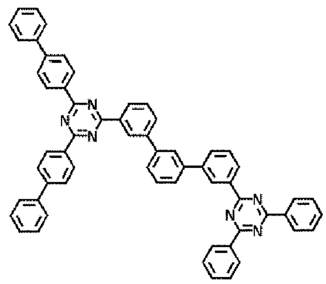

A(8)

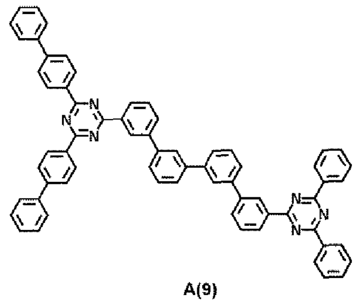

A(9)

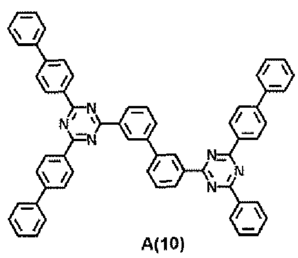

A(10)

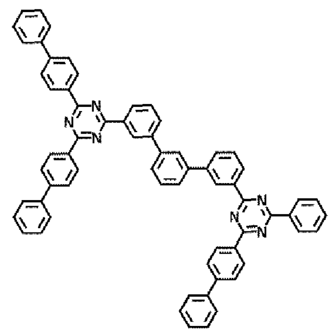

A(11)

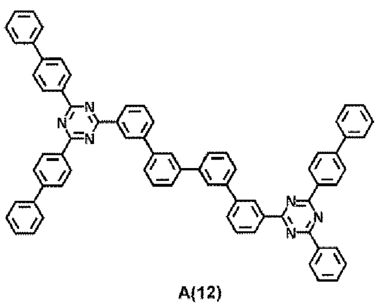

A(12)

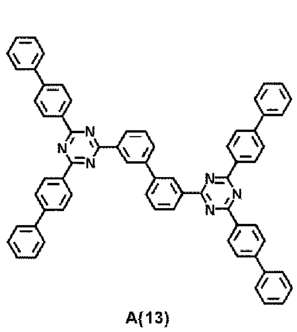

A(13)

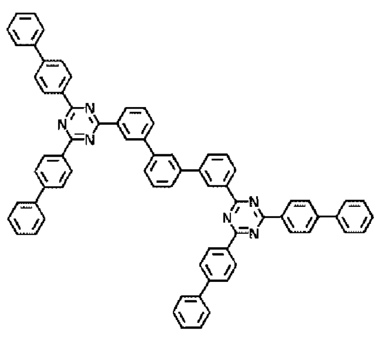

A(14)

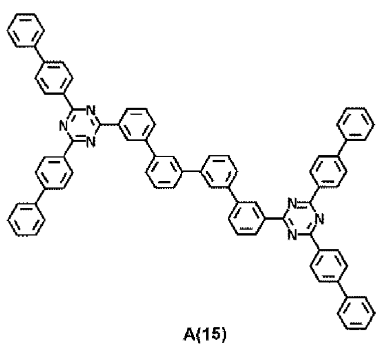

A(15)

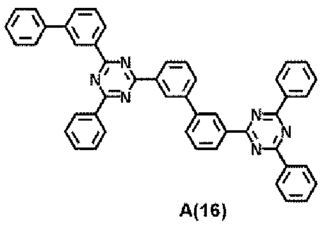

A(16)

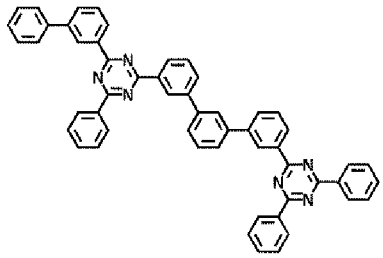

A(17)

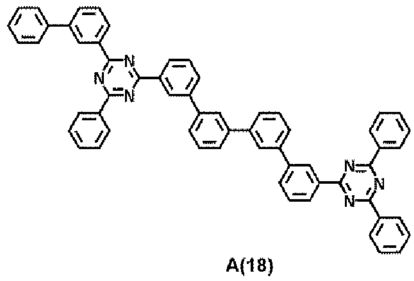

A(18)

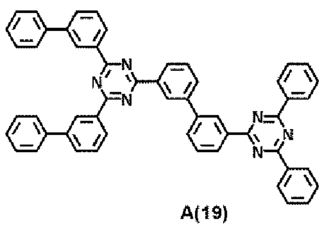

A(19)

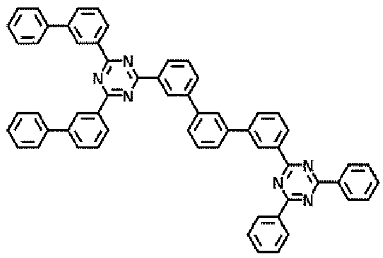

A(20)

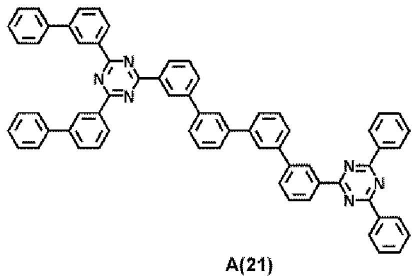

A(21)

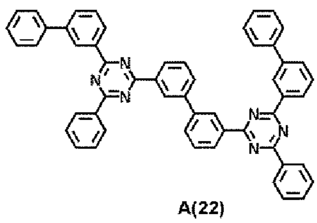

A(22)

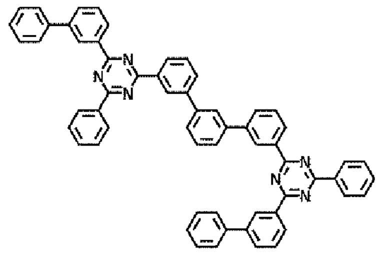

A(23)

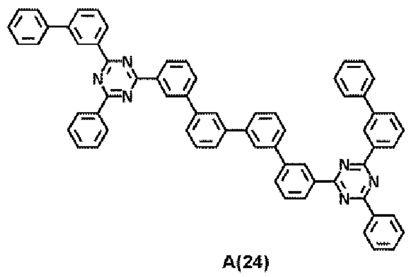

A(24)

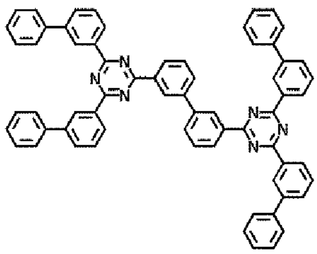

A(25)

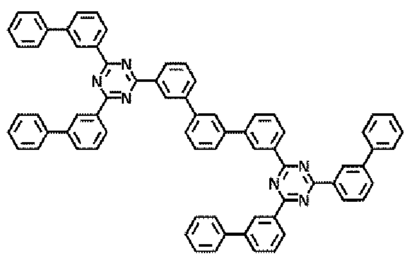

A(26)

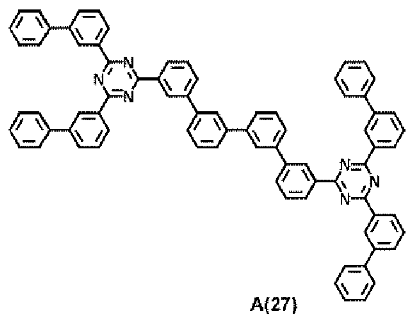

A(27)

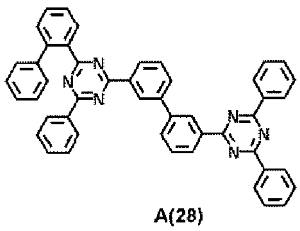

A(28)

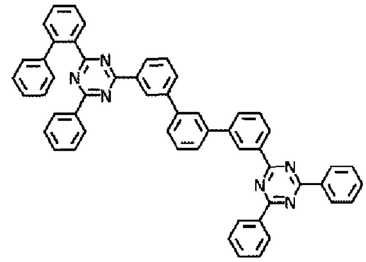

A(29)

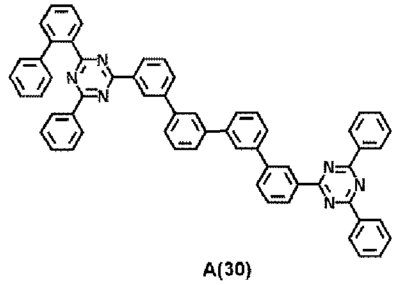

A(30)

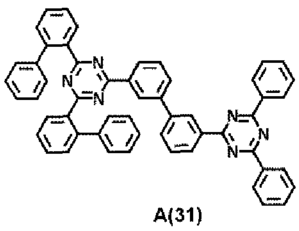

A(31)

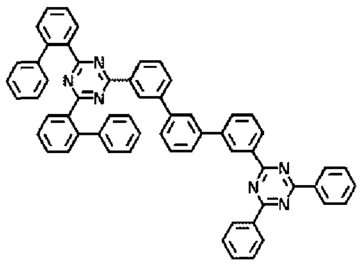

A(32)

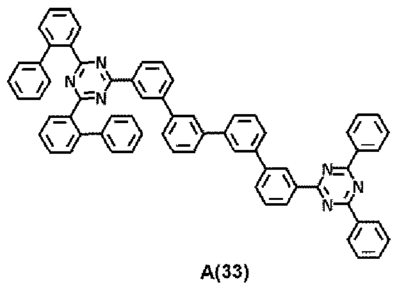

A(33)

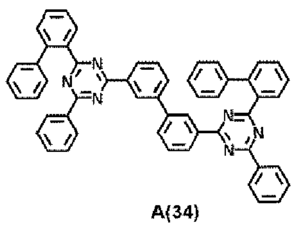

A(34)

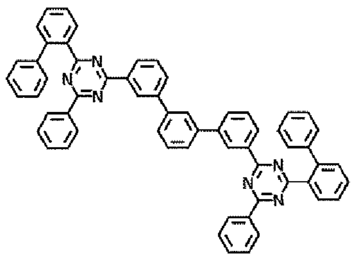

A(35)

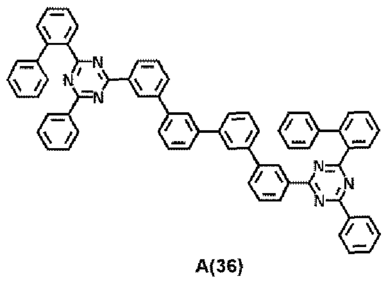

A(36)

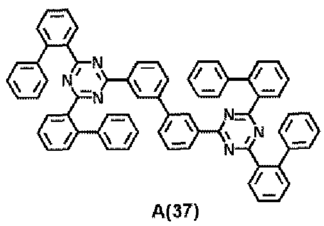

A(37)

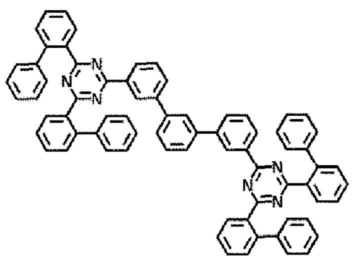

A(38)

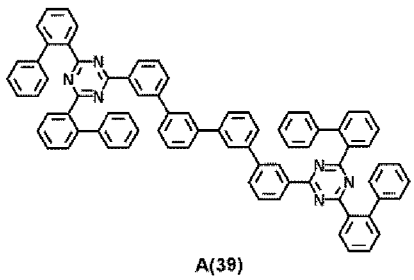

A(39)

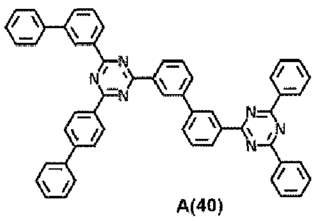

A(40)

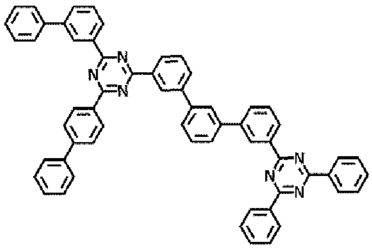

A(41)

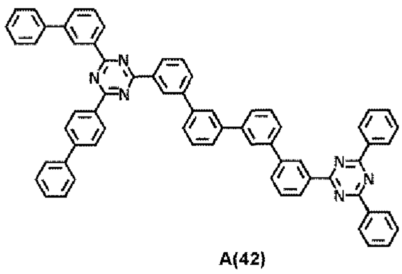

A(42)

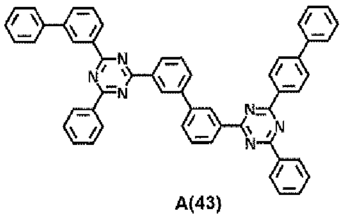

A(43)

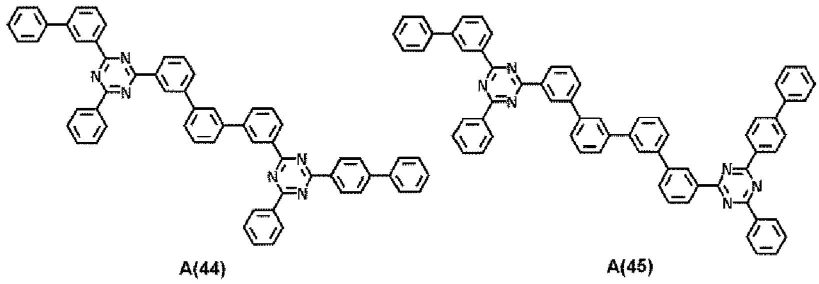

A(44)

A(45)

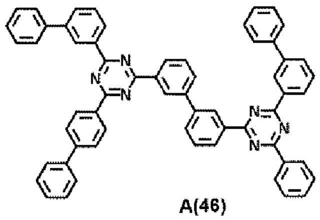

A(46)

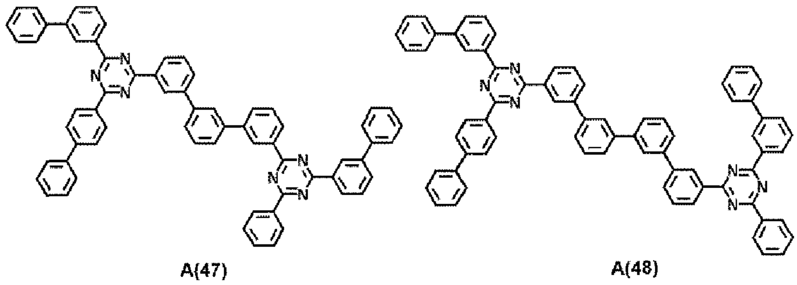

A(47)

A(48)

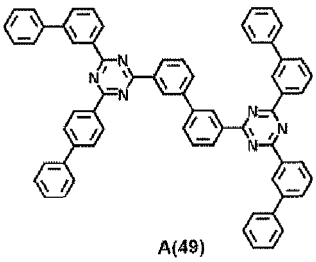

A(49)

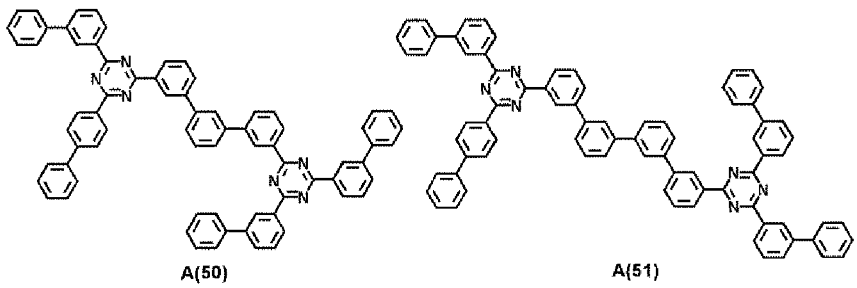

A(50)

A(51)

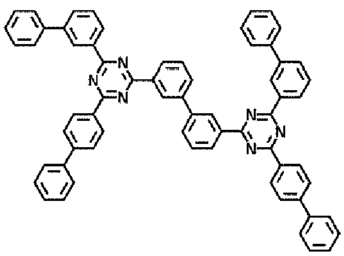
A(52)

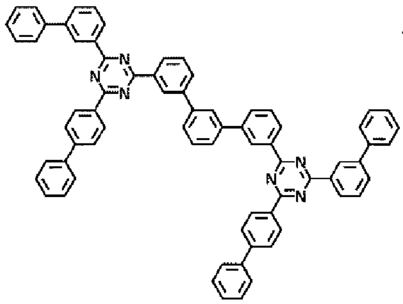
A(53)

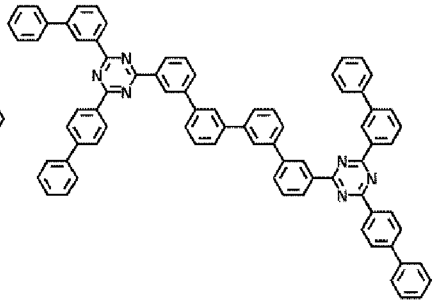
A(54)

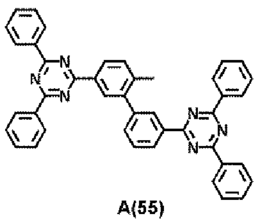
A(55)

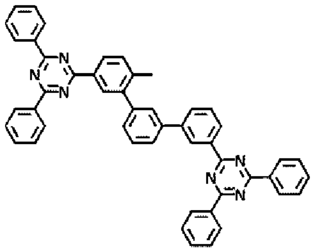
A(56)

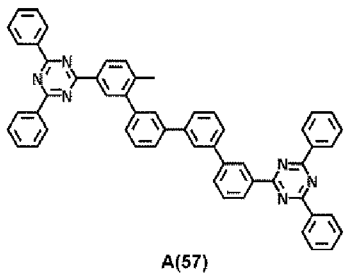
A(57)

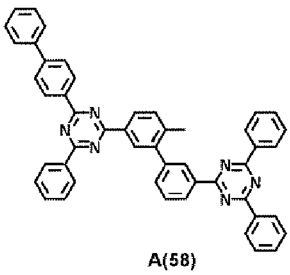
A(58)

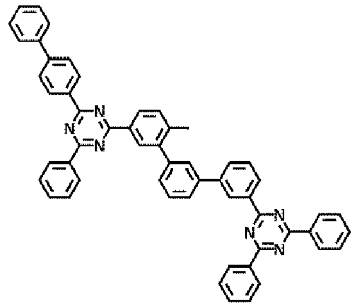
A(59)

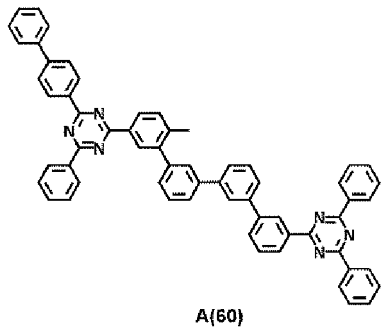
A(60)

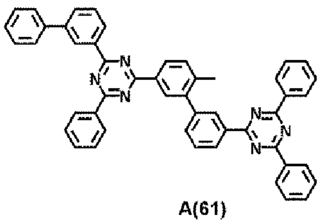
A(61)

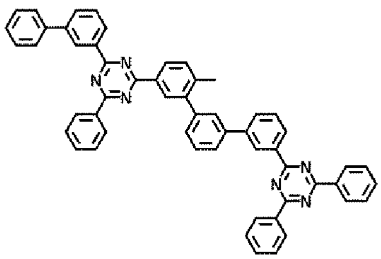
A(62)

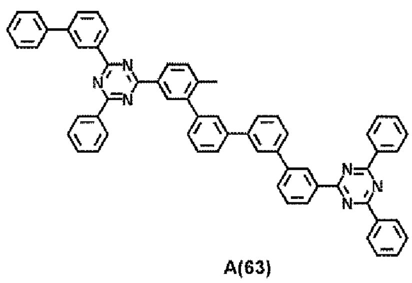
A(63)

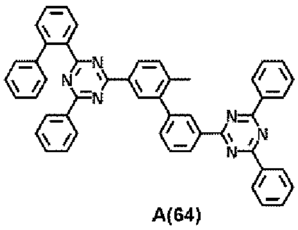

A(64)

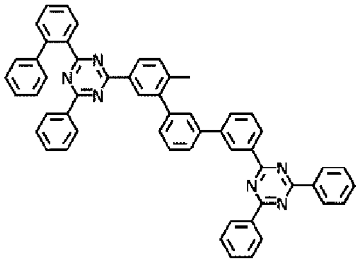

A(65)

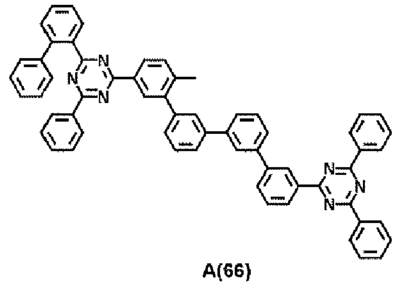

A(66)

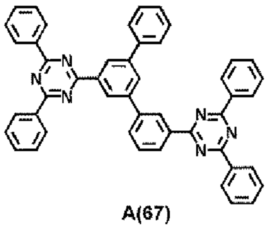

A(67)

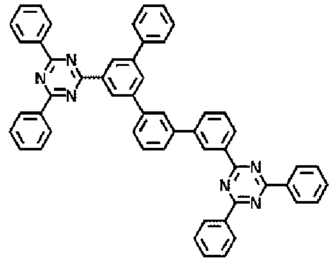

A(68)

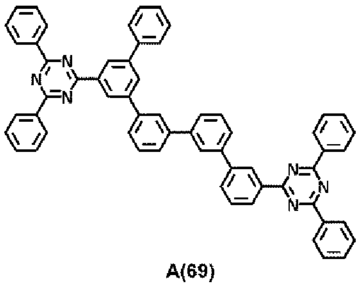

A(69)

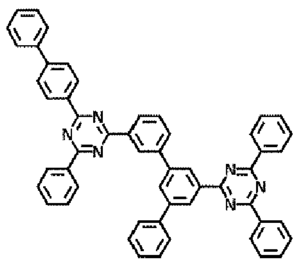

A(70)

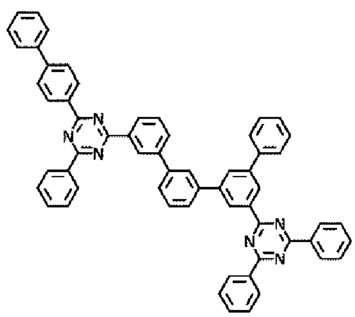

A(71)

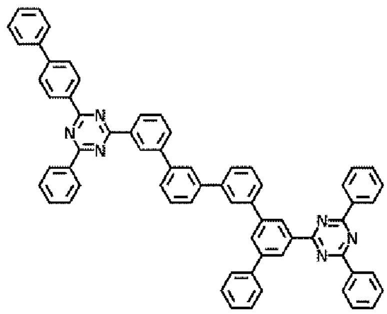

A(72)

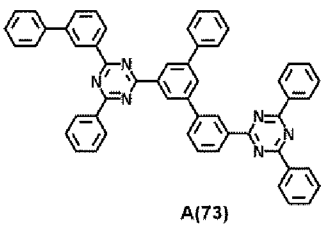

A(73)

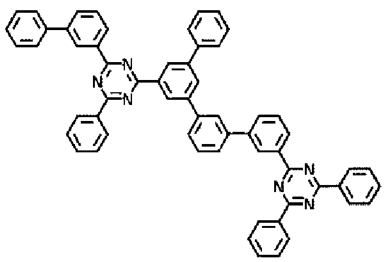

A(74)

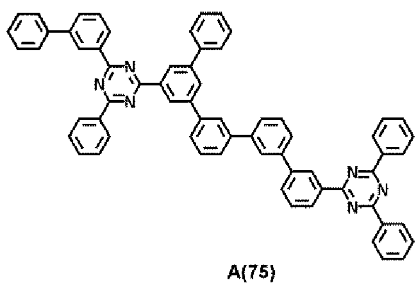

A(75)

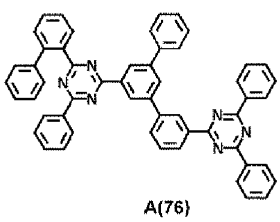

A(76)

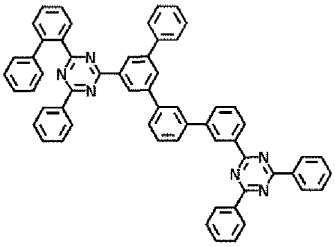

A(77)

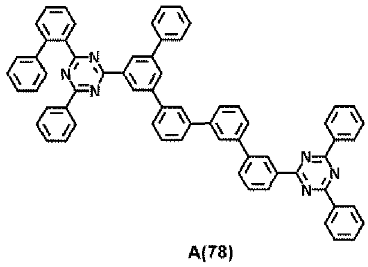

A(78)

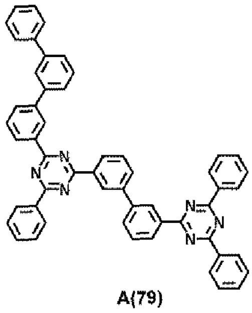

A(79)

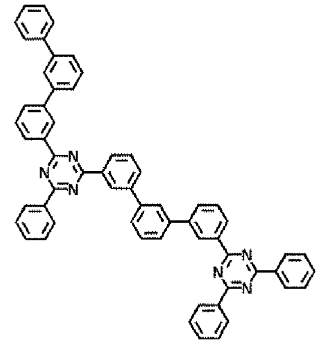

A(80)

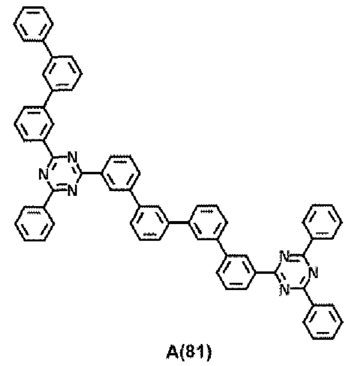

A(81)

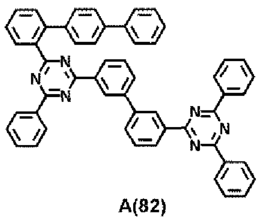

A(82)

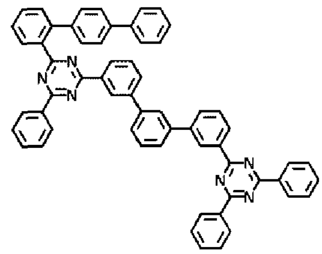

A(83)

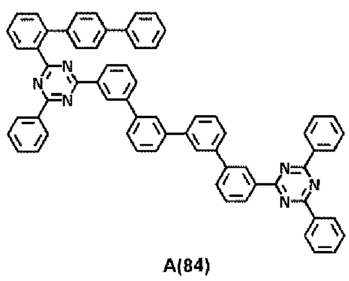

A(84)

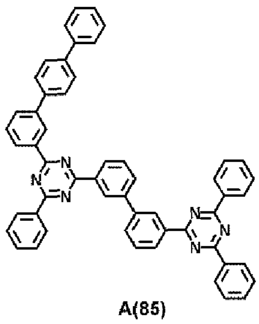

A(85)

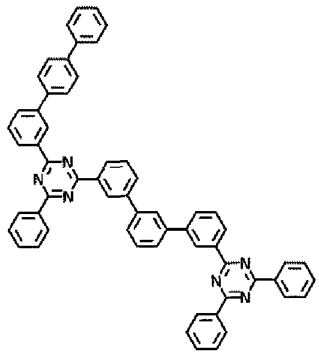

A(86)

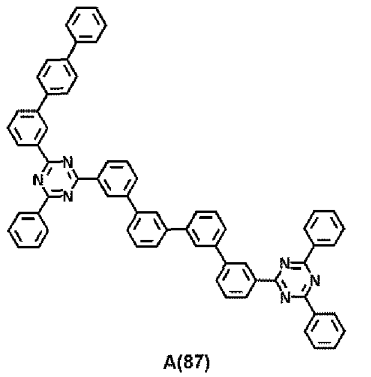

A(87)

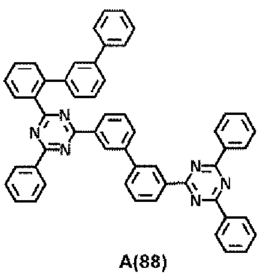

A(88)

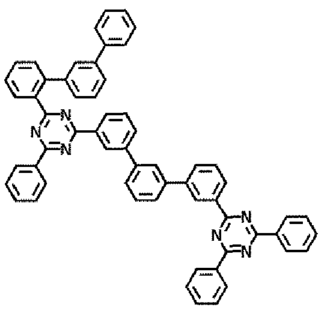

A(89)

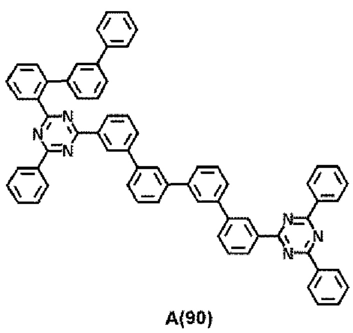

A(90)

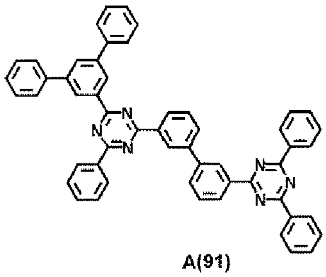

A(91)

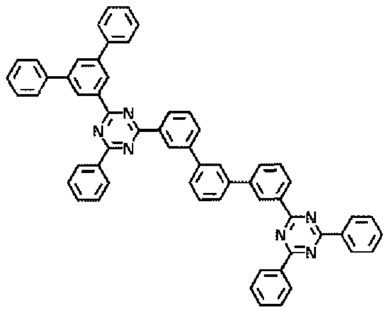

A(92)

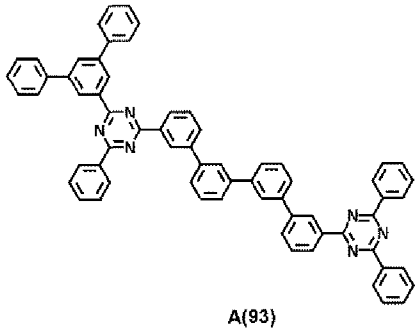

A(93)

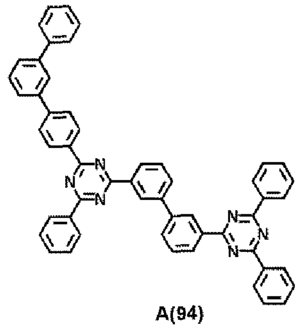

A(94)

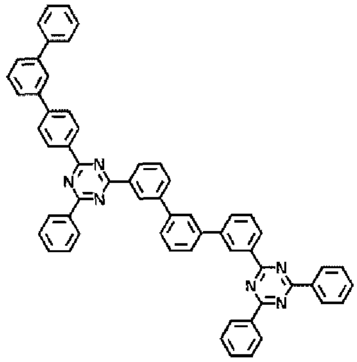

A(95)

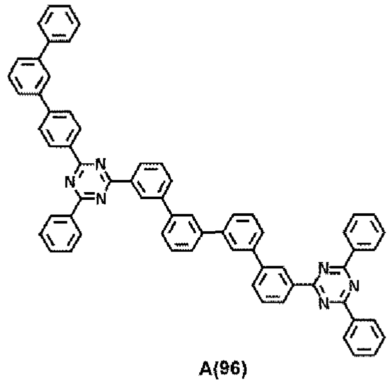

A(96)

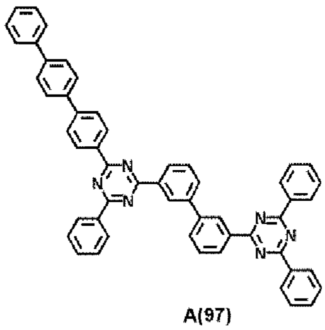

A(97)

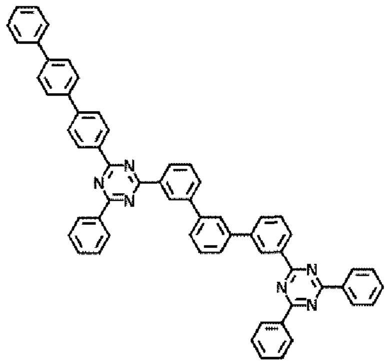

A(98)

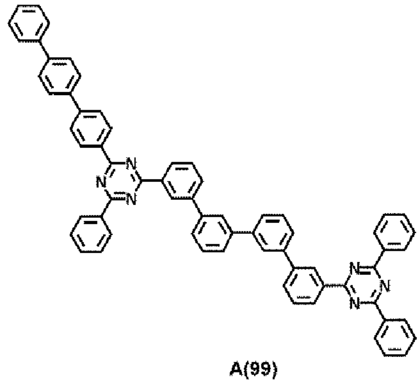

A(99)

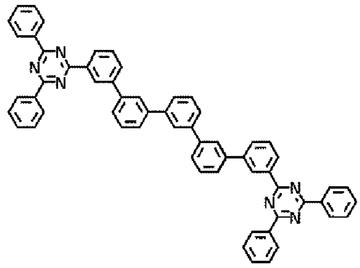
A(100)

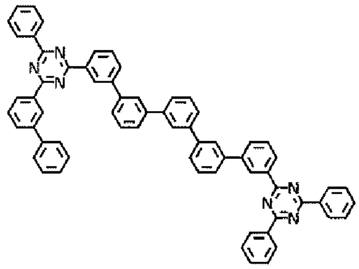
A(101)

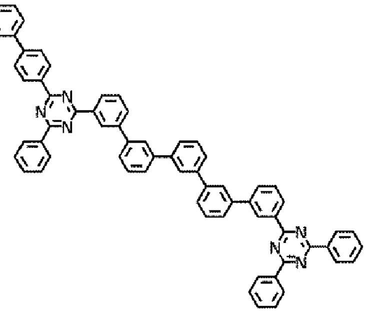
A(102)

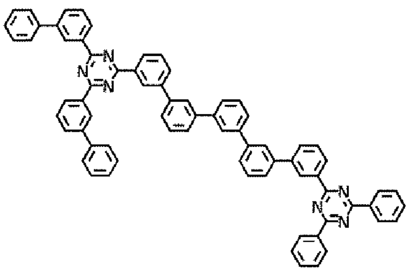
A(103)

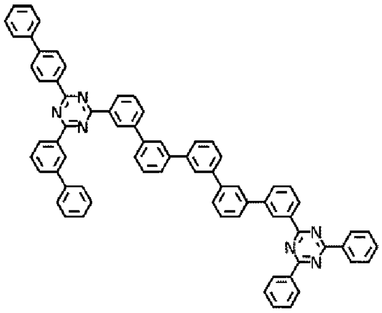
A(104)

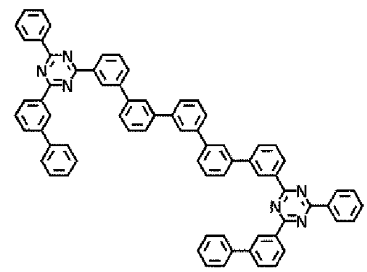
A(105)

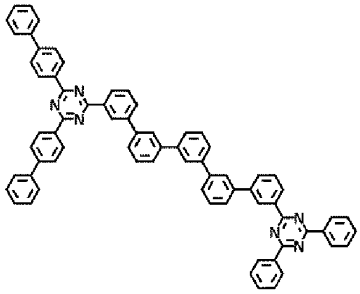
A(106)

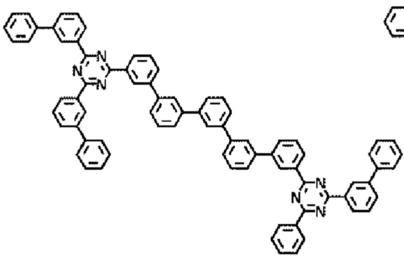
A(107)

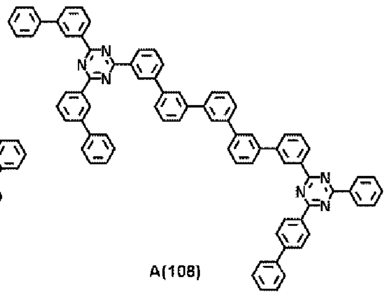
A(108)

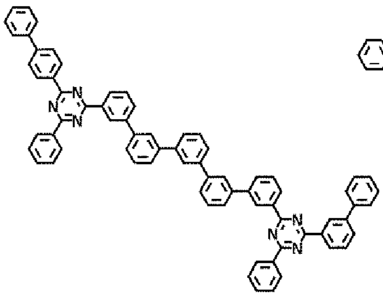
A(109)

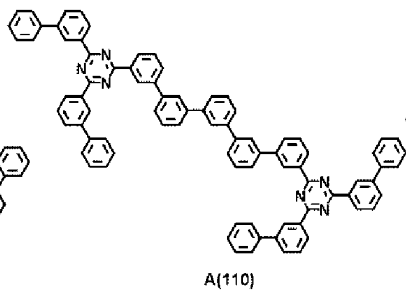
A(110)

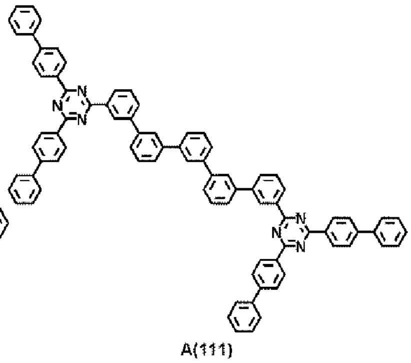
A(111)

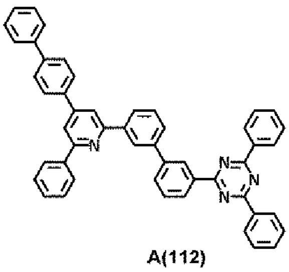
A(112)

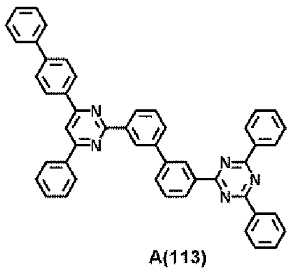
A(113)

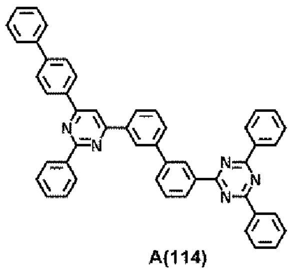
A(114)

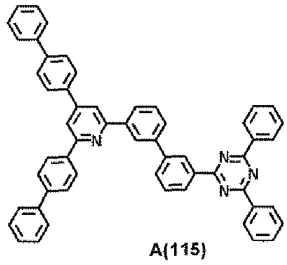
A(115)

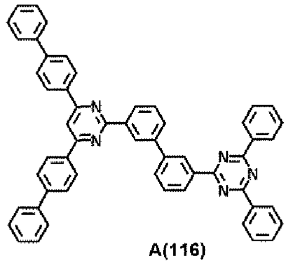
A(116)

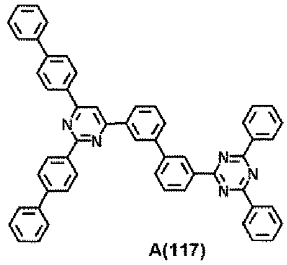
A(117)

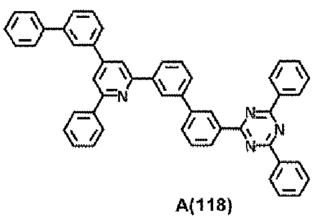
A(118)

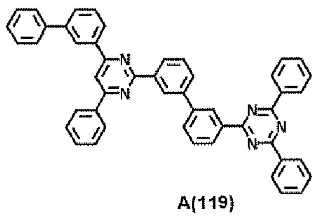
A(119)

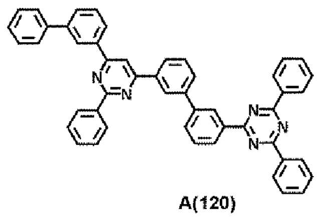
A(120)

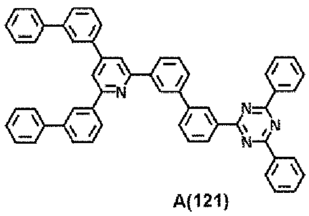
A(121)

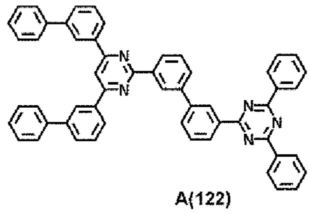
A(122)

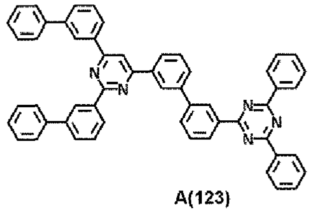
A(123)

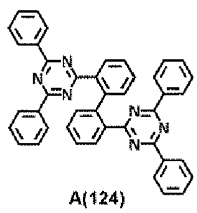
A(124)

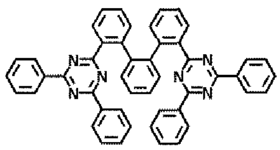
A(125)

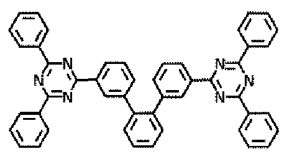
A(126)

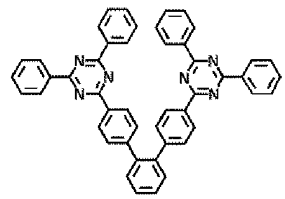
A(127)

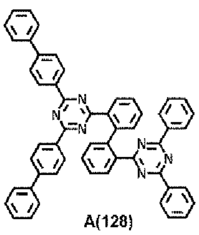
A(128)

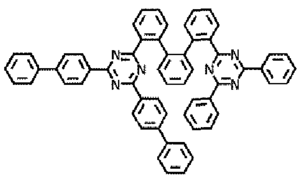
A(129)

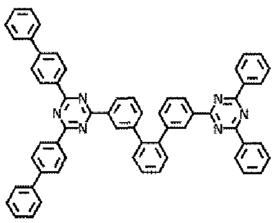
A(130)

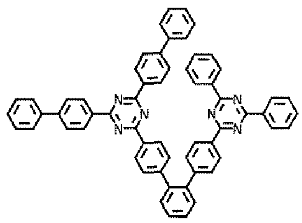
A(131)

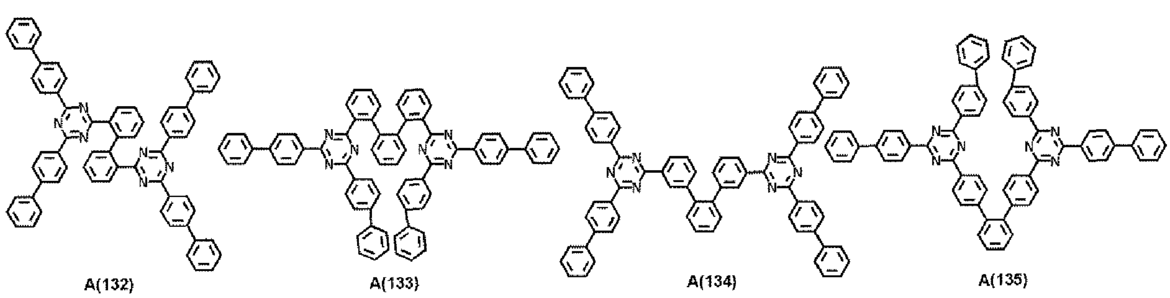
A(132)

A(133)

A(134)

A(135)

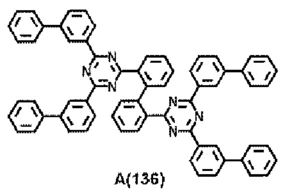
A(136)

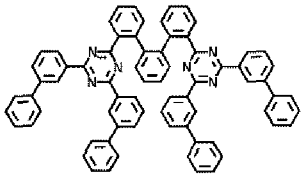
A(137)

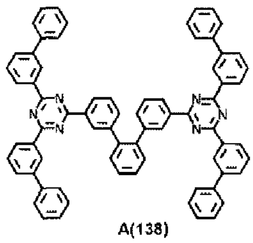
A(138)

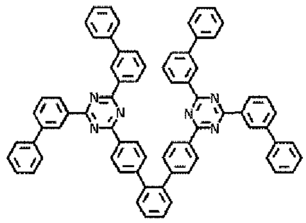
A(139)

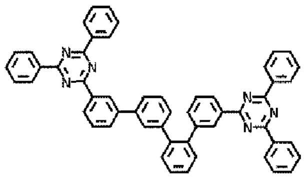
A(140)

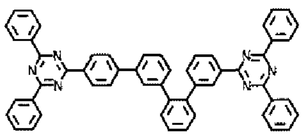
A(141)

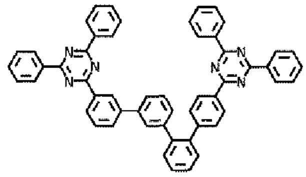
A(142)

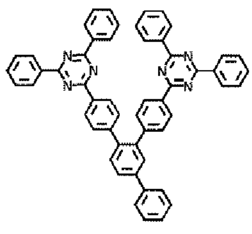
A(143)

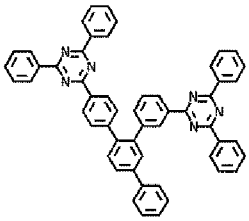
A(144)

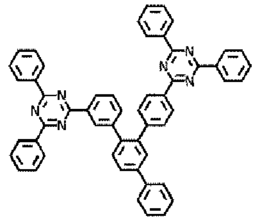
A(145)

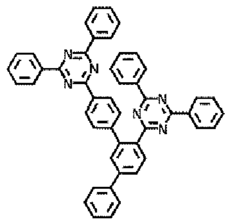
A(146)

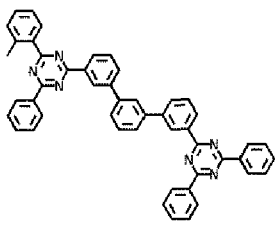
A(147)

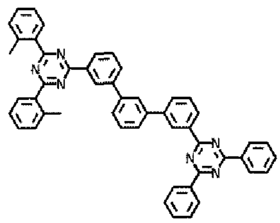
A(148)

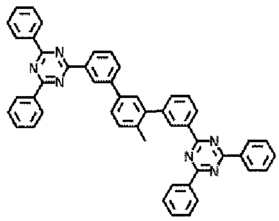
A(149)

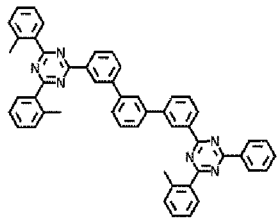
A(150)

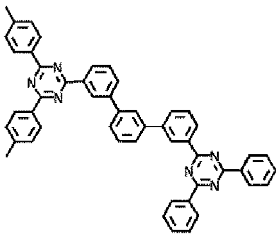
A(151)

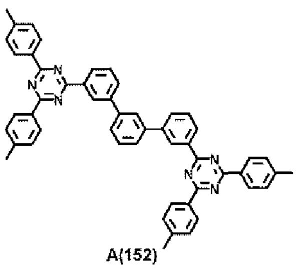
A(152)

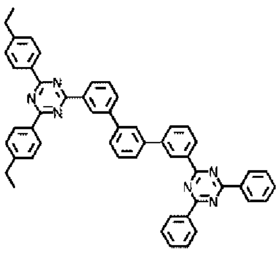
A(153)

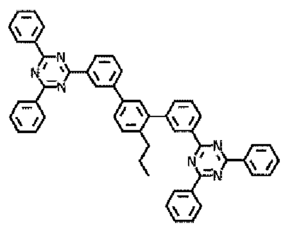
A(154)

## Group HE2

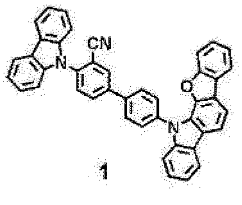
1
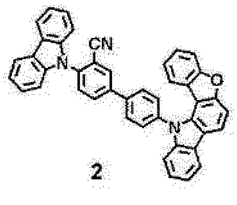
2
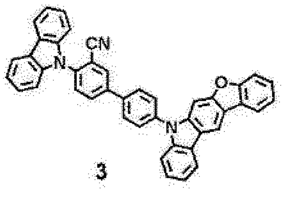
3
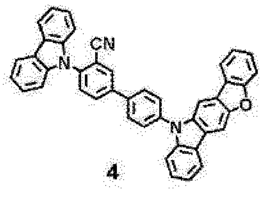
4
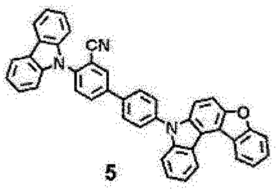
5
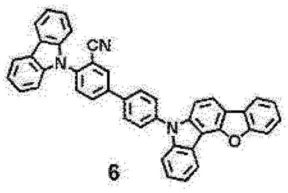
6
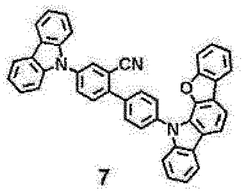
7
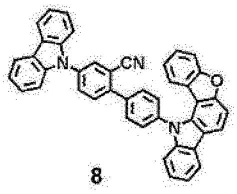
8
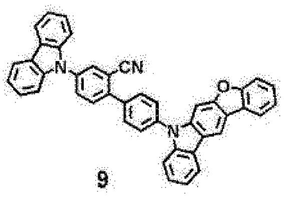
9
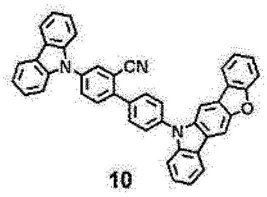
10
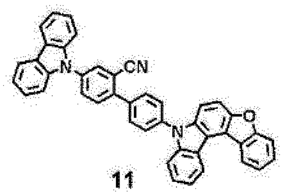
11
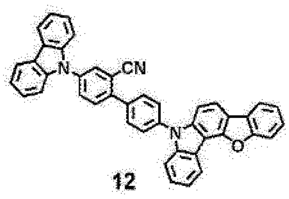
12
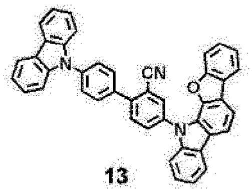
13
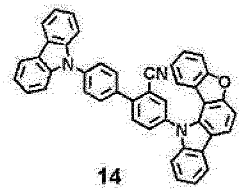
14
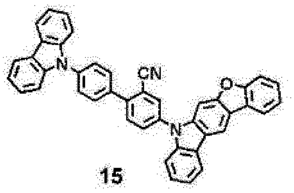
15
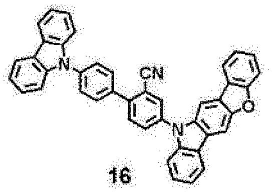
16
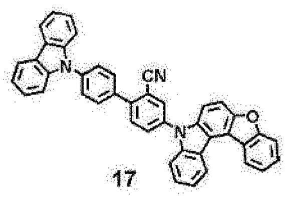
17
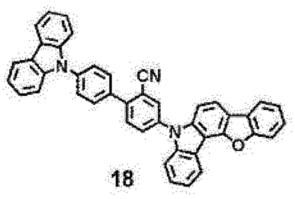
18
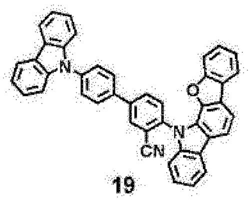
19
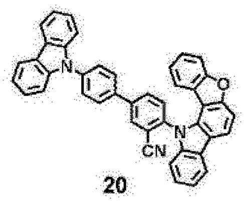
20
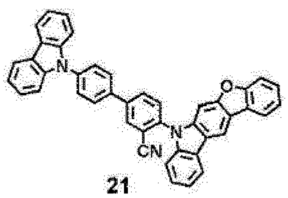
21
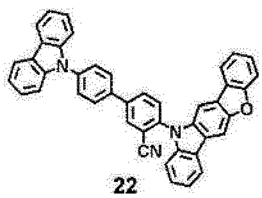
22
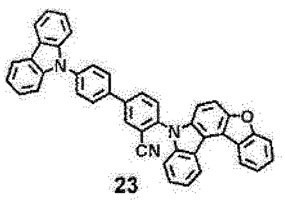
23
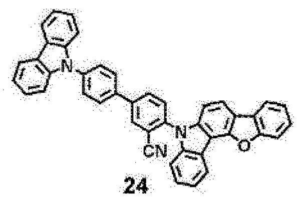
24

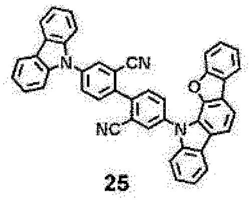
25

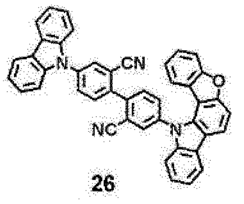
26

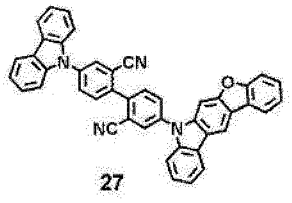
27

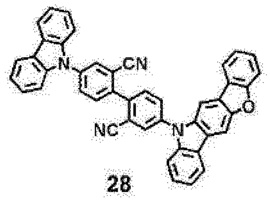
28

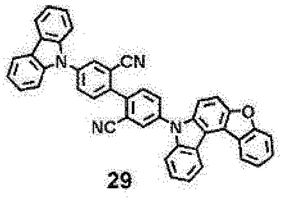
29

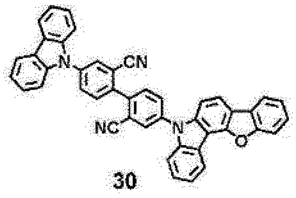
30

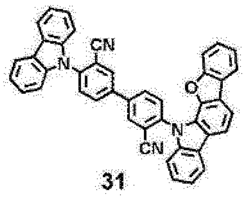
31

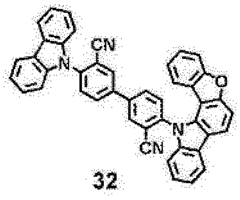
32

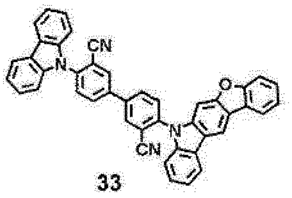
33

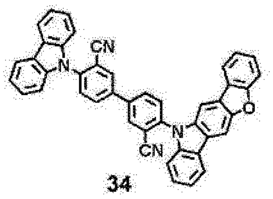
34

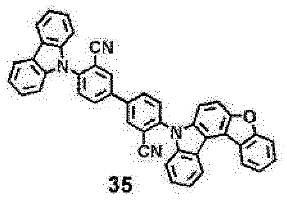
35

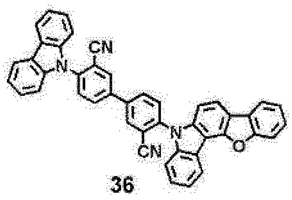
36

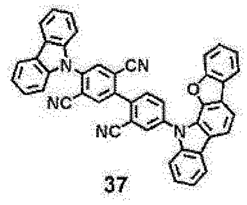
37

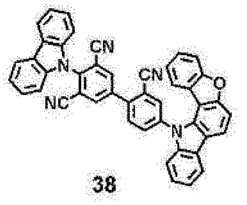
38

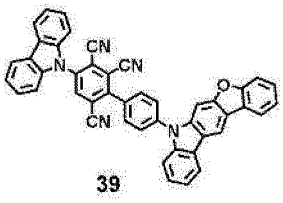
39

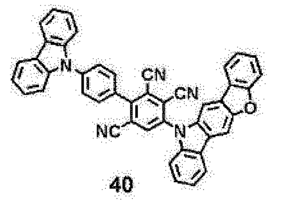
40

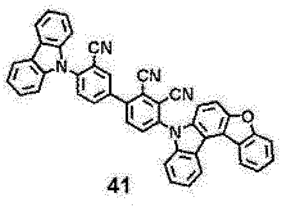
41

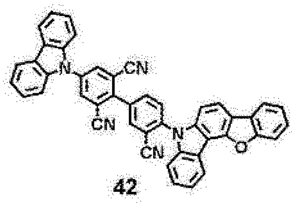
42

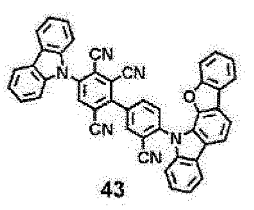
43

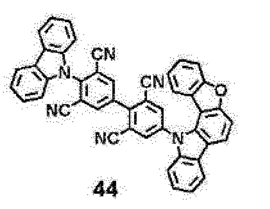
44

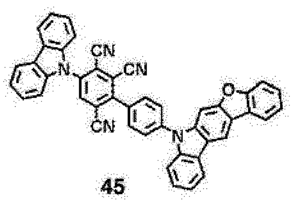
45

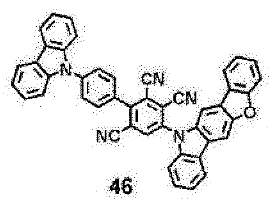
46

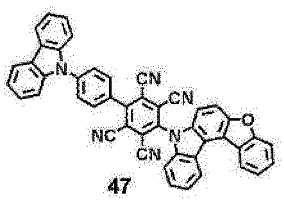
47

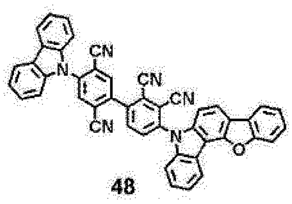
48

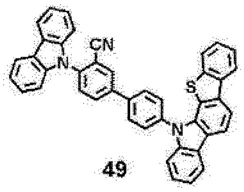
49
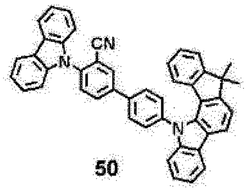
50
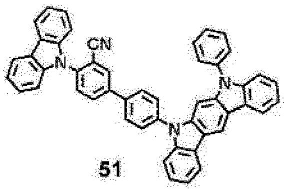
51
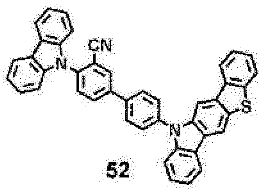
52

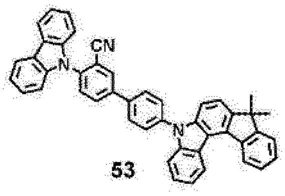
53
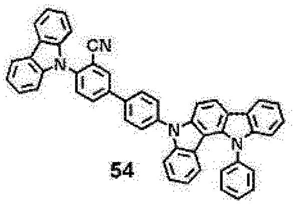
54
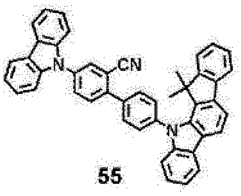
55
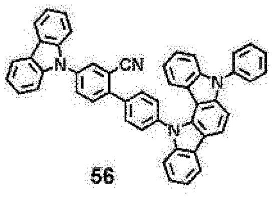
56

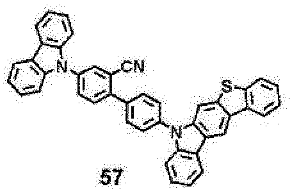
57
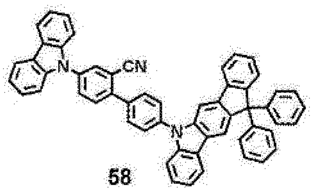
58
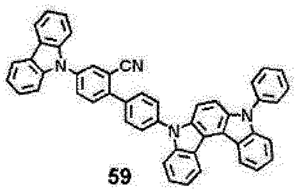
59
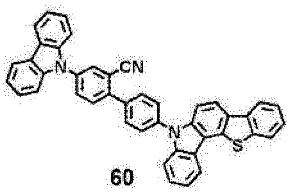
60

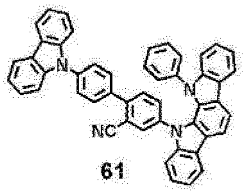
61
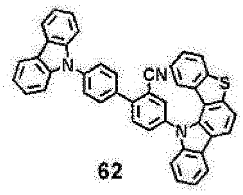
62
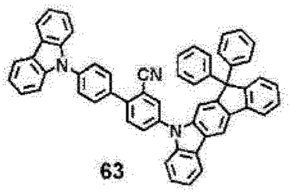
63
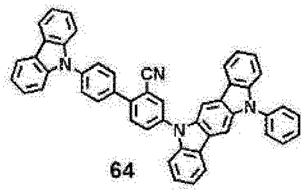
64

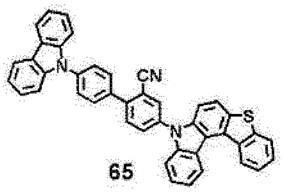
65
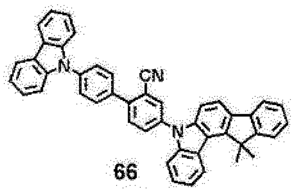
66
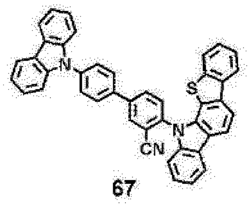
67
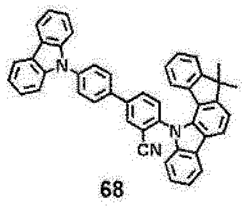
68

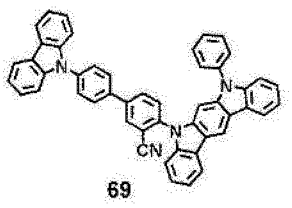
69
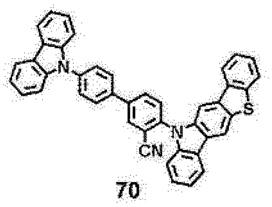
70
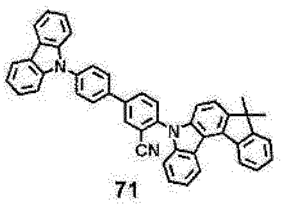
71
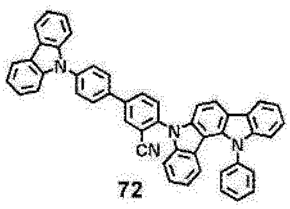
72

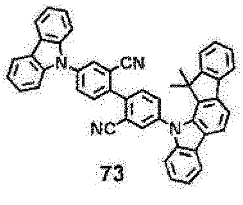
73

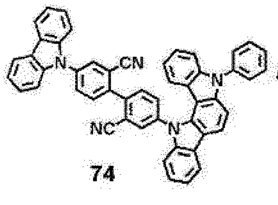
74

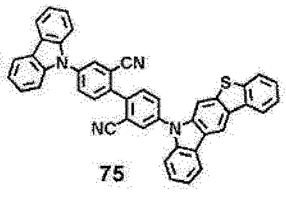
75

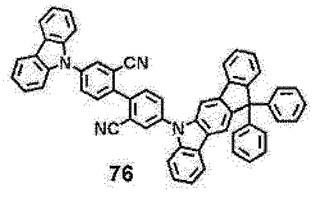
76

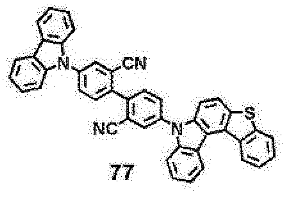
77

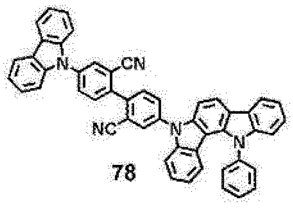
78

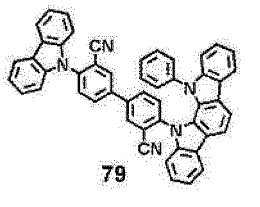
79

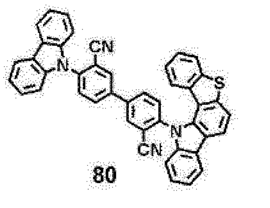
80

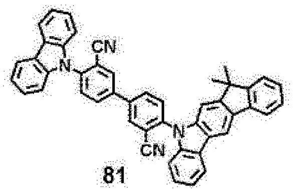
81

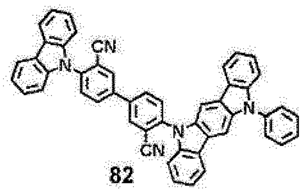
82

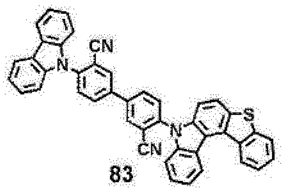
83

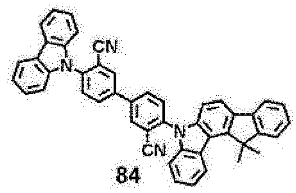
84

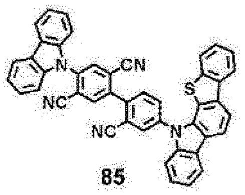
85

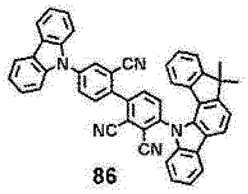
86

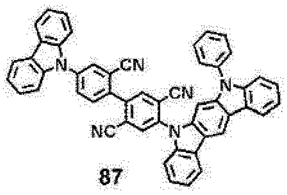
87

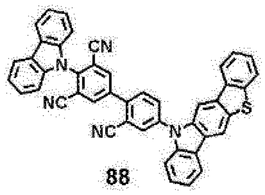
88

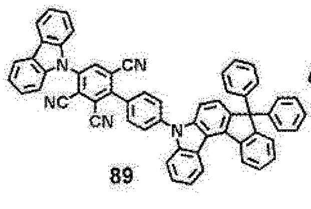
89

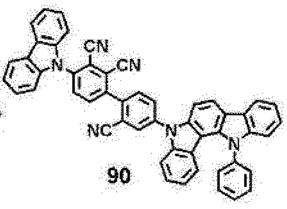
90

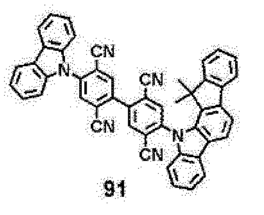
91

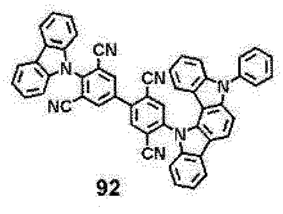
92

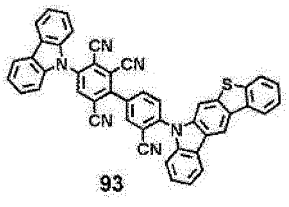
93

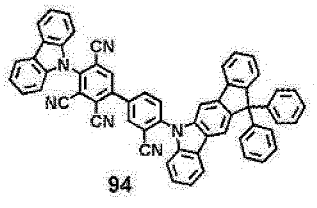
94

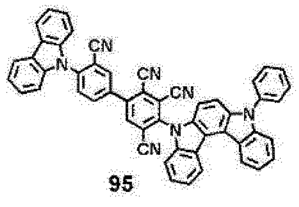
95

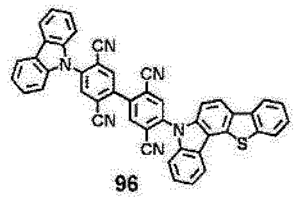
96

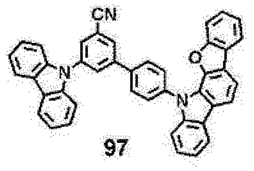
97

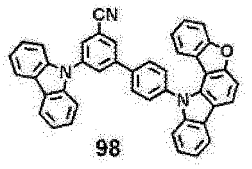
98

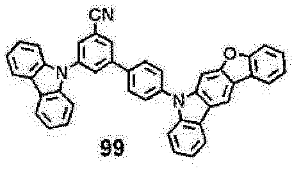
99

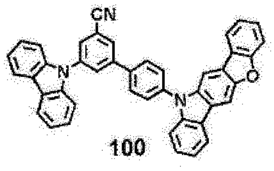
100

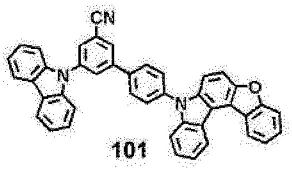
101

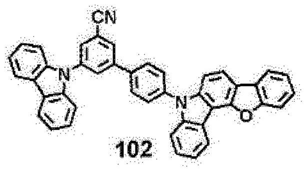
102

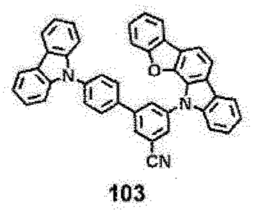
103

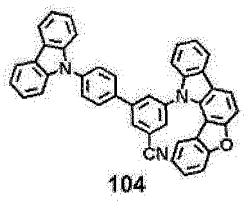
104

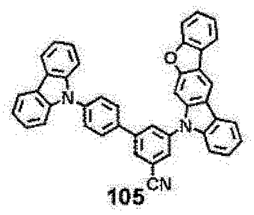
105

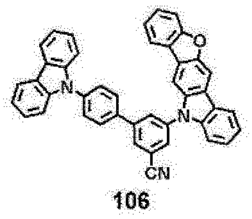
106

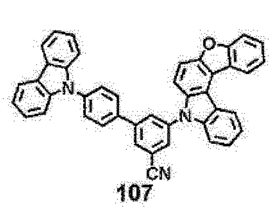
107

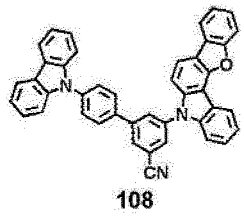
108

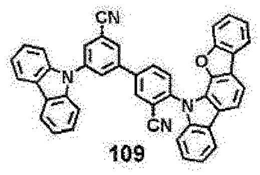
109

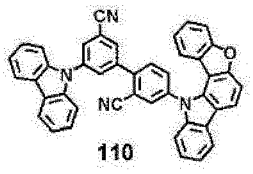
110

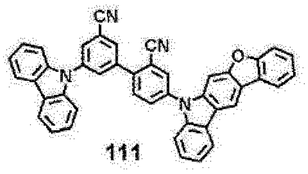
111

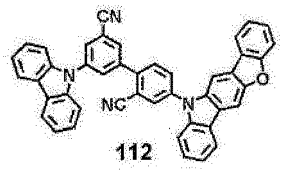
112

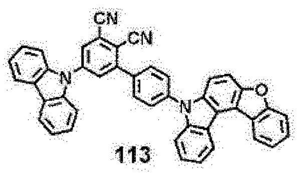
113

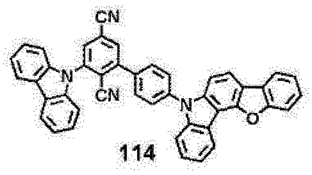
114

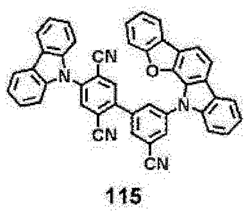
115

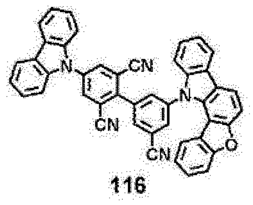
116

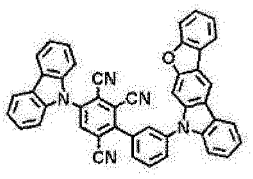
117

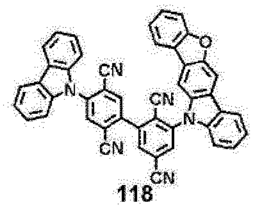
118

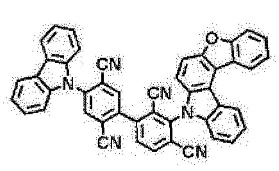
119

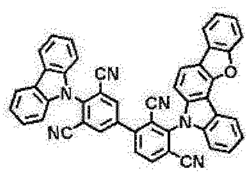
120

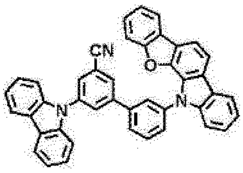
121

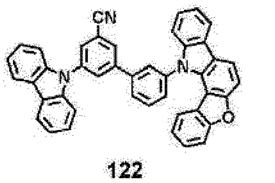
122

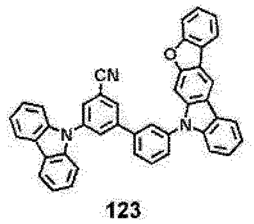
123

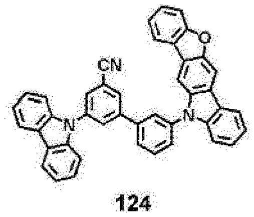
124

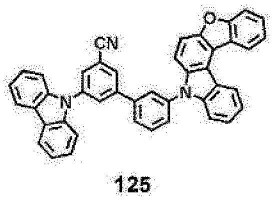
125

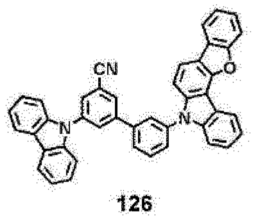
126

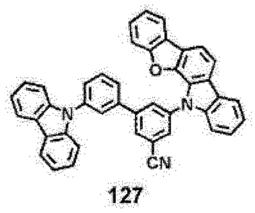
127

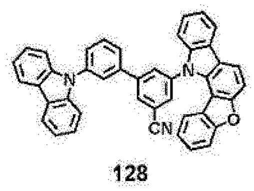
128

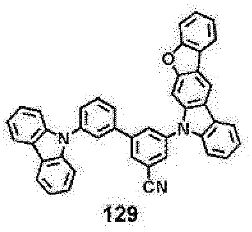
129

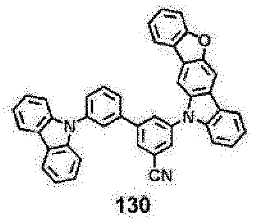
130

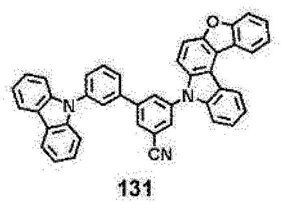
131

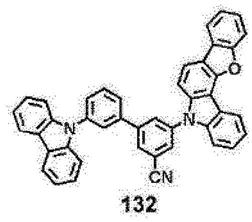
132

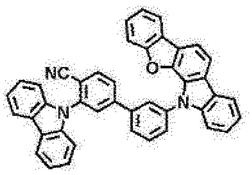
133

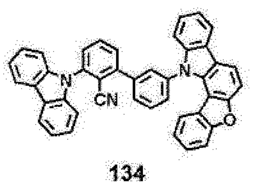
134

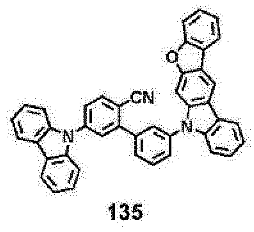
135

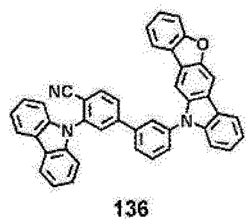
136

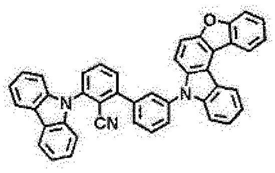
137

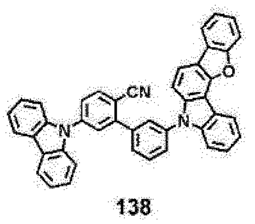
138

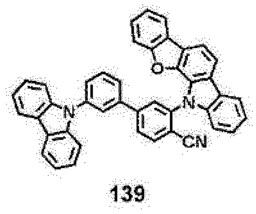
139

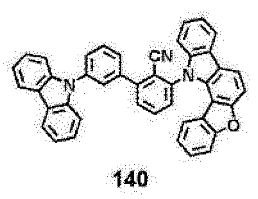
140

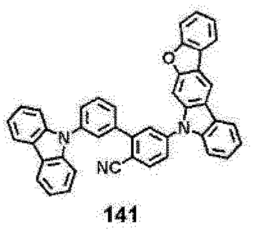
141

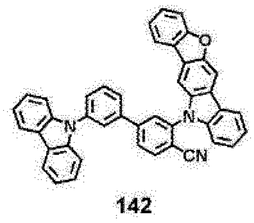
142

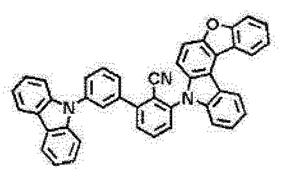
143

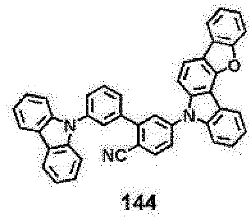
144

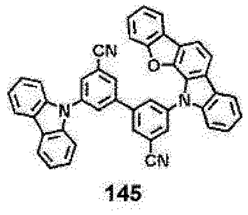
145

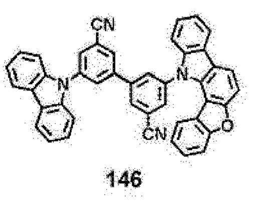
146

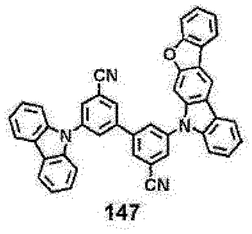
147

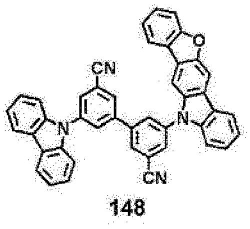
148

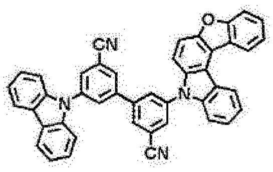
149

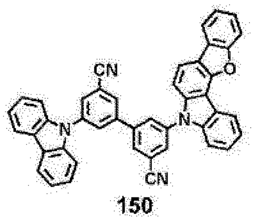
150

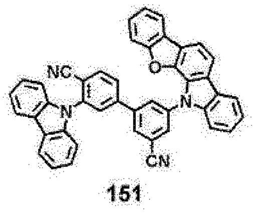
151

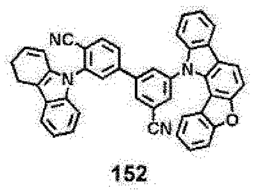
152

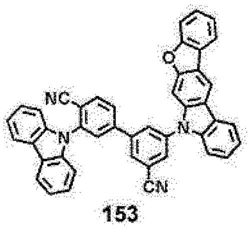
153

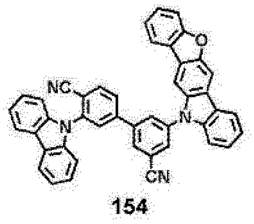
154

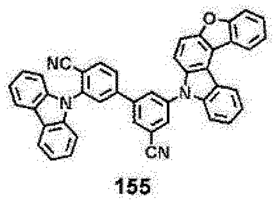
155

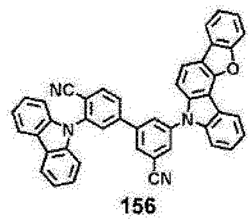
156

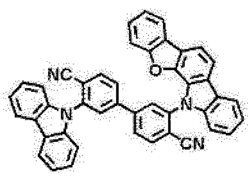
157

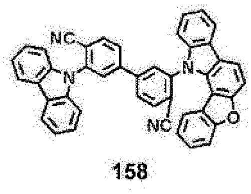
158

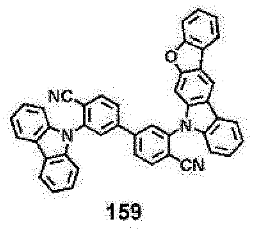
159

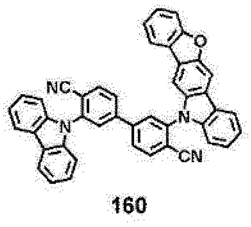
160

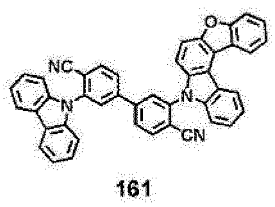
161

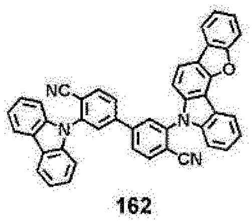
162

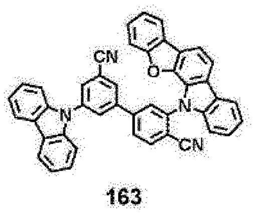
163

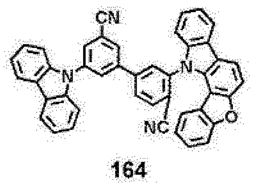
164

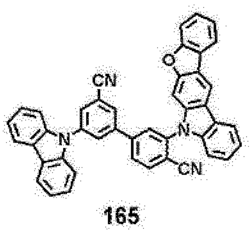
165

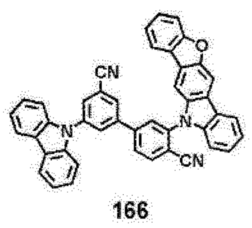
166

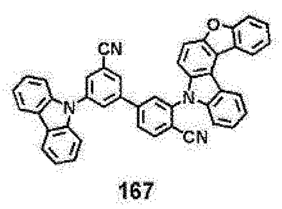
167

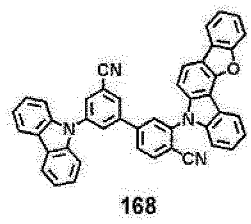
168

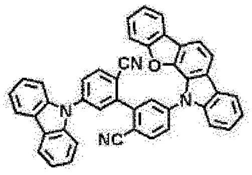
169

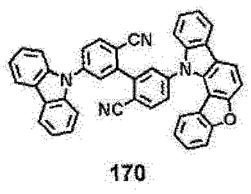
170

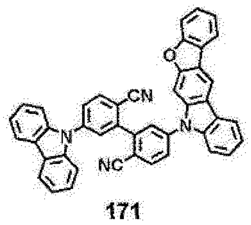
171

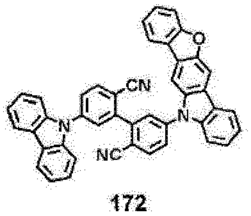
172

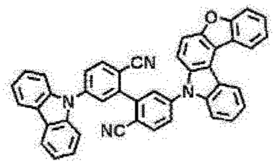
173

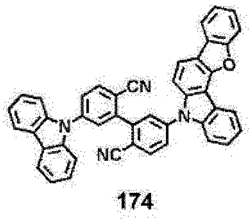
174

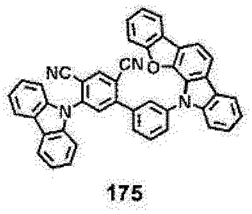
175

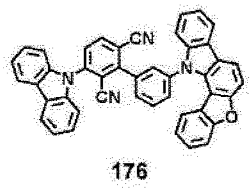
176

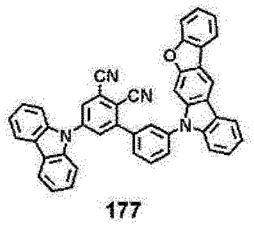
177

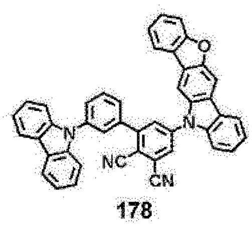
178

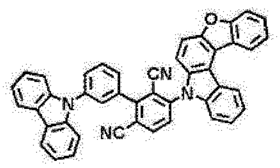
179

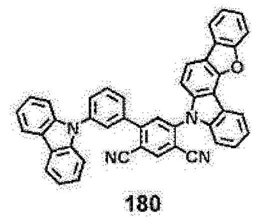
180

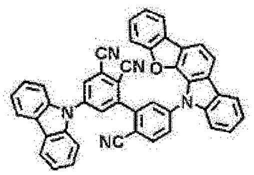
181

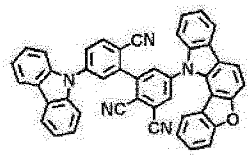
182

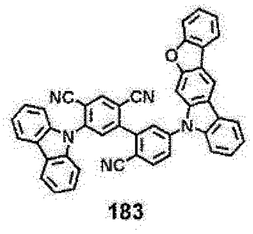
183

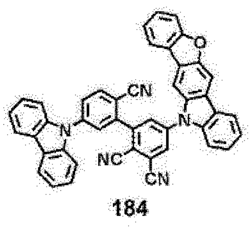
184

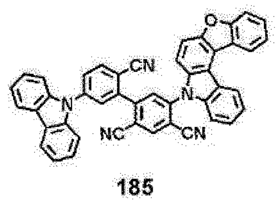
185

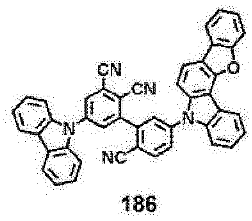
186

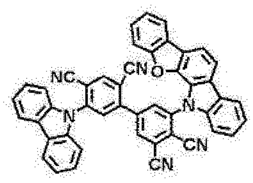
187

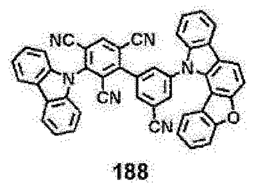
188

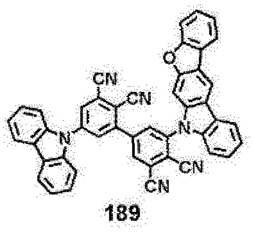
189

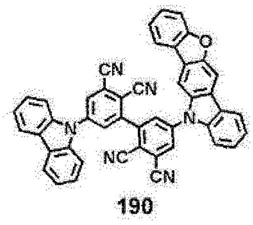
190

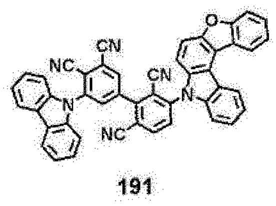
191

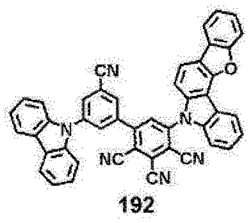
192

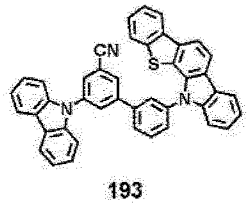
193

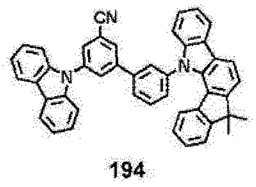
194

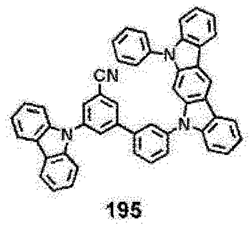
195

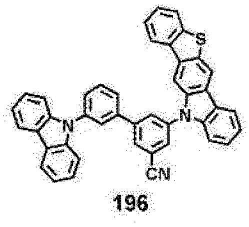
196

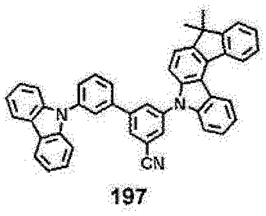
197

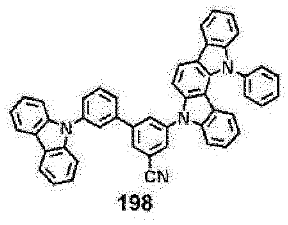
198

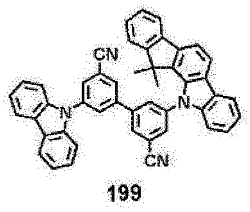
199

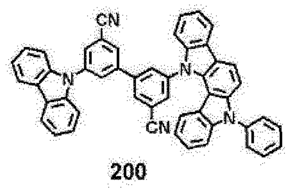
200

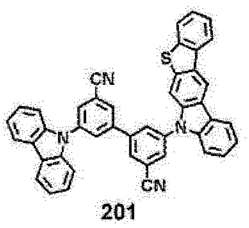
201

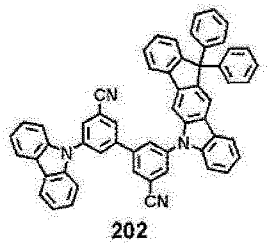
202

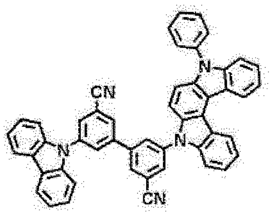
203

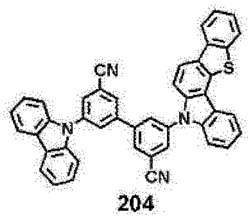
204

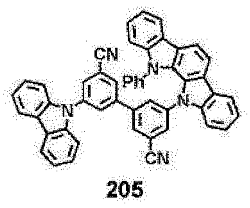
205

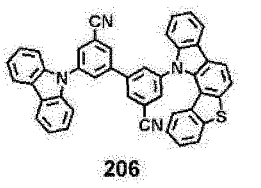
206

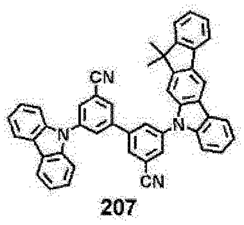
207

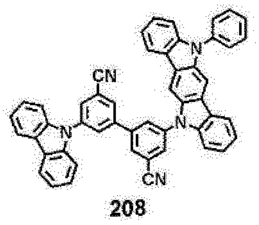
208

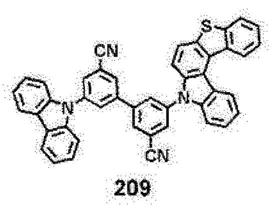
209

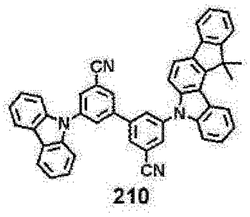
210

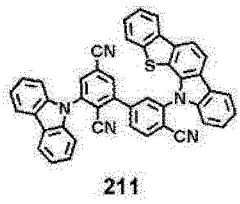
211

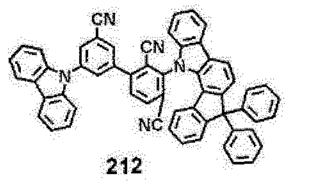
212

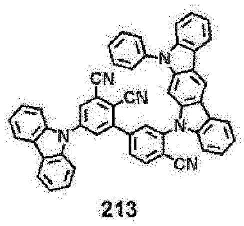
213

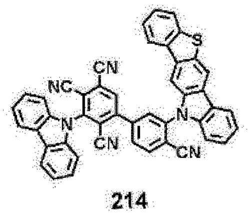
214

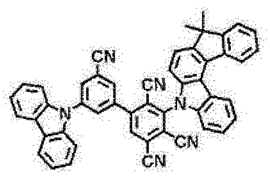
215

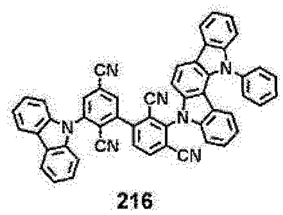
216

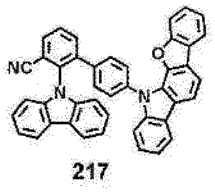
217

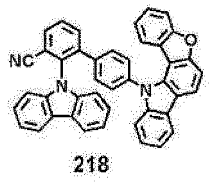
218

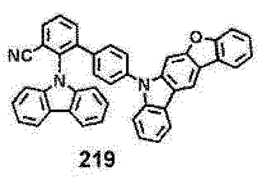
219

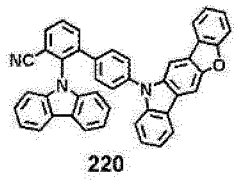
220

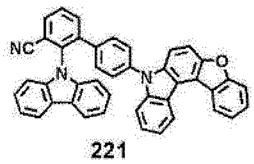
221

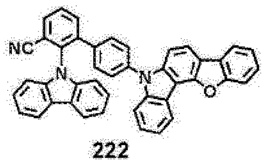
222

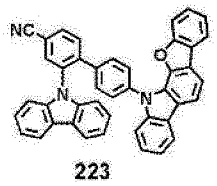
223

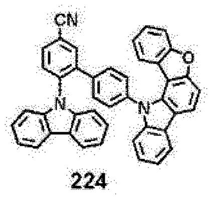
224

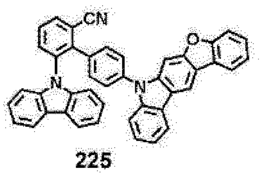
225

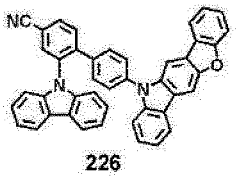
226

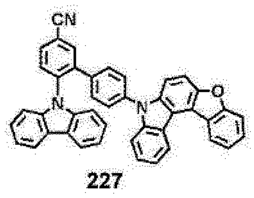
227

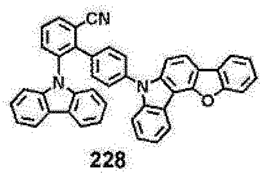
228

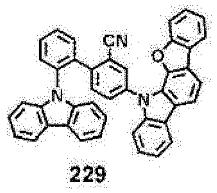
229

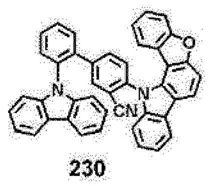
230

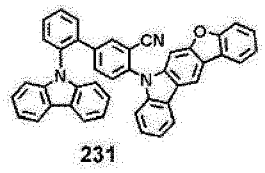
231

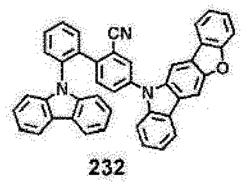
232

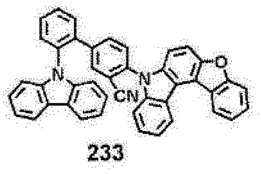
233

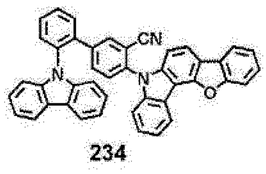
234

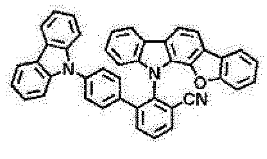
235

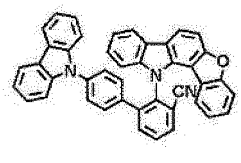
236

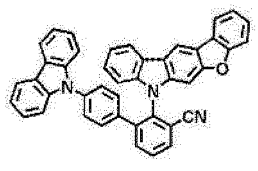
237

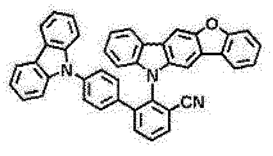
238

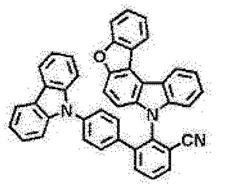
239

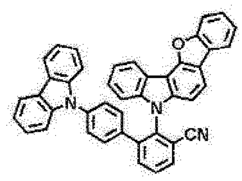
240

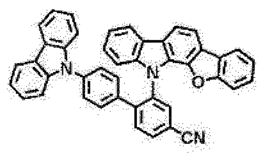
241
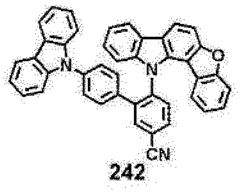
242
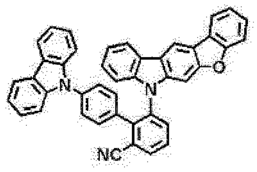
243
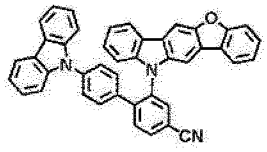
244

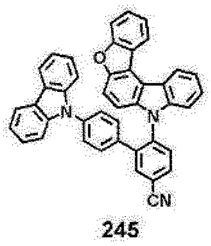
245
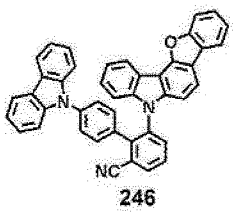
246
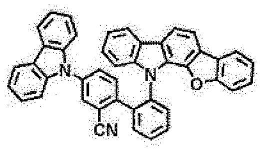
247
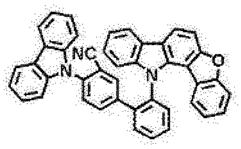
248

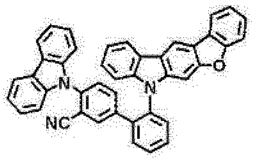
249
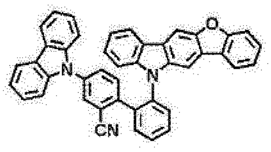
250
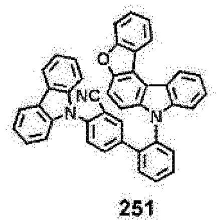
251
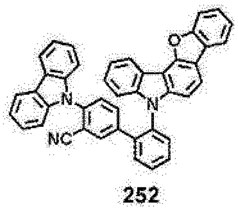
252

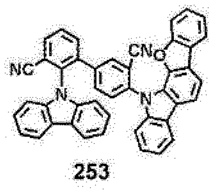
253
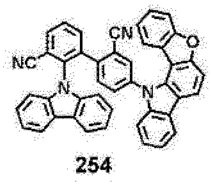
254
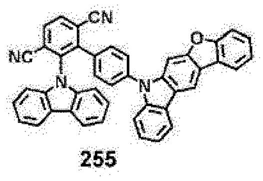
255
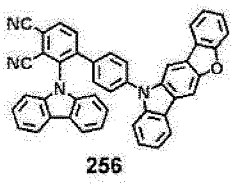
256

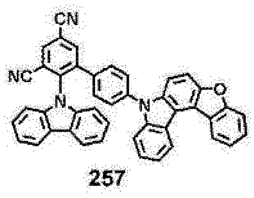
257
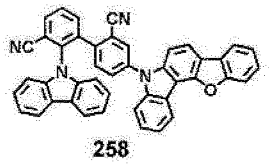
258
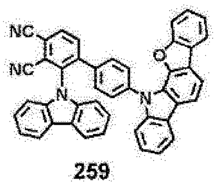
259
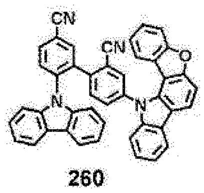
260

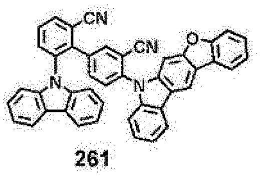
261
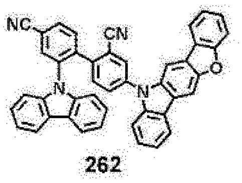
262
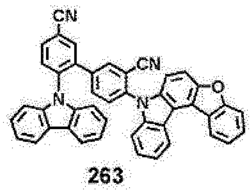
263
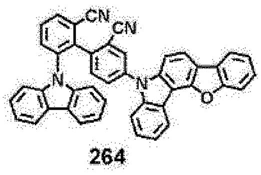
264

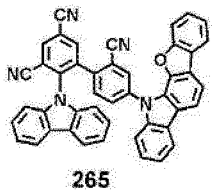
265

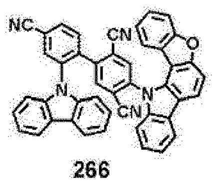
266

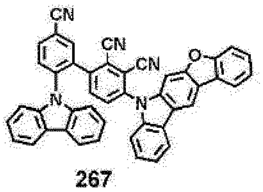
267

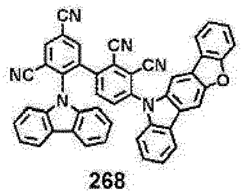
268

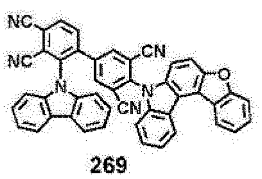
269

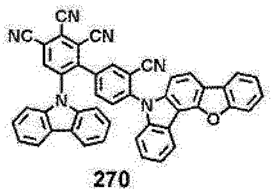
270

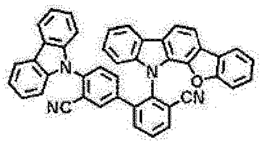
271

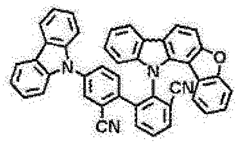
272

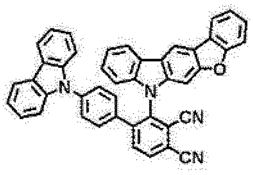
273

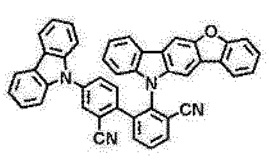
274

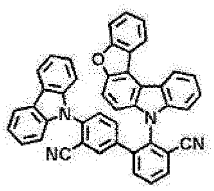
275

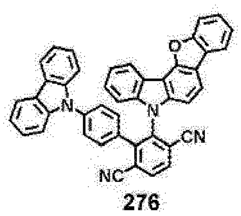
276

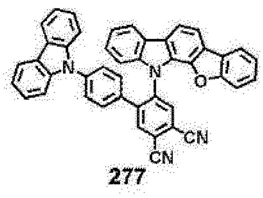
277

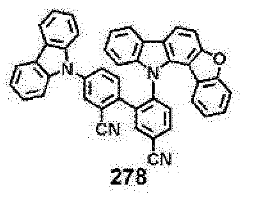
278

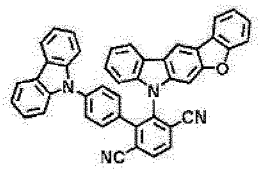
279

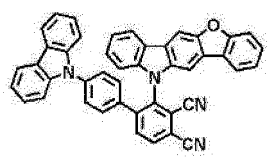
280

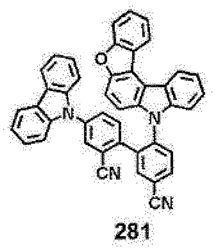
281

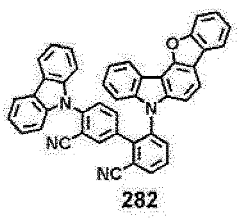
282

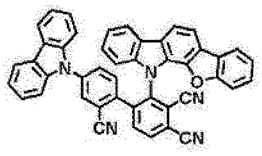
283

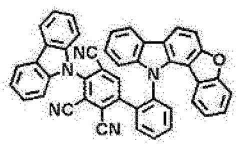
284

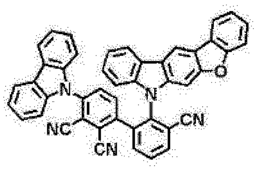
285

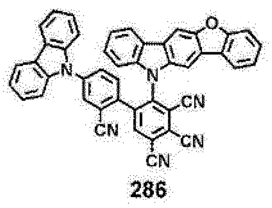
286

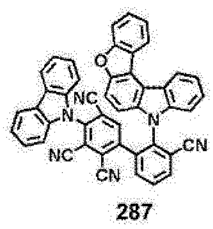
287

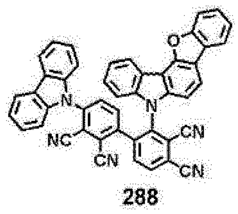
288

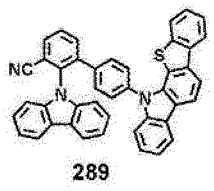
289

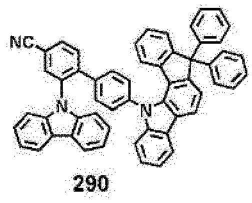
290

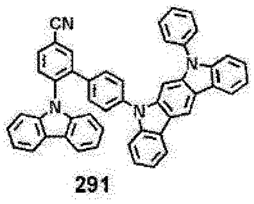
291

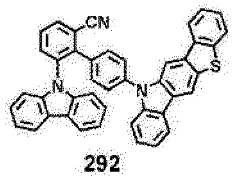
292

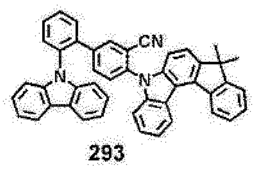
293

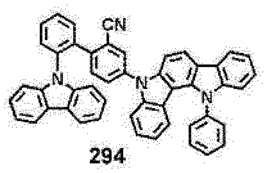
294

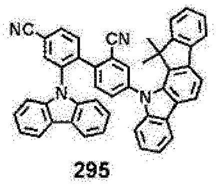
295

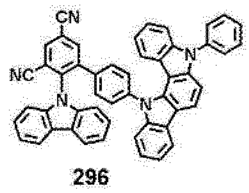
296

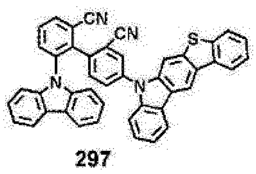
297

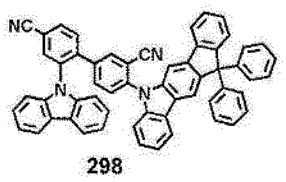
298

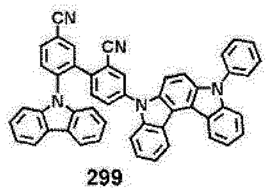
299

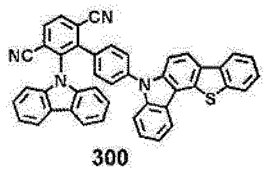
300

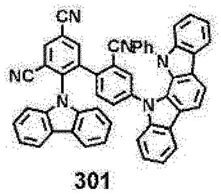
301

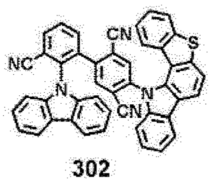
302

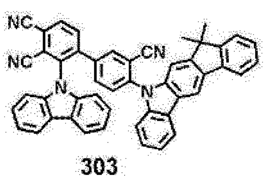
303

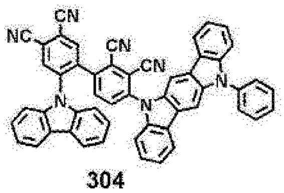
304

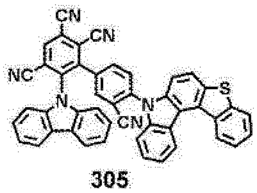
305

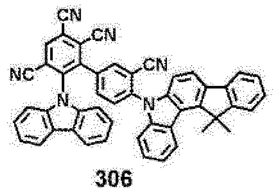
306

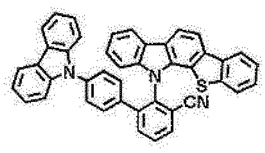
307

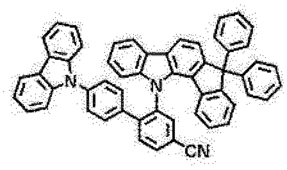
308

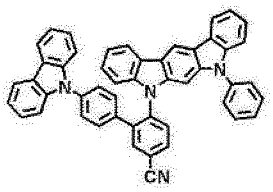
309

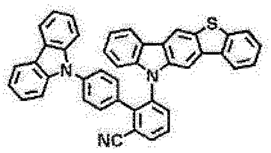
310

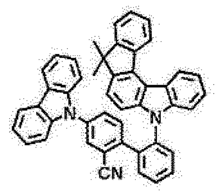
311

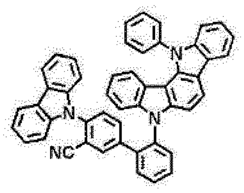
312

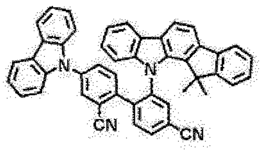
313

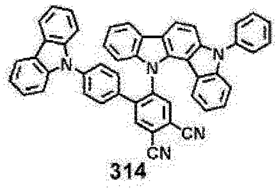
314

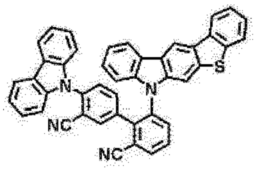
315

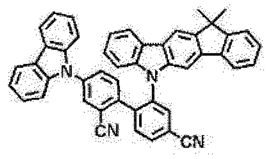
316

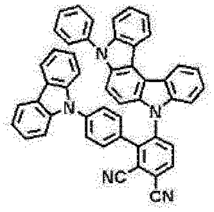
317

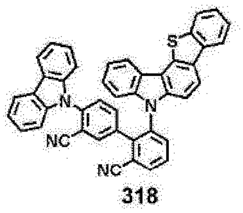
318

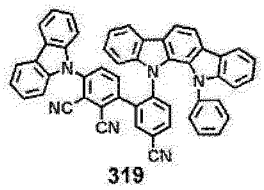
319

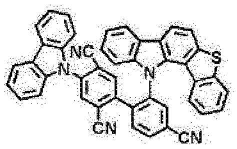
320

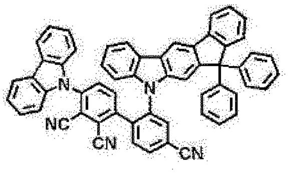
321

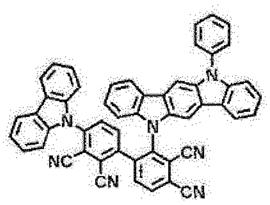
322

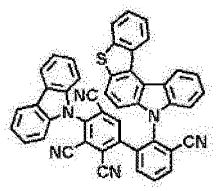
323

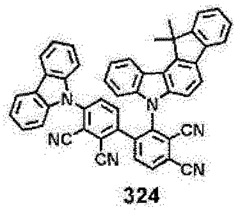
324

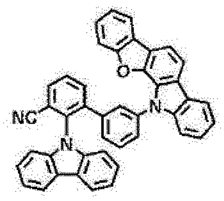
325

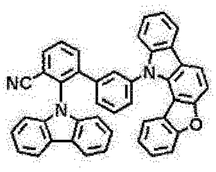
326

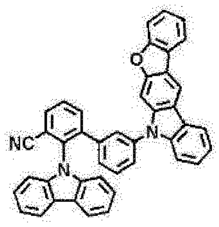
327

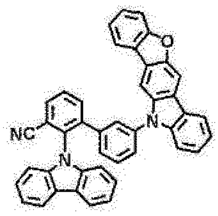
328

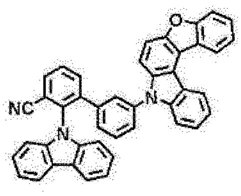
329

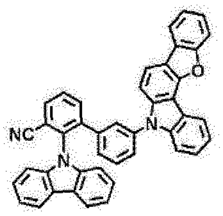
330

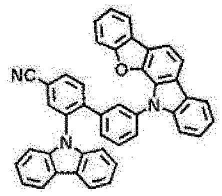
331

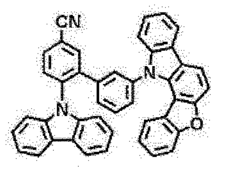
332

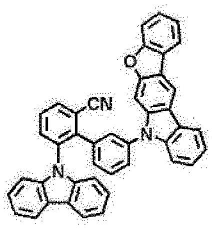
333

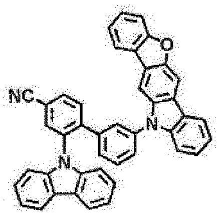
334

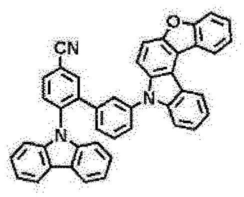
335

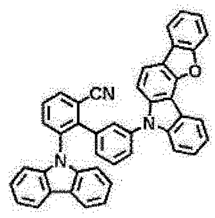
336

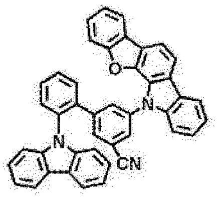
337

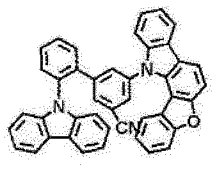
338

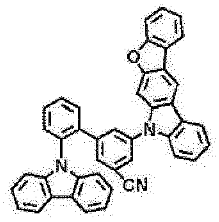
339

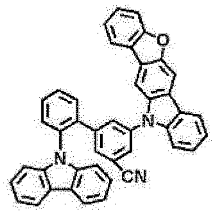
340

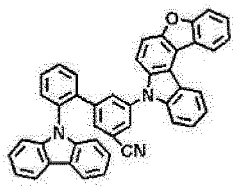
341

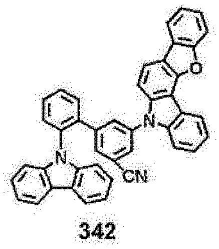
342

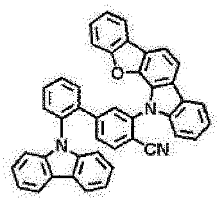
343

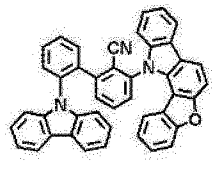
344

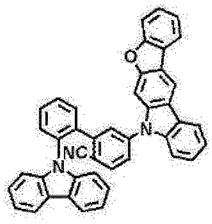
345

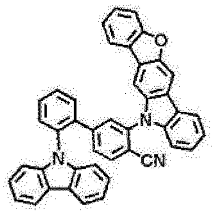
346

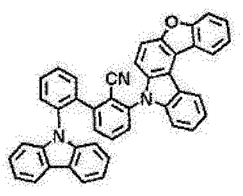
347

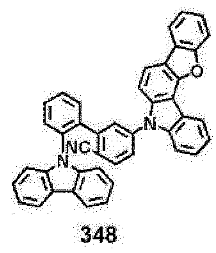
348

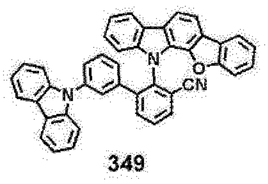
349

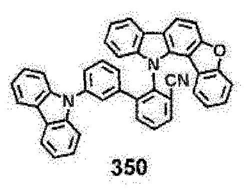
350

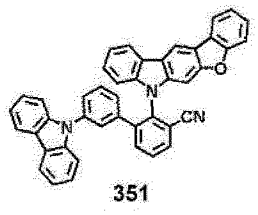
351

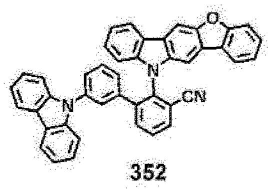
352

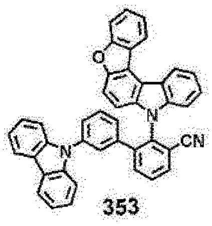
353

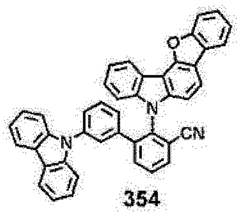
354

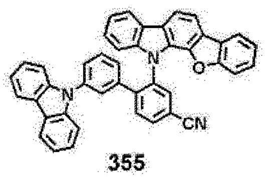
355

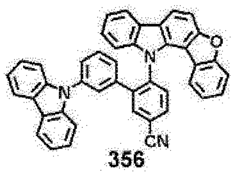
356

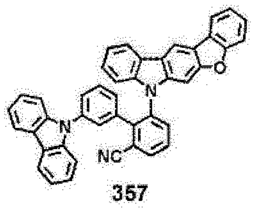
357

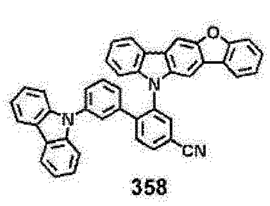
358

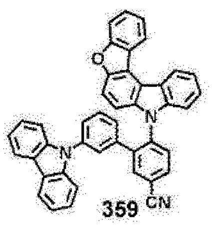
359

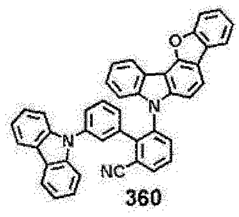
360

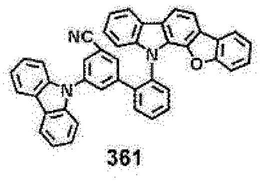
361
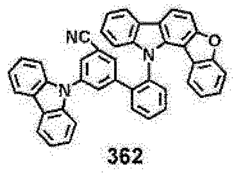
362
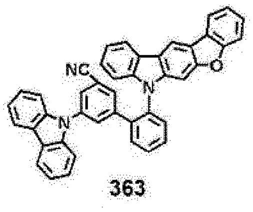
363
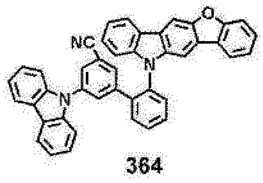
364

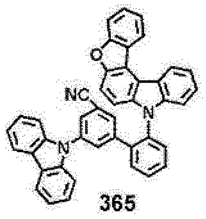
365
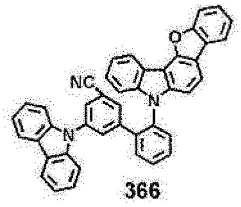
366
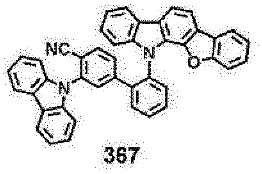
367
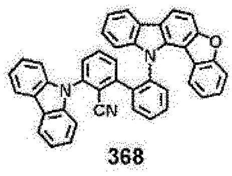
368

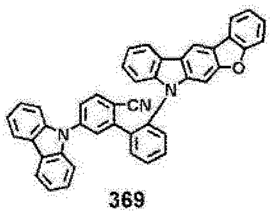
369
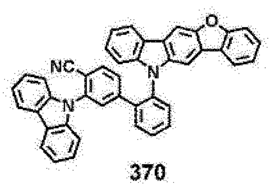
370
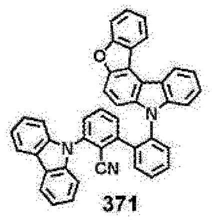
371
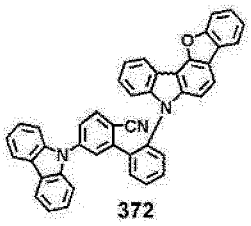
372

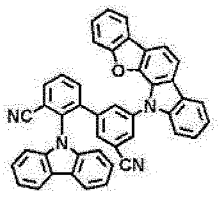
373
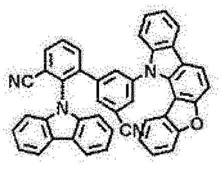
374
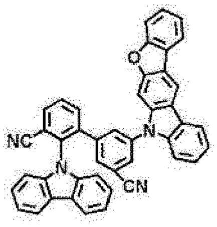
375
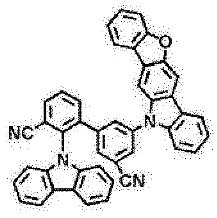
376

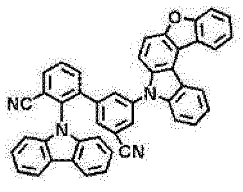
377
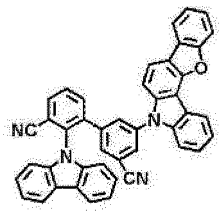
378
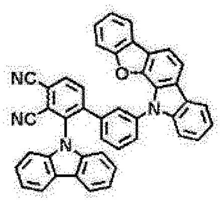
379
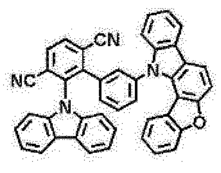
380

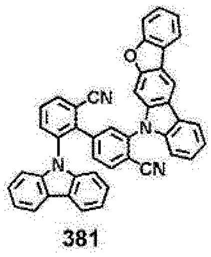
381
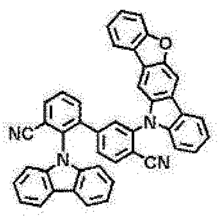
382
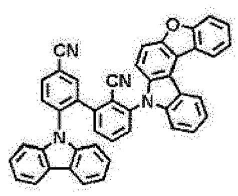
383
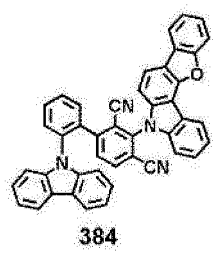
384

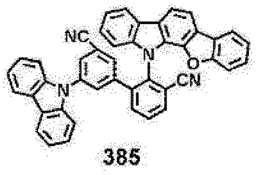
385

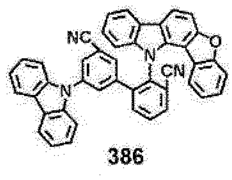
386

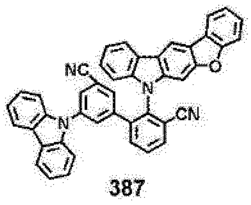
387

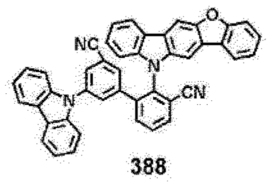
388

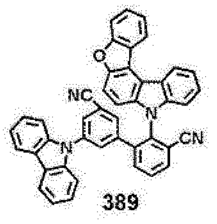
389

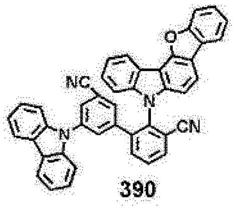
390

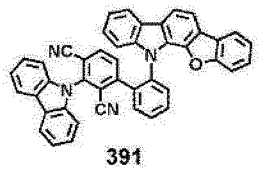
391

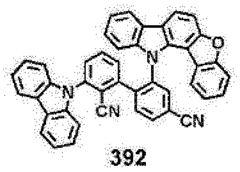
392

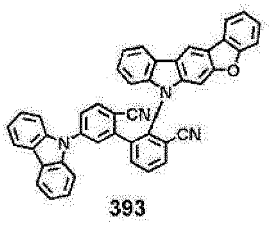
393

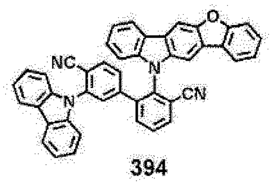
394

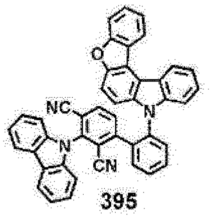
395

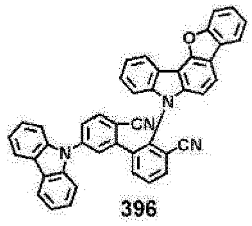
396

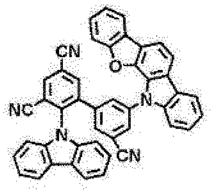
397

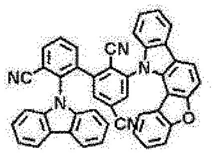
398

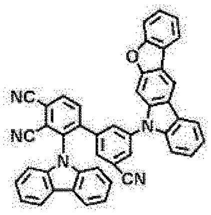
399

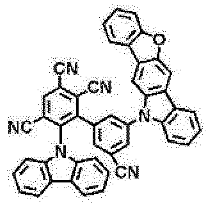
400

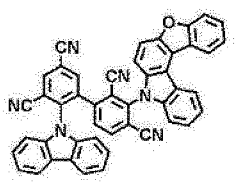
401

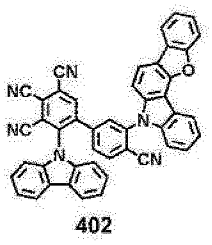
402

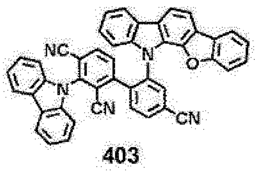
403

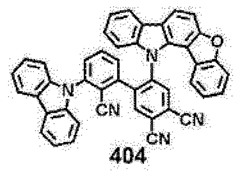
404

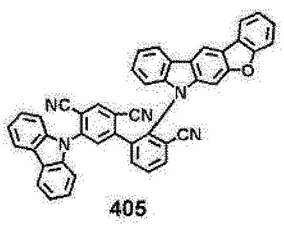
405

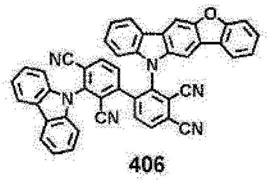
406

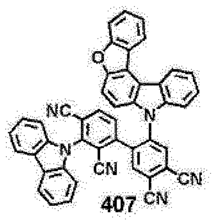
407

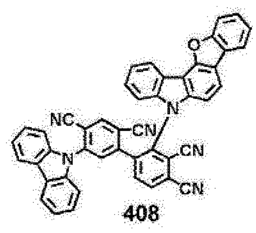
408

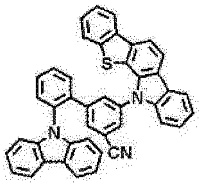
409

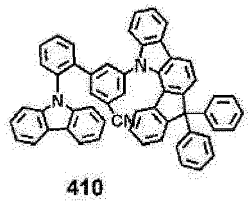
410

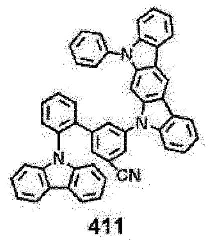
411

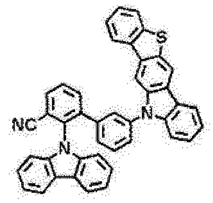
412

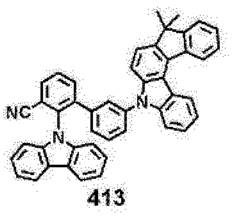
413

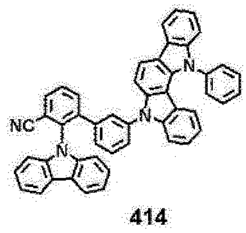
414

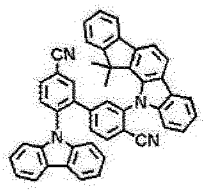
415

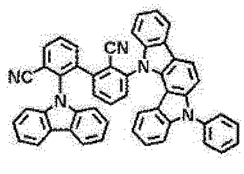
416

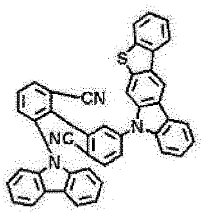
417

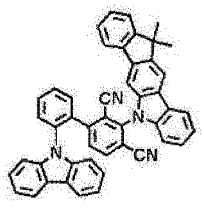
418

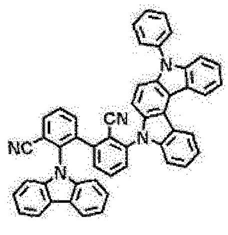
419

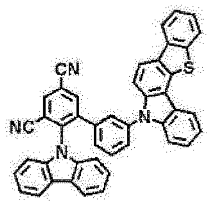
420

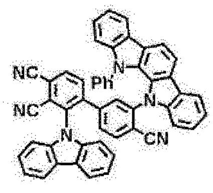
421

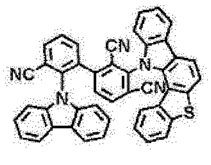
422

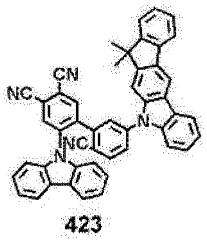
423

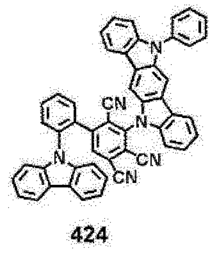
424

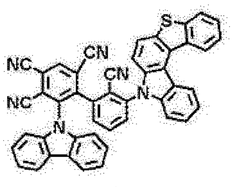
425

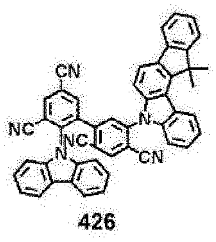
426

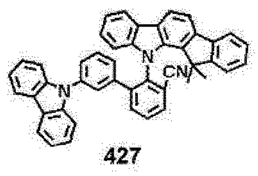
427

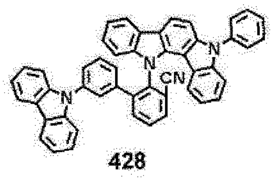
428

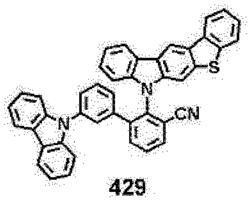
429

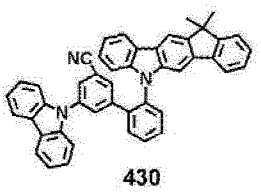
430

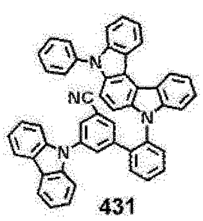
431

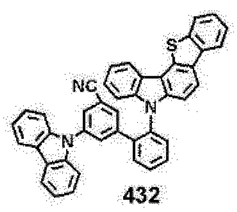
432

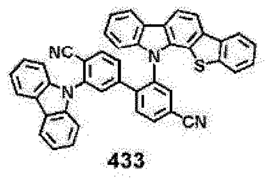
433

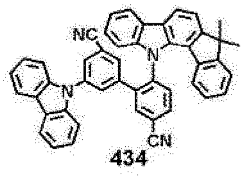
434

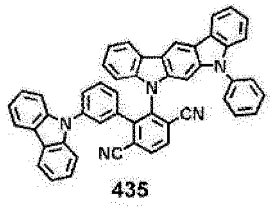
435

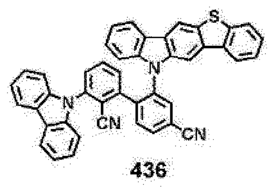
436

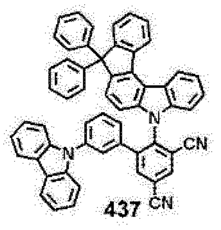
437

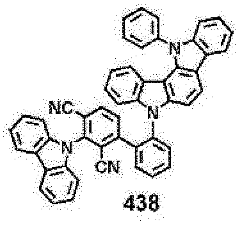
438

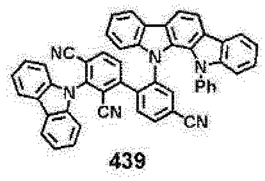
439

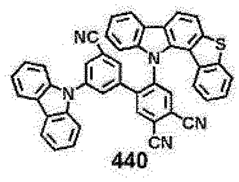
440

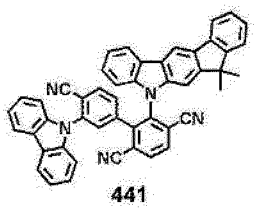
441

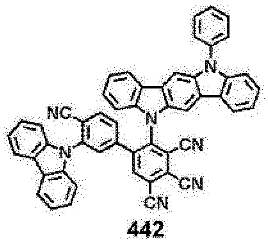
442

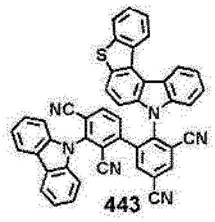
443

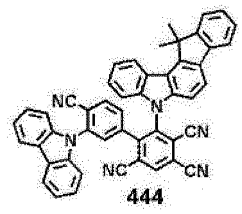
444

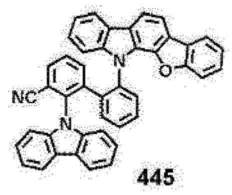
445

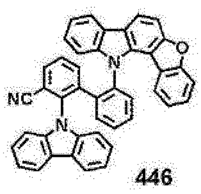
446

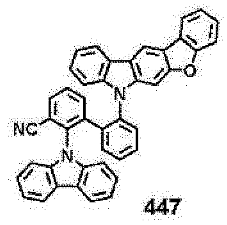
447

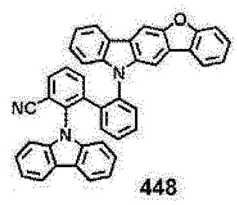
448

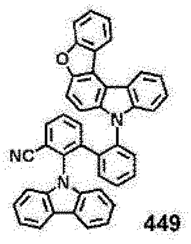
449

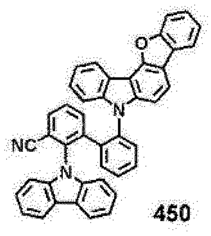
450

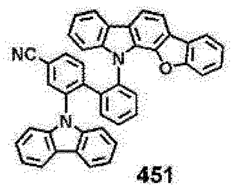
451

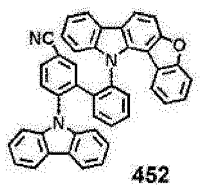
452

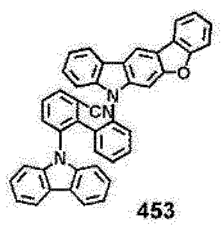
453

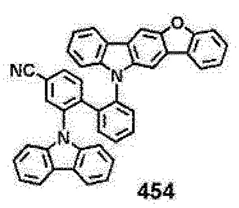
454

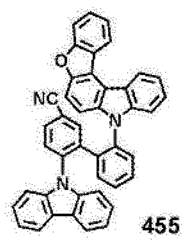
455

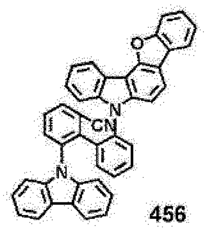
456

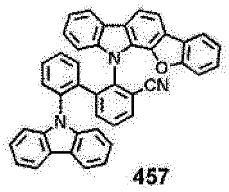
457

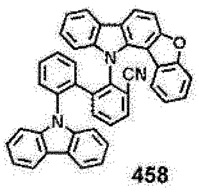
458

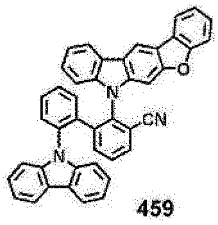
459

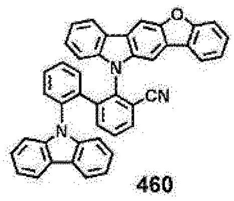
460

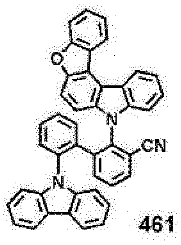
461

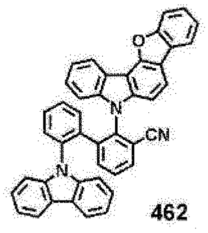
462

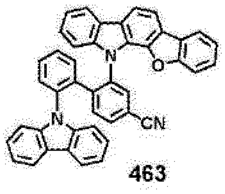
463

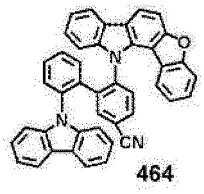
464

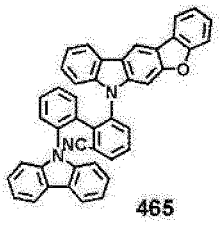
465

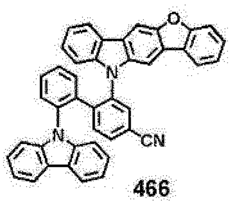
466

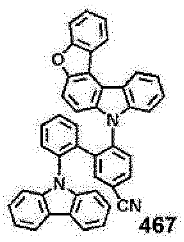
467

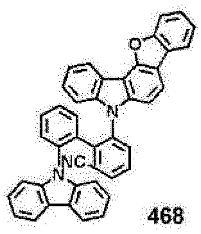
468

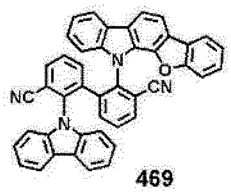
469

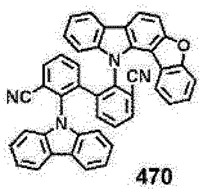
470

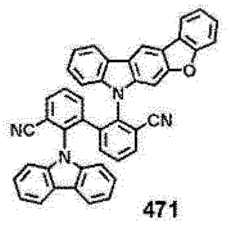
471

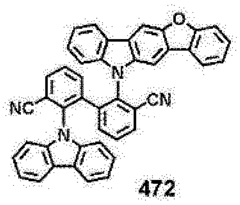
472

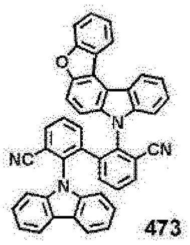
473

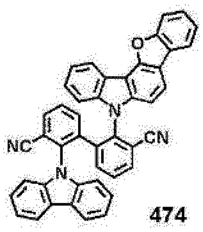
474

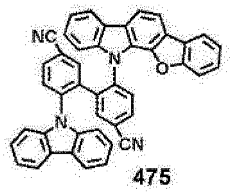
475

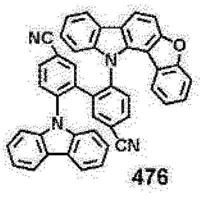
476

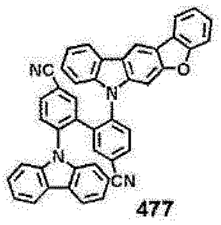
477

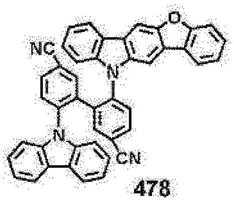
478

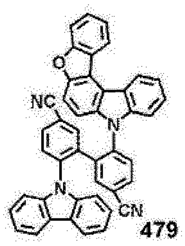
479

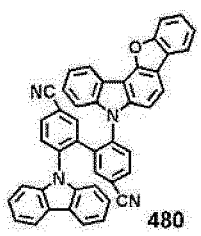
480

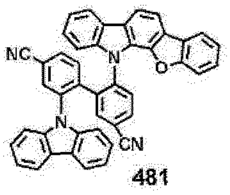
481

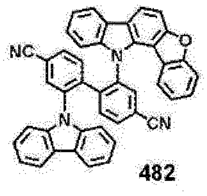
482

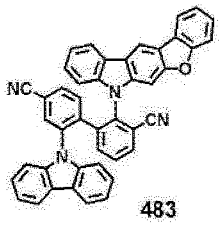
483

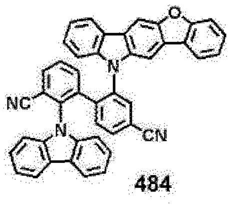
484

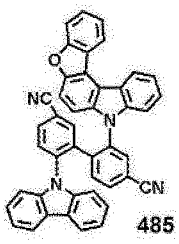
485

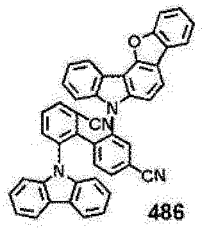
486

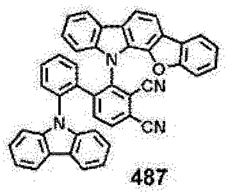
487

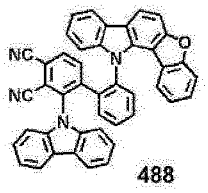
488

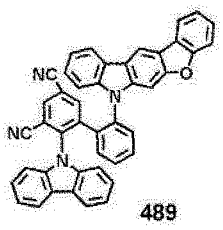
489

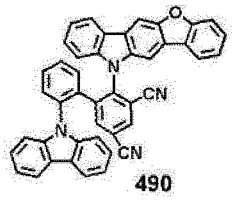
490

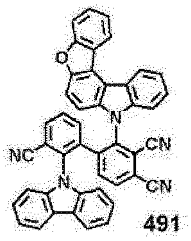
491

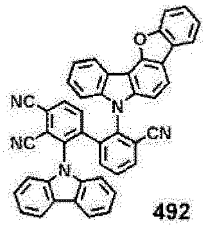
492

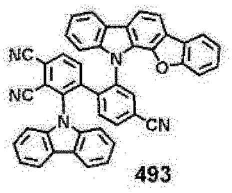
493

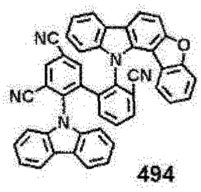
494

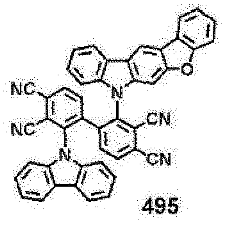
495

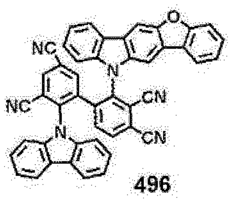
496

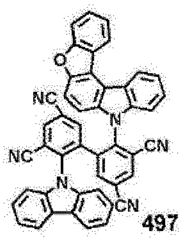
497

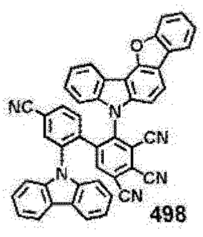
498

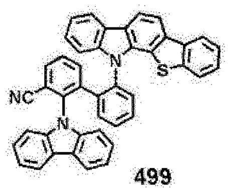
499

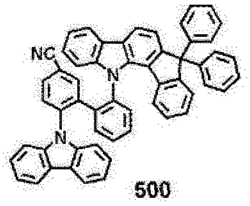
500

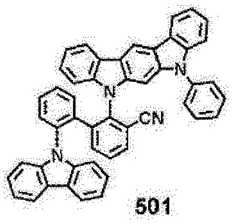
501

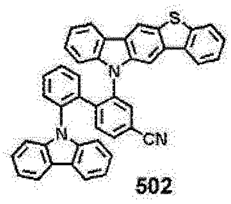
502

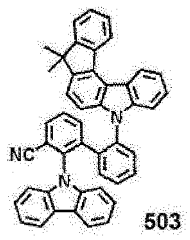
503

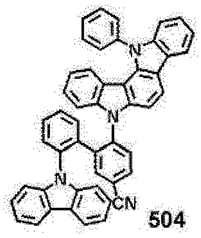
504

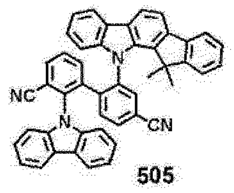
505

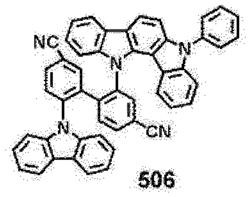
506

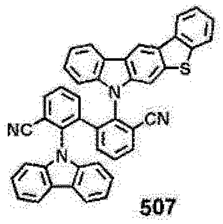
507

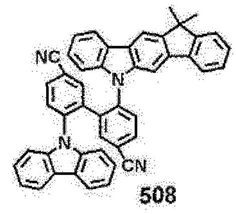
508

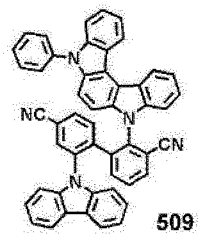
509

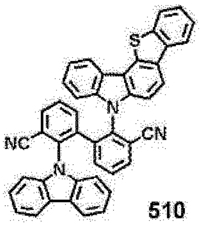
510

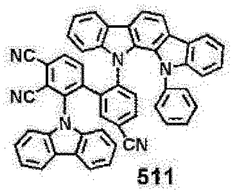
511

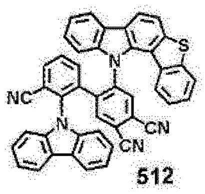
512

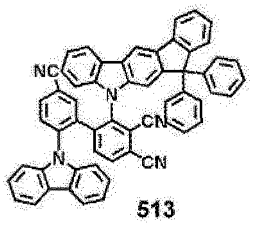
513

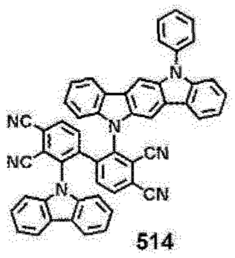
514

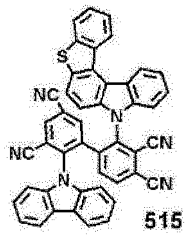
515

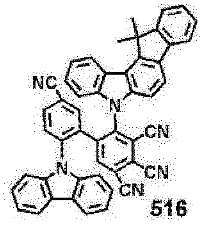
516

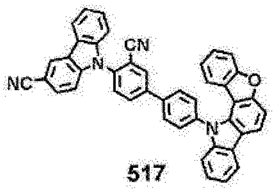
517

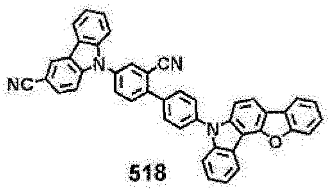
518

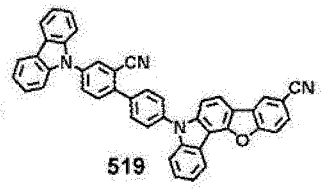
519

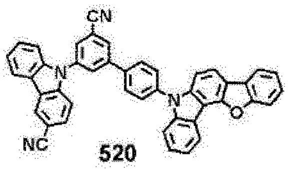
520

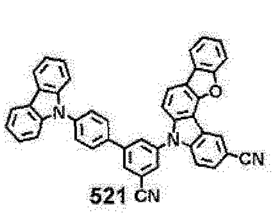
521

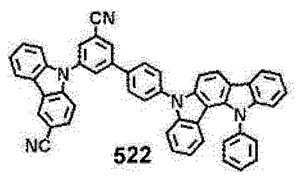
522

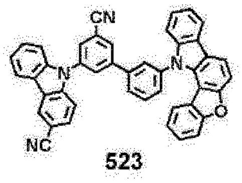
523

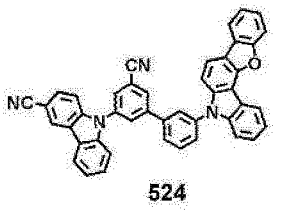
524

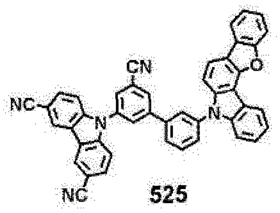
525

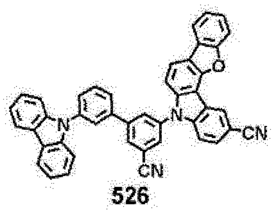
526

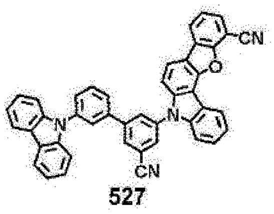
527

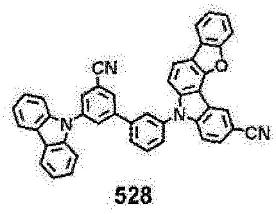
528

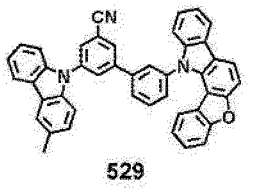
529

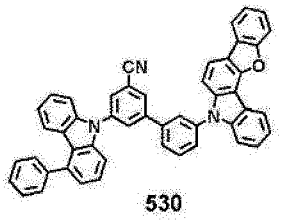
530

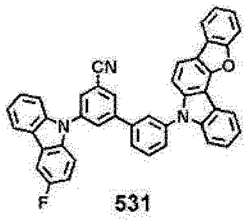
531

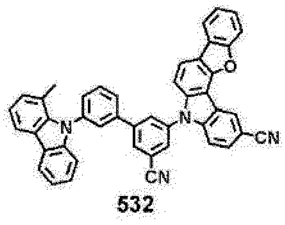
532

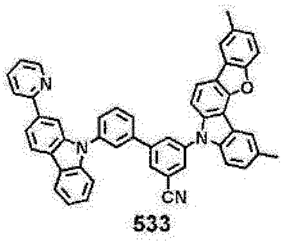
533

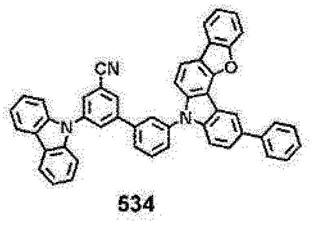
534

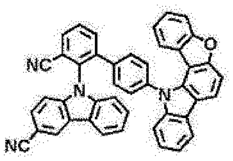
535

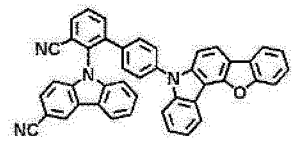
536

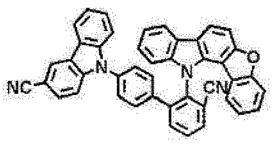
537

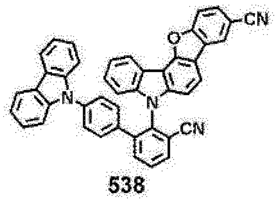
538

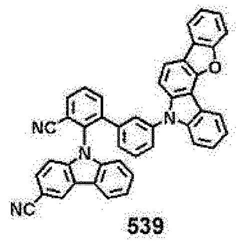
539

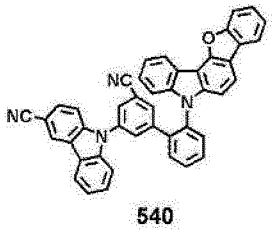
540

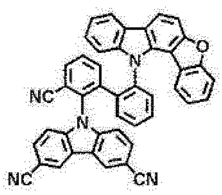
541

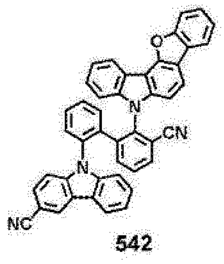
542

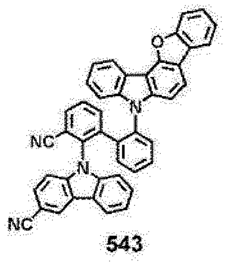
543

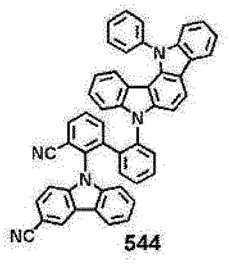
544

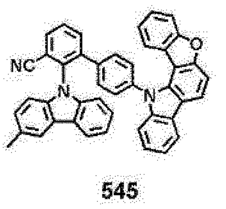
545

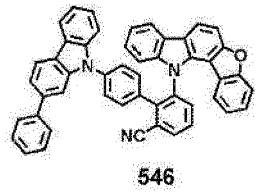
546

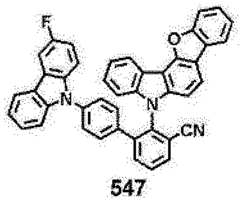
547

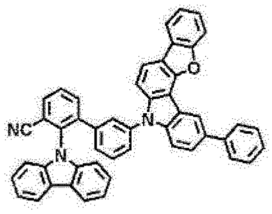
548

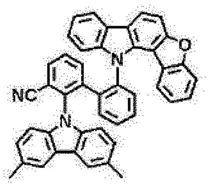
549

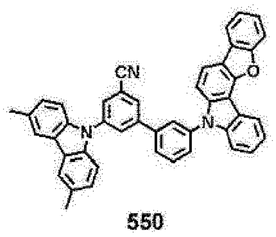
550

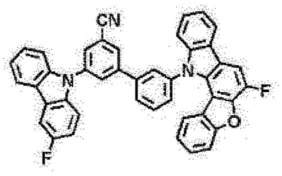
551

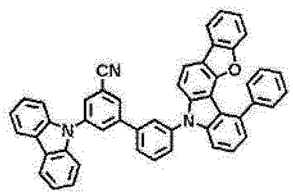
552

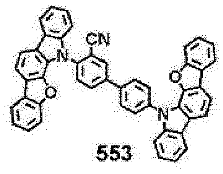
553
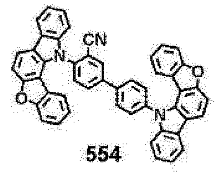
554
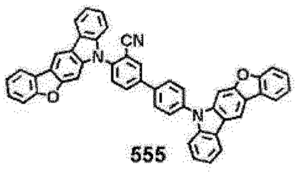
555
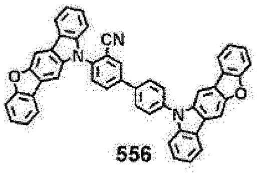
556

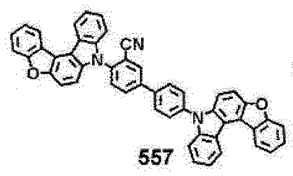
557
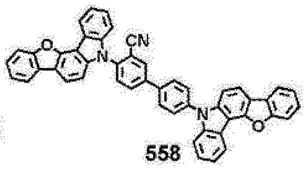
558
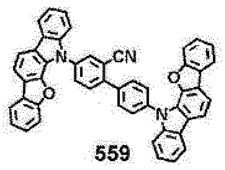
559
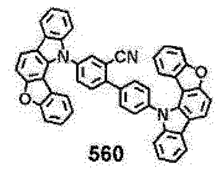
560

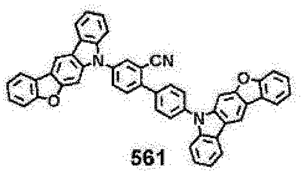
561
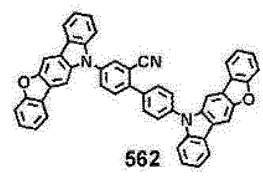
562
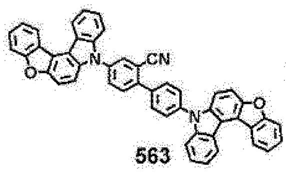
563
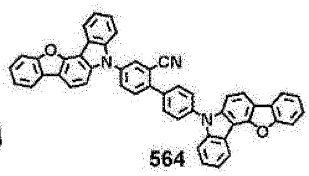
564

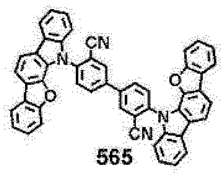
565
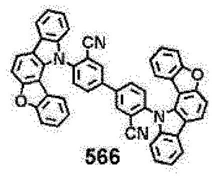
566
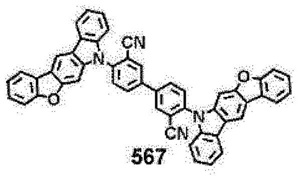
567
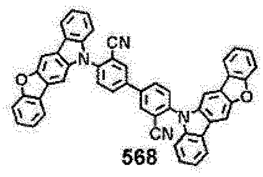
568

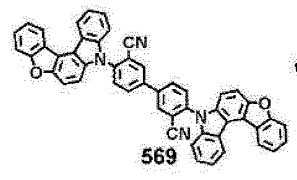
569
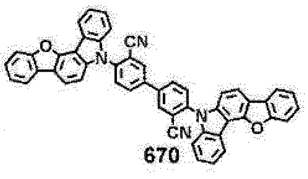
670
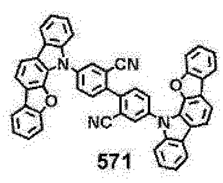
571
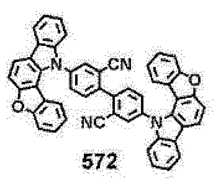
572

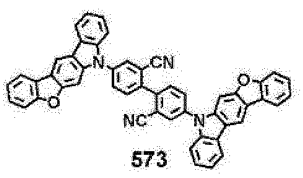
573
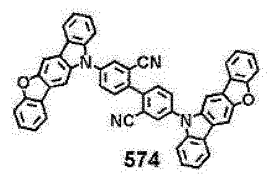
574
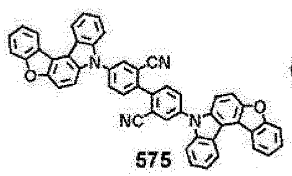
575
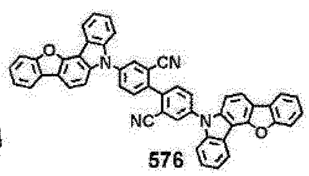
576

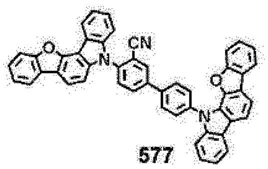
577
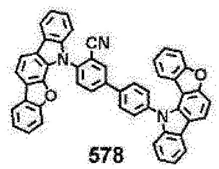
578
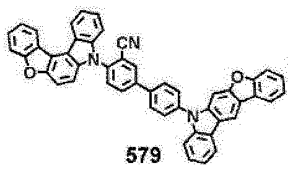
579
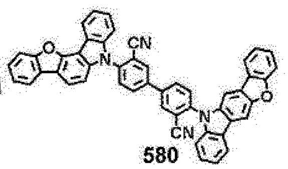
580

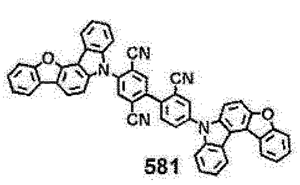
581
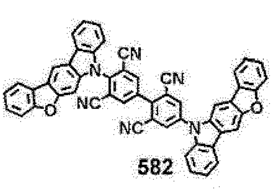
582
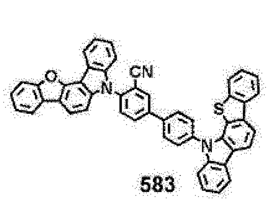
583
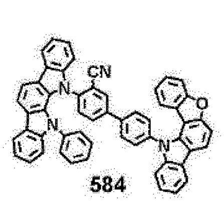
584

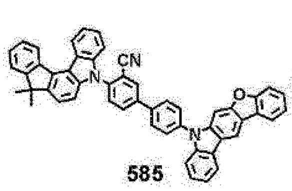
585
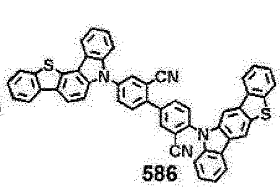
586
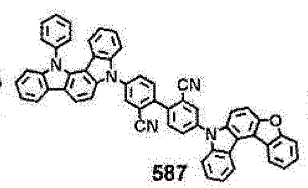
587
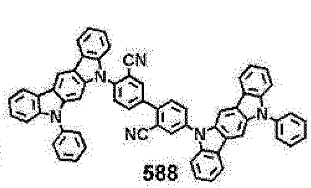
588

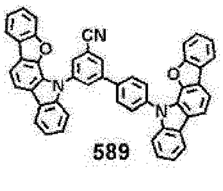
589
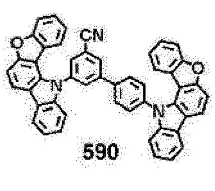
590
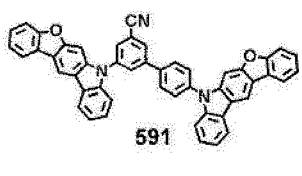
591
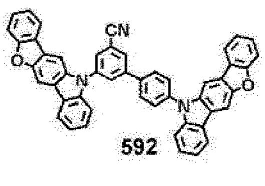
592

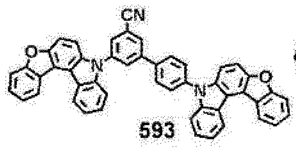
593
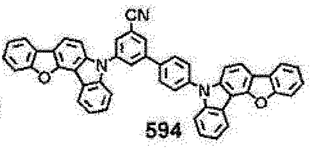
594
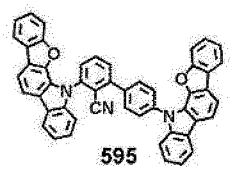
595
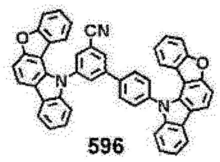
596

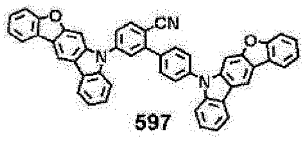
597
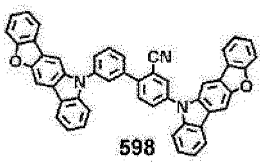
598
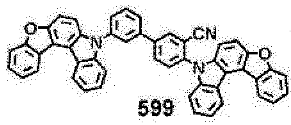
599
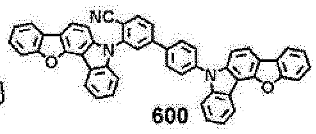
600

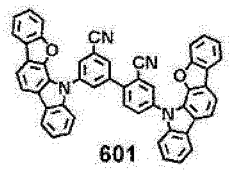
601
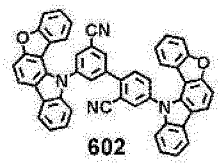
602
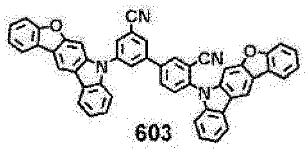
603
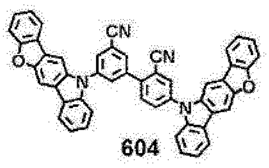
604

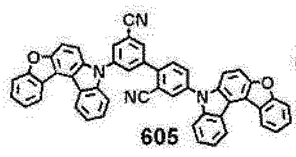
605
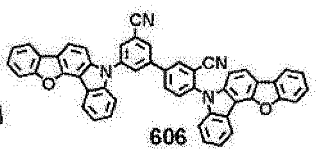
606
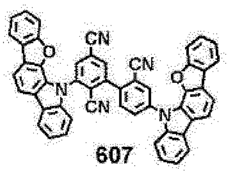
607
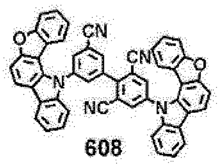
608

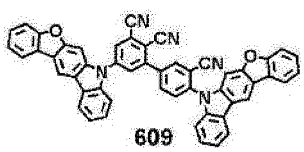
609
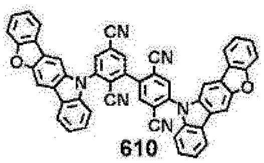
610
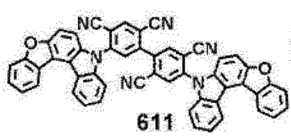
611
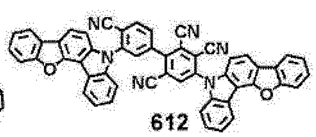
612

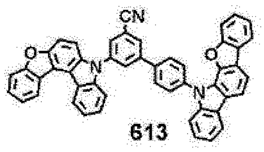
613
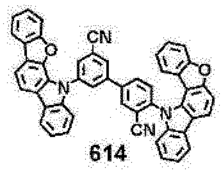
614
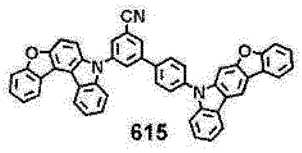
615
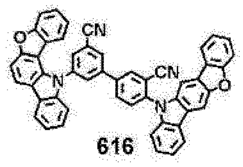
616

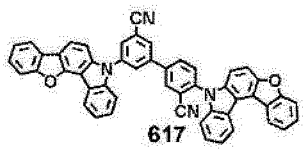
617
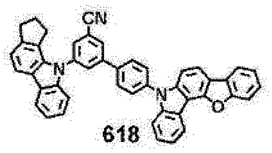
618
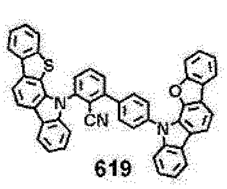
619
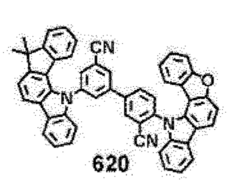
620

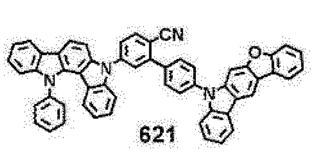
621
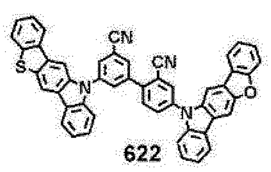
622
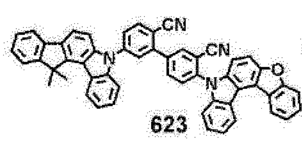
623
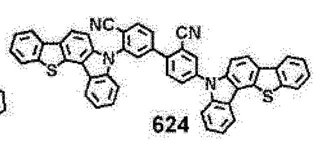
624

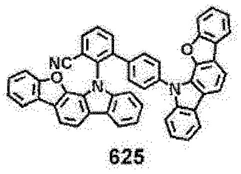
625
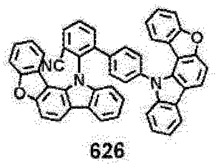
626
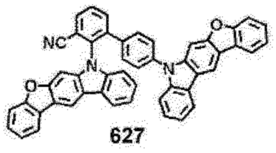
627
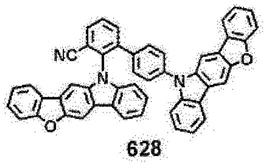
628

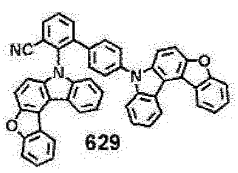
629
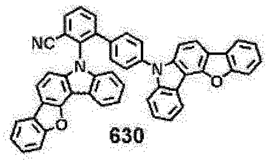
630
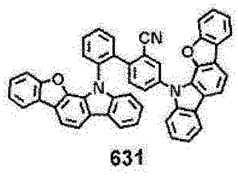
631
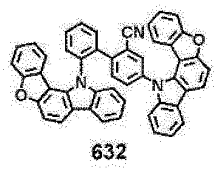
632

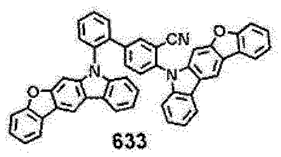
633
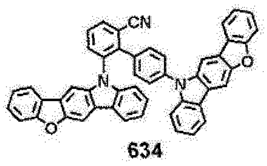
634
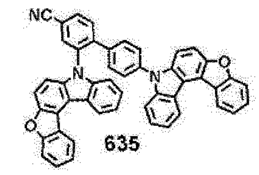
635
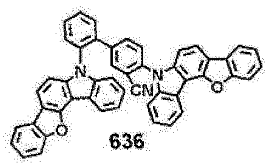
636

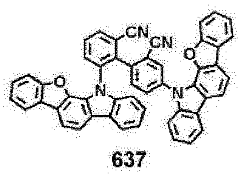
637
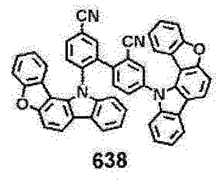
638
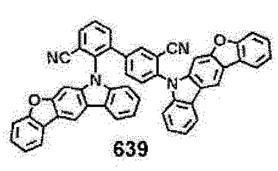
639
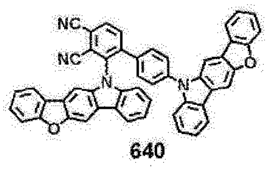
640

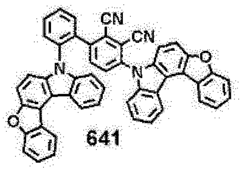
641
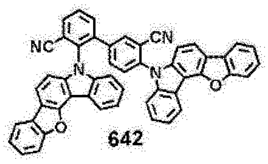
642
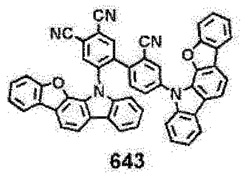
643
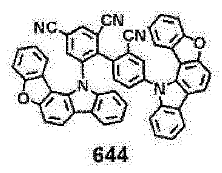
644

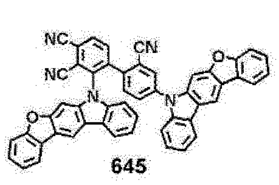
645
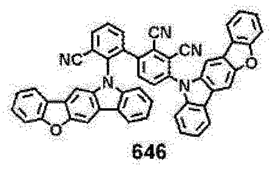
646
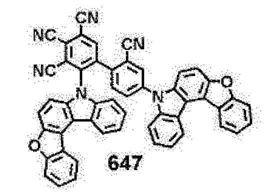
647
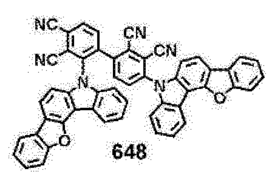
648

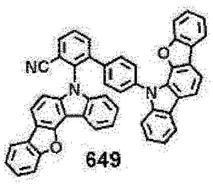
649
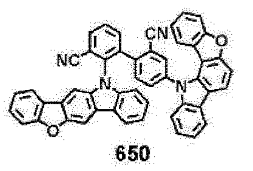
650
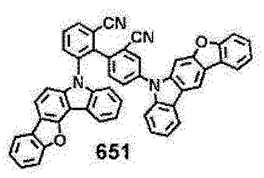
651
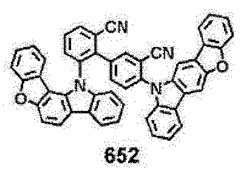
652

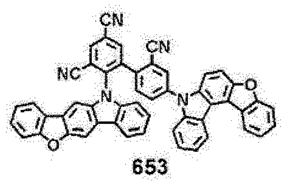
653
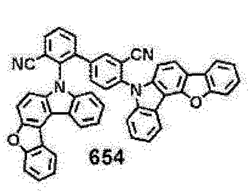
654
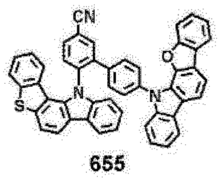
655
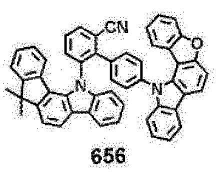
656

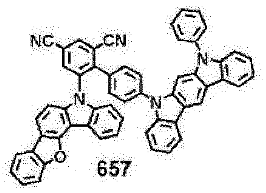
657
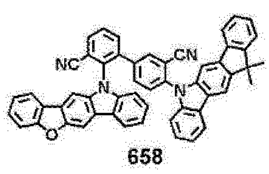
658
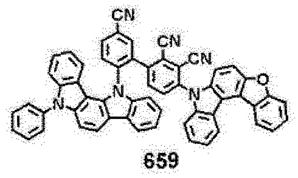
659
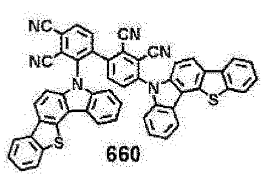
660

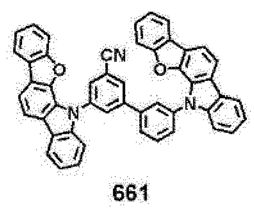
661

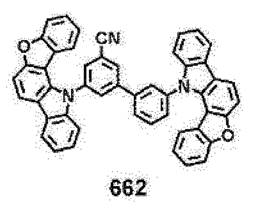
662

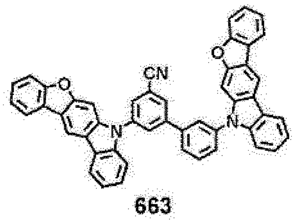
663

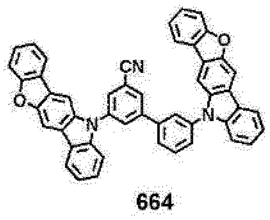
664

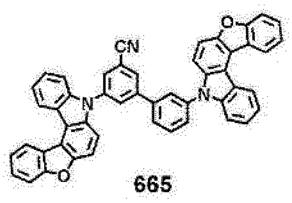
665

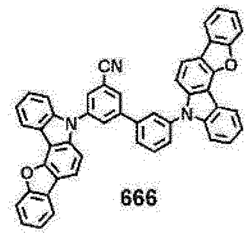
666

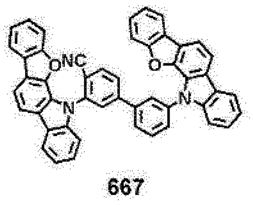
667

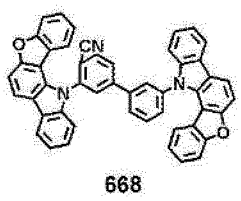
668

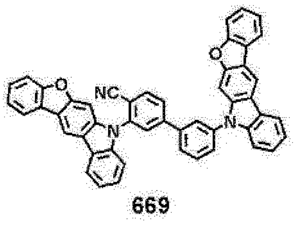
669

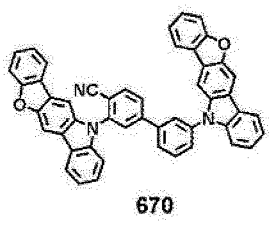
670

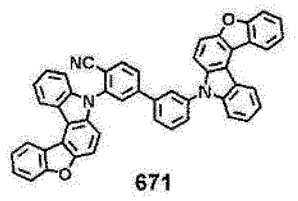
671

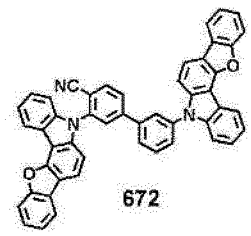
672

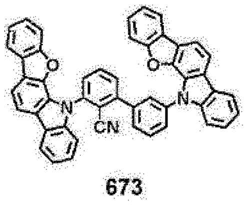
673

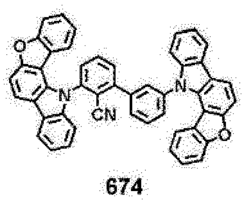
674

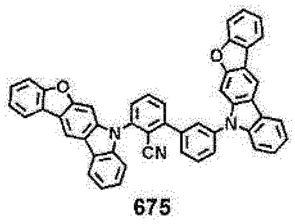
675

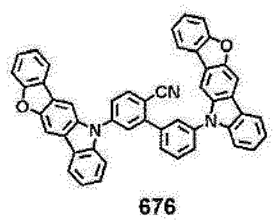
676

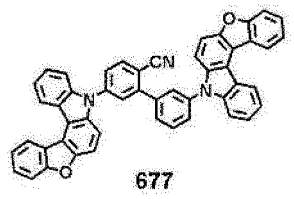
677

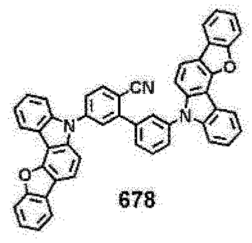
678

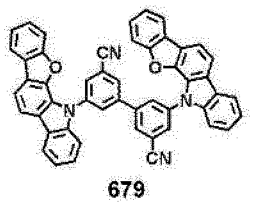
679

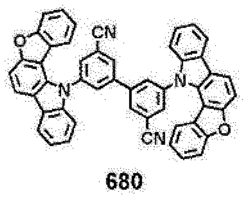
680

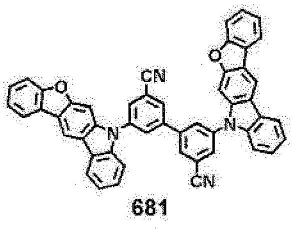
681

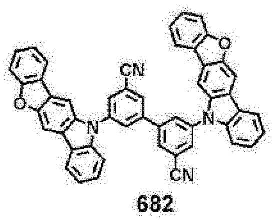
682

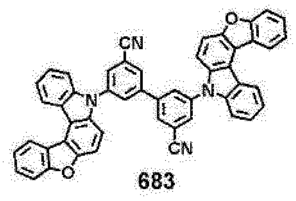
683

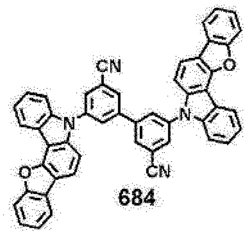
684

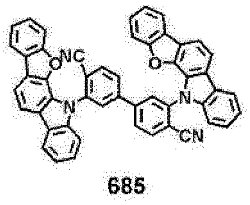
685

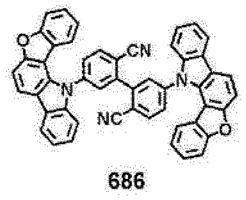
686

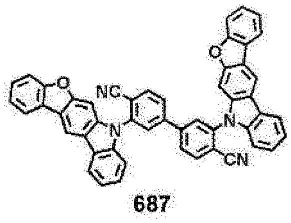
687

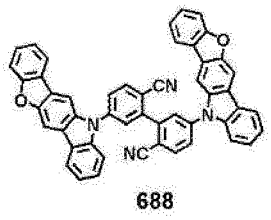
688

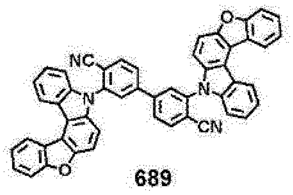
689

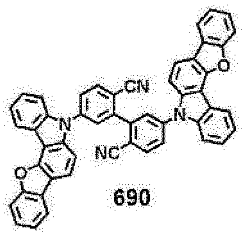
690

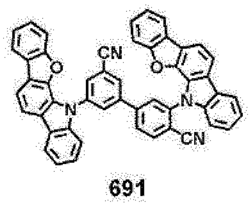
691

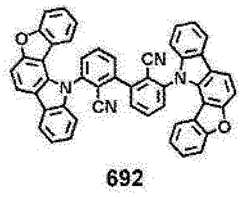
692

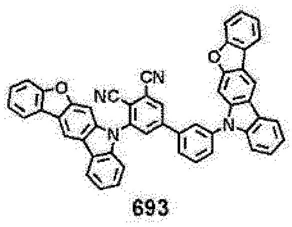
693

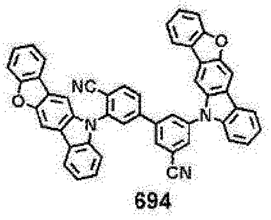
694

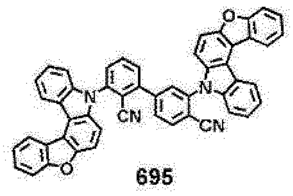
695

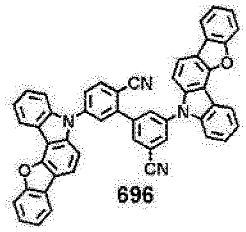
696

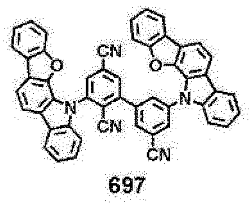
697

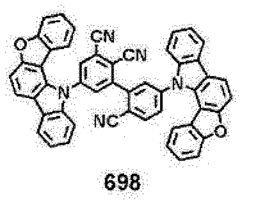
698

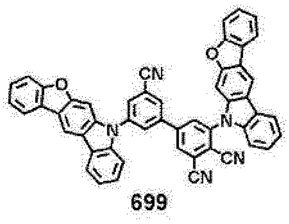
699

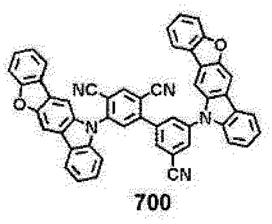
700

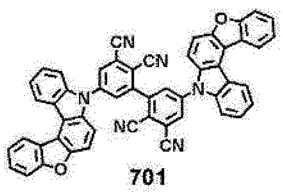
701

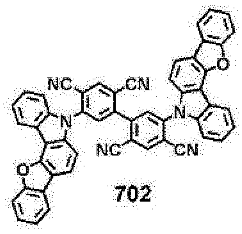
702

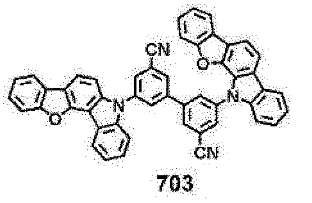
703

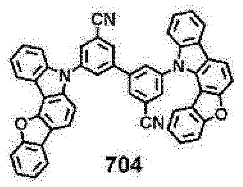
704

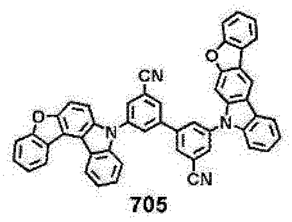
705

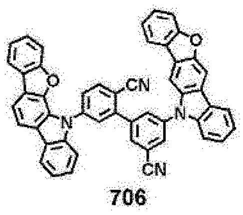
706

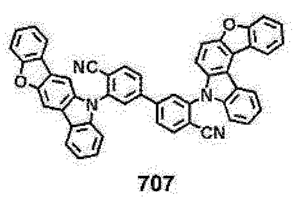
707

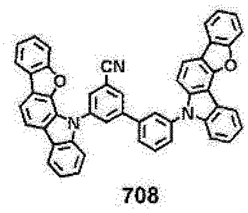
708

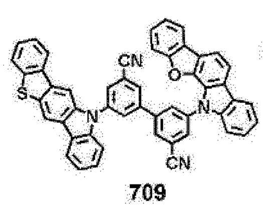
709

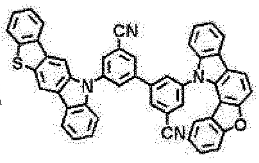
710

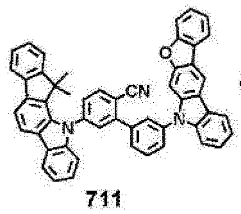
711

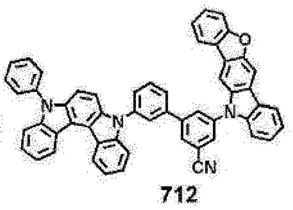
712

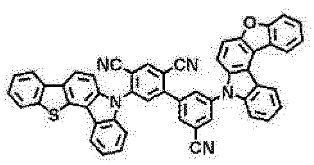
713

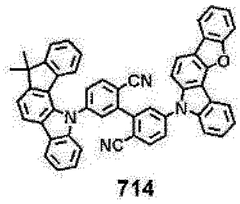
714

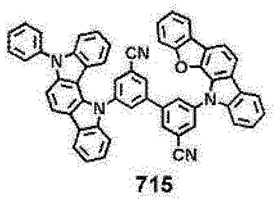
715

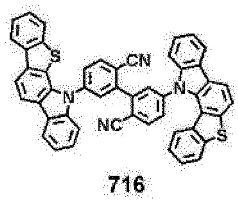
716

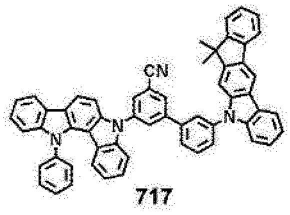
717

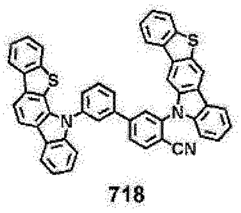
718

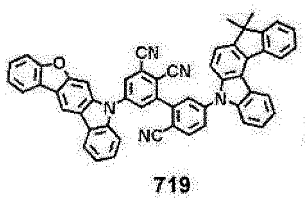
719

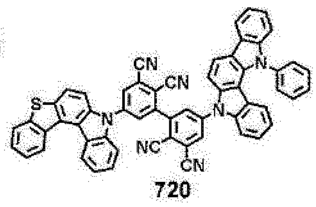
720

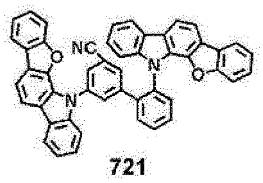
721

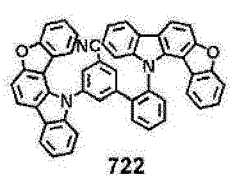
722

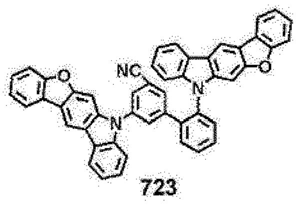
723

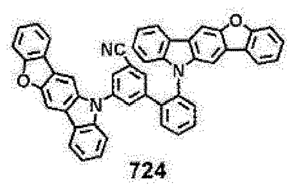
724

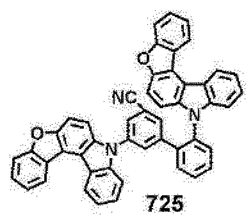
725

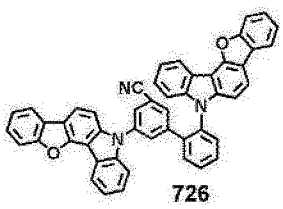
726

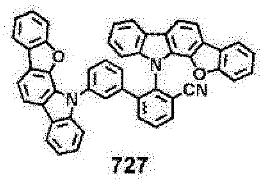
727

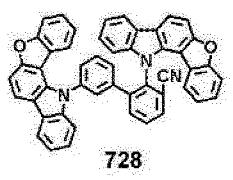
728

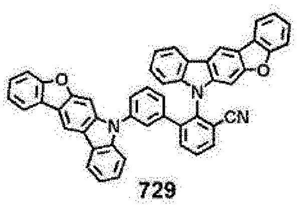
729

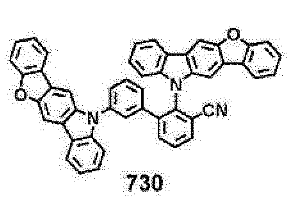
730

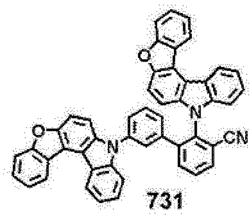
731

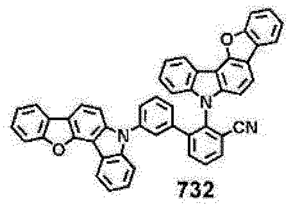
732

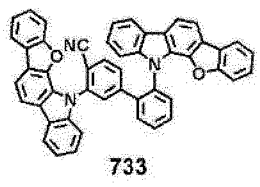
733

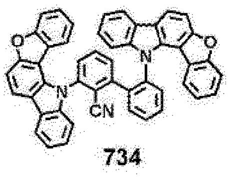
734

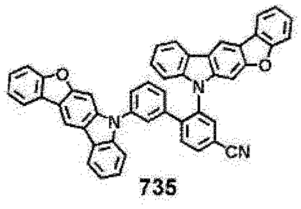
735

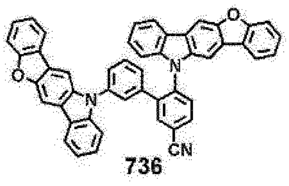
736

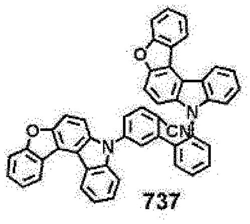
737

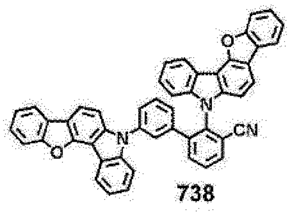
738

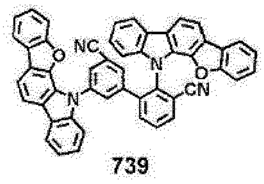
739

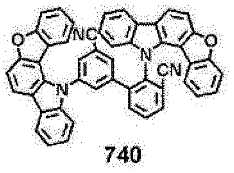
740

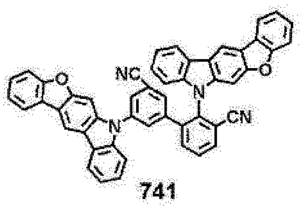
741

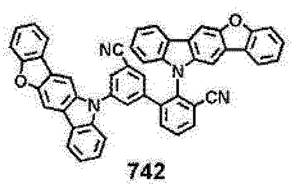
742

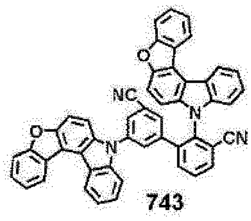
743

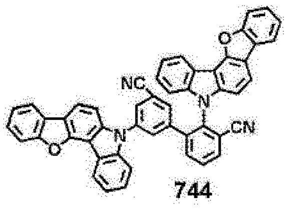
744

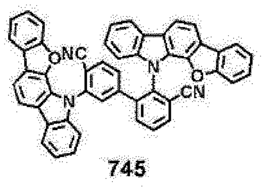
745

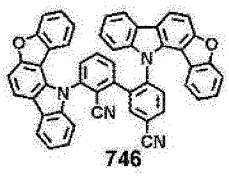
746

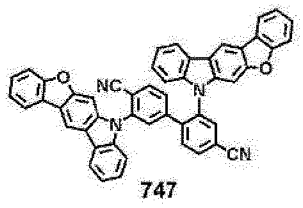
747

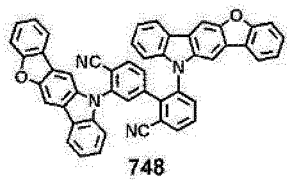
748

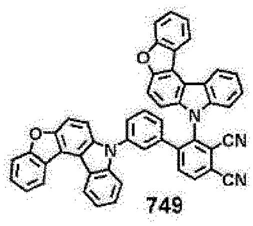
749

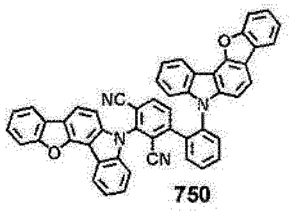
750

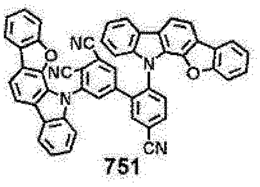
751

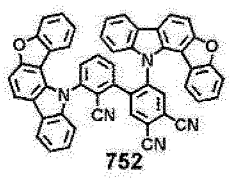
752

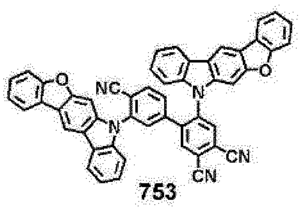
753

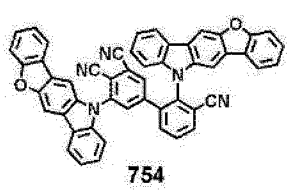
754

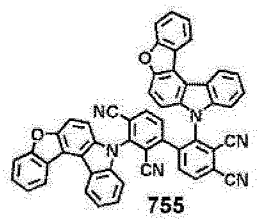
755

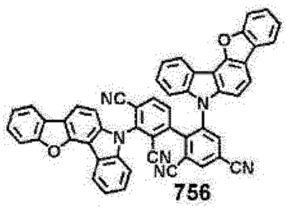
756

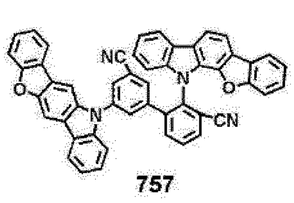
757

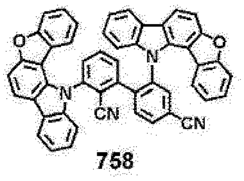
758

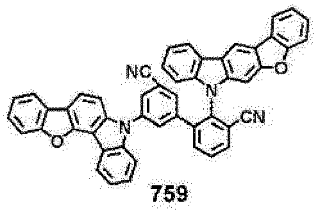
759

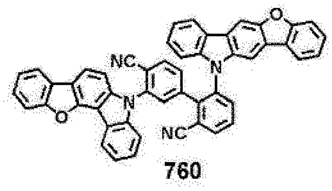
760

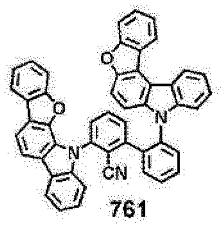
761

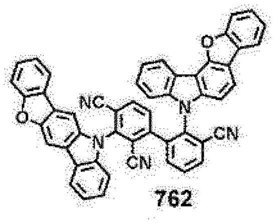
762

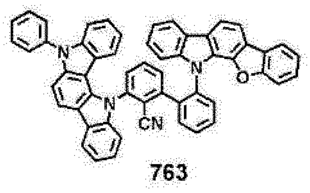
763

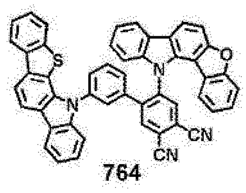
764

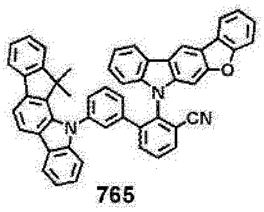
765

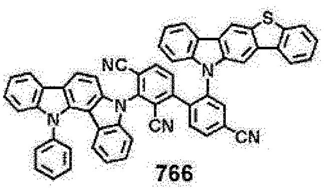
766

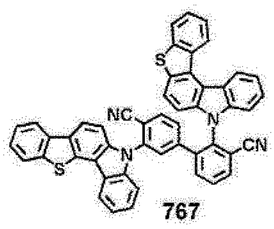
767

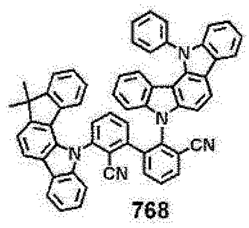
768

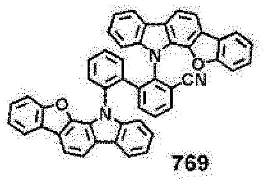
769

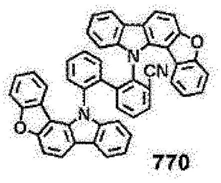
770

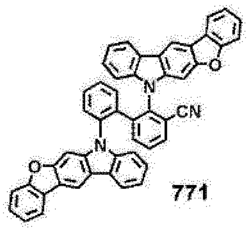
771

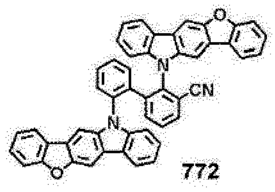
772

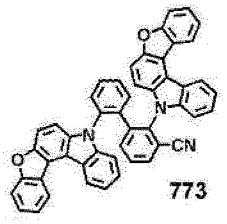
773

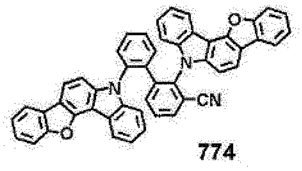
774

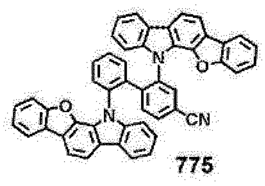
775

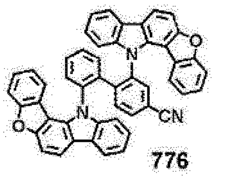
776

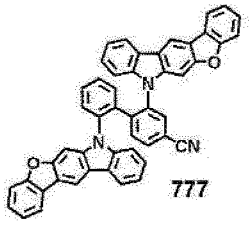
777

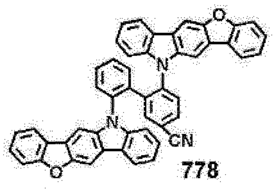
778

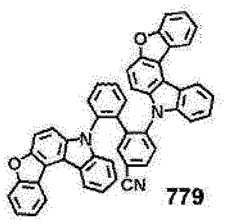
779

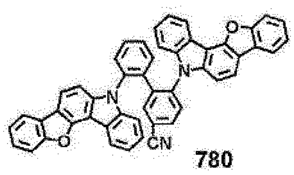
780

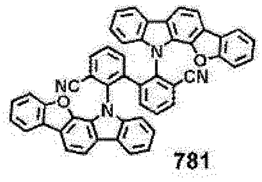
781

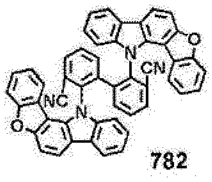
782

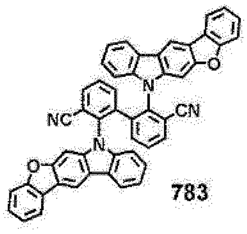
783

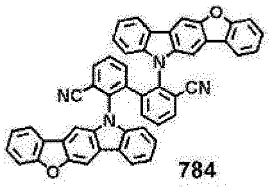
784

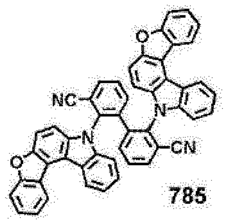
785

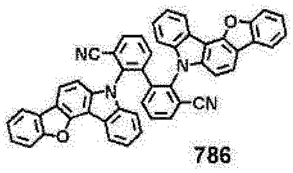
786

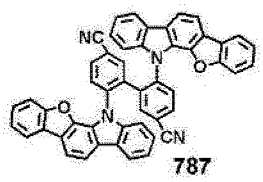
787

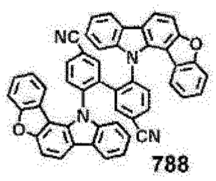
788

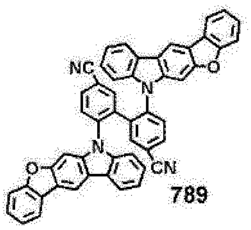
789

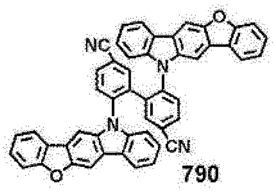
790

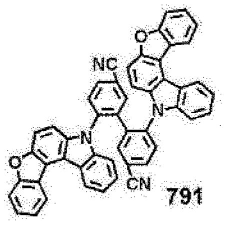
791

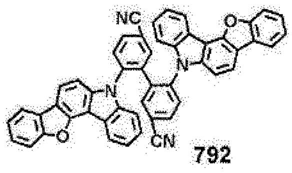
792

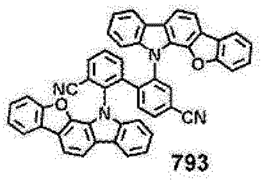
793

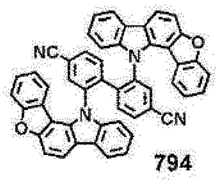
794

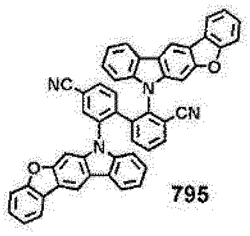
795

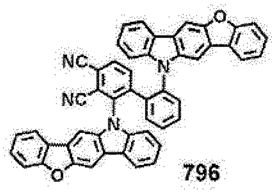
796

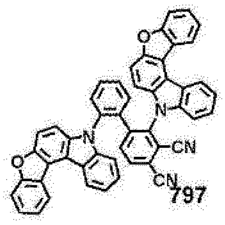
797

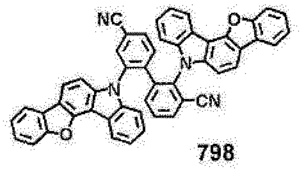
798

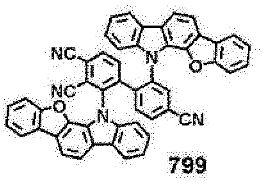
799

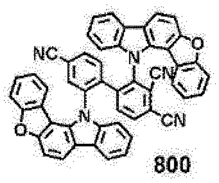
800

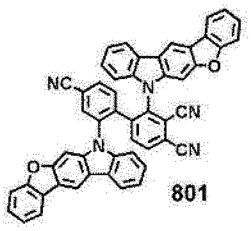
801

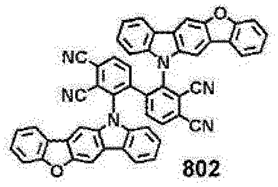
802

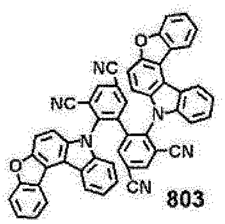
803

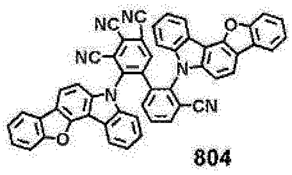
804

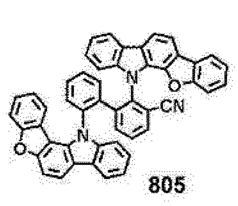
805

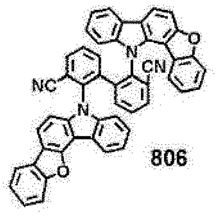
806

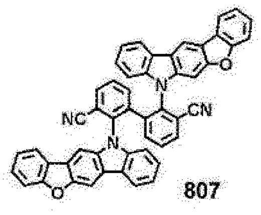
807

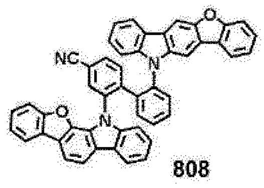
808

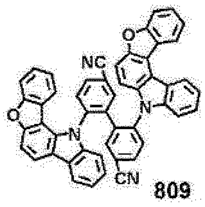
809

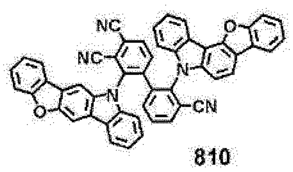
810

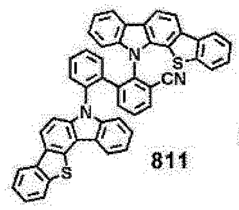
811

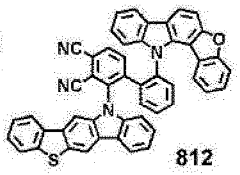
812

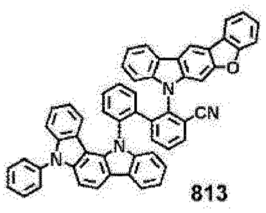
813

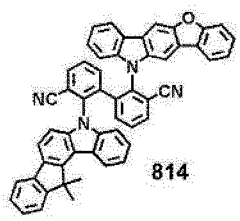
814

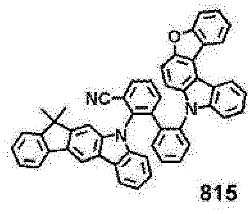
815

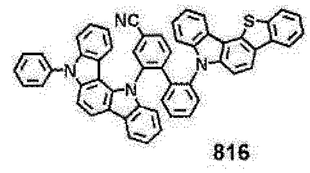
816

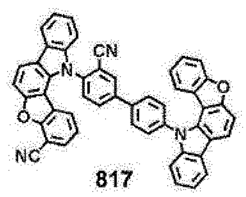
817

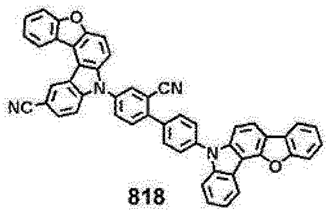
818

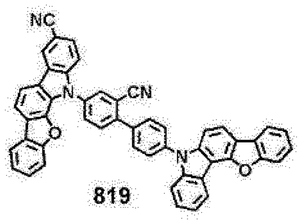
819

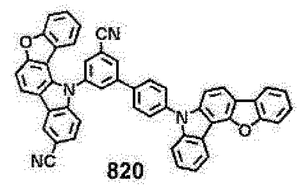
820

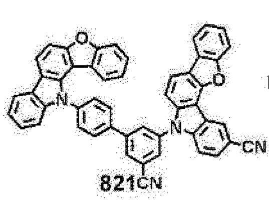
821

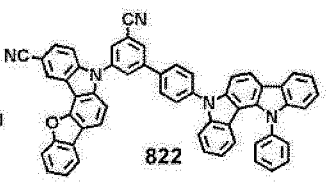
822

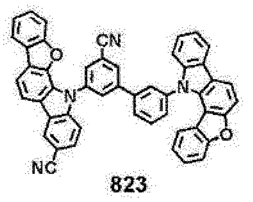
823

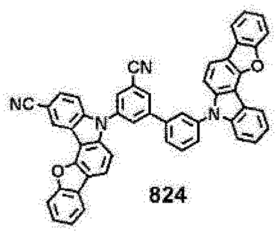
824

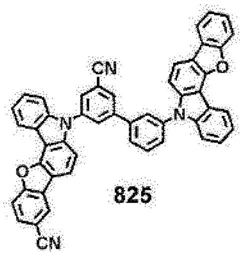
825

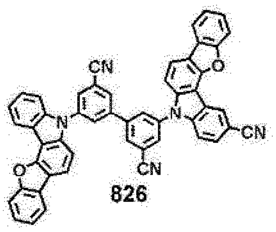
826

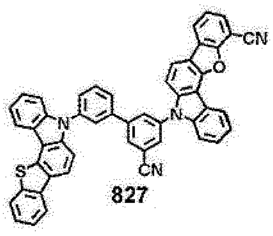
827

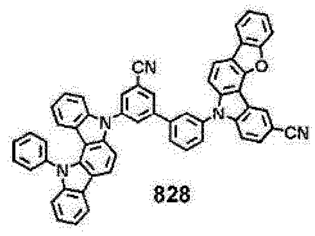
828

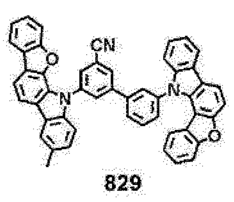
829
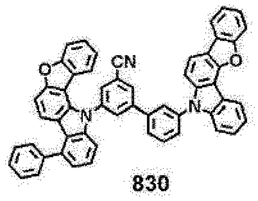
830
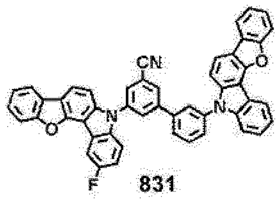
831
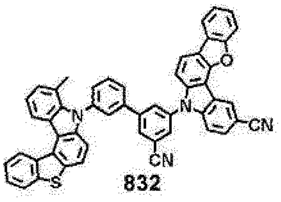
832

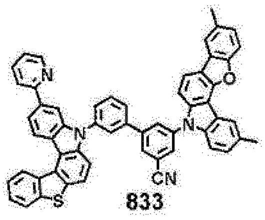
833
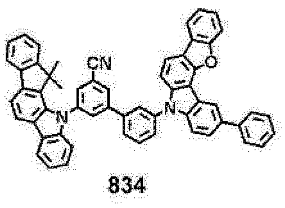
834
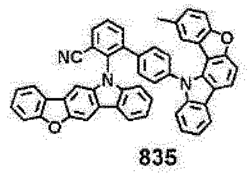
835
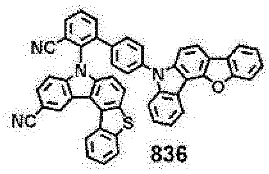
836

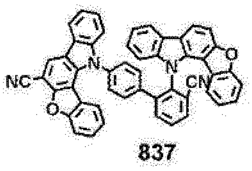
837
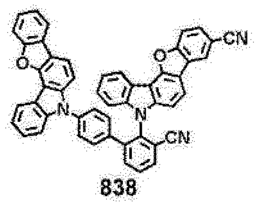
838
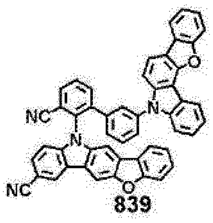
839
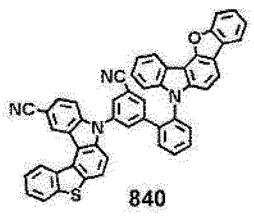
840

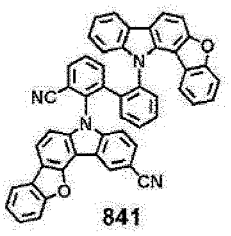
841
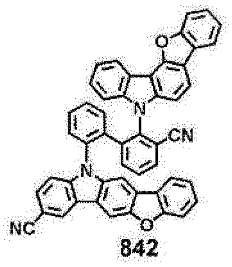
842
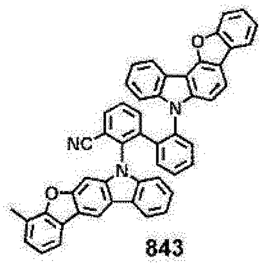
843
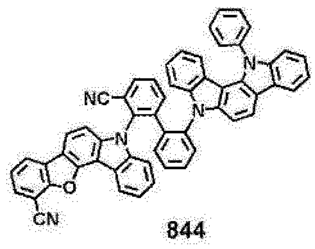
844

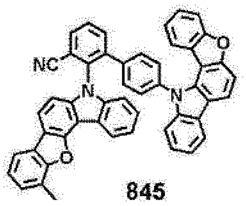
845
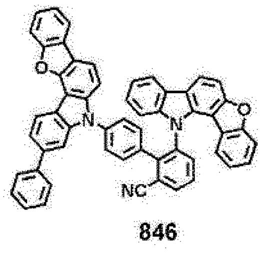
846
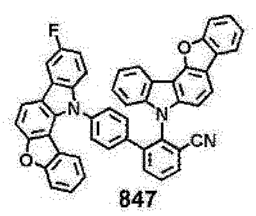
847
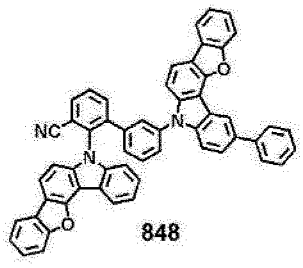
848

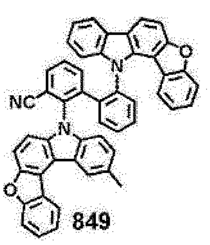
849
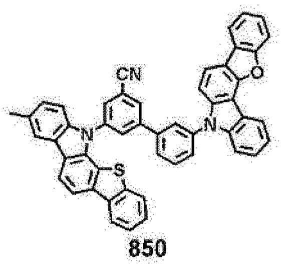
850
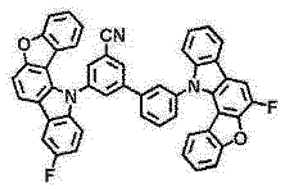
851
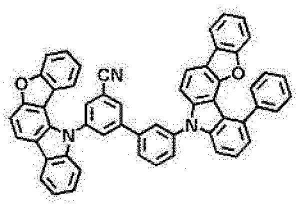
852

Group HE3

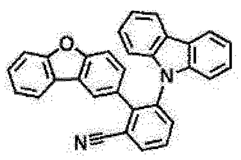
1

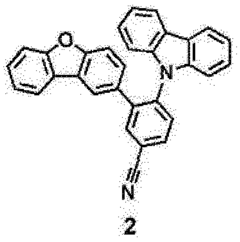
2

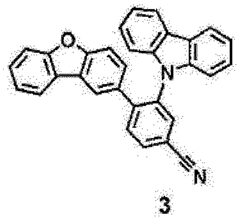
3

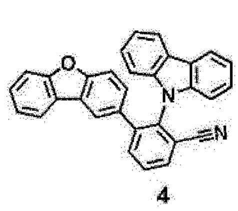
4

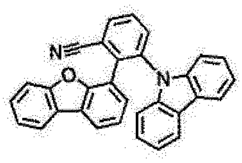
5

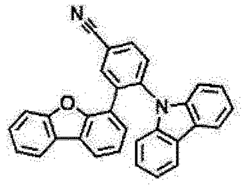
6

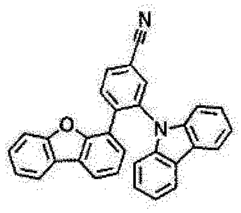
7

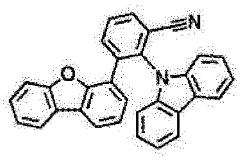
8

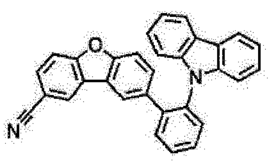
9

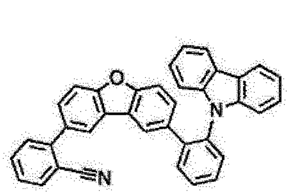
10

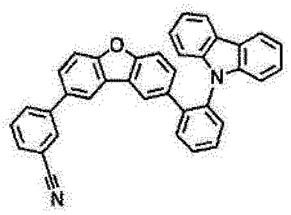
11

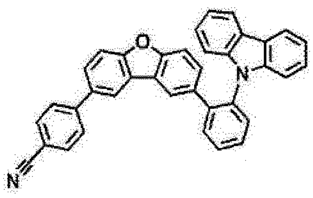
12

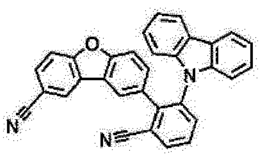
13

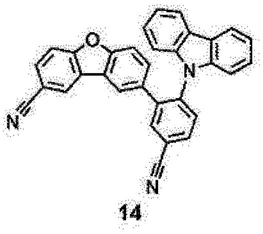
14

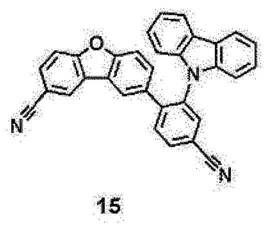
15

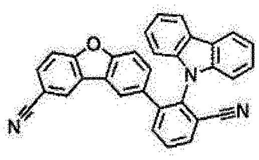
16

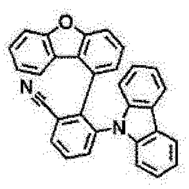
17

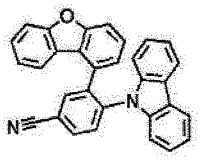
18

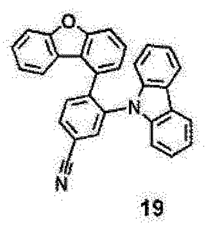
19

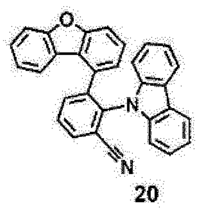
20

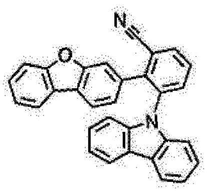
21

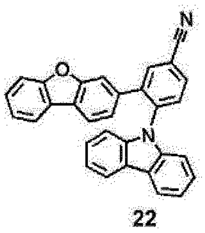
22

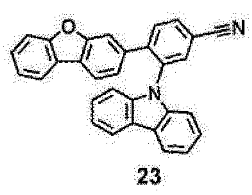
23

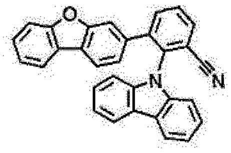
24

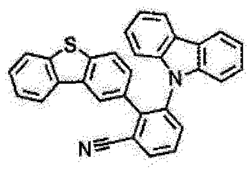
25

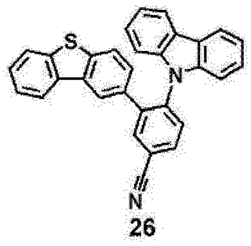
26

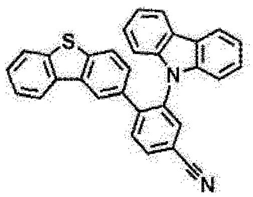
27

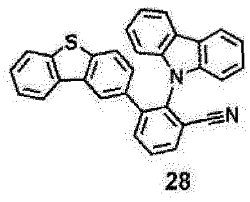
28

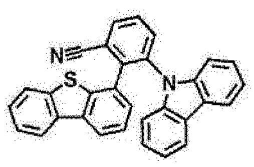
29

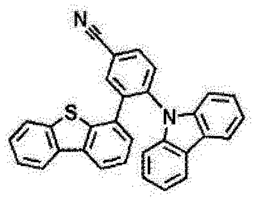
30

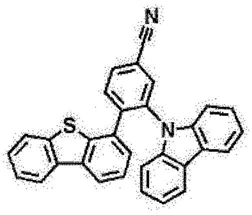
31

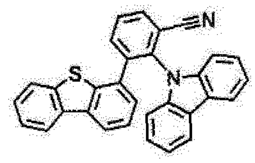
32

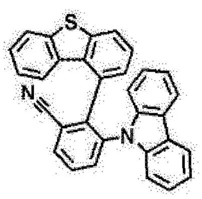
33

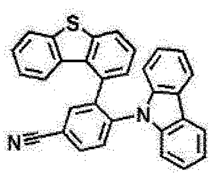
34

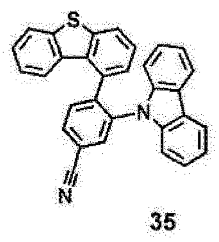
35

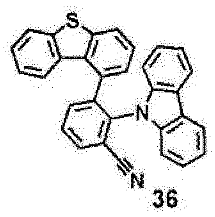
36

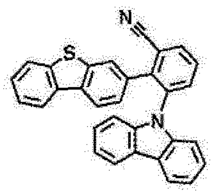
37

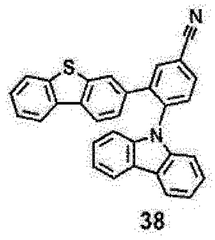
38

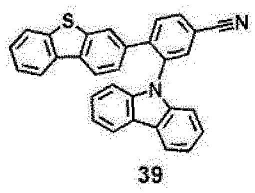
39

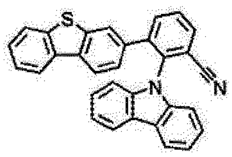
40

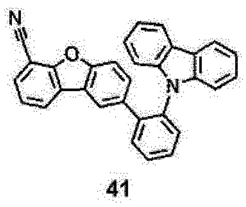
41

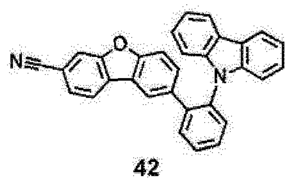
42

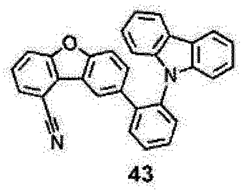
43

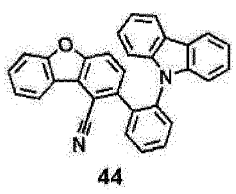
44

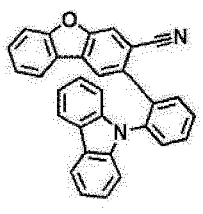

45

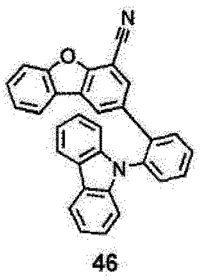

46

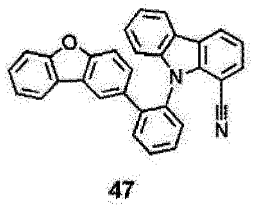

47

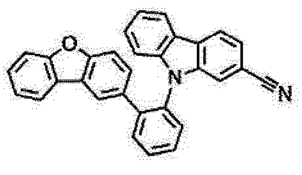

48

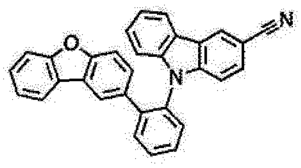

49

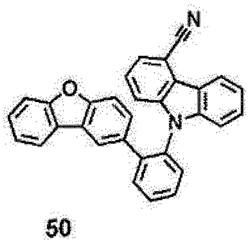

50

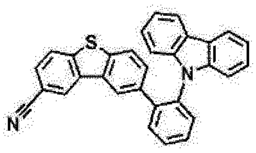

51

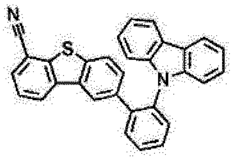

52

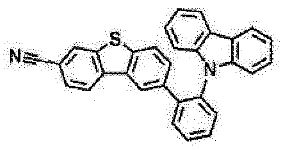

53

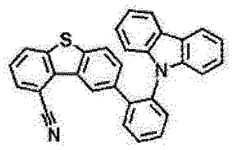

54

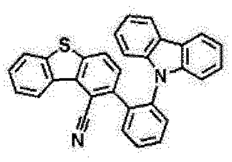

55

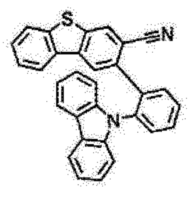

56

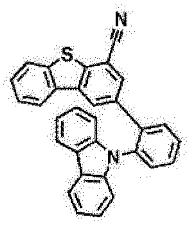

57

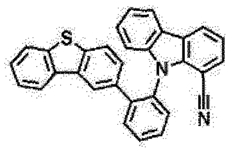

58

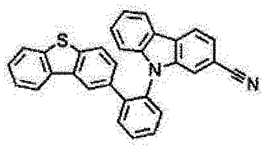

59

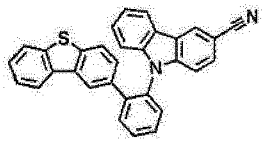

60

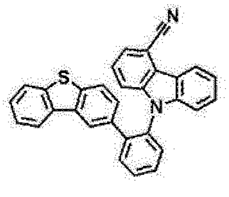

61

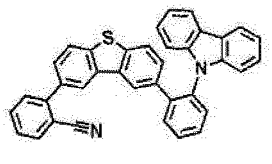

62

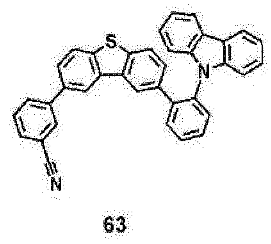

63

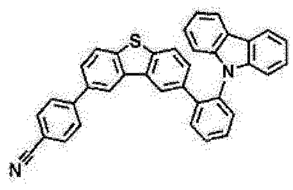

64

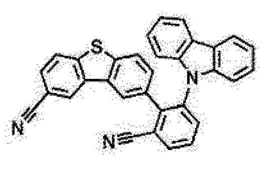
65

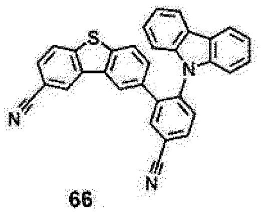
66

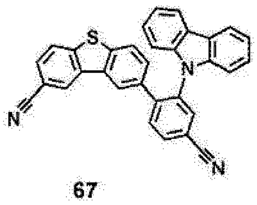
67

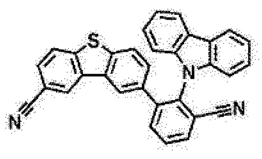
68

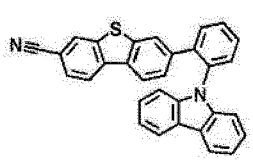
69

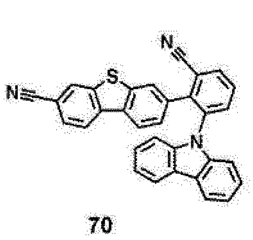
70

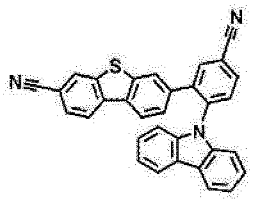
71

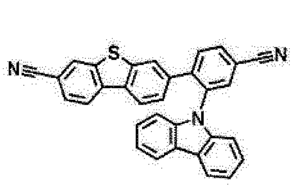
72

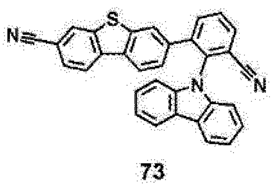
73

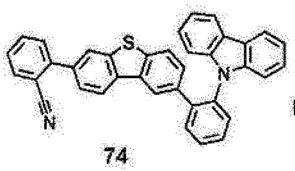
74

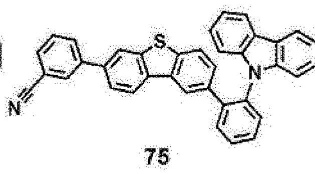
75

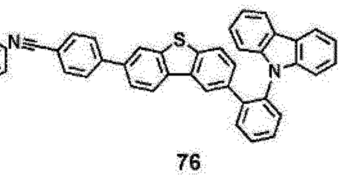
76

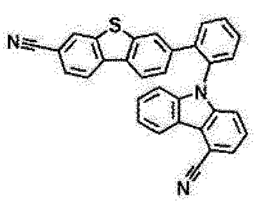
77

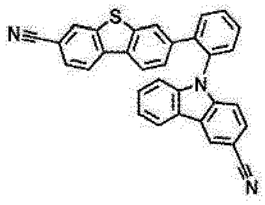
78

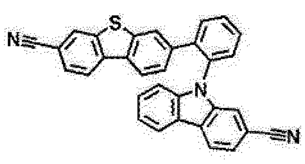
79

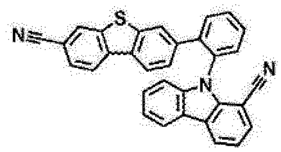
80

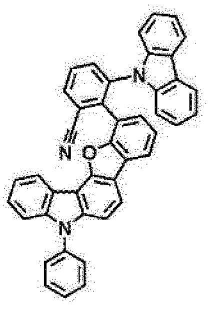
81

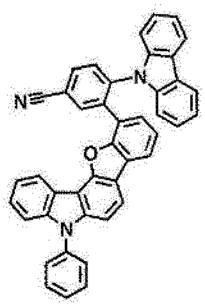
82

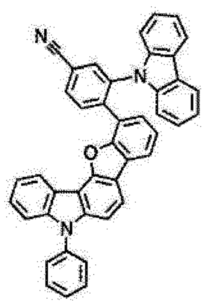
83

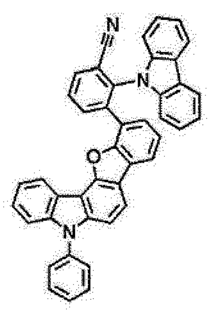
84

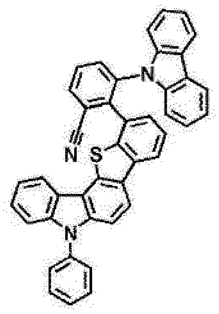
85

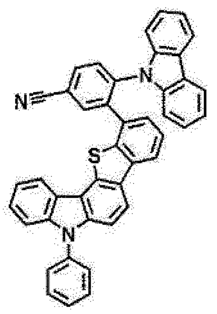
86

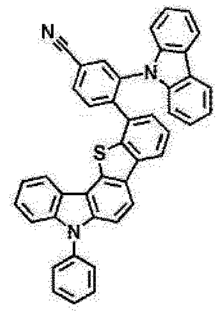
87

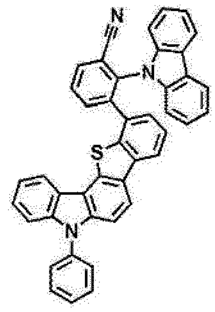
88

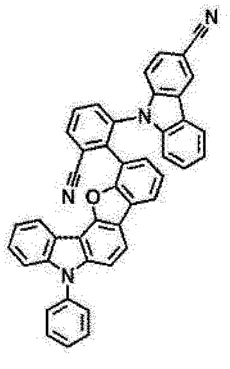
89

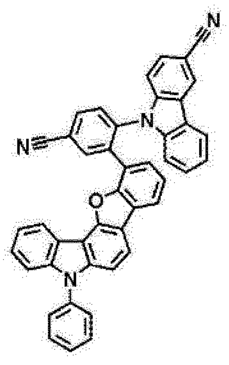
90

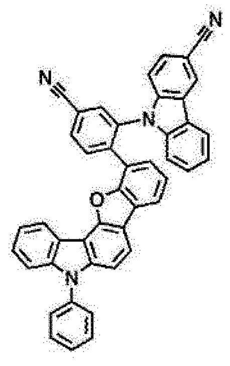
91

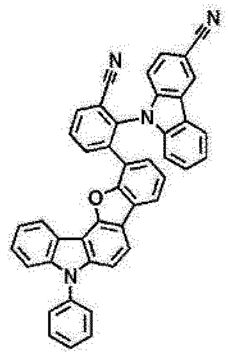
92

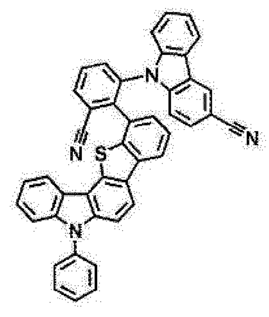
93

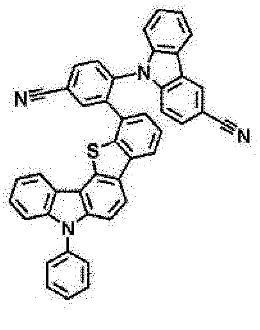
94

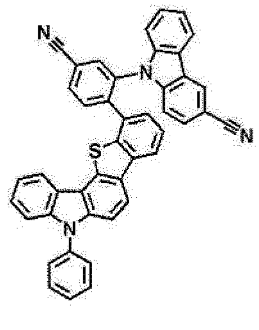
95

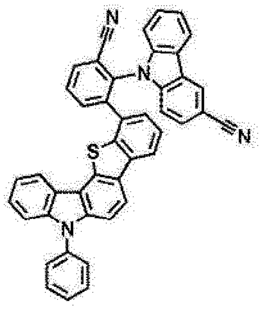
96

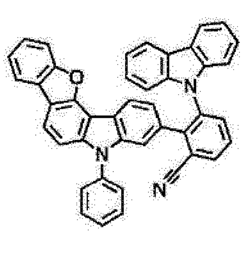
97

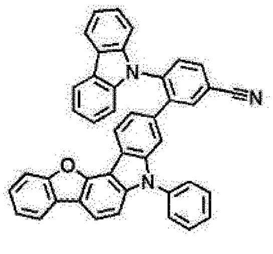
98

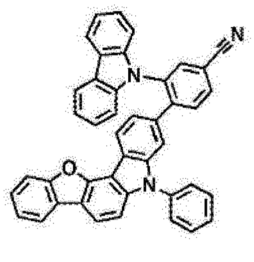
99

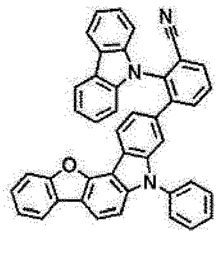
100

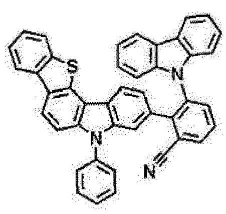
101

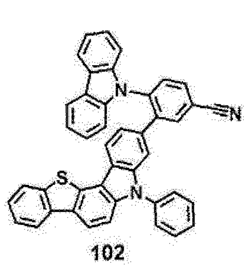
102

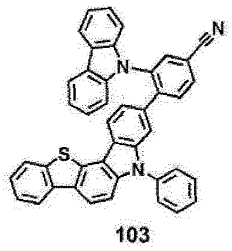
103

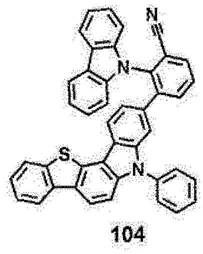
104

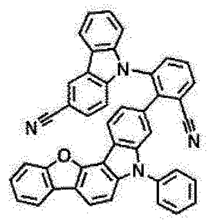
105

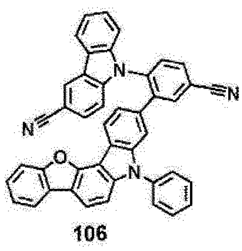
106

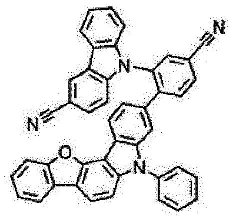
107

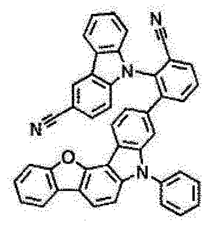
108

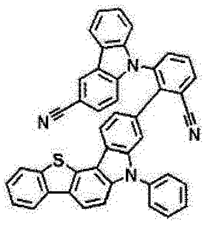
109

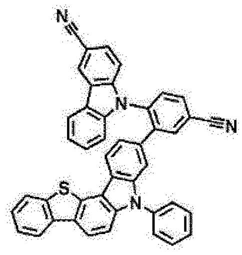
110

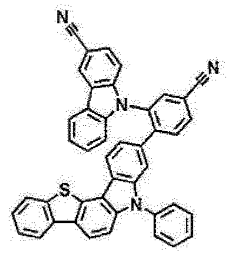
111

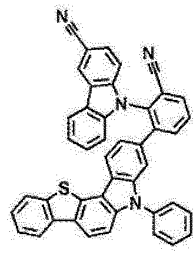
112

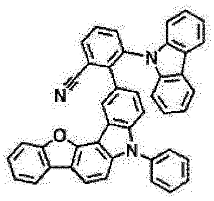
113

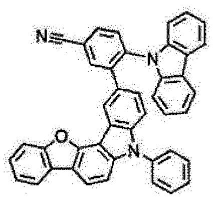
114

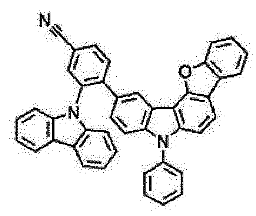
115

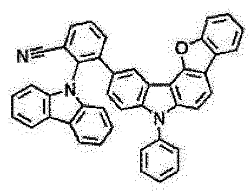
116

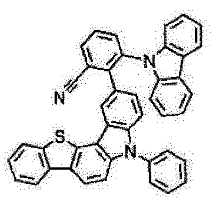
117

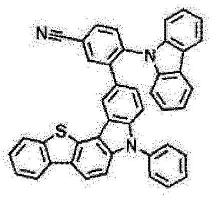
118

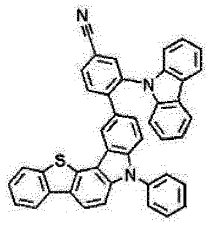
119

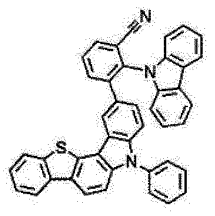
120

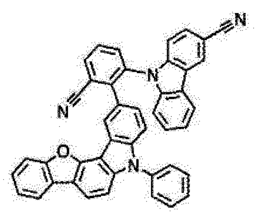
121

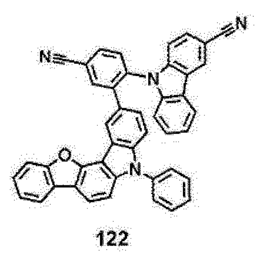
122

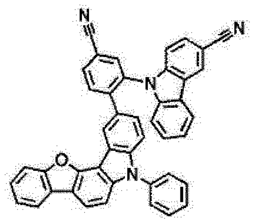
123

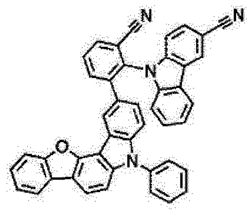
124

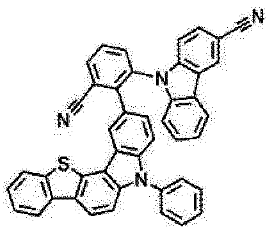
125

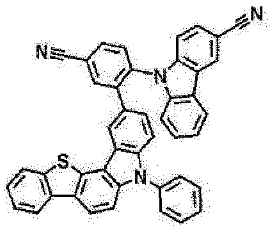
126

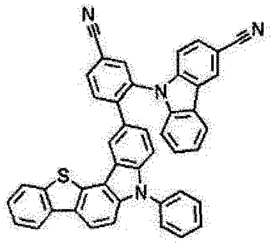
127

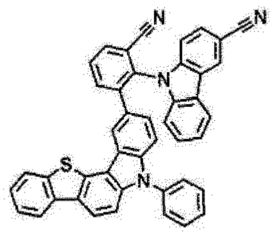
128

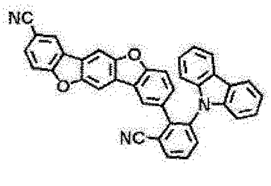
129

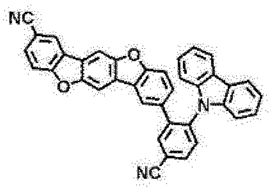
130

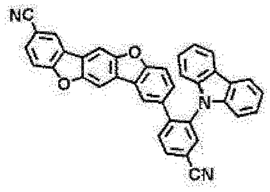
131

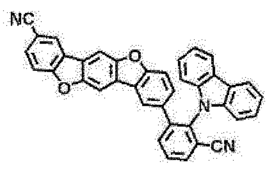
132

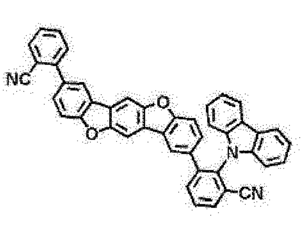
133

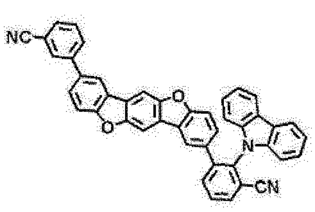
134

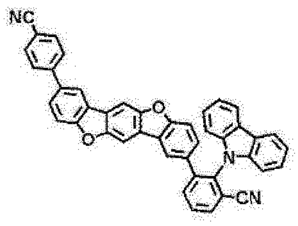
135

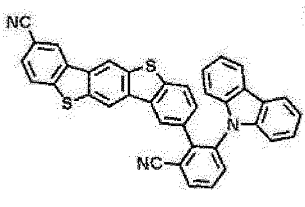
136

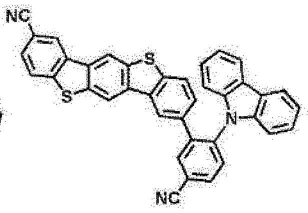
137

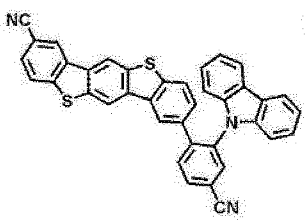
138

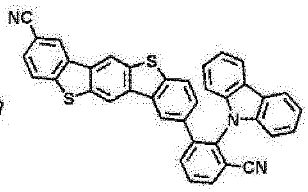
139

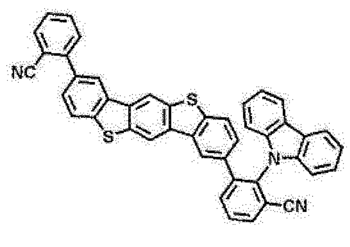
140

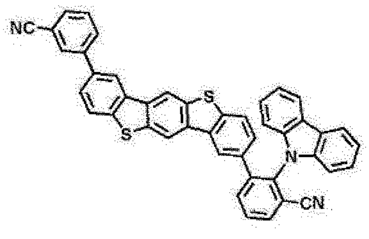
141

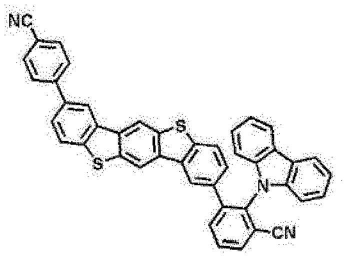
142

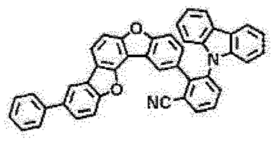
143

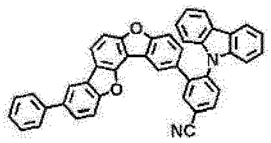
144

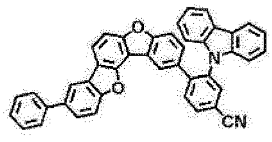
145

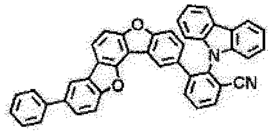
146

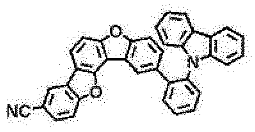
147

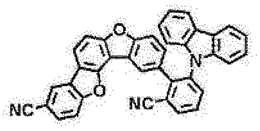
148

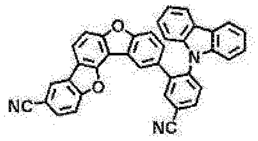
149

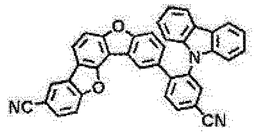
150

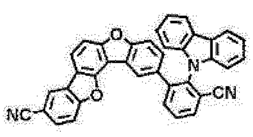
151

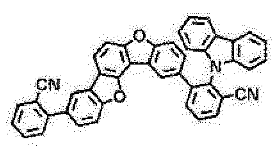
152

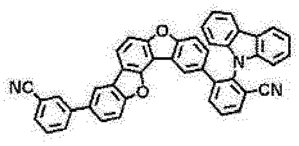
153

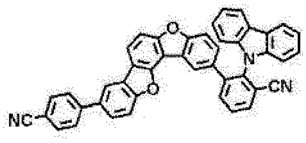
154

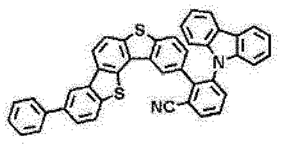
155

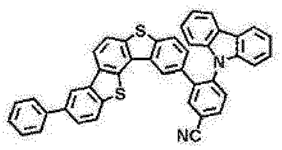
156

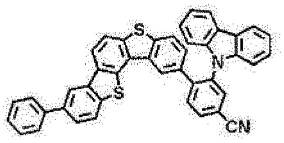
157

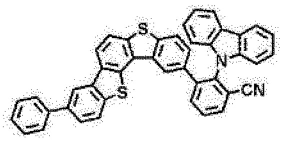
158

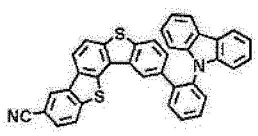
159

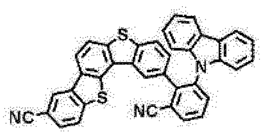
160

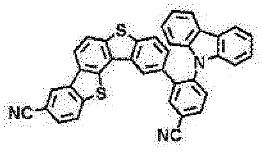
161

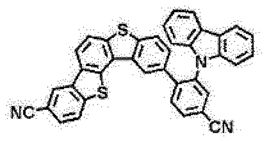
162

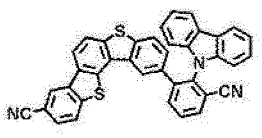
163

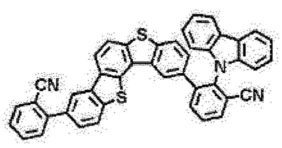
164

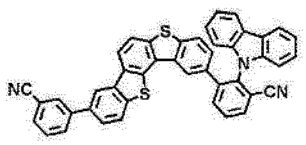
165

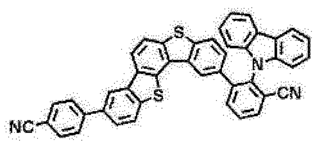
166

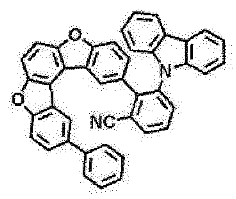
167

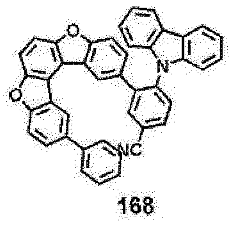
168

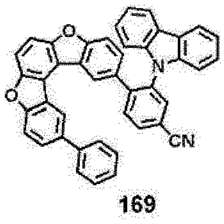
169

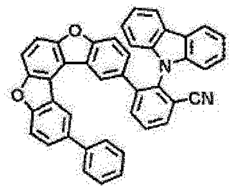
170

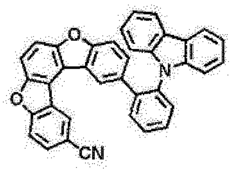
171

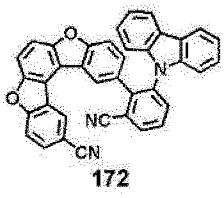
172

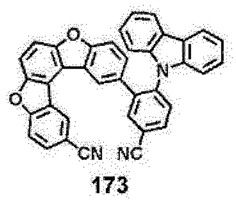
173

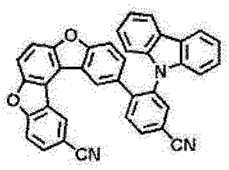
174

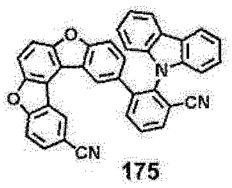
175

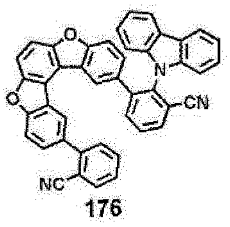
176

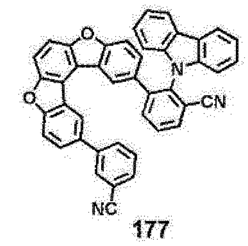
177

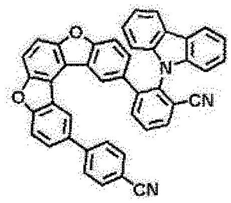
178

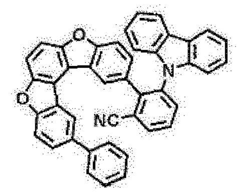
179

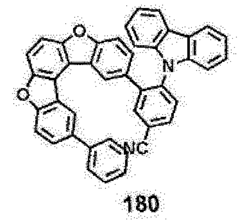
180

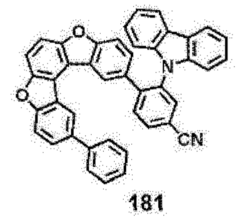
181

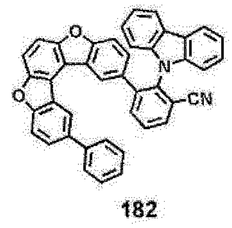
182

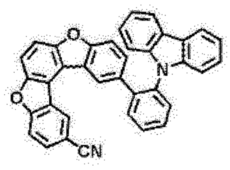
183

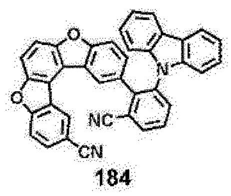
184

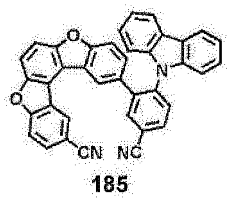
185

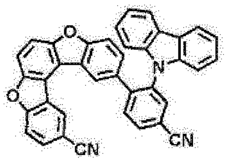
186

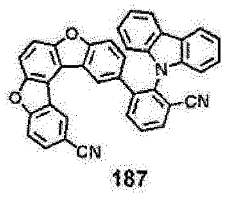
187

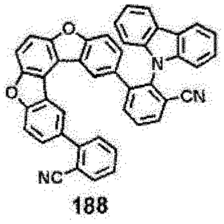
188

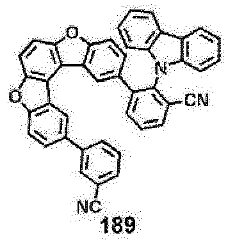
189

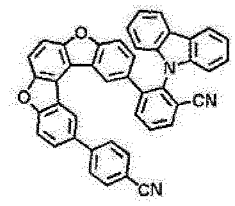
190

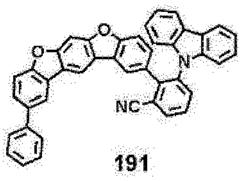
191

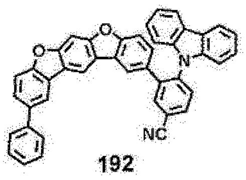
192

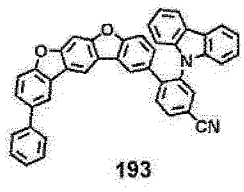
193

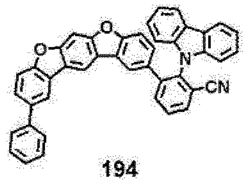
194

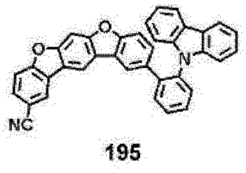
195

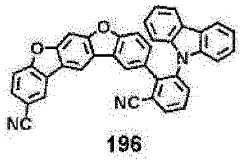
196

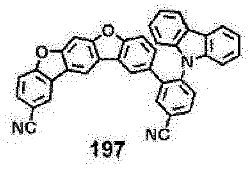
197

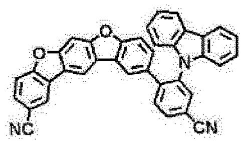
198

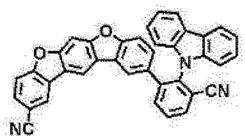
199

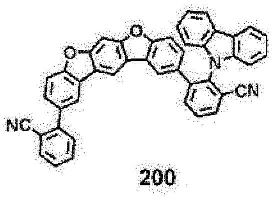
200

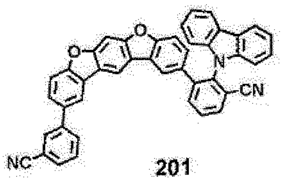
201

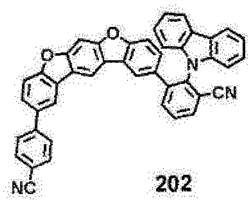
202

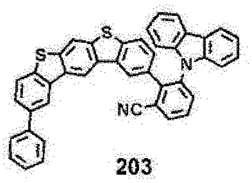
203

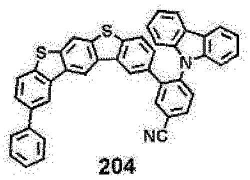
204

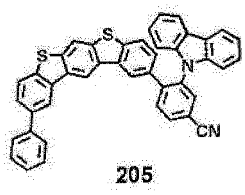
205

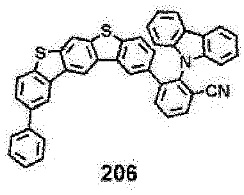
206

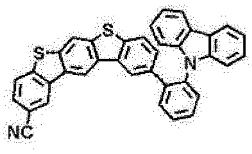
207

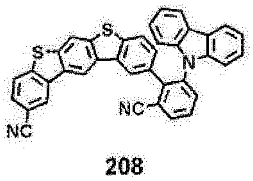
208

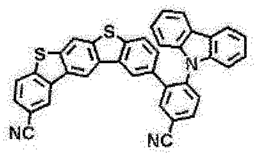
209

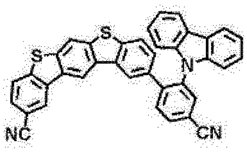
210

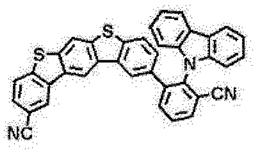
211

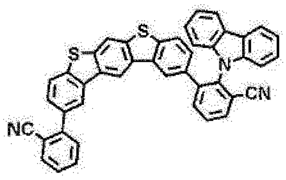
212

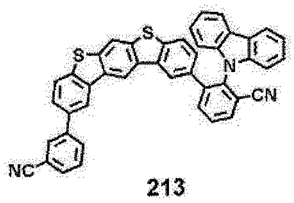
213

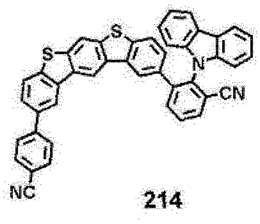
214

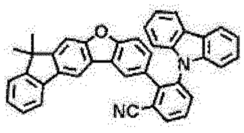
215

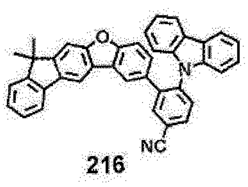
216

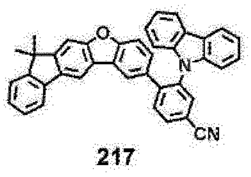
217

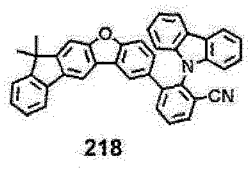
218

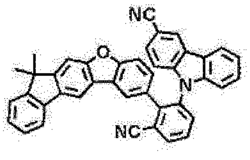
219

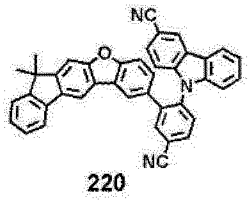
220

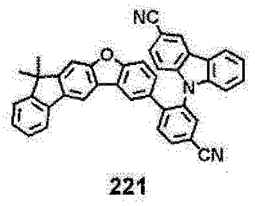
221

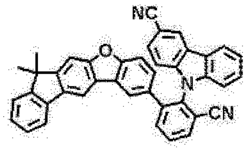
222

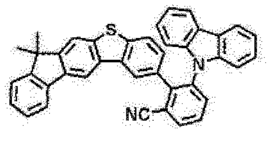
223

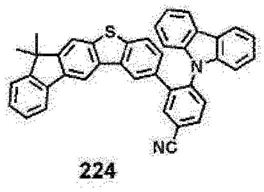
224

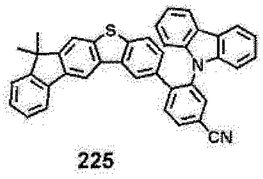
225

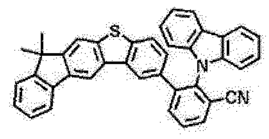
226

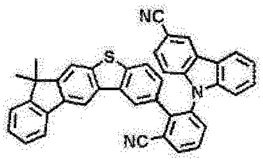
227

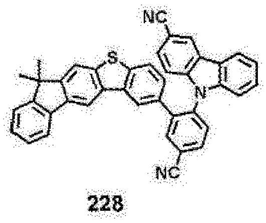
228

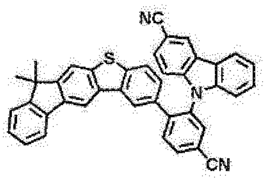
229

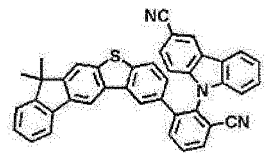
230

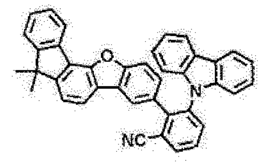
231

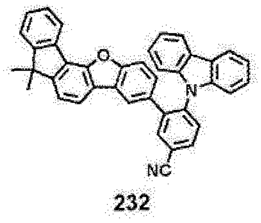
232

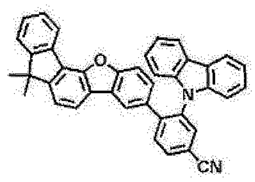
233

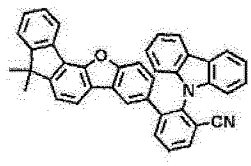
234

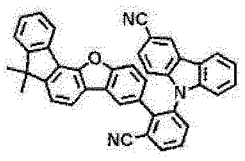
235

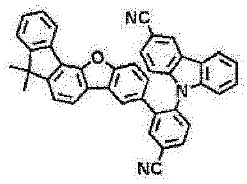
236

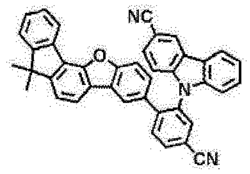
237

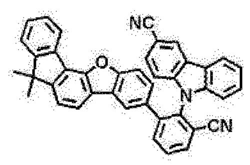
238

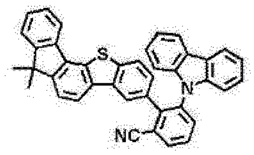
239

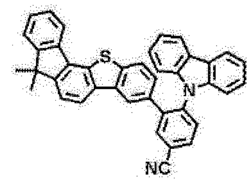
240

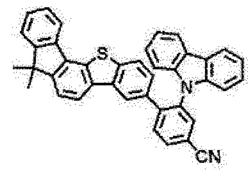
241

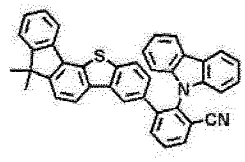
242

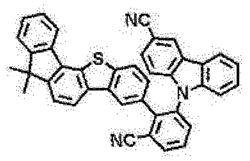
243

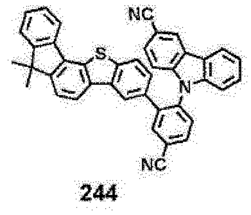
244

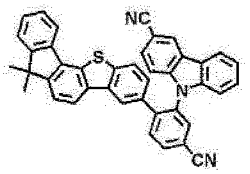
245

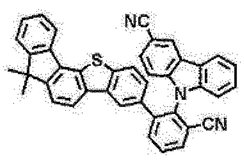
246

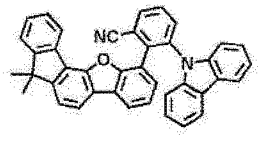
247

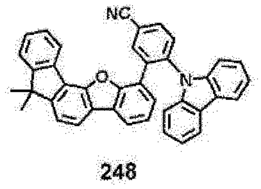
248

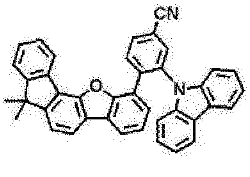
249

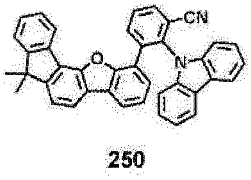
250

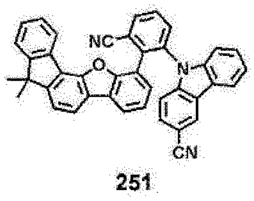
251

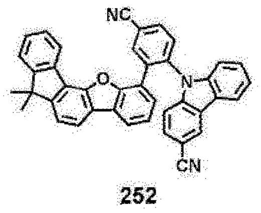
252

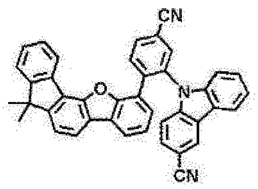
253

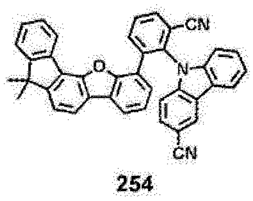
254

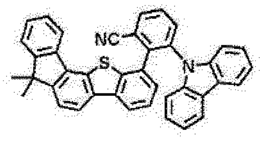
255

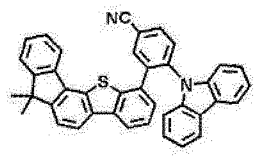
256

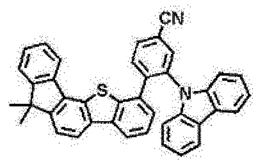
257

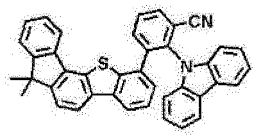
258

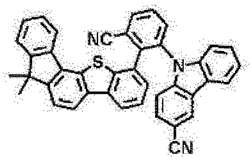
259

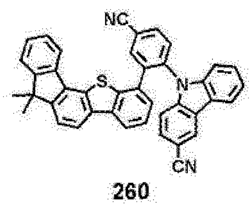
260

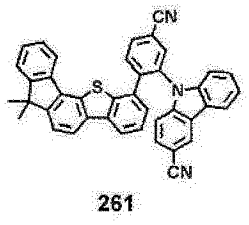
261

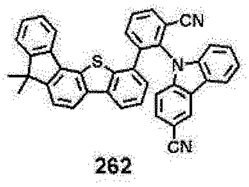
262

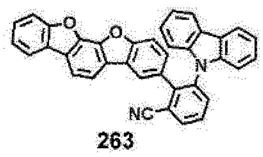
263

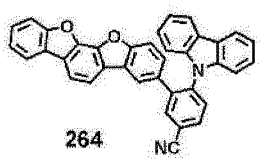
264

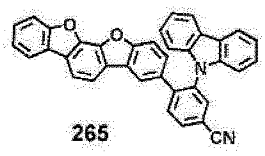
265

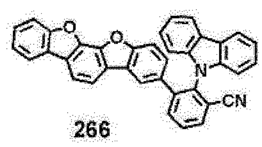
266

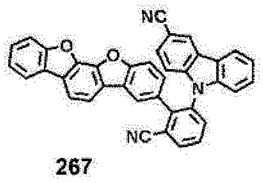
267

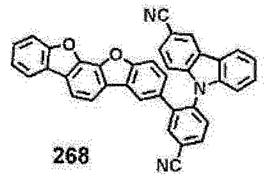
268

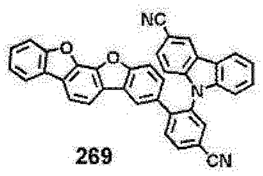
269

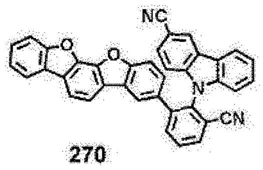
270

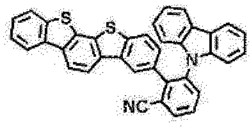
271

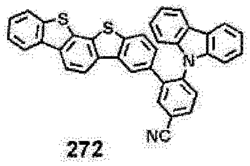
272

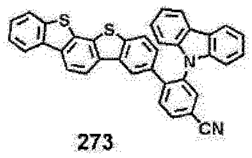
273

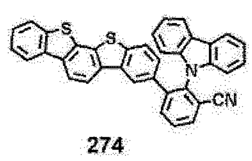
274

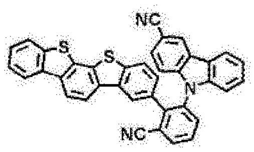
275

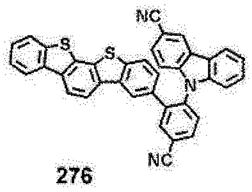
276

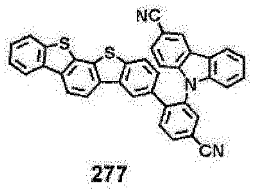
277

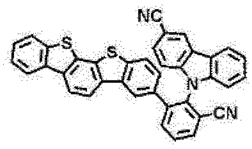
278

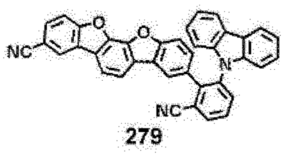
279

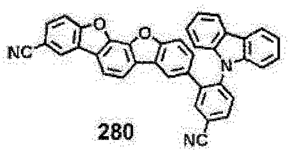
280

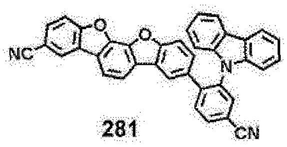
281

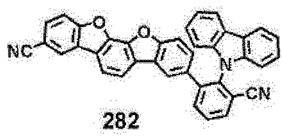
282

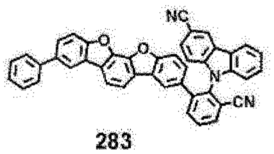
283

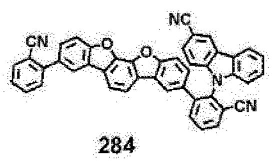
284

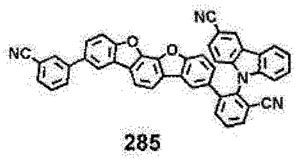
285

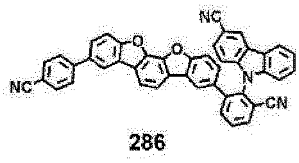
286

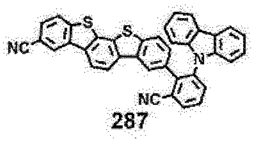
287

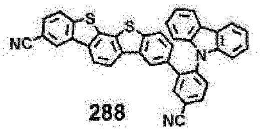
288

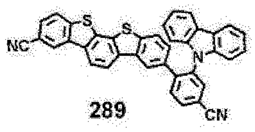
289

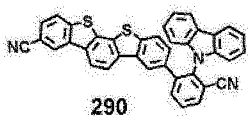
290

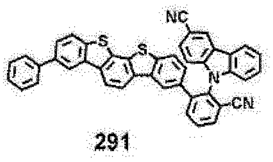
291

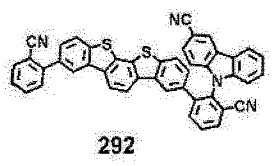
292

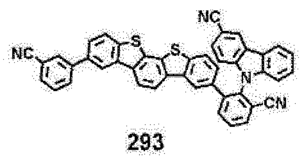
293

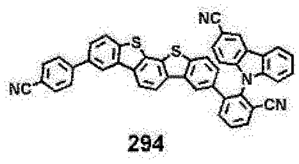
294

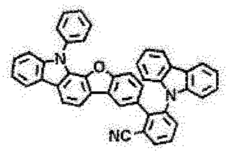
295

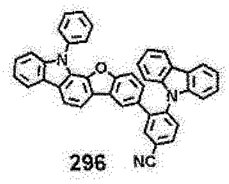
296

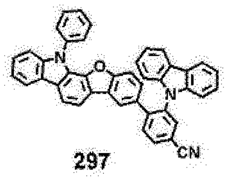
297

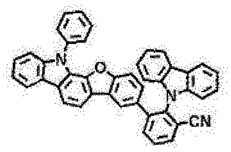
298

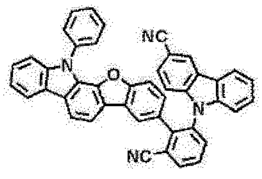
299

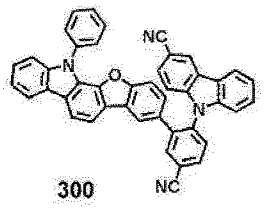
300

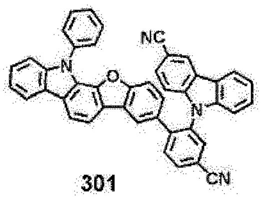
301

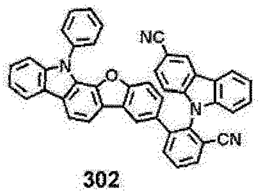
302

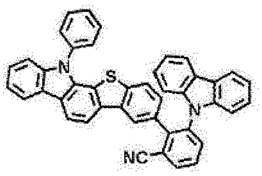
303

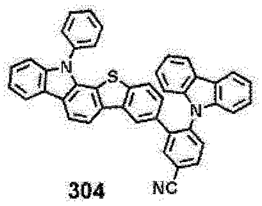
304

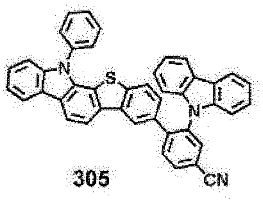
305

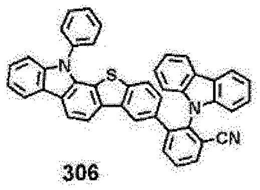
306

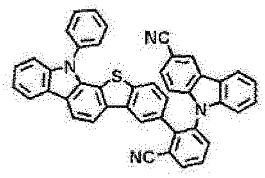
307

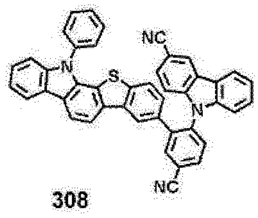
308

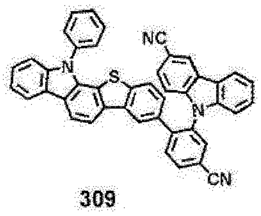
309

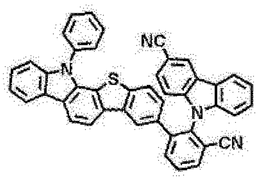
310

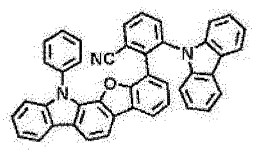
311

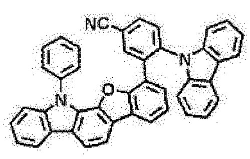
312

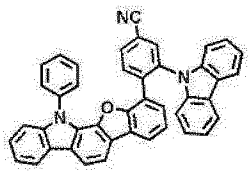
313

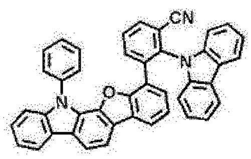
314

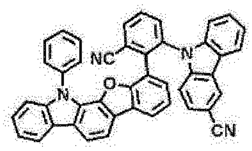
315

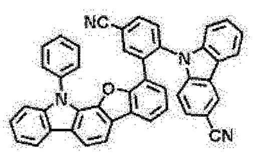
316

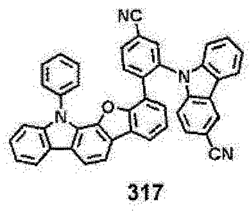
317

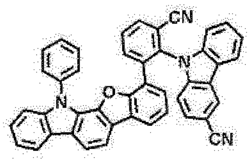
318

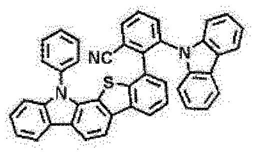
319

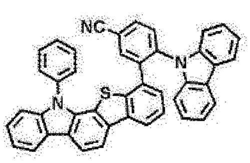
320

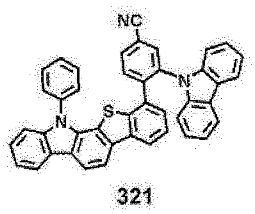
321

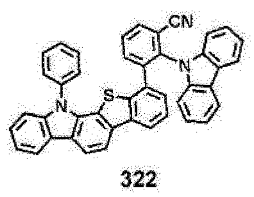
322

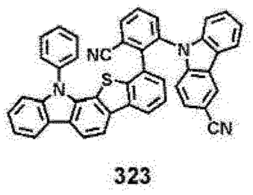
323

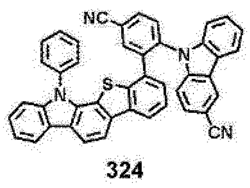
324

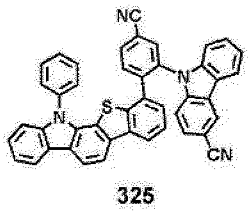
325

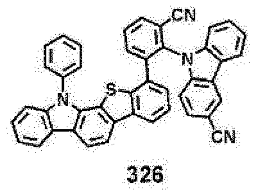
326

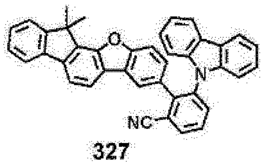
327

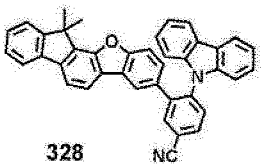
328

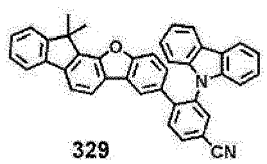
329

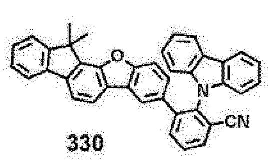
330

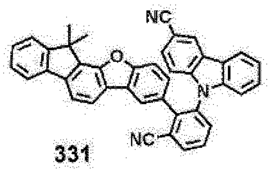
331

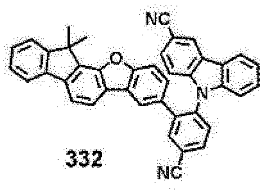
332

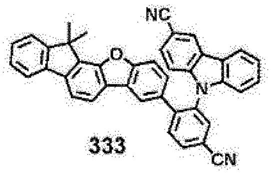
333

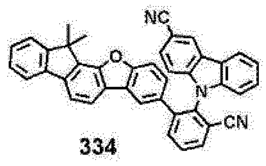
334

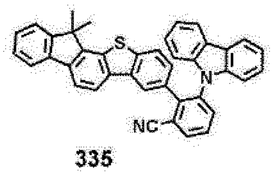
335

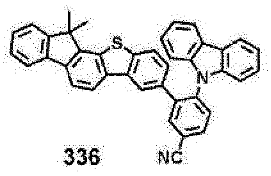
336

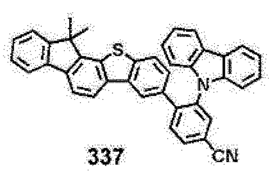
337

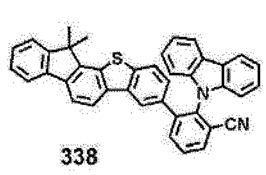
338

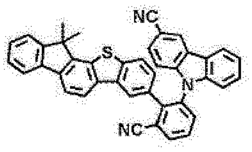
339

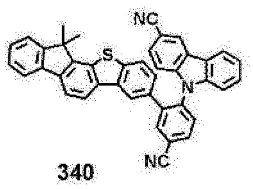
340

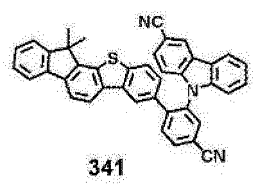
341

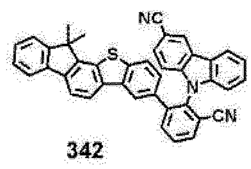
342

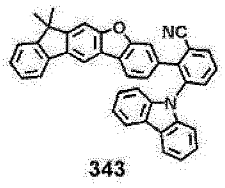
343

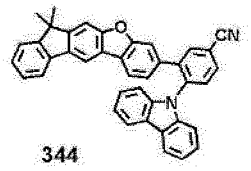
344

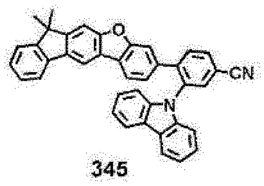
345

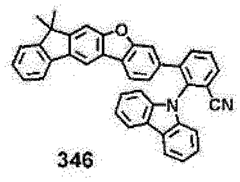
346

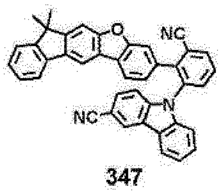
347

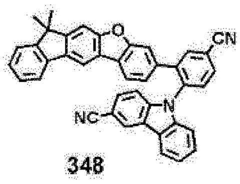
348

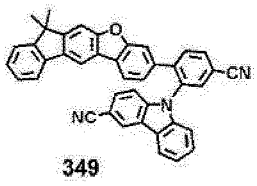
349

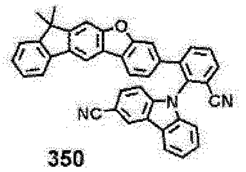
350

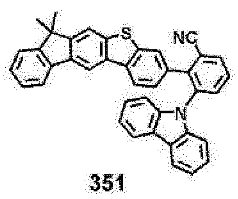

351

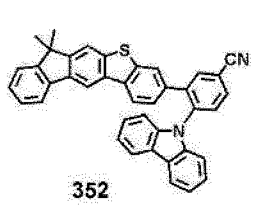

352

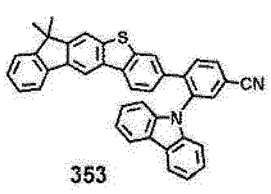

353

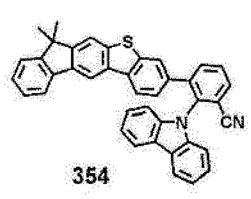

354

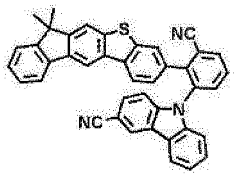

355

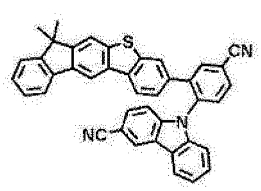

356

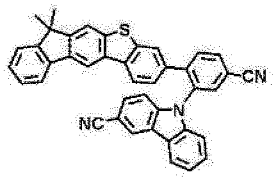

357

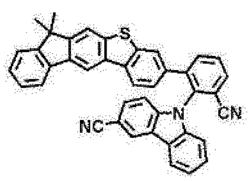

358

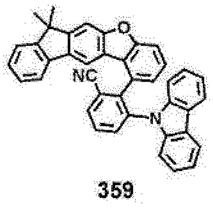

359

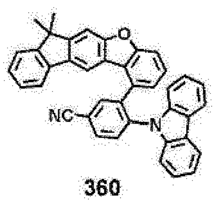

360

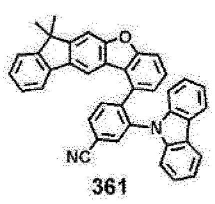

361

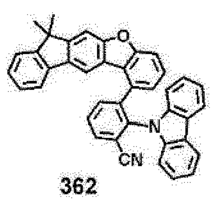

362

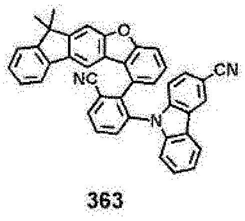

363

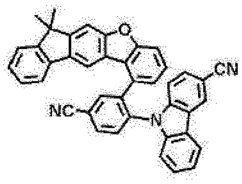

364

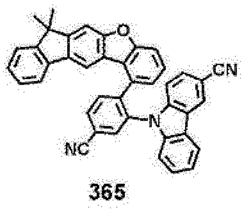

365

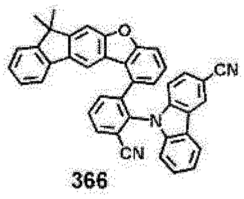

366

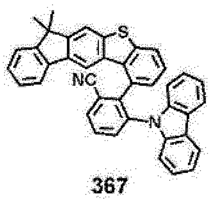

367

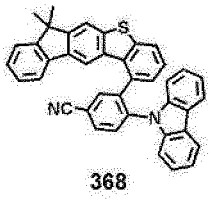

368

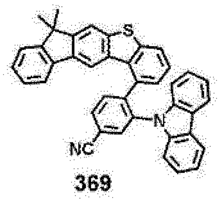

369

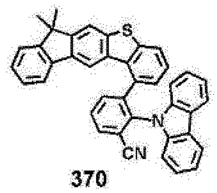

370

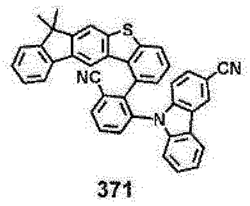

371

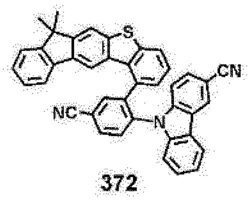

372

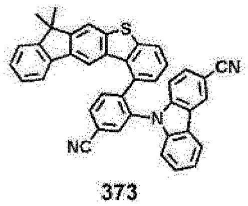

373

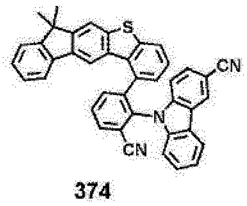

374

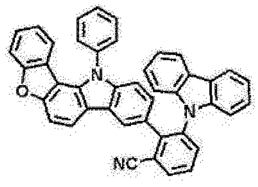
375

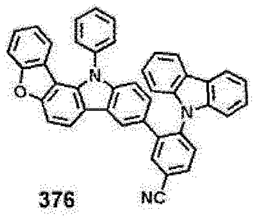
376

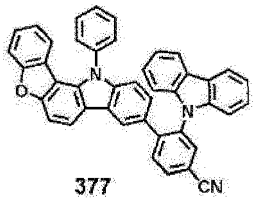
377

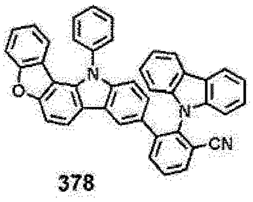
378

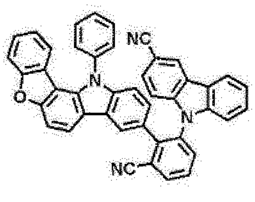
379

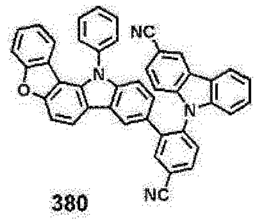
380

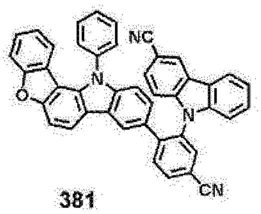
381

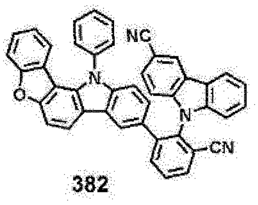
382

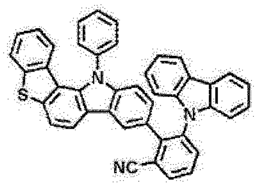
383

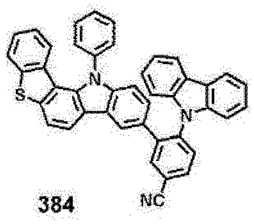
384

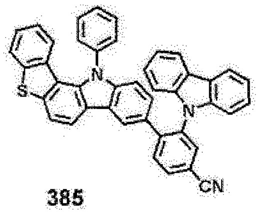
385

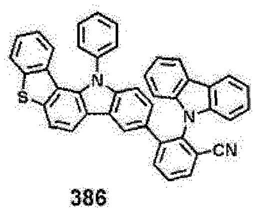
386

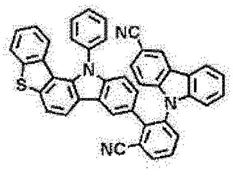
387

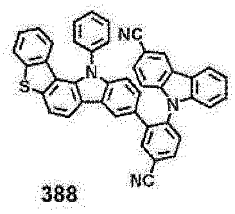
388

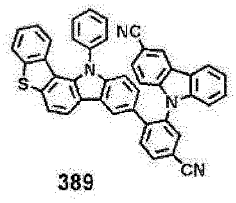
389

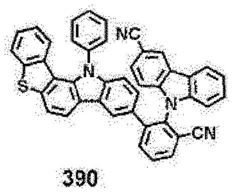
390

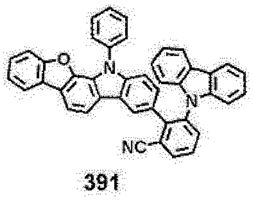
391

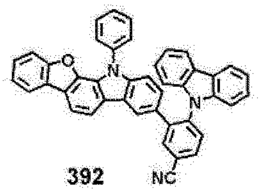
392

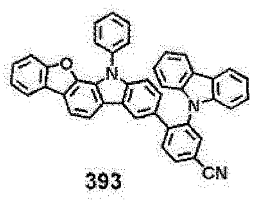
393

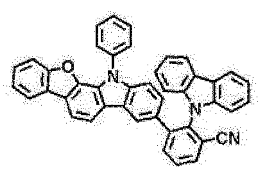
394

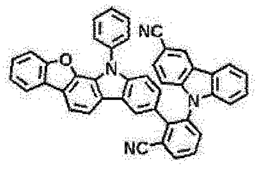
395

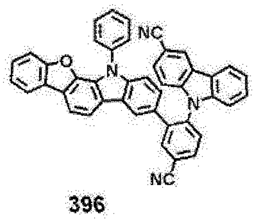
396

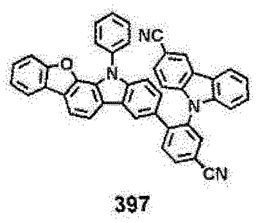
397

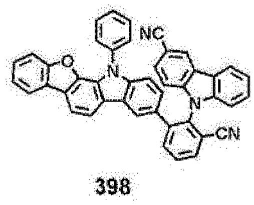
398

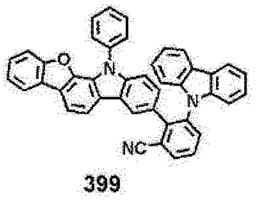

399

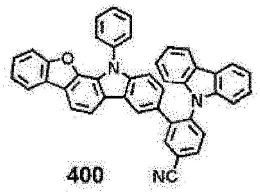

400

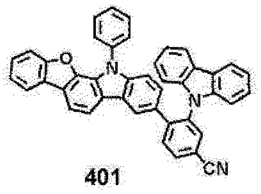

401

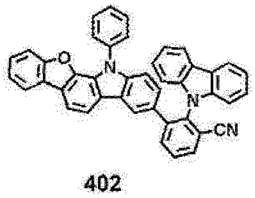

402

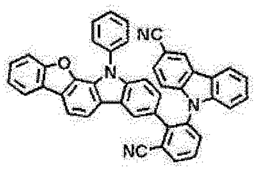

403

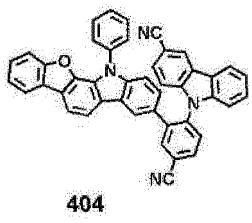

404

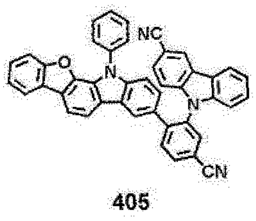

405

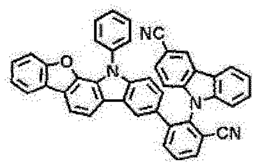

406

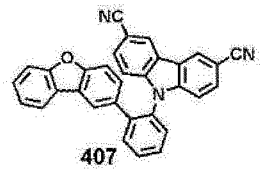

407

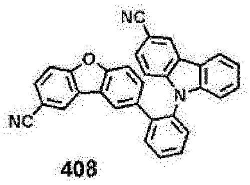

408

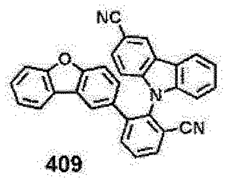

409

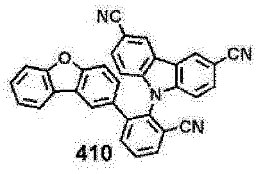

410

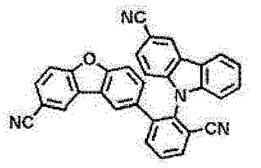

411

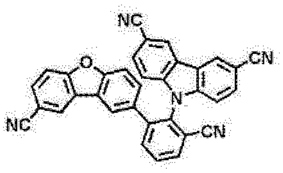

412

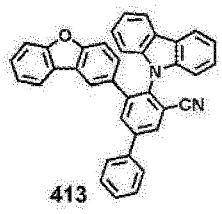

413

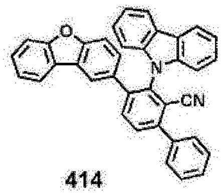

414

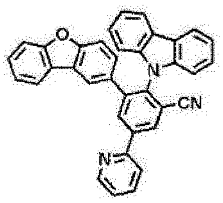

415

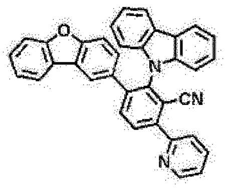

416

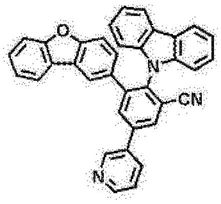

417

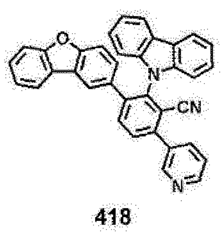

418

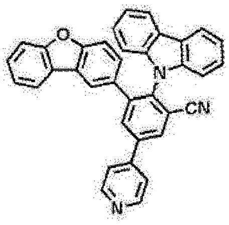

419

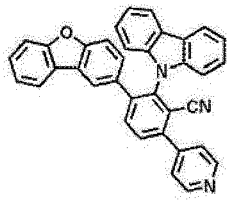

420

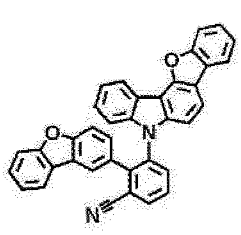

421

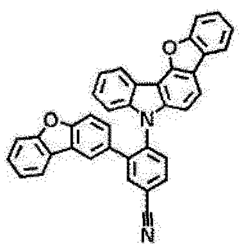

422

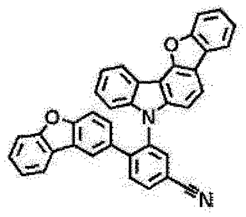

423

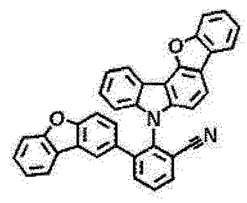

424

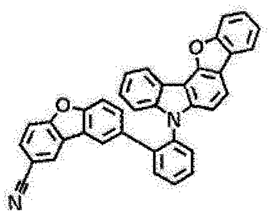

425

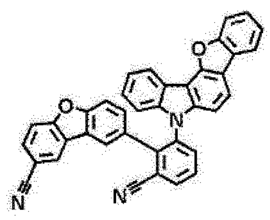

426

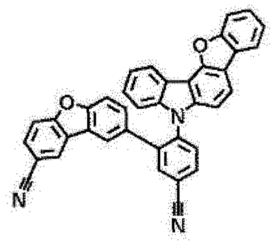

427

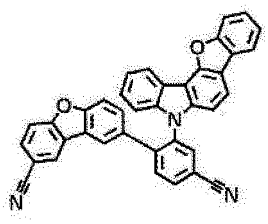

428

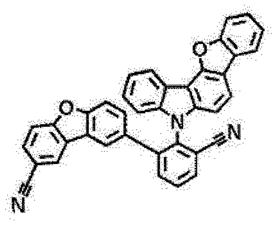

429

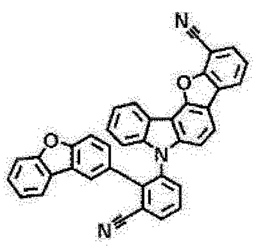

430

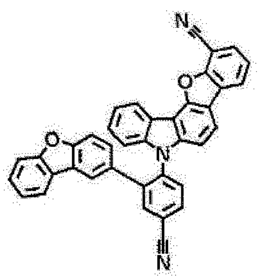

431

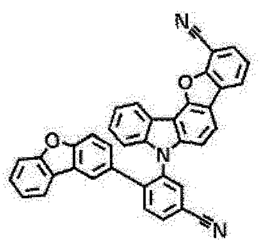

432

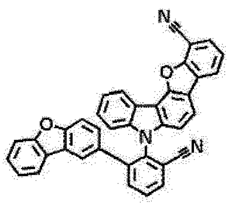
433

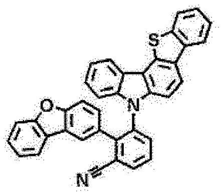
434

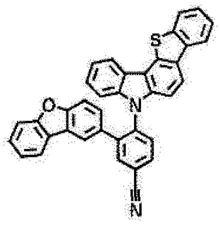
435

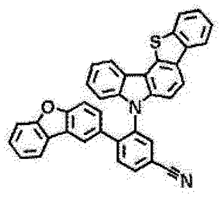
436

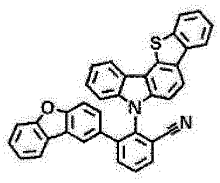
437

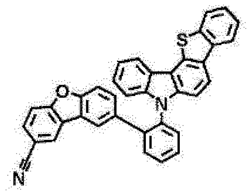
438

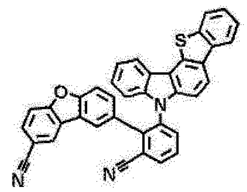
439

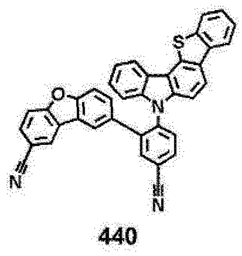
440

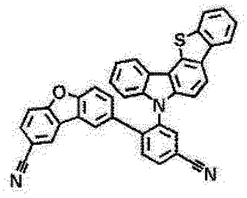
441

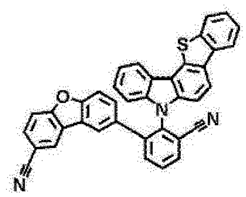
442

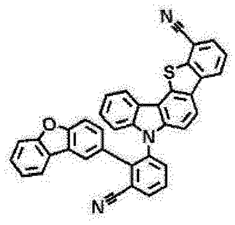
443

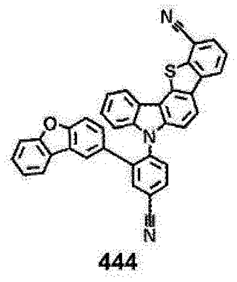
444

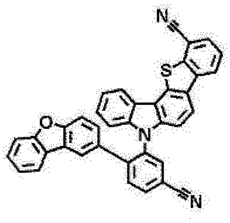
445

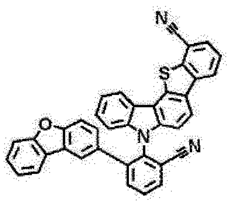
446

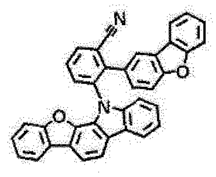
447

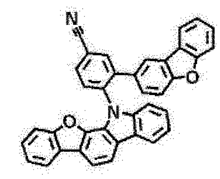
448

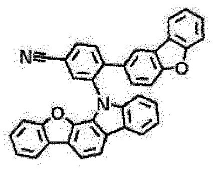
449

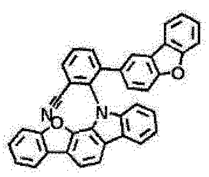
450

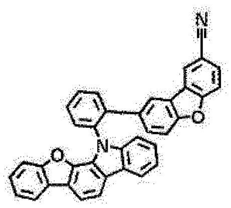
451

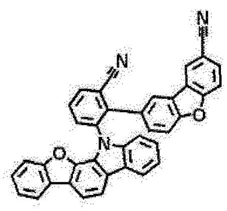
452

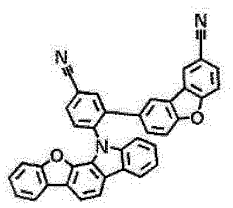
453

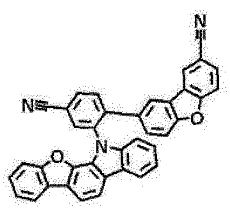
454

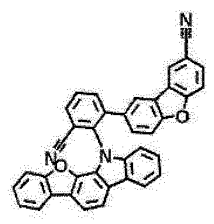
455

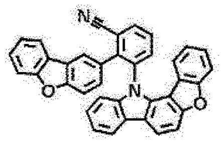
456

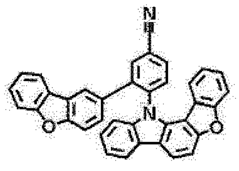
457

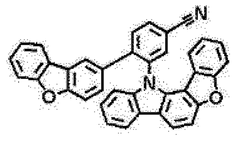
458

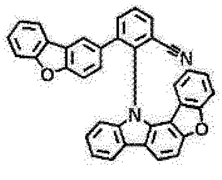
459

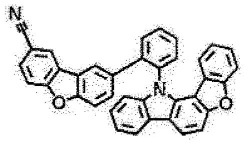
460

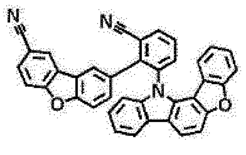
461

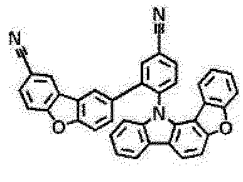
462

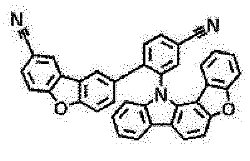
463

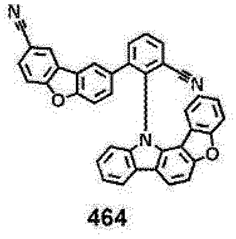
464

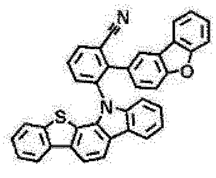
465

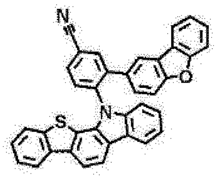
466

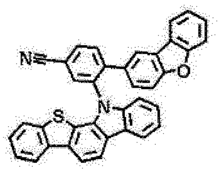
467

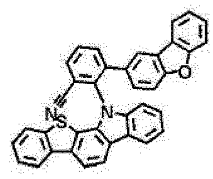
468

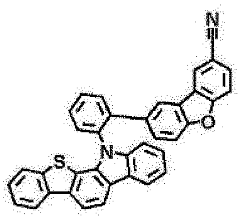
469

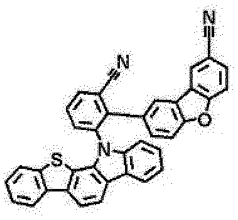
470

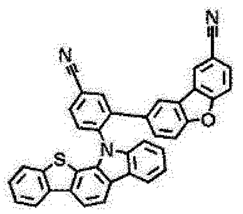
471

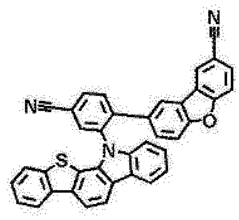
472

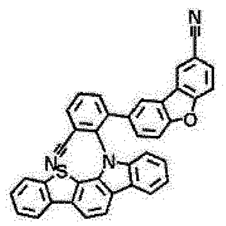
473

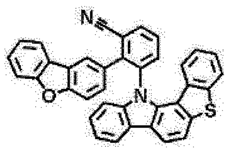
474

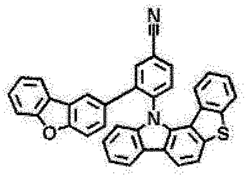
475

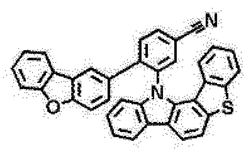
476

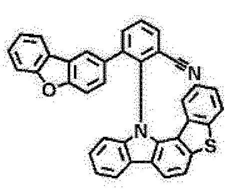
477

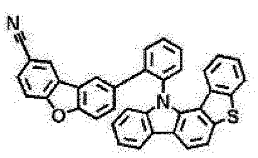
478

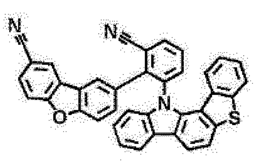
479

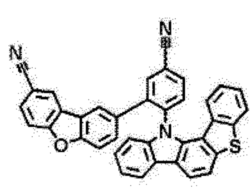
480

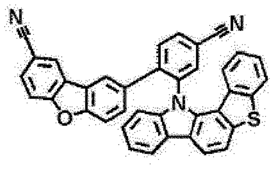

481

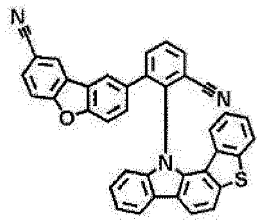

482

Group HE4

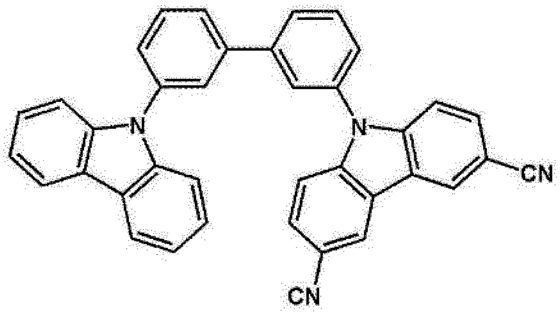

1

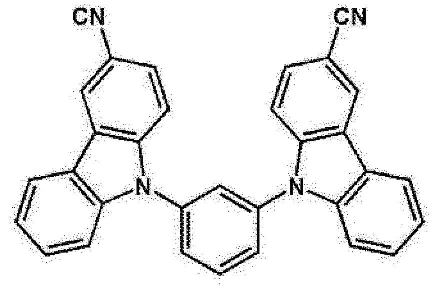

2

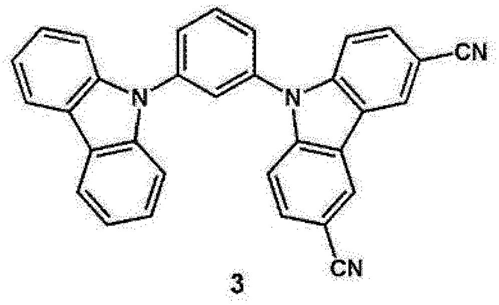

3

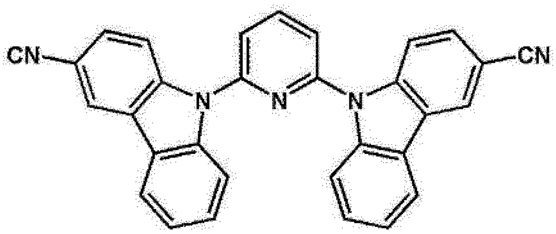

4

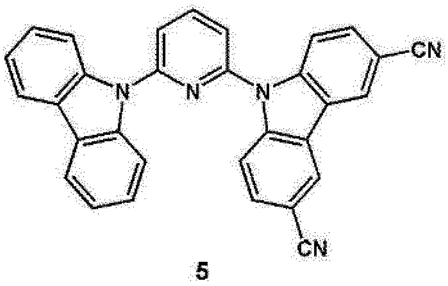

5

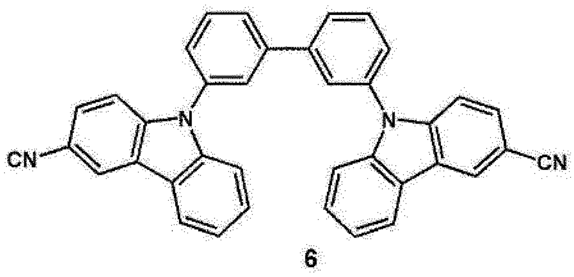

6

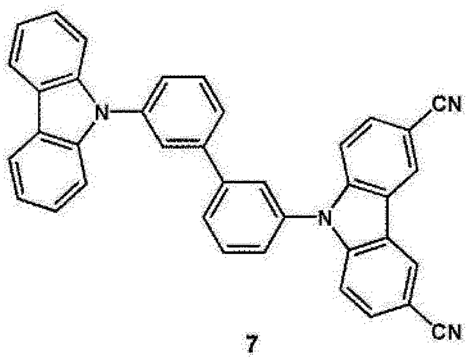

7

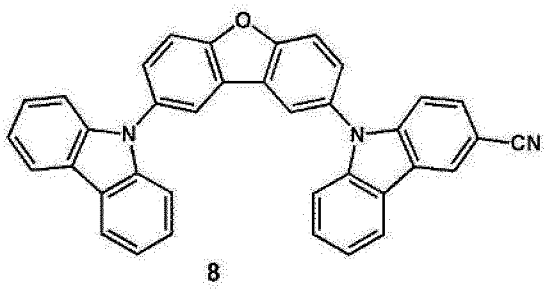

8

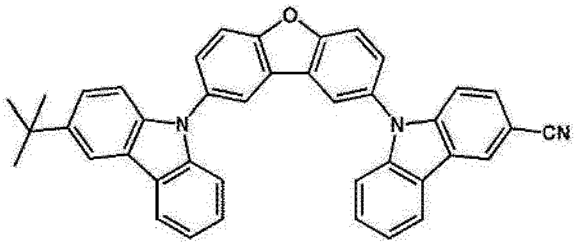

9

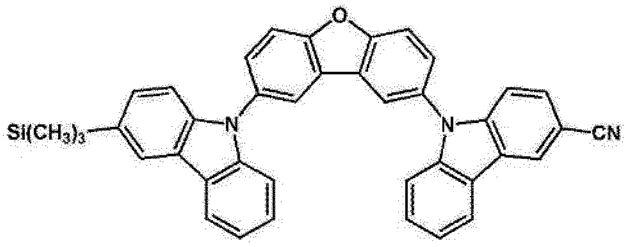

10

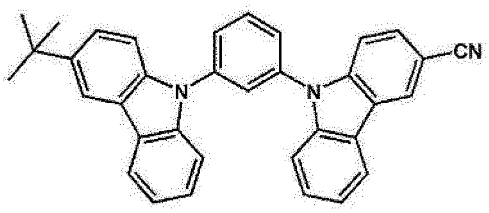

11

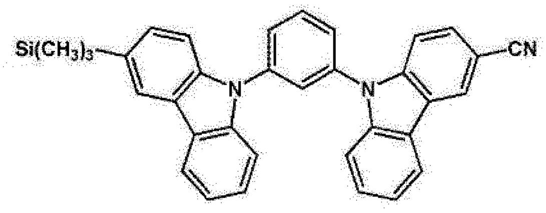

12

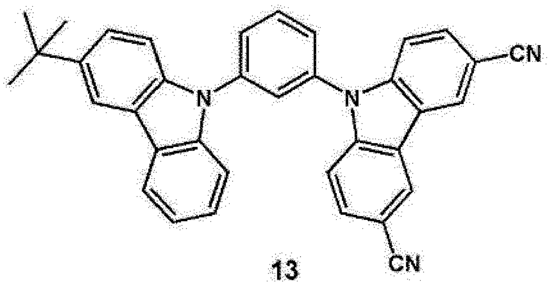

13

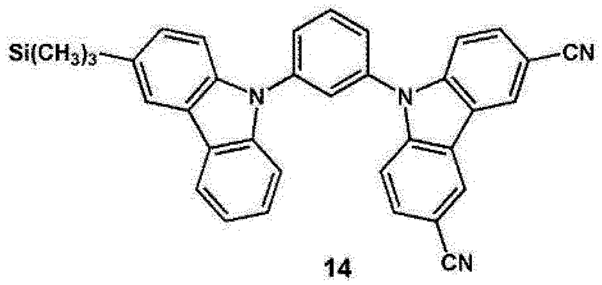

14

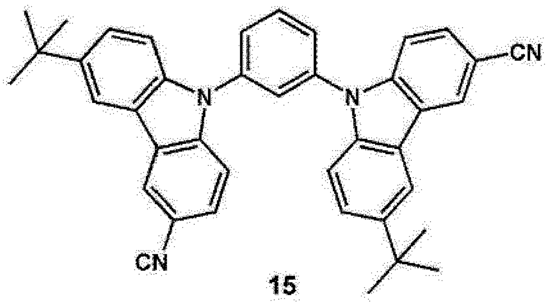

15

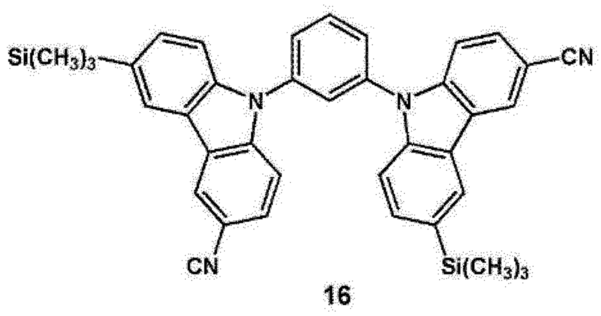

16

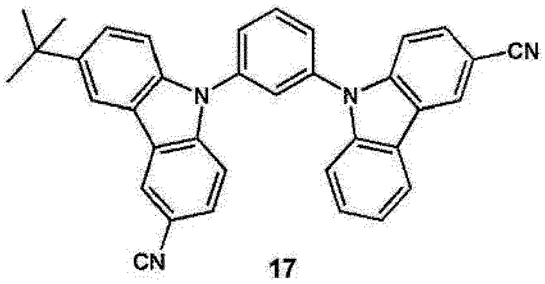

17

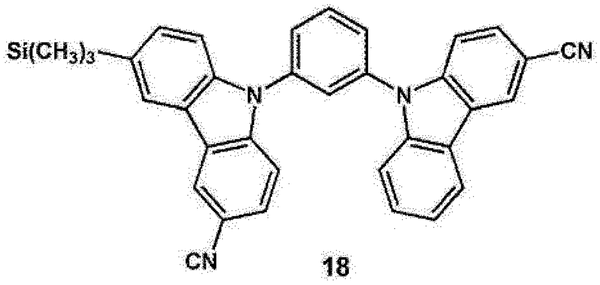

18

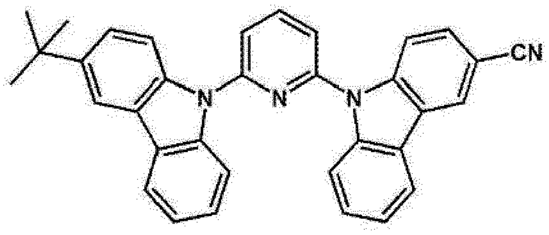

19

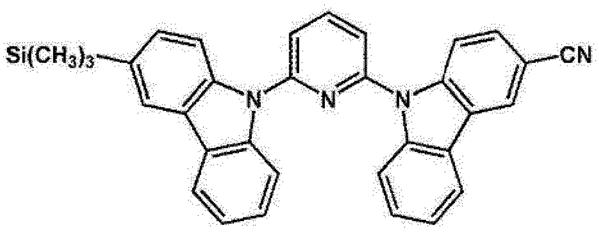

20

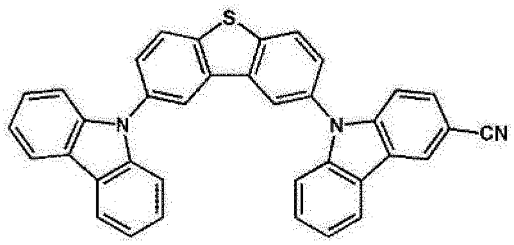

21

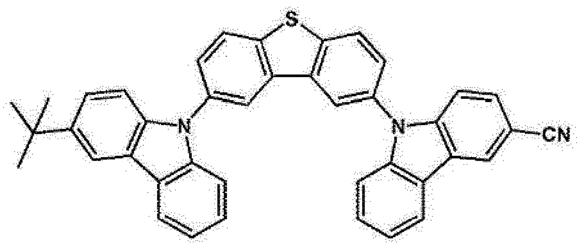

22

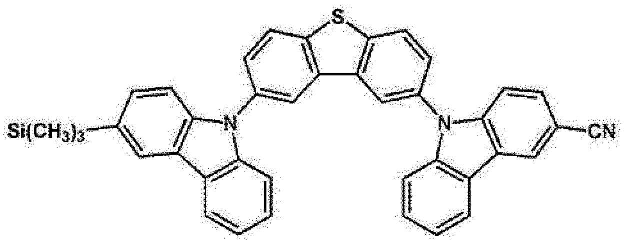

23

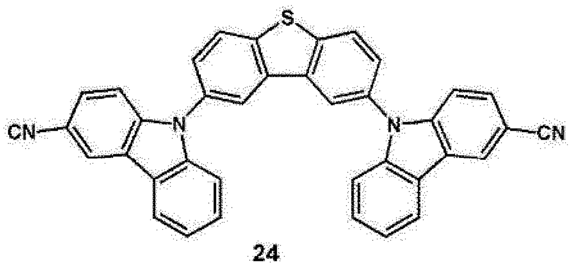

24

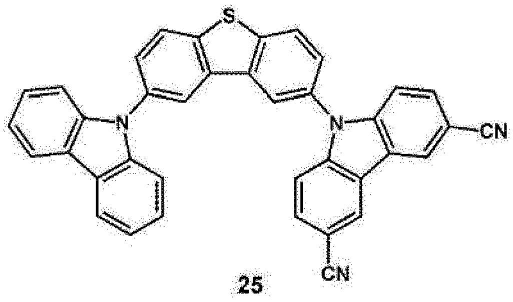

25

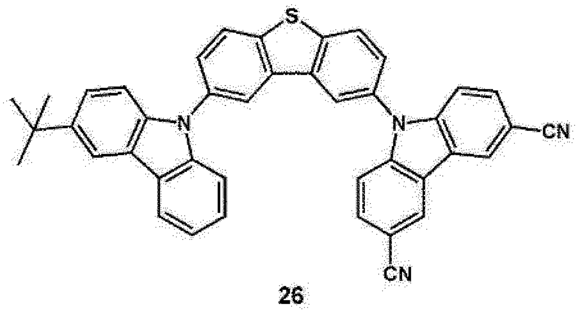

26

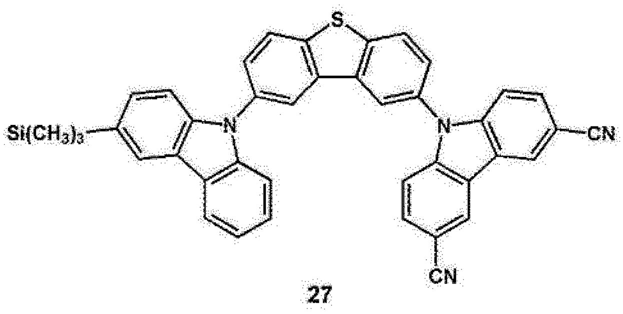

27

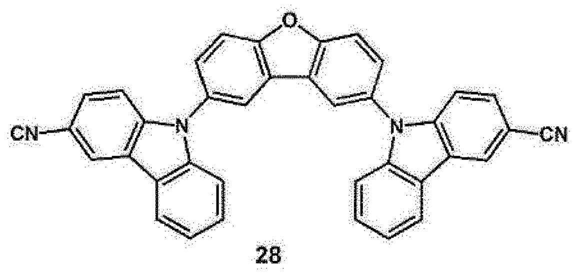

28

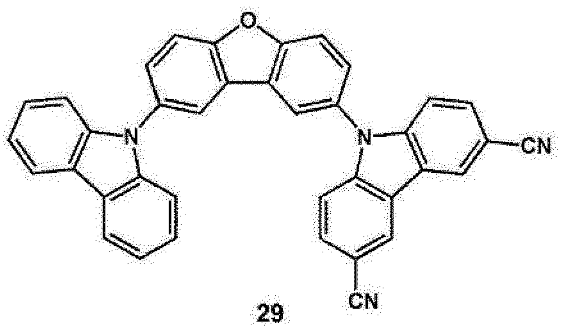

29

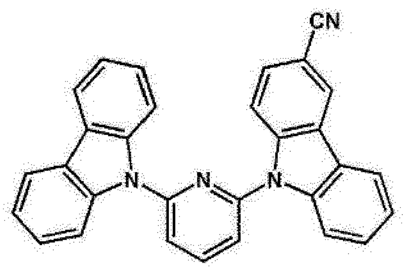

30

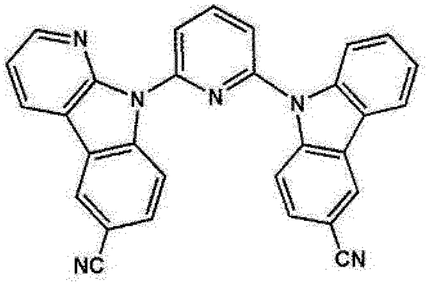

31

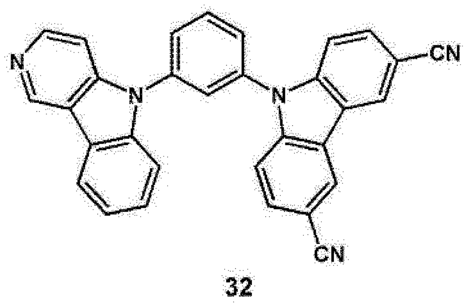

32

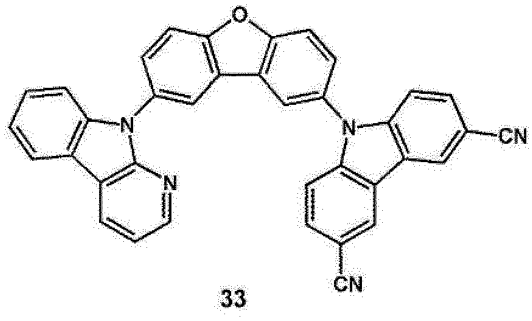

33

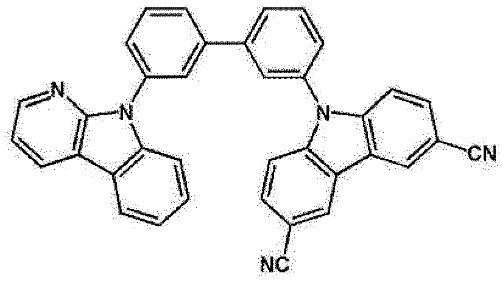

34

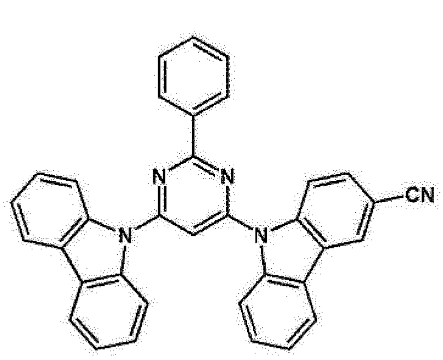

35

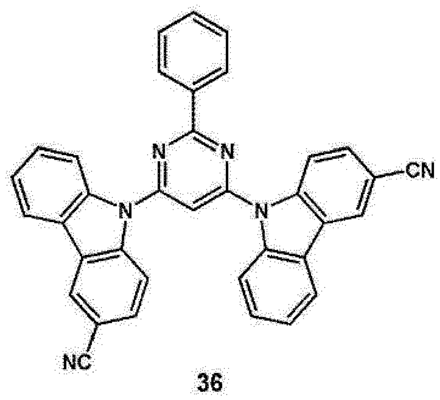

36

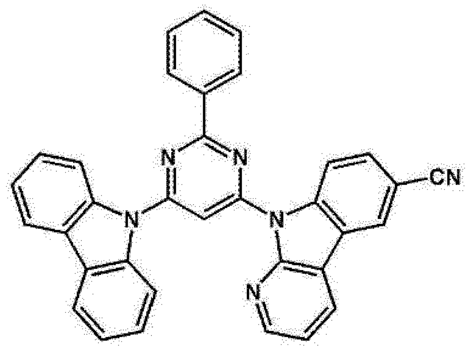

37

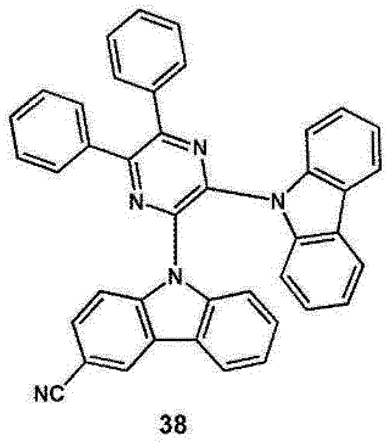

38

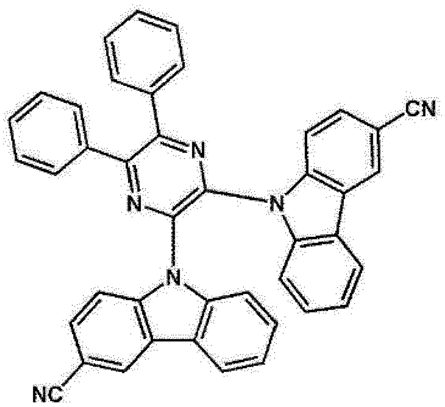

39

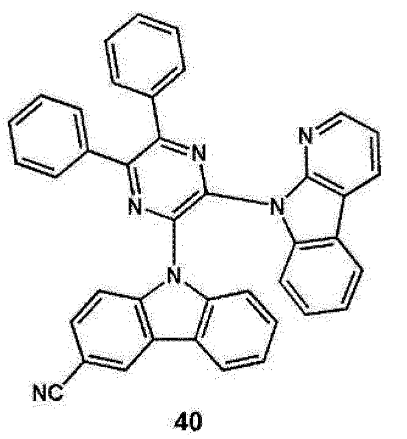

40

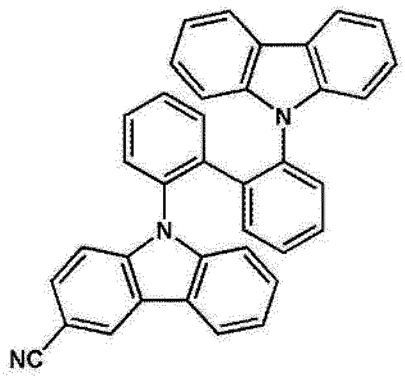

41

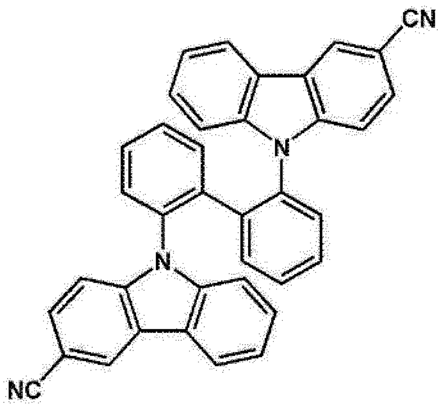

42

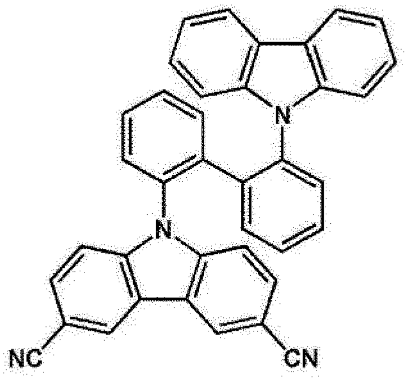

43

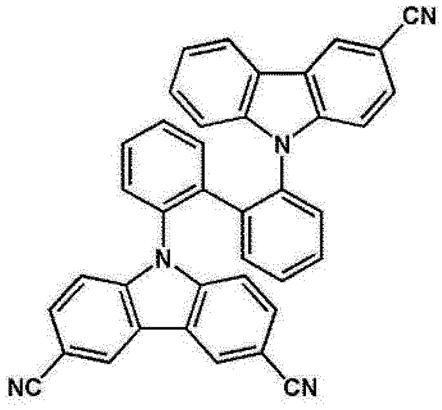

44

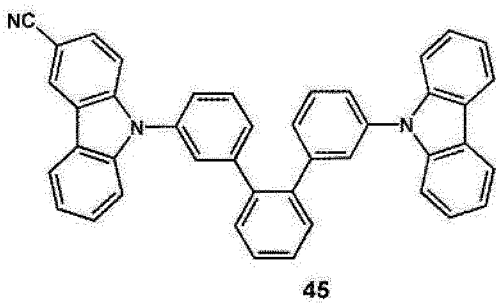

45

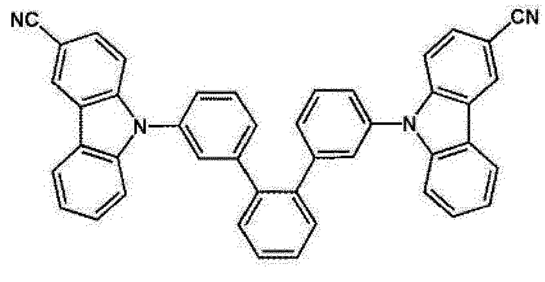

46

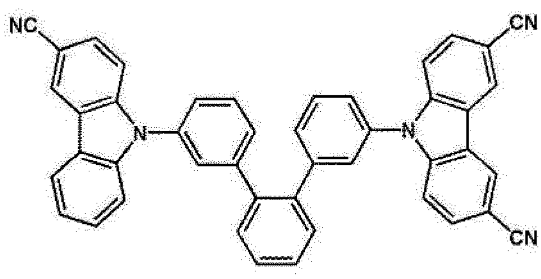

47

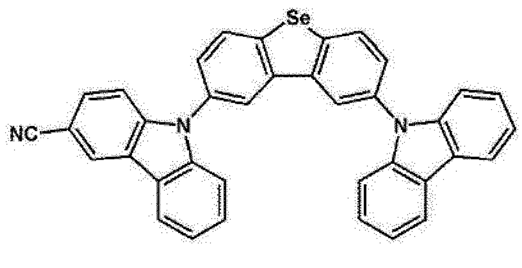

48

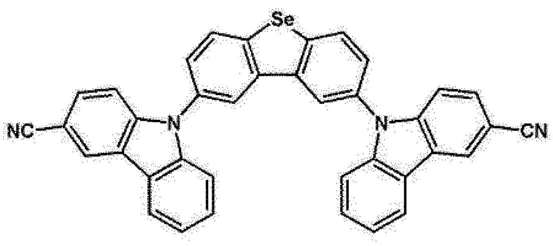

49

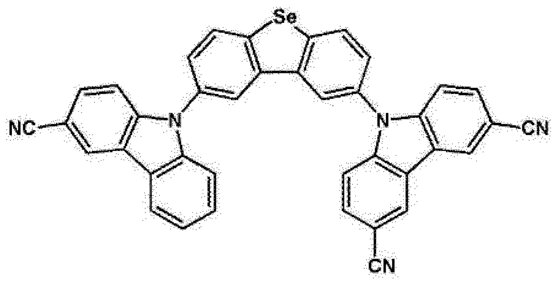

50

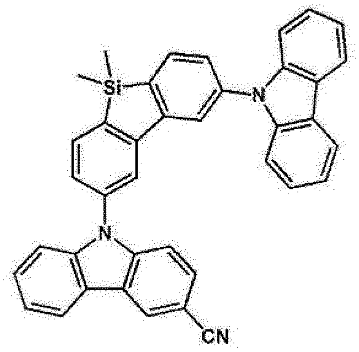

51

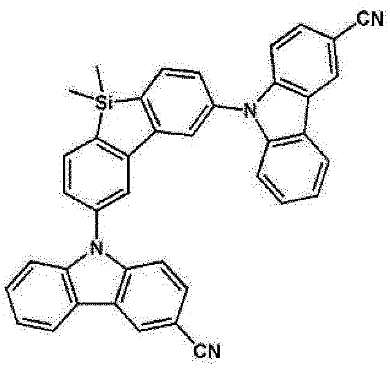

52

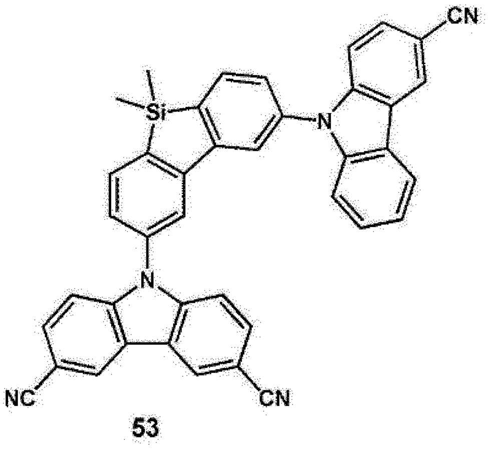

53

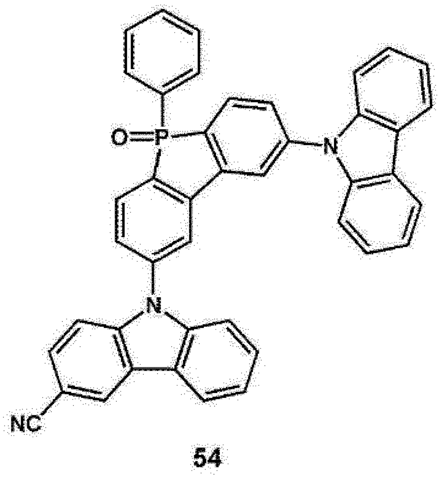

54

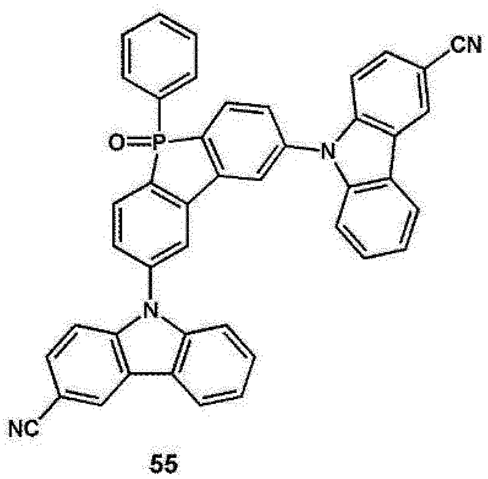

55

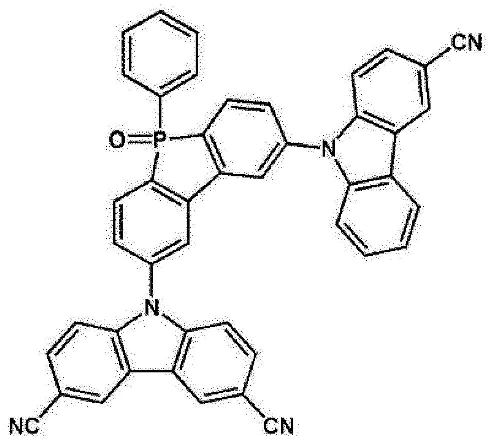

56

## Group HE5

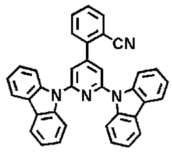
1
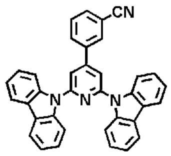
2
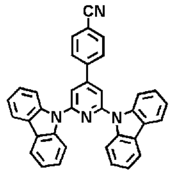
3
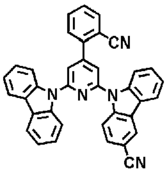
4
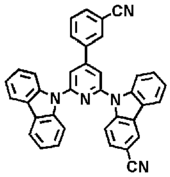
5
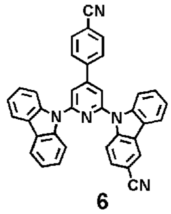
6

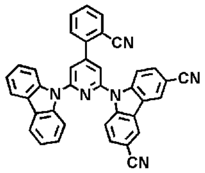
7
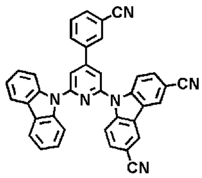
8
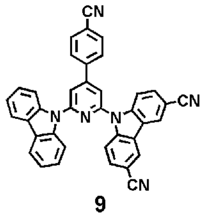
9
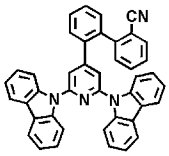
10
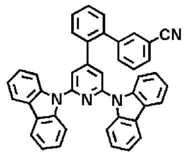
11
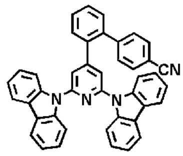
12

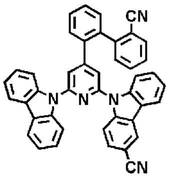
13
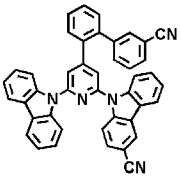
14
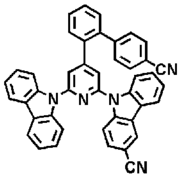
15
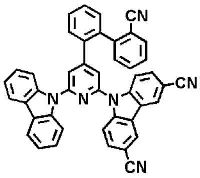
16
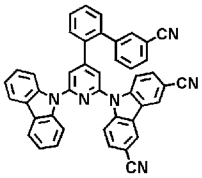
17
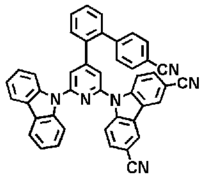
18

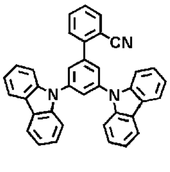
19
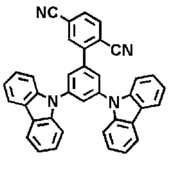
20
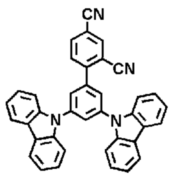
21
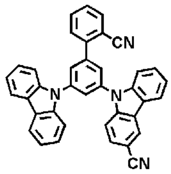
22
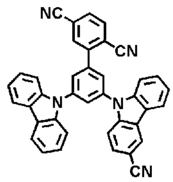
23
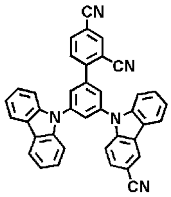
24

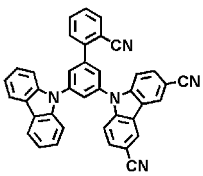
25
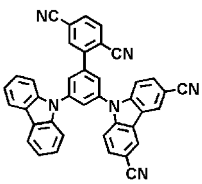
26
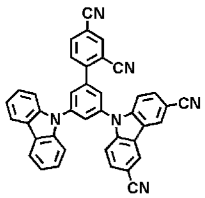
27
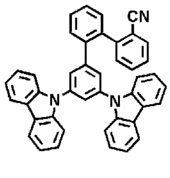
28
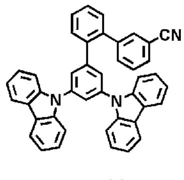
29
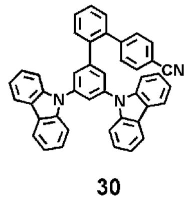
30

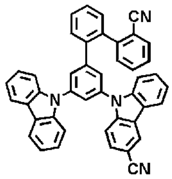
31
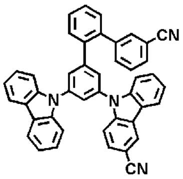
32
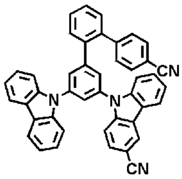
33
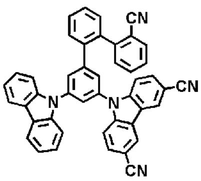
34
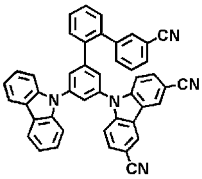
35
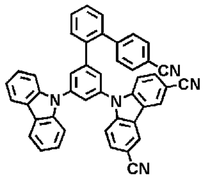
36

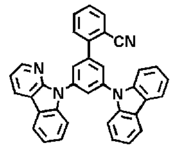
37

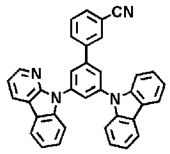
38

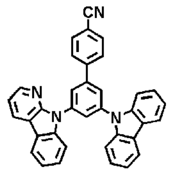
39

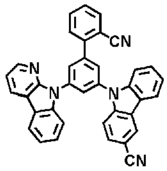
40

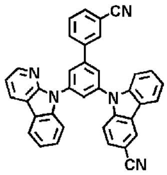
41

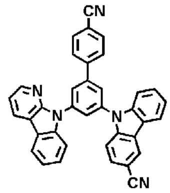
42

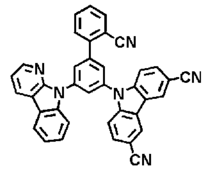
43

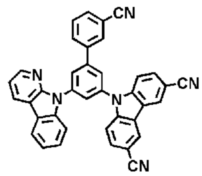
44

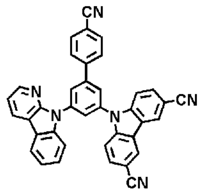
45

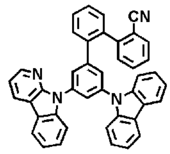
46

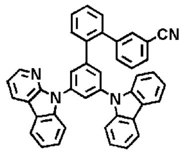
47

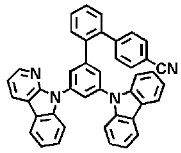
48

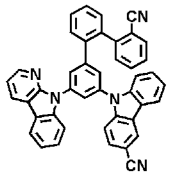
49

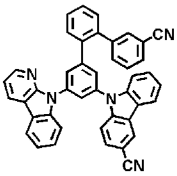
50

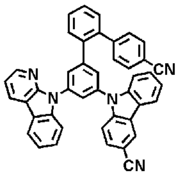
51

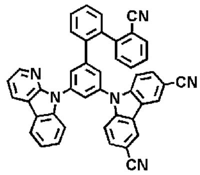
52

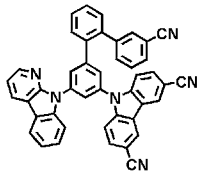
53

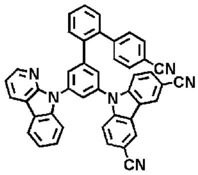
54

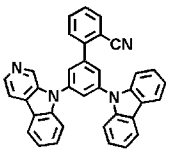
55

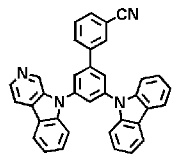
56

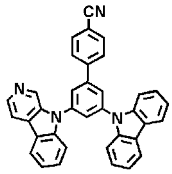
57

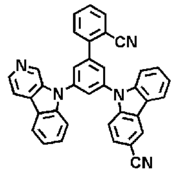
58

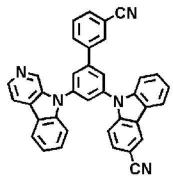
59

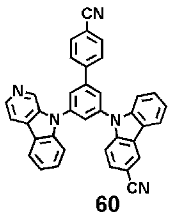
60

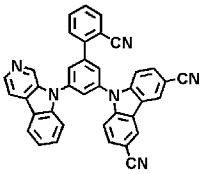
61

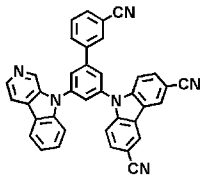
62

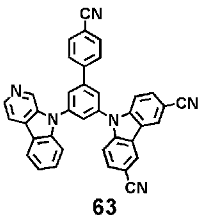
63

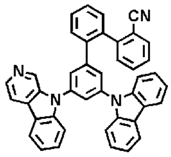
64

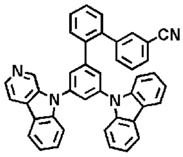
65

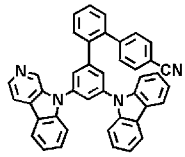
66

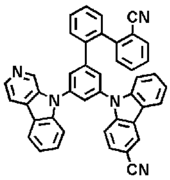
67

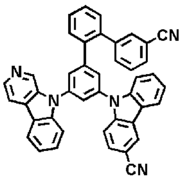
68

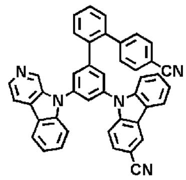
69

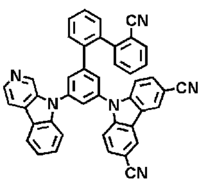
70

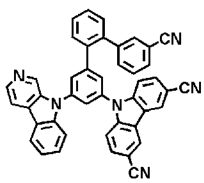
71

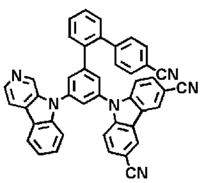
72

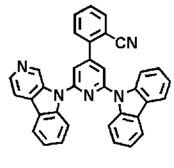
73
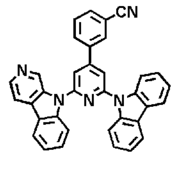
74
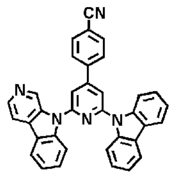
75
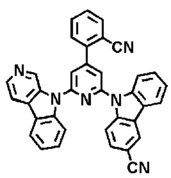
76
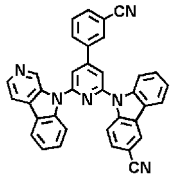
77
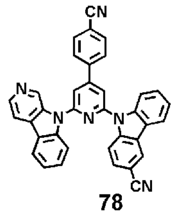
78

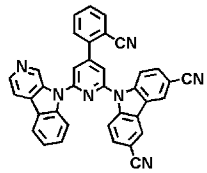
79
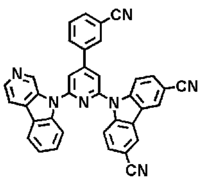
80
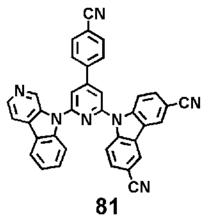
81
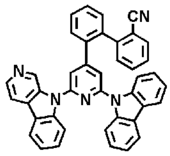
82
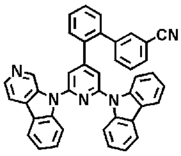
83
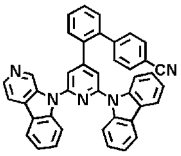
84

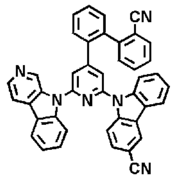
85
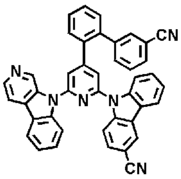
86
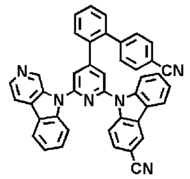
87
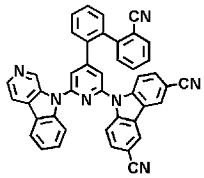
88
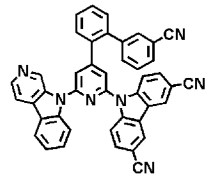
89
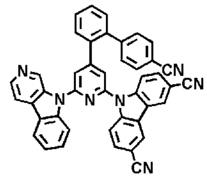
90

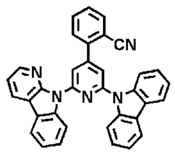
91
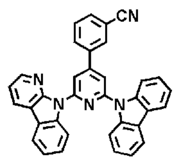
92
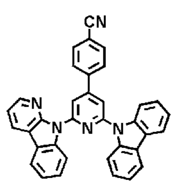
93
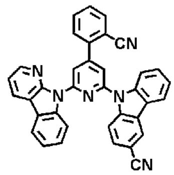
94
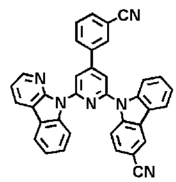
95
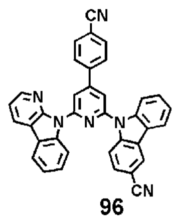
96

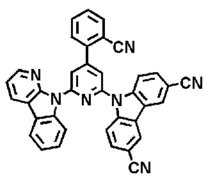
97
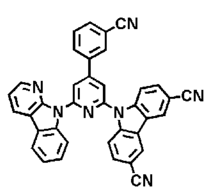
98
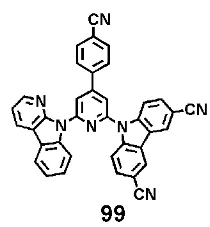
99
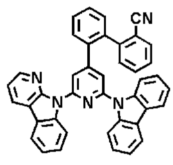
100
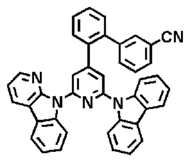
101
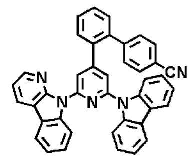
102

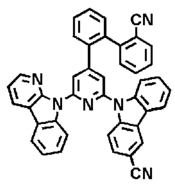
103
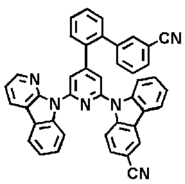
104
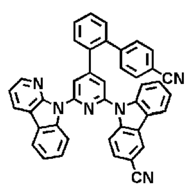
105
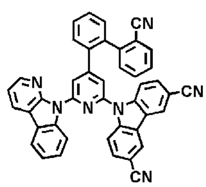
106
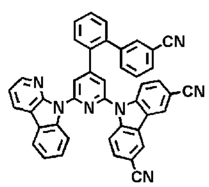
107
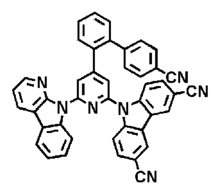
108

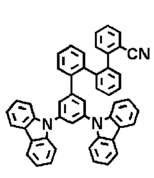

109

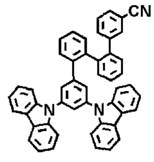

110

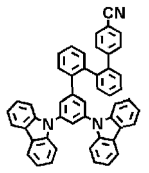

111

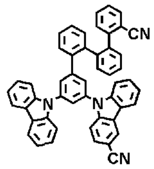

112

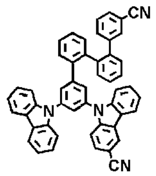

113

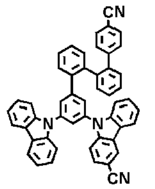

114

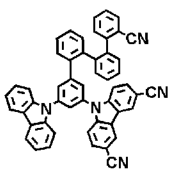

115

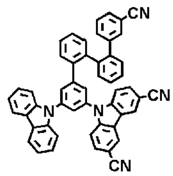

116

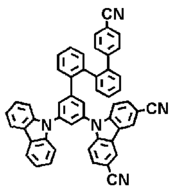

117

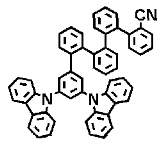

118

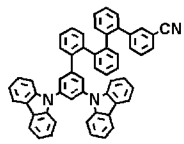

119

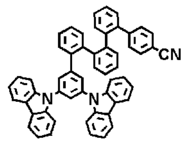

120

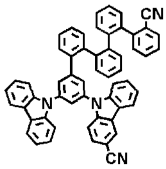

121

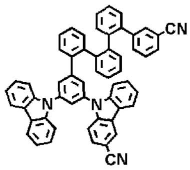

122

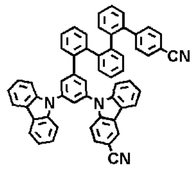

123

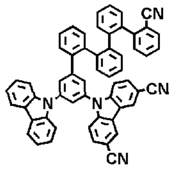

124

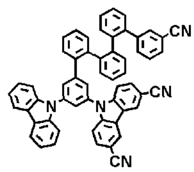

125

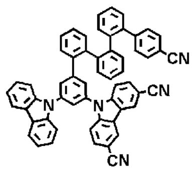

126

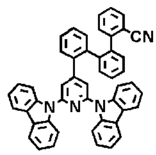

127

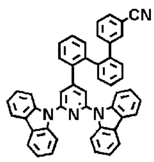

128

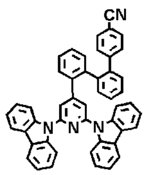

129

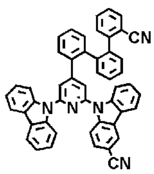

130

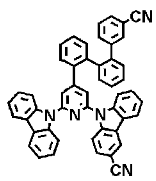

131

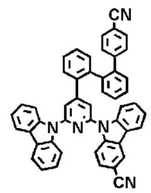

132

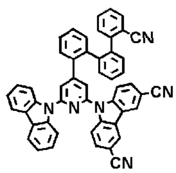

133

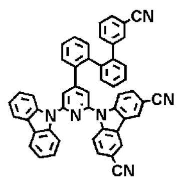

134

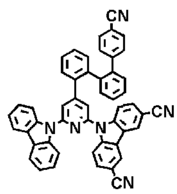

135

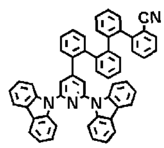

136

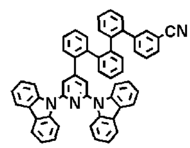

137

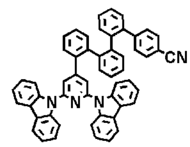

138

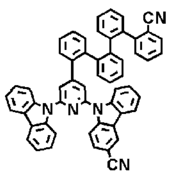

139

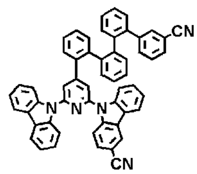

140

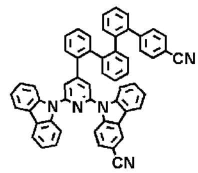

141

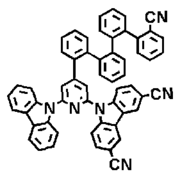

142

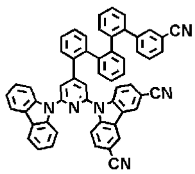

143

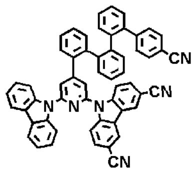

144

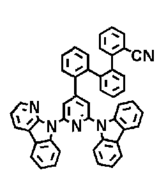 145 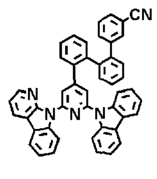 146 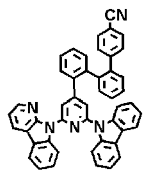 147 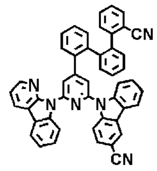 148 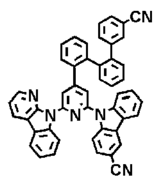 149 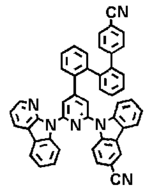 150

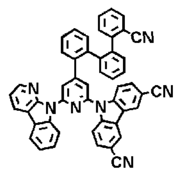 151 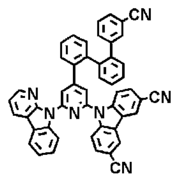 152 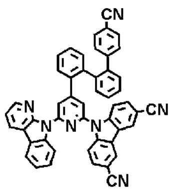 153 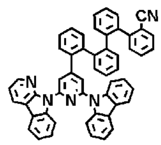 154 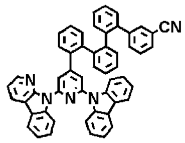 155 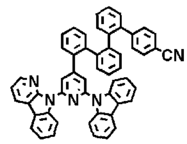 156

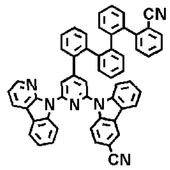 157 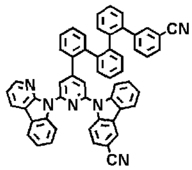 158 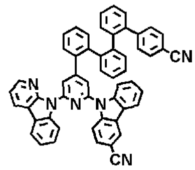 159 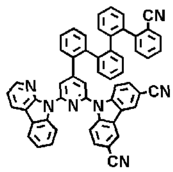 160 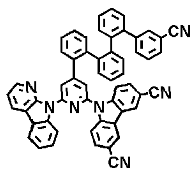 161 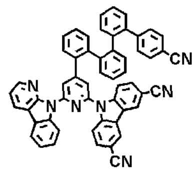 162

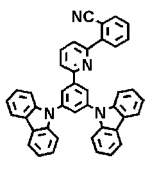 163 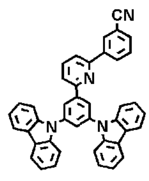 164 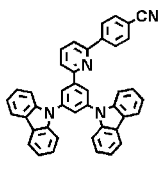 165 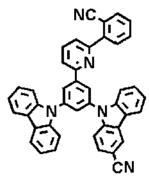 166 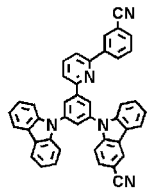 167 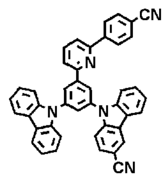 168

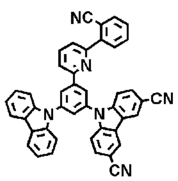 169 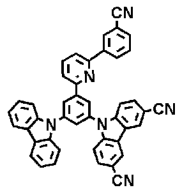 170 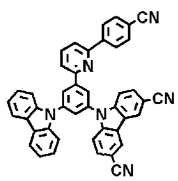 171 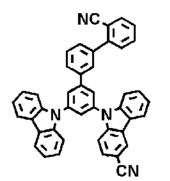 172 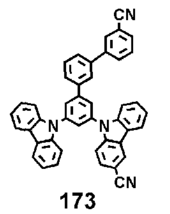 173 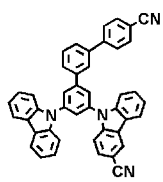 174

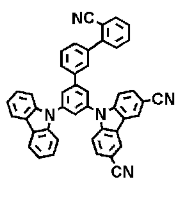 175 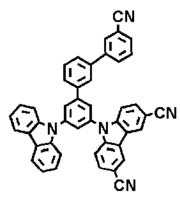 176 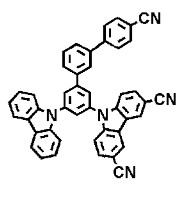 177 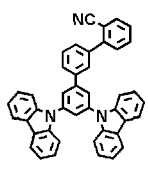 178 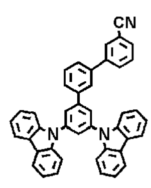 179 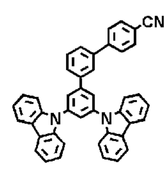 180

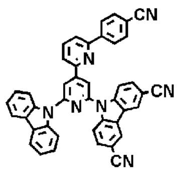

**181**

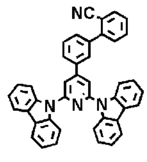

**182**

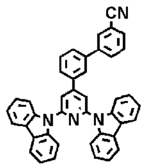

**183**

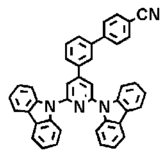

**184**

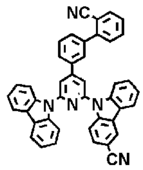

**185**

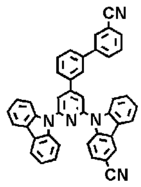

**186**

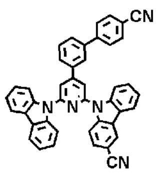

**187**

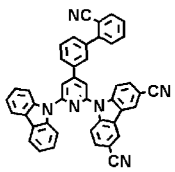

**188**

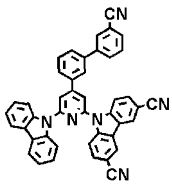

**189**

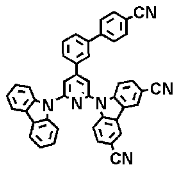

**190**

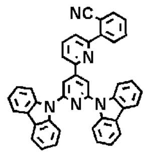

**191**

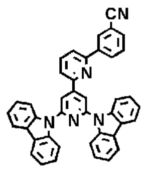

**192**

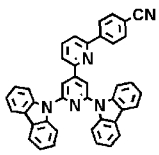

**193**

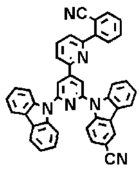

**194**

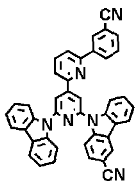

**195**

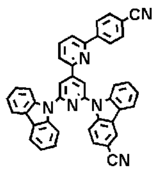

**196**

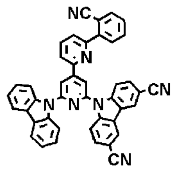

**197**

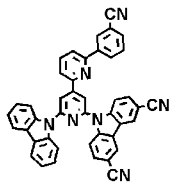

**198**

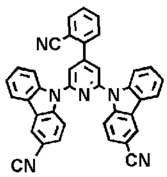

**199**

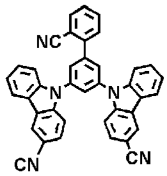

**200**

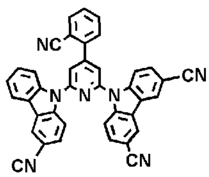

**201**

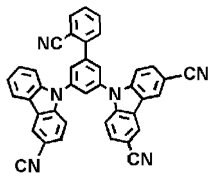

**202**

Group HE6

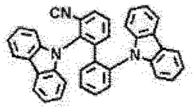
1

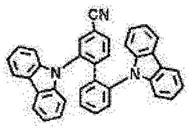
2

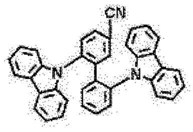
3

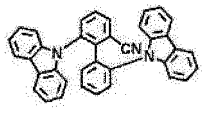
4

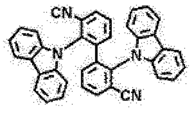
5

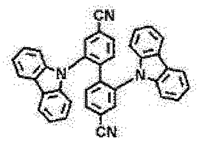
6

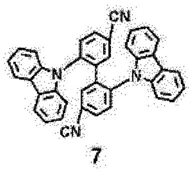
7

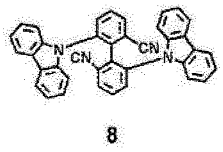
8

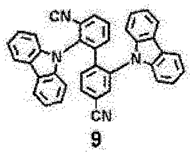
9

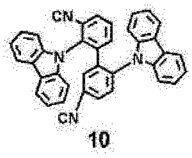
10

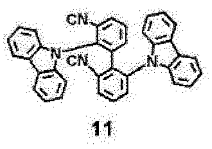
11

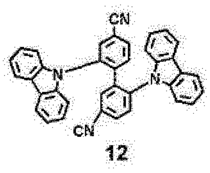
12

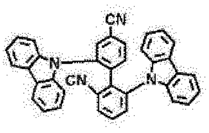
13

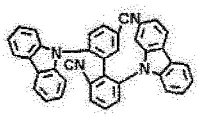
14

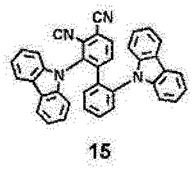
15

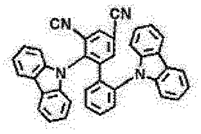
16

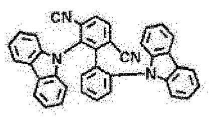
17

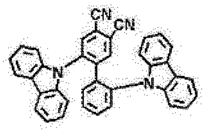
18

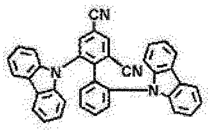
19

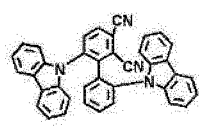
20

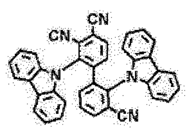
21
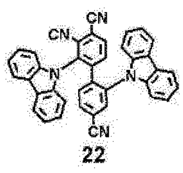
22
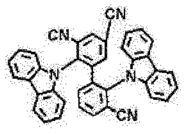
23
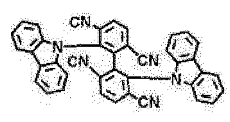
24
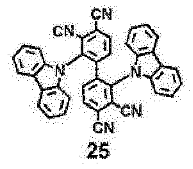
25

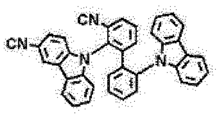
26
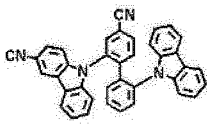
27
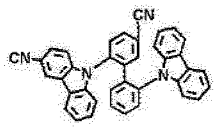
28
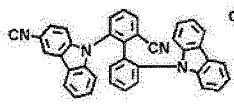
29
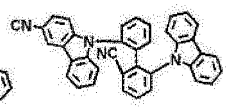
30

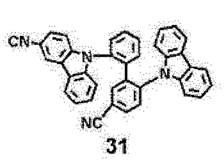
31
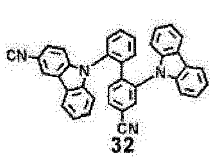
32
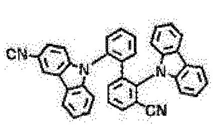
33
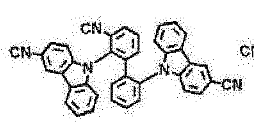
34
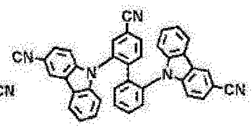
35

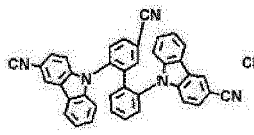
36
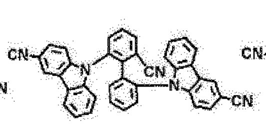
37
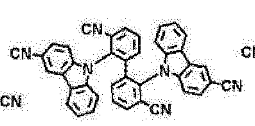
38
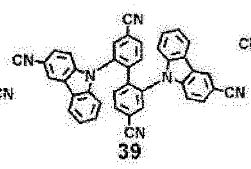
39
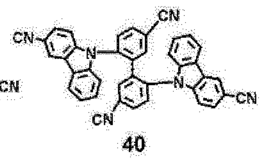
40

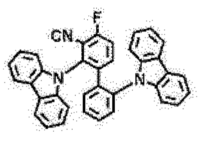
41
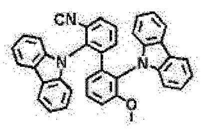
42
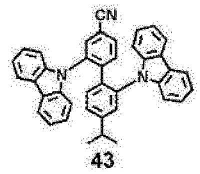
43
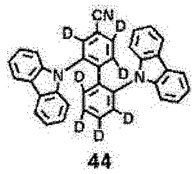
44
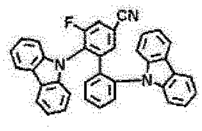
45

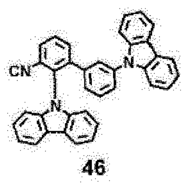
46
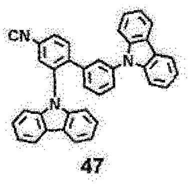
47
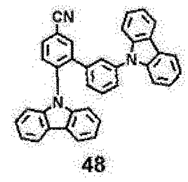
48
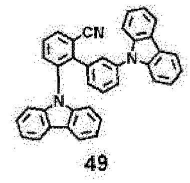
49
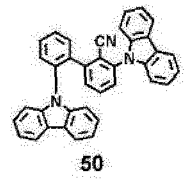
50

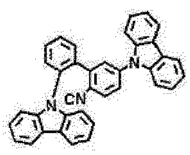
51
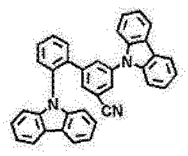
52
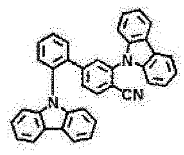
53
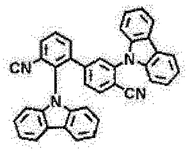
54
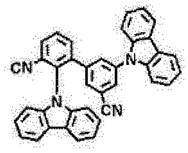
55

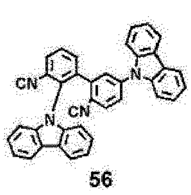
56
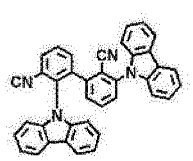
57
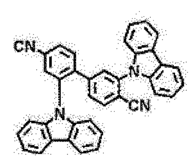
58
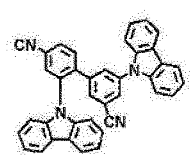
59
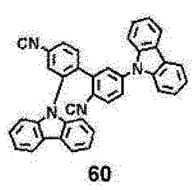
60

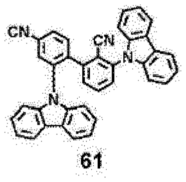
61
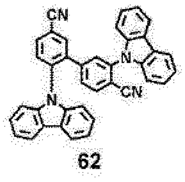
62
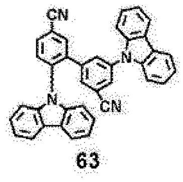
63
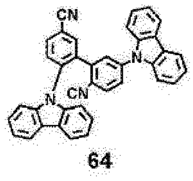
64
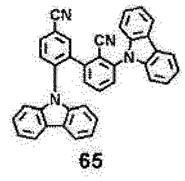
65

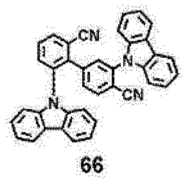
66
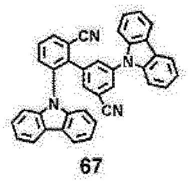
67
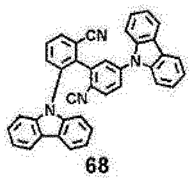
68
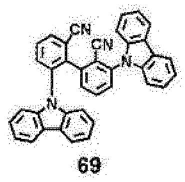
69
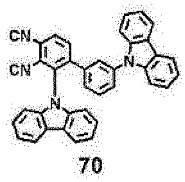
70

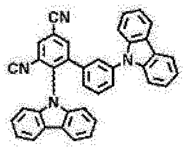
71
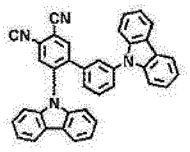
72
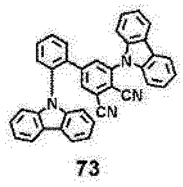
73
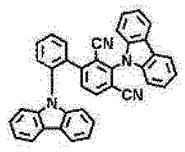
74
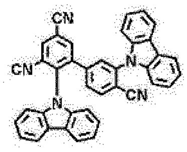
75

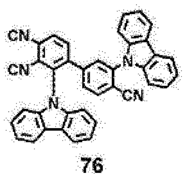
76
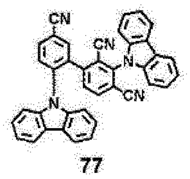
77
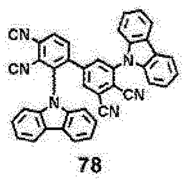
78
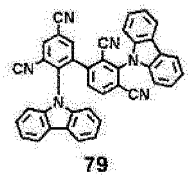
79
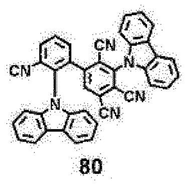
80

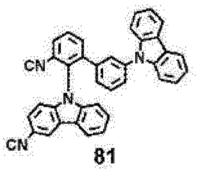
81
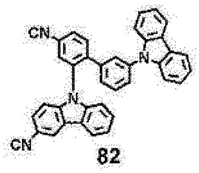
82
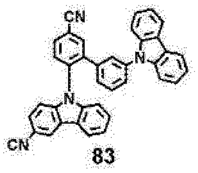
83
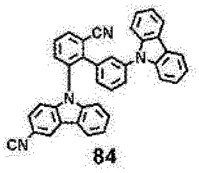
84
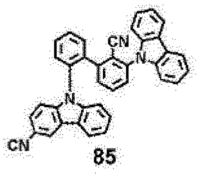
85

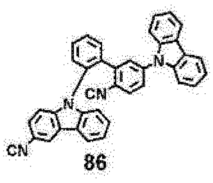
86
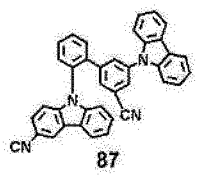
87
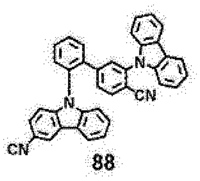
88
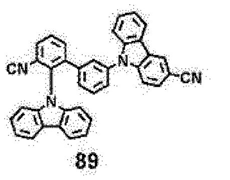
89
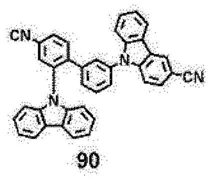
90

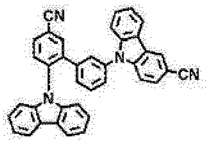
91
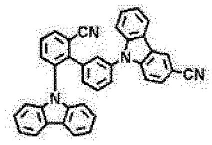
92
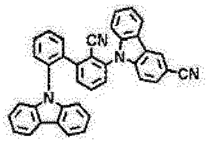
93
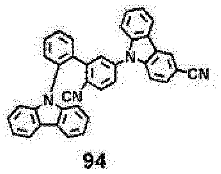
94
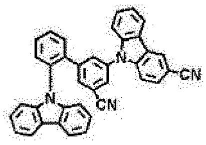
95

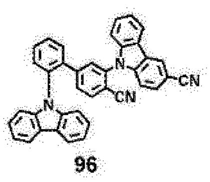
96
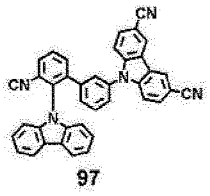
97
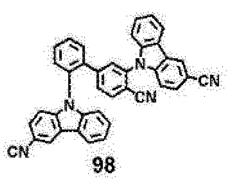
98
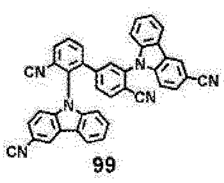
99
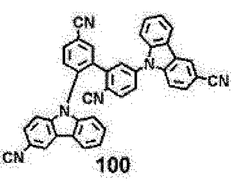
100

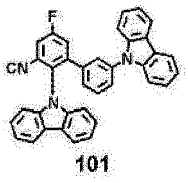
101

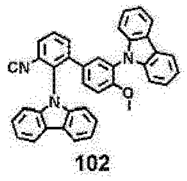
102

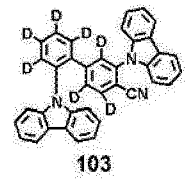
103

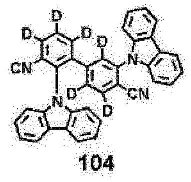
104

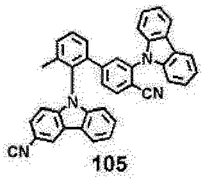
105

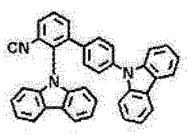
106

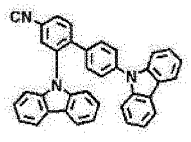
107

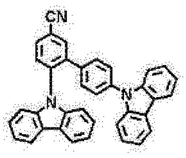
108

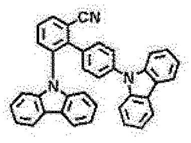
109

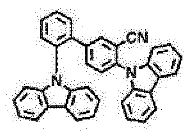
110

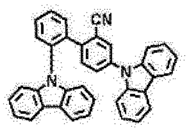
111

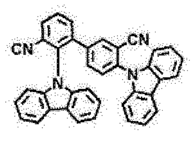
112

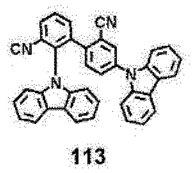
113

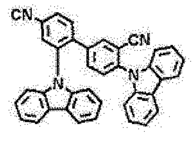
114

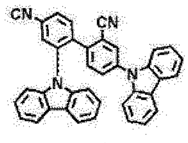
115

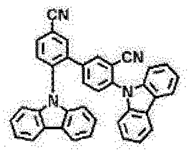
116

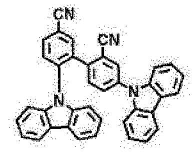
117

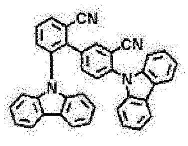
118

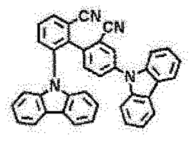
119

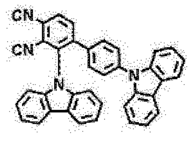
120

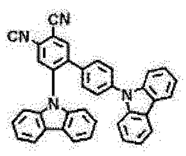
121

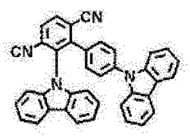
122

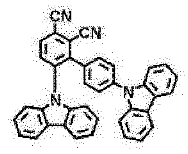
123

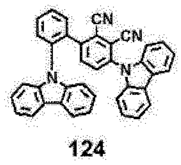
124

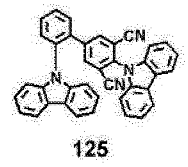
125

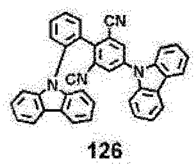
126

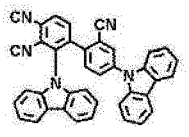
127

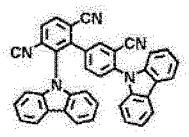
128

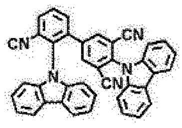
129

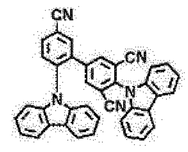
130

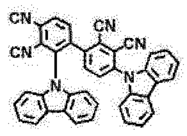
131

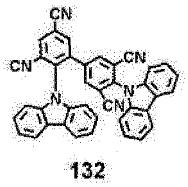
132

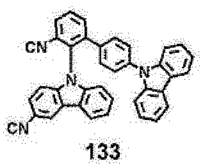
133

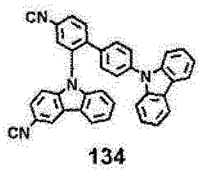
134

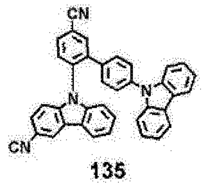
135

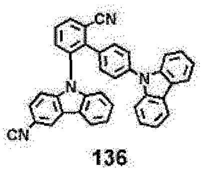
136

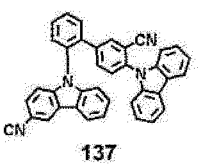
137

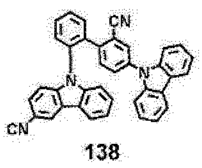
138

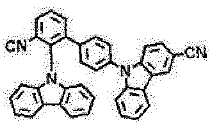
139

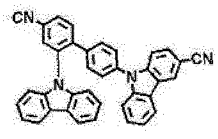
140

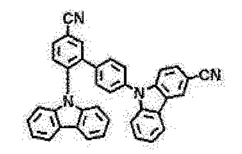
141

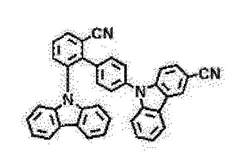
142

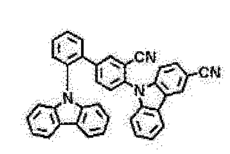
143

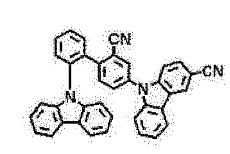
144

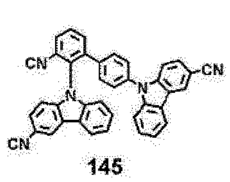
145

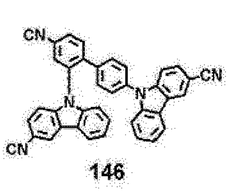
146

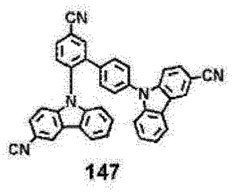
147

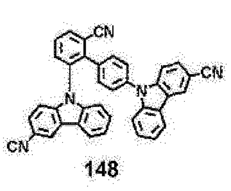
148

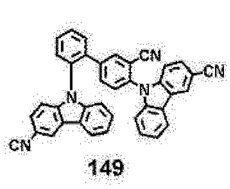
149

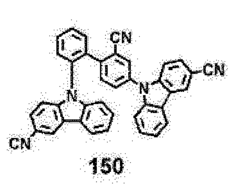
150

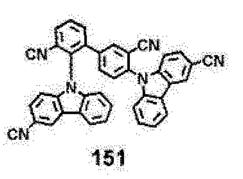
151

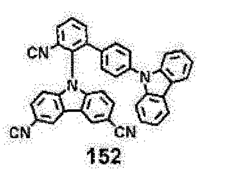
152

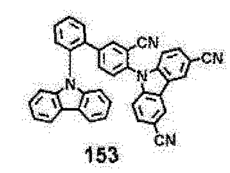
153

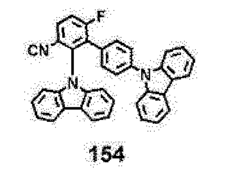
154

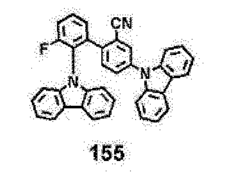
155

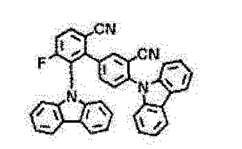
156

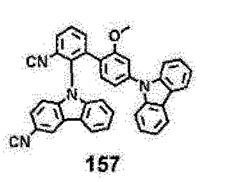
157

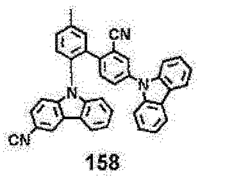
158

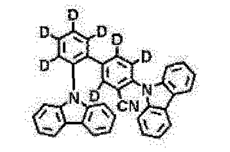
159

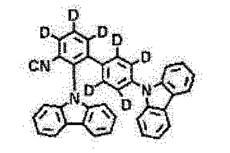
160

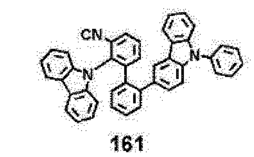
161

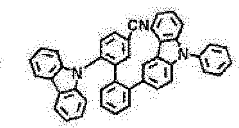
162

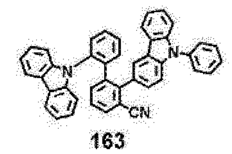
163

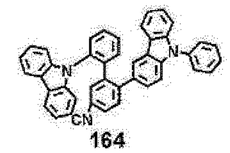
164

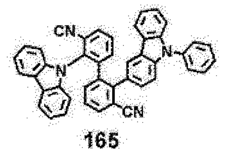
165

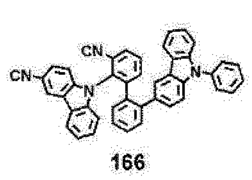
166

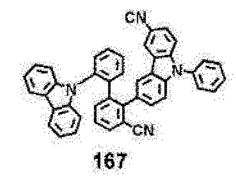
167

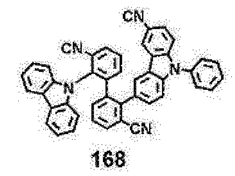
168

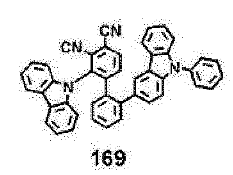
169

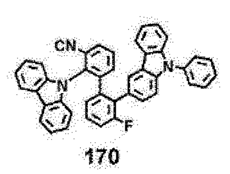
170

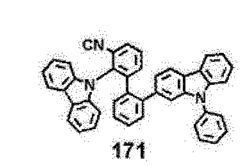
171

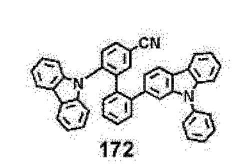
172

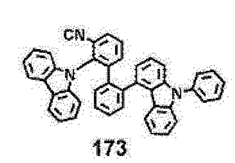
173

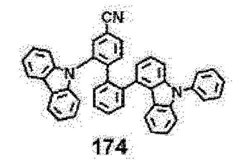
174

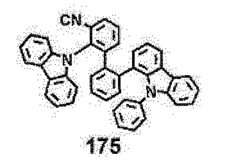
175

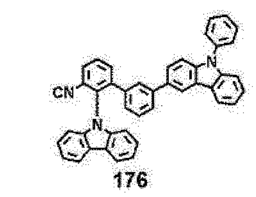
176

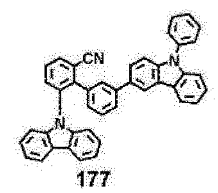
177

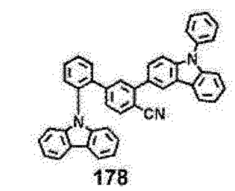
178

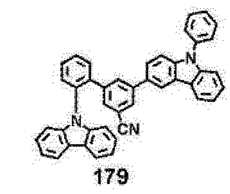
179

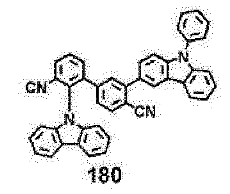
180

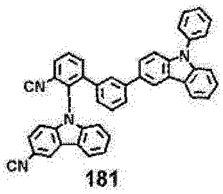
181

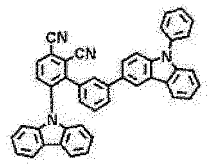
182

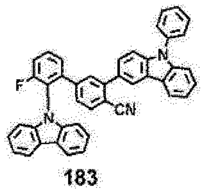
183

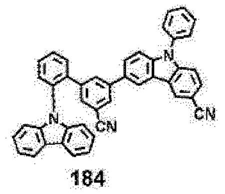
184

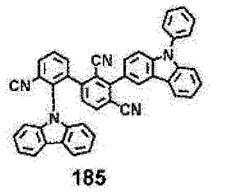
185

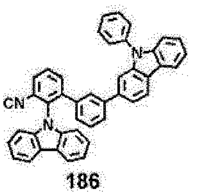
186

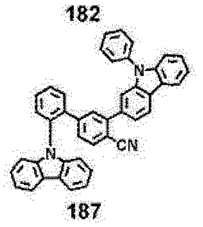
187

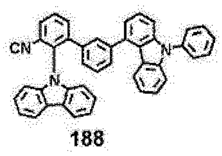
188

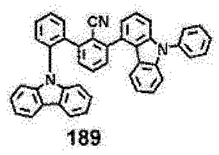
189

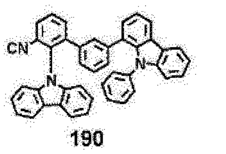
190

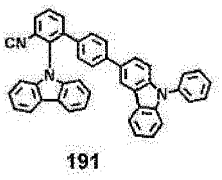
191

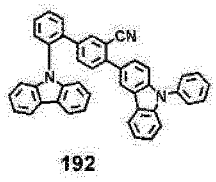
192

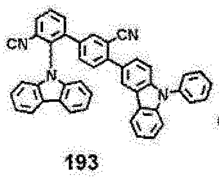
193

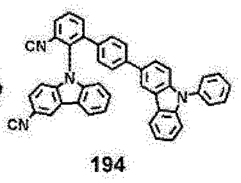
194

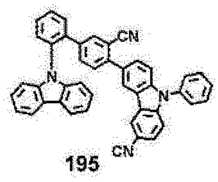
195

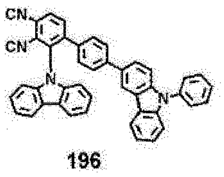
196

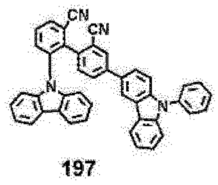
197

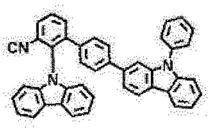
198

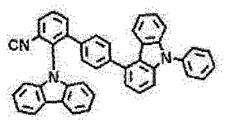
199

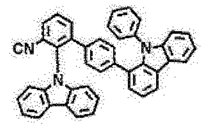
200

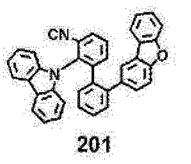
201

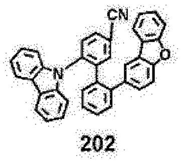
202

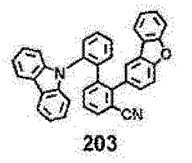
203

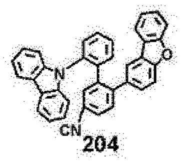
204

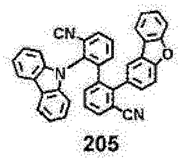
205

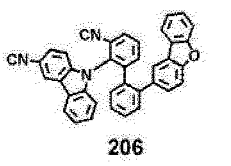
206

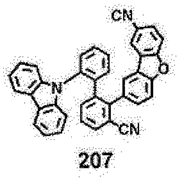
207

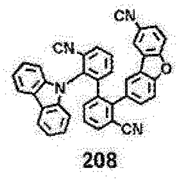
208

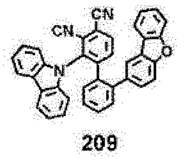
209

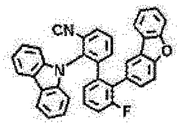
210

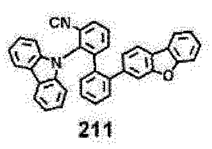
211

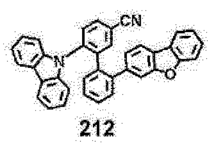
212

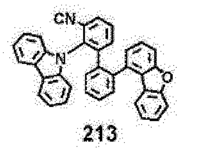
213

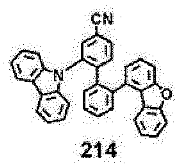
214

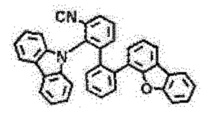
215

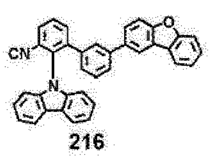
216

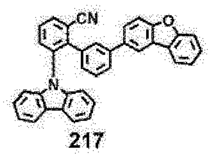
217

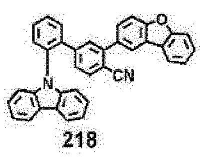
218

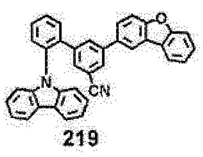
219

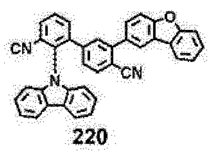
220

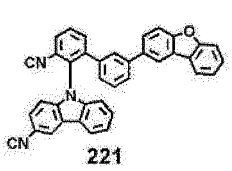
221
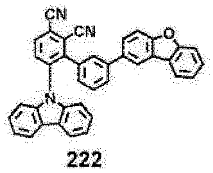
222
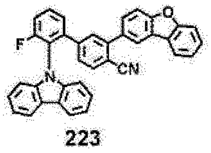
223
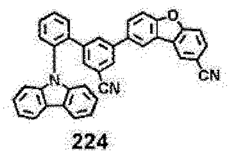
224
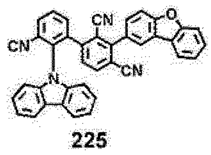
225

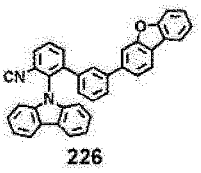
226
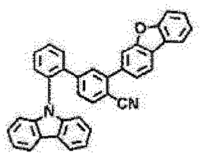
227
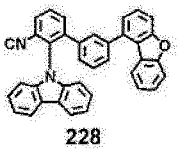
228
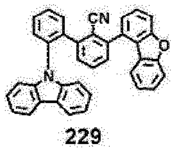
229
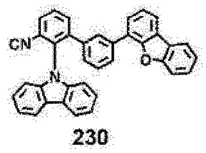
230

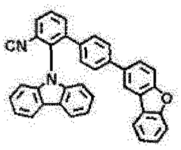
231
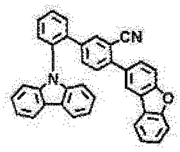
232
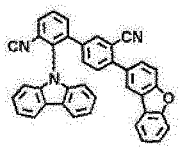
233
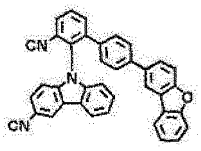
234
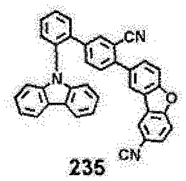
235

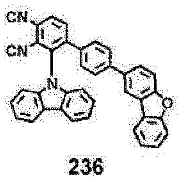
236
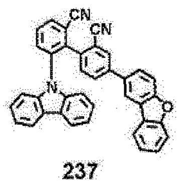
237
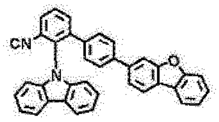
238
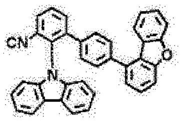
239
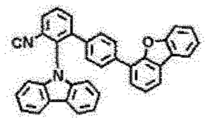
240

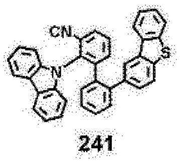
241
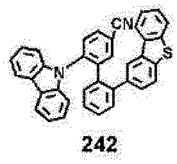
242
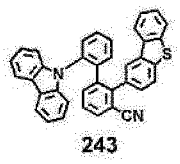
243
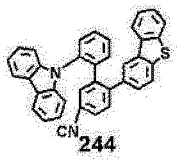
244
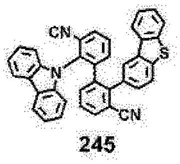
245

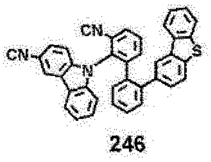
246
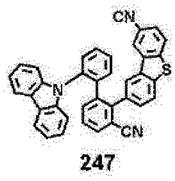
247
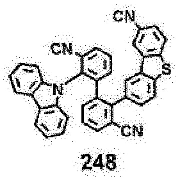
248
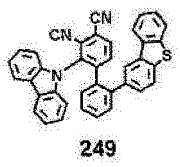
249
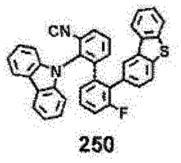
250

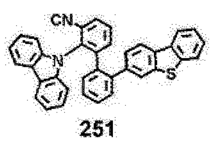
251
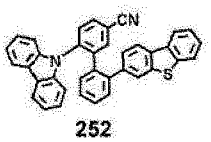
252
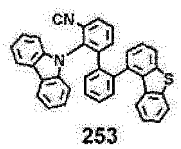
253
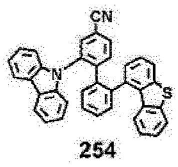
254
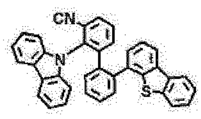
255

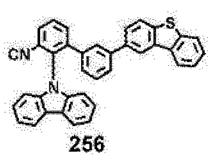
256
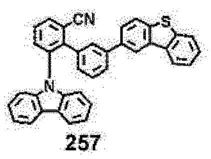
257
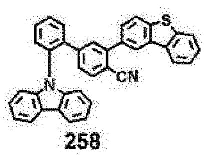
258
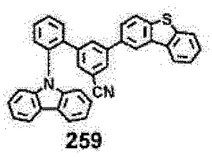
259
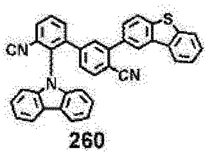
260

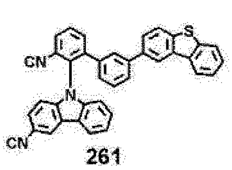
261
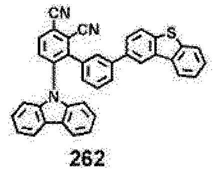
262
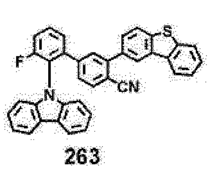
263
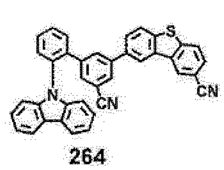
264
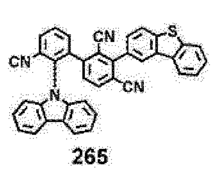
265

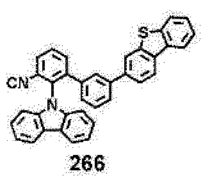
266
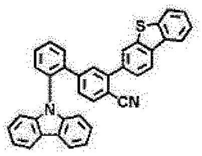
267
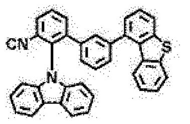
268
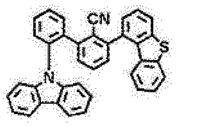
269
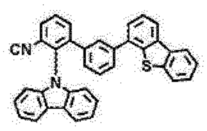
270

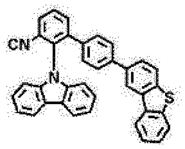
271
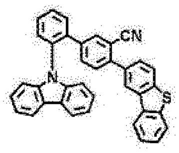
272
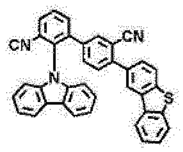
273
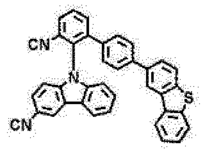
274
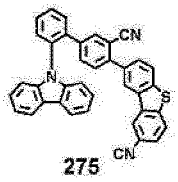
275

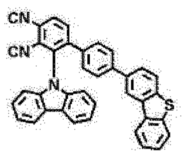
276
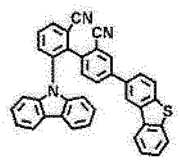
277
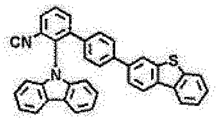
278
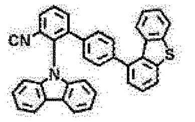
279
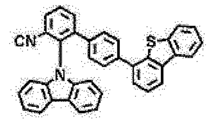
280

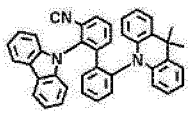
281
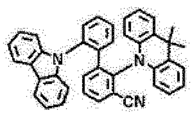
282
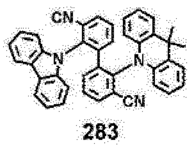
283
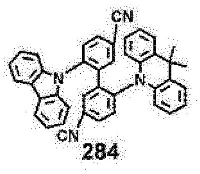
284
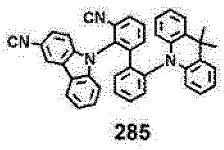
285

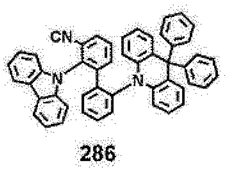
286
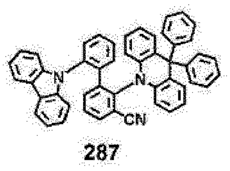
287
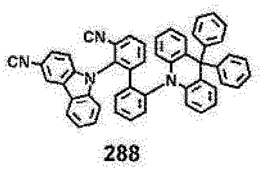
288
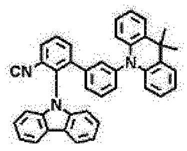
289
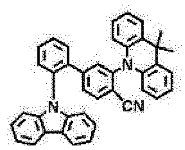
290

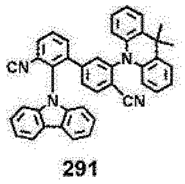
291
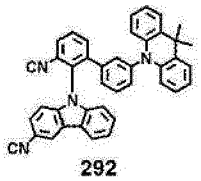
292
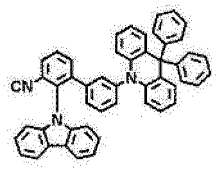
293
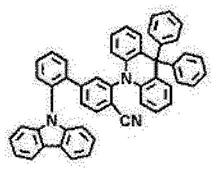
294
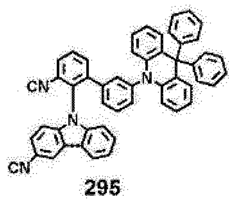
295

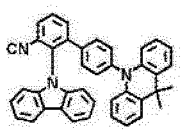
296
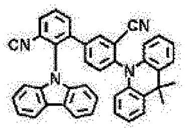
297
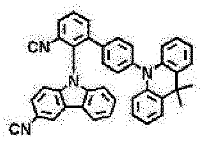
298
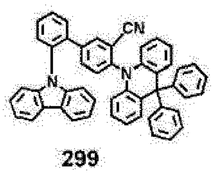
299
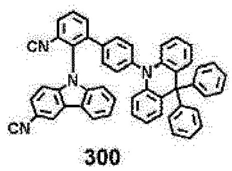
300

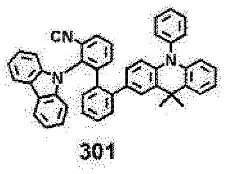
301

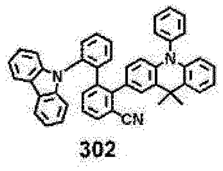
302

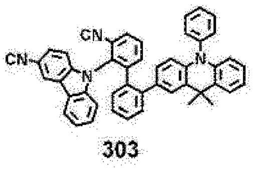
303

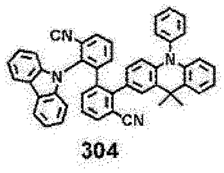
304

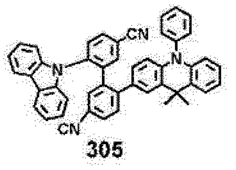
305

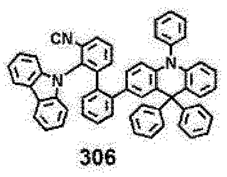
306

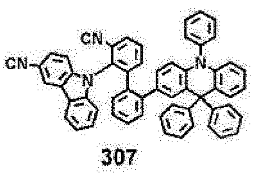
307

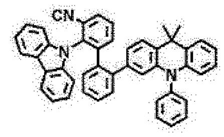
308

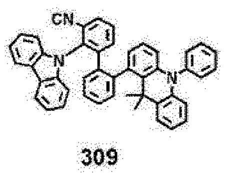
309

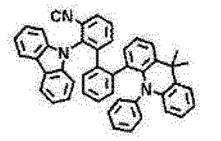
310

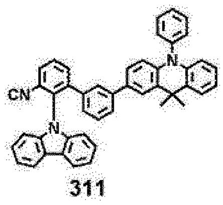
311

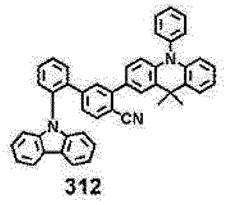
312

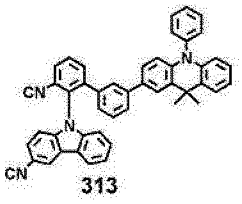
313

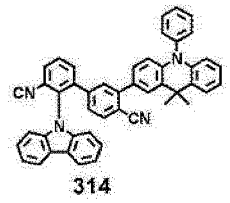
314

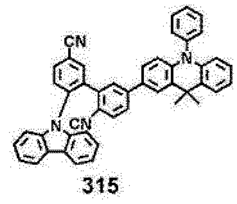
315

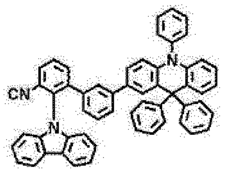
316

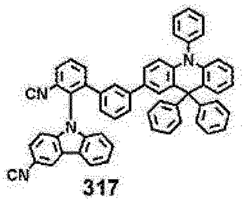
317

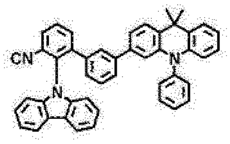
318

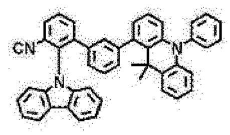
319

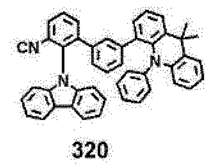
320

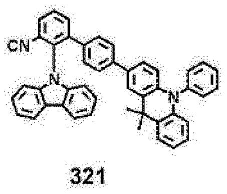
321

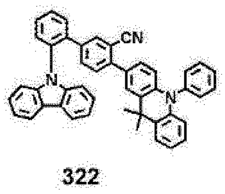
322

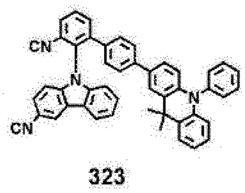
323

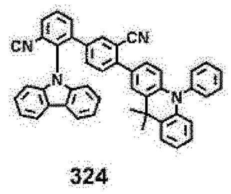
324

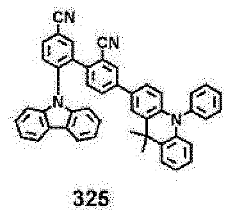
325

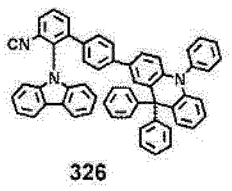
326

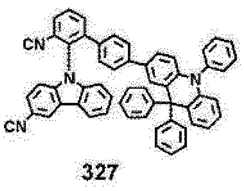
327

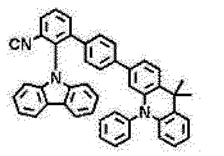
328

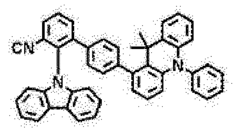
329

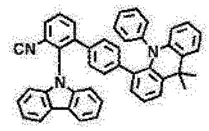
330

## Group HE7

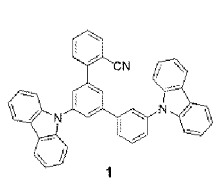
1
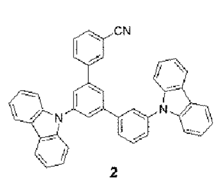
2
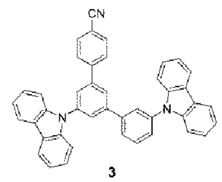
3
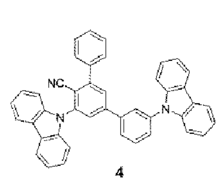
4
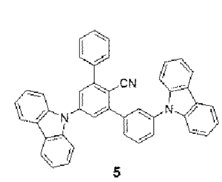
5
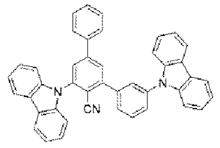
6
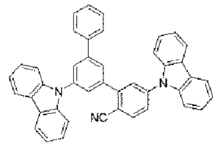
7
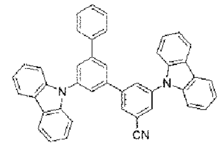
8
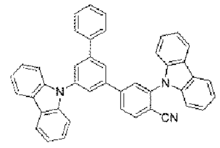
9
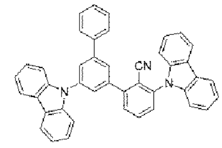
10
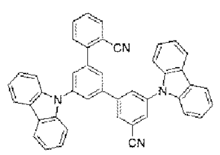
11
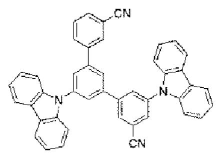
12
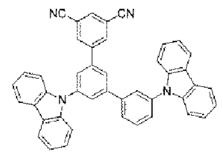
13
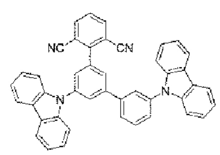
14
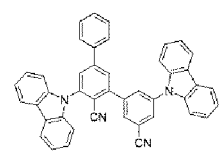
15
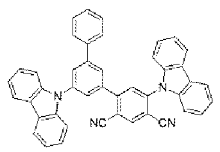
16
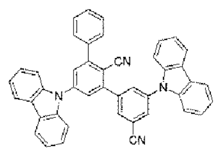
17
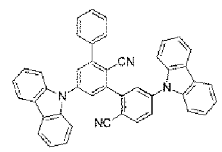
18
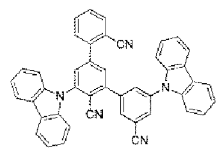
19
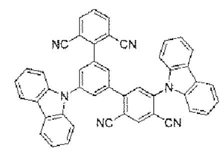
20
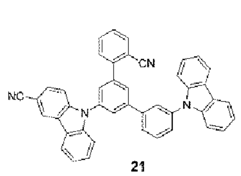
21
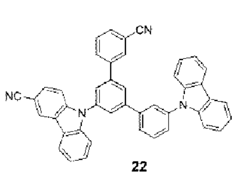
22
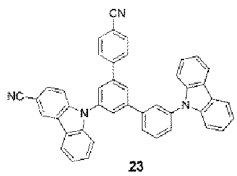
23
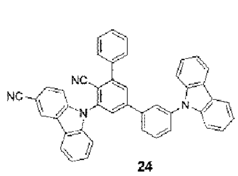
24
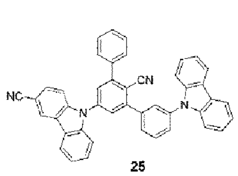
25
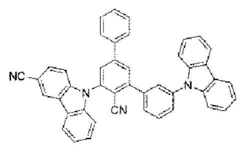
26
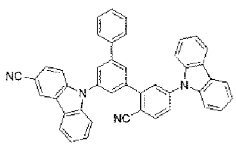
27
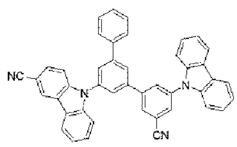
28
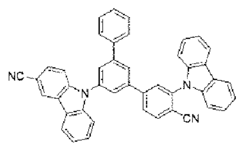
29
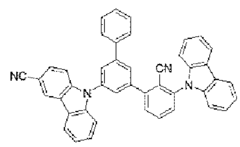
30
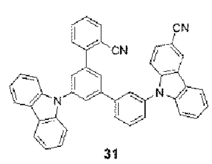
31
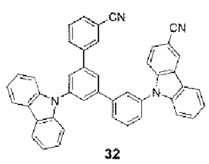
32
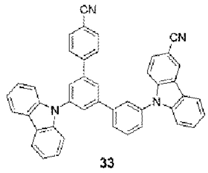
33
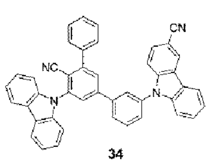
34
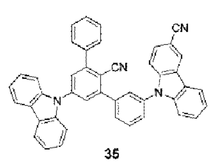
35
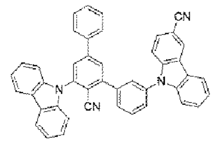
36
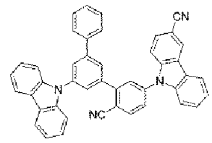
37
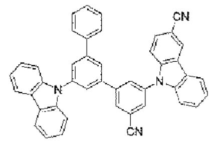
38
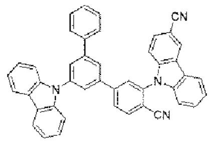
39
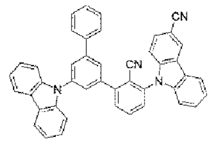
40

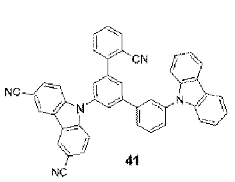
41

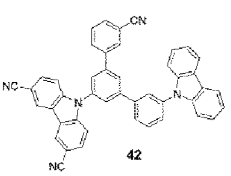
42

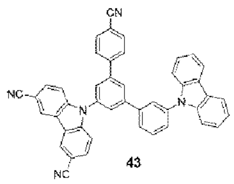
43

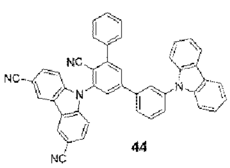
44

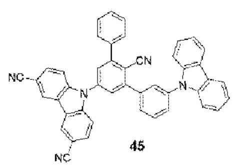
45

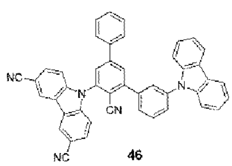
46

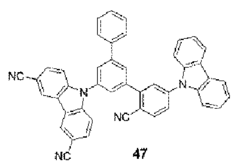
47

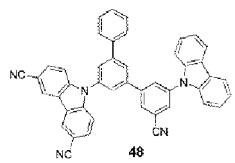
48

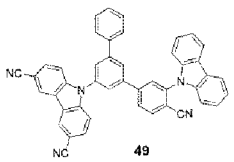
49

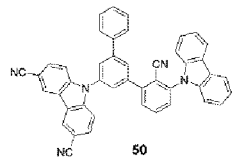
50

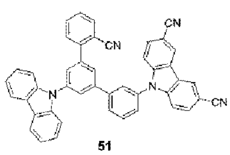
51

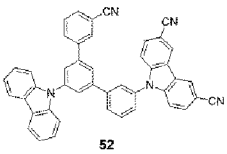
52

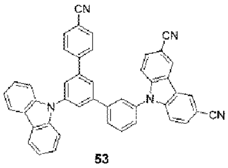
53

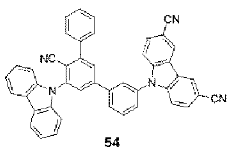
54

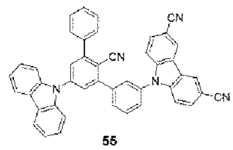
55

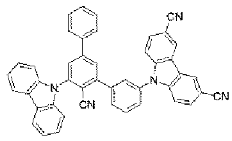
56

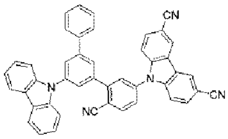
57

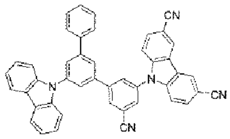
58

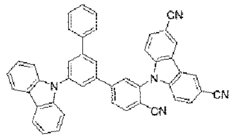
59

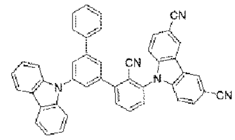
60

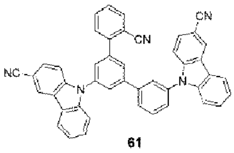
61

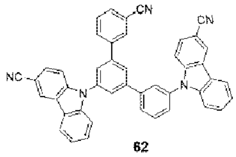
62

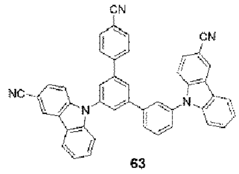
63

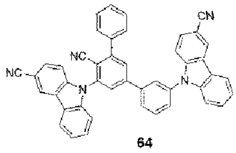
64

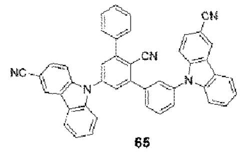
65

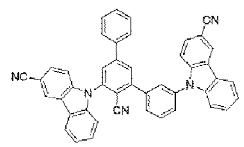
66

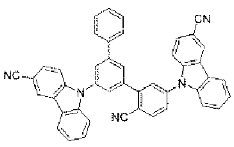
67

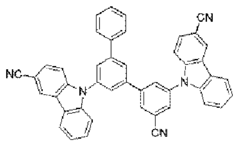
68

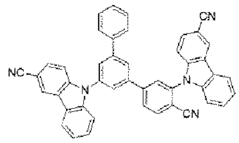
69

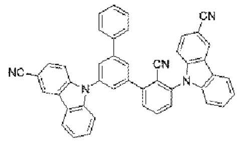
70

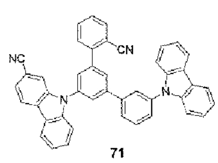
71

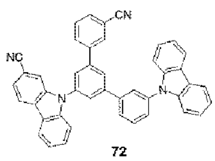
72

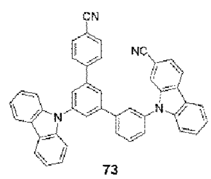
73

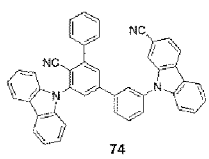
74

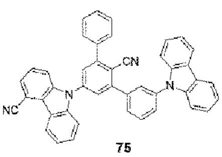
75

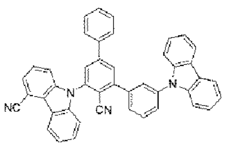
76

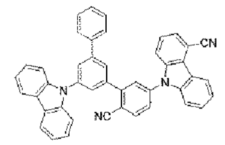
77

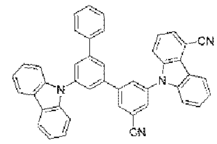
78

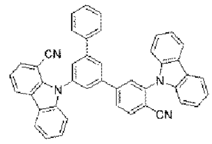
79

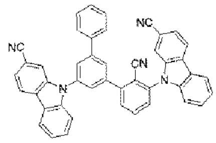
80

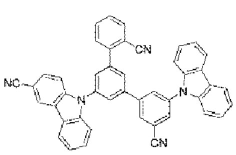
81
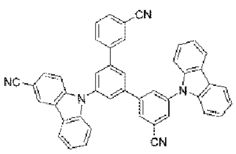
82
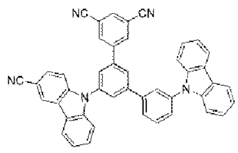
83
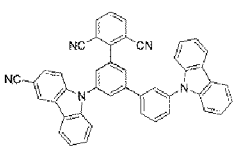
84
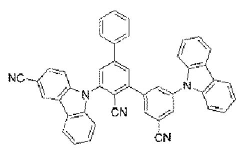
85

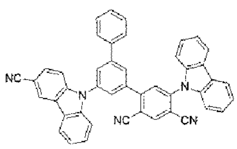
86
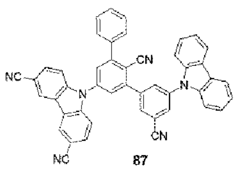
87
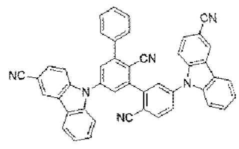
88
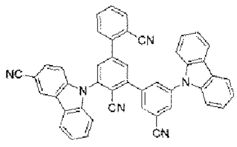
89
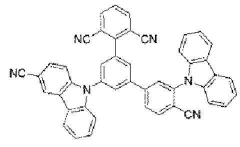
90

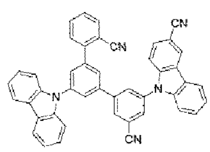
91
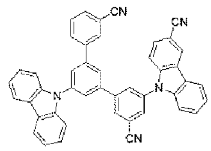
92
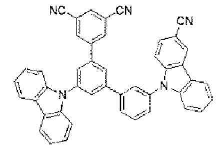
93
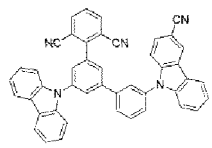
94
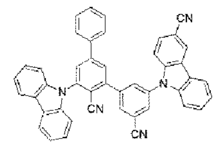
95

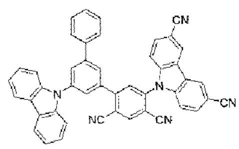
96
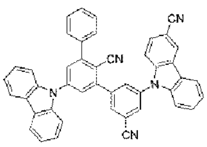
97
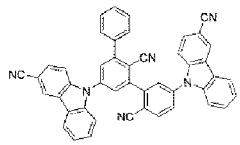
98
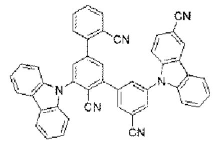
99
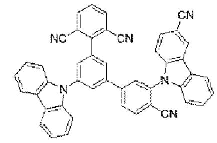
100

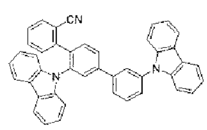
101
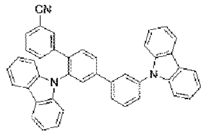
102
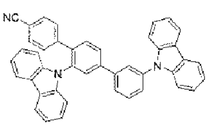
103
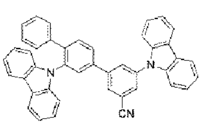
104
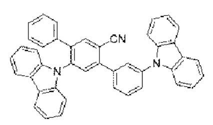
105

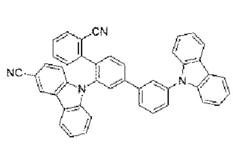
106
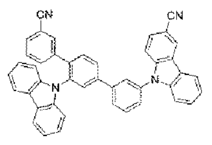
107
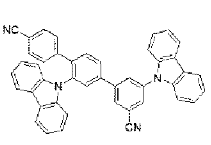
108
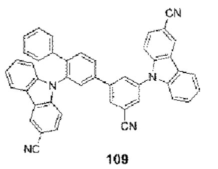
109
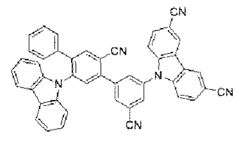
110

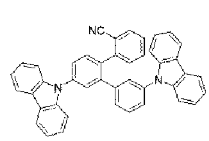
111
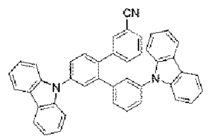
112
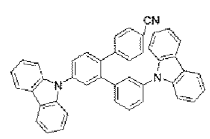
113
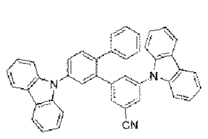
114
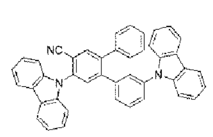
115

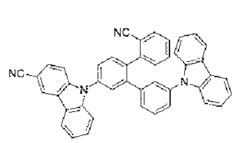
116
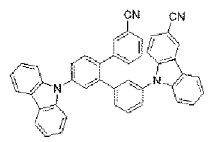
117
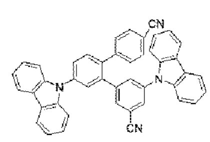
118
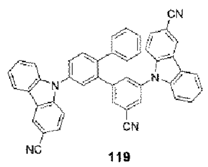
119
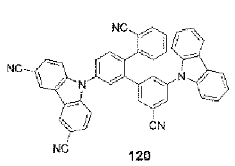
120

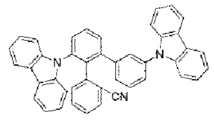
121
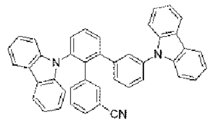
122
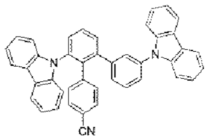
123
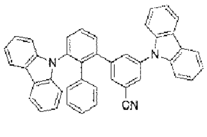
124
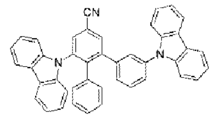
125

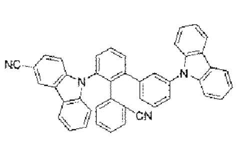
126
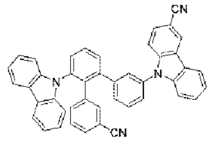
127
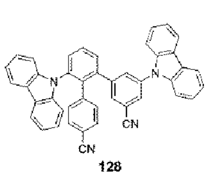
128
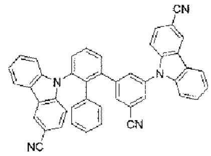
129
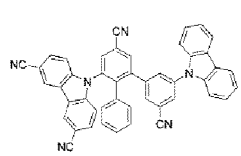
130

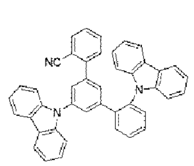
131
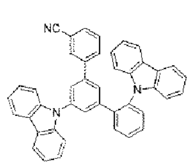
132
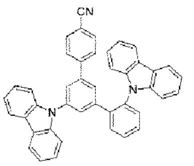
133
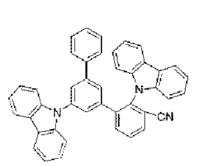
134
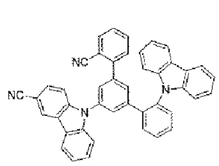
135

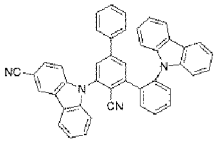
136
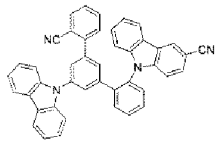
137
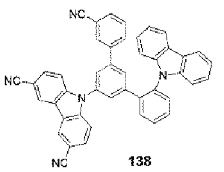
138
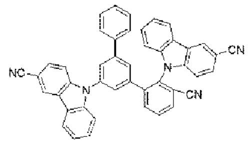
139
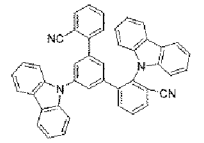
140

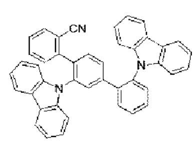
141
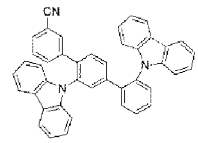
142
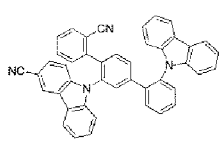
143
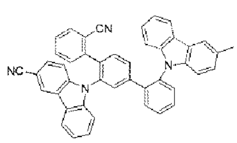
144
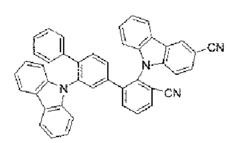
145

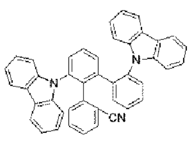
146
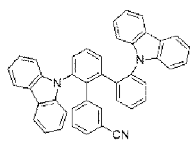
147
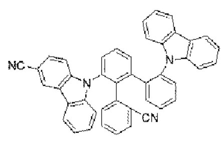
148
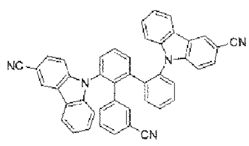
149
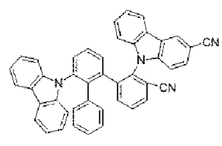
150

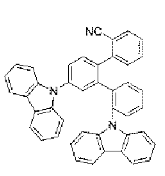
151
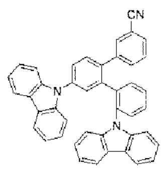
152
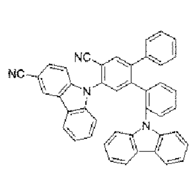
153
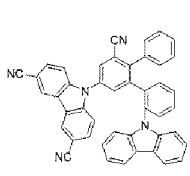
154
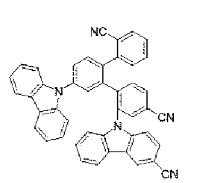
155

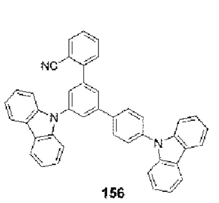
156
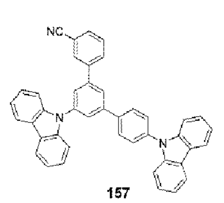
157
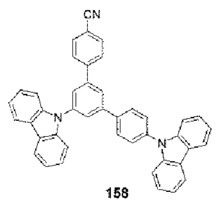
158
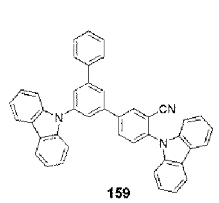
159
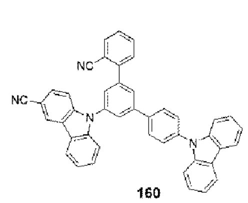
160

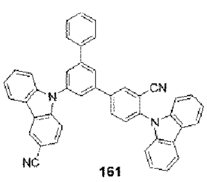
161

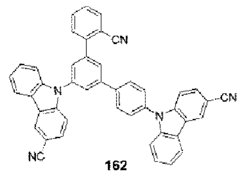
162

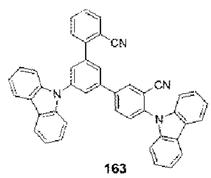
163

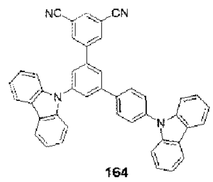
164

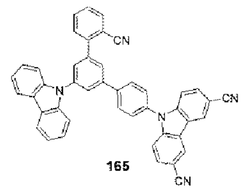
165

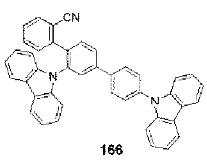
166

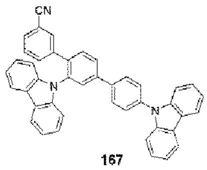
167

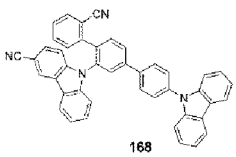
168

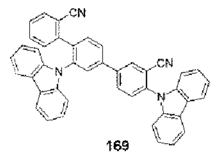
169

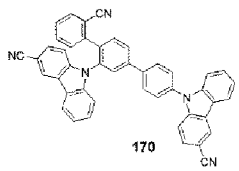
170

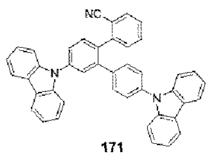
171

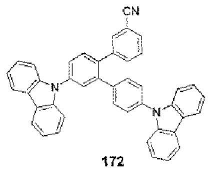
172

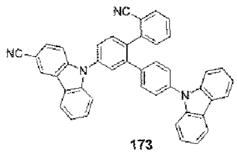
173

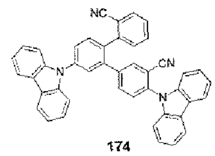
174

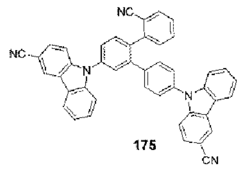
175

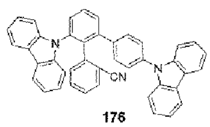
176

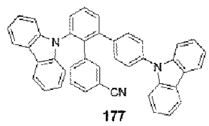
177

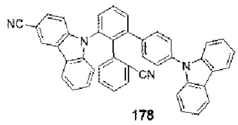
178

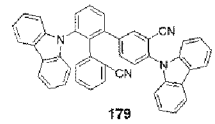
179

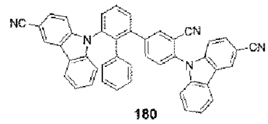
180

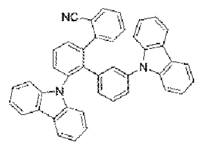
181

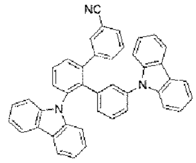
182

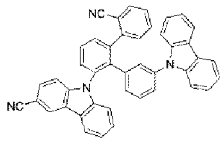
183

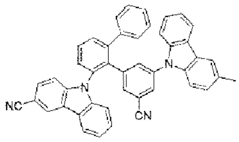
184

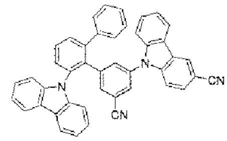
185

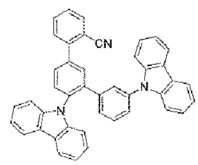
186

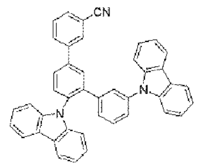
187

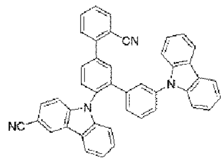
188

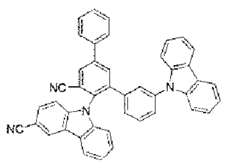
189

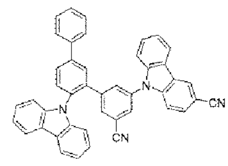
190

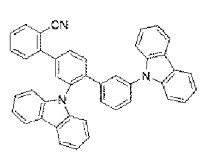
191

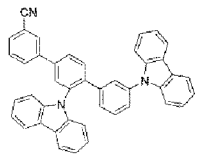
192

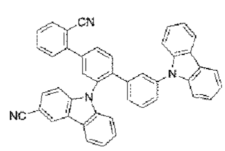
193

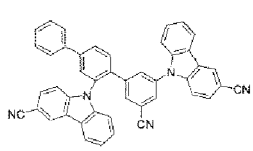
194

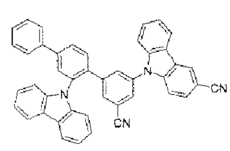
195

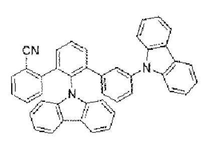
196

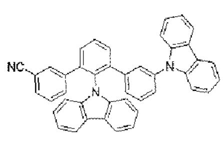
197

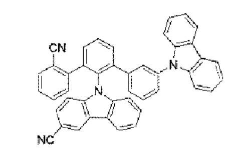
198

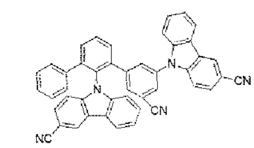
199

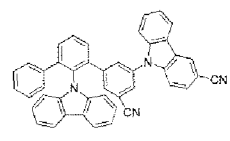
200

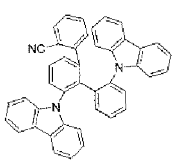
201

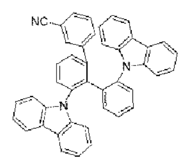
202

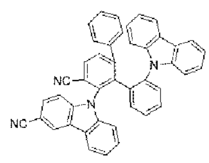
203

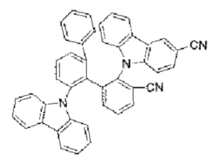
204

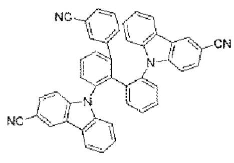
205

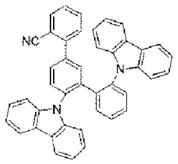
206

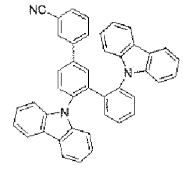
207

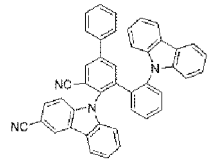
208

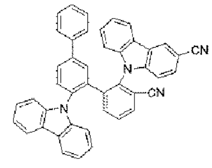
209

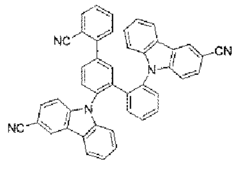
210

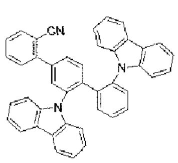
211

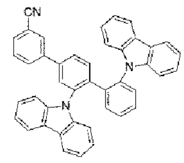
212

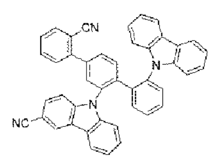
213

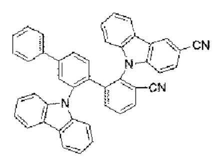
214

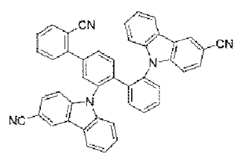
215

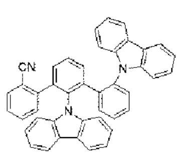
216

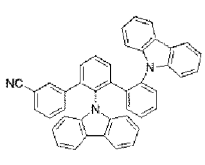
217

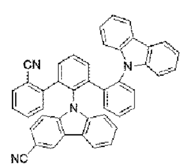
218

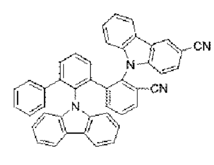
219

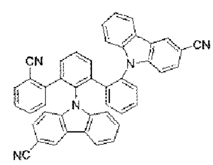
220

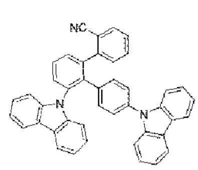
221

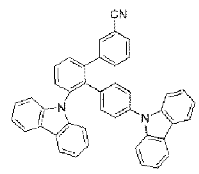
222

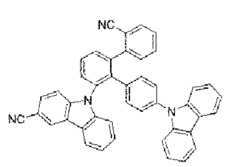
223

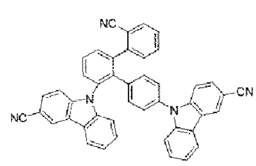
224

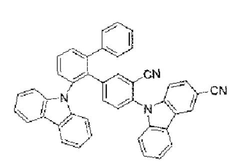
225

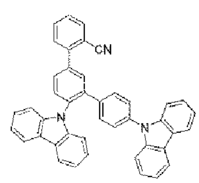
226

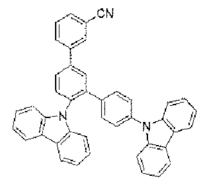
227

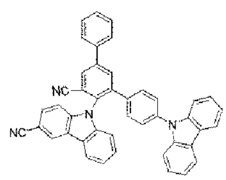
228

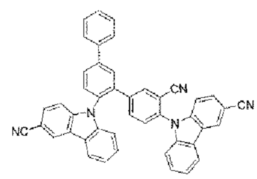
229

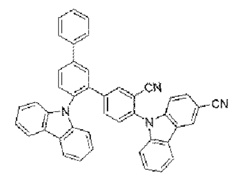
230

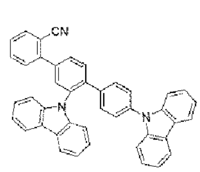
231

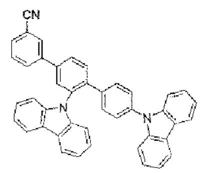
232

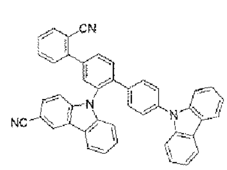
233

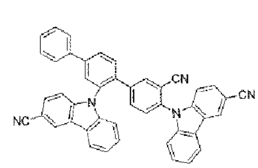
234

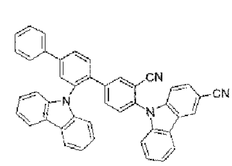
235

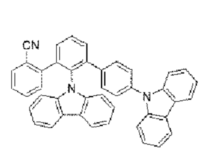
236

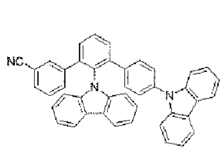
237

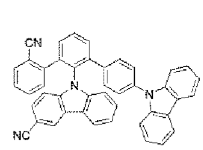
238

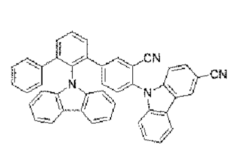
239

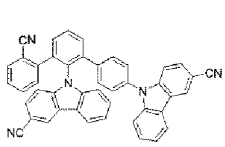
240

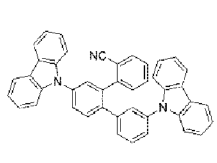
241

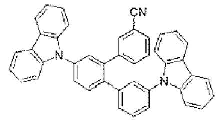
242

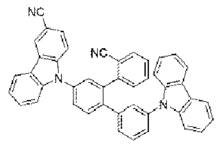
243

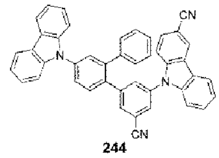
244

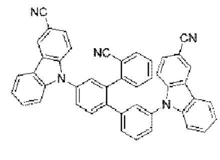
245

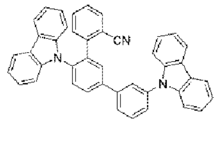
246

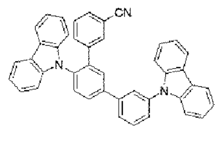
247

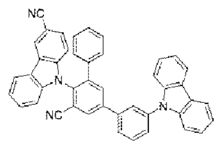
248

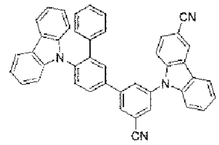
249

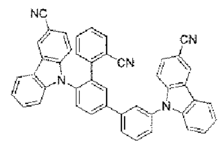
250

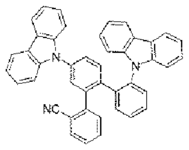
251

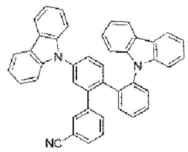
252

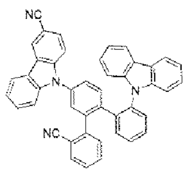
253

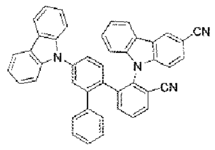
254

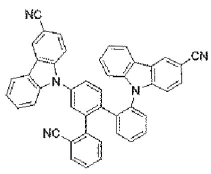
255

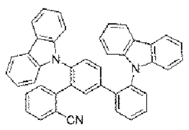
256

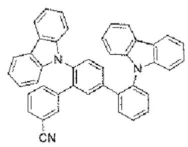
257

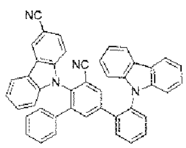
258

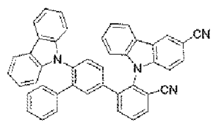
259

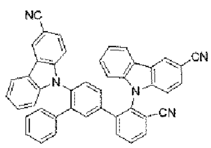
260

In some embodiments, the electron transporting host may include DPEPO, TSPO1, or Compound ET host:

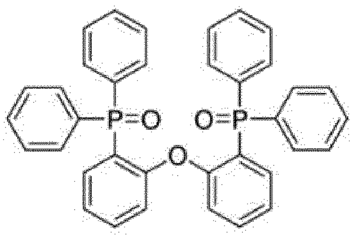

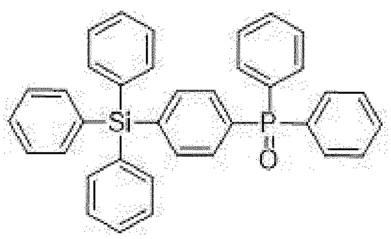

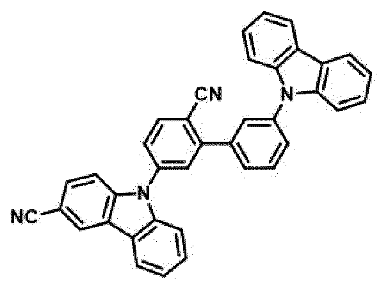

ET host

In some embodiments, the hole transporting host may be a compound represented by one of Group HH1, but embodiments are not limited thereto:

Group HH1

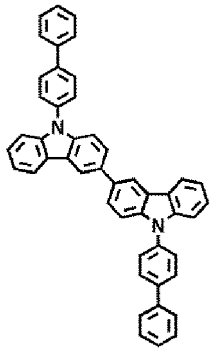

**H-H1**

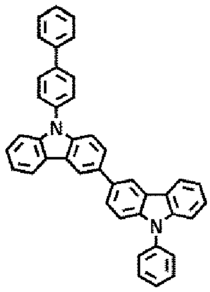

**H-H2**

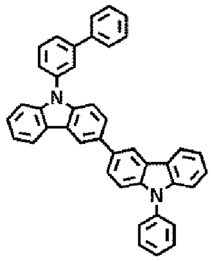

**H-H3**

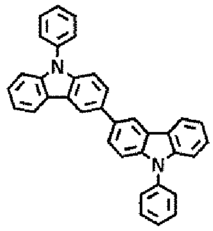

**H-H4**

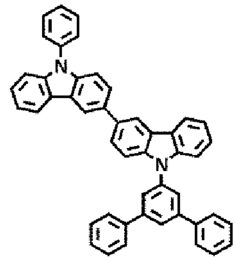

**H-H5**

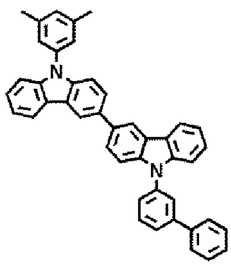

**H-H6**

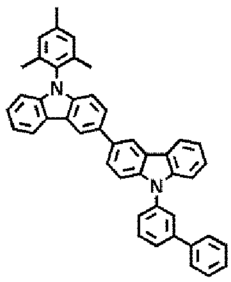

**H-H7**

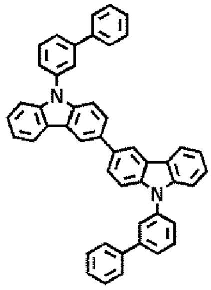

**H-H8**

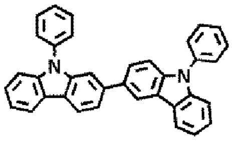

**H-H9**

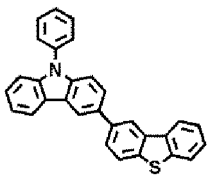

**H-H10**

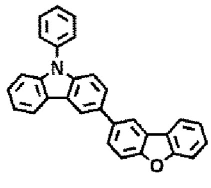

**H-H11**

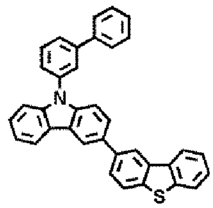

**H-H12**

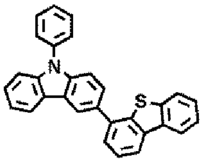

**H-H13**

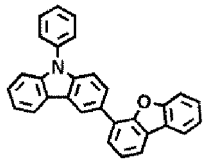

**H-H14**

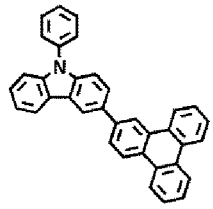

**H-H15**

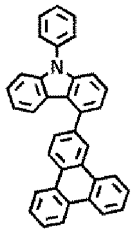

**H-H16**

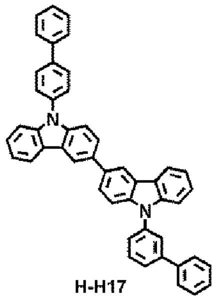
H-H17

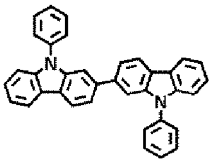
H-H18

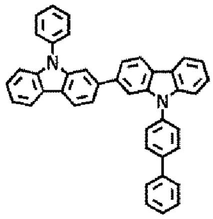
H-H19

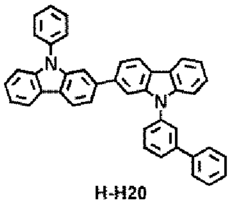
H-H20

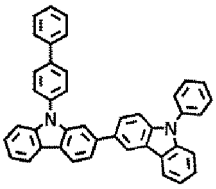
H-H21

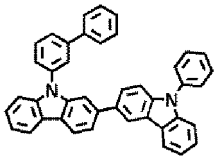
H-H22

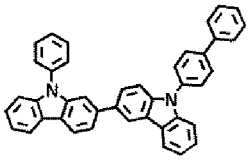
H-H23

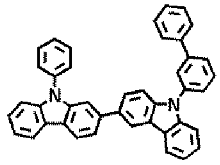
H-H24

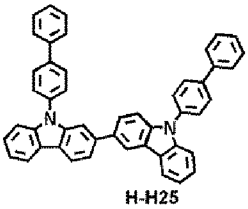
H-H25

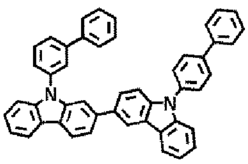
H-H26

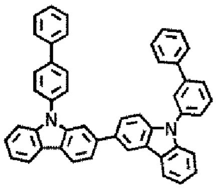
H-H27

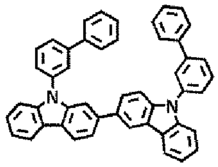
H-H28

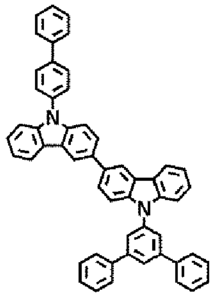

H-H29

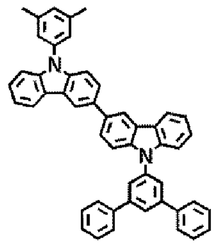

H-H30

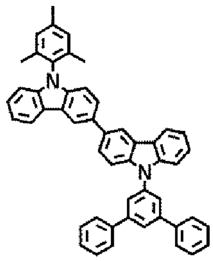

H-H31

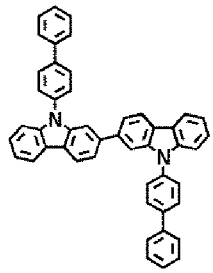

H-H32

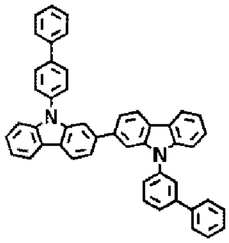

H-H33

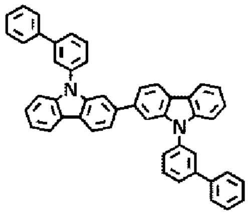

H-H34

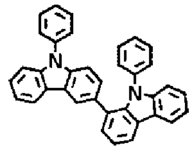

H-H35

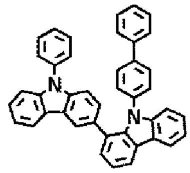

H-H36

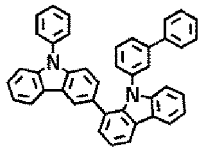

H-H37

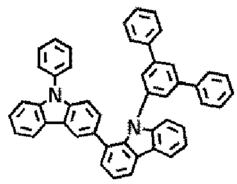

H-H38

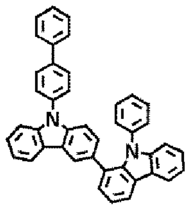

H-H39

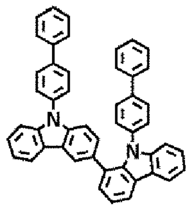

H-H40

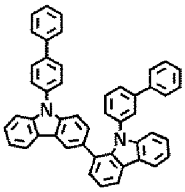

H-H41

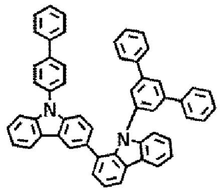

H-H42

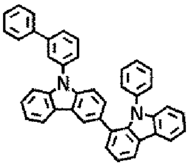

H-H43

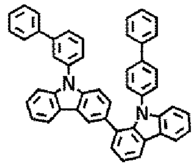

H-H44

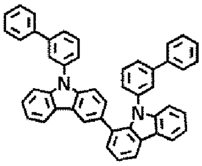

H-H45

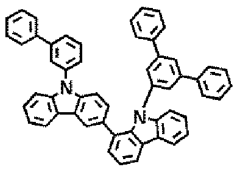

H-H46

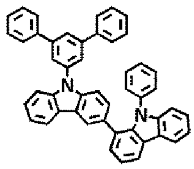

H-H47

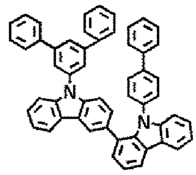

H-H48

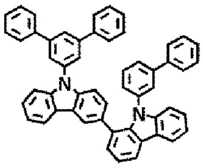

H-H49

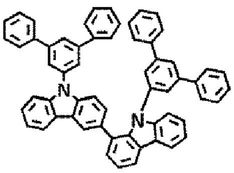

H-H50

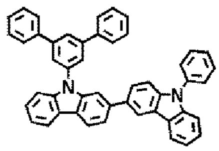

H-H51

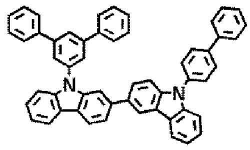

H-H52

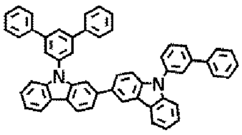

H-H53

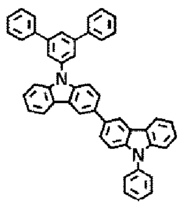

H-H54

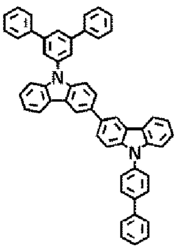

H-H55

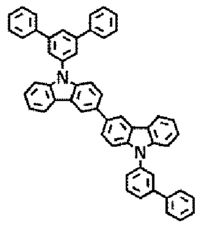

H-H56

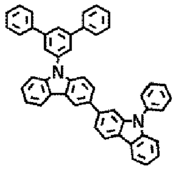

H-H57

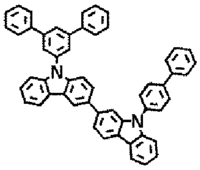

H-H58

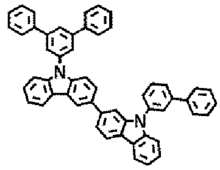

H-H59

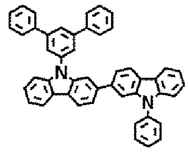

H-H60

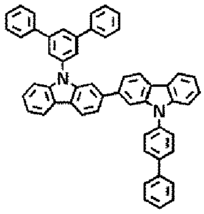

H-H61

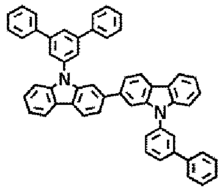

H-H62

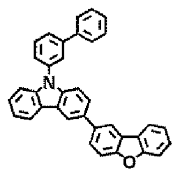

H-H63

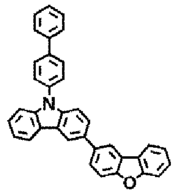

H-H64

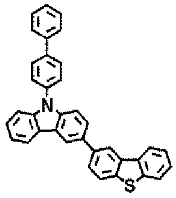
H-H65

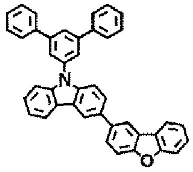
H-H66

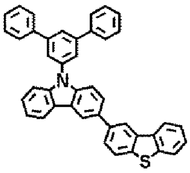
H-H67

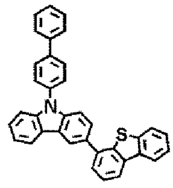
H-H68

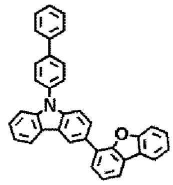
H-H69

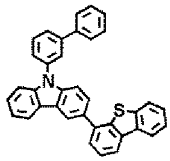
H-H70

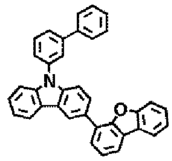
H-H71

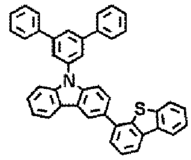
H-H72

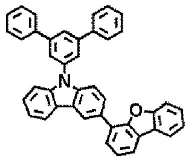
H-H73

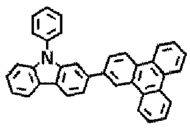
H-H74

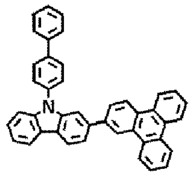
H-H75

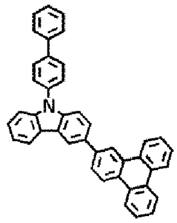
H-H76

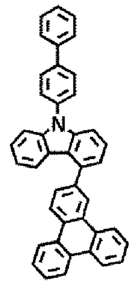
H-H77

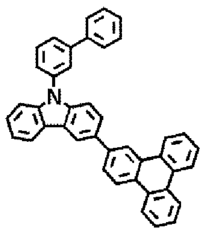
H-H78

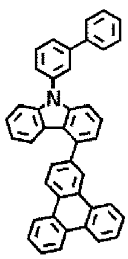
H-H79

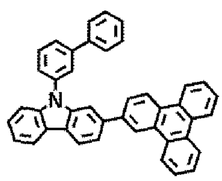
H-H80

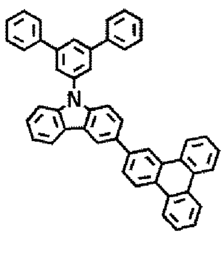
H-H81

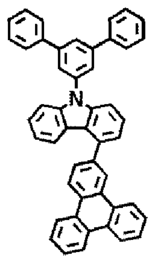
H-H82

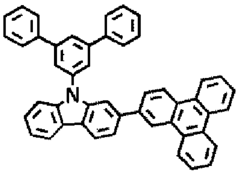
H-H83

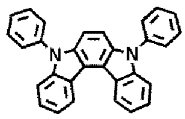
H-H84

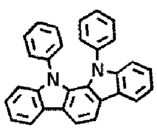
H-H85

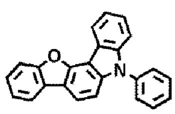
H-H86

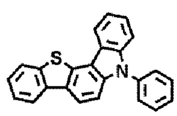
H-H87

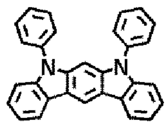

H-H88

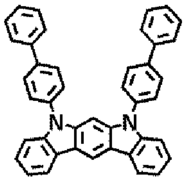

H-H89

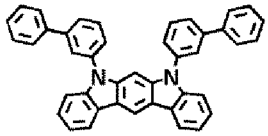

H-H90

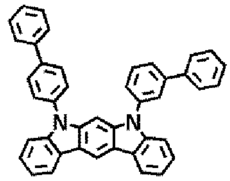

H-H91

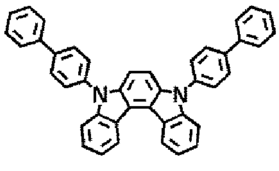

H-H92

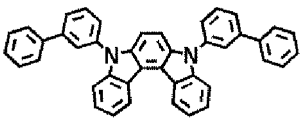

H-H93

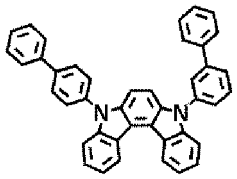

H-H94

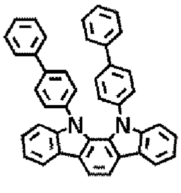

H-H95

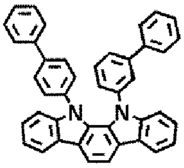

H-H96

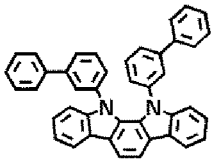

H-H97

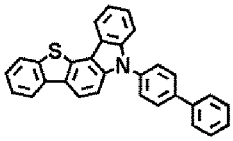

H-H98

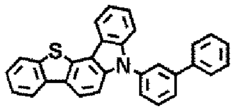

H-H99

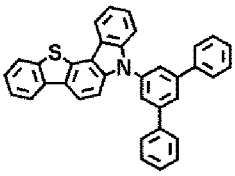

H-H100

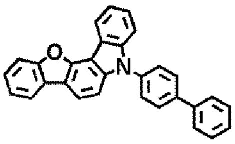

H-H101

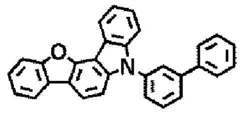

H-H102

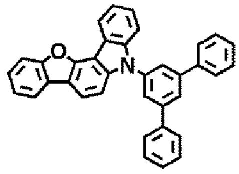

H-H103

In some embodiments, the hole transporting host may include o-CBP, mCP or Compound HT host:

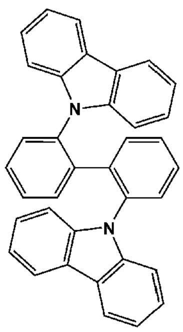

o-CBP

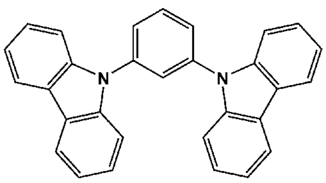

mCP

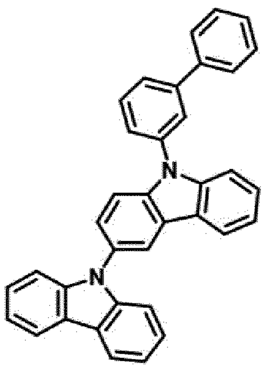

HT host

In some embodiments, the bipolar host may be a compound represented by one of Group HEH1, but embodiments are not limited thereto:

## Group HEH1

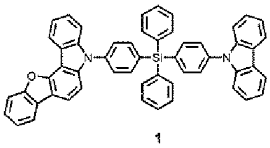
1

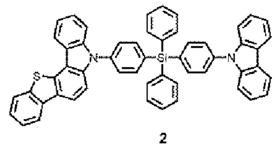
2

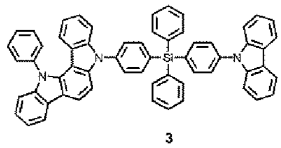
3

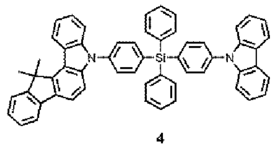
4

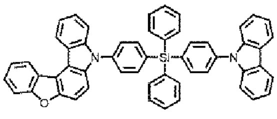
5

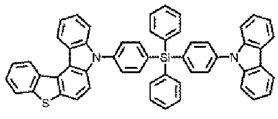
6

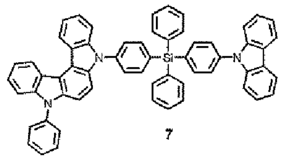
7

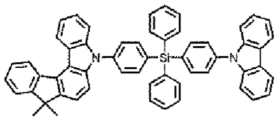
8

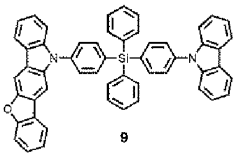
9

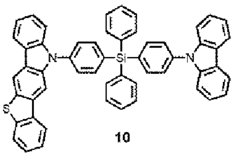
10

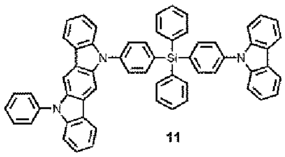
11

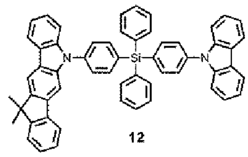
12

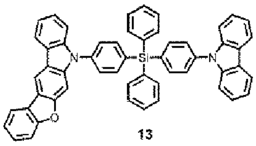
13

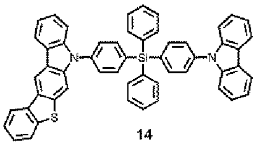
14

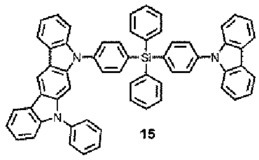
15

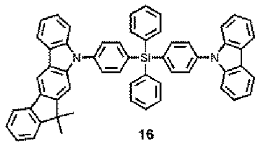
16

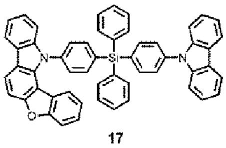
17

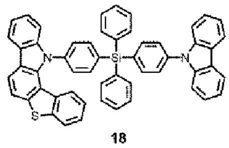
18

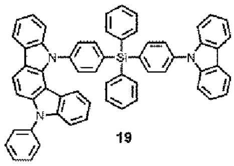
19

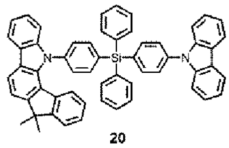
20

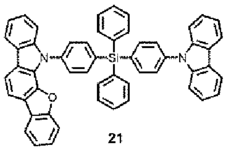
21

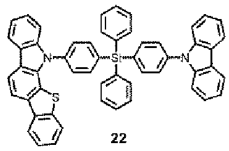
22

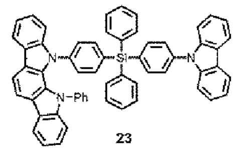
23

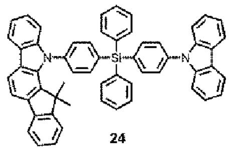
24

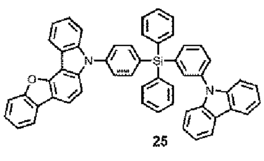
25

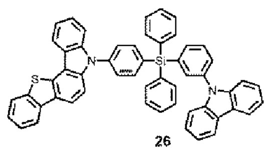
26

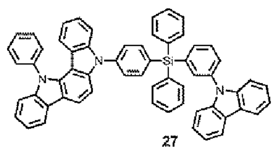
27

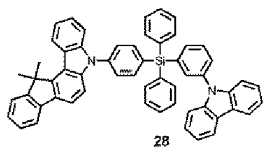
28

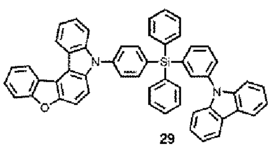
29

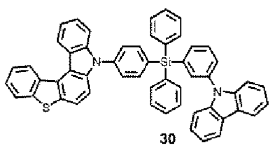
30

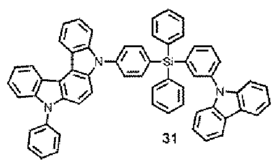
31

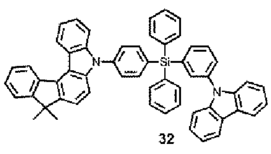
32

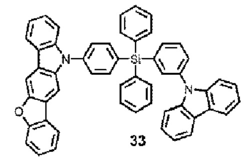
33

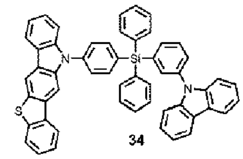
34

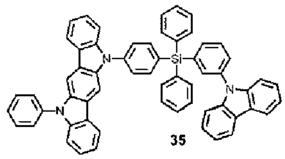
35

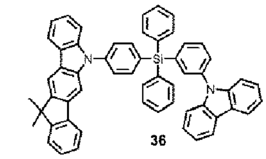
36

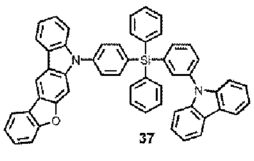
37

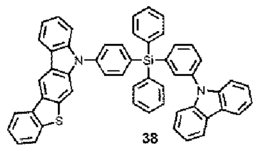
38

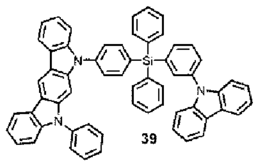
39

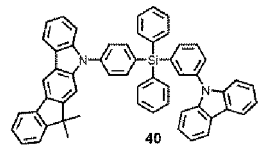
40

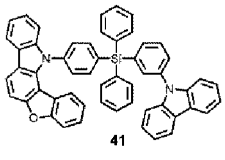
41

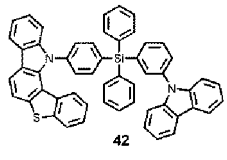
42

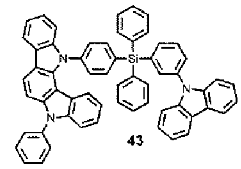
43

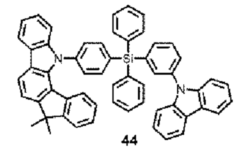
44

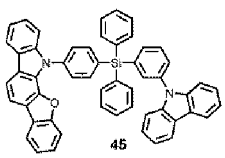
45

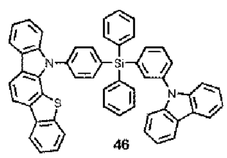
46

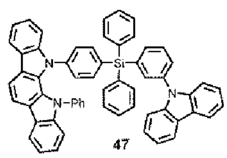
47

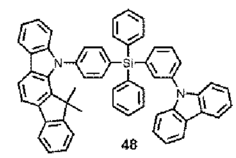
48

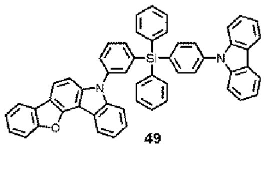
49

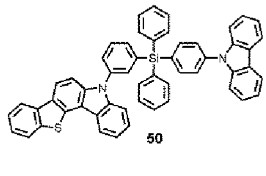
50

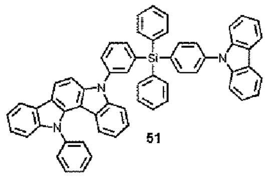
51

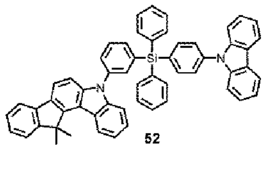
52

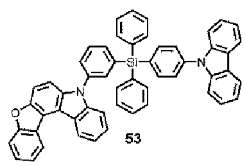
53

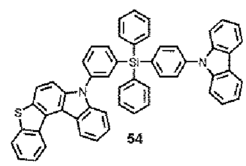
54

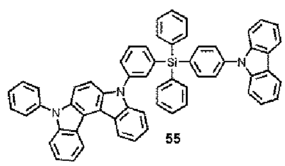
55

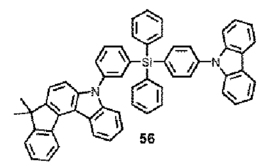
56

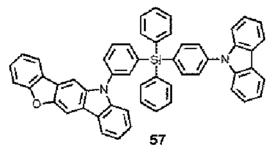
57

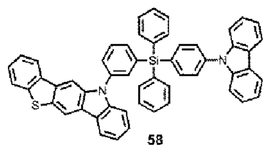
58

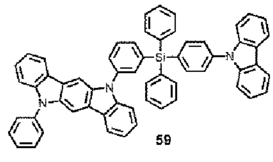
59

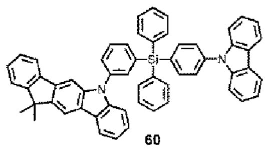
60

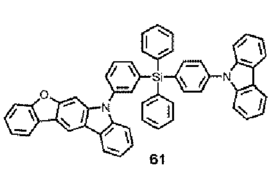
61

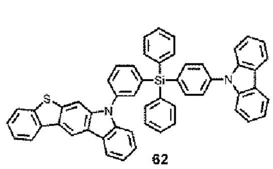
62

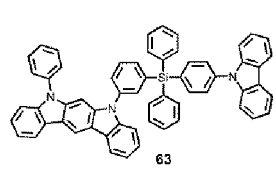
63

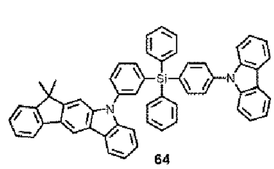
64

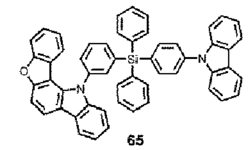
65
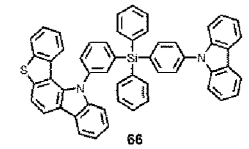
66
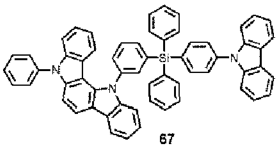
67
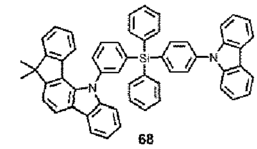
68

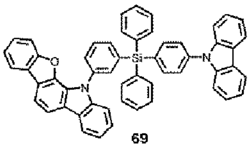
69
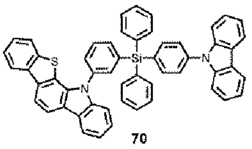
70
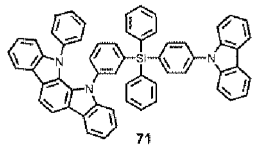
71
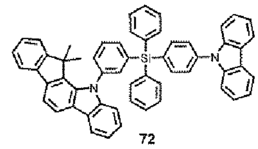
72

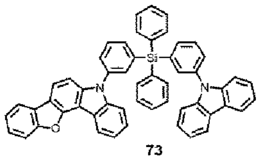
73
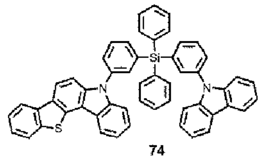
74
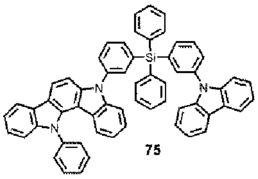
75
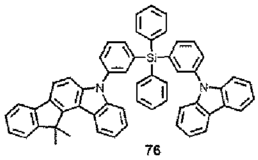
76

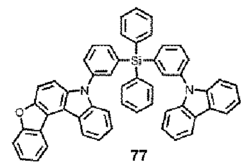
77
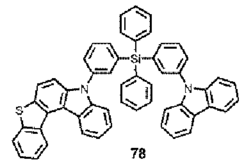
78
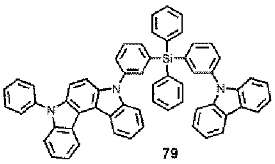
79
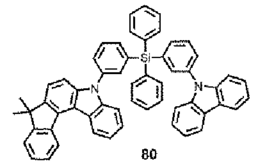
80

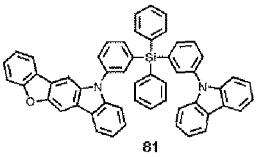
81
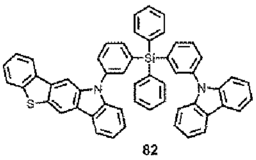
82
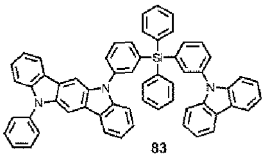
83
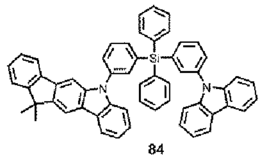
84

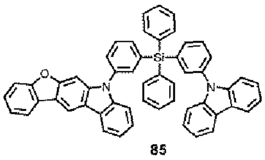
85
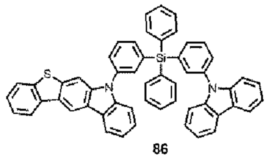
86
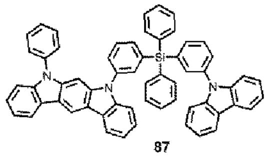
87
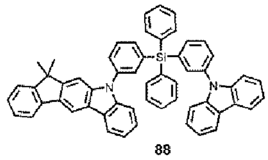
88

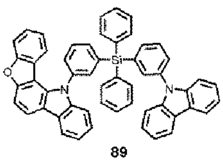
89
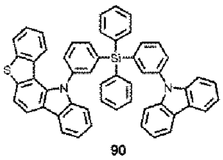
90
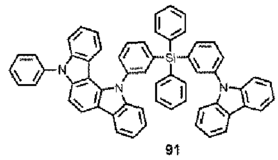
91
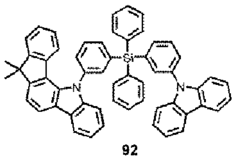
92

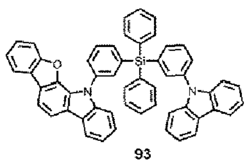
93
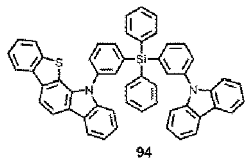
94
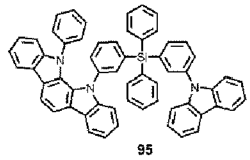
95
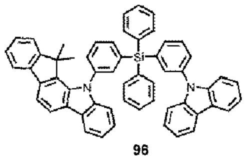
96

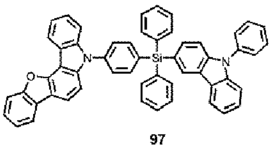
97
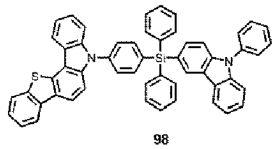
98
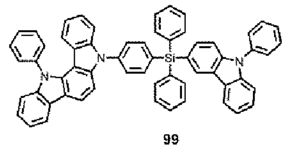
99
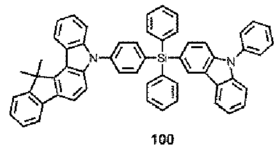
100

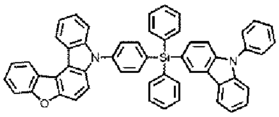
101
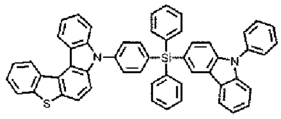
102
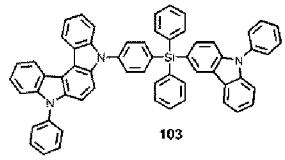
103
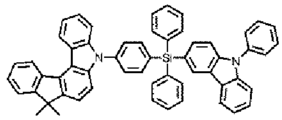
104

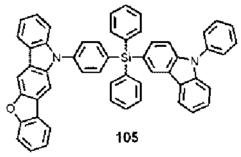
105
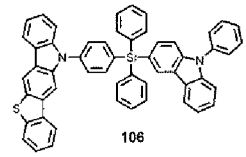
106
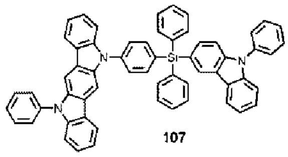
107
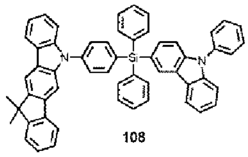
108

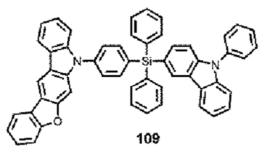
109
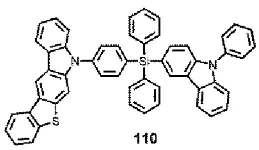
110
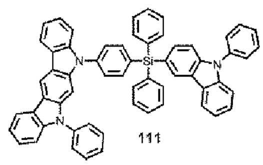
111
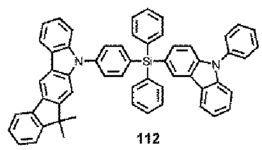
112

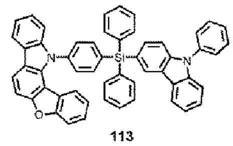
113
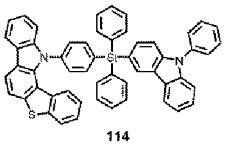
114
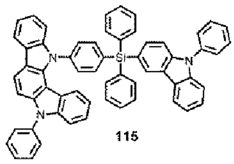
115
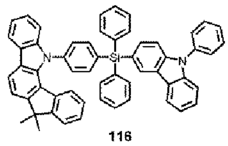
116

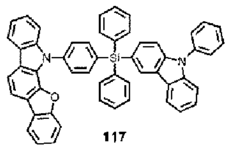
117
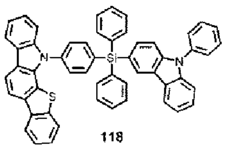
118
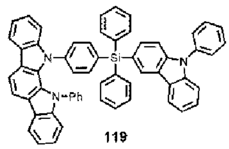
119
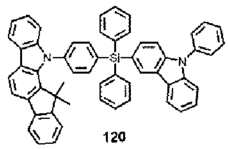
120

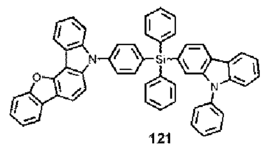
121
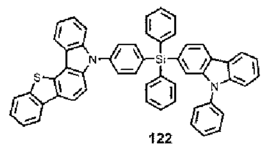
122
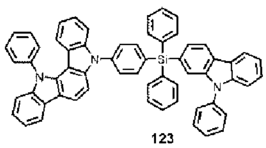
123
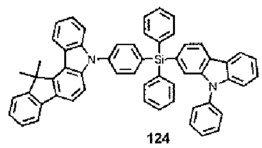
124

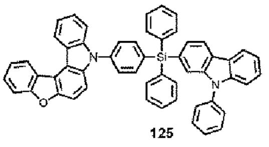
125
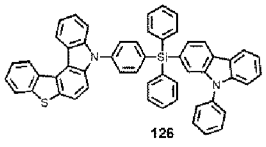
126
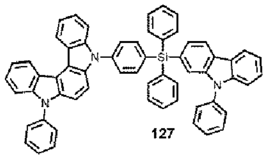
127
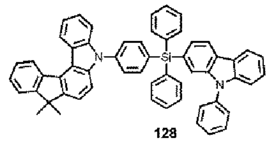
128

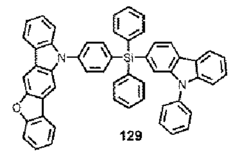
129

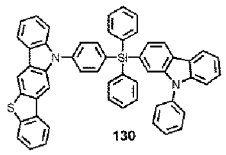
130

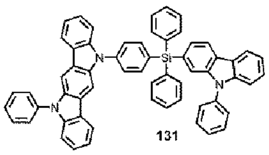
131

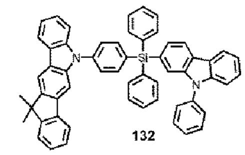
132

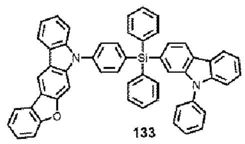
133

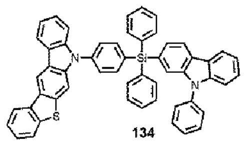
134

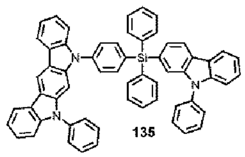
135

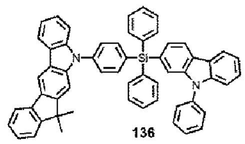
136

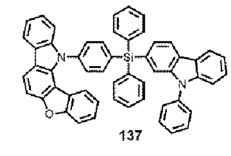
137

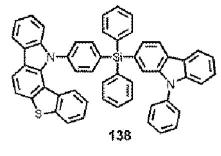
138

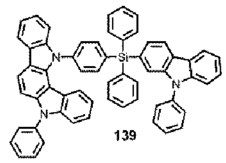
139

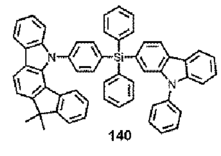
140

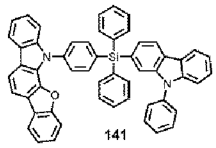
141

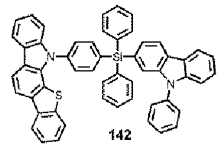
142

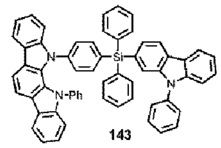
143

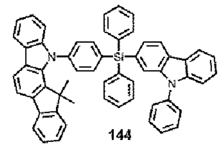
144

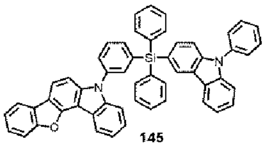
145

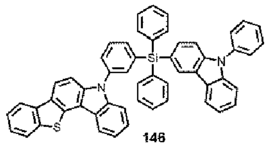
146

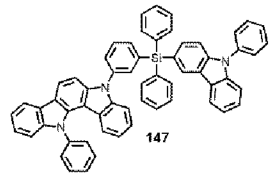
147

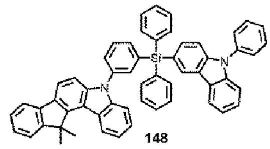
148

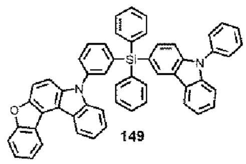
149

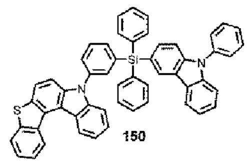
150

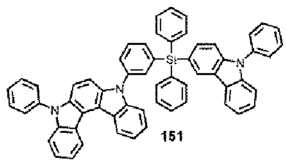
151

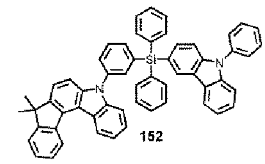
152

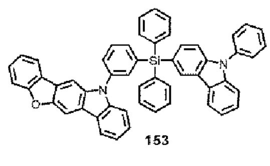
153

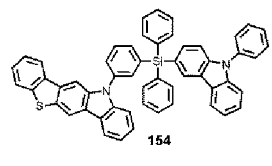
154

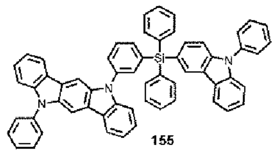
155

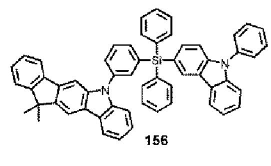
156

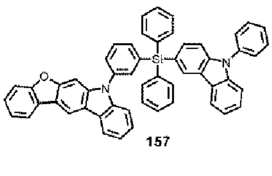
157

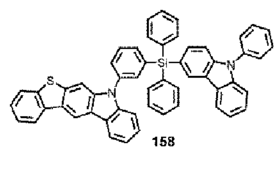
158

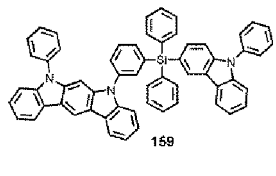
159

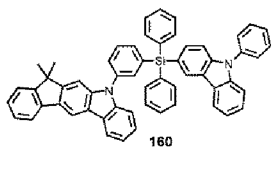
160

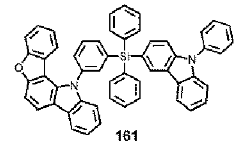
161

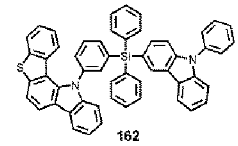
162

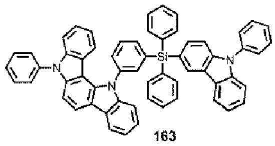
163

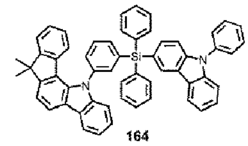
164

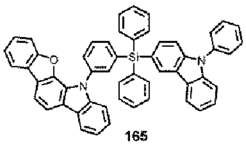
165

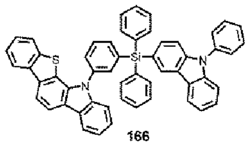
166

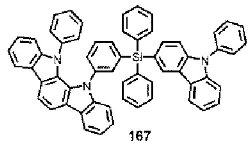
167

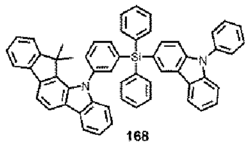
168

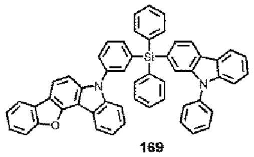
169

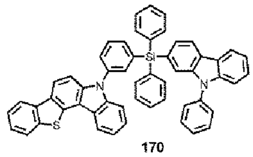
170

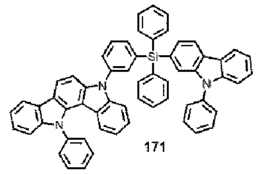
171

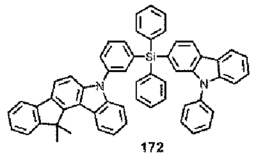
172

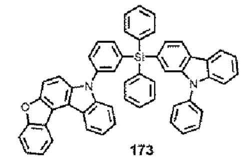
173

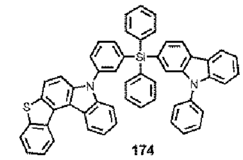
174

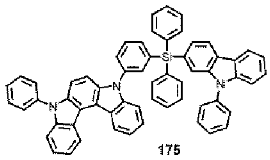
175

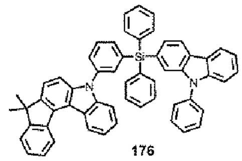
176

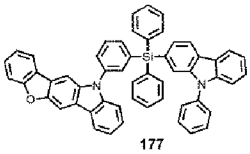
177

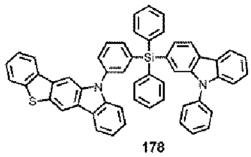
178

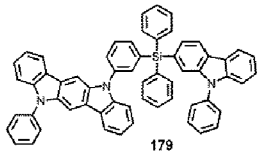
179

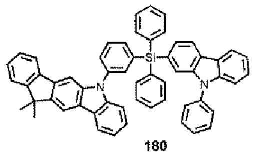
180

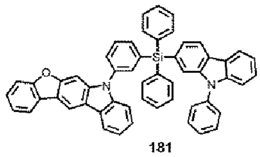
181

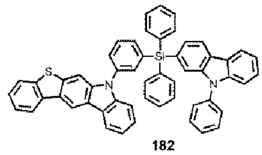
182

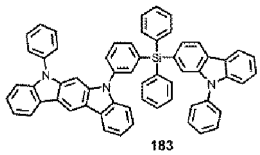
183

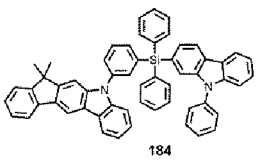
184

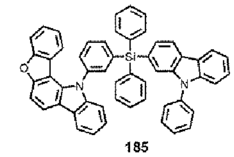
185

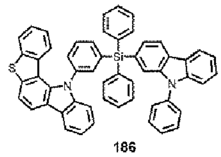
186

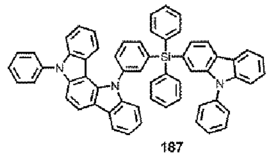
187

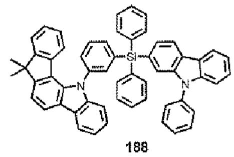
188

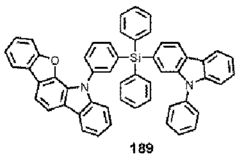
189

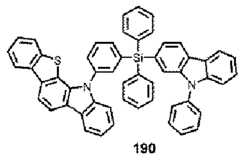
190

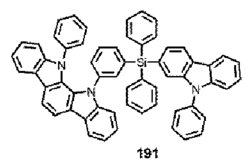
191

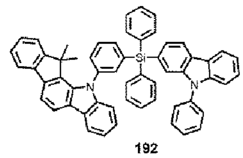
192

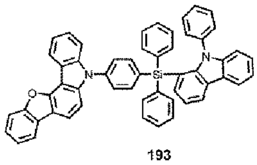
193
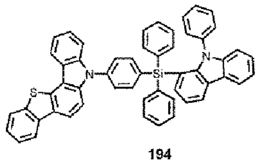
194
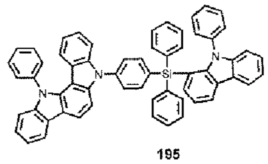
195
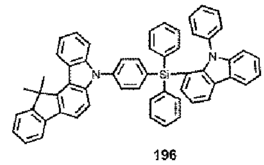
196
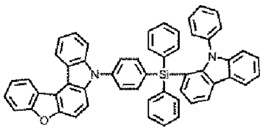
197
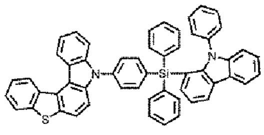
198
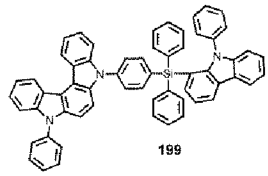
199
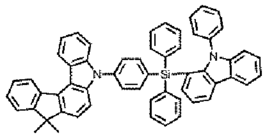
200
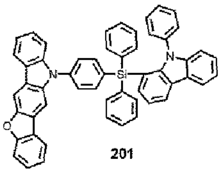
201
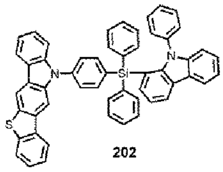
202
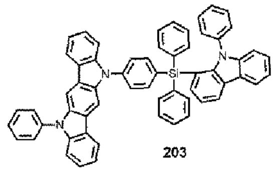
203
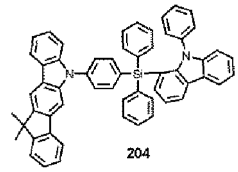
204
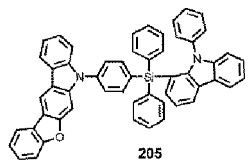
205
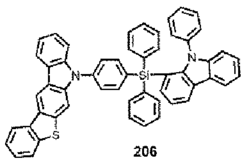
206
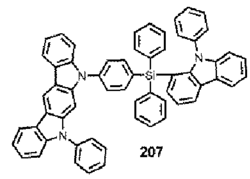
207
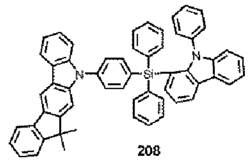
208
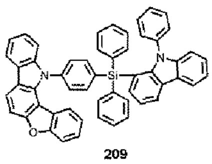
209
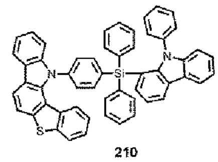
210
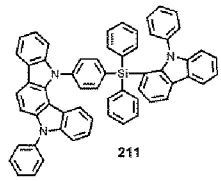
211
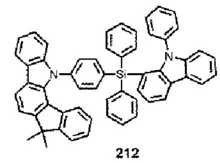
212
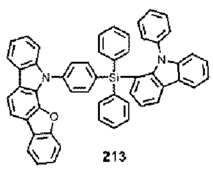
213
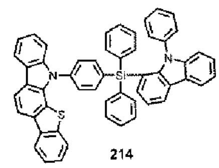
214
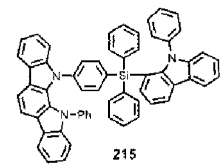
215
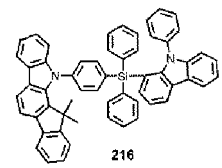
216
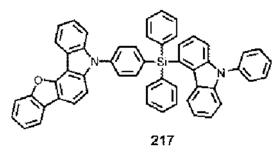
217
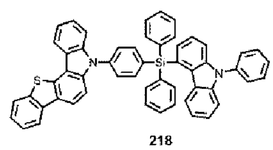
218
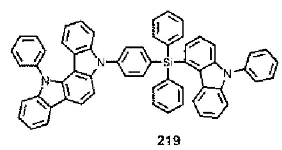
219
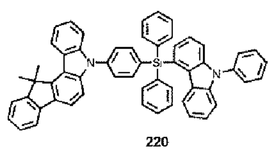
220
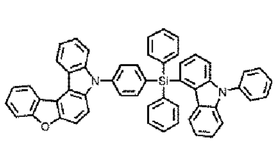
221
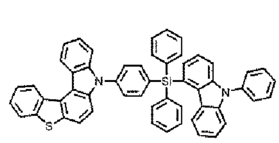
222
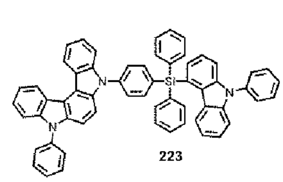
223
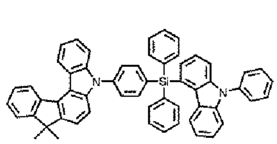
224

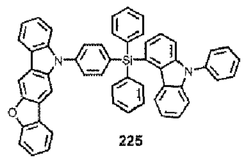
225
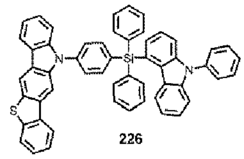
226
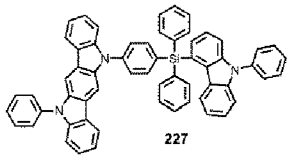
227
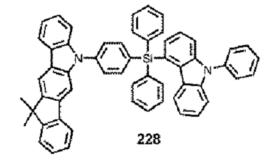
228

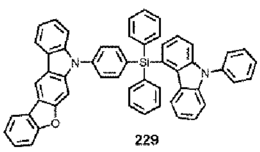
229
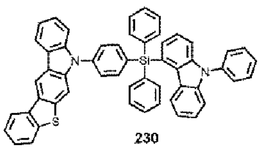
230
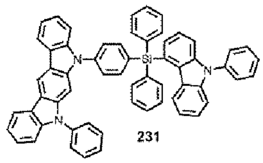
231
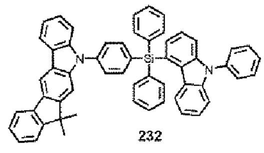
232

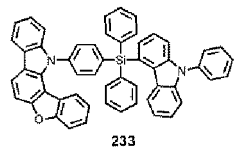
233
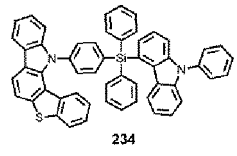
234
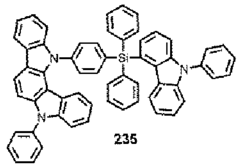
235
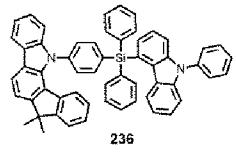
236

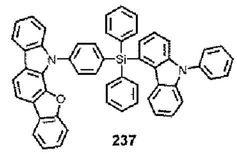
237
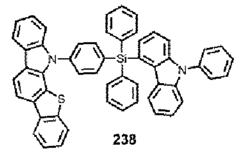
238
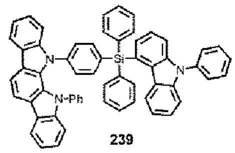
239
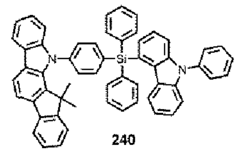
240

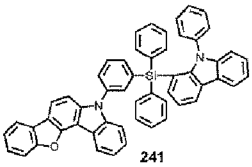
241
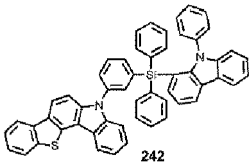
242
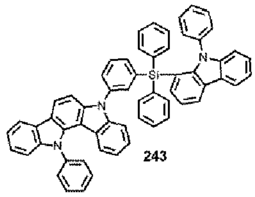
243
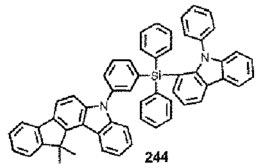
244

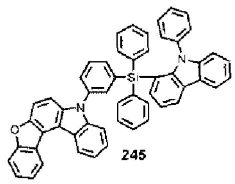
245
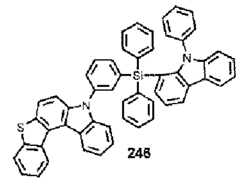
246
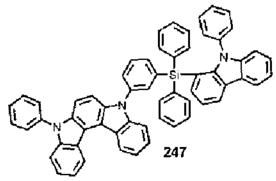
247
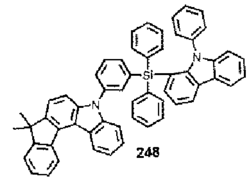
248

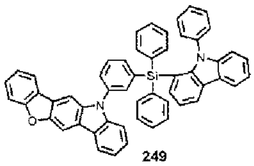
249
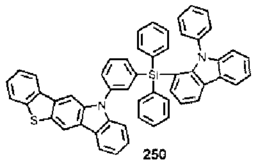
250
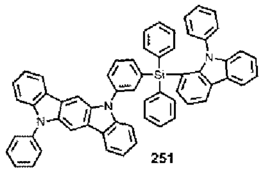
251
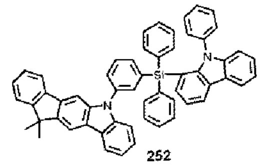
252

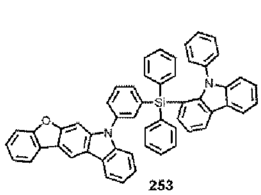
253
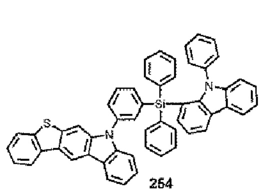
254
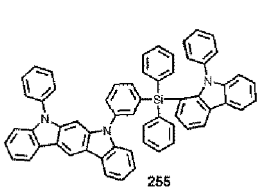
255
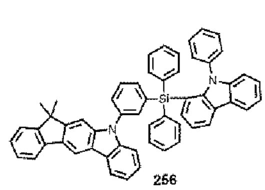
256

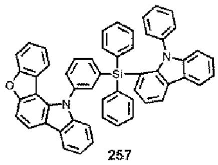
257
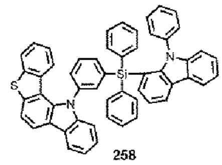
258
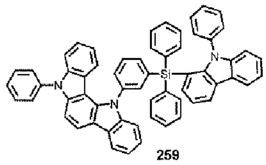
259
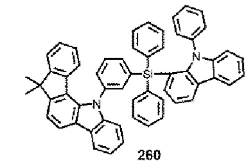
260

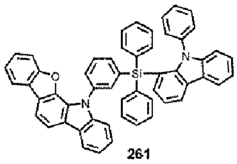
261
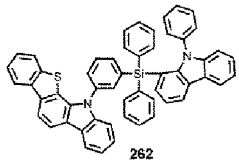
262
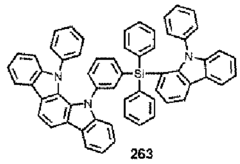
263
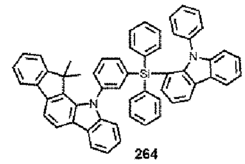
264

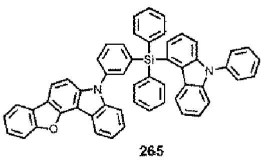
265
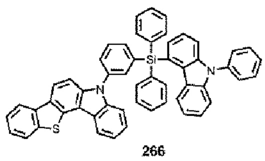
266
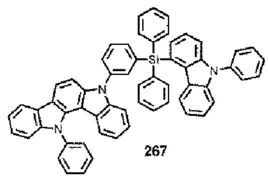
267
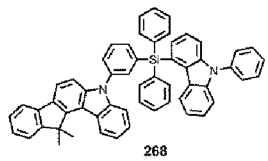
268

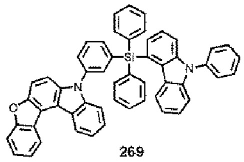
269
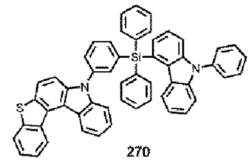
270
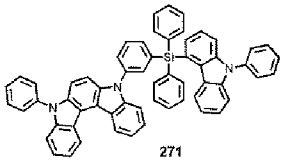
271
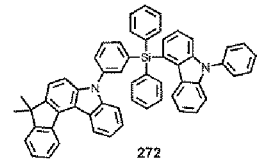
272

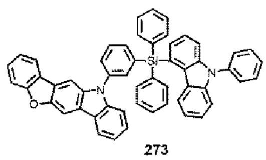
273
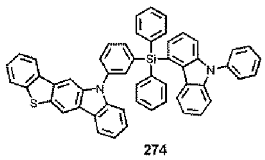
274
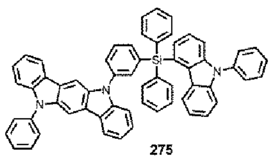
275
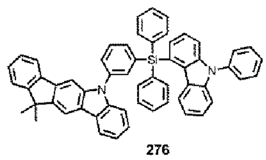
276

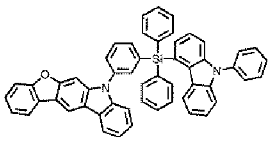
277
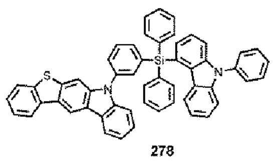
278
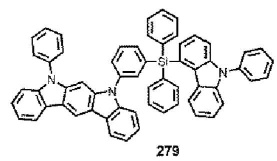
279
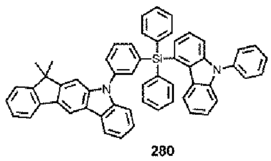
280

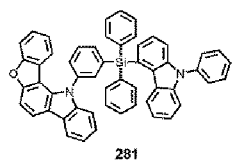
281
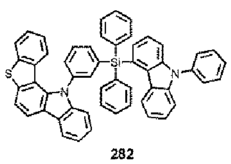
282
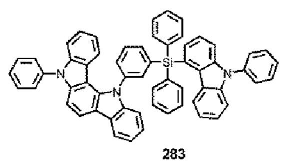
283
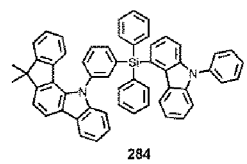
284

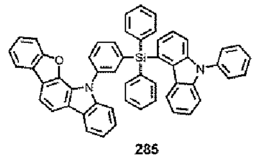
285
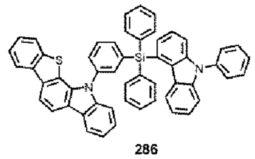
286
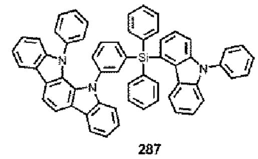
287
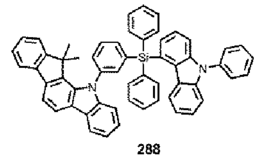
288

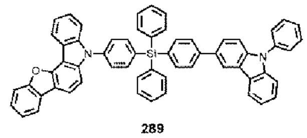
289

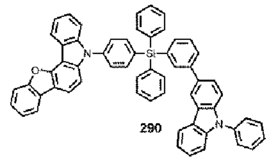
290

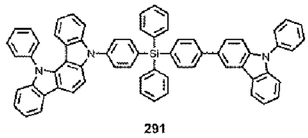
291

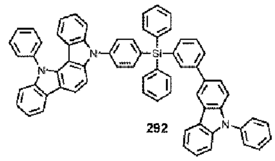
292

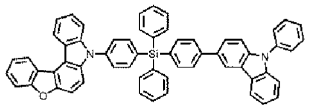
293

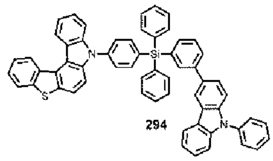
294

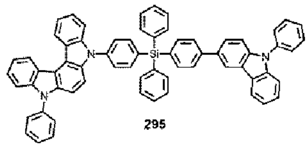
295

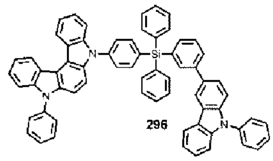
296

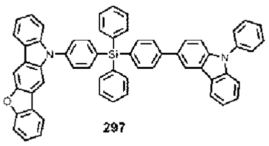
297

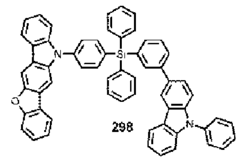
298

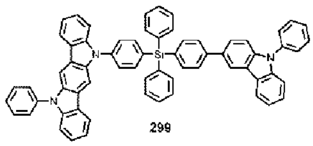
299

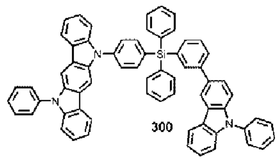
300

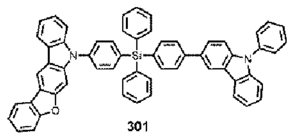
301

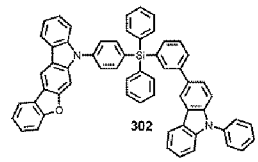
302

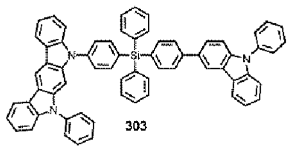
303

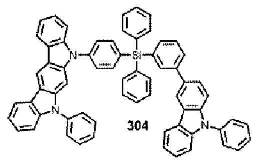
304

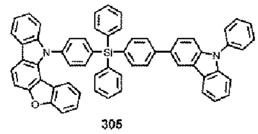
305

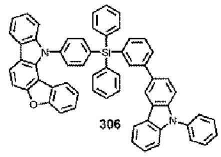
306

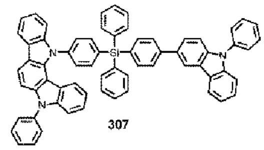
307

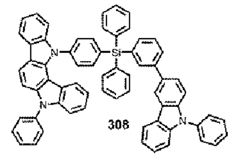
308

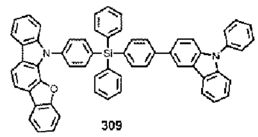
309

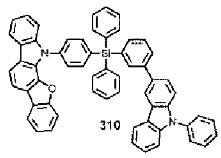
310

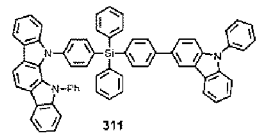
311

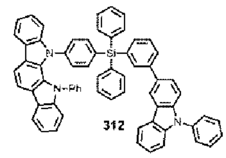
312

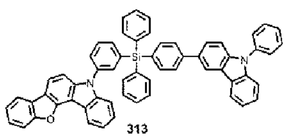
313

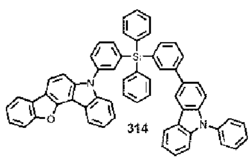
314

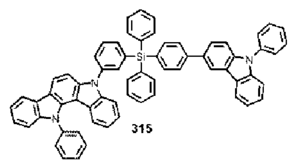
315

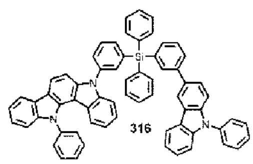
316

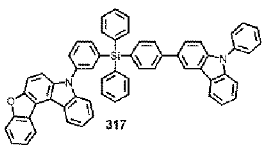
317

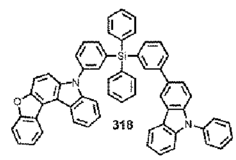
318

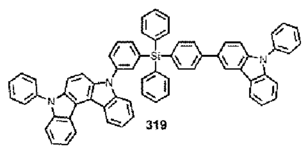
319

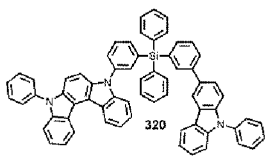
320

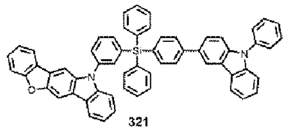
321

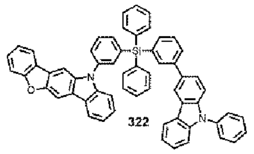
322

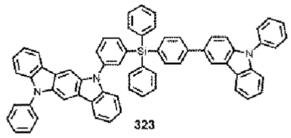
323

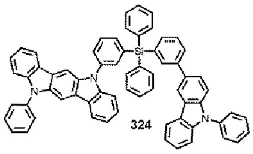
324

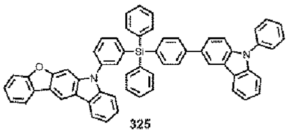
325

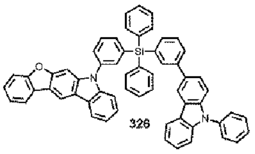
326

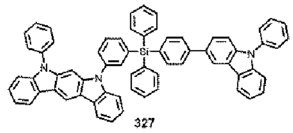
327

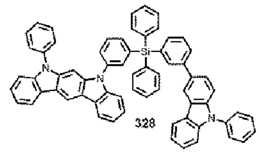
328

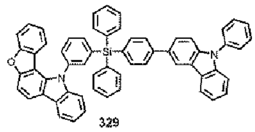
329

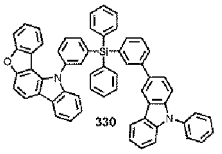
330

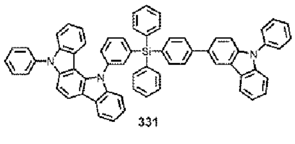
331

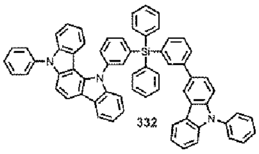
332

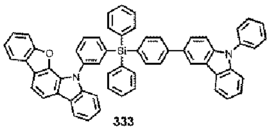
333

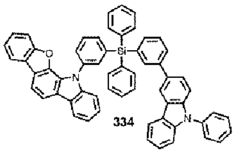
334

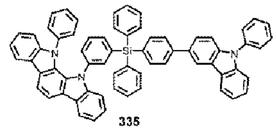
335

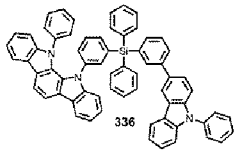
336

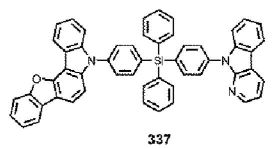
337

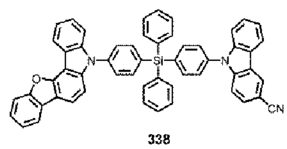
338

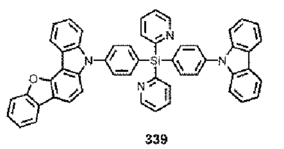
339

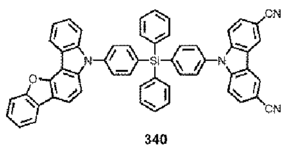
340

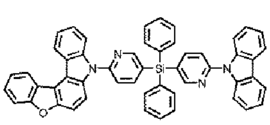
341

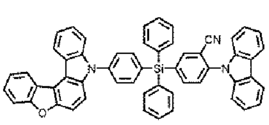
342

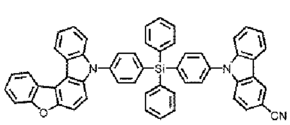
343

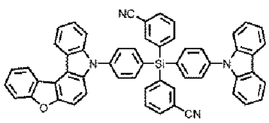
344

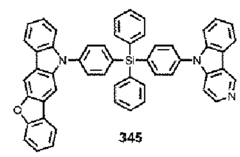
345

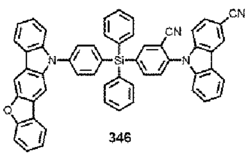
346

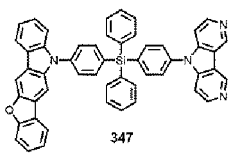
347

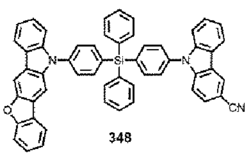
348

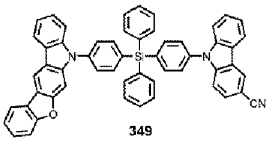
349

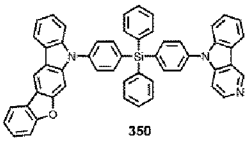
350

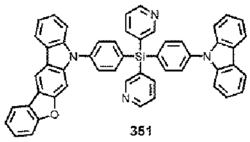
351

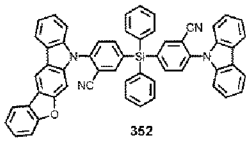
352

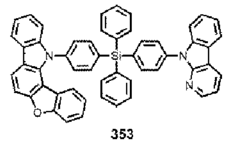
353
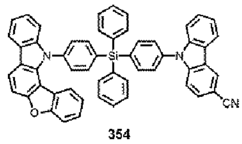
354
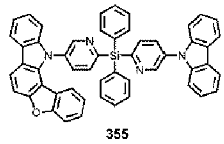
355
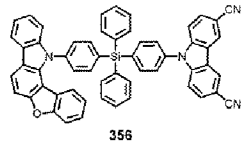
356

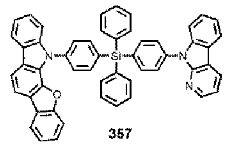
357
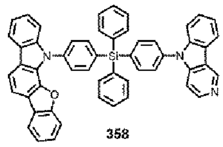
358
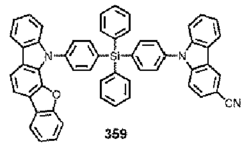
359
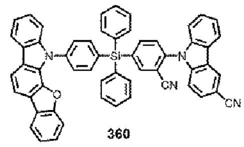
360

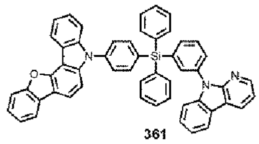
361
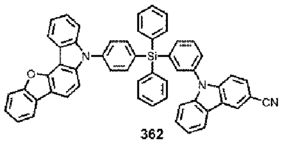
362
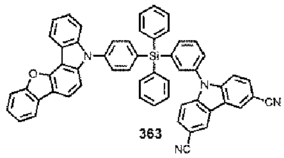
363
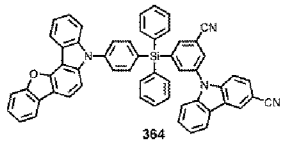
364

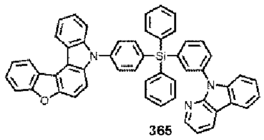
365
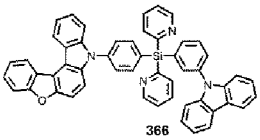
366
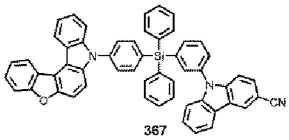
367
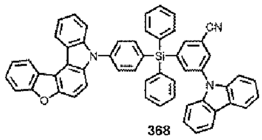
368

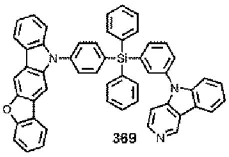
369
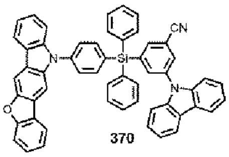
370
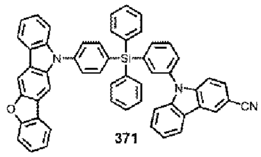
371
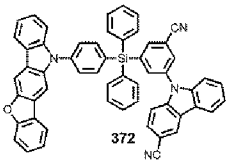
372

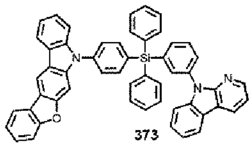
373
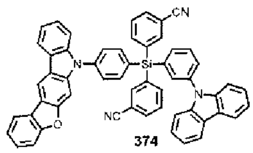
374
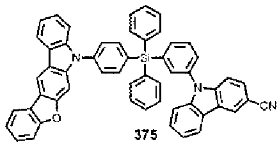
375
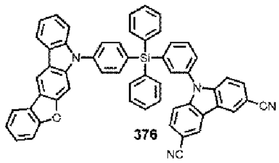
376

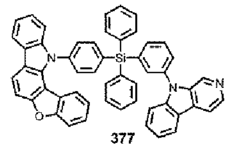
377
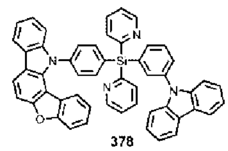
378
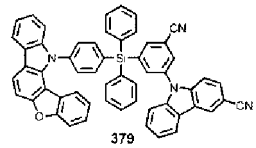
379
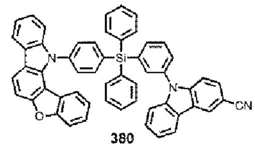
380

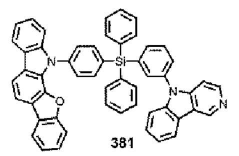
381
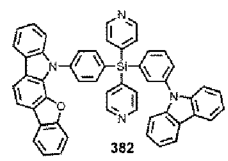
382
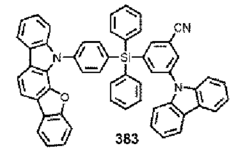
383
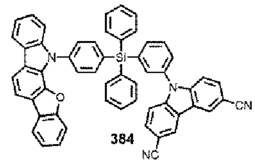
384

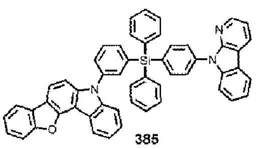
385

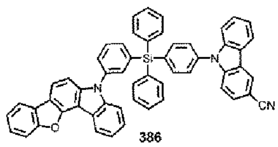
386

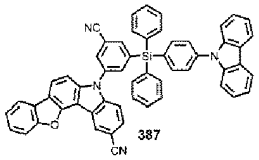
387

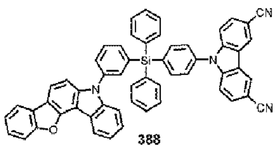
388

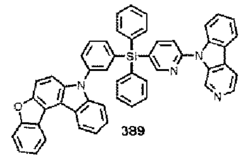
389

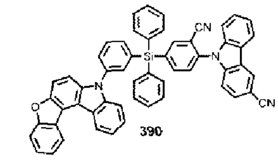
390

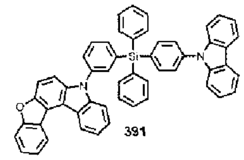
391

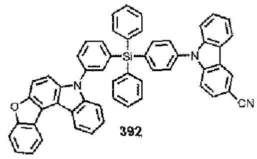
392

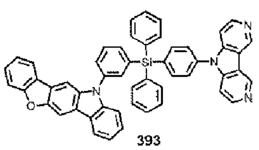
393

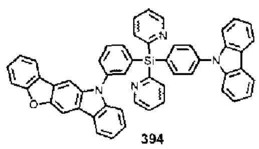
394

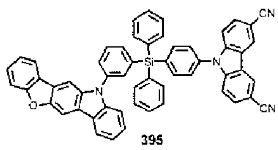
395

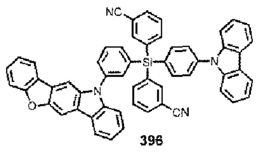
396

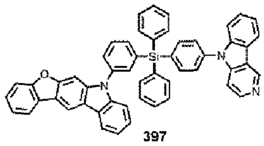
397

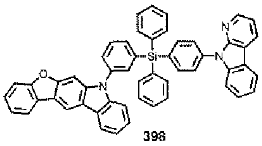
398

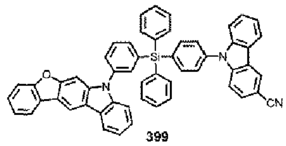
399

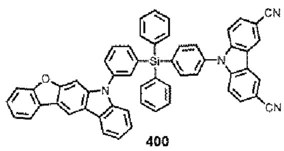
400

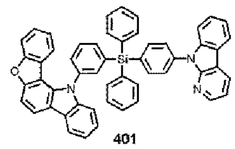
401

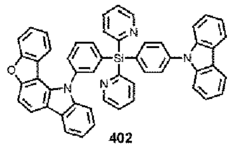
402

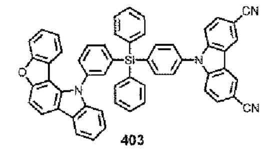
403

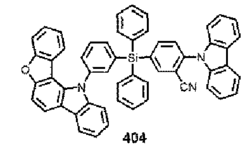
404

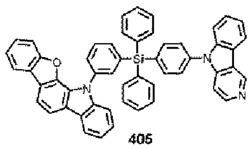
405

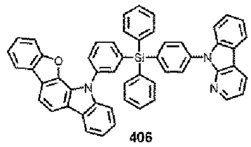
406

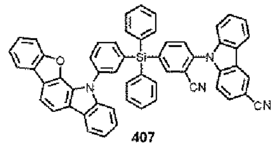
407

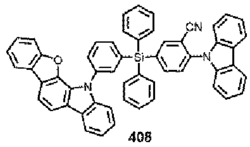
408

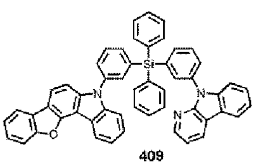
409

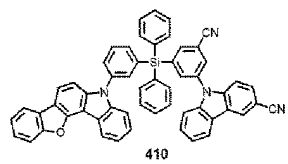
410

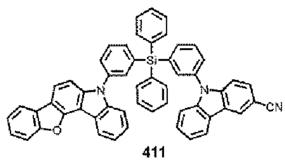
411

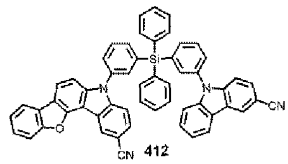
412

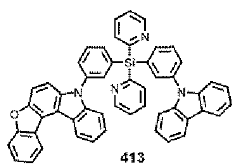
413

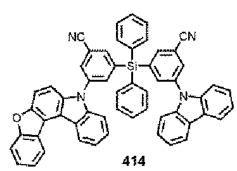
414

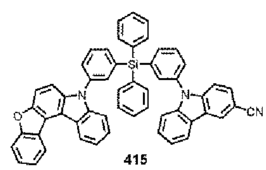
415

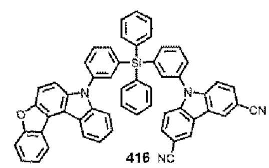
416

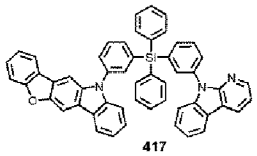
417
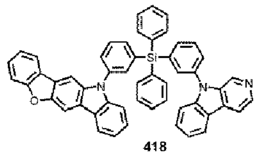
418
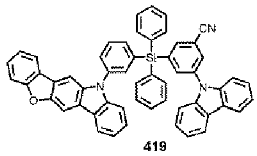
419
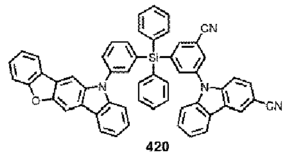
420

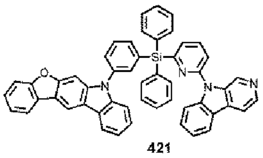
421
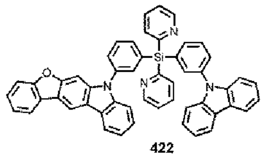
422
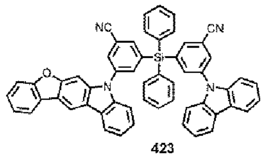
423
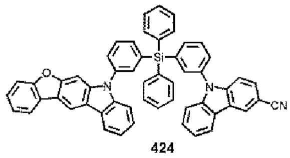
424

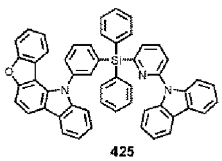
425
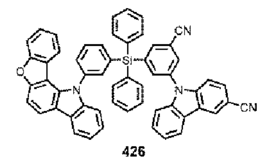
426
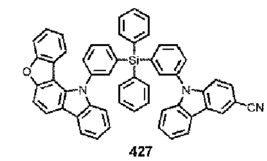
427
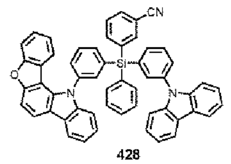
428

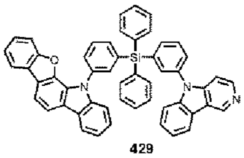
429
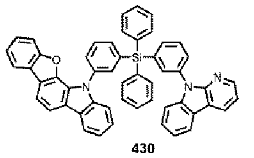
430
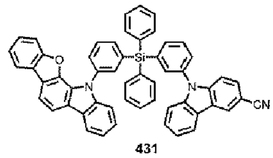
431
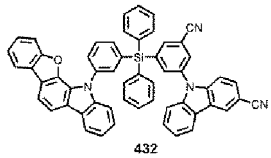
432

wherein in Compounds 1 to 432,
"Ph" represents a phenyl group.

A content (i.e., an amount) of the host in the emission layer may be in a range of about 30 wt% to about 90 wt%. When the content of the host in the emission layer is within this range, energy transfer in the emission layer may be effectively occurred. Thus, the organic light-emitting device may have high efficiency and long lifespan.

In some embodiments, when the host includes a first compound and a second compound, the first compound and the second compound may form an exciplex, but embodiments are not limited thereto. When an exciplex is formed, the exciplex may be understood by referring to the description of the host provided herein.

When the host includes a first compound and a second compound, a weight ratio of the first compound to the second compound may be in a range of about 1:9 to about 9:1, for example, about 2:8 to about 8:2, for example, about 4:6 to 6:4, or for example, about 5:5.

In one or more embodiments, the host does not emit light. For example, the host may not emit light.

Emitter

In one or more embodiments, the emitter emits light. For example, the emitter may emit light.

In some embodiments, the emitter may be a fluorescent dopant, a fluorescent dopant that may emit delayed fluorescence, a delayed fluorescent dopant, or a combination thereof. Accordingly, a decay time of the emitter ($T_{decay}$(E)) may be less than 100 microseconds ($\mu$s).

$T_{decay}$(E) may be measured from a time-resolved photoluminescence (TRPL) spectrum at room temperature of a film having a thickness of 40 nanometers (nm) formed by vacuum-depositing the host and the emitter at a weight ratio of 90:10 included in the emission layer on a quartz substrate at a vacuum degree of $10^{-7}$ torr.

The emitter may be a condensed polycyclic compound or a styryl-containing compound.

In some embodiments, the emitter may include a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a picene-containing core, a perylene-containing core, a pentacene-containing core, an indenoanthracene-containing core, a tetracene-containing core, a bisanthracene-containing core, or a core represented by one of Formulae 501-1 to 501-21:

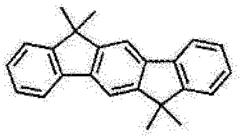

501-1

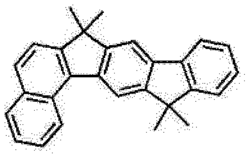

501-2

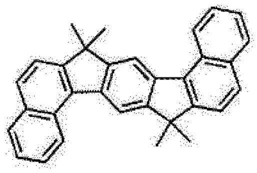

501-3

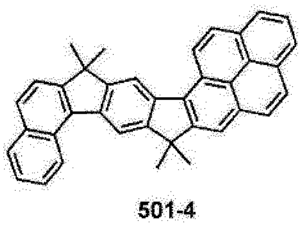

501-4

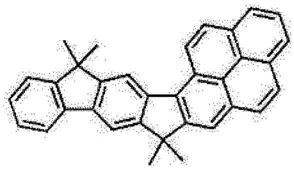

501-5

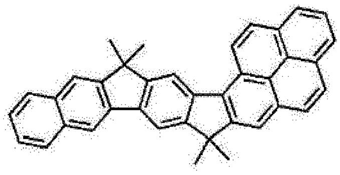

501-6

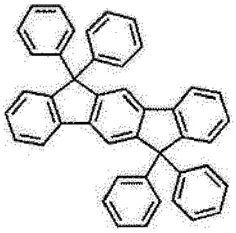

501-7

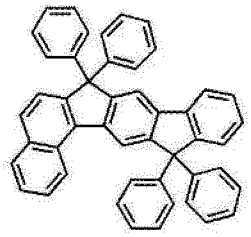

501-8

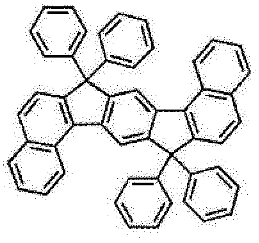

501-9

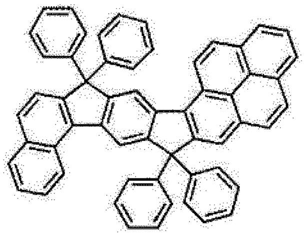

501-10

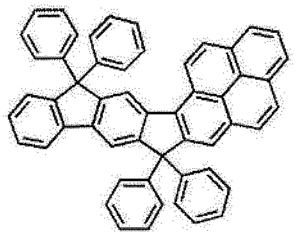

501-11

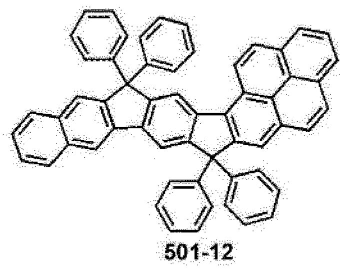

501-12

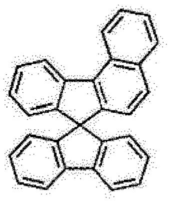

501-13

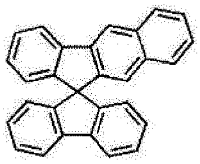

501-14

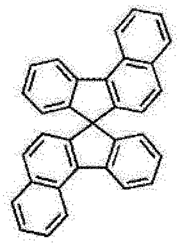

501-15

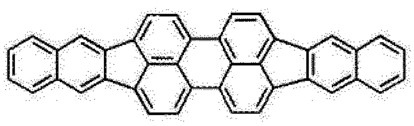

501-16

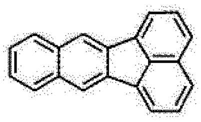

501-17

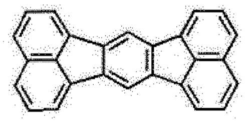

501-18

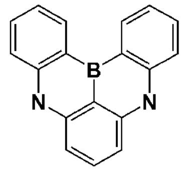

501-19

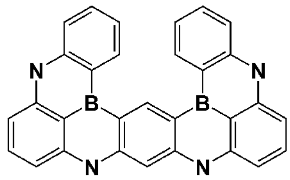

501-20

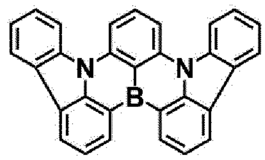

501-21

In some embodiments, the emitter may be represented by Formula 51:

Formula 51

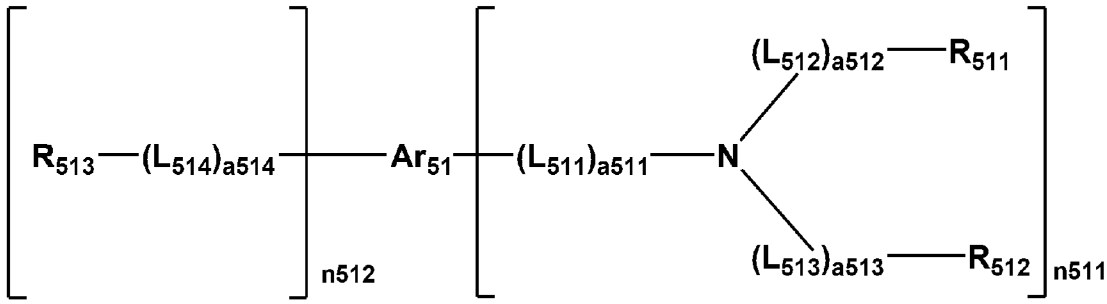

wherein, in Formula 51,

$Ar_{51}$ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a picene group, a perylene group, a pentacene group, an indenoanthracene group, a tetracene group, a bisanthracene group, or a group represented by one of Formulae 501-1 to 501-21, each unsubstituted or substituted with at least one of deuterium, -F, -Cl, -Br, -I, $-SF_5$, a hydroxyl group, a cyano group, a nitro group, an amidino group, a hydrazine group, a hydrazone group, a sulfonic acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -Si(Qs11)(Qs12)(Qs13), -Ge(Qs11)(Qs12)(Qs13), -$C(Q_{511})(Q_{512})(Q_{513})$, $-B(Q_{511})(Q_{512})$, $-N(Q_{511})(Q_{512})$, $-P(Q_{511})(Q_{512})$, $-C(=O)(Q_{511})$, - $S(=O)(Q_{511})$, $-S(=O)_2(Q_{511})$, $-P(=O)(Q_{511})(Q_{512})$, $-P(=S)(Q_{511})(Q_{512})$, or a combination thereof:

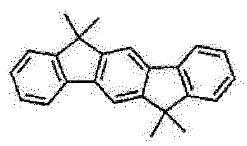

501-1

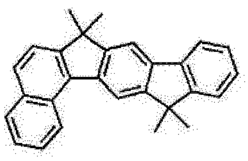

501-2

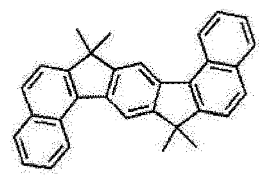

501-3

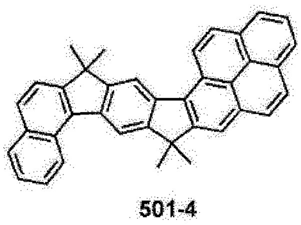

501-4

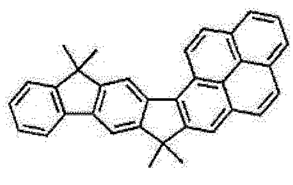

501-5

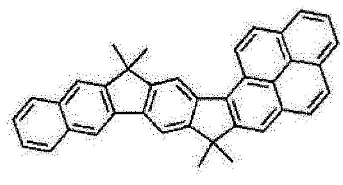

501-6

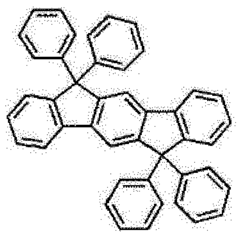
501-7
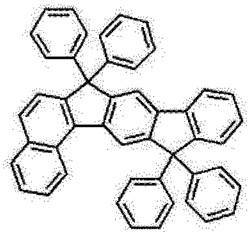
501-8
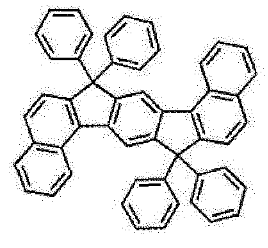
501-9

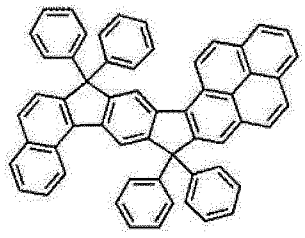
501-10
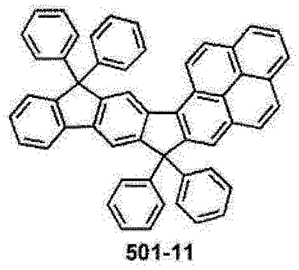
501-11
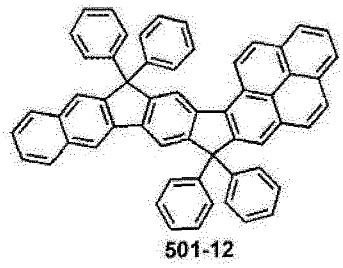
501-12

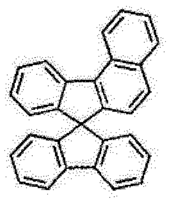
501-13
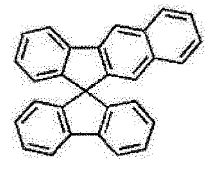
501-14
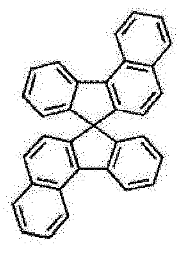
501-15

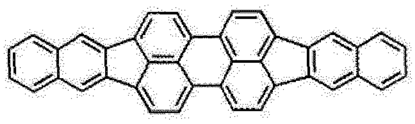
501-16
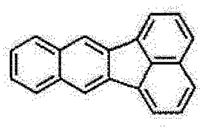
501-17
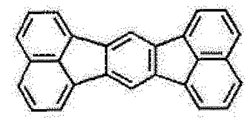
501-18

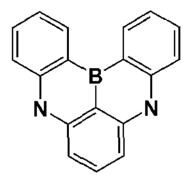
501-19
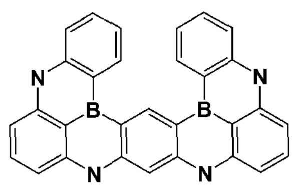
501-20
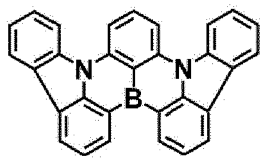
501-21

$L_{511}$ to $L_{514}$ may each independently be a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

a511 to a514 may each independently be 0, 1, 2, or 3,

$R_{511}$ to $R_{513}$ may each independently be a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$

heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group,

wherein $Q_{511}$ to $Q_{513}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, a cyano group, a $C_1$-$C_{20}$ alkyl group, and a $C_6$-$C_{30}$ aryl group, a $C_6$-$C_{60}$ aryl group, or a combination thereof, and n511 and n512 may each independently 0, 1, 2, 3, 4, 5, or 6.

In some embodiments, in Formula 51, a sum of n511 and n512 may be 1 or greater, but embodiments are not limited thereto.

In some embodiments, in Formula 51, $R_{511}$ and $R_{512}$ may each independently be

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof.

In some embodiments, the emitter may be a compound represented by one of Group FD1:

Group FD1

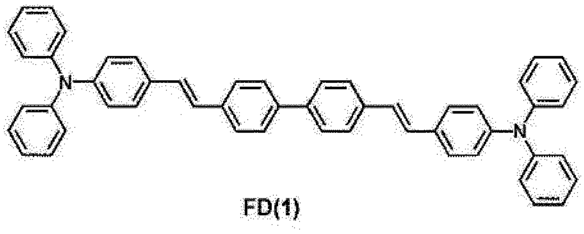

FD(1)

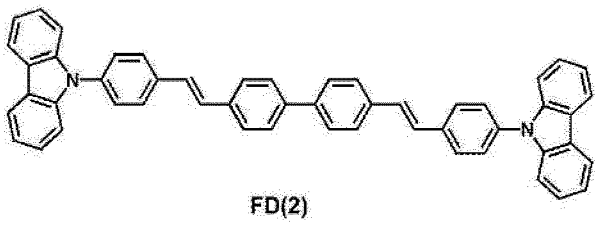

FD(2)

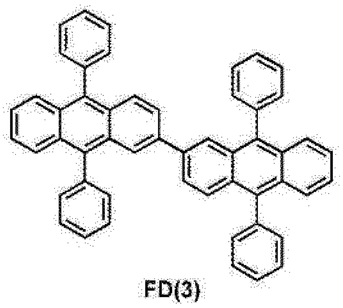

FD(3)

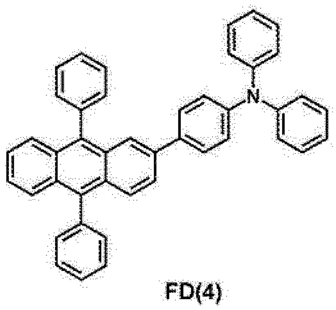

FD(4)

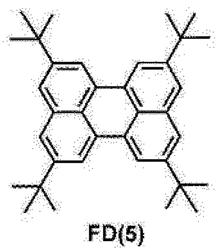

FD(5)

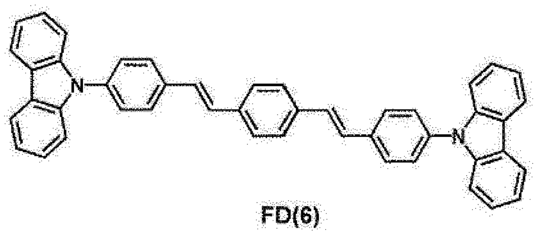

FD(6)

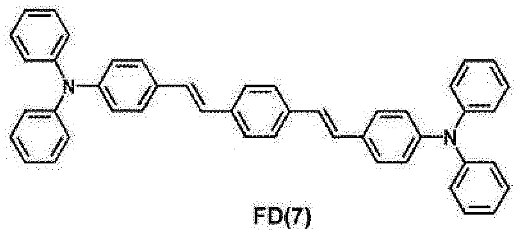

FD(7)

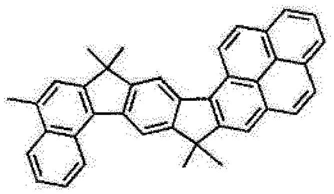

FD(8)

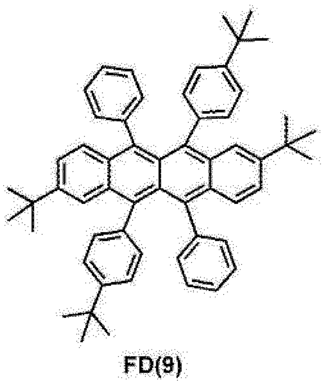

FD(9)

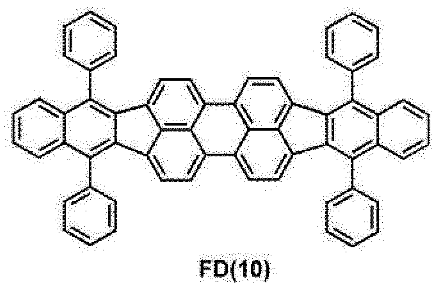

FD(10)

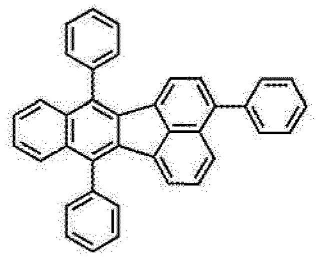

FD(11)

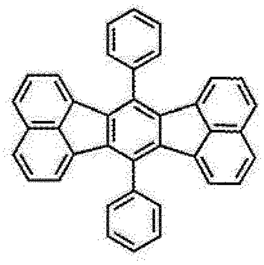

FD(12)

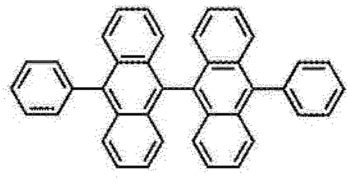

FD(13)

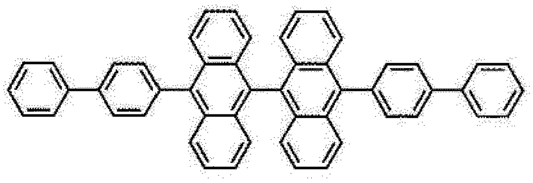

FD(14)

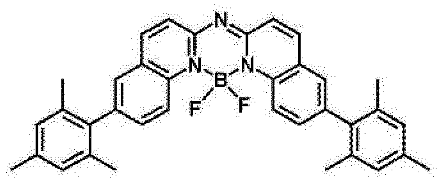

FD(15)

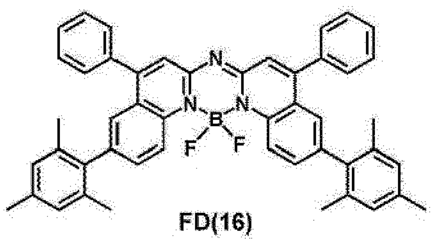

FD(16)

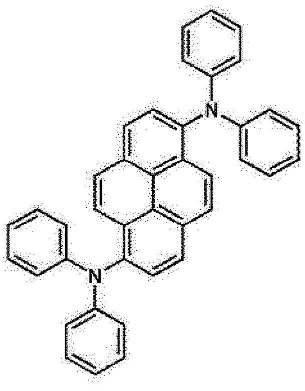

FD1

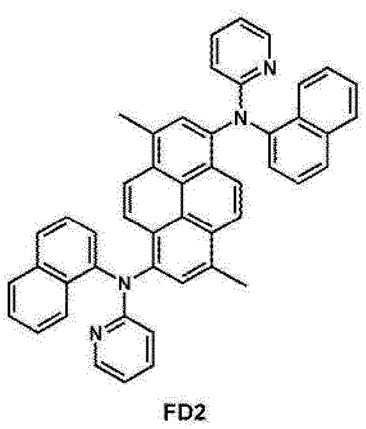

FD2

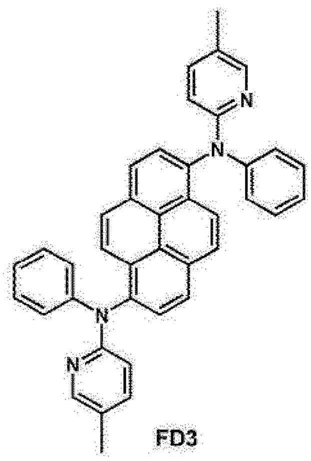

FD3

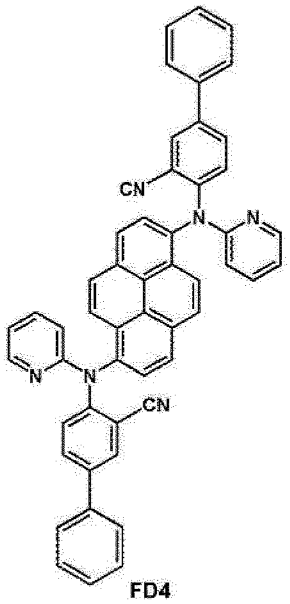

FD4

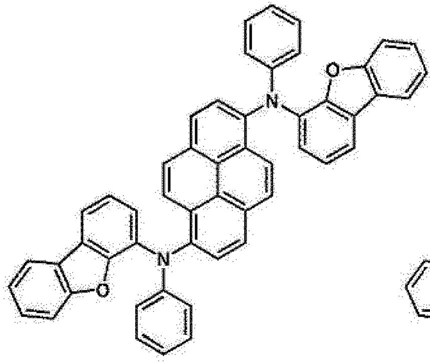

FD5

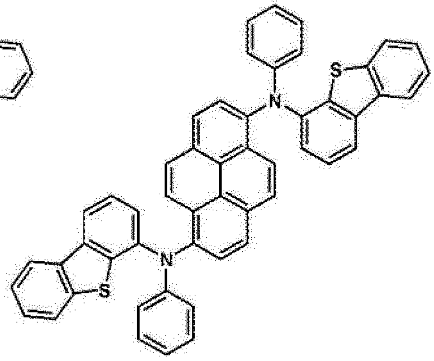

FD6

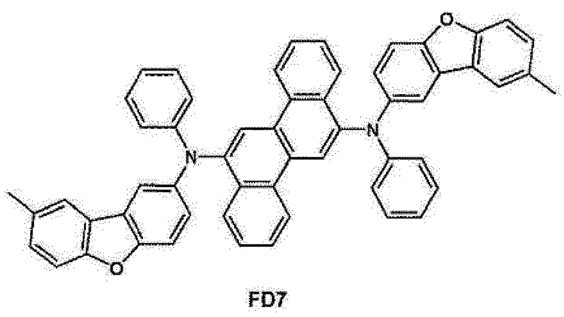

FD7

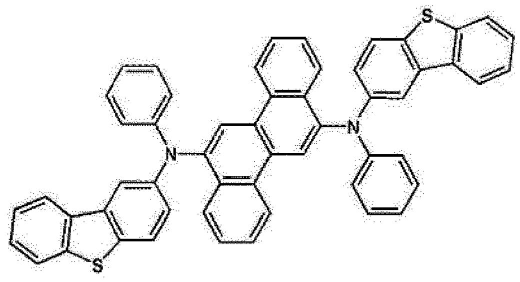

FD8

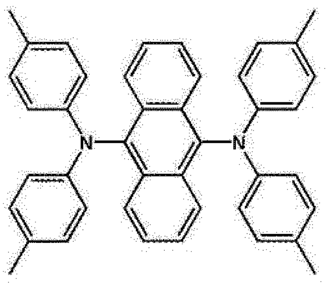

FD9

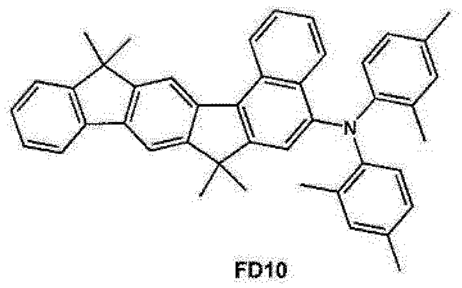

FD10

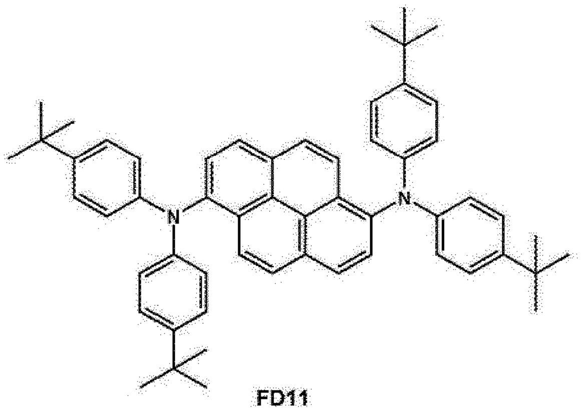

FD11

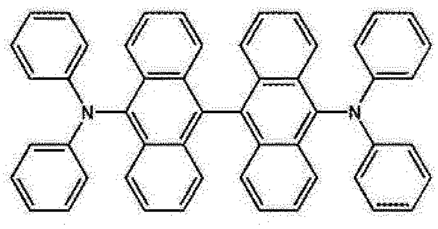

FD12

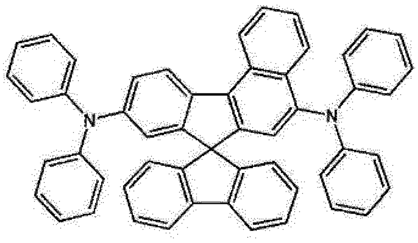

FD13

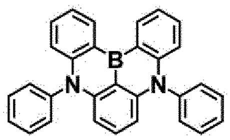

BD1-1

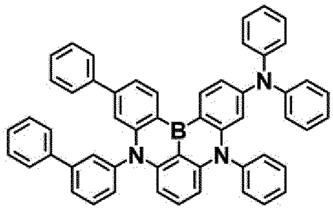

BD1-2

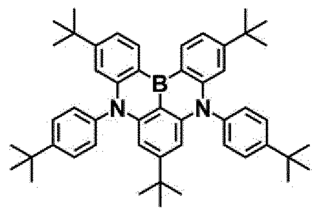

BD1-3

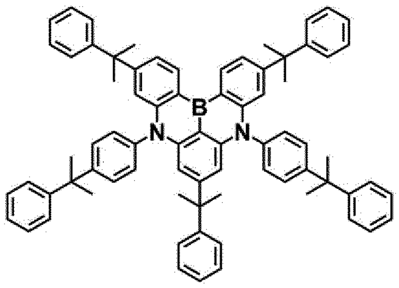

BD1-4

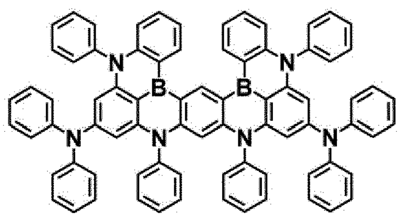

BD1-5

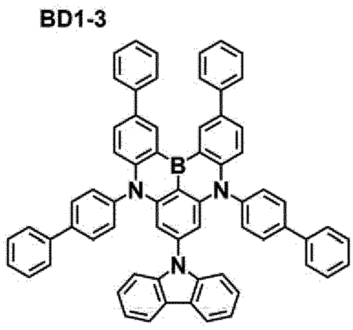

BD1-6

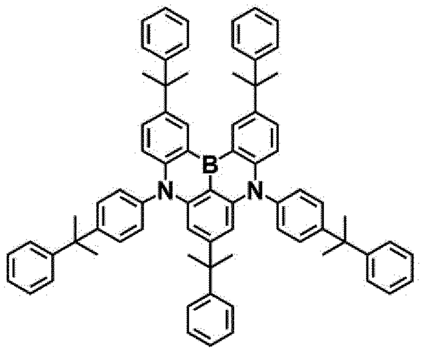

BD1-7

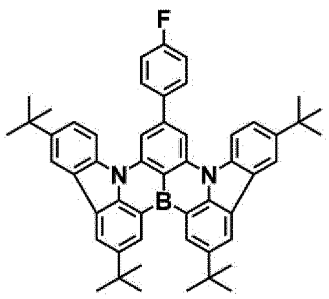

BD1-8

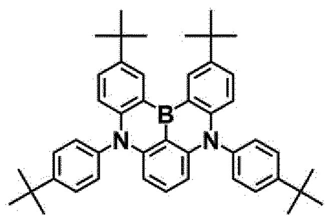

BD1-9

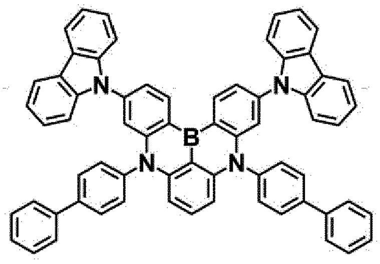

BD1-10

The maximum emission wavelength ($\lambda_{max}$) of an emission spectrum of the emitter may be about 400 nm or greater and about 650 nm or lower. In some embodiments, the maximum emission wavelength of an emission spectrum of the fluorescence emitter may be about 400 nm or greater and about 550 nm or lower, about 400 nm or greater and about 495 nm or lower, or about 450 nm or greater and about 495 nm or lower, but embodiments are not limited thereto. The emitter may emit blue light to green light, for example, blue light, but embodiments are not limited thereto. The "maximum emission wavelength" as used herein refers to a wavelength of which the emission intensity is greatest. In other words, the "maximum emission wavelength" may be referred to as "peak emission wavelength".

The emission layer may have an emitter content (i.e., an amount) in a range of about 0.01 wt% to about 15 wt%, but embodiments are not limited thereto.

In the emission layer, regarding a content of the host, a content of the sensitizer, and a content of the emitter, the content of the host may be greatest, and the content of the emitter may be smallest, but embodiments are not limited thereto.

The organic light-emitting device may satisfy Condition 1:

Condition 1

$$S_1(H) > S_1(S) \geq S_1(E)$$

wherein, in Condition 1,

$S_1(H)$ indicates a lowest excited singlet energy level of the host,
$S_1(S)$ indicates a lowest excited singlet energy level of the sensitizer, and
$S_1(E)$ indicates a lowest excited singlet energy level of the emitter.

$S_1(H)$, $S_1(S)$, and $S_1(E)$ may respectively be determined by density functional theory.

When Condition 1 is satisfied, the emitter may emit light, and the organic light-emitting device may have improved efficiency.

For example, when Condition 1 is satisfied, the emission ratio from the emitter in the organic light-emitting device may be about 85 % or greater. When the above-described ratio is satisfied, in the organic light-emitting device, the emitter may substantially emit light only, and the exciplex and the sensitizer may not substantially emit light.

The singlet and/or triplet excitons formed in the host may be transitioned to the sensitizer, and triplet excitons may be transferred to singlet excitons through reverse intersystem crossing (RISC) in the sensitizer, and then the singlet excitons may be transferred to the emitter through Förster energy transfer (FRET). As singlet excitons and triplet excitons of the host may all be transferred to the emitter, the organic light-emitting device may have significantly improved lifespan and efficiency.

The host and the sensitizer may satisfy Condition 2:

Condition 2

$$T_1(H) \geq T_1(S)$$

wherein, in Condition 2,

$T_1(H)$ indicates a lowest excited triplet energy level of the host, and
$T_1(S)$ indicates a lowest excited triplet energy level of the sensitizer.
$T_1(H)$ and $T_1(S)$ may respectively be determined by density functional theory.

The thickness of the emission layer may be in a range of about 100 angstrom (Å) to about 1,000 Å, and in some embodiments, about 200 Å to about 600 Å. When the thickness of the emission layer is within any of these ranges, improved luminescence characteristics may be obtained without a substantial increase in driving voltage.

Hole transport region 12

In the organic light-emitting device 10, the hole transport region 12 may be located between the first electrode 11 and the emission layer 15.

The hole transport region 12 may have a single-layered structure or a multilayered structure.

For example, the hole transport region 12 may have a structure of hole injection layer, a structure of hole transport layer, a structure of hole injection layer/hole transport layer, a structure of hole injection layer/first hole transport layer/second hole transport layer, a structure of hole transport layer/intermediate layer, a structure of hole injection layer/hole transport layer/intermediate layer, a structure of hole transport layer/electron blocking layer, or a structure of hole injection layer/hole transport layer/electron blocking layer, but embodiments are not limited thereto.

The hole transport region 12 may include a compound having hole transport characteristics.

For example, the hole transport region 12 may include an amine-containing compound.

In an embodiment, the hole transport region 12 may include at least one compound represented by one of Formulae 201 to 205, but embodiments are not limited thereto:

Formula 201

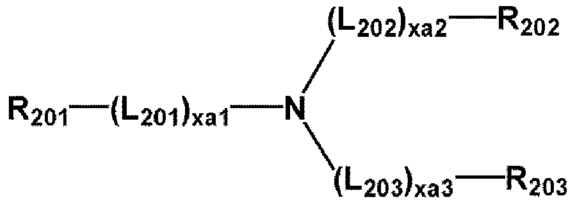

Formula 202

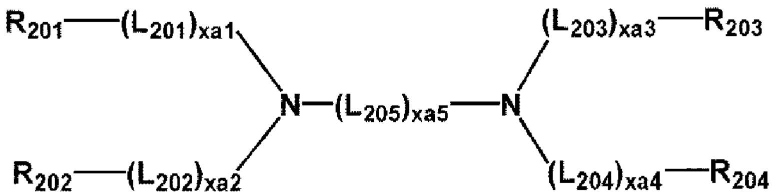

Formula 203

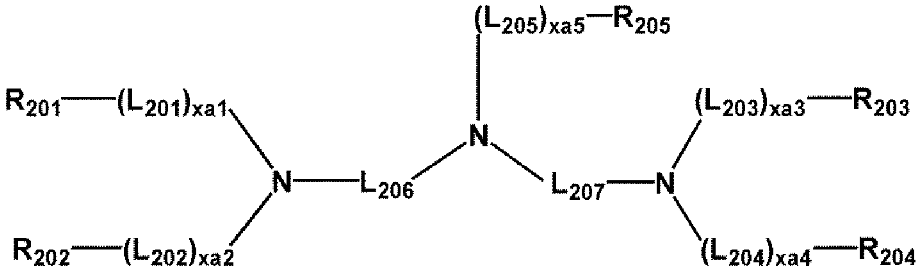

Formula 204

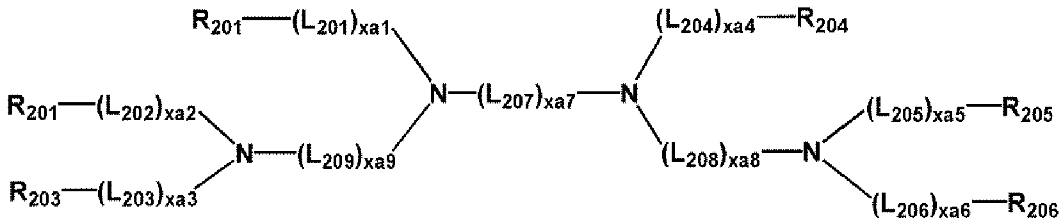

Formula 205

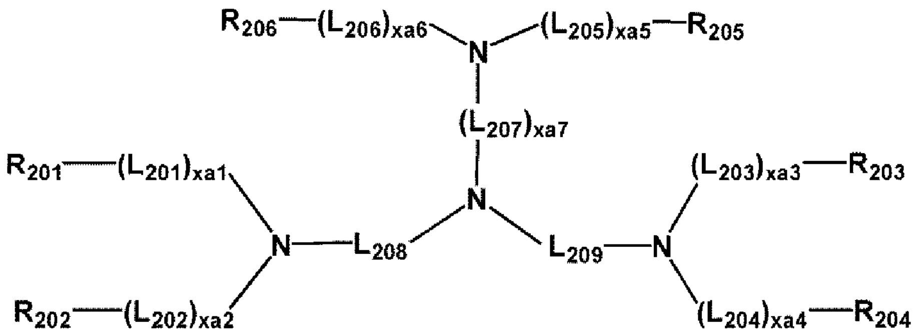

wherein, in Formulae 201 to 205,

$L_{201}$ to $L_{209}$ may each independently be *-O-*', *-S-*', a substituted or unsubstituted $C_6$-$C_{60}$ carbocyclic group, or a substituted or unsubstituted $C_1$-$C_{60}$ heterocyclic group,
xa1 to xa9 may each independently be an integer from 0 to 5,
$R_{201}$ to $R_{206}$ may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group, and two adjacent groups from $R_{201}$ to $R_{206}$ may optionally be linked together via a single bond, a dimethyl-methylene group, or a diphenyl-methylene group.

In some embodiments,

$L_{201}$ to $L_{209}$ may be a benzene group, a heptalene group, an indene group, a naphthalene group, an azulene group, a heptalene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a corozene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group, each unsubstituted or substituted with at least one of deuterium, a $C_1$-$C_{10}$ alkyl group, a $C_1$-$C_{10}$ alkoxy group, a $C_1$-$C_{10}$ alkylthio group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, -Si($Q_{11}$)($Q_{12}$)($Q_{13}$), or a combination thereof,
xa1 to xa9 may each independently be 0, 1, or 2, and
$R_{201}$ to $R_{206}$ may each independently be a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an indenocarbazolyl group, an indolocarbazolyl group, a benzofurocarbazolyl group, or a benzothienocarbazolyl group, each unsubstituted or substituted with at least one of deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or

a salt thereof, a $C_1$-$C_{20}$ alkyl group, a $C_1$-$C_{20}$ alkoxy group, a $C_1$-$C_{20}$alkylthio group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si($Q_{31}$)($Q_{32}$)($Q_{33}$) , -N($Q_{31}$)($Q_{32}$), or a combination thereof,

wherein $Q_{11}$ to $Q_{13}$ and $Q_{31}$ to $Q_{33}$ may each independently be a $C_1$-$C_{10}$ alkyl group, a $C_1$-$C_{10}$ alkoxy group, a $C_1$-$C_{10}$ alkylthio group, a phenyl group, a biphenyl group, a terphenyl group, or a naphthyl group.

According to an embodiment, the hole transport region 12 may include a carbazole-containing amine-containing compound.

In one or more embodiments, the hole transport region 12 may include a carbazole-containing amine-containing compound and a carbazole-free amine-containing compound.

The carbazole-containing amine-containing compound may be, for example, a compound represented by Formula 201 including a carbazole group and further including at least one of a dibenzofuran group, a dibenzothiophene group, a fluorene group, a spirofluorene group, an indenocarbazole group, an indolocarbazole group, a benzofurocarbazole group, or a benzothienocarbazole group.

The carbazole-free amine-containing compound may be, for example, a compound represented by Formula 201 not including a carbazole group and including at least one of a dibenzofuran group, a dibenzothiophene group, a fluorene group, a spirofluorene group, an indenocarbazole group, an indolocarbazole group, a benzofurocarbazole group, or a benzothienocarbazole group.

In one or more embodiments, the hole transport region 12 may include at least one compound represented by one of Formulae 201 or 202.

In an embodiment, the hole transport region 12 may include at least one compound represented by one of Formulae 201-1, 202-1, or 201-2, but embodiments are not limited thereto:

Formula 201-1

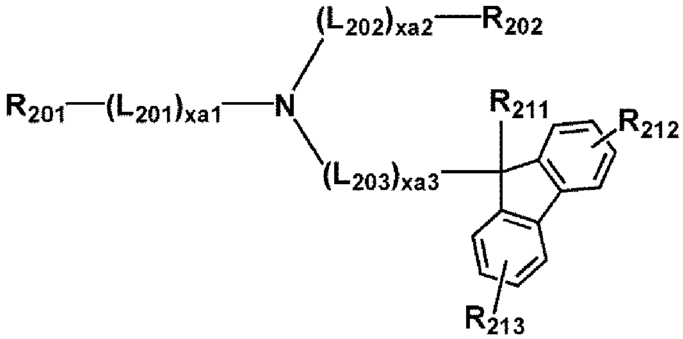

Formula 202-1

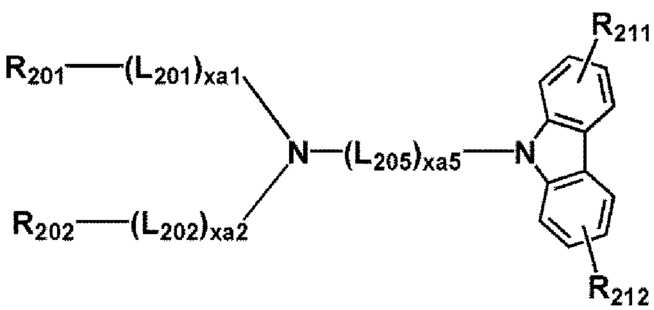

Formula 201-2

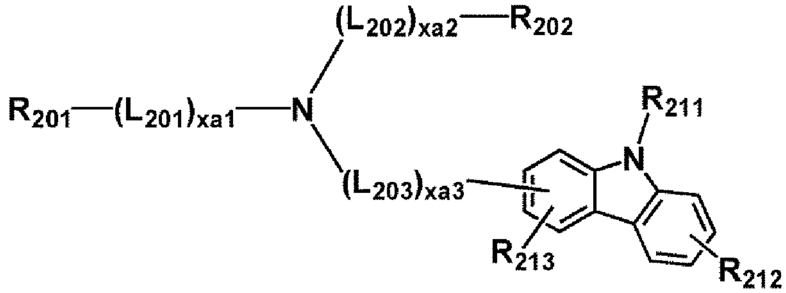

wherein in Formulae 201-1, 202-1, and 201-2, $L_{201}$ to $L_{203}$, $L_{205}$, xa1 to xa3, xa5, $R_{201}$, and $R_{202}$ may each be understood by referring to the descriptions for those provided herein, and $R_{211}$ to $R_{213}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$alkylthio group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a dimethylfluorenyl group, a diphenylfluorenyl group, a triphenylenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, or a pyridinyl group.

In some embodiments, the hole transport region 12 may include at least one compound represented by HT1 to HT39, but embodiments are not limited thereto:

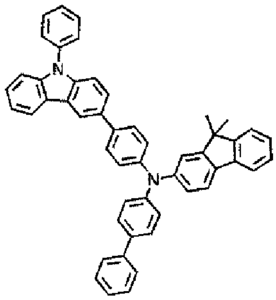

HT1

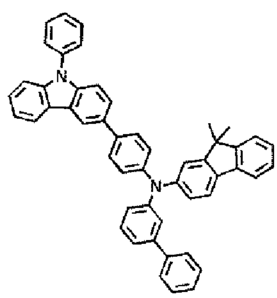

HT2

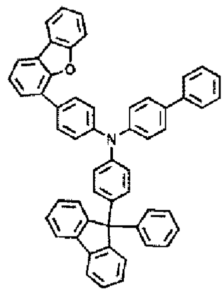

HT3

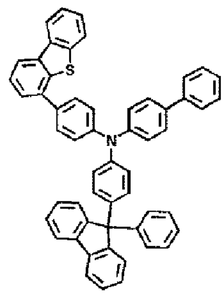

HT4

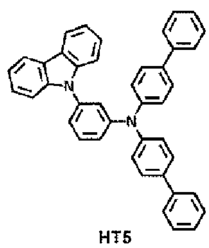

HT5

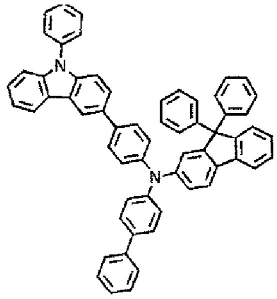

HT6

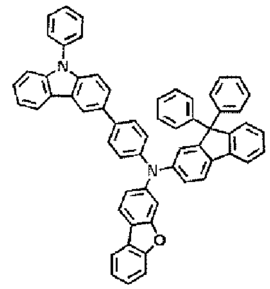
HT7

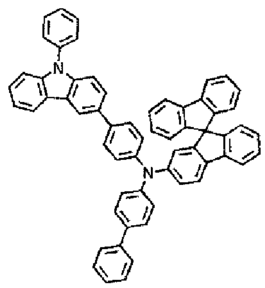
HT8

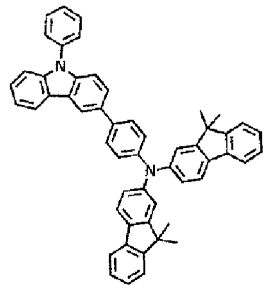
HT9

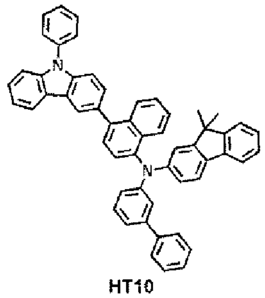
HT10

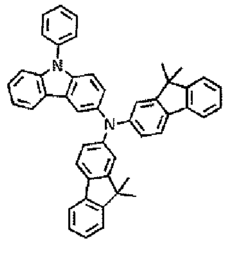
HT11

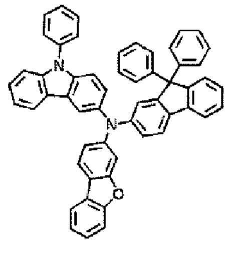
HT12

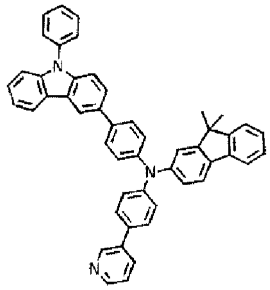
HT13

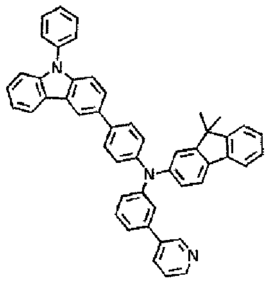
HT14

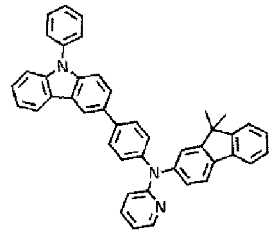
HT15

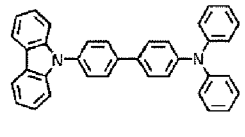
HT16

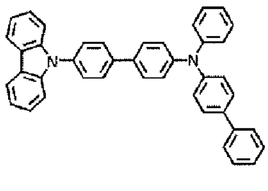
HT17

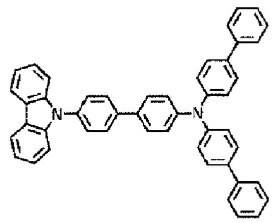
HT18

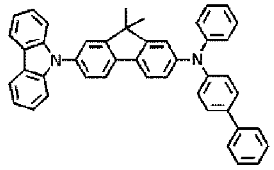
HT19

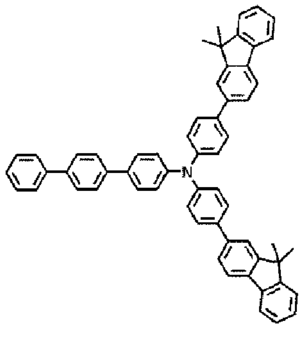
HT20

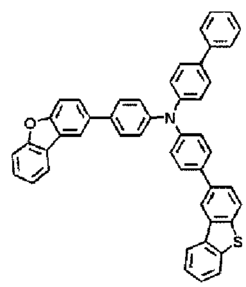
HT21

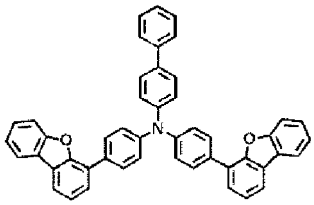

HT22

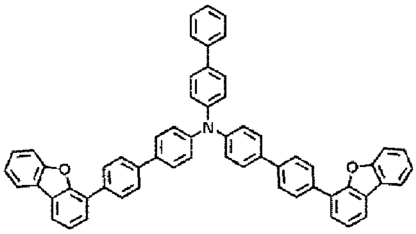

HT23

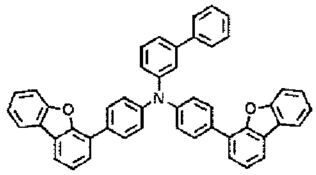

HT24

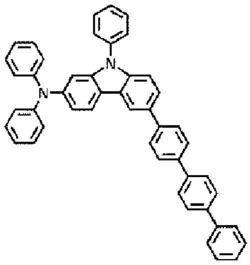

HT25

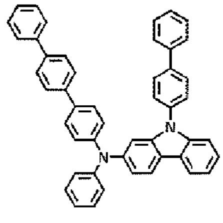

HT26

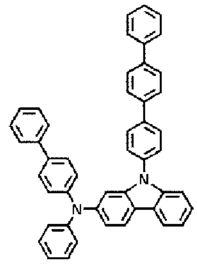

HT27

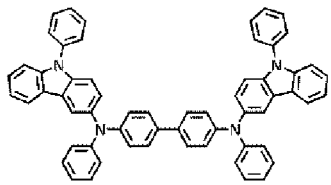

HT28

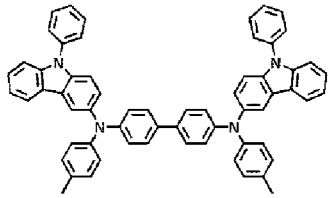

HT29

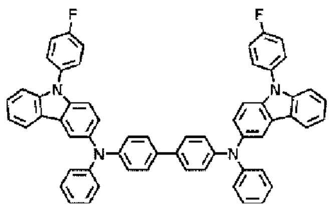

HT30

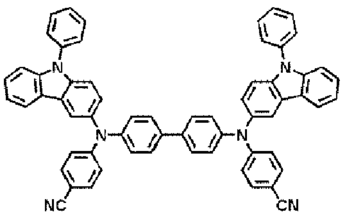

HT31

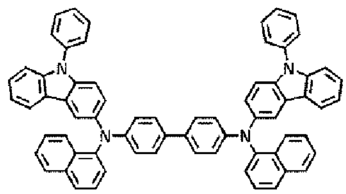

HT32

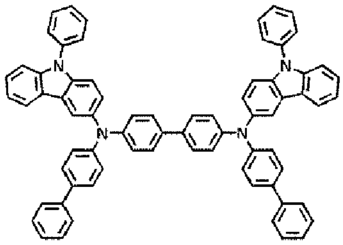

HT33

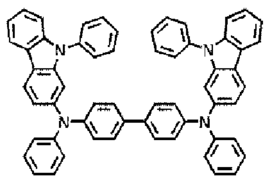

HT34

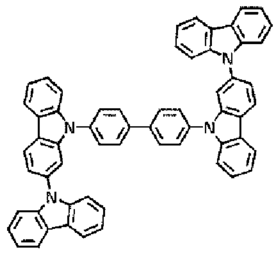

HT35

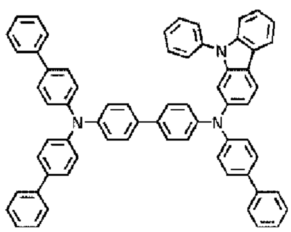

HT36

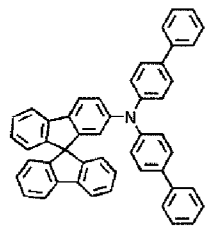

HT37

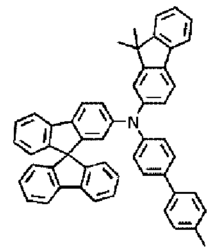

HT38

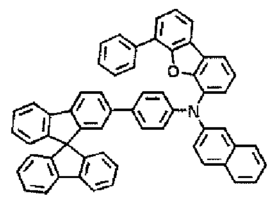

HT39

The hole transport region 12 of the organic light-emitting device 10 may further include a p-dopant. When the hole transport region 12 further includes a p-dopant, the hole transport region 12 may have a structure including a matrix (for example, at least one compound represented by Formulae 201 to 205) and a p-dopant included in the matrix. The p-dopant may be homogeneously or non-homogeneously doped in the hole transport region 12.

In some embodiments, a lowest unoccupied molecular orbital (LUMO) energy level of the p-dopant may be about -3.5 eV or less.

The p-dopant may include at least one selected from a quinone derivative, a metal oxide, and a cyano group-containing compound, but embodiments are not limited thereto.

In some embodiments, the p-dopant may include:

a quinone derivative such as tetracyanoquinodimethane (TCNQ), 2,3,5,6-tetrafluoro-7,7,8,8-tetracyanoquinodimethane (F4-TCNQ), or F6-TCNNQ;
a metal oxide such as tungsten oxide or molybdenum oxide;
1,4,5,8,9,12-hexaazatriphenylene-hexacarbonitrile (HAT-CN); or
a compound represented by Formula 221,
but embodiments are not limited thereto:

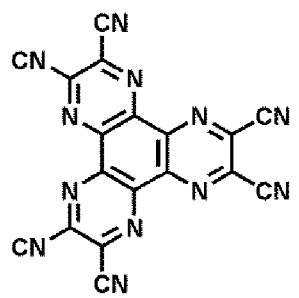

HAT-CN

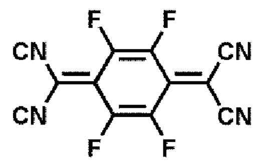

F4-TCNQ

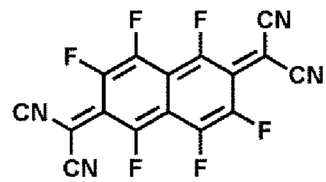

F6-TCNNQ

Formula 221

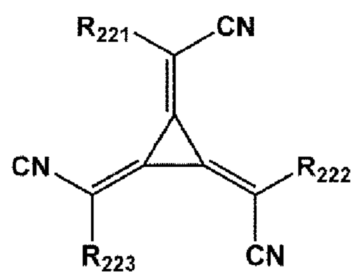

wherein, in Formula 221,

$R_{221}$ to $R_{223}$ may each independently be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_1$-$C_{60}$ heteroaryl group, a substituted or unsubstituted $C_2$-$C_{60}$ alkyl heteroaryl group, a substituted or unsubstituted monovalent non-aromatic condensed

polycyclic group, or a substituted or unsubstituted monovalent non-aromatic condensed heteropolycyclic group, provided that at least one from $R_{221}$ to $R_{223}$ may include at least one substituent that is a cyano group, -F, -Cl, -Br, -I, $-SF_5$, a $C_1$-$C_{20}$ alkyl group substituted with -F, a $C_1$-$C_{20}$ alkyl group substituted with -Cl, a $C_1$-$C_{20}$ alkyl group substituted with -Br, or a $C_1$-$C_{20}$ alkyl group substituted with -I.

A thickness of the hole transport region 12 may be in a range of about 100 Å to about 10,000 Å, e.g., about 400 Å to about 2,000 Å, and a thickness of the emission layer 15 may be in a range of about 100 Å to about 3,000 Å, e.g., about 300 Å to about 1,000 Å. When the thicknesses of the hole transport region 12 and the emission layer 15 are within any of these ranges, satisfactory hole transporting characteristics and/or luminescence characteristics may be obtained without a substantial increase in driving voltage.

Electron transport region 17

In the organic light-emitting device 10, the electron transport region 17 may be located between the emission layer 15 and the second electrode 19.

The electron transport region 17 may have a single-layered structure or a multilayered structure.

For example, the electron transport region 17 may have a structure of electron transport layer, a structure of electron transport layer/electron injection layer, a structure of buffer layer/electron transport layer, a structure of hole blocking layer/electron transport layer, a structure of buffer layer/electron transport layer/electron injection layer, or a structure of hole blocking layer/electron transport layer/electron injection layer, but embodiments are not limited thereto. The electron transport region 17 may include an electron control layer.

The electron transport region 17 may include a known electron transport material.

The electron transport region 17 (for example, the buffer layer, the hole blocking layer, the electron control layer, or the electron transport layer in the electron transport region 17) may include a metal-free compound including at least one $\pi$ electron-depleted nitrogen-containing $C_1$-$C_{60}$ cyclic group. The $\pi$ electron-depleted nitrogen-containing $C_1$-$C_{60}$ cyclic group may be understood by referring to the description for those provided herein.

In some embodiments, the electron transport region may include a compound represented by Formula 601:

Formula 601 $[Ar_{601}]_{xe11}$-$[(L_{601})_{xe1}$-$R_{601}]_{xe21}$

wherein, in Formula 601,

$Ar_{601}$ and $L_{601}$ may each independently be a substituted or unsubstituted $C_6$-$C_{60}$ carbocyclic group or a substituted or unsubstituted $C_1$-$C_{60}$ heterocyclic group,
xe11 may be 1, 2, or 3,
xe1 may be an integer from 0 to 5,
$R_{601}$ may be a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_{601})(Q_{602})(Q_{603})$, $-C(=O)(Q_{601})$, $-S(=O)_2(Q_{601})$, or $-P(=O)(Q_{601})(Q_{602})$,

wherein $Q_{601}$ to $Q_{603}$ may each independently be a $C_1$-$C_{10}$ alkyl group, a $C_1$-$C_{10}$ alkoxy group, a $C_1$-$C_{10}$alkylthio group, a phenyl group, a biphenyl group, a terphenyl group, or a naphthyl group, and
xe21 may be an integer from 1 to 5.

In one embodiment, at least one $Ar_{601}$(s) in the number of xe11 and $R_{601}$(s) in the number of xe21 may include the $\pi$ electron-depleted nitrogen-containing $C_1$-$C_{60}$ cyclic group.

In an embodiment, ring $Ar_{601}$ and $L_{601}$ in Formula 601 may be a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group, each unsubstituted or substituted with at least one of deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, $-Si(Q_{31})(Q_{32})(Q_{33})$, $-S(=O)_2(Q_{31})$, $-P(=O)(Q_{31})(Q_{32})$, or a combination thereof,

wherein $Q_{31}$ to $Q_{33}$ may each independently be a $C_1$-$C_{10}$ alkyl group, a $C_1$-$C_{10}$ alkoxy group, a $C_1$-$C_{10}$alkylthio group, a phenyl group, a biphenyl group, a terphenyl group, or a naphthyl group.

When xe11 in Formula 601 is 2 or greater, at least two $Ar_{601}$(s) may be linked to each other via a single bond.

In one or more embodiments, $Ar_{601}$ in Formula 601 may be an anthracene group.

In one or more embodiments, a compound represented by Formula 601 may be represented by Formula 601-1:

Formula 601-1

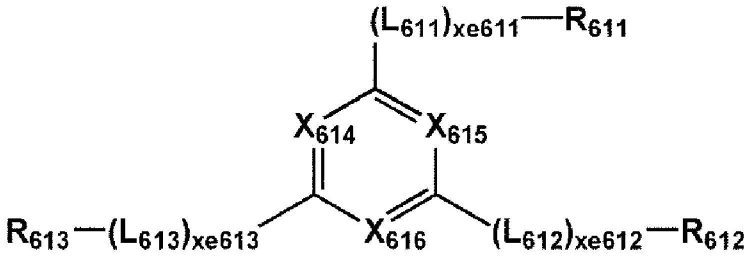

wherein, in Formula 601-1,

$X_{614}$ may be N or $C(R_{614})$, $X_{615}$ may be N or $C(R_{615})$, $X_{616}$ may be N or $C(R_{616})$, and at least one of $X_{614}$ to $X_{616}$ may be N,

$L_{611}$ to $L_{613}$ may each independently be understood by referring to the description of $L_{601}$ provided herein,

xe611 to xe613 may each independently be understood by referring to the description of xe1 provided herein,

$R_{611}$ to $R_{613}$ may each independently be understood by referring to the description of $R_{601}$ provided herein, and

$R_{614}$ to $R_{616}$ may each independently be hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, or a naphthyl group.

In one or more embodiments, xe1 and xe611 to xe613 in Formulae 601 and 601-1 may each independently be 0, 1, or 2.

In one or more embodiments, in Formulae 601 and 601-1, $R_{601}$ and $R_{611}$ to $R_{613}$ may each independently be a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, or an azacarbazolyl group, each unsubstituted or substituted with at least one of deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group,

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, or a combination thereof; or

$$-S(=O)_2(Q_{601}) \text{ or } -P(=O)(Q_{601})(Q_{602}),$$

wherein $Q_{601}$ and $Q_{602}$ may respectively be understood by referring to the descriptions of $Q_{601}$ and $Q_{602}$ provided herein.

The electron transport region may include at least one compound represented by one of Compounds ET1 to ET36, but embodiments are not limited thereto:

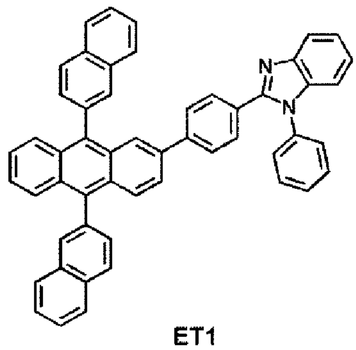

ET1

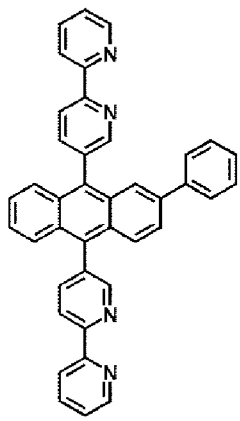

ET2

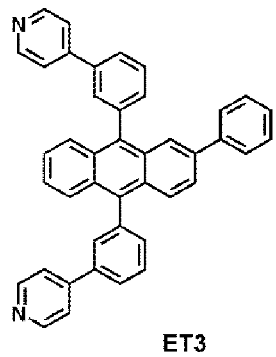

ET3

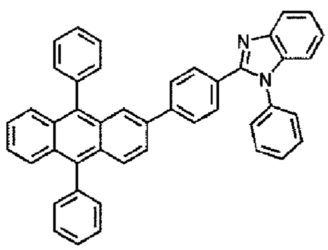

ET4

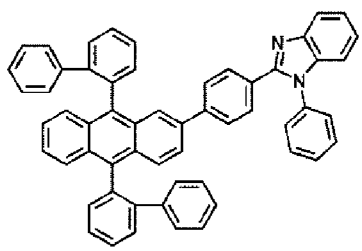

ET5

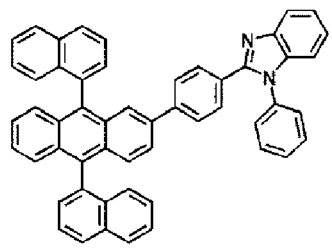

ET6

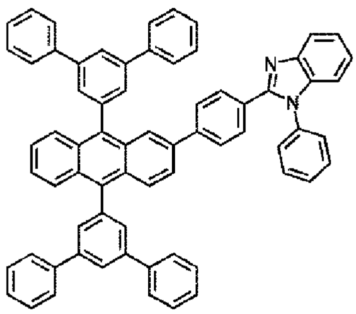

ET7

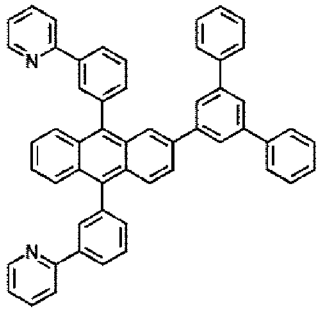

ET8

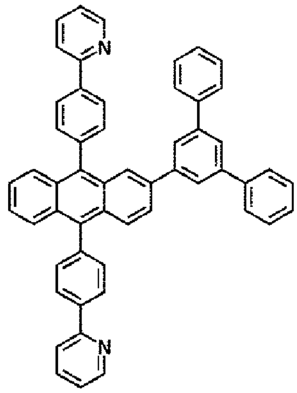

ET9

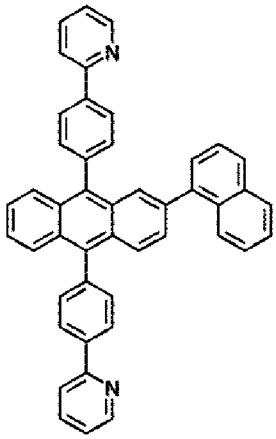

ET10

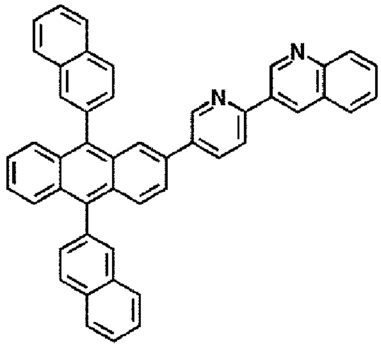

ET11

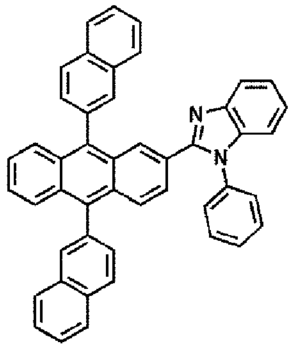

ET12

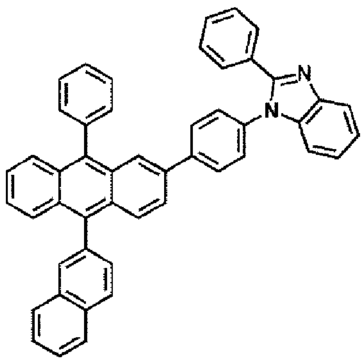

ET13

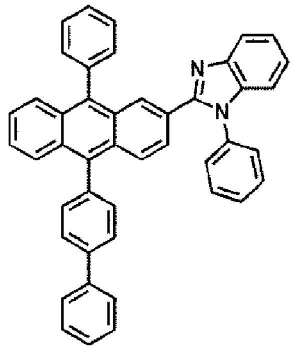

ET14

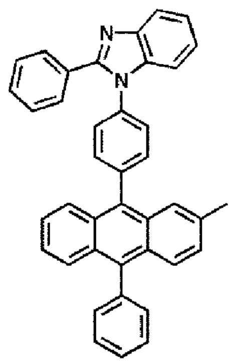

ET15

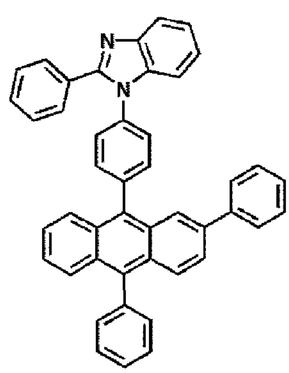

ET16

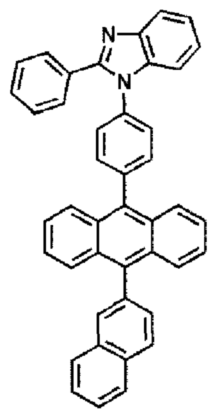

ET17

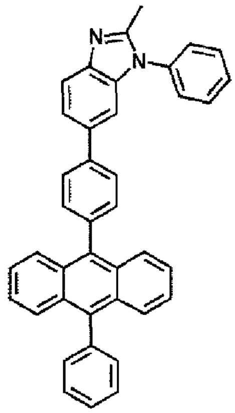

ET18

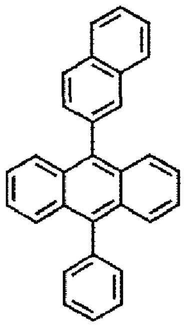

ET19

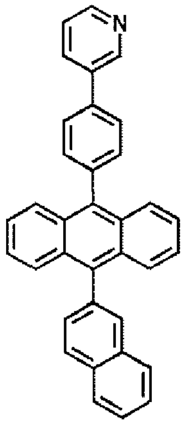

ET20

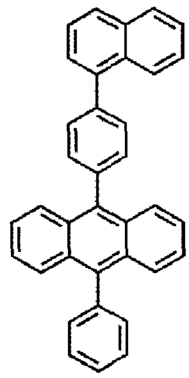

ET21

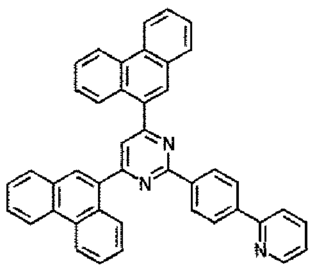

ET22

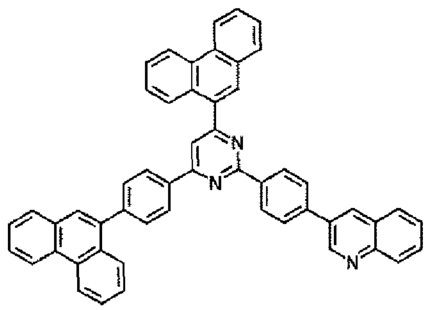

ET23

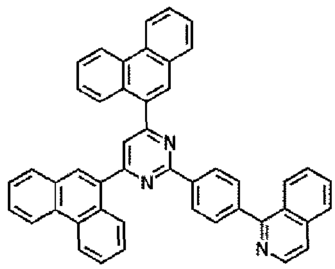

ET24

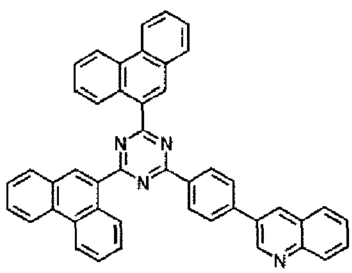

ET25

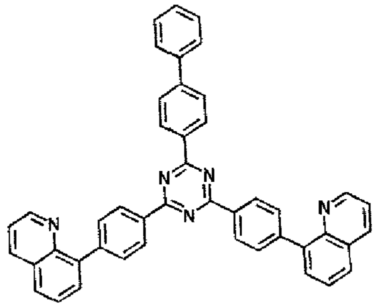

ET26

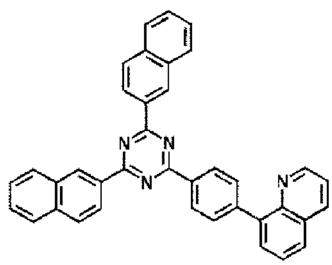

ET27

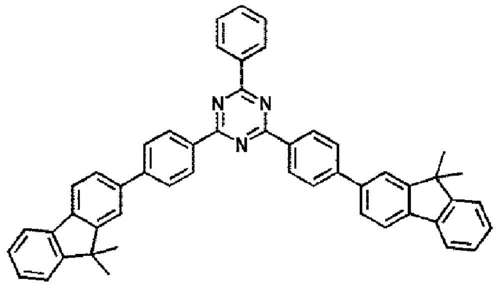

ET28

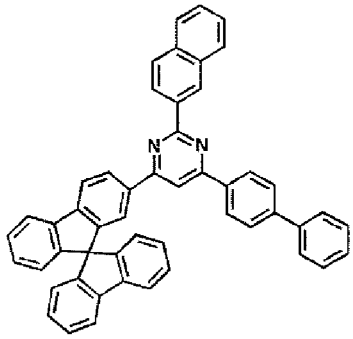

ET29

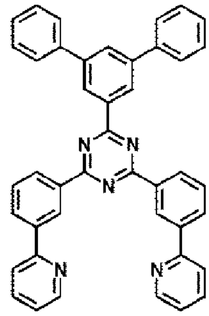

ET30

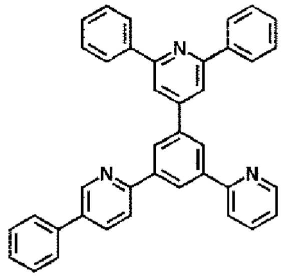

ET31

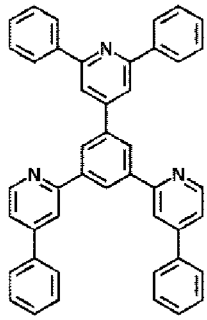

ET32

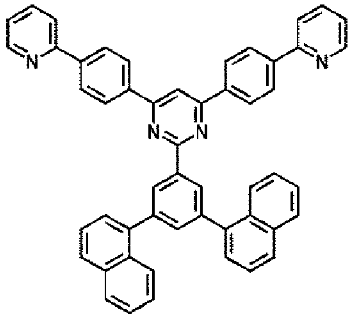

ET33

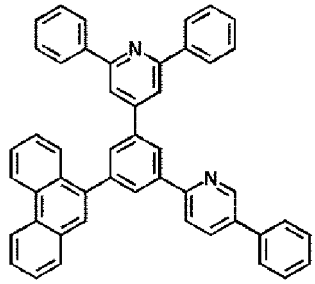

ET34

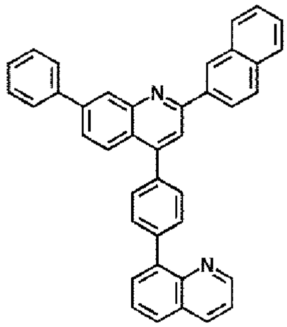

ET35

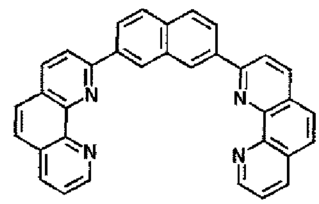

ET36

In some embodiments, the electron transport region may include at least one compound selected from 2,9-dimethyl-4,7-diphenyl-1,10-phenanthroline (BCP), 4,7-diphenyl-1,10-phenanthroline (Bphen), $Alq_3$, BAlq, 3-(biphenyl-4-yl)-5-(4-tert-butylphenyl)-4-phenyl-4H-1,2,4-triazole (TAZ), and NTAZ:

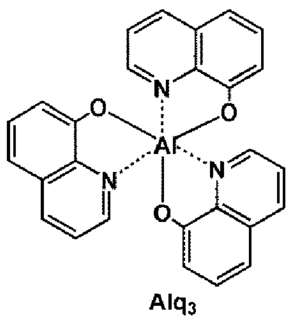

$Alq_3$

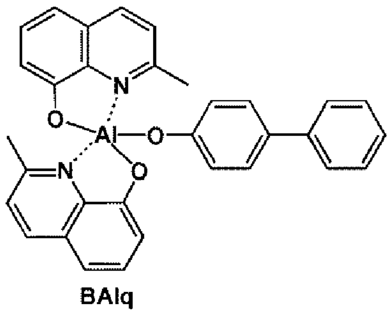

BAlq

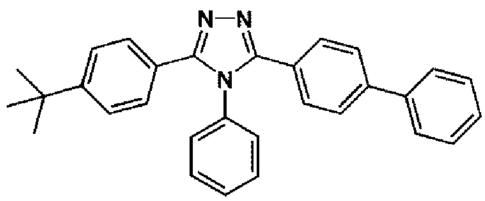

TAZ

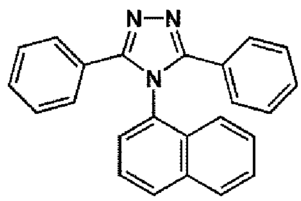

NTAZ

The thicknesses of the buffer layer, the hole blocking layer, or the electron control layer may each independently be in a range of about 20 Å to about 1,000 Å, and in some embodiments, about 30 Å to about 300 Å. When the thicknesses of the buffer layer, the hole blocking layer or the electron control layer are within any of these ranges, excellent hole blocking characteristics or excellent electron controlling characteristics may be obtained without a substantial increase in driving voltage.

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport region 17 (e.g., the electron transport layer in the electron transport region 17) may further include, in addition to the materials described above, a material including metal.

The metal-containing material may include at least one of an alkali metal complex or an alkaline earth metal complex. The alkali metal complex may include a metal ion that is a lithium (Li) ion, a sodium (Na) ion, a potassium (K) ion, a rubidium (Rb) ion, or a cesium (Cs) ion. The alkaline earth metal complex may include a metal ion that is a beryllium (Be) ion, a magnesium (Mg) ion, a calcium (Ca) ion, a strontium (Sr) ion, or a barium (Ba) ion. Each ligand coordinated with the metal ion of the alkali metal complex and the alkaline earth metal complex may independently be hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, or cyclopentadiene, but embodiments are not limited thereto.

For example, the metal-containing material may include a Li complex. The Li complex may include, e.g., Compound ET-D1 (LiQ) or Compound ET-D2:

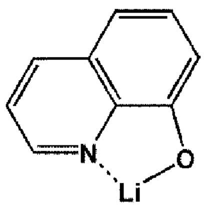

ET-D1

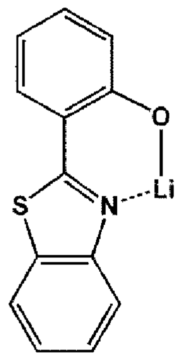

ET-D2

The electron transport region 17 may include an electron injection layer that facilitates injection of electrons from the second electrode 19. The electron injection layer may be in direct contact with the second electrode 19.

The electron injection layer may have i) a single-layered structure consisting of a single layer consisting of a single material, ii) a single-layered structure consisting of a single layer including a plurality of different materials, or iii) a multi-layered structure having a plurality of layers, each including a plurality of different materials.

The electron injection layer may include an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

The alkali metal may be Li, Na, K, Rb, or Cs. In some embodiments, the alkali metal may be Li, Na, or Cs. In one or more embodiments, the alkaline metal may be Li or Cs, but is not limited thereto.

The alkaline earth metal may be Mg, Ca, Sr, or Ba.

The rare earth metal may be Sc, Y, Ce, Tb, Yb, or Gd.

The alkali metal compound, the alkaline earth metal compound, and the rare earth metal compound may each

independently be oxides or halides (e.g., fluorides, chlorides, bromides, or iodines) of the alkali metal, the alkaline earth metal, or the rare earth metal, respectively.

The alkali metal compound may be an alkali metal oxide, such as $Li_2O$, $Cs_2O$, or $K_2O$, or an alkali metal halide, such as LiF, NaF, CsF, KF, LiI, NaI, CsI, or KI. In an embodiment, the alkali metal compound may be LiF, $Li_2O$, NaF, LiI, NaI, CsI, or KI, but embodiments are not limited thereto.

The alkaline earth metal compound may be an alkaline earth metal compound such as BaO, SrO, CaO, $Ba_xSr_{1-x}O$ (wherein 0<x<1), or $Ba_xCa_{1-x}O$ (wherein 0<x<1). In an embodiment, the alkaline earth metal compound may BaO, SrO, or CaO, but embodiments are not limited thereto.

The rare earth metal compound may be $YbF_3$, $ScF_3$, ScOs, $Y_2O_3$, $Ce_2O_3$, $GdF_3$, or $TbF_3$. In some embodiments, the rare earth metal compound may be $YbF_3$, $ScF_3$, $TbF_3$, $YbI_3$, $ScI_3$, or $TbI_3$, but embodiments are not limited thereto.

The alkali metal complex, the alkaline earth metal complex, and the rare earth metal complex may each include ions of the above-described alkali metal, alkaline earth metal, and/or rare earth metal. Each ligand coordinated with the metal ion of the alkali metal complex, the alkaline earth metal complex, and/or the rare earth metal complex may independently be hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, or cyclopentadiene, but embodiments are not limited thereto.

The electron injection layer may comprise, consist essentially of, or consist of an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In some embodiments, the electron injection layer may further include an organic material. When the electron injection layer further includes an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or a combination thereof may be homogeneously or non-homogeneously dispersed in a matrix including the organic material.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

Second electrode 19

The second electrode 19 may be on the organic layer 10A. In an embodiment, the second electrode 19 may be a cathode that is an electron injection electrode. In this embodiment, a material for forming the second electrode 19 may be a material having a low work function, for example, a metal, an alloy, an electrically conductive compound, or a combination thereof.

The second electrode 19 may include at least one of lithium (Li), silver (Ag), magnesium (Mg), aluminum (Al), silver (Ag), aluminum-lithium (Al-Li), calcium (Ca), magnesium-indium (Mg-in), magnesium-silver (Mg-Ag), ITO, or IZO, but embodiments are not limited thereto. The second electrode 19 may be a transmissive electrode, a semitransmissive electrode, or a reflective electrode.

The second electrode 19 may have a single-layered structure, or a multi-layered structure including two or more layers.

Hereinbefore the organic light-emitting device 10 has been described with reference to FIG. 1, but embodiments are not limited thereto.

Description of FIG. 2

FIG. 2 is a schematic view of an organic light-emitting device 100 according to an embodiment.

The organic light-emitting device 100 in FIG. 2 may include a first electrode 110, a second electrode 190 facing the first electrode 110, and a first light-emitting unit 151 and a second light-emitting unit 152 located between the first electrode 100 and the second electrode 190. A charge generating layer 141 may be located between the first light-emitting unit 151 and the second light-emitting unit 152, and the charge generating layer 141 may include an n-type charge generating layer 141-N and a p-type charge generating layer 141-P. The charge generating layer 141 is a layer serving to generate charges and to supply the generated charges to the adjacent light-emitting unit, and may include a known material in the art.

The first light-emitting unit 151 may include a first emission layer 151-EM, and the second light-emitting unit 152 may include a second emission layer 152-EM. A maximum emission wavelength of light emitted by the first light-emitting unit 151 may be different from a maximum emission wavelength of light emitted by the second light-emitting unit 152. For example, mixed light of the light emitted by the first light-emitting unit 151 and the light emitted by the

second light-emitting unit 152 may be white light, but embodiments are not limited thereto.

A hole transport region 120 may be located between the first light-emitting unit 151 and the first electrode 110, and the second light-emitting unit 152 may include a first hole transport region 121 located towards or most adjacent to the first electrode 110.

An electron transport region 170 may be located between the second light-emitting unit 152 and the second electrode 190, and the first light-emitting unit 151 may include a first electron transport region 171 located between the charge generating layer 141 and the first emission layer 151-EM.

The first emission layer 151-EM may include a host, a sensitizer, and an emitter, the host, the sensitizer, and the emitter may be different from each other, and the sensitizer may be represented by Formula 1.

The second emission layer 152-EM may include a host, a sensitizer, and an emitter, the host, the sensitizer, and the emitter may be different from each other, and the sensitizer may be represented by Formula 1.

In FIG. 2, the first electrode 110 and the second electrode 190 may each be understood by referring to the descriptions for the first electrode 11 and the second electrode 19 in FIG. 1, respectively.

In FIG. 2 the first emission layer 151-EM and the second emission layer 152-EM may each be understood by referring to the descriptions for the emission layer 15 in FIG. 1.

In FIG. 2, the hole transport region 120 and the first hole transport region 121 may each be understood by referring to the descriptions for the hole transport region 12 in FIG. 1.

In FIG. 2, the electron transport region 170 and the first electron transport region 171 may each be understood by referring to the descriptions for the electron transport region 17 in FIG. 1.

Hereinbefore, by referring to FIG. 2, the first light-emitting unit 151 and the second light-emitting unit 152 has been described as being included in an organic light-emitting device including the host, the sensitizer, and the emitter. However, the organic light-emitting device 100 in FIG. 2 may be subjected to various modifications, for example, at least one of the first light-emitting unit 151 and the second light-emitting unit 152 of the organic light-emitting device 100 in FIG. 2 may be replaced by any suitable light-emitting unit including those available in the art, or three or more light-emitting units may be included together.

Description of FIG. 3

FIG. 3 is a schematic view of an organic light-emitting device 200 according to another embodiment.

The organic light-emitting device 100 in FIG. 4 includes a first electrode 210, a second electrode 290 facing the first electrode 210, and a first emission layer 251 and a second emission layer 252 located between the first electrode 210 and the second electrode 290.

A maximum emission wavelength of light emitted by the first emission layer 251 may be different from a maximum emission wavelength of light emitted by the second emission layer 252. For example, mixed light of the light emitted by the first emission layer 251 and the light emitted by the second emission layer 252 may be white light, but embodiments are not limited thereto.

A hole transport region 220 may be located between the first emission layer 251 and the first electrode 210, and an electron transport region 270 may be located between the second emission layer 252 and the second electrode 290.

The first emission layer 251 may include a host, a sensitizer, and an emitter, the host, the sensitizer, and the emitter may be different from each other, and the sensitizer may be represented by Formula 1.

The second emission layer 252 may include a host, a sensitizer, and an emitter, the host, the sensitizer, and the emitter may be different from each other, and the sensitizer may be represented by Formula 1.

In FIG. 3, the first electrode 210, the hole transport region 220, and the second electrode 290 may each be understood by referring to the descriptions for the first electrode 11, the hole transport region 12, and the second electrode 19 in FIG. 1, respectively.

In FIG. 3, the first emission layer 251 and the second emission layer 252 may each be understood by referring to the descriptions for the emission layer 15 in FIG. 1.

In FIG. 3, the electron transport region 170 may be understood by referring to the descriptions for the electron transport region 17 in FIG. 1.

Hereinbefore, by referring to FIG. 3, the first emission layer 251 and the second emission layer 252 has been described as being included in an organic light-emitting device including the sensitizer and the emitter described herein. However, the organic light-emitting device in FIG. 3 may be subjected to various modifications, for example, one of the first emission layer 251 and the second emission layer 252 may be replaced by any suitable known layer, three or more layers may be included, or an interlayer may be further located between neighboring emission layers.

General definitions of terms

The term "$C_1$-$C_{60}$ alkyl group" as used herein refers to a linear or branched saturated aliphatic hydrocarbon monovalent group having 1 to 60 carbon atoms. Examples thereof include a methyl group, an ethyl group, a propyl group, an iso-butyl group, a sec-butyl group, a tert-butyl group, a pentyl group, an iso-amyl group, and a hexyl group. The term "$C_1$-$C_{60}$ alkylene group" as used herein refers to a divalent group having substantially the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is a $C_1$-$C_{60}$ alkyl group). Examples thereof include a methoxy group, an ethoxy group, and an isopropyloxy group.

The term "$C_1$-$C_{60}$ alkylthio group" as used herein refers to a monovalent group represented by $-SA_{101'}$ (wherein $A_{101'}$ is a $C_1$-$C_{60}$ alkyl group).

The term "$C_2$-$C_{60}$ alkenyl group" as used herein refers to a group formed by including at least one carbon-carbon double bond in the middle or at the terminus of the $C_2$-$C_{60}$ alkyl group. Examples thereof include an ethenyl group, a propenyl group, and a butenyl group. The term "$C_2$-$C_{60}$ alkenylene group" as used herein refers to a divalent group having substantially the same structure as the $C_2$-$C_{60}$ alkenyl group.

The term "$C_2$-$C_{60}$ alkynyl group" as used herein refers to a group formed by including at least one carbon-carbon triple bond in the middle or at the terminus of the $C_2$-$C_{60}$ alkyl group. Examples thereof include an ethenyl group and a propenyl group. The term "$C_2$-$C_{60}$ alkynylene group" as used herein refers to a divalent group having substantially the same structure as the $C_2$-$C_{60}$ alkynyl group.

The term "$C_3$-$C_{10}$ cycloalkyl group" as used herein refers to a monovalent monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having substantially the same structure as the $C_3$-$C_{10}$ cycloalkyl group.

The term "$C_1$-$C_{10}$ heterocycloalkyl group" as used herein refers to a monovalent monocyclic group including at least one heteroatom selected from N, O, P, Si, Ge, Se, and S as a ring-forming atom and 1 to 10 carbon atoms. Examples thereof include a tetrahydrofuranyl group and a tetrahydrothiophenyl group. The term "$C_1$-$C_{10}$ heterocycloalkylene group" as used herein refers to a divalent group having substantially the same structure as the $C_1$-$C_{10}$ heterocycloalkyl group.

The term "$C_3$-$C_{10}$ cycloalkenyl group" as used herein refers to a monovalent monocyclic group including 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "$C_3$-$C_{10}$ cycloalkenylene group" as used herein refers to a divalent group having substantially the same structure as the $C_3$-$C_{10}$ cycloalkenyl group.

The term "$C_1$-$C_{10}$ heterocycloalkenyl group" as used herein refers to a monovalent monocyclic group including at least one heteroatom selected from N, O, P, Si, Ge, Se, and S as a ring-forming atom, 1 to 10 carbon atoms, and at least one double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkylene group" as used herein refers to a divalent group having substantially the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms. The term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and a $C_6$-$C_{60}$ arylene group each include at least two rings, the at least two rings may be fused.

The term "$C_7$-$C_{60}$ alkyl aryl group" as used herein refers to a monovalent group having a carbocyclic aromatic system substituted with an alkyl group, wherein the alkyl aryl group has 7 to 60 carbon atoms. Examples of the $C_7$-$C_{60}$ alkyl aryl group include a methylphenyl group.

The term "$C_7$-$C_{60}$ aryl alkyl group" a used herein refers to a monovalent group having an alkyl group substituted with a group having a carbocyclic aromatic system, wherein the aryl alkyl group has 7 to 60 carbon atoms.

The term "$C_1$-$C_{60}$ heteroaryl group" as used herein refers to a monovalent group having a heterocyclic aromatic system having at least one heteroatom selected from N, O, P, Si, and S as a ring-forming atom and 1 to 60 carbon atoms. The term "$C_1$-$C_{60}$ heteroarylene group" as used herein refers to a divalent group having a heterocyclic aromatic system having at least one heteroatom selected from N, O, P, Si, and S as a ring-forming atom and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include at least two rings, the at least two rings may be fused.

The term "$C_2$-$C_{60}$ alkyl heteroaryl group" as used herein refers to a monovalent group having a heterocyclic aromatic system substituted with an alkyl group and having at least one heteroatom selected from N, O, P, Si, and S as a ring-forming atom and 1 to 60 carbon atoms. Examples of the $C_2$-$C_{60}$ alkyl heteroaryl group include a methylpyridinyl

group.

The term "$C_2$-$C_{60}$ heteroaryl alkyl group" as used herein refers to a monovalent group having an alkyl group substituted with a heterocyclic aromatic system, and having at least one heteroatom selected from N, O, P, Si, and S as a ring-forming atom and 1 to 60 carbon atoms.

The term "$C_6$-$C_{60}$ aryloxy group" as used herein refers to a group represented by -$OA_{102}$ (where $A_{102}$ is a $C_6$-$C_{60}$ aryl group). The term "$C_6$-$C_{60}$ arylthio group" as used herein refers to a group represented by -$SA_{103}$ (where $A_{103}$ is a $C_6$-$C_{60}$ aryl group).

The term "$C_1$-$C_{60}$ heteroaryloxy group" as used herein refers to a group represented by -$OA_{102'}$ (where $A_{102'}$ is a $C_1$-$C_{60}$ heteroaryl group). The term "$C_1$-$C_{60}$ heteroarylthio group" as used herein refers to a group represented by -$SA_{103'}$ (where $A_{103'}$ is a $C_1$-$C_{60}$ heteroaryl group).

The term "monovalent non-aromatic condensed polycyclic group" as used herein refers to a monovalent group having two or more rings condensed and only carbon atoms (for example, the number of carbon atoms may be in a range of 8 to 60) as ring-forming atoms, wherein the molecular structure as a whole is non-aromatic. Examples of the non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group having at least two rings condensed and a heteroatom selected from N, O, P, Si, Ge, Se, and S as well as carbon atoms (for example, the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "$C_5$-$C_{30}$ carbocyclic group" as used herein refers to a saturated or unsaturated cyclic group including 5 to 30 carbon atoms only as ring-forming atoms. The $C_6$-$C_{30}$ carbocyclic group may be a monocyclic group or a polycyclic group. Depending on formula structure, the $C_6$-$C_{30}$ carbocyclic group may be monovalent, divalent, trivalent, quadrivalent, pentavalent, or hexavalent.

The term "$C_1$-$C_{30}$ heterocyclic group" as used herein refers to saturated or unsaturated cyclic group including 1 to 30 carbon atoms and at least one heteroatom selected from N, O, P, Si, Ge, Se, and S as ring-forming atoms. The $C_1$-$C_{30}$ heterocyclic group may be a monocyclic group or a polycyclic group. Depending on formula structure, the $C_5$-$C_{30}$ heterocyclic group may be monovalent, divalent, trivalent, quadrivalent, pentavalent, or hexavalent.

In the present specification, at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent aromatic condensed polycyclic group, the substituted monovalent aromatic condensed heteropolycyclic group, the substituted monovalent non-aromatic condensed polycyclic group, and the substituted monovalent non-aromatic condensed heteropolycyclic group may be:

deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, -$SF_5$, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, -$N(Q_{11})(Q_{12})$, -$Si(Q_{13})(Q_{14})(Q_{16})$, -$B(Q_{16})(Q_{17})$, - $P(=O)(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl

group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, or a monovalent non-aromatic condensed heteropolycyclic group, each substituted with at least one of deuterium, -F, -Cl, - Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, - $P(=O)(Q_{28})(Q_{29})$, or a combination thereof; or

$-N(Q_{31})(Q_{32})$, $-Si(Q_{33})(Q_{34})(Q_{35})$, $-B(Q_{36})(Q_{37})$, or $-P(=O)(Q_{38})(Q_{39})$,

wherein $Q_1$ to $Q_9$, $Q_{11}$ to $Q_{19}$, $Q_{21}$ to $Q_{29}$, and $Q_{31}$ to $Q_{39}$ may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ heteroaryl alkyl group, a $C_2$-$C_{60}$ alkyl heteroaryl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, or a monovalent non-aromatic condensed heteropolycyclic group, each of which is unsubstituted or substituted with at least one of deuterium, -F, a cyano group, a $C_1$-$C_{20}$ alkyl group, a $C_6$-$C_{30}$ aryl group, or a combination thereof.

The term "room temperature" as used herein refers to a temperature of about 25°C.

The terms "a biphenyl group, a terphenyl group, and a tetraphenyl group" as used herein each refer to a monovalent group having two, three, and four phenyl groups linked together via a single bond, respectively.

The terms "a phenyl group substituted with at least one cyano group, a biphenyl group substituted with at least one cyano group, a terphenyl group substituted with at least one cyano group, and a tetraphenyl group substituted with at least one cyano group" as used herein each refer to a phenyl group, a biphenyl group, a terphenyl group, and a tetraphenyl group, each substituted with at least one cyano group. In "the phenyl group substituted with at least one cyano group, the biphenyl group substituted with at least one cyano group, the terphenyl group substituted with at least one cyano group, and the tetraphenyl group substituted with at least one cyano group", a cyano group may be substituted at any position of the ring or rings, and "the phenyl group substituted with at least one cyano group, the biphenyl group substituted with at least one cyano group, the terphenyl group substituted with at least one cyano group, and the tetraphenyl group substituted with at least one cyano group" may further include a substituent in addition to a cyano group.

Hereinafter, an organic light-emitting device, according to an embodiment, will be described in more detail with reference to Synthesis Examples and Examples; however, the present disclosure is not limited thereto. The wording "B was used instead of A" used in describing Synthesis Examples means that an identical molar equivalent of B was used in place of A.

Examples

Synthesis Example

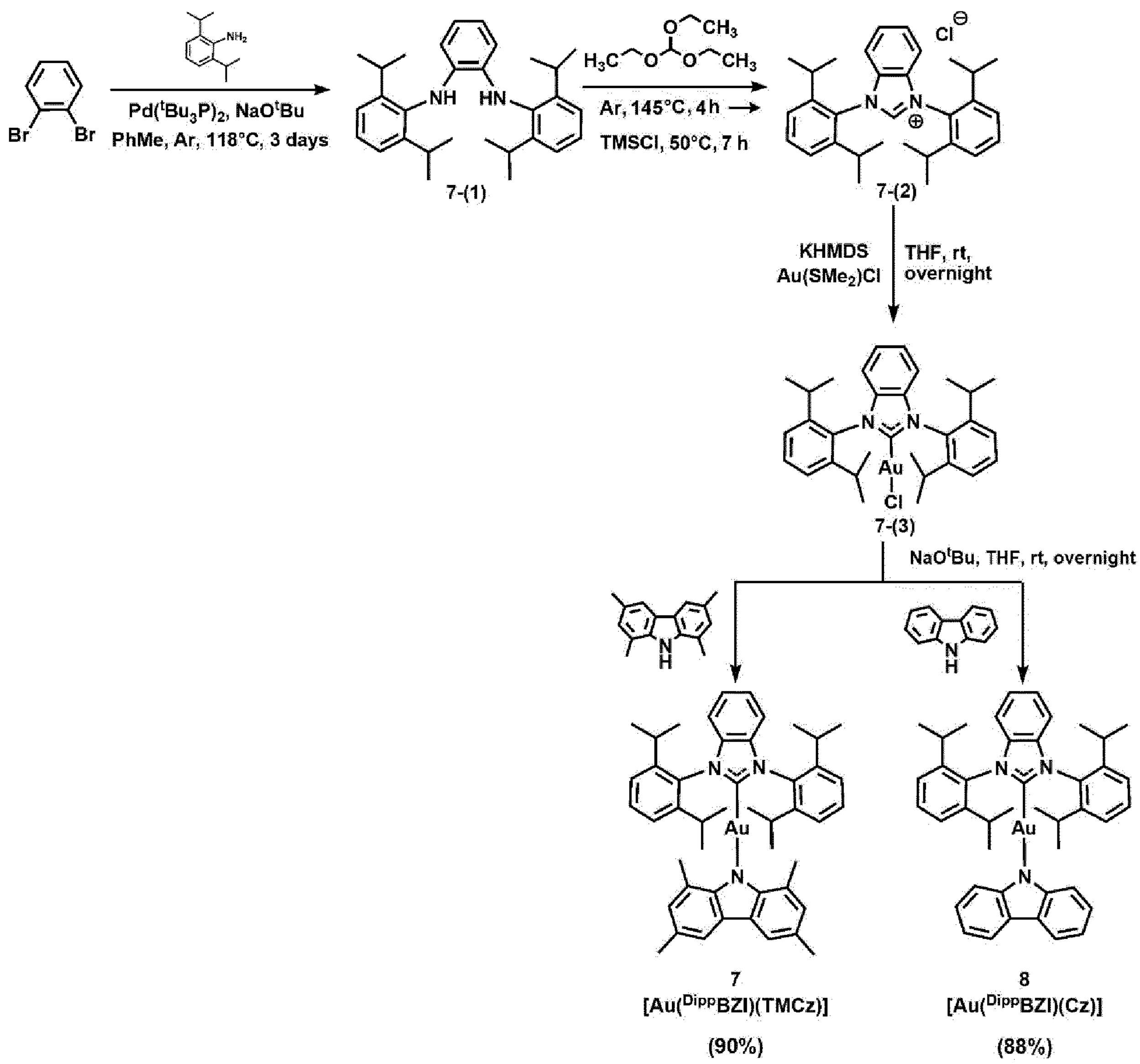


7-(1)

7-(2)

7-(3)

7
[Au($^{Dipp}$BZI)(TMCz)]
(90%)

8
[Au($^{Dipp}$BZI)(Cz)]
(88%)

Synthesis Example 1: Synthesis of Compound 7

1) Synthesis of Intermediate 7-(1)

A magnetic stir bar was put into a 250 milliliter (mL) two necked round-bottom flask and connected to a condenser. While maintaining the connection, residual water was removed therefrom by flame drying. 6.70 grams (g) (28.4 (millimoles) mmol) of 1,2-dibromobenzene was added to the cooled flask, 20.1 g (114 mmol) of 2,6-diisopropyl aniline, and 10.9 g (114 mmol) of sodium tertiary-butoxide ($NaO^tBu$) were added thereto and purged with argon gas. While stirring using a heating stirrer, 100 mL of anhydrous toluene was injected using a glass syringe, followed by stirring at room temperature for 10 minutes. 1.45 g (2.84 mmol) of bis(tri-tert-butylphosphine)palladium(0) ($Pd(t\text{-}Bu_3P)_2$) was added to a vial, followed by adding 5 mL of anhydrous toluene, while argon was injected to form a $Pd(tBu_3P)_2$ solution. The $Pd(tBu^3P)_2$ solution was added to the reaction flask using a glass syringe. The temperature was slowly raised to 118°C, and the mixture was stirred and heated at reflux for 3 days. After stopping the stirring and heating, Celite™ was placed on the filter, and the reaction solution was filtered through a 500 mL recovery flask. The reaction solvent was evaporated from the filtered solution using a rotary evaporator, and a separation process was performed through column chromatography (dichloromethane: hexanes 1:49). (thin layer chromatography (TLC): $R_f$ value acetate ethyl:hexane (1:99) = 0.25) yield: 76% (9.30 g, yellowish brown powder).

Proton nuclear magnetic resonance ($^1H$ NMR) spectroscopy (300 megahertz (MHz), $CD_2Cl_2$) chemical shift (δ, parts per million (ppm)) : 1.14 (d, J =6.9 Hz, 12H), 1.22 (d, J = 6.9 Hz, 12H), 3.18 (sept, J = 6.9 Hz, 4H), 5.23 (s, 2H) 6.22 (dd, J =6.3 Hz, 3.0 Hz, 2H), 6.60 (dd, J =6.3 Hz, 3.0 Hz, 2H), 7.23 - 7.29 (m, 6H).

Carbon-13 nuclear magnetic resonance $^{13}C\{^1H\}$ spectroscopy (126 MHz, $CD_2Cl_2$) δ (ppm) : 23.45, 25.00, 28.77, 114.89, 120.39, 124.35, 126.69, 137.45, 137.45, 145.98.

High resolution mass spectrometry using fast atom bombardment (HR MS (FAB)): Calcd for $C_{30}H_{40}N_2$ ($[M]^+$), 428.3191. Found: 428.3194.

Elemental analysis (C,H,N): Anal. Calcd for $C_{30}H_{40}N_2$: C, 84.06; H, 9.41; N, 6.54. Found: C, 84.12; H, 9.43; N, 6.35%.

2) Synthesis of Intermediate 7-(2)

A magnetic stir bar and 9.00 g (21.0 mmol) of Intermediate 7-(1) were placed in a 500 mL two-necked round-bottom flask, and argon was injected thereto, while the flask was connected to the condenser and Vigreux column. While stirring using a heat stirrer, 200 mL of triethylorthoformate was added to the reaction flask using a glass syringe. While heating at reflux at 145°C for 4 hours, ethanol, a by-product, was removed from the reaction mixture. After lowering the temperature, pressure was reduced in the flask using a vacuum pump to completely remove the remaining ethanol. The temperature was raised to 50°C using a heat stirrer, and after injection of 43 mL of trimethylsilyl chloride (excess), the mixture was stirred for an additional 8 hours at 50°C. After cooling the reaction solution by lowering the temperature, the reaction solution was transferred to a 500 mL recovery flask, and then the reaction solvent was evaporated using a rotary evaporator. Ether was added to the reaction solution concentrated to a high concentration in dichloromethane for precipitation. The precipitated solution was poured into a glass filter to obtain only the precipitate filtered through the filter. Yield: 45% (4.20 g, grayish dark green powder).

$^1H$ NMR (300 MHz, $CD_2Cl_2$) δ (ppm) : 1.16 (d, J =6.9 Hz, 12H), 1.30 (d, J = 6.9 Hz, 12H), 2.27 (sept, J = 6.9 Hz, 4H), 7.37 (dd, J =6.3 Hz, 3.0 Hz, 2H), 7.49 (d, J = 7.8 Hz 4H), 7.70 (dd, J =6.3 Hz, 3.0 Hz, 2H), 7.72 (t, J = 7.8 Hz, 2H).
$^{13}C\{^1H\}$ NMR (126 MHz, $CD_2Cl_2$) δ (ppm) : 23.57, 25.19, 29.89, 113.94, 125.48, 127.94, 129.06, 132.73, 133.31, 146.54, 147.07, 147.21.
HR MS (FAB): Calcd for $C_{30}H_{40}N_2$ ($[M]^+$), 439.3108; Found: 439.3112.
Elemental analysis (C,H,N): Anal. Calcd for $C_{31}H_{39}ClN_2$: C, 78.37; H, 8.27; N, 5.90. Found: C, 74.25; H, 8.50; N, 5.44%.

3) Synthesis of Intermediate 7-(3)

A magnetic stir bar and 4.00 g (8.42 mmol) of Intermediate 7-(2) were placed in a 100 mL two-necked round-bottom flask, and argon was injected thereto. While stirring using a stirrer, 30 mL of anhydrous tetrahydrofuran (THF) was injected using a glass syringe, followed by stirring for 5 minutes at 25°C. 9.26 mL (9.26 mmol) of 1.0 molar (M) potassium bis(trimethylsilyl)amide in THF was injected into a reaction flask by using a glass syringe, while the flask was purged with argon. The mixture was stirred for 1 hour at a temperature of 25°C. 2.48 g (8.42 mmol) of chloro(dimethylsulfide)gold(I) ($AuClS(CH_3)_2$) was placed in a vial and dissolved in 10 mL of anhydrous THF while the vial was purged with argon. After injection using a glass syringe in the reaction flask, the mixture was stirred at 25°C. After stopping the stirring, Celite™ was placed on the filter, and the reaction solution was filtered through a 500 mL recovery flask. The reaction solvent was evaporated from the filtered solution using a rotary evaporator. Hexanes were added to the reaction solution and concentrated to a high concentration in dichloromethane as a solvent for precipitation. The precipitated solution was poured into a glass filter to obtain the precipitate filtered through the filter. Yield: 45% (2.58 g, grayish purple powder).

$^1H$ NMR (300 MHz, $CD_2Cl_2$) δ (ppm) : 1.10 (d, J =6.9 Hz, 12H), 1.32 (d, J = 6.9 Hz, 12H), 2.40 (sept, J = 6.9 Hz, 4H), 7.11 (dd, J =6.2 Hz, 3.0 Hz, 2H), 7.44 (dd, J =6.2 Hz, 3.0 Hz, 2H), 7.44 (d, J = 7.8 Hz 4H), 7.66 (t, J = 7.8 Hz, 2H).
$^{13}C\{^1H\}$ NMR (126 MHz, $CD_2Cl_2$) δ (ppm) : 24.16, 24.92, 29.48, 112.62, 125.25, 126.09, 131.60, 131.81, 135.08, 147.15, 182.07.
Elemental analysis (C,H,N): Anal. Calcd for $C_{31}H_{38}AuClN_2$: C, 55.48; H, 5.71; N, 4.17. Found: C, 55.86; H, 5.76; N, 4.12%.

4) Synthesis of Compound 7

A magnetic stir bar, 0.44 g (1.97 mmol) of 1,3,6,8-tetramethyl-9H-carbazole, 1.2 g (1.79 mmol) of Intermediate 7-(3), and 0.21 g (2.15 mmol) of $NaO^tBu$ were added to a 100 mL two necked round-bottom flask, and the flask was purged with argon. While stirring using a stirrer, 40 mL of anhydrous THF was injected using a glass syringe, followed by stirring over night at 25°C. After stopping the stirring, Celite™ was placed on the filter, and the reaction solution was filtered through a 500 mL recovery flask. The reaction solvent was evaporated from the filtered solution using a rotary

evaporator. Hexane was added to the reaction solution concentrated to a high concentration in dichloromethane as a solvent for precipitation. The precipitated solution was poured into a glass filter to obtain only the precipitate filtered through the filter. Yield: 90% (1.38 g, beige powder).

$^1$H NMR (300 MHz, $CD_2Cl_2$) $\delta$ (ppm) : 1.09 (d, J =6.9 Hz, 12H), 1.30 (d, J = 6.9 Hz, 12H), 2.00 (s, 6H), 2.37 (s, 6H), 2.53 (sept, J = 6.9 Hz, 4H), 6.67 (s, 2H), 7.07 (dd, J =6.2 Hz, 3.0 Hz, 2H), 7.42 (dd, J =6.2 Hz, 3.0 Hz, 2H), 7.51 (s, 2H), 7.51 (d, J = 7.8 Hz 4H), 7.74 (t, J = 7.8 Hz, 2H).

$^{13}$C{$^1$H} NMR (126 MHz, $CD_2Cl_2$) $\delta$ (ppm) : 21.17, 21.37, 24.28, 24.71, 29.55, 112.55, 116.88, 122.75, 125.15, 125.22, 125.77, 125.78, 127.37, 131.83, 132.54, 135.43, 147.06, 147.33, 184.14.

HR MS (FAB): Calcd for $C_{47}H_{54}AuN_3$, 857.3983; Found: 857.3973.

Elemental analysis (C,H,N): Anal. Calcd for $C_{47}H_{54}AuN_3$: C, 65.80; H, 6.34; N, 4.90. Found: C, 65.96; H, 6.31; N, 4.80%.

Synthesis Example 2: Synthesis of Compound 8 not forming part of the present invention.

A magnetic stir bar, 0.33 g (1.97 mmol) of carbazole, 1.2 g (1.79 mmol) of Intermediate 7-(3), and 0.21 g (2.15 mmol) of $NaO^tBu$ were added to a 100 mL two necked round-bottom flask, and the flask was purged with argon. While stirring using a stirrer, 40 mL of anhydrous THF was injected using a glass syringe, followed by stirring over night at 25°C. After stopping the stirring, Celite™ was placed on the filter, and the reaction solution was filtered through a 500 mL recovery flask. The reaction solvent was evaporated from the filtered solution using a rotary evaporator. Hexane was added to the reaction solution concentrated to a high concentration in dichloromethane as a solvent for precipitation. The precipitated solution was poured into a glass filter to obtain only the precipitate filtered through the filter. Yield: 88% (1.27 g, light purple powder).

$^1$H NMR (300 MHz, $CD_2Cl_2$) $\delta$ (ppm) : 1.16 (d, J =6.9 Hz, 12H), 1.35 (d, J = 6.9 Hz, 12H), 2.56 (sept, J = 6.9 Hz, 4H), 6.69 (ddd, J =7.8 Hz, 1.2 Hz, 6 Hz, 2H), 6.87 (td, J =7.2 Hz, 1.2 Hz 3.0 Hz, 2H), 7.04 (td, J =7.2 Hz, 1.2 Hz 3.0 Hz, 2H), 7.24 (dd, J =6.2 Hz, 3.0 Hz, 2H), 7.49 (dd, J =6.2 Hz, 3.0 Hz, 2H), 7.53 (d, J = 7.8 Hz 4H), 7.76 (t, J = 7.8 Hz, 2H), 6.69 (ddd, J =7.8 Hz, 1.2 Hz, 6 Hz, 2H).

$^{13}$C{$^1$H} NMR (126 MHz, $CD_2Cl_2$) $\delta$ (ppm) : 24.37, 24.89, 29.66, 112.51, 114.01, 116.32, 119.66, 123.96, 124.09, 125.22, 125.90, 131.53, 132.19, 135.51, 147.62, 149.90, 185.93.

HR MS (FAB): Calcd for $C_{43}H_{46}AuN_3$, 801.3357; Found: 801.3362.

Elemental analysis (C,H,N): Anal. Calcd for $C_{43}H_{46}AuN_3$: C, 64.41; H, 5.78; N, 5.24. Found: C, 64.49; H, 5.75; N, 5.14%.

Example 1-1

As a glass substrate, ITO electrode-patterned having a thickness of 50 nm was sonicated in acetone, isopropyl alcohol, and deionized (DI) water for about 15 minutes each, and cleaned by exposure to ultraviolet (UV) rays and ozone for 30 minutes.

Subsequently, NDP-9 was deposited on the ITO electrode (anode) the glass substrate to a thickness of 10 nm, HT211 was deposited thereon to a thickness of 40 nm, and 2,2'-di(9H-carbazol-9-yl)biphenyl (o-CBP) was deposited thereon to a thickness of 10 nm.

Then, HT host (as a first compound), ET host (as a second compound), Compound 7 (as a sensitizer), and BD1-8 were co-deposited thereon in the ratio shown in Table 1 to form an emission layer having a thickness of 30 nm.

9-(3-(9H-carbazol-9-yl)phenyl)-9H-carbazol-3,6-dicarbonitrile (mCP-2CN) was deposited on the emission layer to a thickness of 10 nm, DPEPO and LiQ were co-deposited thereon (at a weight ratio of 1:1) to a thickness of 30 nm, LiQ was deposited thereon to a thickness of 1 nm, and Al was deposited thereon to a thickness of 100 nm, thereby completing the manufacture of an organic light-emitting device having a structure of ITO (50 nm)/NDP-9 (10 nm)/HT211 (40 nm)/o-CBP (10 nm)/emission layer (30 nm)/mCP-2CN (10 nm)/DPEPO:LiQ (1:1) (30 nm)/LiQ (1 nm)/Al (100 nm).

Example 1-2 and Comparative Examples 1-1 to 1-3 and Examples 2-1 and 2-2, Comparative Examples 2-1 and 2-2

Organic light-emitting devices were manufactured in substantially the same manner as in Example 1, except that the host, the sensitizer, and the emitter were used in the emission layer as shown in Table 1. The amounts of sensitizer and emitter are each based on based on the total weight of the emission layer.

Examples 1-2 and 2-2 are reference examples not forming part of the present invention.

Table 1

| | First compound | Second compound | Weight ratio: First compound to second compound | Sensitizer | Sensitizer content (wt%) | Emitter | Emitter content (wt%) |
|---|---|---|---|---|---|---|---|
| Example 1-1 | HT host | ET host | 6:4 | Compound 7 | 20 | BD1-8 | 3 |
| Example 1-2 | HT host | ET host | 6:4 | Compound 8 | 20 | BD1-5 | 3 |
| Comparative Example 1-1 | HT host | ET host | 6:4 | - | - | Compound 7 | 20 |
| Comparative Example 1-2 | HT host | ET host | 6:4 | - | - | Compound 8 | 20 |
| Comparative Example 1-3 | HT host | ET host | 6:4 | - | - | BD1-9 | 20 |
| Example 2-1 | HT host | ET host | 6:4 | Compound 7 | 20 | BD1-8 | 1.5 |
| Example 2-2 | HT host | ET host | 6:4 | Compound 8 | 20 | BD1-5 | 1.5 |
| Comparative Example 2-1 | HT host | ET host | 6:4 | BD1-9 | 20 | BD1-8 | 1.5 |
| Comparative Example 2-2 | HT host | ET host | 6:4 | BD1-9 | 20 | BD1-5 | 1.5 |

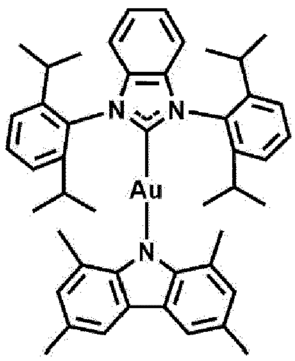

7

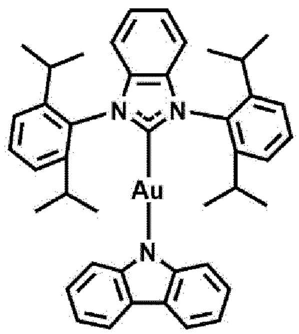

8

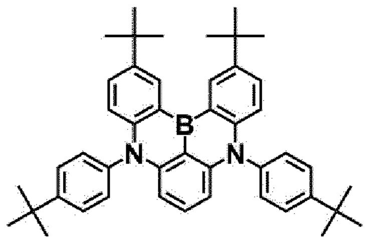

BD1-9

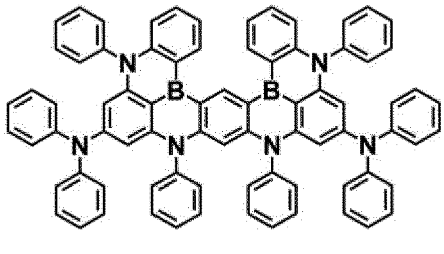

BD1-5

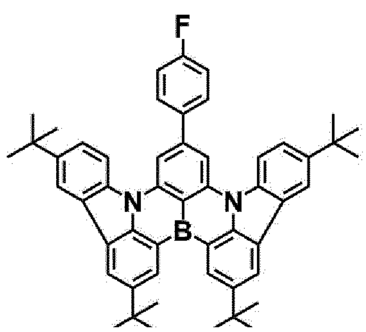

BD1-8

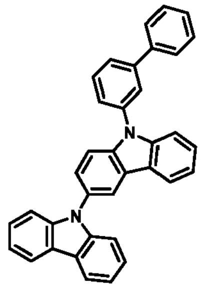

HT host

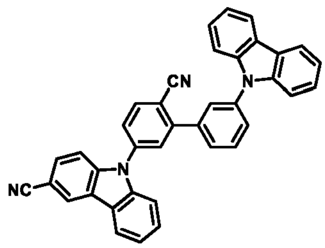

ET host

Evaluation Example 1

The driving voltage (volts, V), current efficiency (candela per ampere, cd/A), maximum external quantum efficiency (EQE, %), maximum emission wavelength ($\lambda_{max}$, nm), full width at half maximum (FWHM, nm), lifespan ($T_{95}$, hours), and lifespan ($T_{80}$, hours) of the organic light-emitting devices manufactured in Example 1-1 and reference Example 1-2, Example 2-1 and reference Example 2-2, Comparative Examples 1-1 to 1-3, and Comparative Example 2-1 and 2-2 were evaluated. The results thereof are shown in Table 2. The lifespan ($T_{95}$) indicates a time (hour) for the luminance at 1,000 cd/$m^2$ of each organic light-emitting device to decline to 95 % of its initial luminance. The lifespan ($T_{80}$) indicates a time (hour) for the luminance at 1,000 cd/$m^2$ of each organic light-emitting device to decline to 80 % of its initial luminance.

Table 2

| Structure | Driving voltage (V) | Current efficiency (cd/A) | Maximum EQE (%) | $\lambda_{max}$ (nm) | FWHM (nm) | $T_{95}$ (hours) | $T_{80}$ (hours) |
|---|---|---|---|---|---|---|---|
| Example 1-1 | 4.68 | 44.09 | 21.9 | 496 | 31 | 8.83 | 80.60 |
| Example 1-2 | 4.47 | 25.50 | 30.2 | 475 | 20 | 1.43 | 11.10 |
| Comparative Example 1-1 | 4.49 | 40.84 | 14.8 | 519 | 90 | 2.66 | 26.85 |
| Comparative Example 1-2 | 5.01 | 12.24 | 7.9 | 492 | 79 | 0.43 | 2.58 |
| Comparative Example 1-3 | 6.64 | 2.84 | 13.4 | 519 | 31 | 0.16 | 0.75 |
| Example 2-1 | 4.61 | 43.89 | 22.8 | 494 | 29 | 9.19 | 79.36 |
| Example 2-2 | 4.53 | 24.78 | 29.1 | 474 | 19 | 2.12 | 13.34 |
| Comparative Example 2-1 | 4.85 | 22.76 | 21.4 | 519 | 28 | 2.95 | 15.61 |
| Comparative Example 2-2 | 6.15 | 4.22 | 14.8 | 519 | 26 | 0.16 | 0.90 |

Referring to the results of Table 2, the organic light-emitting device of Example 1-1 was found to have improved luminescence efficiency, lifespan, and/or colorimetric purity, as compared with the organic light-emitting devices of Comparative Examples 1-1, 1-2, and 1-3. Accordingly, it was found that an organic light-emitting device using the compound represented by Formula 1 as a sensitizer was found to have improved luminescence efficiency, lifespan, and/or colorimetric purity, as compared with an organic light-emitting device using the compound represented by Formula 1 as an emitter.

In addition, referring to the results of Table 2, the organic light-emitting device of Example 2-1 was found to have improved lifespan and/or colorimetric purity, as compared with the organic light-emitting devices of Comparative Examples 2-1 and 2-2. Accordingly, it was found that an organic light-emitting device using the compound represented by Formula 1 as a sensitizer was found to have improved luminescence efficiency, lifespan, and/or colorimetric purity, as compared with an organic light-emitting device using another known organic compound as a sensitizer.

As apparent from the foregoing description, the organic light-emitting device may have a long lifespan.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

**1.** An organic light-emitting device, comprising:

a first electrode (11);
a second electrode (19); and
an organic layer (10A) located between the first electrode and the second electrode wherein the organic layer comprises an emission layer (15),
wherein the emission layer comprises a host, a sensitizer, and an emitter,
wherein the host, the sensitizer, and the emitter are different from each other, and
wherein the sensitizer is represented by Formula 1:

Formula 1 $M_1(L_1)(L_2)$

wherein, in Formula 1,

$M_1$ is Au, Ag, or Cu,
$L_1$ is a ligand represented by Formula 2-1 or Formula 2-2, and
$L_2$ is a ligand represented by Formula 3-3:

Formula 2-1

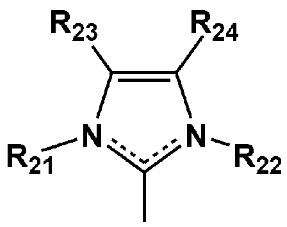

Formula 2-2

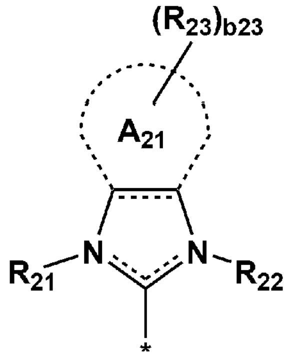

Formula 3-3

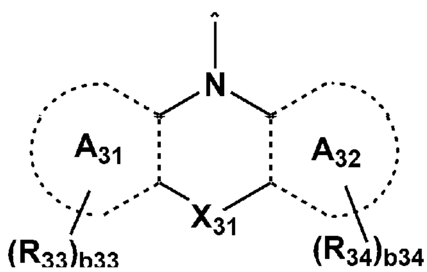

wherein, in Formulae 2-1, 2-2, and 3-3,

$A_{21}$, $A_{31}$, and $A_{32}$ are each independently a monocyclic or polycyclic $C_5$-$C_{30}$ carbocyclic group or a monocyclic or polycyclic $C_1$-$C_{30}$ heterocyclic group,
$X_{31}$ is a single bond, O, S, $N(R_{36})$, $C(R_{36})=C(R_{37})$, $[C(R_{36})(R_{37})]_{n31}$, or $[Si(R_{36})(R_{37})]_{n31}$, wherein n31

is 1 or 2,

$R_{21}$ and $R_{22}$ are each independently a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group,

$R_{23}$, $R_{24}$, $R_{36}$, and $R_{37}$ are each independently hydrogen, deuterium, -F, -Cl, -Br, - I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), -C($Q_1$)($Q_2$)($Q_3$), -B($Q_1$)($Q_2$), -N($Q_1$)($Q_2$), -P($Q_1$)($Q_2$), - C(=O)($Q_1$), -S(=O)($Q_1$), -S(=O)$_2$($Q_1$), -P(=O)($Q_1$)($Q_2$), or-P(=S)($Q_1$)($Q_2$), and

$R_{36}$ and $R_{37}$ are optionally linked to each other to form a substituted or unsubstituted $C_5$-$C_{30}$ carbocyclic group or a substituted or unsubstituted $C_1$-$C_{30}$ heterocyclic group,

$R_{33}$ and $R_{34}$ are each independently a substituted or unsubstituted $C_1$-$C_{60}$ alkyl group, and

b23 and b33 are each independently 1, 2, 3, 4, 5, 6, 7, 8, 9, or 10,

wherein $Q_1$ to $Q_3$ are each independently hydrogen, deuterium, -F, -Cl, -Br, -I, - $SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{66}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, a cyano group, a $C_1$-$C_{20}$ alkyl group, and a $C_6$-$C_{30}$ aryl group, a $C_6$-$C_{60}$ aryl group, or a combination thereof, and

* indicates a binding site to $M_1$ in Formula 1; and **characterized in that** b34 is 2, 3, 4, 5, 6, 7, 8, 9, or 10.

**2.** The organic light-emitting device of claim 1, wherein $A_{21}$, $A_{31}$, and $A_{32}$ are each independently a benzene group, a naphthalene group, a phenanthrene group, a furan group, a thiophene group, a pyrrole group, a cyclopentene group, a silole group, a germole group, a benzofuran group, a benzothiophene group, an indole group, an indene group, a benzosilole group, a benzogermole group, a dibenzofuran group, a dibenzothiophene group, a carbazole group, a fluorene group, a dibenzosilole group, a dibenzogermole group, a pyridine group, a pyrimidine group, a pyridazine group, or a pyrazine group;

preferably wherein $A_{21}$ is a benzene group, a naphthalene group, a pyridine group, a pyrimidine group, a pyridazine group, or a pyrazine group, and

$A_{31}$ and $A_{32}$ are each independently a benzene group, a naphthalene group, a dibenzofuran group, a dibenzothiophene group, a carbazole group, a pyridine group, a pyrimidine group, a pyridazine group, or a pyrazine group.

**3.** The organic light-emitting device of claims 1 or 2, wherein

$L_1$ is a ligand represented by Formula 2-11 or Formula 2-12, and

$L_2$ is a ligand represented by one of Formulae 3-13 to 3-17:

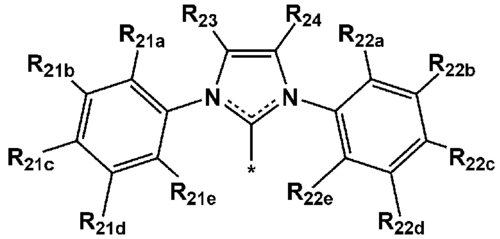

2-11

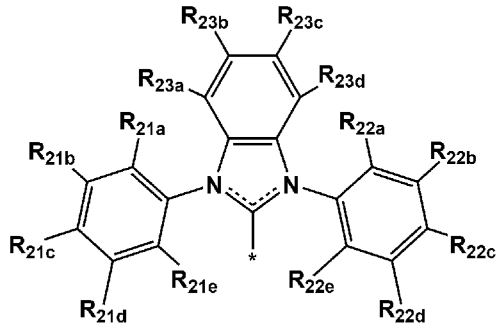

2-12

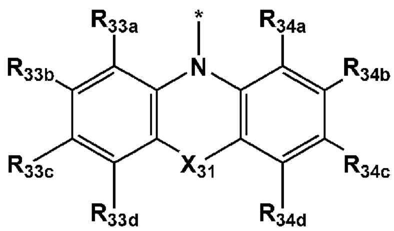

3-13

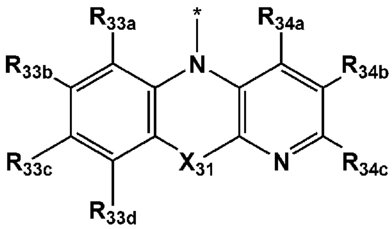

3-14

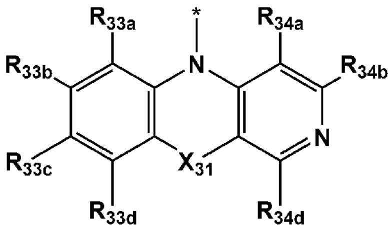

3-15

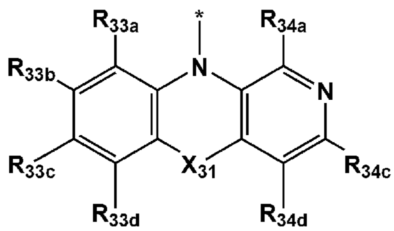

3-16

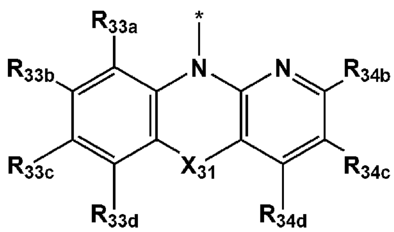

3-17

wherein, in Formulae 2-11, 2-12, and 3-13 to 3-17,

$X_{31}$, $R_{23}$, and $R_{24}$ are as defined in claim 1, and
$R_{21a}$ to $R_{21e}$, $R_{22a}$ to $R_{22e}$, and $R_{23a}$ to $R_{23d}$ are each independently hydrogen, deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a($C_1$-$C_{20}$ alkyl)cyclopentenyl group, a ($C_1$-$C_{20}$ alkyl)cyclohexenyl group, a ($C_1$-$C_{20}$

alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, - $N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, or - $P(=S)(Q_{21})(Q_{22})$,

$R_{33a}$ to $R_{33d}$ and $R_{34a}$ to $R_{34d}$ are each independently a $C_1$-$C_{20}$ alkyl group or a deuterated $C_2$-$C_{20}$ alkyl group, wherein $Q_{21}$ to $Q_{23}$ are each independently: hydrogen, deuterium, -F, a cyano group, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, - $CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$, or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof, and

* indicates a binding site to $M_1$ in Formula 1;

preferably wherein

$L_1$ is a ligand represented by Formula 2-11 or Formula 2-12, and
$L_2$ is a ligand represented by Formula 3-13.

**4.** The organic light-emitting device of any of claims 1-3, wherein $L_1$ is a ligand represented by one of Formulae 2-21 to 2-26:

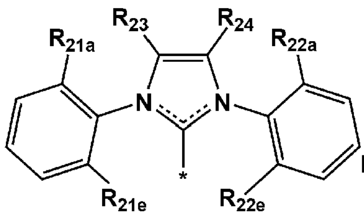

2-21

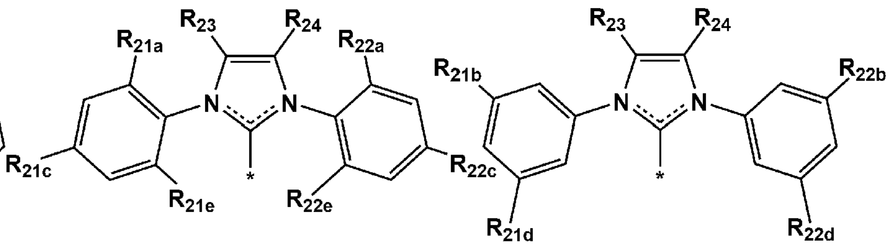

2-22 2-23

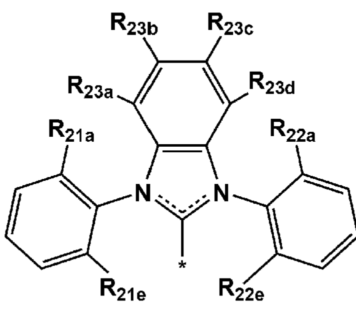

2-24

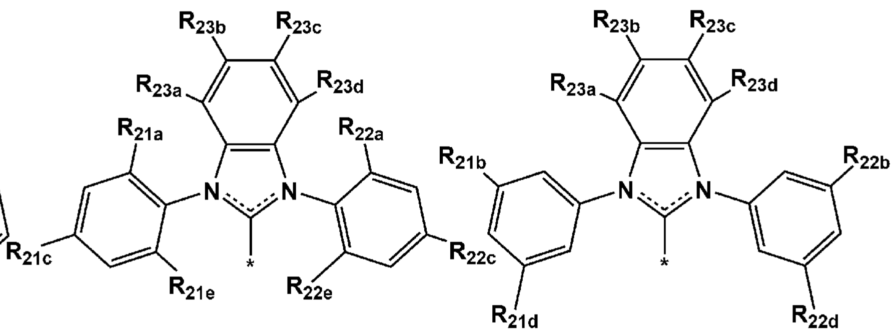

2-25 2-26

wherein, in Formulae 2-21 to 2-26,

$R_{23}$, $R_{24}$, and $R_{23a}$ to $R_{23d}$ are each independently: hydrogen, deuterium, -F, -Cl, -Br, -I, $-SF_5$, a hydroxyl group, a cyano group, or a nitro group;

a $C_1$-$C_{20}$ alkyl group unsubstituted or substituted with at least one of deuterium, - F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, $-Si(Q_{11})(Q_{12})(Q_{13})$, $-Ge(Q_{11})(Q_{12})(Q_{13})$, - $C(0_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, - $S(=O)_2(Q_{11})$, $-P(=O)(Q_{11})(Q_{12})$, $-P(=S)(Q_{11})(Q_{12})$, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, - $Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, - $P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, or a combination thereof; or

$-Si(Q_1)(Q_2)(Q_3)$, $-Ge(Q_1)(Q_2)(Q_3)$, $-C(Q_1)(Q_2)(Q_3)$, $-B(Q_1)(Q_2)$, or $-N(Q_1)(Q_2)$, and

$R_{21a}$, $R_{21b}$, $R_{21c}$, $R_{21d}$, $R_{21e}$, $R_{22a}$, $R_{22b}$, $R_{22c}$, $R_{22d}$, and $R_{22e}$ are each independently hydrogen, deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a sulfonic acid group or a salt thereof, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl

group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, or $-P(=S)(Q_{21})(Q_{22})$,

wherein $Q_1$ to $Q_3$, $Q_{11}$ to $Q_{13}$, and $Q_{21}$ to $Q_{23}$ are each independently: hydrogen, deuterium, -F, a cyano group, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof, and

* indicates a binding site to $M_1$ in Formula 1; and/or

wherein $L_2$ is a ligand represented by one of Formulae 3-21 to 3-26:

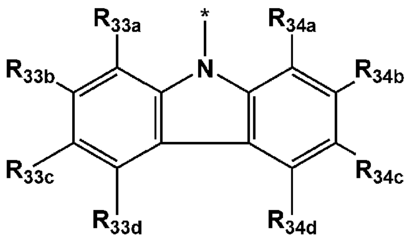

3-21

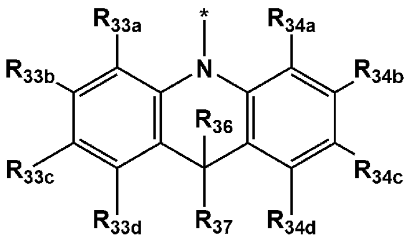

3-22

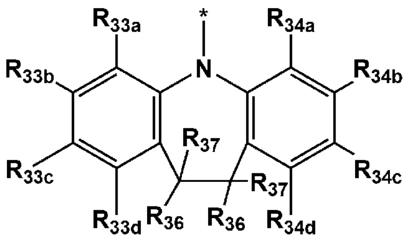

3-23

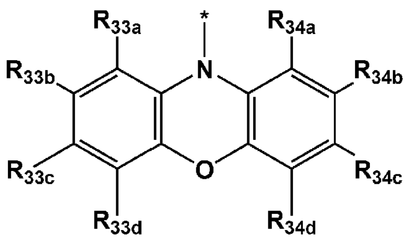

3-24

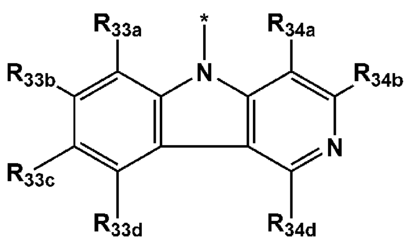

3-25

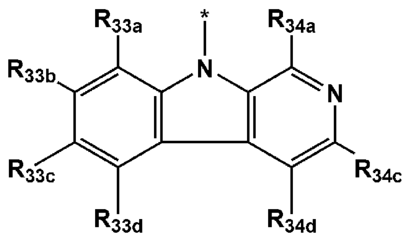

3-26

wherein, in Formulae 3-21 to 3-26,

$R_{36}$ and $R_{37}$ are each independently: hydrogen, deuterium, -F, -Cl, -Br, -I, $-SF_5$, a hydroxyl group, a cyano group, or a nitro group;

a $C_1$-$C_{20}$ alkyl group unsubstituted or substituted with at least one of deuterium, - F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$

alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, $-Si(Q_{11})(Q_{12})(Q_{13})$, $-Ge(Q_{11})(Q_{12})(Q_{13})$, $-C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, $-S(=O)_2(Q_{11})$, $-P(=O)(Q_{11})(Q_{12})$, $-P(=S)(Q_{11})(Q_{12})$, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a deuterated $C_2$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrazinyl group, a pyrimidinyl group, a pyridazinyl group, a quinolinyl group, an isoquinolinyl group, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, or a combination thereof; or

$-Si(Q_1)(Q_2)(Q_3)$, $-Ge(Q_1)(Q_2)(Q_3)$, $-C(Q_1)(Q_2)(Q_3)$, $-B(Q_1)(Q_2)$, or $-N(Q_1)(Q_2)$, and

$R_{33a}$ to $R_{33d}$ and $R_{34a}$ to $R_{34d}$ are each independently a $C_1$-$C_{20}$ alkyl group or a deuterated $C_2$-$C_{20}$ alkyl group,

wherein $Q_1$ to $Q_3$, $Q_{11}$ to $Q_{13}$, and $Q_{21}$ to $Q_{23}$ are each independently: hydrogen, deuterium, -F, a cyano group, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a deuterated $C_1$-$C_{10}$ alkyl group, a phenyl group, or a combination thereof, and

* indicates a binding site to $M_1$ in Formula 1.

**5.** The organic light-emitting device of any of claims 1, 2, and 4, wherein the sensitizer is selected from Group I:

Group I

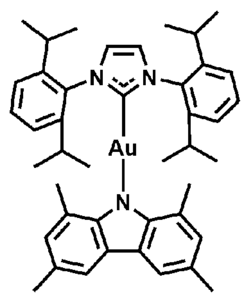

1

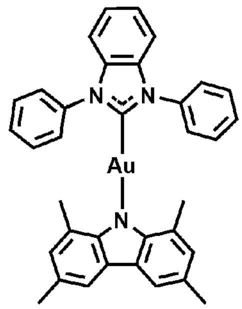

3

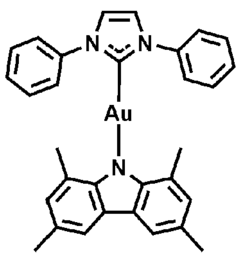

5

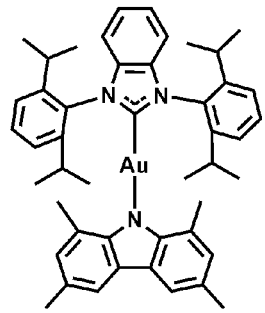

7

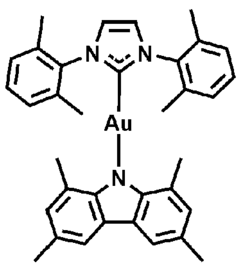

9

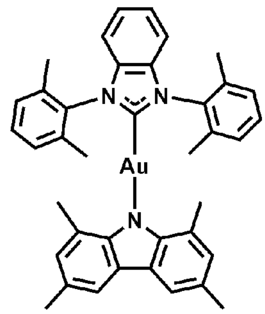

11

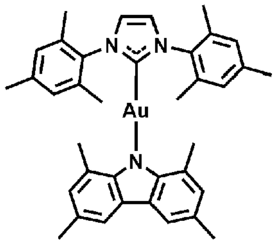

13

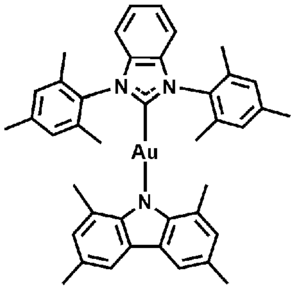

15

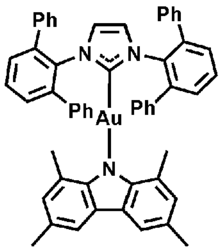

17

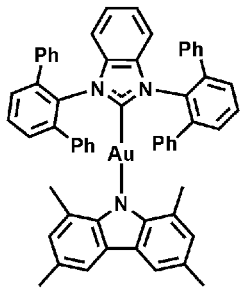

19

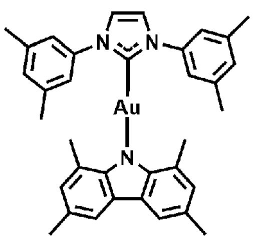

21

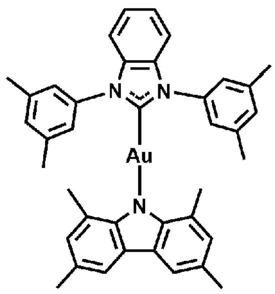

23

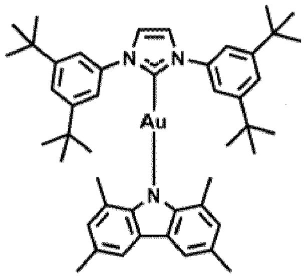

25

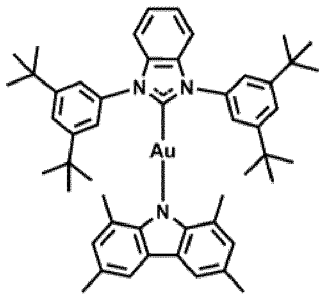

27

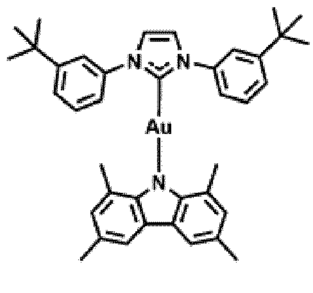

29

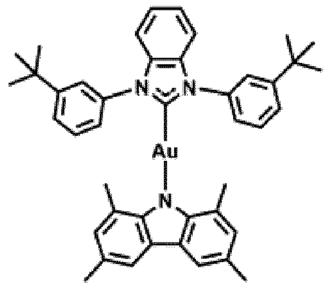

31

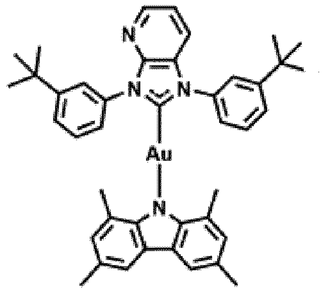

33

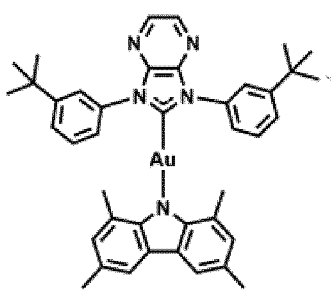

35

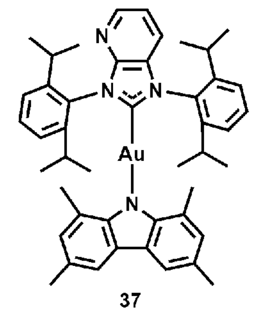

37

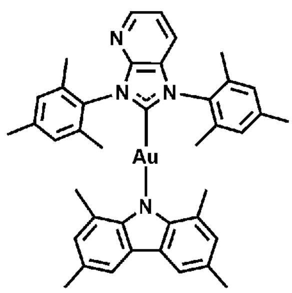

39

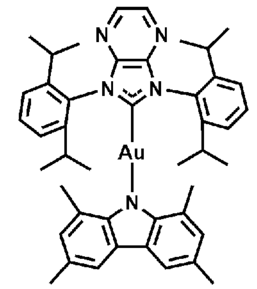

41

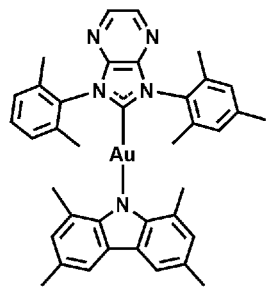

43

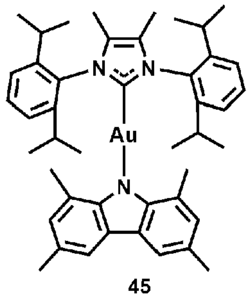

45

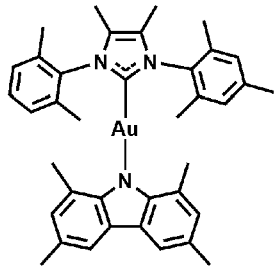

47

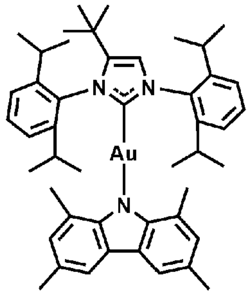

49

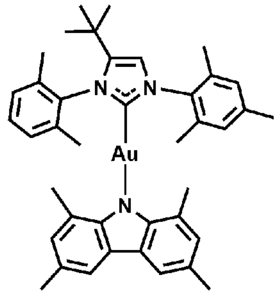

51

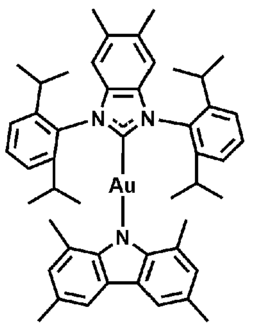

53

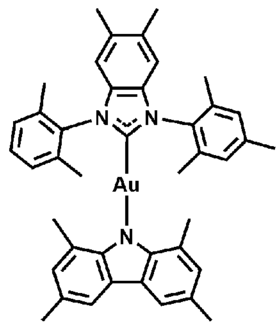

55

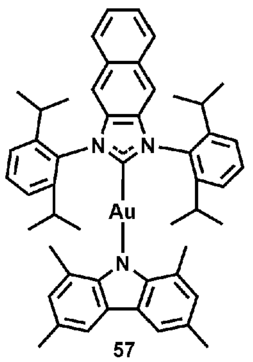

57

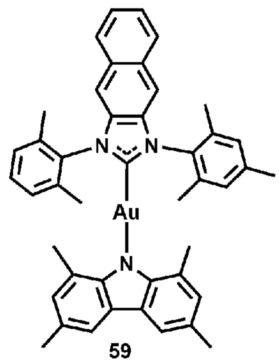

59

wherein, in Group 1, "Ph" represents a phenyl group.

**6.** The organic light-emitting device of any of claims 1-5, wherein

the host comprises at least one of a hole transporting host, an electron transporting host, or a bipolar host,
the electron transporting host comprises at least one electron transporting moiety,
the hole transporting host comprises a hole transporting moiety and does not comprise an electron transporting moiety,
the bipolar host comprises at least one electron transporting moiety and at least one hole transporting moiety,
the electron transporting moiety is a cyano group, -F, $-CFH_2$, $-CF_2H$, $-CF_3$, a $\pi$ electron-depleted nitrogen-containing $C_1$-$C_{60}$ cyclic group, or a group represented by one of Formulae ET-moiety,
the hole transporting moiety is a $\pi$ electron-rich $C_3$-$C_{60}$ cyclic group or a groups represented by Formula HT-

moiety:

ET-moiety

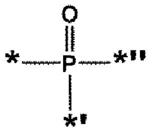 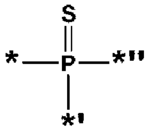 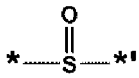 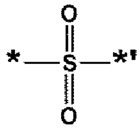

HT-moiety

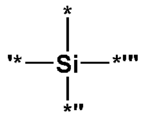

wherein, in Formulae ET-moiety and HT-moiety, *, *', *", and *''' each indicate a binding site to an adjacent atom.

**7.** The organic light-emitting device of any of claims 1-6, wherein the host comprises a first compound and a second compound,

i) the first compound isa hole transporting host, and the second compound is an electron transporting host,
ii) the first compound is an electron transporting host, and the second compound is a hole transporting host,
iii) the first compound and the second compound are each a bipolar host,
iv) the first compound is a hole transporting hosts, and the second compound a bipolar host,
v) the first compound is an electron transporting host, and the second compound is a bipolar host,
vi) the first compound is a bipolar host, and the second compound is a hole transporting host, or
vii) the first compound is a bipolar host, and the second compound is an electron transporting host.

**8.** The organic light-emitting device of any of claims 1-7, wherein the emitter has a decay time less than 100 microseconds; and/or
wherein the emitter comprises a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a picene-containing core, a perylene-containing core, a pentacene-containing core, an indenoanthracene-containing core, a tetracene-containing core, a bisanthracene-containing core, or a core represented by one of Formulae 501-1 to 501-21:

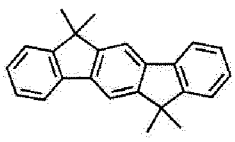
501-1

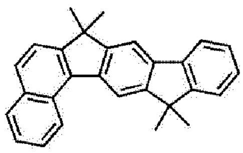
501-2

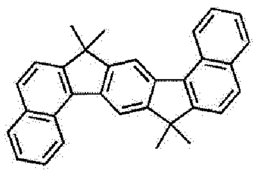
501-3

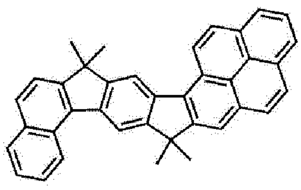
501-4

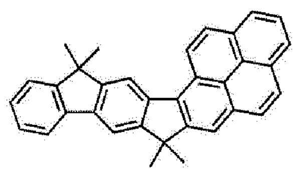
501-5

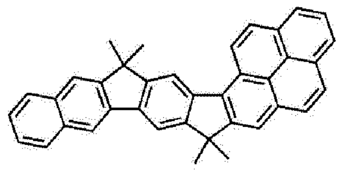
501-6

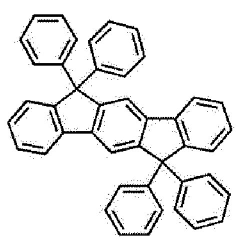

501-7

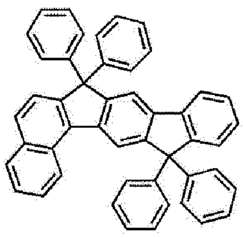

501-8

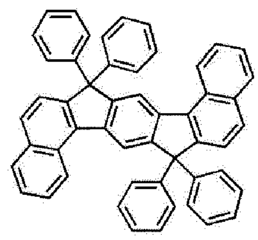

501-9

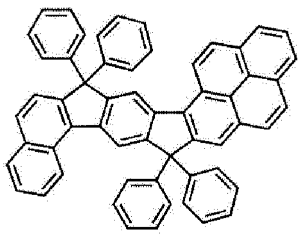

501-10

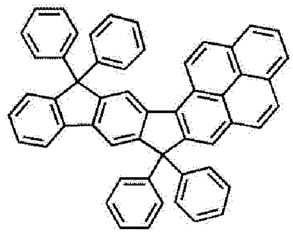

501-11

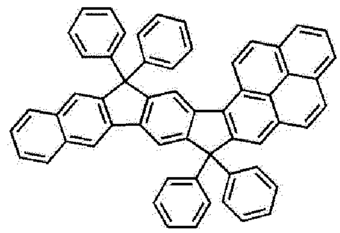

501-12

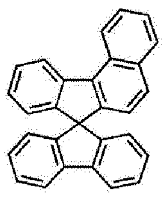

501-13

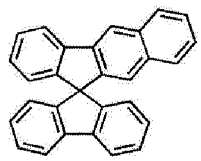

501-14

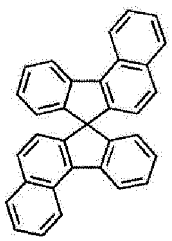

501-15

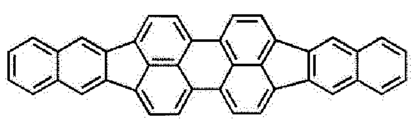

501-16

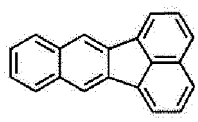

501-17

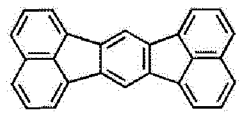

501-18

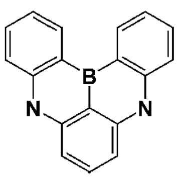

501-19

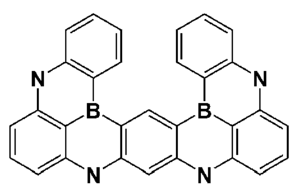

501-20

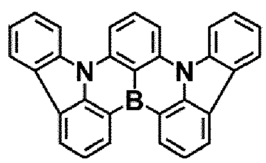

501-21

**9.** The organic light-emitting device of any of claims 1-8, wherein the emitter is represented by Formula 51:

Formula 51

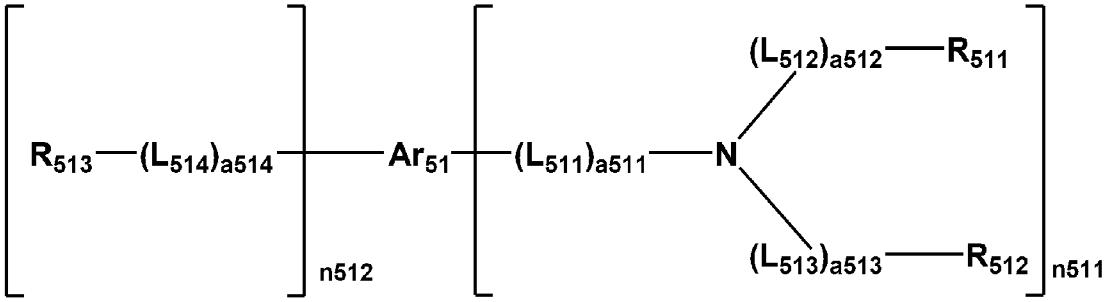

wherein, in Formula 51,

$Ar_{51}$ is a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a picene group, a perylene group, a pentacene group, an indenoanthracene group, a tetracene group, a bisanthracene group, or a group represented by one of Formulae 501 - 1 to 501-21, each unsubstituted or substituted with at least one of deuterium, -F, -Cl, -Br, -I, $-SF_5$, a hydroxyl group, a cyano group, a nitro group, an amidino group, a hydrazine group, a hydrazone group, a sulfonic acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{20}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{511})(Q_{512})(Q_{513})$, $-Ge(Q_{511})(Q_{512})(Q_{513})$, $-C(Q_{511})(Q_{512})(Q_{513})$, $-B(Q_{511})(Q_{512})$, $-N(Q_{511})(Q_{512})$, $-P(Q_{511})(Q_{512})$, $-C(=O)(Q_{511})$, $-S(=O)(O_{511})$, $-S(=O)_2(O_{511})$, $-P(=O)(Q_{511})(Q_{512})$, $-P(=S)(Q_{511})(Q_{512})$, or a combination thereof:

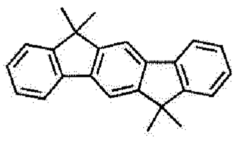

501-1

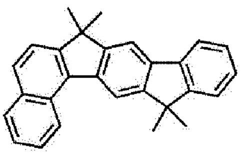

501-2

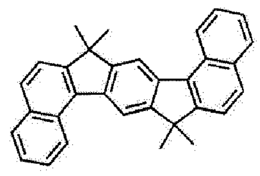

501-3

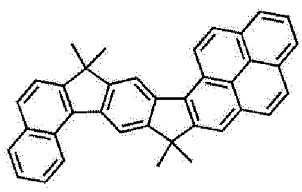

501-4

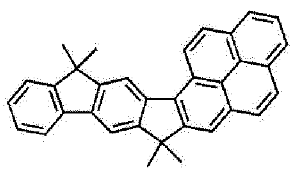

501-5

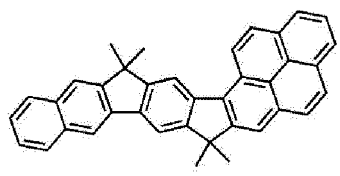

501-6

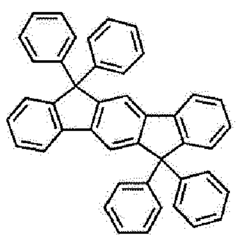

501-7

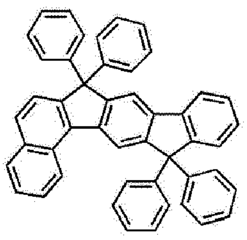

501-8

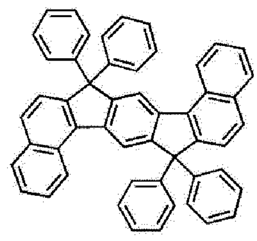

501-9

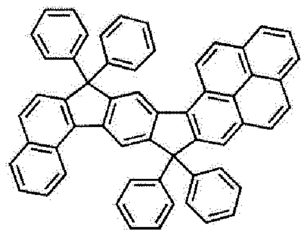
501-10

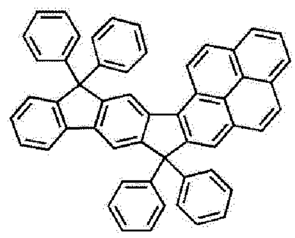
501-11

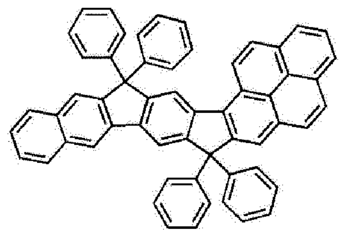
501-12

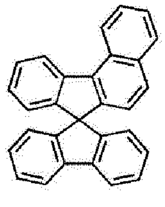
501-13

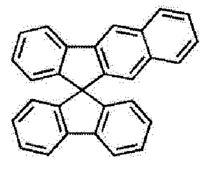
501-14

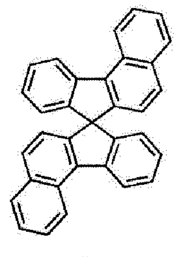
501-15

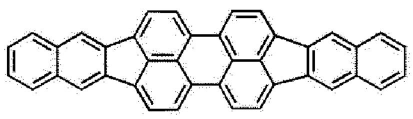
501-16

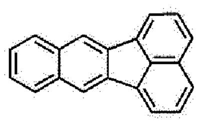
501-17

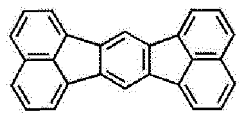
501-18

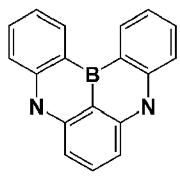
501-19

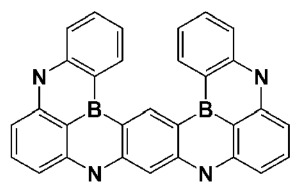
501-20

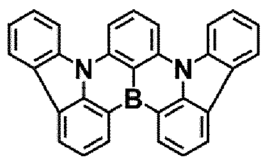
501-21

,

$L_{511}$ to $L_{514}$ are each independently a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

a511 to a514 are each independently 0, 1, 2, or 3,

$R_{511}$ to $R_{513}$ are each independently a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted monovalent non-aromatic condensed polycyclic group, or a substituted or unsubstituted monovalent non-aromatic condensed heteropolycyclic group,

wherein $Q_{511}$ to $Q_{513}$ are each independently hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed

polycyclic group, or a monovalent non-aromatic condensed heteropolycyclic group, each unsubstituted or substituted with at least one of deuterium, -F, a cyano group, a $C_1$-$C_{20}$ alkyl group, a $C_6$-$C_{30}$ aryl group, or a combination thereof, and

n511 and n512 are each independently 0, 1, 2, 3, 4, 5, or 6.

**10.** The organic light-emitting device of any of claims 1-9, wherein the emitter is a compound represented by one of Group FD1:

Group FD1

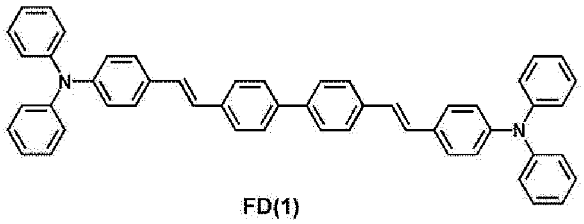

FD(1)

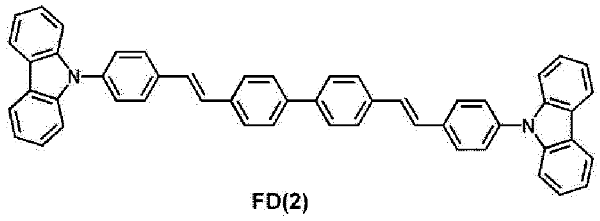

FD(2)

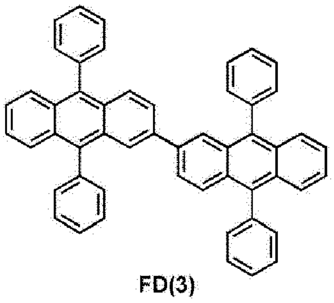

FD(3)

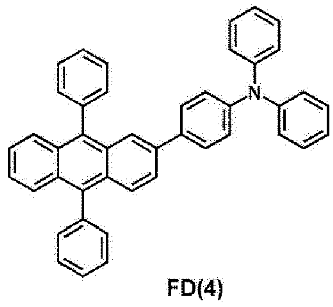

FD(4)

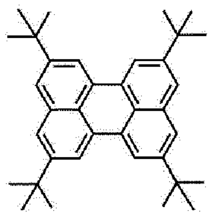

FD(5)

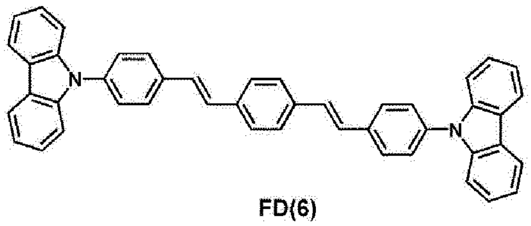

FD(6)

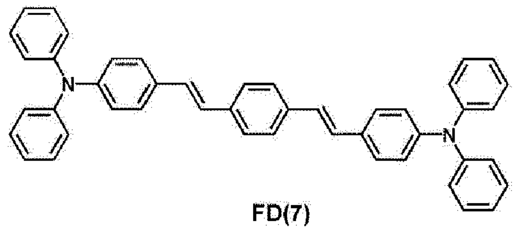

FD(7)

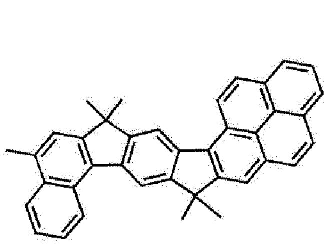

FD(8)

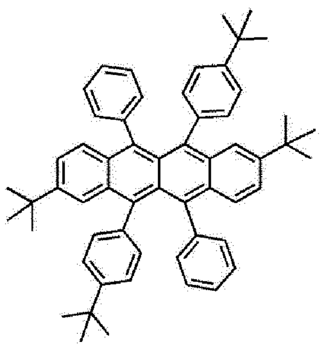

FD(9)

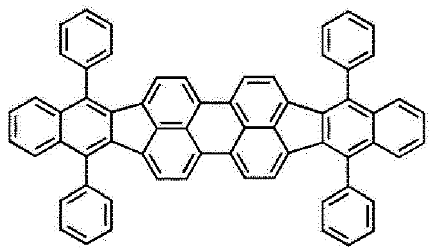

FD(10)

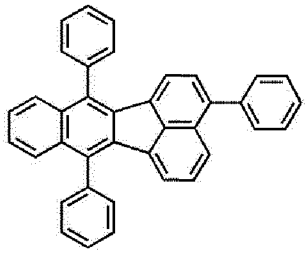

FD(11)

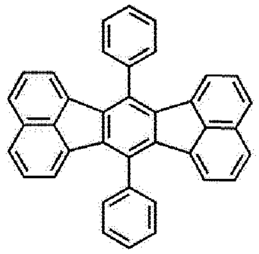

FD(12)

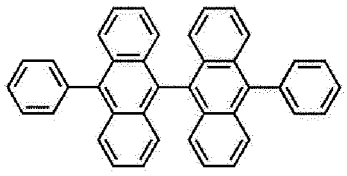

FD(13)

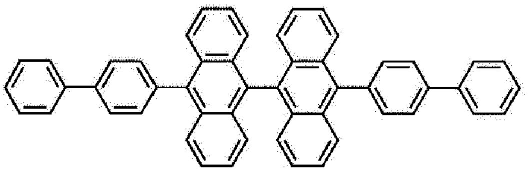

FD(14)

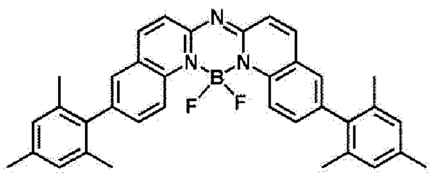

FD(15)

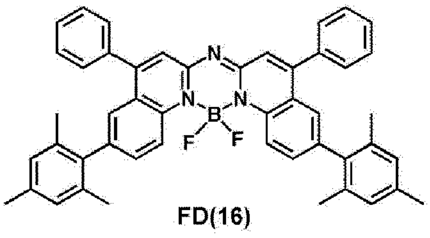

FD(16)

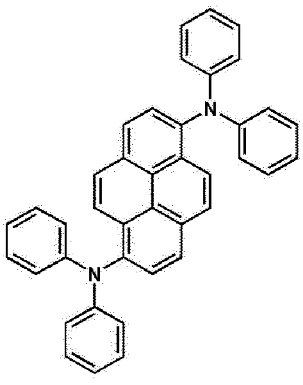

FD1

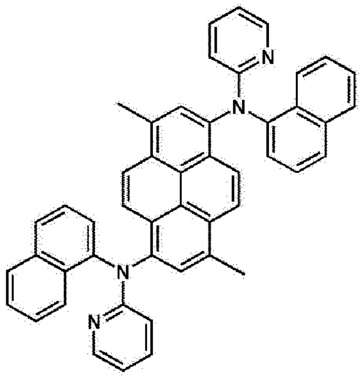

FD2

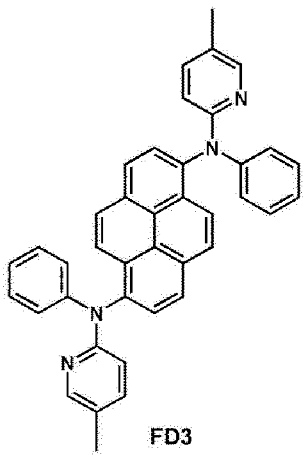

FD3

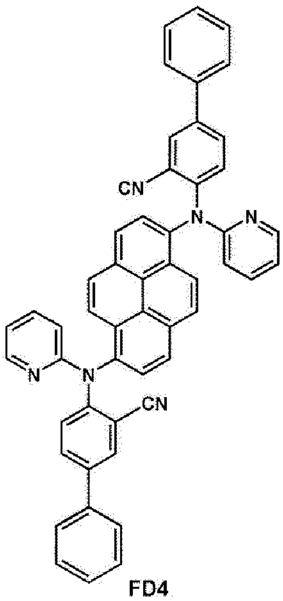

FD4

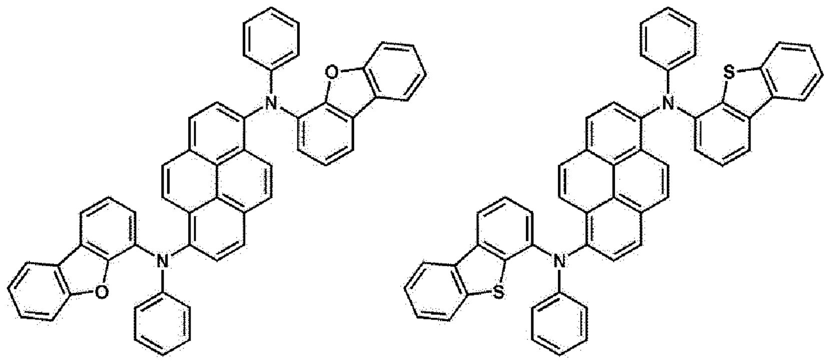

FD5 FD6

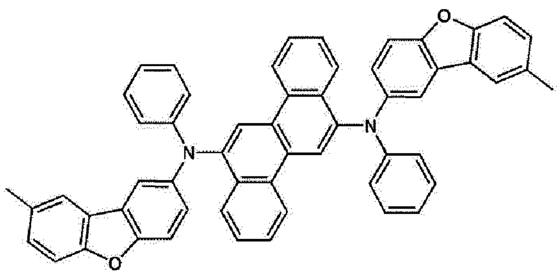

FD7

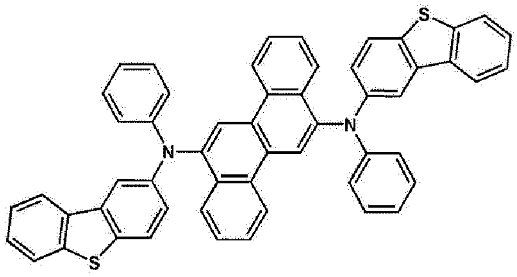

FD8

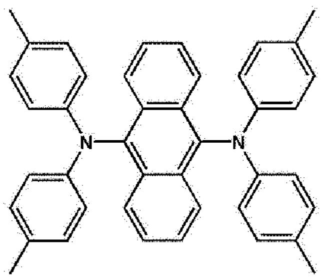

FD9

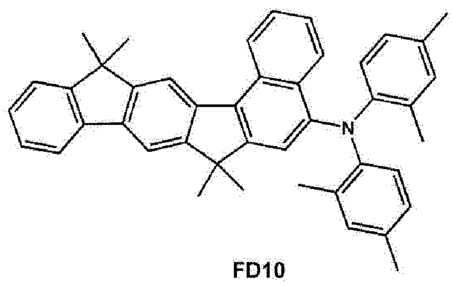

FD10

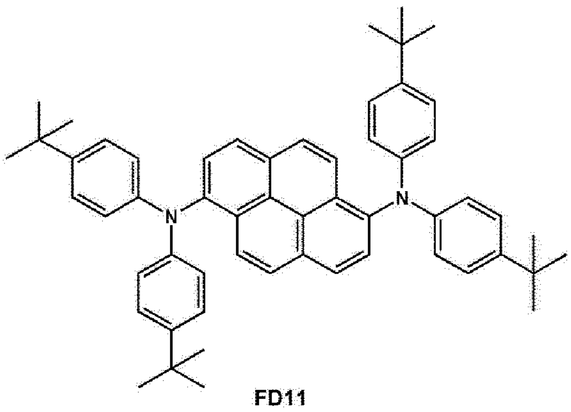

FD11

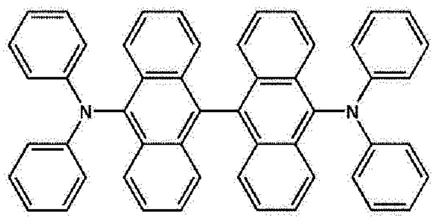

FD12

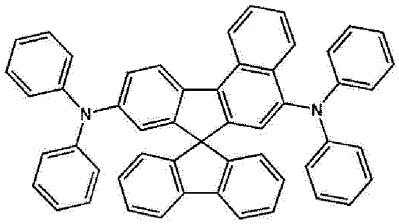

FD13

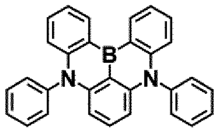

BD1-1

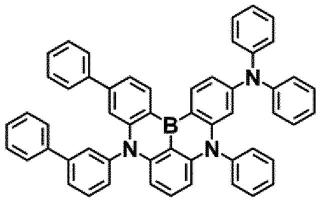

BD1-2

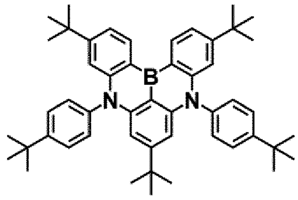

BD1-3

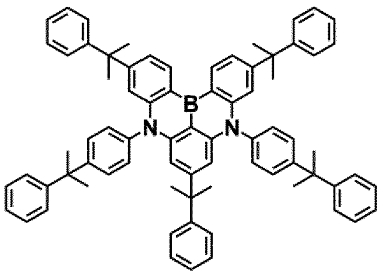

BD1-4

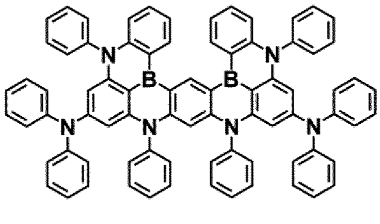

BD1-5

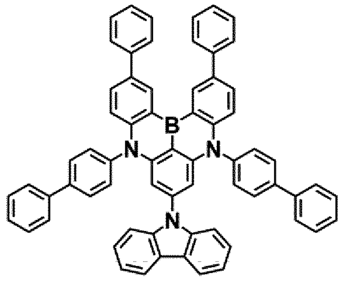

BD1-6

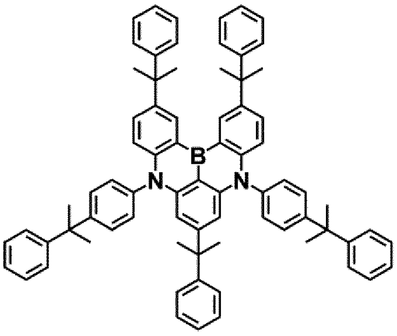

BD1-7

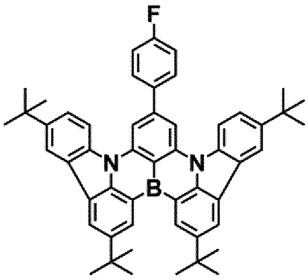

BD1-8

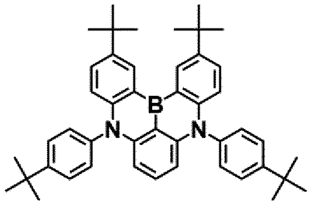

BD1-9

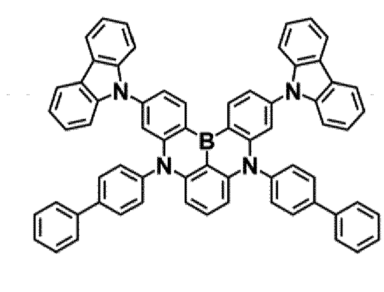

BD1-10

**11.** The organic light-emitting device of any of claims 1-10, wherein

the host and the sensitizer substantially do not emit light, and
the emitter emits light.

**12.** The organic light-emitting device of any of claims 1-11, wherein Condition 1 is satisfied:

Condition 1

$$S_1(H) > S_1(S) \geq S_1(E)$$

wherein, in Condition 1,

$S_1(H)$ indicates a lowest excited singlet energy level of the host,
$S_1(S)$ indicates a lowest excited singlet energy level of the sensitizer, and
$S_1(E)$ indicates a lowest excited singlet energy level of the emitter,
wherein energy levels are determined by density functional theory; and/or
wherein Condition 2 is satisfied:

Condition 2

$$T_1(H) \geq T_1(S)$$

wherein, in Condition 2,

$T_1(H)$ indicates a lowest excited triplet energy level of the host, and
$T_1(S)$ indicates a lowest excited triplet energy level of the sensitizer,
wherein energy levels are determined by density functional theory.

**13.** The organic light-emitting device of any of claims 1-12, wherein

a content of the sensitizer in the emission layer is in a range of 1 wt% to 50 wt%,
a content of the host in the emission layer is in a range of 30 wt% to 90 wt%, and
a content of the emitter in the emission layer is in a range of 0.01 wt% to 15 wt%,
each based on a total weight of the emission layer.

**14.** The organic light-emitting device of claim 1, further comprising:

m emission units stacked between the first electrode and the second electrode, each comprising at least one emission layer; and
m-1 charge generating layers located between each two adjacent emission units from among the m emission units, wherein each of the m-1 charge generating layers comprises an n-type charge generating layer and a p-type charge generating layer,
wherein m is an integer of 2 or greater,
a maximum emission wavelength of light emitted from at least one of the m emission units differs from a maximum emission wavelength of light emitted from at least one of the other emission units,
at least one of the m emission layers is the emission layer comprising the host, the dopant, and the sensitizer.

**15.** The organic light-emitting device of claim 1, further comprising:

m emission layers located between the first electrode and the second electrode,
wherein m is an integer of 2 or greater,
a maximum emission wavelength of light emitted from at least one of the m emission layers differs from a maximum emission wavelength of light emitted from at least one of the other emission layers,
at least one of the m emission layers is the emission layer comprising the host, the sensitizer, and the emitter.

**Patentansprüche**

1. Organische lichtemittierende Vorrichtung, umfassend:

eine erste Elektrode (11);
eine zweite Elektrode (19); und
eine organische Schicht (10A), die sich zwischen der ersten Elektrode und der zweiten Elektrode befindet, wobei die organische Schicht eine Emissionsschicht (15) umfasst,
wobei die Emissionsschicht einen Wirt, einen Sensibilisator und einen Emitter umfasst,
wobei der Wirt, der Sensibilisator und der Emitter voneinander verschieden sind und
wobei der Sensibilisator durch Formel 1 dargestellt wird:

Formel 1 $M_1(L_1)(L_2)$

wobei in Formel 1

$M_1$ Au, Ag oder Cu ist,
$L_1$ ein Ligand ist, der durch Formel 2-1 oder Formel 2-2 dargestellt ist, und
$L_2$ ein Ligand ist, der durch Formel 3-3 dargestellt ist:

Formel 2-1

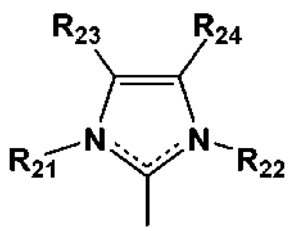

Formel 2-2

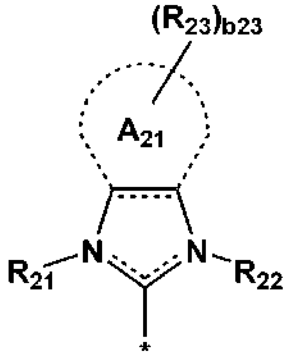

Formel 3-3

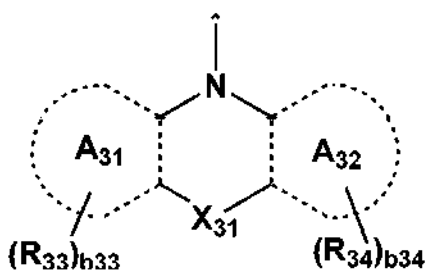

wobei in Formel 2-1, 2-2 und 3-3

$A_{21}$, $A_{31}$, und $A_{32}$ jeweils unabhängig eine monozyklische oder polyzyklische carbozyklische $C_5$-$C_{30}$-Gruppe oder eine monozyklische oder polyzyklische heterozyklische $C_1$-$C_{30}$-Gruppe sind,
$X_{31}$ eine Einfachbindung, O, S, $N(R_{36})$, $C(R_{36})=C(R_{37})$, $[C(R_{36})(R_{37})]_{n31}$ oder $[Si(R_{36})(R_{37})]_{n31}$ ist, wobei n31 1 oder 2 ist,
$R_{21}$ and $R_{22}$ jeweils unabhängig eine substituierte oder unsubstituierte $C_1$-$C_{60}$-Alkylgruppe, eine substituierte oder unsubstituierte $C_3$-$C_{10}$-Cycloalkylgruppe, eine substituierte oder unsubstituierte $C_6$-$C_{60}$-Arylgruppe, eine substituierte oder unsubstituierte $C_7$-$C_{60}$-Alkylarylgruppe, eine substituierte oder unsubstituierte $C_7$-$C_{60}$-Arylalkylgruppe, eine substituierte oder unsubstituierte $C_1$-$C_{60}$-Heteroarylgruppe, eine substituierte oder unsubstituierte $C_2$-$C_{60}$-Alkylheteroarylgruppe, eine substituierte oder

unsubstituierte $C_2$-$C_{60}$-Heteroarylalkylgruppe, eine substituierte oder unsubstituierte einwertige nichtaromatische kondensierte polyzyklische Gruppe oder eine substituierte oder unsubstituierte einwertige nichtaromatische kondensierte heteropolyzyklische Gruppe sind,

$R_{23}$, $R_{24}$, $R_{36}$ und $R_{37}$ jeweils unabhängig Folgendes sind: Wasserstoff, Deuterium, -F, -Cl, -Br, -I, -$SF_5$, eine Hydroxylgruppe, eine Cyanogruppe, eine Nitrogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierten oder unsubstituierte $C_2$-$C_{60}$-Alkynylgruppe, eine substituierte oder unsubstituierte $C_1$-$C_{60}$-Alkoxygruppe, eine substituierte oder unsubstituierte $C_1$-$C_{60}$-Alkylthiogruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_7$-$C_{60}$-Alkylarylgruppe, eine substituierte oder unsubstituierte $C_7$-$C_{60}$-Arylalkylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte $C_2$-$C_{60}$-Alkylheteroarylgruppe, eine substituierte oder unsubstituierte $C_2$-$C_{60}$-Heteroarylalkylgruppe, eine substituierte oder unsubstituierte $C_1$-$C_{60}$-Heteroaryloxygruppe, eine substituierte oder unsubstituierte $C_1$-$C_{60}$-Heteroarylthiogruppe, eine substituierte oder unsubstituierte einwertige nichtaromatische kondensierte polyzyklische Gruppe, eine substituierte oder unsubstituierte einwertige nichtaromatische kondensierte heteropolyzyklische Gruppe, -$Si(Q_1)(Q_2)(Q_3)$, -$Ge(Q_1)(Q_2)(Q_3)$, - $C(Q_1)(Q_2)(Q_3)$, -$B(Q_1)(Q_2)$, -$N(Q_1)(Q_2)$, -$P(Q_1)(Q_2)$, -$C(=O)(Q_1)$, -$S(=O)(Q_1)$, -$S(=O)_2(Q_1)$, - $P(=O)(Q_1)(Q_2)$ oder -$P(=S)(Q_1)(Q_2)$ und $R_{36}$ und $R_{37}$ optional miteinander verbunden sind, um eine substituierte oder unsubstituierte carbozyklische $C_5$-$C_{30}$-Gruppe oder eine substituierte oder unsubstituierte heterozyklische $C_1$-$C_{30}$-Gruppe zu bilden,

$R_{33}$ und $R_{34}$ jeweils unabhängig eine substituierte oder unsubstituierte $C_1$-$C_{60}$-Alkylgruppe sind und

b23 und b33 jeweils unabhängig 1, 2, 3, 4, 5, 6, 7, 8, 9 oder 10 sind,

wobei $Q_1$ bis $Q_3$ jeweils unabhängig Folgendes sind: Wasserstoff, Deuterium, -F, -Cl, -Br, -I, -$SF_5$, eine Hydroxylgruppe, eine Cyanogruppe, eine Nitrogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkynylgruppe, eine $C_1$-$C_{60}$-Alkoxygruppe, eine $C_1$-$C_{66}$-Alkylthiogruppe, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_7$-$C_{60}$-Alkylarylgruppe, eine $C_7$-$C_{60}$-Arylalkylgruppe, eine $C_6$-$C_{60}$-Aryloxygruppe, eine $C_6$-$C_{60}$-Arylthiogruppe, eine $C_1$-$C_{60}$-Heteroarylgruppe, eine $C_2$-$C_{60}$-Alkylheteroarylgruppe, eine $C_2$-$C_{60}$-Heteroarylalkylgruppe, eine $C_1$-$C_{60}$-Heteroaryloxygruppe, eine $C_1$-$C_{60}$-Heteroarylthiogruppe, eine einwertige nichtaromatische kondensierte polyzyklische Gruppe oder eine einwertige nichtaromatische kondensierte heteropolyzyklischen Gruppe, wobei jede unsubstituierte oder mit mindestens einem von Deuterium, -F, einer Cyanogruppe, einer $C_1$-$C_{20}$-Alkylgruppe und einer $C_6$-$C_{30}$-Arylgruppe, einer $C_6$-$C_{60}$-Arylgruppe oder einer Kombination davon substituiert ist, und

* eine Bindungsstelle an $M_1$ in Formel 1 angibt; und **dadurch gekennzeichnet, dass** b34 2, 3, 4, 5, 6, 7, 8, 9 oder 10 ist.

**2.** Organische lichtemittierende Vorrichtung nach Anspruch 1, wobei $A_{21}$, $A_{31}$ und $A_{32}$ jeweils unabhängig Folgendes sind: eine Benzolgruppe, eine Naphthalingruppe, eine Phenanthrengruppe, eine Furangruppe, eine Thiophengruppe, eine Pyrrolgruppe, eine Cyclopentengruppe, eine Silolgruppe, eine Germolgruppe, eine Benzofurangruppe, eine Benzothiophengruppe, eine Indolgruppe, eine Indengruppe, eine Benzosilolgruppe, eine Benzogermolgruppe, eine Dibenzofurangruppe, eine Dibenzothiophengruppe, eine Carbazolgruppe, eine Fluorenguppe, eine Dibenzosilolguppe, eine Dibenzogermolgruppe, eine Pyridingruppe, eine Pyrimidingruppe, eine Pyridazingruppe oder eine Pyrazingruppe;
wobei vorzugsweise

$A_{21}$ eine Benzolgruppe, eine Naphthalingruppe, eine Pyridingruppe, eine Pyrimidingruppe, eine Pyridazingruppe oder eine Pyrazingruppe ist und

$A_{31}$ und $A_{32}$ jeweils unabhängig eine Benzolgruppe, eine Naphthalingruppe, eine Dibenzofurangruppe, eine Dibenzothiophengruppe, eine Carbazolgruppe, eine Pyridingruppe, eine Pyrimidingruppe, eine Pyridazingruppe oder eine Pyrazingruppe sind.

**3.** Organische lichtemittierende Vorrichtung nach Anspruch 1 oder 2, wobei

$L_1$ ein Ligand ist, der durch Formel 2-11 oder Formel 2-12 dargestellt ist, und
$L_2$ ein Ligand ist, der durch eine der Formeln 3-13 bis 3-17 dargestellt ist:

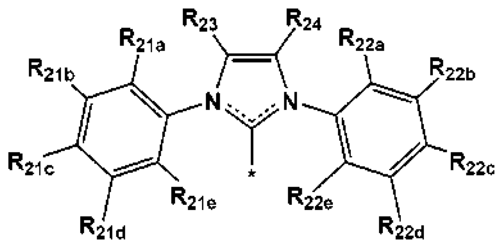
2-11

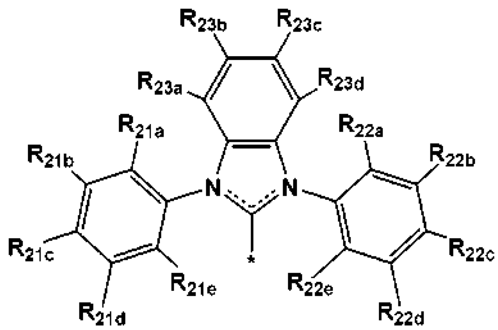
2-12

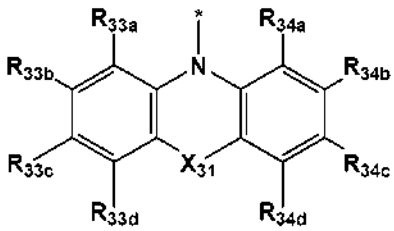
3-13

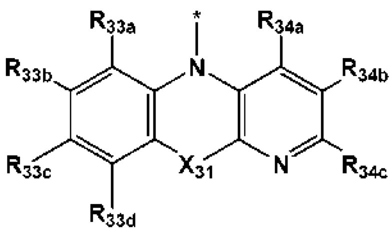
3-14

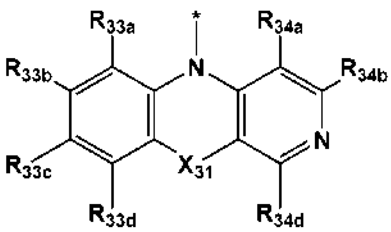
3-15

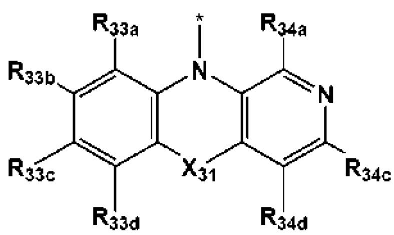
3-16

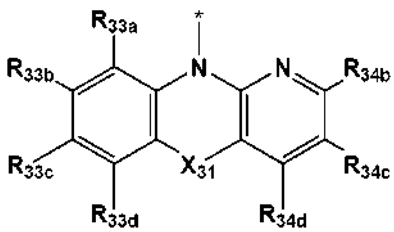
3-17

wobei in Formel 2-11, 2-12 und 3-13 bis 3-17

$X_{31}$, $R_{23}$ und $R_{24}$ wie in Anspruch 1 definiert sind und
$R_{21a}$ bis $R_{21e}$, $R_{22a}$ bis $R_{22e}$ und $R_{23a}$ bis $R_{23d}$ jeweils unabhängig Folgendes sind: Wasserstoff, Deuterium, -F, -Cl, -Br, -I, $-SF_5$, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Amidinogruppe, eine Hydrazingruppe, eine Hydrazongruppe, eine Sulfonsäuregruppe oder ein Salz davon, eine $C_1$-$C_{20}$-Alkylgruppe, eine deuterierte $C_2$-$C_{20}$-Alkylgruppe, eine $C_1$-$C_{20}$-Alkoxygruppe, eine $C_1$-$C_{20}$-Alkylthiogruppe, eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.1]heptylgruppe, eine Bicyclo[2.2.2]octylgruppe, ein ($C_1$-$C_{20}$-Alkyl)cyclopentylgruppe, eine ($C_1$-$C_{20}$-Alkyl)cyclohexylgruppe, eine ($C_1$-$C_{20}$-Alkyl)cycloheptylgruppe, eine ($C_1$-$C_{20}$-Alkyl)cyclooctylgruppe, eine ($C_1$-$C_{20}$-Alkyl)adamantanylgruppe, eine ($C_1$-$C_{20}$-Alkylgruppe)norbornanylgruppe, eine ($C_1$-$C_{20}$-Alkyl)norbornenylgruppe, eine ($C_1$-$C_{20}$-Alkyl)cyclopentenylgruppe, eine ($C_1$-$C_{20}$-Alkyl)cyclohexenylgruppe, eine ($C_1$-$C_{20}$-Alkyl)cycloheptenylgruppe, eine ($C_1$-$C_{20}$-Alkyl)bicyclo[1.1.1]pentylgruppe, eine ($C_1$-$C_{20}$-Alkyl)bicyclo[2.1.1]hexylgruppe, eine ($C_1$-$C_{20}$-Alkyl)bicyclo[2.2.1]heptylgruppe, eine ($C_1$-$C_{20}$-Alkyl)bicyclo[2.2.2]octylgruppe, eine Phenylgruppe, eine ($C_1$-$C_{20}$-Alkyl)phenylgruppe, eine Biphenylgruppe, eine Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe, eine Azadibenzothiophenylgruppe, -Si($Q_{21}$)($Q_{22}$)($Q_{23}$), -Ge($Q_{21}$)($Q_{22}$)($Q_{23}$), -C($Q_{21}$)($Q_{22}$)($Q_{23}$), - B($Q_{21}$)($Q_{22}$), -N($Q_{21}$)($Q_{22}$), -P($Q_{21}$)($Q_{22}$), -C(=O)($Q_{21}$), -S(=O)($Q_{21}$), -S(=O)$_2$($Q_{21}$), - P(=O)($Q_{21}$)($Q_{22}$) oder -P(=S)($Q_{21}$)($Q_{22}$),

$R_{33a}$ bis $R_{33d}$ und $R_{34a}$ bis $R_{34d}$ jeweils unabhängig eine $C_1$-$C_{20}$-Alkylgruppe oder eine deuterierte $C_2$-$C_{20}$-Alkylgruppe sind,

wobei $Q_{21}$ bis $Q_{23}$ jeweils unabhängig Folgendes sind:

Wasserstoff, Deuterium, -F, eine Cyanogruppe, $-CH_3$, $-CD_3$, $-CD_2H$, $-CDH_2$, $-CH_2CH_3$, - $CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, - $CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, - $CHFCF_2H$, $-CHFCFH_2$, $-CHFCF_3$, $-CF_2CF_3$, $-CF_2CF_2H$, oder $-CF_2CFH_2$ oder

eine n-Propylgruppe, eine Isopropylgruppe, eine n-Butylgruppe, eine sec-Butylgruppe, eine Isobutylgruppe, eine tert-Butylgruppe, eine n-Pentylgruppe, eine tert-Pentylgruppe, eine Neopentylgruppe, eine Isopentylgruppe, eine sec-Pentylgruppe, eine 3-Pentylgruppe, eine sec-Isopentylgruppe, eine Phenylgruppe, eine Biphenylgruppe oder eine Naphthylgruppe, jeweils unsubstituiert oder substituiert mit mindestens einem von Deuterium, -F, einer $C_1$-$C_{10}$-Alkylgruppe, einer deuterierten $C_1$-$C_{10}$-Alkylgruppe, einer Phenylgruppe oder einer Kombination davon und

* eine Bindungsstelle an $M_1$ in Formel 1 angibt;

wobei vorzugsweise

$L_1$ ein Ligand ist, der durch Formel 2-11 oder Formel 2-12 dargestellt ist, und

$L_2$ ein Ligand ist, der durch Formel 3-13 dargestellt ist.

**4.** Organische lichtemittierende Vorrichtung nach einem der Ansprüche 1-3, wobei $L_1$ ein Ligand ist, der durch eine der Formeln 2-21 bis 2-26 dargestellt ist:

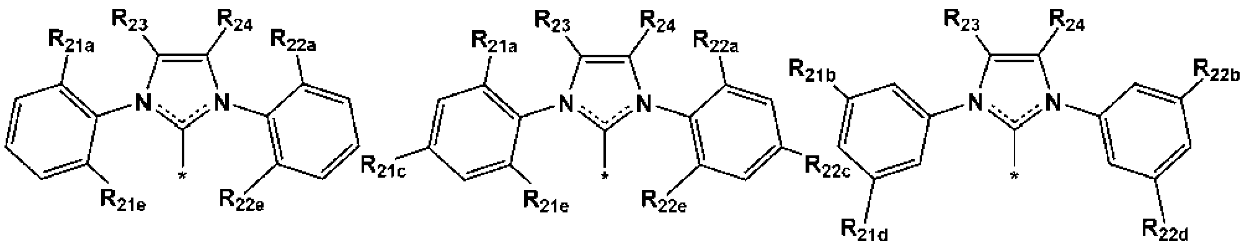

2-21 2-22 2-23

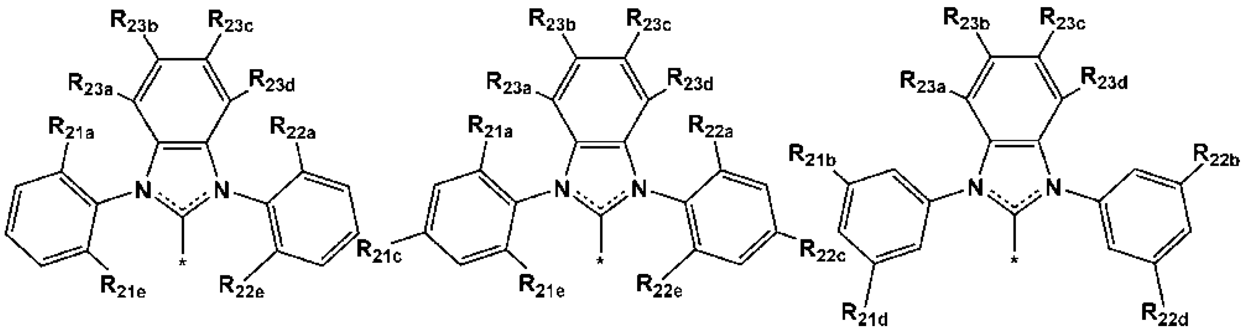

2-24 2-25 2-26

wobei in Formel 2-21 bis 2-26
$R_{23}$, $R_{24}$ und $R_{23a}$ bis $R_{23d}$ jeweils unabhängig Folgendes sind:

Wasserstoff, Deuterium, -F, -Cl, -Br, -I, $-SF_5$, eine Hydroxylgruppe, eine Cyanogruppe oder eine Nitrogruppe; eine $C_1$-$C_{20}$-Alkylgruppe, die unsubstituierte oder mit mindestens einem von Folgendem substituiert ist: Deuterium, -F, -Cl, -Br, -I, $-SF_5$, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer $C_1$-$C_{20}$-Alkylgruppe, einer deuterierten $C_2$-$C_{20}$-Alkylgruppe, einer $C_1$-$C_{20}$-Alkoxygruppe, einer $C_1$-$C_{20}$-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer ($C_1$-$C_{20}$-Alkyl)cyclopentylgruppe, einer ($C_1$-$C_{20}$-Alkyl)cyclohexylgruppe, einer ($C_1$-$C_{20}$-Alkyl)cycloheptylgruppe, einer ($C_1$-$C_{20}$-Alkyl)cyclooctylgruppe, einer ($C_1$-$C_{20}$-Alkyl)adamantanylgruppe, einer ($C_1$-$C_{20}$-Alkyl)norbornanylgruppe, einer ($C_1$-$C_{20}$-Alkyl)norbornenylgruppe, einer ($C_1$-$C_{20}$-Alkyl)cyclopentenylgruppe, einer ($C_1$-$C_{20}$-Alkyl)cyclohexenylgruppe, einer ($C_1$-$C_{20}$-Alkyl)cycloheptenylgruppe, einer ($C_1$-$C_{20}$-Alkyl)bicyclo[1.1.1]pentylgruppe, einer ($C_1$-$C_{20}$-Alkyl)bicyclo[2.1.1]hexylgruppe, einer ($C_1$-$C_{20}$-Alkyl)bicyclo[2.2.1]heptylgruppe, einer ($C_1$-$C_{20}$-Alkyl)bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, $-Si(Q_{11})(Q_{12})(Q_{13})$, $-Ge(Q_{11})(Q_{12})(Q_{13})$, $-C(Q_{11})(Q_{12})(Q_{13})$, $-B(Q_{11})(Q_{12})$, - $N(Q_{11})(Q_{12})$, $-P(Q_{11})(Q_{12})$, $-C(=O)(Q_{11})$, $-S(=O)(Q_{11})$, $-S(=O)_2(Q_{11})$, $-P(=O)(Q_{11})(Q_{12})$, - $P(=S)(Q_{11})(Q_{12})$ oder einer Kombination davon;
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.1]heptylgruppe, eine Bicyclo[2.2.2]octylgruppe, eine Phenylgruppe, eine ($C_1$-$C_{20}$-Alkyl)phenylgruppe, eine Biphenylgruppe, ein Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, ein Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe oder eine Azadibenzothiophenylgruppe, jeweils unsubstituiert oder substituiert mit mindestens einem von Deuterium, -F, -Cl, -Br, -I, $-SF_5$, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer $C_1$-$C_{20}$-Alkylgruppe, einer deuterierten $C_2$-$C_{20}$-Alkylgruppe, einer $C_1$-$C_{20}$-Alkoxygruppe, einer $C_1$-$C_{20}$-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer ($C_1$-$C_{20}$-Alkyl)cyclopentylgruppe, einer ($C_1$-$C_{20}$-Alkyl)cyclohexylgruppe, einer ($C_1$-$C_{20}$-Alkyl)cycloheptylgruppe, einer ($C_1$-$C_{20}$-Alkyl)cyclooctylgruppe, einer ($C_1$-$C_{20}$-Alkyl)adamantanylgrup-

pe, einer ($C_1$-$C_{20}$-Alkyl)norbornanylgruppe, einer ($C_1$-$C_{20}$-Alkyl)norbornenylgruppe, einer ($C_1$-$C_{20}$-Alkyl)cyclopentenylgruppe, einer ($C_1$-$C_{20}$-Alkyl)cyclohexenylgruppe, einer ($C_1$-$C_{20}$-Alkyl)cycloheptenylgruppe, ($C_1$-$C_{20}$-Alkyl)bicyclo[1.1.1]pentylgruppe, einer ($C_1$-$C_{20}$-Alkyl)bicyclo[2.1.1]hexylgruppe, einer ($C_1$-$C_{20}$-Alkyl)bicyclo[2.2.1]heptylgruppe, einer ($C_1$-$C_{20}$-Alkyl)bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, einer Pyridinylgruppe, einer Pyrazinylgruppe, einer Pyrimidinylgruppe, einer Pyridazinylgruppe, einer Chinolinylgruppe, einer Isochinolinylgruppe, $-Si(Q_{21})(Q_{22})(Q_{23})$, - $Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, - $S(=O)(Q_{21})$, $-S(=O)_2(Q_{21})$, $-P(=O)(Q_{21})(Q_{22})$, $-P(=S)(Q_{21})(Q_{22})$ oder einer Kombination davon; oder

$-Si(Q_1)(Q_2)(Q_3)$, $-Ge(Q_1)(Q_2)(Q_3)$, $-C(Q_1)(Q_2)(Q_3)$, $-B(Q_1)(Q_2)$ oder $-N(Q_1)(Q_2)$ und

$R_{21a}$, $R_{21b}$, $R_{21c}$, $R_{21d}$, $R_{21e}$, $R_{22a}$, $R_{22b}$, $R_{22c}$, $R_{22d}$ und $R_{22e}$ jeweils unabhängig Folgendes sind: Wasserstoff, Deuterium, -F, -Cl, -Br, -I, $-SF_5$, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Amidinogruppe, eine Hydrazingruppe, eine Hydrazongruppe, eine Sulfonsäuregruppe oder ein Salz davon, eine $C_1$-$C_{20}$-Alkylgruppe, eine deuterierte $C_2$-$C_{20}$-Alkylgruppe, eine $C_1$-$C_{20}$-Alkoxygruppe, eine $C_1$-$C_{20}$-Alkylthiogruppe, eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.1]heptylgruppe, eine Bicyclo[2.2.2]octylgruppe, eine ($C_1$-$C_{20}$-Alkyl)cyclopentylgruppe, eine ($C_1$-$C_{20}$-Alkyl)cyclohexylgruppe, eine ($C_1$-$C_{20}$-Alkyl)cycloheptylgruppe, eine ($C_1$-$C_{20}$-Alkyl)cyclooctylgruppe, eine ($C_1$-$C_{20}$-Alkyl)adamantanylgruppe, eine ($C_1$-$C_{20}$-Alkylgruppe)norbornanylgruppe, eine ($C_1$-$C_{20}$-Alkyl)norbornenylgruppe, eine ($C_1$-$C_{20}$-Alkyl)cyclopentenylgruppe, eine ($C_1$-$C_{20}$-Alkyl)cyclohexenylgruppe, eine ($C_1$-$C_{20}$-Alkyl)cycloheptenylgruppe, eine ($C_1$-$C_{20}$-Alkyl)bicyclo[1.1.1]pentylgruppe, eine ($C_1$-$C_{20}$-Alkyl)bicyclo[2.1.1]hexylgruppe, eine ($C_1$-$C_{20}$-Alkyl)bicyclo[2.2.1]heptylgruppe, eine ($C_1$-$C_{20}$-Alkyl)bicyclo[2.2.2]octylgruppe, eine Phenylgruppe, eine ($C_1$-$C_{20}$-Alkyl)phenylgruppe, eine Biphenylgruppe, eine Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe, eine Azadibenzothiophenylgruppe, $-Si(Q_{21})(Q_{22})(Q_{23})$, $-Ge(Q_{21})(Q_{22})(Q_{23})$, $-C(Q_{21})(Q_{22})(Q_{23})$, - $B(Q_{21})(Q_{22})$, - $N(Q_{21})(Q_{22})$, $-P(Q_{21})(Q_{22})$, $-C(=O)(Q_{21})$, $-S(=O)(Q_{21})$, $-S(=O)_2(Q_{21})$, - $P(=O)(Q_{21})(Q_{22})$ oder $P(=S)(Q_{21})(Q_{22})$,

wobei $Q_1$ bis $Q_3$, $Q_{11}$ bis $Q_{13}$ und $Q_{21}$ bis $Q_{23}$ jeweils unabhängig Folgendes sind:

Wasserstoff, Deuterium, -F, eine Cyanogruppe, $-CH_3$, $-CD_3$, $-CD_2H$, $-CDH_2$, $-CH_2CH_3$, - $CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, - $CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, - $CHFCF_2H$, $-CHFCFH_2$, $-CHFCF_3$, $-CF_2CF_3$, $-CF_2CF_2H$ oder $-CF_2CFH_2$; oder

eine n-Propylgruppe, eine Isopropylgruppe, eine n-Butylgruppe, eine sec-Butylgruppe, eine Isobutylgruppe, eine tert-Butylgruppe, eine n-Pentylgruppe, eine tert-Pentylgruppe, eine Neopentylgruppe, eine Isopentylgruppe, eine sec-Pentylgruppe, eine 3-Pentylgruppe, eine sec-Isopentylgruppe, eine Phenylgruppe, eine Biphenylgruppe oder eine Naphthylgruppe, jeweils unsubstituiert oder substituiert mit mindestens einem von Deuterium, -F, einer $C_1$-$C_{10}$-Alkylgruppe, einer deuterierten $C_1$-$C_{10}$-Alkylgruppe, einer Phenylgruppe oder einer Kombination davon und

* eine Bindungsstelle an $M_1$ in Formel 1 angibt; und/oder

wobei $L_2$ ein Ligand ist, der durch eine der Formeln 3-21 bis 3-26 dargestellt ist:

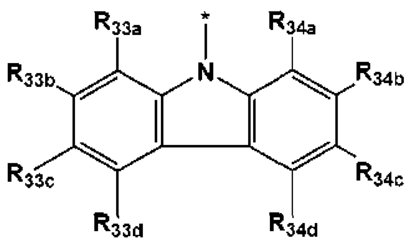
3-21

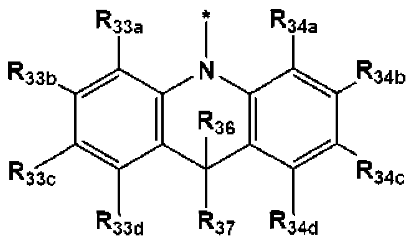
3-22

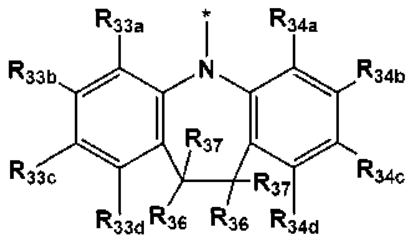
3-23

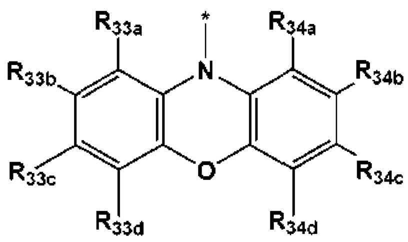
3-24

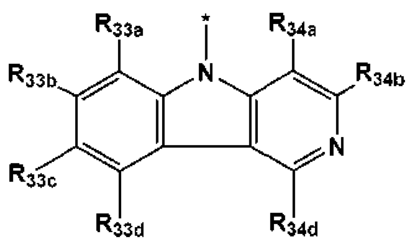
3-25

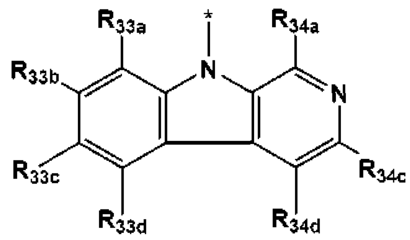
3-26

wobei in Formel 3-21 bis 3-26
$R_{36}$ und $R_{37}$ jeweils unabhängig Folgendes sind:

Wasserstoff, Deuterium, -F, -Cl, -Br, -I, $-SF_5$, eine Hydroxylgruppe, eine Cyanogruppe oder eine Nitrogruppe;
eine $C_1$-$C_{20}$-Alkylgruppe, die unsubstituierte oder mit mindestens einem von Folgendem substituiert ist: Deuterium, -F, -Cl, -Br, -I, $-SF_5$, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer $C_1$-$C_{20}$-Alkylgruppe, einer deuterierten $C_2$-$C_{20}$-Alkylgruppe, einer $C_1$-$C_{20}$-Alkoxygruppe, einer $C_1$-$C_{20}$-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer ($C_1$-$C_{20}$-Alkyl)cyclopentylgruppe, einer ($C_1$-$C_{20}$-Alkyl)cyclohexylgruppe, einer ($C_1$-$C_{20}$-Alkyl)cycloheptylgruppe, einer ($C_1$-$C_{20}$-Alkyl)cyclooctylgruppe, einer ($C_1$-$C_{20}$-Alkyl)adamantanylgruppe, einer ($C_1$-$C_{20}$-Alkyl)norbornanylgruppe, einer ($C_1$-$C_{20}$-Alkyl)norbornenylgruppe, einer ($C_1$-$C_{20}$-Alkyl)cyclopentenylgruppe, einer ($C_1$-$C_{20}$-Alkyl)cyclohexenylgruppe, einer ($C_1$-$C_{20}$-Alkyl)cycloheptenylgruppe, einer ($C_1$-$C_{20}$-Alkyl)bicyclo[1.1.1]pentylgruppe, einer ($C_1$-$C_{20}$-Alkyl)bicyclo[2.1.1]hexylgruppe, einer ($C_1$-$C_{20}$-Alkyl)bicyclo[2.2.1]heptylgruppe, einer ($C_1$-$C_{20}$-Alkyl)bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, $-Si(Q_{11})(Q_{12})(Q_{13})$, $-Ge(Q_{11})(Q_{12})(Q_{13})$, $-C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, $-S(=O)_2(Q_{11})$, $-P(=O)(Q_{11})(Q_{12})$, $-P(=S)(Q_{11})(Q_{12})$ oder einer Kombination davon;
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.1]heptylgruppe, eine Bicyclo[2.2.2]octylgruppe, eine Phenylgruppe, eine ($C_1$-$C_{20}$-Alkyl)phenylgruppe, eine Biphenylgruppe, ein Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, ein Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe,

eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe oder eine Azadibenzothiophenylgruppe, jeweils unsubstituiert oder substituiert mit mindestens einem von Folgenden: Deuterium, -F, -Cl, -Br, -I, $-SF_5$, $-CD_3$, $-CD_2H$, $-CDH_2$, $-CF_3$, $-CF_2H$, $-CFH_2$, einer Hydroxylgruppe, einer Cyanogruppe, einer Nitrogruppe, einer $C_1$-$C_{20}$-Alkylgruppe, einer deuterierten $C_2$-$C_{20}$-Alkylgruppe, einer $C_1$-$C_{20}$-Alkoxygruppe, einer $C_1$-$C_{20}$-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Bicyclo[1.1.1]pentylgruppe, einer Bicyclo[2.1.1]hexylgruppe, einer Bicyclo[2.2.1]heptylgruppe, einer Bicyclo[2.2.2]octylgruppe, einer ($C_1$-$C_{20}$-Alkyl)cyclopentylgruppe, einer ($C_1$-$C_{20}$-Alkyl)cyclohexylgruppe, einer ($C_1$-$C_{20}$-Alkyl)cycloheptylgruppe, einer ($C_1$-$C_{20}$-Alkyl)cyclooctylgruppe, einer ($C_1$-$C_{20}$-Alkyl)adamantanylgruppe, einer ($C_1$-$C_{20}$-Alkyl)norbornanylgruppe, einer ($C_1$-$C_{20}$-Alkyl)norbornenylgruppe, einer ($C_1$-$C_{20}$-Alkyl)cyclopentenylgruppe, einer ($C_1$-$C_{20}$-Alkyl)cyclohexenylgruppe, einer ($C_1$-$C_{20}$-Alkyl)cycloheptenylgruppe, ($C_1$-$C_{20}$-Alkyl)bicyclo[1.1.1]pentylgruppe, einer ($C_1$-$C_{20}$-Alkyl)bicyclo[2.1.1]hexylgruppe, einer ($C_1$-$C_{20}$-Alkyl)bicyclo[2.2.1]heptylgruppe, einer ($C_1$-$C_{20}$-Alkyl)bicyclo[2.2.2]octylgruppe, einer Phenylgruppe, einer ($C_1$-$C_{20}$-Alkyl)phenylgruppe, einer Biphenylgruppe, einer Terphenylgruppe, einer Naphthylgruppe, einer Pyridinylgruppe, einer Pyrazinylgruppe, einer Pyrimidinylgruppe, einer Pyridazinylgruppe, einer Chinolinylgruppe, einer Isochinolinylgruppe, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$ oder einer Kombination davon; oder

$-Si(Q_1)(Q_2)(Q_3)$, $-Ge(Q_1)(Q_2)(Q_3)$, $-C(Q_1)(Q_2)(Q_3)$, $-B(Q_1)(Q_2)$ oder $-N(Q_1)(Q_2)$ und

$R_{33a}$ bis $R_{33d}$ und $R_{34a}$ bis $R_{34d}$ jeweils unabhängig eine $C_1$-$C_{20}$-Alkylgruppe oder eine deuterierte $C_2$-$C_{20}$-Alkylgruppe sind,

wobei $Q_1$ bis $Q_3$, $Q_{11}$ bis $Q_{13}$ und $Q_{21}$ bis $Q_{23}$ jeweils unabhängig Folgendes sind:

Wasserstoff, Deuterium, -F, eine Cyanogruppe, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$ oder $-CF_2CFH_2$; oder

eine n-Propylgruppe, eine Isopropylgruppe, eine n-Butylgruppe, eine sec-Butylgruppe, eine Isobutylgruppe, eine tert-Butylgruppe, eine n-Pentylgruppe, eine tert-Pentylgruppe, eine Neopentylgruppe, eine Isopentylgruppe, eine sec-Pentylgruppe, eine 3-Pentylgruppe, eine sec-Isopentylgruppe, eine Phenylgruppe, eine Biphenylgruppe oder eine Naphthylgruppe, jeweils unsubstituiert oder substituiert mit mindestens einem von Deuterium, -F, einer $C_1$-$C_{10}$-Alkylgruppe, einer deuterierten $C_1$-$C_{10}$-Alkylgruppe, einer Phenylgruppe oder einer Kombination davon und

* eine Bindungsstelle an $M_1$ in Formel 1 angibt.

**5.** Organische lichtemittierende Vorrichtung nach einem der Ansprüche 1, 2 und 4, wobei der Sensibilisator aus Gruppe I ausgewählt ist:

Gruppe I

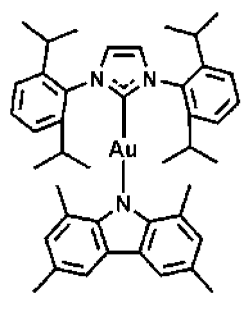

1

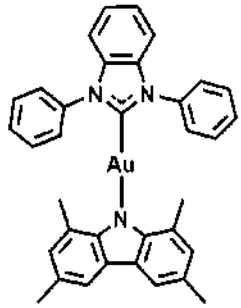

3

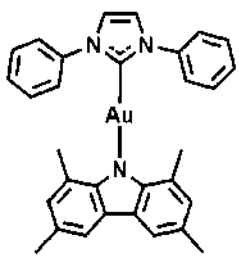

5

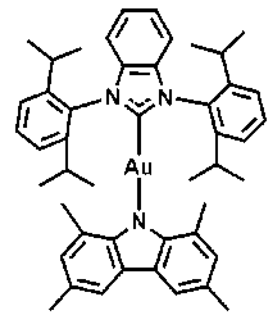

7

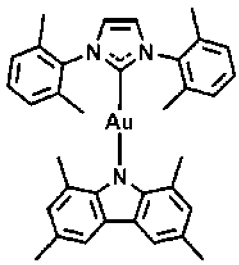

9

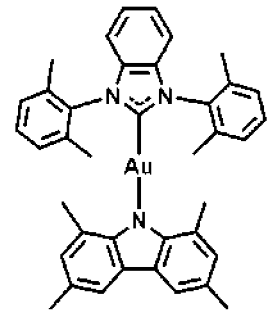

11

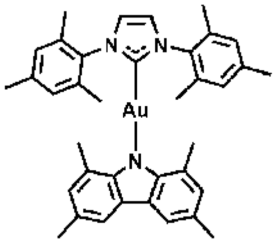

13

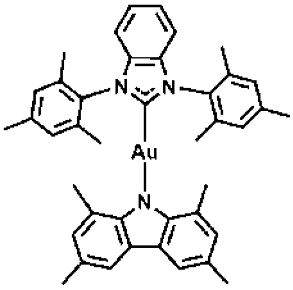

15

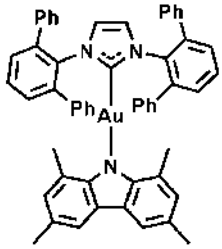

17

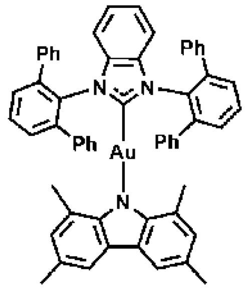

19

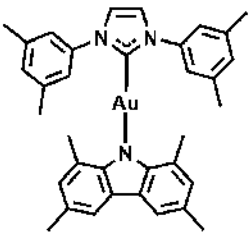

21

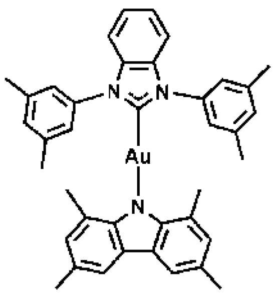

23

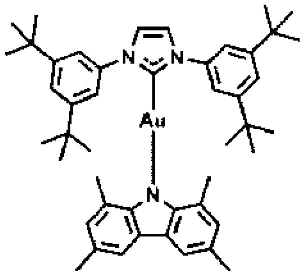

25

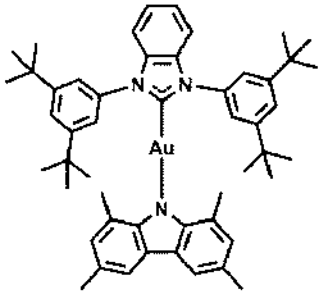

27

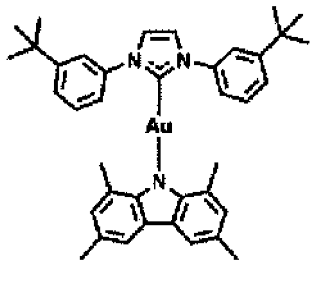

29

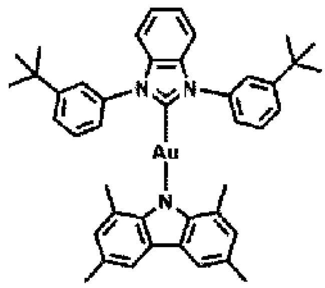

31

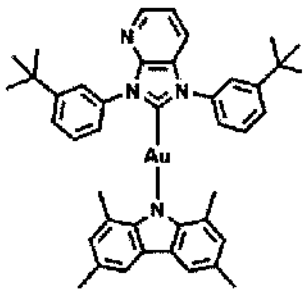

33

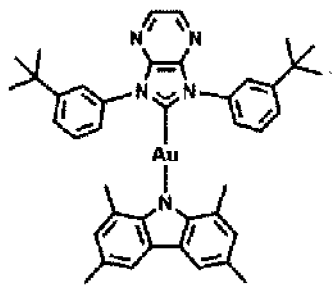

35

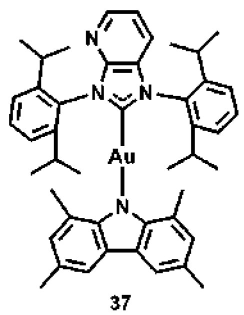

37

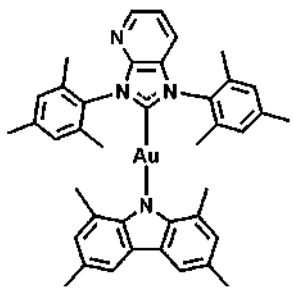

39

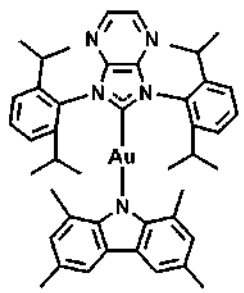

41

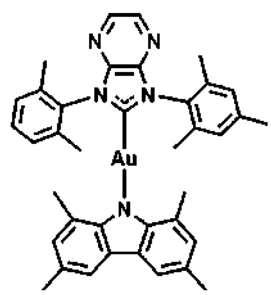

43

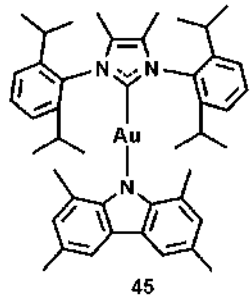
45

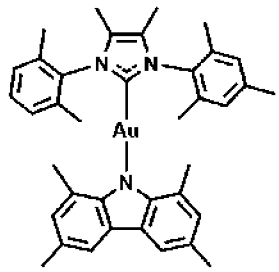
47

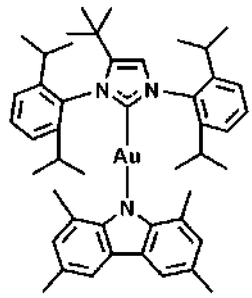
49

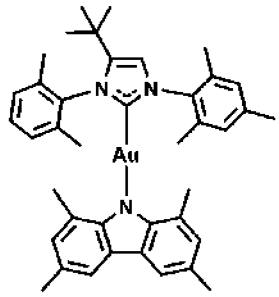
51

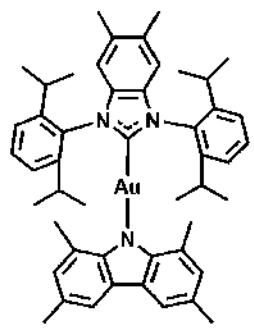
53

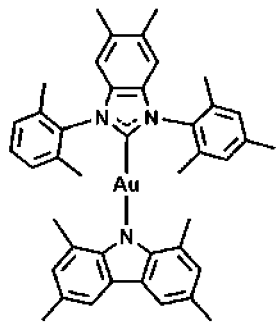
55

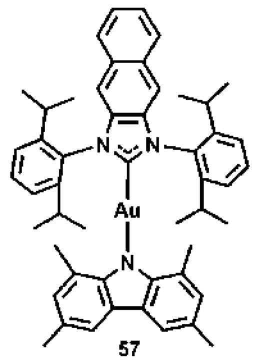
57

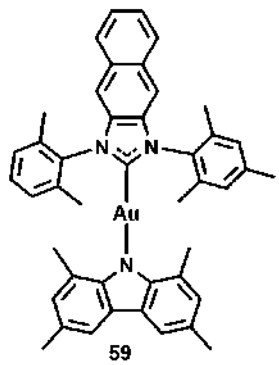
59

wobei in Gruppe 1 "Ph" eine Phenylgruppe darstellt.

**6.** Organische lichtemittierende Vorrichtung nach einem der Ansprüche 1-5, wobei

der Wirt mindestens einen von einem lochtransportierenden Wirt, einem elektronentransportierenden Wirt oder einem bipolaren Wirt umfasst,
der elektronentransportierende Wirt mindestens einen elektronentransportierenden Teil umfasst, der lochtransportierende Wirt einen lochtransportierenden Teil umfasst und keinen elektronentransportierenden Teil umfasst,
der bipolare Wirt mindestens einen elektronentransportierenden Teil und mindestens einen lochtransportierenden Teil umfasst,
der elektronentransportierende Teil Folgendes ist: eine Cyanogruppe, -F, $-CFH_2$, $-CF_2H$, - $CF_3$, eine an $\pi$-Elektronen abgereicherte stickstoffhaltige zyklische $C_1$-$C_{60}$-Gruppe oder eine Gruppe, die durch eines der

Formel ET-Teil dargestellt ist,
der lochtransportierende Teil eine Π-elektronenreiche zyklische $C_3$-$C_{60}$-Gruppe oder eine Gruppe, die durch die Formel HT-Teil dargestellt ist:

ET-Teil

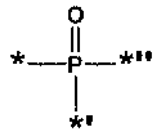 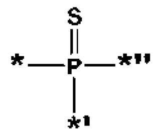 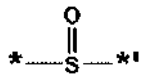 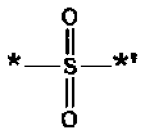

HT-Teil

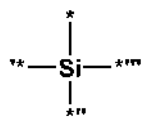

wobei in den Formeln ET-Teil und HT-Teil, *, *', *'' und *''' jeweils eine Bindungsstelle an ein benachbartes Atom angeben.

**7.** Organische lichtemittierende Vorrichtung nach einem der Ansprüche 1-6, wobei der Wirt eine erste Verbindung und eine zweite Verbindung umfasst,

i) die erste Verbindung ein lochtransportierender Wirt ist und die zweite Verbindung ein elektronentransportierender Wirt ist,
ii) die erste Verbindung ein elektronentransportierender Wirt ist und die zweite Verbindung ein lochtransportierender Wirt ist,
iii) die erste Verbindung und die zweite Verbindung jeweils ein bipolarer Wirt sind,
iv) die erste Verbindung ein lochtransportierender Wirt ist und die zweite Verbindung ein bipolarer Wirt ist,
v) die erste Verbindung ein elektronentransportierender Wirt ist und die zweite Verbindung ein bipolarer Wirt ist,
vi) die erste Verbindung ein bipolarer Wirt ist und die zweite Verbindung ein lochtransportierender Wirt ist oder
vii) die erste Verbindung ein bipolarer Wirt ist und die zweite Verbindung ein elektronentransportierender Wirt ist.

**8.** Organische lichtemittierende Vorrichtung nach einem der Ansprüche 1-7, wobei der Emitter eine Abklingzeit von weniger als 100 Mikrosekunden aufweist; und/oder
wobei der Emitter Folgendes umfasst: einen naphtalinhaltigen Kern, einen fluorenhaltigen Kern, einen spirobifluorenhaltigen Kern, einen benzofluorenhaltigen Kern, einen dibenzofluorenhaltigen Kern, einen phenanthrenhaltigen Kern, einen anthracenhaltigen Kern, einen fluoranthenhaltigen Kern, einen triphenylenhaltigen Kern, einen pyrenhaltigen Kern, einen chrysenhaltigen Kern, einen picenhaltigen Kern, einen perylenhaltigen Kern, einen pentacenhaltigen Kern, einen indenoanthracenhaltigen Kern, einen tetracenhaltigen Kern, einen bisanthracenhaltigen Kern oder einen Kern, der durch eine der Formeln 501-1 bis 501-21 dargestellt ist:

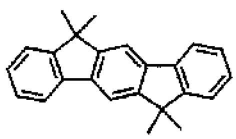
**501-1**

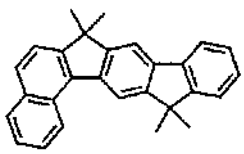
**501-2**

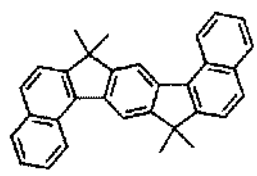
**501-3**

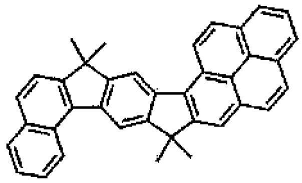

501-4

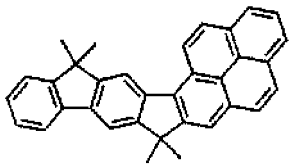

501-5

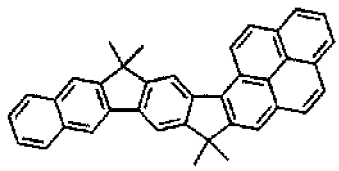

501-6

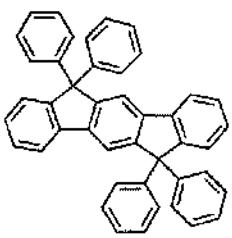

501-7

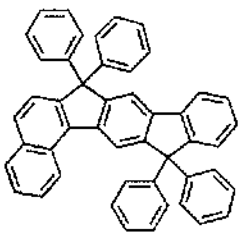

501-8

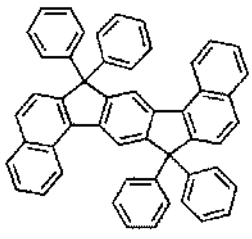

501-9

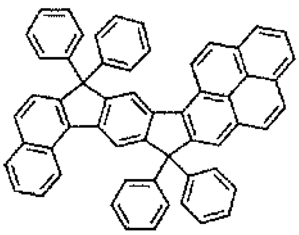

501-10

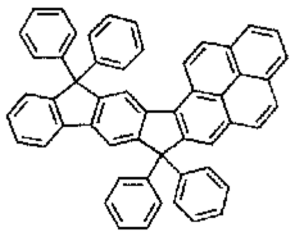

501-11

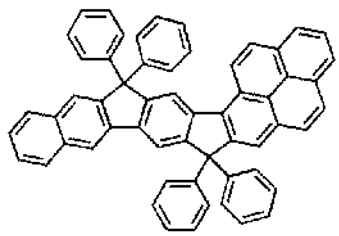

501-12

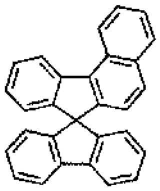

501-13

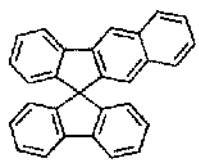

501-14

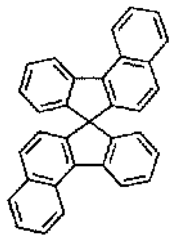

501-15

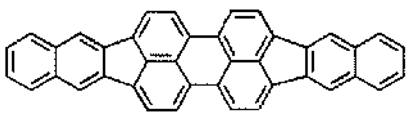

501-16

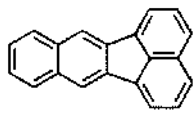

501-17

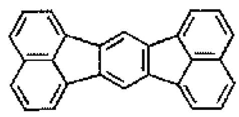

501-18

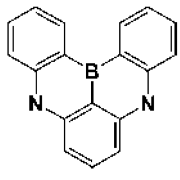

501-19

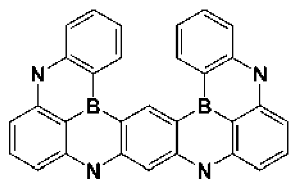

501-20

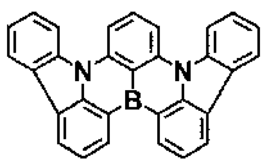

501-21

**9.** Organische lichtemittierende Vorrichtung nach einem der Ansprüche 1-8, wobei der Emitter durch Formel 51 dargestellt ist:

Formel 51

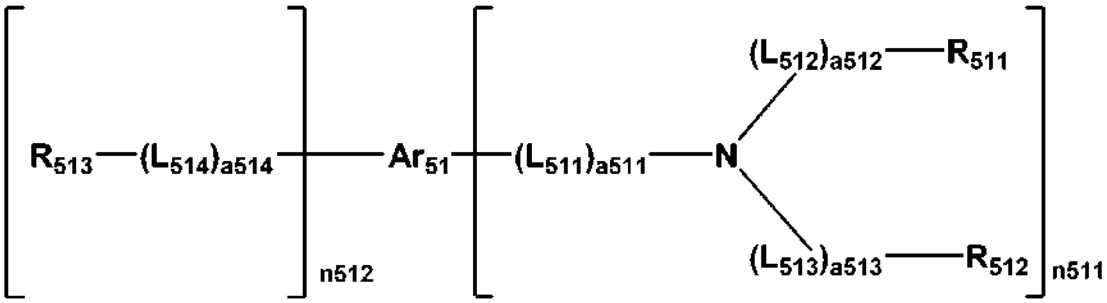

wobei in Formel 51

$Ar_{51}$ Folgendes ist: eine Naphthalingruppe, eine Fluorengruppe, eine Spirobifluorengruppe, eine Benzofluorengruppe, eine Dibenzofluorengruppe, eine Phenanthrengruppe, eine Anthracengruppe, eine Fluoranthengruppe, eine Triphenylengruppe, eine Pyrengruppe, eine Chrysengruppe, eine Picengruppe, eine Perylengruppe, eine Pentacengruppe, eine Indenoanthracengruppe, eine Tetracengruppe, eine Bisanthracengruppe oder eine Gruppe, die durch eine der Formeln 501-1 bis 501-21 dargestellt ist, jeweils unsubstituiert oder substituiert mit mindestens einem von Folgendem: Deuterium, - F, -Cl, -Br, -I, $-SF_5$, einer Hydroxylgruppe, einer Cyanogruppe, einer Nitrogruppe, einer Amidinogruppe, einer Hydrazingruppe, einer Hydrazongruppe, einer Sulfonsäuregruppe oder einem Salz davon, einer $C_1$-$C_{60}$-Alkylgruppe, einer $C_2$-$C_{60}$-Alkenylgruppe, einer $C_2$-$C_{60}$-Alkynylgruppe, einer $C_1$-$C_{60}$-Alkoxygruppe, einer $C_1$-$C_{20}$-Alkylthiogruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_7$-$C_{60}$-Alkylarylgruppe, einer $C_7$-$C_{60}$-Arylalkylgruppe, einer $C_6$-$C_{60}$-Aryloxygruppe, einer $C_6$-$C_{60}$-Arylthiogruppe, einer $C_1$-$C_{60}$-Heteroarylgruppe, einer $C_2$-$C_{60}$-Alkylheteroarylgruppe, einer $C_1$-$C_{60}$-Heteroaryloxygruppe, einer $C_1$-$C_{60}$-Heteroarylthiogruppe, einer einwertigen nichtaromatische kondensierte polyzyklische Gruppe, einer einwertigen nichtaromatischen kondensierten heteropolyzyklischen Gruppe, $-Si(Q_{511})(Q_{512})(Q_{513})$, - $Ge(Q_{511})(Q_{512})(Q_{513})$, $-C(Q_{511})(Q_{512})(Q_{513})$, $-B(Q_{511})(Q_{512})$, $-N(Q_{511})(Q_{512})$, $-P(Q_{511})(Q_{512})$, - $C(=O)(Q_{511})$, $-S(=O)(Q_{511})$, $-S(=O)_2(Q_{511})$, $-P(=O)(Q_{511})(Q_{512})$, $-P(=S)(Q_{511})(Q_{512})$ oder eine Kombination davon:

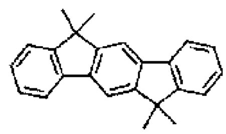

501-1

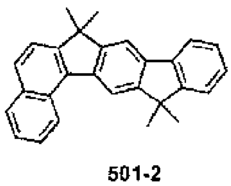

501-2

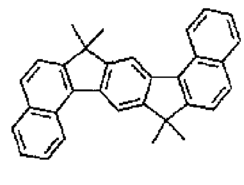

501-3

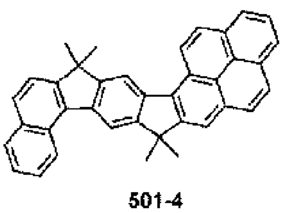

501-4

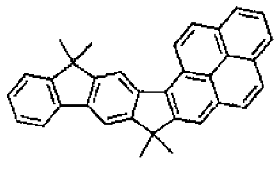

501-5

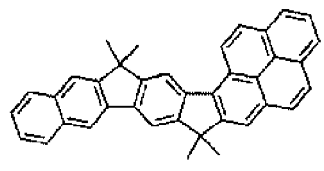

501-6

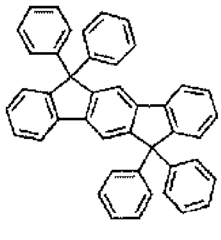

501-7

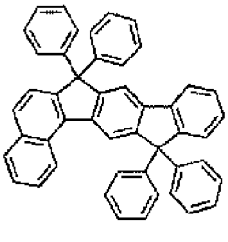

501-8

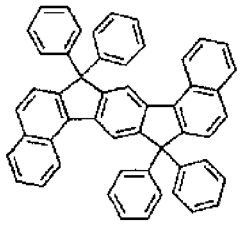

501-9

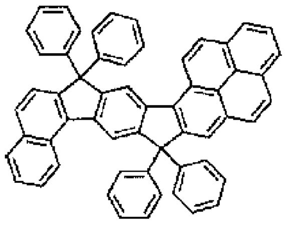

501-10

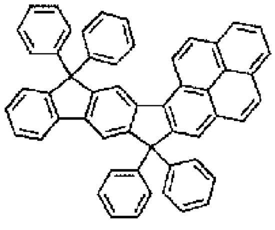

501-11

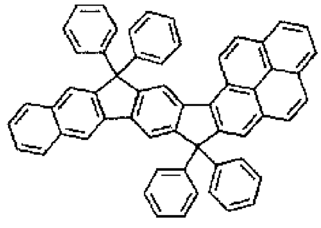

501-12

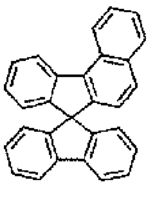

501-13

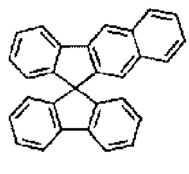

501-14

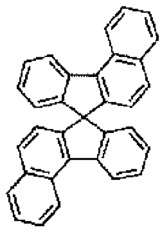

501-15

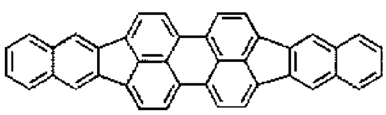

501-16

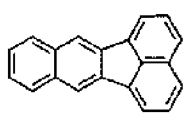

501-17

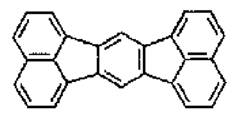

501-18

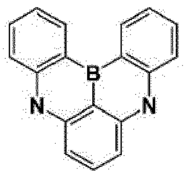

501-19

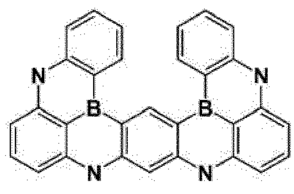

501-20

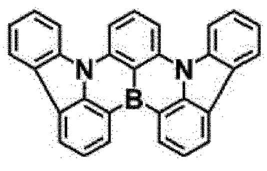

501-21

,

$L_{511}$ bis $L_{514}$ jeweils unabhängig Folgendes ist: eine substituierte oder unsubstituierte $C_3$-$C_{10}$-Cycloalkylengruppe, eine substituierte oder unsubstituierte $C_1$-$C_{10}$-Heterocycloalkylengruppe, eine substituierte oder unsubstituierte $C_3$-$C_{10}$-Cycloalkenylengruppe, eine substituierte oder unsubstituierte $C_1$-$C_{10}$-Heterocycloalkenylengruppe, eine substituierte oder unsubstituierte $C_6$-$C_{60}$-Arylengruppe, eine substituierte oder unsubstituierte $C_1$-$C_{60}$-Heteroarylengruppe, eine substituierte oder unsubstituierte zweiwertige nichtaromatische kondensierte polyzyklische Gruppe oder eine substituierte oder unsubstituierte zweiwertige nichtaromatische kondensierte heteropolyzyklische Gruppe, wobei a511 oder a514 jeweils unabhängig 0, 1, 2 oder 3 sind,

$R_{511}$ bis $R_{513}$ jeweils unabhängig eine substituierte oder unsubstituierte $C_1$-$C_{60}$-Alkylgruppe, eine substituierte oder unsubstituierte $C_3$-$C_{10}$-Cycloalkylgruppe, eine substituierte oder unsubstituierte $C_6$-$C_{60}$-Arylgruppe, eine substituierte oder unsubstituierte $C_7$-$C_{60}$-Alkylarylgruppe, eine substituierte oder unsubstituierte $C_7$-$C_{60}$-Arylalkylgruppe, eine substituierte oder unsubstituierte $C_1$-$C_{60}$-Heteroarylgruppe, eine substituierte oder unsubstituierte $C_2$-$C_{60}$-Alkylheteroarylgruppe, eine substituierte oder unsubstituierte $C_2$-$C_{60}$-Heteroarylalkylgruppe, eine substituierte oder unsubstituierte einwertige nichtaromatische kondensierte polyzyklische Gruppe oder eine

substituierte oder unsubstituierte einwertige nichtaromatische kondensierte heteropolyzyklische Gruppe sind, wobei $Q_{511}$ bis $Q_{513}$ jeweils unabhängig Folgendes sind: Wasserstoff, Deuterium, -F, -Cl, - Br, -I, $-SF_5$, eine Hydroxylgruppe, eine Cyanogruppe, eine Nitrogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkynylgruppe, eine $C_1$-$C_{60}$-Alkoxygruppe, eine $C_1$-$C_{60}$-Alkylthiogruppe, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_7$-$C_{60}$-Alkylarylgruppe, eine $C_7$-$C_{60}$-Arylalkylgruppe, eine $C_6$-$C_{60}$-Aryloxygruppe, eine $C_6$-$C_{60}$-Arylthiogruppe, eine $C_1$-$C_{60}$-Heteroarylgruppe, eine $C_2$-$C_{60}$-Alkylheteroarylgruppe, eine $C_2$-$C_{60}$-Heteroarylalkylgruppe, eine $C_1$-$C_{60}$-Heteroaryloxygruppe, eine $C_1$-$C_{60}$-Heteroarylthiogruppe, eine einwertige nichtaromatische kondensierte polyzyklische Gruppe oder eine einwertige nichtaromatische kondensierte heteropolyzyklischen Gruppe, wobei jede unsubstituiert oder mit mindestens einem von Deuterium, -F, einer Cyanogruppe, einer $C_1$-$C_{20}$-Alkylgruppe, einer $C_6$-$C_{30}$-Arylgruppe oder einer Kombination davon substituiert ist, und

n511 und n512 jeweils unabhängig 0, 1, 2, 3, 4, 5 oder 6 sind.

**10.** Organische lichtemittierende Vorrichtung nach einem der Ansprüche 1-9, wobei der Emitter eine Verbindung ist, die durch eines der Gruppe FD1 dargestellt ist:

Gruppe FD1

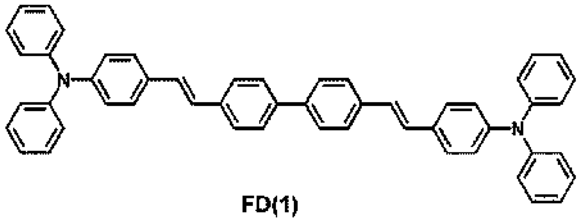

FD(1)

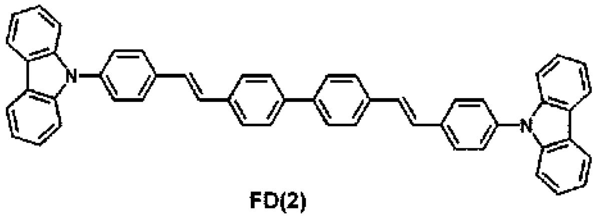

FD(2)

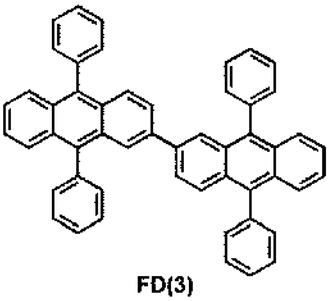

FD(3)

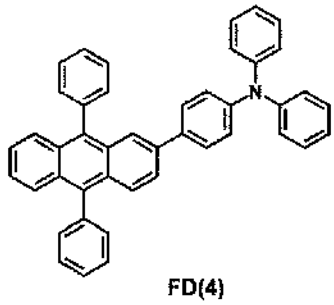

FD(4)

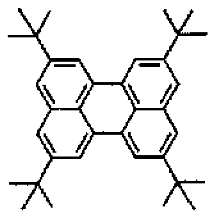

FD(5)

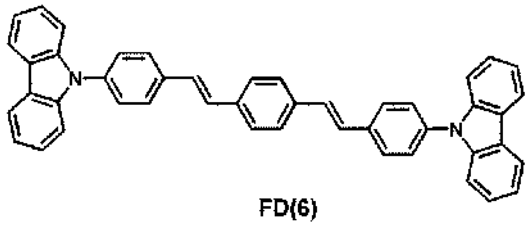

FD(6)

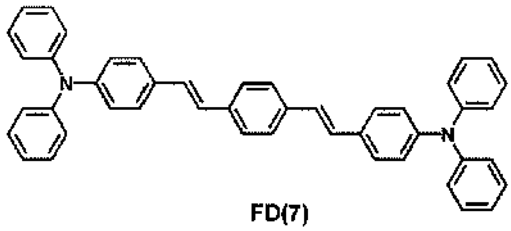

FD(7)

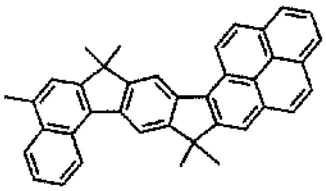

FD(8)

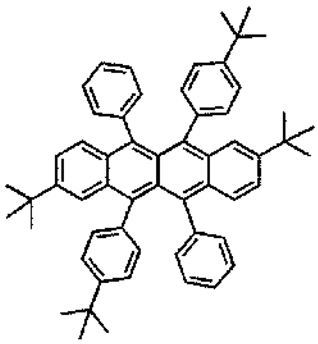

FD(9)

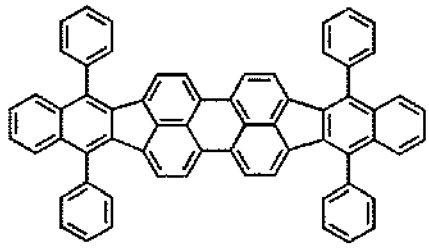

FD(10)

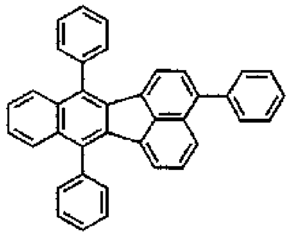

FD(11)

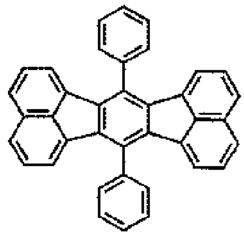

FD(12)

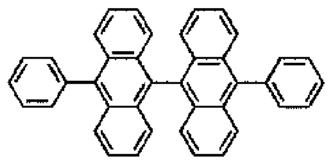

FD(13)

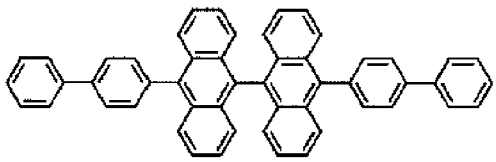

FD(14)

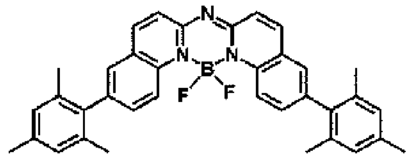

FD(15)

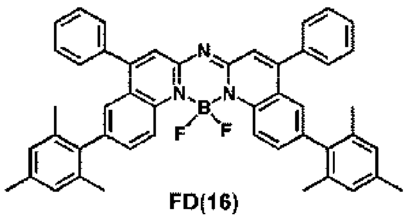

FD(16)

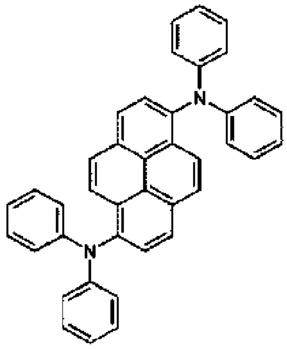

FD1

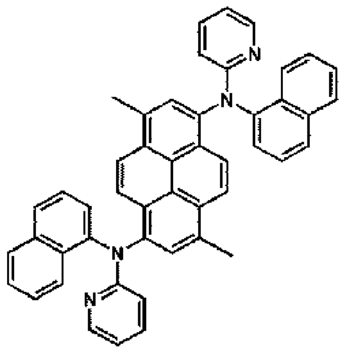

FD2

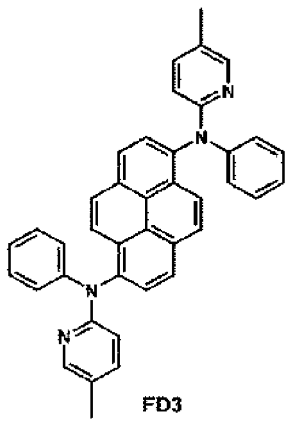

FD3

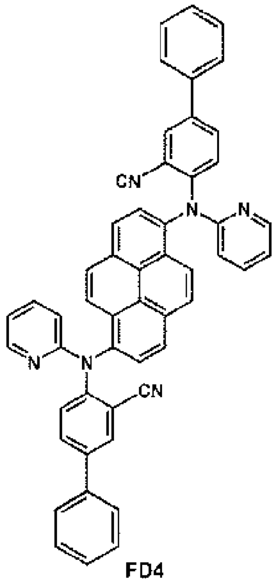

FD4

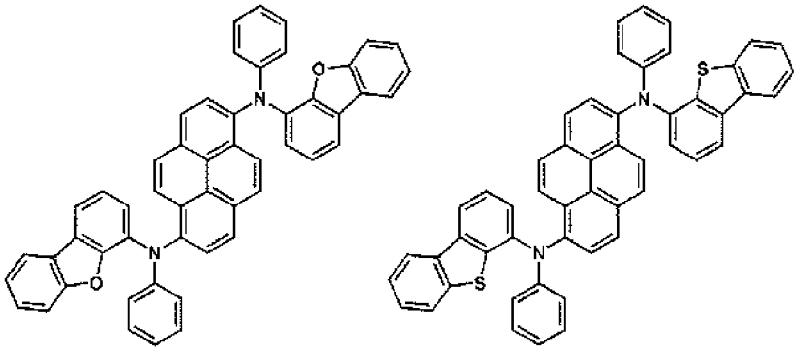

FD5

FD6

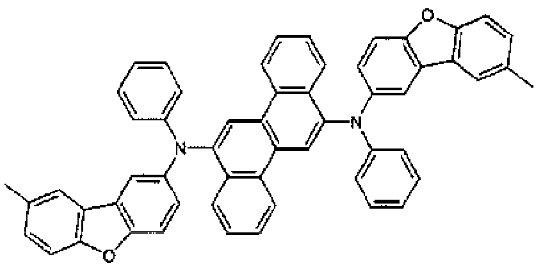

FD7

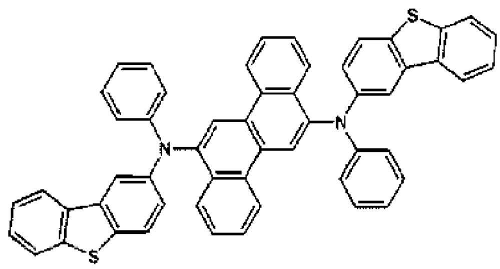

FD8

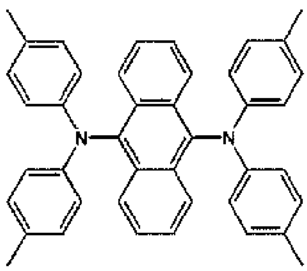

FD9

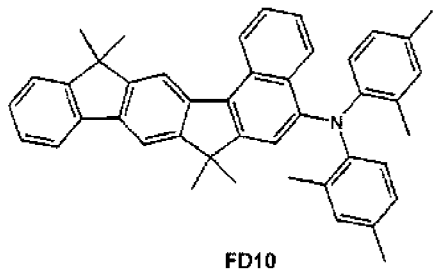

FD10

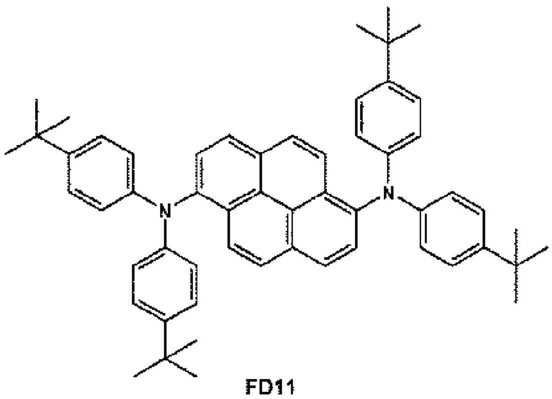

FD11

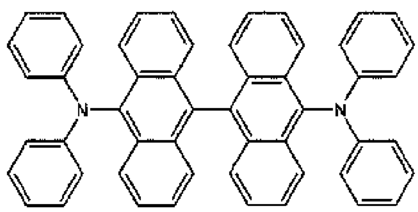

FD12

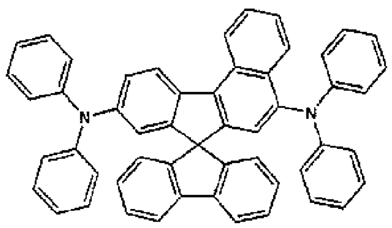

FD13

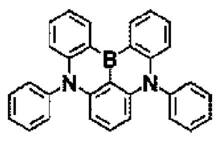

BD1-1

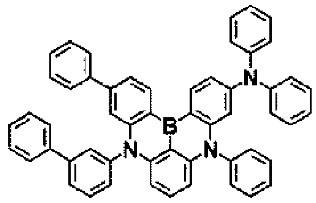

BD1-2

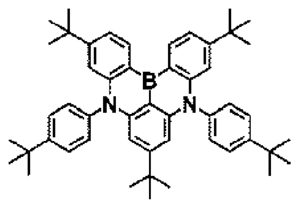

BD1-3

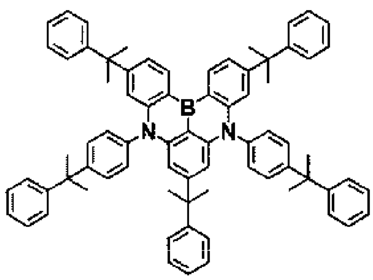

BD1-4

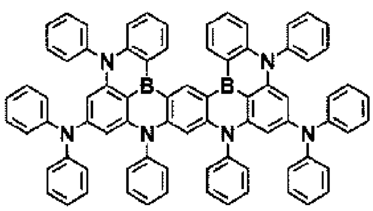

BD1-5

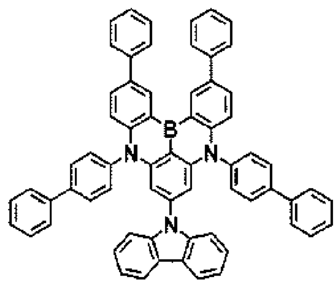

BD1-6

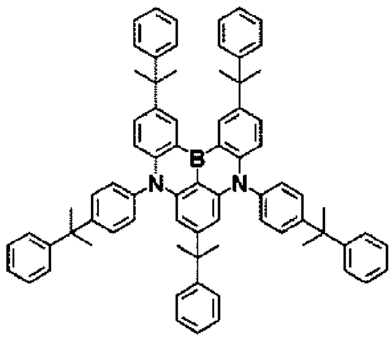

BD1-7

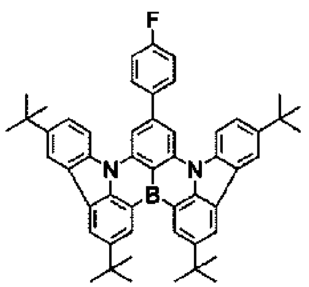

BD1-8

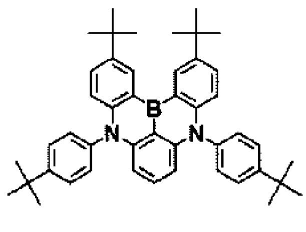

BD1-9

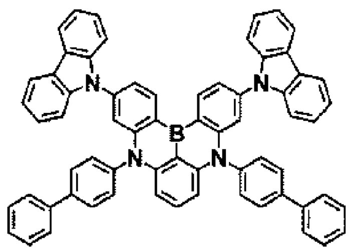

BD1-10

**11.** Organische lichtemittierende Vorrichtung nach einem der Ansprüche 1-10, wobei der Wirt und der Sensibilisator im Wesentlichen kein Licht emittieren und der Emitter Licht emittiert.

**12.** Organische lichtemittierende Vorrichtung nach einem der Ansprüche 1-11, wobei Bedingung 1 erfüllt ist:

Bedingung 1

$$S_1(H) > S_1(S) \geq S_1(E)$$

wobei bei Bedingung 1

$S_1(H)$ ein niedrigstes angeregtes Singulett-Energieniveau des Wirts angibt,
$S_1(S)$ ein niedrigstes angeregtes Singulett-Energieniveau des Sensibilisators angibt und
$S_1(E)$ ein niedrigstes angeregtes Singulett-Energieniveau des Emitters angibt,
wobei die Energieniveaus durch die Dichtefunktionaltheorie bestimmt werden; und/oder
wobei Bedingung 2 erfüllt ist:

Bedingung 2

$$T_1(H) \geq T_1(S)$$

wobei bei Bedingung 2,

$T_1(H)$ ein niedrigstes angeregtes Triplett-Energieniveau des Wirts angibt und
$T_1(S)$ ein niedrigstes angeregtes Triplett-Energieniveau des Sensibilisators angibt, wobei die Energieniveaus durch die Dichtefunktionaltheorie bestimmt werden.

**13.** Organische lichtemittierende Vorrichtung nach einem der Ansprüche 1-12, wobei
ein Gehalt des Sensibilisators in der Emissionsschicht im Bereich von 1 Gew.-% bis 50 Gew.-% liegt, ein Gehalt des Wirts in der Emissionsschicht im Bereich von 30 Gew.-% bis 90 Gew.-% liegt und ein Gehalt des Emitters in der Emissionsschicht im Bereich von 0,01 Gew.-% bis 15 Gew.-% liegt, jeweils bezogen auf das Gesamtgewicht der Emissionsschicht.

**14.** Organische lichtemittierende Vorrichtung nach Anspruch 1, ferner umfassend:

m Emissionseinheiten, die zwischen der ersten Elektrode und der zweiten Elektrode gestapelt sind und jeweils mindestens eine Emissionsschicht umfassen; und
m-1 ladungserzeugende Schichten, die sich zwischen jeweils zwei benachbarten Emissionseinheiten aus den m Emissionseinheiten befinden, wobei jede der m-1 ladungserzeugenden Schichten eine ladungserzeugende Schicht vom n-Typ und eine ladungserzeugende Schicht vom p-Typ umfasst, wobei m eine ganze Zahl von 2 oder größer ist,
sich eine maximale Emissionswellenlänge des von mindestens einer der m Emissionseinheiten emittierten Lichts von einer maximalen Emissionswellenlänge des von mindestens einer der anderen Emissionseinheiten emittierten Lichts unterscheidet,
mindestens eine der m Emissionsschichten die Emissionsschicht ist, die den Wirt, den Dotierstoff und den Sensibilisator umfasst.

**15.** Organische lichtemittierende Vorrichtung nach Anspruch 1, ferner umfassend:

m Emissionsschichten, die sich zwischen der ersten Elektrode und der zweiten Elektrode befinden, wobei m eine ganze Zahl von 2 oder größer ist,
sich eine maximale Emissionswellenlänge des von mindestens einer der m Emissionsschichten emittierten Lichts von einer maximalen Emissionswellenlänge des von mindestens einer der anderen Emissionsschichten emittierten Lichts unterscheidet,
mindestens eine der m Emissionsschichten die Emissionsschicht ist, die den Wirt, den Sensibilisator und den Emitter umfasst.

## Revendications

**1.** Dispositif électroluminescent organique, comprenant :

une première électrode (11) ;
une seconde électrode (19) ; et
une couche organique (10A) située entre la première électrode et la seconde électrode, ladite couche organique comprenant une couche d'émission (15),
ladite couche d'émission comprenant un hôte, un sensibilisateur et un émetteur, et
ledit hôte, ledit sensibilisateur et ledit émetteur étant différents les uns des autres, et
ledit sensibilisateur étant représenté par la formule 1 :

Formule 1 $M_1(L_1)(L_2)$

dans laquelle, dans la formule 1,

$M_1$ représente un atome Au, Ag ou Cu,
$L_1$ est un ligand représenté par la formule 2-1 ou la formule 2-2, et
$L_2$ est un ligand représenté par la formule 3-3 :

Formule 2-1

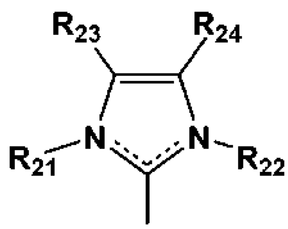

Formule 2-2

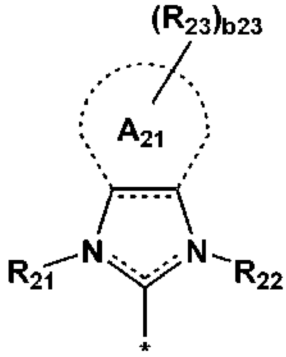

Formule 3-3

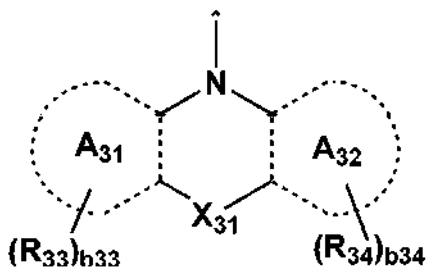

dans lesquelles, dans les formules 2-1, 2-2 et 3-3,

$A_{21}$, $A_{31}$ et $A_{32}$ représentent chacun indépendamment un groupe $C_5$-$C_{30}$ carbocyclique monocyclique ou polycyclique ou un groupe $C_1$-$C_{30}$ hétérocyclique monocyclique ou polycyclique,
$X_{31}$ représente une liaison simple, un atome O, S, un groupe $N(R_{36})$, $C(R_{36})=C(R_{37})$, $[C(R_{36})(R_{37})]_{n31}$ ou $[Si(R_{36})(R_{37})]_{n31}$, n31 valant 1 ou 2,
$R_{21}$ et $R_{22}$ représentent chacun indépendamment un groupe $C_1$-$C_{60}$ alkyle substitué ou non substitué, un groupe $C_3$-$C_{10}$ cycloalkyle substitué ou non substitué, un groupe $C_6$-$C_{60}$ aryle substitué ou non substitué, un groupe $C_7$-$C_{60}$ alkylaryle substitué ou non substitué, un groupe $C_7$-$C_{60}$ arylalkyle substitué ou non substitué, un groupe $C_1$-$C_{60}$ hétéroaryle substitué ou non substitué, un groupe $C_2$-$C_{60}$ alkyl-hétéroaryle substitué ou non substitué, un groupe $C_2$-$C_{60}$ hétéroarylalkyle substitué ou non substitué,

un groupe polycyclique condensé non aromatique monovalent substitué ou non substitué, ou un groupe hétéropolycyclique condensé non aromatique monovalent substitué ou non substitué,

$R_{23}$, $R_{24}$, $R_{36}$ et $R_{37}$ représentent chacun indépendamment un atome d'hydrogène, un atome de deutérium, un groupe -F, -Cl, -Br, -I, -$SF_5$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle substitué ou non substitué, un groupe $C_2$-$C_{60}$ alcényle substitué ou non substitué, un groupe $C_2$-$C_{60}$ alcynyle substitué ou non substitué, un groupe $C_1$-$C_{60}$ alcoxy substitué ou non substitué, un groupe $C_1$-$C_{60}$ alkylthio substitué ou non substitué, un groupe $C_3$-$C_{10}$ cycloalkyle substitué ou non substitué, un groupe $C_1$-$C_{10}$ hétérocycloalkyle substitué ou non substitué, un groupe $C_3$-$C_{10}$ cycloalcényle substitué ou non substitué, un groupe $C_1$-$C_{10}$ hétérocycloalcényle substitué ou non substitué, un groupe $C_6$-$C_{60}$ aryle substitué ou non substitué, un groupe $C_7$-$C_{60}$ alkylaryle substitué ou non substitué, un groupe $C_7$-$C_{60}$ arylalkyle substitué ou non substitué, un groupe $C_6$-$C_{60}$ aryloxy substitué ou non substitué, un groupe $C_6$-$C_{60}$ arylthio substitué ou non substitué, un groupe $C_1$-$C_{60}$ hétéroaryle substitué ou non substitué, un groupe $C_2$-$C_{60}$ alkylhétéroaryle substitué ou non substitué, un groupe $C_2$-$C_{60}$ hétéroarylalkyle substitué ou non substitué, un groupe $C_1$-$C_{60}$ hétéroaryloxy substitué ou non substitué, un groupe $C_1$-$C_{60}$ hétéroarylthio substitué ou non substitué, un groupe polycyclique condensé non aromatique monovalent substitué ou non substitué, ou un groupe hétéropolycyclique condensé non aromatique monovalent substitué ou non substitué, -Si($Q_1$)($Q_2$)($Q_3$), - Ge($Q_1$)($Q_2$)($Q_3$), -C($Q_1$)($Q_2$)($Q_3$), -B($Q_1$)($Q_2$), -N($Q_1$)($Q_2$), -P($Q_1$)($Q_2$), - C(=O)($Q_1$), -S(=O)($Q_1$), - S(=O)$_2$($Q_1$), -P(=O)($Q_1$)($Q_2$) ou -P(=S)($Q_1$)($Q_2$), et $R_{36}$ et $R_{37}$ sont éventuellement liés l'un à l'autre pour former un groupe $C_5$-$C_{30}$ carbocyclique substitué ou non substitué ou un groupe $C_1$-$C_{30}$ hétérocyclique substitué ou non substitué,

$R_{33}$ et $R_{34}$ représentent chacun indépendamment un groupe $C_1$-$C_{60}$ alkyle substitué ou non substitué, et b23 et b33 valent chacun indépendamment 1, 2, 3, 4, 5, 6, 7, 8, 9 ou 10,

$Q_1$ à $Q_3$ représentant chacun indépendamment un atome d'hydrogène, un atome de deutérium, un groupe -F, -Cl, -Br, -I, - $SF_5$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_1$-$C_{66}$ alkylthio, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_7$-$C_{60}$ alkylaryle, un groupe $C_7$-$C_{60}$ arylalkyle, un groupe $C_6$-$C_{60}$ aryloxy, un groupe $C_6$-$C_{60}$ arylthio, un groupe $C_1$-$C_{60}$ hétéroaryle, un groupe $C_2$-$C_{60}$ alkylhétéroaryle, un groupe $C_2$-$C_{60}$ hétéroarylalkyle, un groupe $C_1$-$C_{60}$ hétéroaryloxy, un groupe $C_1$-$C_{60}$ hétéroarylthio, un groupe polycyclique condensé non aromatique monovalent, ou un groupe hétéropolycyclique condensé non aromatique monovalent, chacun non substitué ou substitué par au moins un élément parmi un atome de deutérium, un groupe -F, un groupe cyano, un groupe $C_1$-$C_{20}$ alkyle, et un groupe $C_6$-$C_{30}$ aryle, un groupe $C_6$-$C_{60}$ aryle, ou une combinaison de ceux-ci, et

* indique un site de liaison à $M_1$ dans la formule 1 ; et

**caractérisé en ce que** b34 vaut 2, 3, 4, 5, 6, 7, 8, 9 ou 10.

**2.** Dispositif électroluminescent organique selon la revendication 1, $A_{21}$, $A_{31}$ et $A_{32}$ représentant chacun indépendamment un groupe benzène, un groupe naphtalène, un groupe phénanthrène, un groupe furane, un groupe thiophène, un groupe pyrrole, un groupe cyclopentène, un groupe silole, un groupe germole, un groupe benzofurane, un groupe benzothiophène, un groupe indole, un groupe indène, un groupe benzosilole, un groupe benzogermole, un groupe dibenzofurane, un groupe dibenzothiophène, un groupe carbazole, un groupe fluorène, un groupe dibenzosilole, un groupe dibenzogermole, un groupe pyridine, un groupe pyrimidine, un groupe pyridazine ou un groupe pyrazine ; de préférence

$A_{21}$ représentant un groupe benzène, un groupe naphtalène, un groupe pyridine, un groupe pyrimidine, un groupe pyridazine, ou un groupe pyrazine, et

$A_{31}$ et $A_{32}$ représentant chacun indépendamment un groupe benzène, un groupe naphtalène, un groupe dibenzofurane, un groupe dibenzothiophène, un groupe carbazole, un groupe pyridine, un groupe pyrimidine, un groupe pyridazine ou un groupe pyrazine.

**3.** Dispositif électroluminescent organique selon la revendication 1 ou 2,

$L_1$ étant un ligand représenté par la formule 2-11 ou la formule 2-12, et
$L_2$ étant un ligand représenté par l'une des formules 3-13 à 3-17 :

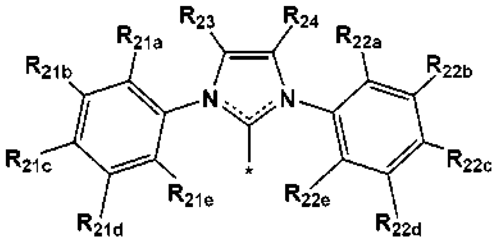

2-11

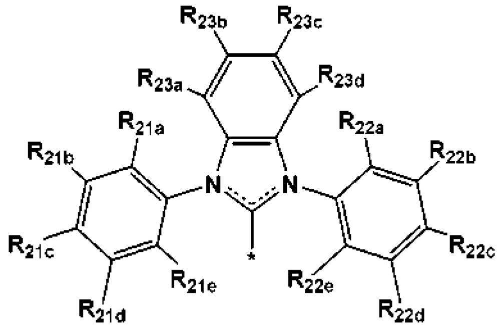

2-12

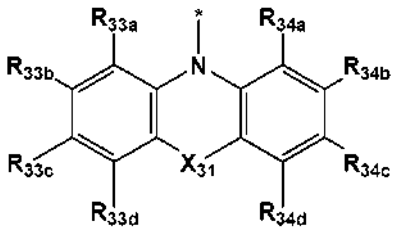

3-13

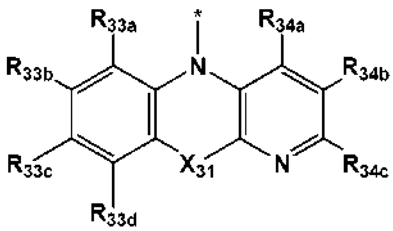

3-14

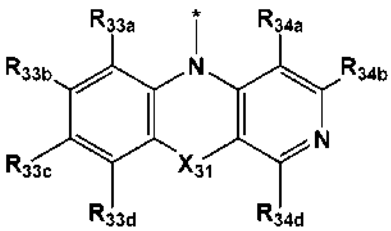

3-15

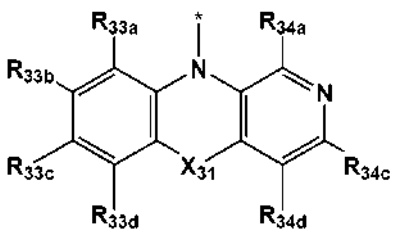

3-16

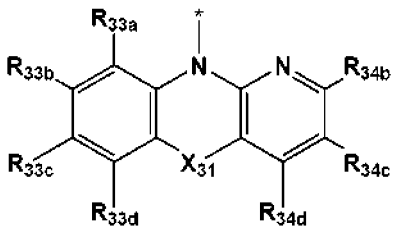

3-17

dans lesquelles, dans les formules 2-11, 2-12, et 3-13 à 3-17,

$X_{31}$, $R_{23}$ et $R_{24}$ sont tels que définis dans la revendication 1, et
$R_{21a}$ à $R_{21c}$, $R_{22a}$ à $R_{22e}$, et $R_{23a}$ à $R_{23d}$ représentent chacun indépendamment un atome d'hydrogène, un atome de deutérium, un groupe -F, -Cl, -Br, -I, $-SF_5$, $-CD_3$, $-CD_2H$, $-CDH_2$, $-CF_3$, $-CF_2H$, $-CFH_2$, un groupe hydroxy, un groupe cyano, un groupe nitro, un groupe amidino, un groupe hydrazine, un groupe hydrazone, un groupe acide sulfonique ou un sel de celui-ci, un groupe $C_1$-$C_{20}$ alkyle, un groupe $C_2$-$C_{20}$ alkyle deutéré, un groupe $C_1$-$C_{20}$ alcoxy, un groupe $C_1$-$C_{20}$ alkylthio, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe

($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe ($C_1$-$C_{20}$ alkyl)norbornényle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1 ]pentyle, un groupe ($C_1$-$C_{20}$ alkyl)bicyclo[2.1.1]hexyle, un groupe ($C_1$-$C_{20}$ alkyl)bicyclo[2.2.1]heptyle, a($C_1$-$C_{20}$ alkyl)bicyclo[2.2.2]octyle, un groupe phényle, un groupe ($C_1$-$C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle, un groupe azadibenzothiophényle, $-Si(Q_{21})(Q_{22})(Q_{23})$, $-Ge(Q_{21})(Q_{22})(Q_{23})$, - $C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, - $S(=O)_2(Q_{21})$, $-P(=O)(Q_{21})(Q_{22})$ ou- $P(=S)(Q_{21})(Q_{22})$,

$R_{33a}$ à $R_{33d}$ et $R_{34a}$ à $R_{34d}$ représentant chacun indépendamment un groupe $C_1$-$C_{20}$ alkyle ou un groupe $C_2$-$C_{20}$ alkyle deutéré,

$Q_{21}$ à $Q_{23}$ représentant chacun indépendamment :

un atome d'hydrogène, un atome de deutérium, un groupe -F, un groupe cyano, $-CH_3$, - $CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, - $CHDCDH_2$, $-CHDCD_3$, $-CD_2CD_3$, - $CD_2CD_2H$, $-CD_2CDH_2$, $-CF_3$, $-CF_2H$, $-CFH_2$, $-CH_2CF_3$, - $CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$ ou - $CF_2CFH_2$, ou

un groupe n-propyle, un groupe iso-propyle, un groupe n-butyle, un groupe sec-butyle, un groupe isobutyle, un groupe tert-butyle, un groupe n-pentyle, un groupe tert-pentyle, un groupe néopentyle, un groupe isopentyle, un groupe sec-pentyle, un groupe 3-pentyle, un groupe sec-isopentyle, un groupe phényle, un groupe biphényle ou un groupe naphtyle, chacun non substitué ou substitué par au moins un élément parmi un atome de deutérium, un groupe -F, un groupe $C_1$-$C_{10}$ alkyle, un groupe $C_1$-$C_{10}$ alkyle deutéré, un groupe phényle, ou une combinaison de ceux-ci, et

* indique un site de liaison à $M_1$ dans la formule 1 ;

de préférence

$L_1$ étant un ligand représenté par la formule 2-11 ou la formule 2-12, et

$L_2$ étant un ligand représenté par la formule 3-13.

4. Dispositif électroluminescent organique selon l'une quelconque des revendications 1 à 3, $L_1$ étant un ligand représenté par l'une des formules 2-21 à 2-26 :

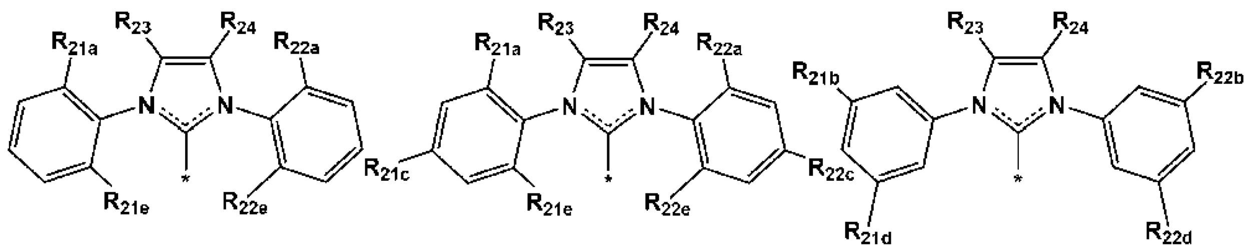

2-21 2-22 2-23

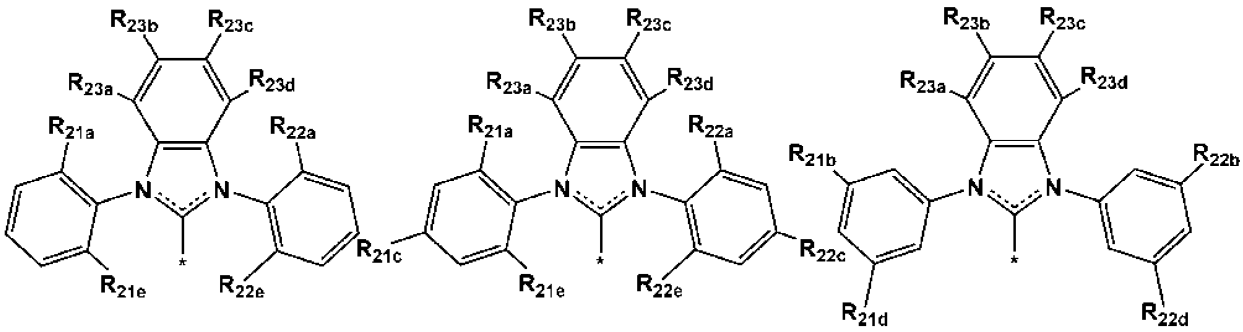

2-24 2-25 2-26

dans lesquelles, dans les formules 2-21 à 2-26,
$R_{23}$, $R_{24}$, et $R_{23a}$ à $R_{23d}$ représentent chacun indépendamment :

un atome d'hydrogène, un atome de deutérium, un groupe -F, -Cl, -Br, -I, $-SF_5$, un groupe hydroxy, un groupe cyano ou un groupe nitro ;
un groupe $C_1$-$C_{20}$ alkyle non substitué ou substitué par au moins un élément parmi un atome de deutérium, un groupe -F, -Cl, -Br, -I, $-SF_5$, $-CD_3$, $-CD_2H$, $-CDH_2$, $-CF_3$, $-CF_2H$, $-CFH_2$, un groupe hydroxy, un groupe cyano, un groupe nitro, un groupe $C_1$-$C_{20}$ alkyle, un groupe $C_2$-$C_{20}$ alkyle deutéré, un groupe $C_1$-$C_{20}$ alcoxy, un groupe $C_1$-$C_{20}$ alkylthio, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe ($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe ($C_1$-$C_{20}$ alkyl)norbornényle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1]pentyle, un groupe ($C_1$-$C_{20}$ alkyl)bicyclo[2.1.1]hexyle, un groupe ($C_1$-$C_{20}$ alkyl)bicyclo[2.2.1]heptyle, un groupe ($C_1$-$C_{20}$ alkyl)bicyclo[2.2.2]octyle, un groupe phényle, un groupe ($C_1$-$C_{20}$ alkyl)phényle, un groupe biphényle, un groupe terphényle, un groupe naphtyle, $-Si(Q_{11})(Q_{12})(Q_{13})$, $-Ge(Q_{11})(Q_{12})(Q_{13})$, - $C(Q_{10})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, - $S(=O)_2(Q_{11})$, $-P(=O)(Q_{11})(Q_{12})$, $-P(=S)(Q_{11})(Q_{12})$, ou une combinaison de ceux-ci ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$-$C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle ou un groupe azadibenzothiophényle, chacun non substitué ou substitué par au moins un élément parmi un atome de deutérium, un groupe -F, -Cl, -Br, -I, $-SF_5$, $-CD_3$, $-CD_2H$, $-CDH_2$, $-CF_3$, $-CF_2H$, $-CFH_2$, un groupe hydroxy, un groupe cyano, un groupe nitro, un groupe $C_1$-$C_{20}$ alkyle, un groupe $C_2$-$C_{20}$ alkyle deutéré, un groupe $C_1$-$C_{20}$ alcoxy, un groupe $C_1$-$C_{20}$ alkylthio, un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe ($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe

($C_1$-$C_{20}$ alkyl)norbornényle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1]pentyle, un groupe ($C_1$-$C_{20}$ alkyl)bicyclo[2.1.1]hexyle, un groupe ($C_1$-$C_{20}$ alkyl)bicyclo[2.2.1]heptyle, un groupe ($C_1$-$C_{20}$ alkyl)bicyclo[2.2.2]octyle, un groupe phényle, un groupe ($C_1$-$C_{20}$ alkyl)phényle, un groupe biphényle, un groupe terphényle, un groupe naphtyle, un groupe pyridinyle, un groupe pyrazinyle, un groupe pyrimidinyle, un groupe pyridazinyle, un groupe quinolinyle, un groupe isoquinolinyle, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, - $P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, ou une combinaison de ceux-ci ; ou

$-Si(Q_1)(Q_2)(Q_3)$, $-Ge(Q_1)(Q_2)(Q_3)$, $-C(Q_1)(Q_2)(Q_3)$, $-B(Q_1)(Q_2)$ ou $-N(Q_1)(Q_2)$, et

$R_{21a}$, $R_{21b}$, $R_{21c}$, $R_{21d}$, $R_{21e}$, $R_{22a}$, $R_{22b}$, $R_{22c}$, $R_{22d}$, et $R_{22e}$ représentent chacun indépendamment un atome d'hydrogène, un atome de deutérium, un groupe -F, -Cl, -Br, -I, $-SF_5$, $-CD_3$, $-CD_2H$, $-CDH_2$, $-CF_3$, $-CF_2H$, $-CFH_2$, un groupe hydroxy, un groupe cyano, un groupe nitro, un groupe amidino, un groupe hydrazine, un groupe hydrazone, un groupe acide sulfonique ou un sel de celui-ci, un groupe $C_1$-$C_{20}$ alkyle, un groupe $C_2$-$C_{20}$ alkyle deutéré, un groupe $C_1$-$C_{20}$ alcoxy, un groupe $C_1$-$C_{20}$ alkylthio, un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe ($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe ($C_1$-$C_{20}$ alkyl)norbornényle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1]pentyle, un groupe ($C_1$-$C_{20}$ alkyl)bicyclo[2.1.1]hexyle, un groupe ($C_1$-$C_{20}$ alkyl)bicyclo[2.2.1]heptyle, un groupe ($C_1$-$C_{20}$ alkyl)bicyclo[2.2.2]octyle, un groupe phényle, un groupe ($C_1$-$C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle, un groupe azadibenzothiophényle, $-Si(Q_{21})(Q_{22})(Q_{23})$, $-Ge(Q_{21})(Q_{22})(Q_{23})$, - $C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, - S(=O)z(Qzi), $-P(=O)(Q_{21})(Q_{22})$ ou $-P(=S)(Q_{21})(Q_{22})$,

$Q_1$ à $Q_3$, $Q_{11}$ à $Q_{13}$, et $Q_{21}$ à $Q_{23}$ représentant chacun indépendamment :

un atome d'hydrogène, un atome de deutérium, un groupe -F, un groupe cyano, $-CH_3$, - $CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, - $CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, - $CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$ ou - $CF_2CFH_2$ ; ou

un groupe n-propyle, un groupe iso-propyle, un groupe n-butyle, un groupe sec-butyle, un groupe isobutyle, un groupe tert-butyle, un groupe n-pentyle, un groupe tert-pentyle, un groupe néopentyle, un groupe isopentyle, un groupe sec-pentyle, un groupe 3-pentyle, un groupe sec-isopentyle, un groupe phényle, un groupe biphényle ou un groupe naphtyle, chacun non substitué ou substitué par au moins un élément parmi un atome de deutérium, un groupe -F, un groupe $C_1$-$C_{10}$ alkyle, un groupe $C_1$-$C_{10}$ alkyle deutéré, un groupe phényle, ou une combinaison de ceux-ci, et

* indique un site de liaison à $M_1$ dans la formule 1 ; et/ou

$L_2$ étant un ligand représenté par l'une des formules 3-21 à 3-26 :

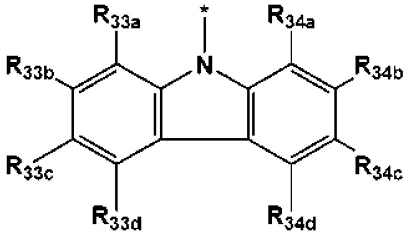

3-21

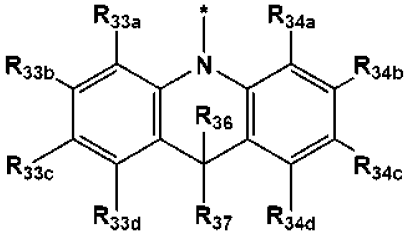

3-22

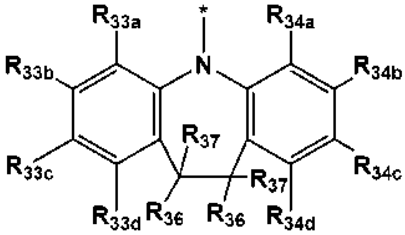

3-23

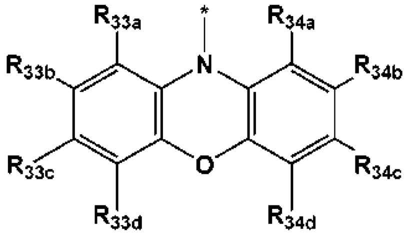

3-24

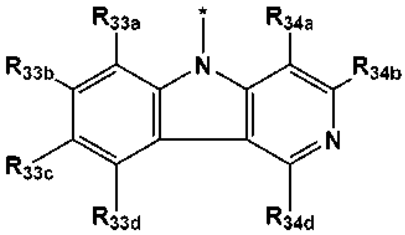

3-25

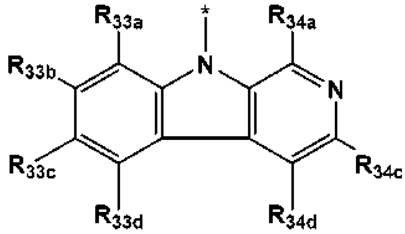

3-26

dans lesquelles, dans les formules 3-21 à 3-26,

$R_{36}$ et $R_{37}$ représentent chacun indépendamment :

un atome d'hydrogène, un atome de deutérium, un groupe -F, -Cl, -Br, -I, $-SF_5$, un groupe hydroxy, un groupe cyano ou un groupe nitro ;

un groupe $C_1$-$C_{20}$ alkyle non substitué ou substitué par au moins un élément parmi un atome de deutérium, un groupe -F, -Cl, -Br, -I, $-SF_5$, $-CD_3$, $-CD_2H$, $-CDH_2$, $-CF_3$, $-CF_2H$, $-CFH_2$, un groupe hydroxy, un groupe cyano, un groupe nitro, un groupe $C_1$-$C_{20}$ alkyle, un groupe $C_2$-$C_{20}$ alkyle deutéré, un groupe $C_1$-$C_{20}$ alcoxy, un groupe $C_1$-$C_{20}$ alkylthio, un groupe cyclopentyle, un groupe cyclohexyle, un groupe cycloheptyle, un groupe cyclooctyle, un groupe adamantanyle, un groupe norbornanyle, un groupe norboménylе, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe ($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe ($C_1$-$C_{20}$ alkyl)norbornényle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1]pentyle, un groupe ($C_1$-$C_{20}$ alkyl)bicyclo[2.1.1]hexyle, un groupe ($C_1$-$C_{20}$ alkyl)bicyclo[2.2.1]heptyle, un groupe ($C_1$-$C_{20}$ alkyl)bicyclo[2.2.2]octyle, un groupe phényle, un groupe ($C_1$-$C_{20}$ alkyl)phényle, un groupe biphényle, un groupe terphényle, un groupe naphtyle, $-Si(Q_{11})(Q_{12})(Q_{13})$, $-Ge(Q_{11})(Q_{12})(Q_{13})$, $- C(Q_{11})(Q_{12})(Q_{13})$, $-B(Q_{11})(Q_{12})$, $-N(Q_{11})(Q_{12})$, $-P(Q_{11})(Q_{12})$, $-C(=O)(Q_{11})$, $-S(=O)(Q_{11})$, $- S(=O)_2(Q_{11})$, $-P(=O)(Q_{11})(Q_{12})$, $-P(=S)(Q_{11})(Q_{12})$, ou une combinaison de ceux-ci ;

un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe phényle, un groupe ($C_1$-$C_{20}$ alkyl)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle,

un groupe dibenzofuranyle, un groupe dibenzothiophényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle ou un groupe azadibenzothiophényle, chacun non substitué ou substitué par au moins un élément parmi un atome de deutérium, un groupe -F, -Cl, -Br, -I, $-SF_5$, $-CD_3$, $-CD_2H$, $-CDH_2$, $-CF_3$, $-CF_2H$, $-CFH_2$, un groupe hydroxy, un groupe cyano, un groupe nitro, un groupe $C_1$-$C_{20}$ alkyle, un groupe $C_2$-$C_{20}$ alkyle deutéré, un groupe $C_1$-$C_{20}$ alcoxy, un groupe $C_1$-$C_{20}$ alkylthio, un groupe cyclopentyle, un groupe cyclohexyle, un groupe cycloheptyle, un groupe cyclooctyle, un groupe adamantanyle, un groupe norbornanyle, un groupe norboményle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.1]heptyle, un groupe bicyclo[2.2.2]octyle, un groupe ($C_1$-$C_{20}$ alkyl)cyclopentyle, un groupe ($C_1$-$C_{20}$ alkyl)cyclohexyle, un groupe ($C_1$-$C_{20}$ alkyl)cycloheptyle, un groupe ($C_1$-$C_{20}$ alkyl)cyclooctyle, un groupe ($C_1$-$C_{20}$ alkyl)adamantanyle, un groupe ($C_1$-$C_{20}$ alkyl)norbornanyle, un groupe ($C_1$-$C_{20}$ alkyl)norboményle, un groupe ($C_1$-$C_{20}$ alkyl)cyclopentényle, un groupe ($C_1$-$C_{20}$ alkyl)cyclohexényle, un groupe ($C_1$-$C_{20}$ alkyl)cycloheptényle, un groupe ($C_1$-$C_{20}$ alkyl)bicyclo[1.1.1]pentyle, un groupe ($C_1$-$C_{20}$ alkyl)bicyclo[2.1,1]hexyle, un groupe ($C_1$-$C_{20}$ alkyl)bicyclo[2.2.1]heptyle, un groupe ($C_1$-$C_{20}$ alkyl)bicyclo[2.2.2]octyle, un groupe phényle, un groupe ($C_1$-$C_{20}$ alkyl)phényle, un groupe biphényle, un groupe terphényle, un groupe naphtyle, un groupe pyridinyle, un groupe pyrazinyle, un groupe pyrimidinyle, un groupe pyridazinyle, un groupe quinolinyle, un groupe isoquinolinyle, $-Si(Q_{21})(Q_{22})(Q_{23})$, $-Ge(Q_{21})(Q_{22})(Q_{23})$, $-C(Q_{21})(Q_{22})(Q_{23})$, $-B(Q_{21})(Q_{22})$, $-N(Q_{21})(Q_{22})$, $-P(Q_{21})(Q_{22})$, $-C(=O)(Q_{21})$, $-S(=O)(Q_{21})$, $-S(=O)_2(Q_{21})$, $-P(=O)(Q_{21})(Q_{22})$, $-P(=S)(Q_{21})(Q_{22})$, ou une combinaison de ceux-ci ; ou
$-Si(Q_1)(Q_2)(Q_3)$, $-Ge(Q_1)(Q_2)(Q_3)$, $-C(Q_1)(Q_2)(Q_3)$, $-B(Q_1)(Q_2)$ ou $-N(Q_1)(Q_2)$, et
$R_{33a}$ à $R_{33d}$ et $R_{34a}$ à $R_{34d}$ représentent chacun indépendamment un groupe $C_1$-$C_{20}$ alkyle ou un groupe $C_2$-$C_{20}$ alkyle deutéré,
$Q_1$ à $Q_3$, $Q_{11}$ à $Q_{13}$, et $Q_{21}$ à $Q_{23}$ représentant chacun indépendamment :

un atome d'hydrogène, un atome de deutérium, un groupe -F, un groupe cyano, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$ ou $-CF_2CFH_2$ ; ou un groupe n-propyle, un groupe iso-propyle, un groupe n-butyle, un groupe sec-butyle, un groupe isobutyle, un groupe tert-butyle, un groupe n-pentyle, un groupe tert-pentyle, un groupe néopentyle, un groupe isopentyle, un groupe sec-pentyle, un groupe 3-pentyle, un groupe sec-isopentyle, un groupe phényle, un groupe biphényle, ou un groupe naphtyle, chacun non substitué ou substitué par au moins un élément parmi un atome de deutérium, un groupe -F, un groupe $C_1$-$C_{10}$ alkyle, un groupe $C_1$-$C_{10}$ alkyle deutéré, un groupe phényle, ou une combinaison de ceux-ci, et
* indique un site de liaison à $M_1$ dans la formule 1.

**5.** Dispositif électroluminescent organique selon l'une quelconque des revendications 1, 2 et 4, ledit sensibilisateur étant choisi parmi le groupe 1 :

Groupe I

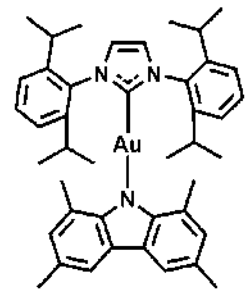

1

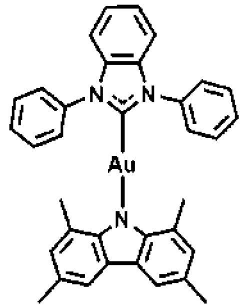

3

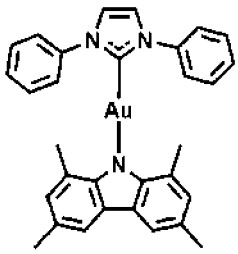

5

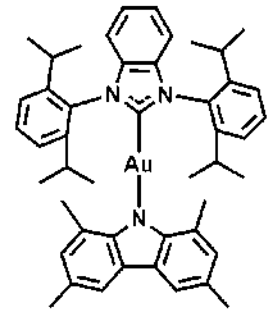

7

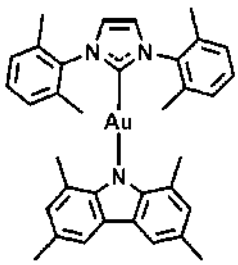

9

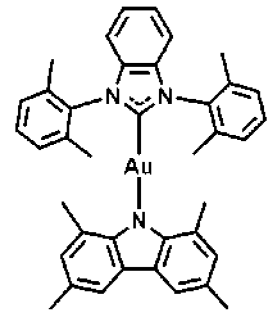

11

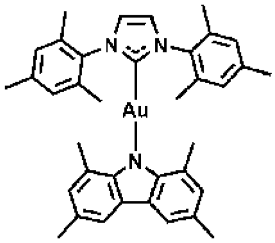

13

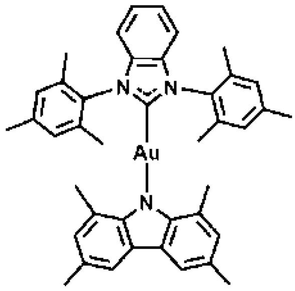

15

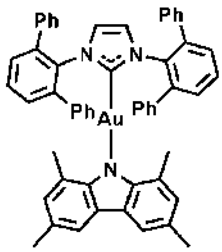

17

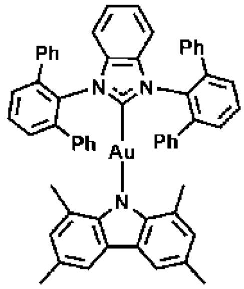

19

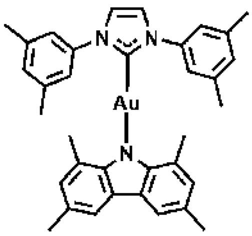

21

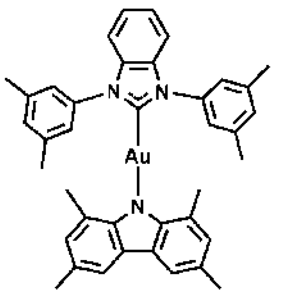

23

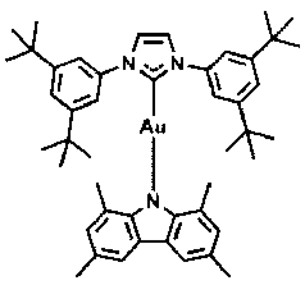

25

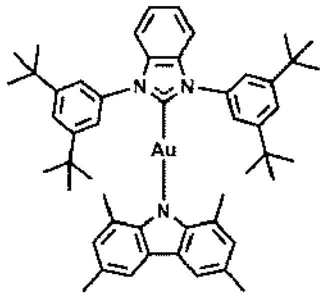

27

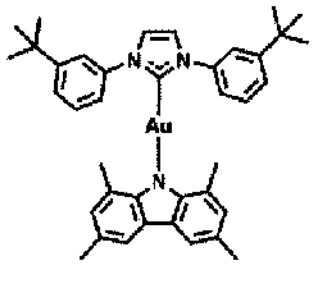

29

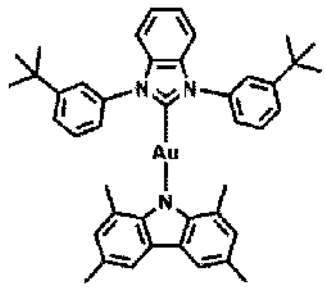

31

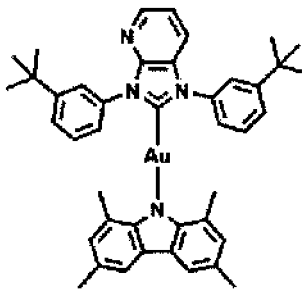

33

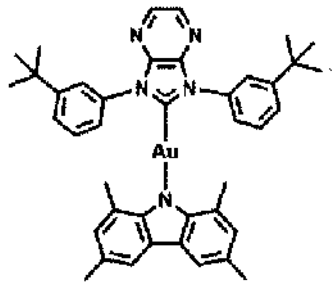

35

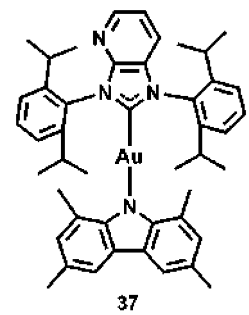

37

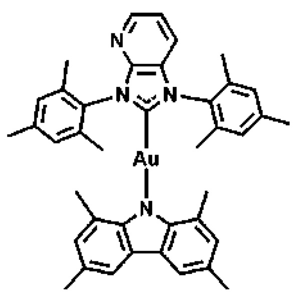

39

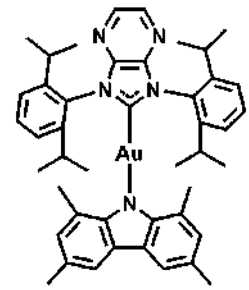

41

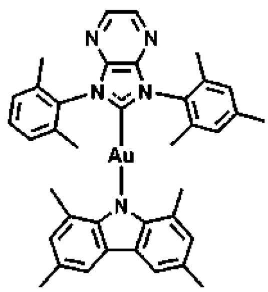

43

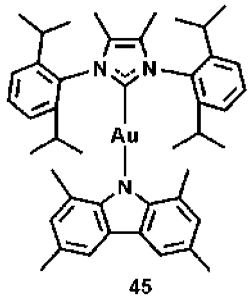

45

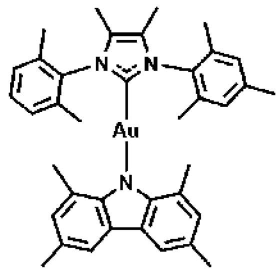

47

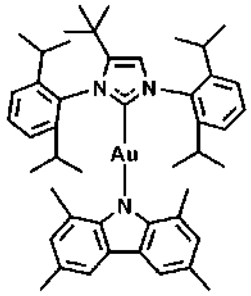

49

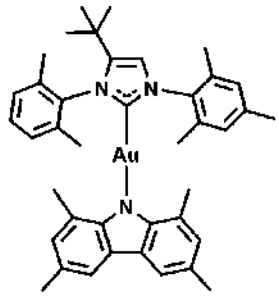

51

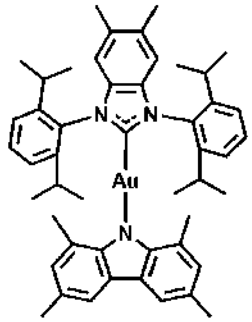

53

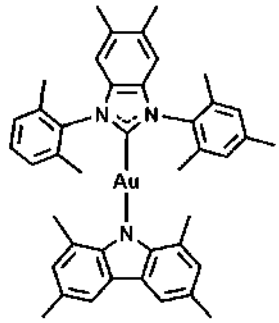

55

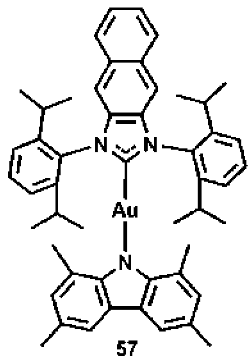

57

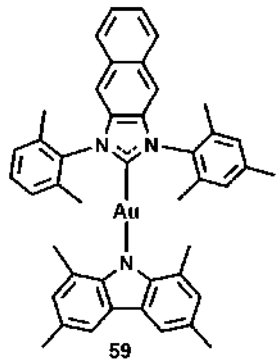

59

dans lequel, dans le groupe 1, « Ph » représente un groupe phényle.

**6.** Dispositif électroluminescent organique selon l'une quelconque des revendications 1 à 5, ledit hôte comprenant au moins un hôte parmi un hôte de transport de trous, un hôte de transport d'électrons ou un hôte bipolaire,

ledit hôte de transport d'électrons comprenant au moins une fraction de transport d'électrons,
ledit hôte de transport de trous comprenant une fraction de transport de trous et ne comprenant pas de fraction de transport d'électrons,
ledit hôte bipolaire comprenant au moins une fraction de transport d'électrons et au moins une fraction de transport de trous,
ladite fraction de transport d'électrons étant un groupe cyano, un groupe -F, $-CFH_2$, $-CF_2H$, $-CF_3$, un groupe $C_1$-$C_{60}$ cyclique contenant de l'azote appauvri en électrons $\Pi$, ou un groupe représenté par l'une des formules

fraction-TE,
ladite fraction de transport de trous étant un groupe $C_3$-$C_{60}$ cyclique riche en électrons Π ou un groupe représenté par la formule fraction-TT :

Fraction-TE

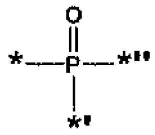
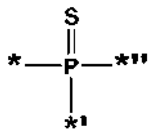
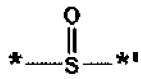
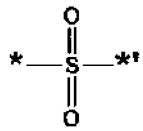

Fraction-TT

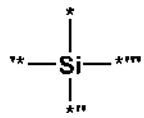

dans lesquelles, dans les formules fraction-TE et fraction-TT, et
chaque *, *', *'' et *''' indique un site de liaison à un atome adjacent.

**7.** Dispositif électroluminescent organique selon l'une quelconque des revendications 1 à 6, ledit hôte comprenant un premier composé et un second composé,

i) ledit premier composé étant un hôte de transport de trous et ledit second composé étant un hôte de transport d'électrons,
ii) ledit premier composé étant un hôte de transport d'électrons et ledit second composé étant un hôte de transport de trous,
iii) ledit premier composé et ledit second composé étant chacun un hôte bipolaire,
iv) ledit premier composé étant un hôte de transport de trous et ledit second composé étant un hôte bipolaire,
v) ledit premier composé étant un hôte de transport d'électrons et ledit second composé étant un hôte bipolaire,
vi) ledit premier composé étant un hôte bipolaire et ledit second composé étant un hôte de transport de trous, ou
vii) ledit premier composé étant un hôte bipolaire et ledit second composé étant un hôte de transport d'électrons.

**8.** Dispositif électroluminescent organique selon l'une quelconque des revendications 1 à 7, ledit émetteur comportant un temps de désintégration inférieur à 100 microsecondes ; et/ou
ledit émetteur comprenant un coeur contenant du naphtalène, un coeur contenant du fluorène, un coeur contenant du spiro-bifluorène, un coeur contenant du benzofluorène, un coeur contenant du dibenzofluorène, un coeur contenant du phénanthrène, un coeur contenant de l'anthracène, un coeur contenant du fluoranthène, un coeur contenant du triphénylène, un coeur contenant du pyrène, un coeur contenant du chrysène, un coeur contenant du picène, un coeur contenant du pérylène, un coeur contenant du pentacène, un coeur contenant de l'indénoanthracène, un coeur contenant du tétracène, un coeur contenant du bisanthracène, ou un coeur représenté par l'une des formules 501-1 à 501 -21 :

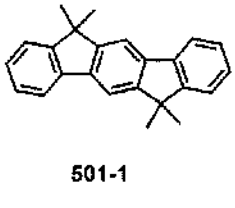

**501-1**

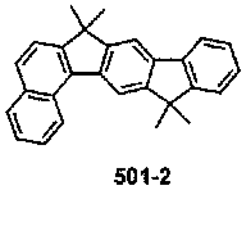

**501-2**

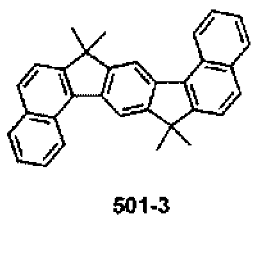

**501-3**

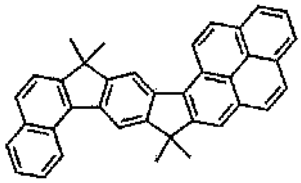
501-4

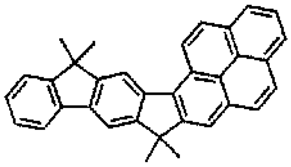
501-5

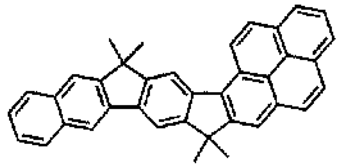
501-6

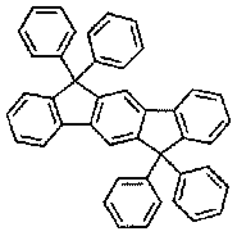
501-7

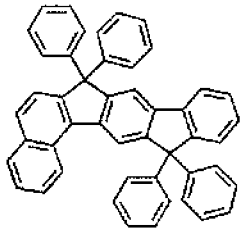
501-8

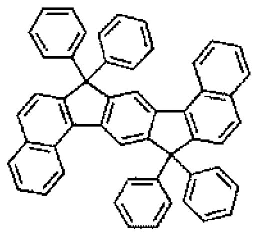
501-9

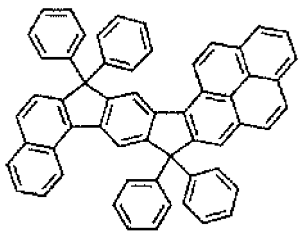
501-10

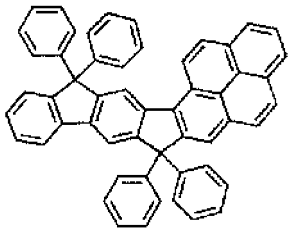
501-11

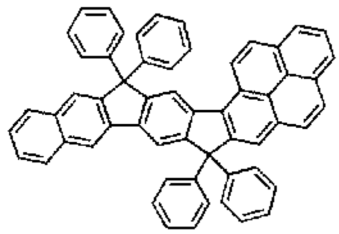
501-12

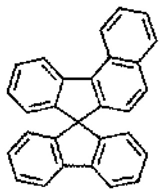
501-13

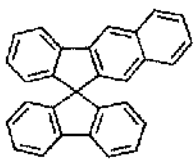
501-14

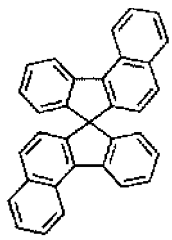
501-15

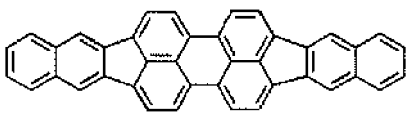
501-16

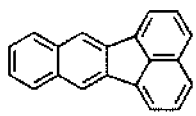
501-17

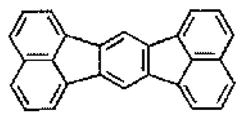
501-18

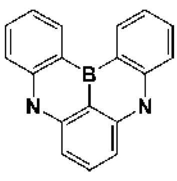
501-19

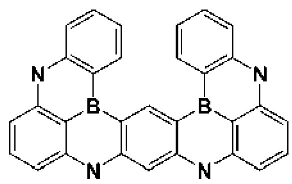
501-20

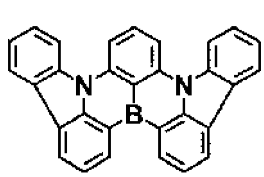
501-21

**9.** Dispositif électroluminescent organique selon l'une quelconque des revendications 1 à 8, ledit émetteur étant représenté par la formule 51 :

Formule 51

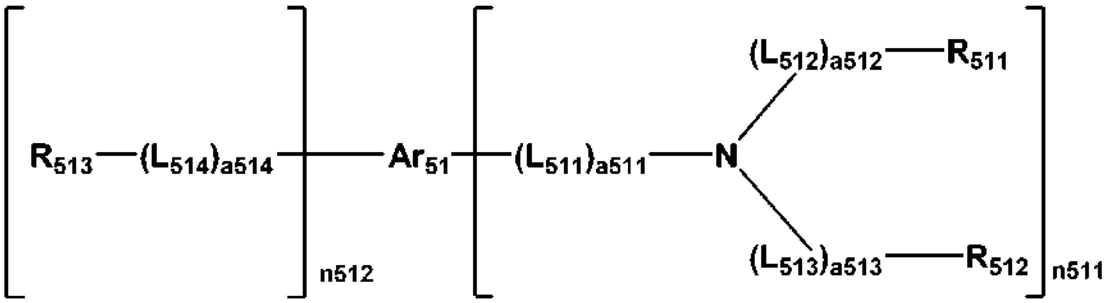

dans laquelle, dans la formule 51,

$Ar_{51}$ représente un groupe naphtalène, un groupe fluorène, un groupe spiro-bifluorène, un groupe benzofluorène, un groupe dibenzofluorène, un groupe phénanthrène, un groupe anthracène, un groupe fluoranthène, un groupe triphénylène, un groupe pyrène, un groupe chrysène, un groupe picène, un groupe perylène, un groupe pentacène, un groupe indénoanthracène, un groupe tétracène, un groupe bisanthracène, ou un groupe représenté par l'une des formules 501-1 à 501-21, chacun non substitué ou substitué par au moins un élément parmi un atome de deutérium, un groupe -F, -Cl, -Br, -I, $-SF_5$, un groupe hydroxy, un groupe cyano, un groupe nitro, un groupe amidino, un groupe hydrazine, un groupe hydrazone, un groupe acide sulfonique ou un sel de celui-ci, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_1$-$C_{20}$ alkylthio, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_7$-$C_{60}$ alkylaryle, un groupe $C_7$-$C_{60}$ arylalkyle, un groupe $C_6$-$C_{60}$ aryloxy, un groupe $C_6$-$C_{60}$ arylthio, un groupe $C_1$-$C_{60}$ hétéroaryle, un groupe $C_2$-$C_{60}$ alkylhétéroaryle, un groupe $C_1$-$C_{60}$ hétéroaryloxy, un groupe $C_1$-$C_{60}$ hétéroarylthio, un groupe polycyclique condensé non aromatique monovalent, un groupe hétéropolycyclique condensé non aromatique monovalent, $-Si(Q_{511})(Q_{512})(Q_{513})$, $-Ge(Q_{511})(Q_{512})(Q_{513})$, $-C(Q_{511})(Q_{512})(Q_{513})$, $-B(Q_{511})(Q_{512})$, $-N(Q_{511})(Q_{512})$, $-P(Q_{511})(Q_{512})$, $-C(=O)(Q_{511})$, $-S(=O)(Q_{511})$, $-S(=O)_2(Q_{511})$, $-P(=O)(Q_{511})(Q_{512})$, $-P(=S)(Q_{511})(Q_{512})$, ou une combinaison de ceux-ci :

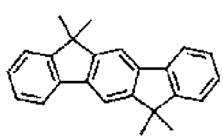

501-1

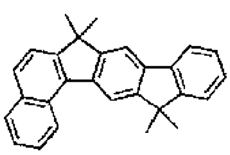

501-2

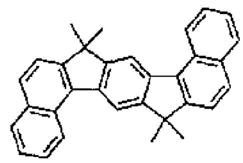

501-3

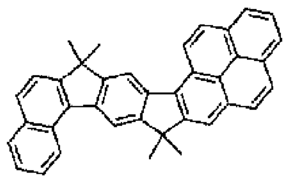

501-4

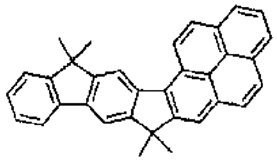

501-5

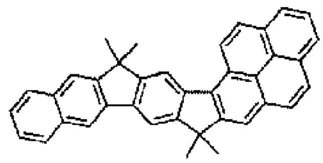

501-6

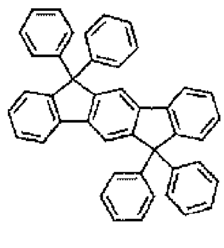

501-7

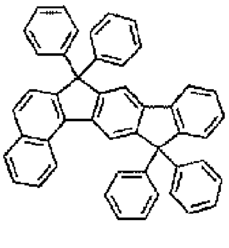

501-8

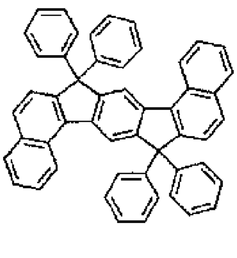

501-9

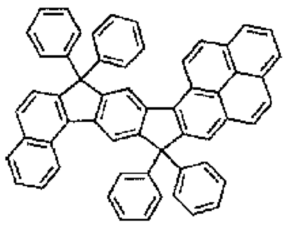
501-10

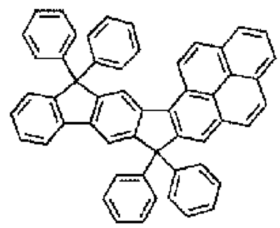
501-11

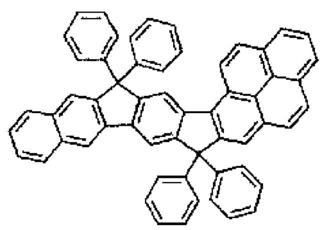
501-12

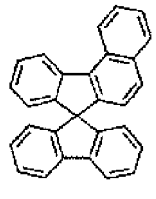
501-13

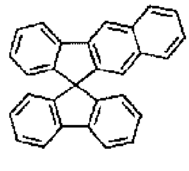
501-14

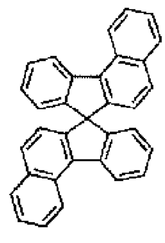
501-15

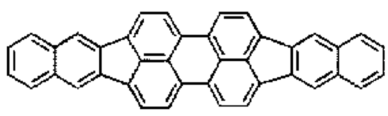
501-16

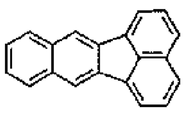
501-17

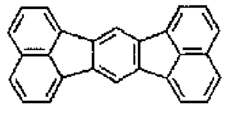
501-18

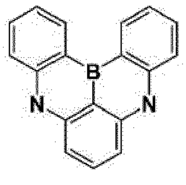
501-19

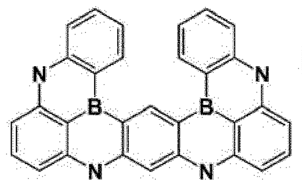
501-20

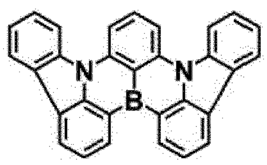
501-21

,

$L_{511}$ à $L_{514}$ représentent chacun indépendamment un groupe $C_3$-$C_{10}$ cycloalkylène substitué ou non substitué, un groupe $C_1$-$C_{10}$ hétérocycloalkylène substitué ou non substitué, un groupe $C_3$-$C_{10}$ cycloalcénylène substitué ou non substitué, un groupe $C_1$-$C_{10}$ hétérocycloalcénylène substitué ou non substitué, un groupe $C_6$-$C_{60}$ arylène substitué ou non substitué, un groupe $C_1$-$C_{60}$ hétéroarylène substitué ou non substitué, un groupe polycyclique condensé non aromatique divalent substitué ou non substitué, ou un groupe hétéropolycyclique condensé non aromatique divalent substitué ou non substitué,

a511 à a514 valent chacun indépendamment 0, 1, 2 ou 3,

$R_{511}$ à $R_{513}$ représentent chacun indépendamment un groupe $C_1$-$C_{60}$ alkyle substitué ou non substitué, un groupe $C_3$-$C_{10}$ cycloalkyle substitué ou non substitué, un groupe $C_6$-$C_{60}$ aryle substitué ou non substitué, un groupe $C_7$-$C_{60}$ alkylaryle substitué ou non substitué, un groupe $C_7$-$C_{60}$ arylalkyle substitué ou non substitué, un groupe $C_1$-$C_{60}$ hétéroaryle substitué ou non substitué, un groupe $C_2$-$C_{60}$ alkylhétéroaryle substitué ou non substitué, un groupe $C_2$-$C_{60}$ hétéroarylalkyle substitué ou non substitué, un groupe polycyclique condensé non aromatique monovalent substitué ou non substitué, ou un groupe hétéropolycyclique condensé non aromatique monovalent substitué ou non substitué,

$Q_{511}$ à $Q_{513}$ représentent chacun indépendamment un atome d'hydrogène, un atome de deutérium, un groupe -F, -Cl, -Br, -I, $-SF_5$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $C_1$-$C_{60}$ alkyle, un groupe $C_2$-$C_{60}$ alcényle, un groupe $C_2$-$C_{60}$ alcynyle, un groupe $C_1$-$C_{60}$ alcoxy, un groupe $C_1$-$C_{60}$ alkylthio, un groupe $C_3$-$C_{10}$ cycloalkyle, un groupe $C_1$-$C_{10}$ hétérocycloalkyle, un groupe $C_3$-$C_{10}$ cycloalcényle, un groupe $C_1$-$C_{10}$ hétérocycloalcényle, un groupe $C_6$-$C_{60}$ aryle, un groupe $C_7$-$C_{60}$ alkylaryle, un groupe $C_7$-$C_{60}$ arylalkyle, un groupe $C_6$-$C_{60}$ aryloxy, un groupe $C_6$-$C_{60}$ arylthio, un groupe $C_1$-$C_{60}$ hétéroaryle, un groupe $C_2$-$C_{60}$ alkylhété-

roaryle, un groupe $C_2$-$C_{60}$ hétéroarylalkyle, un groupe $C_1$-$C_{60}$ hétéroaryloxy, un groupe $C_1$-$C_{60}$ hétéroarylthio, un groupe polycyclique condensé non aromatique monovalent, ou un groupe hétéropolycyclique condensé non aromatique monovalent, chacun non substitué ou substitué par au moins un élément parmi un atome de deutérium, un groupe -F, un groupe cyano, un groupe $C_1$-$C_{20}$ alkyle, un groupe $C_6$-$C_{30}$ aryle, ou une combinaison de ceux-ci, et
n511 et n512 valent chacun indépendamment 0, 1, 2, 3, 4, 5 ou 6.

**10.** Dispositif électroluminescent organique selon l'une quelconque des revendications 1 à 9, ledit émetteur étant un composé représenté par l'un du groupe FD1 :

Groupe FD1

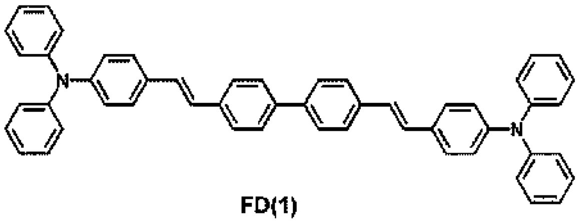
FD(1)

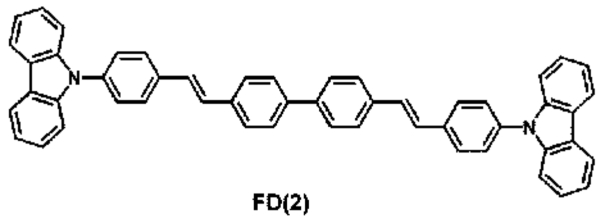
FD(2)

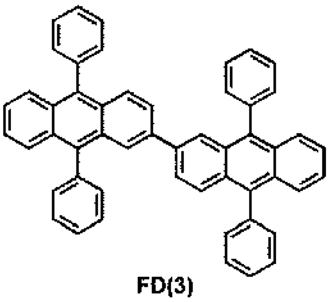
FD(3)

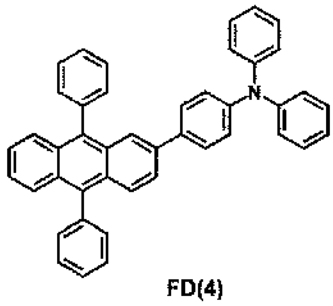
FD(4)

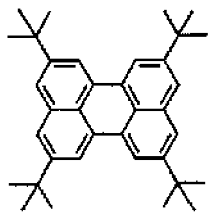
FD(5)

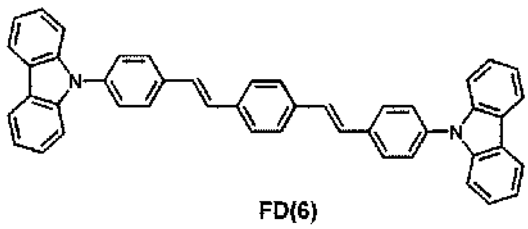
FD(6)

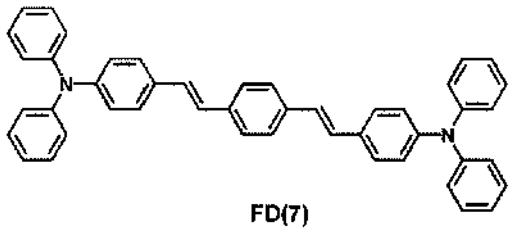
FD(7)

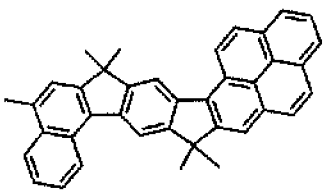
FD(8)

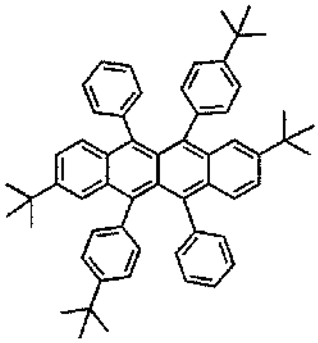
FD(9)

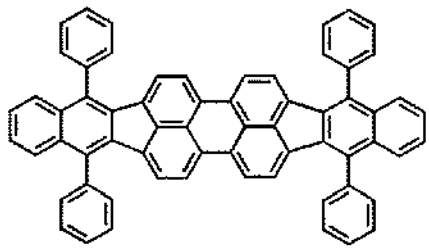
FD(10)

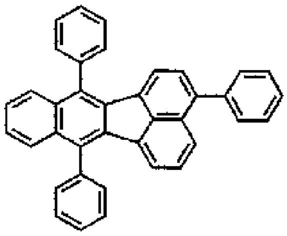

FD(11)

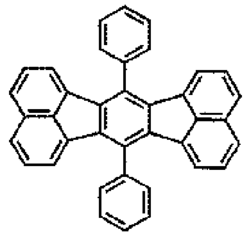

FD(12)

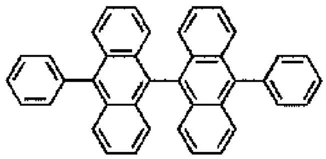

FD(13)

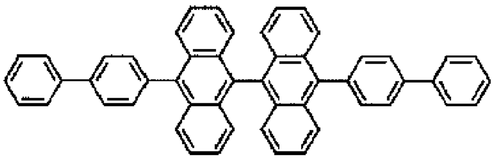

FD(14)

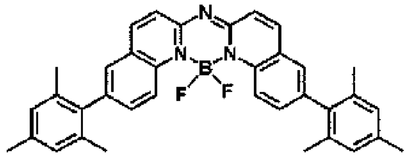

FD(15)

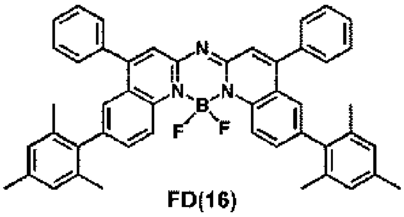

FD(16)

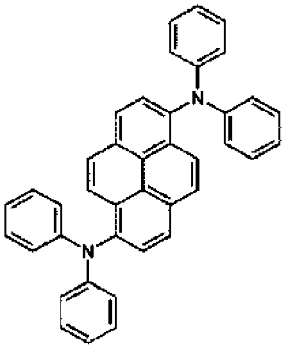

FD1

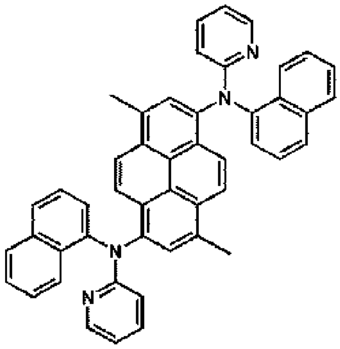

FD2

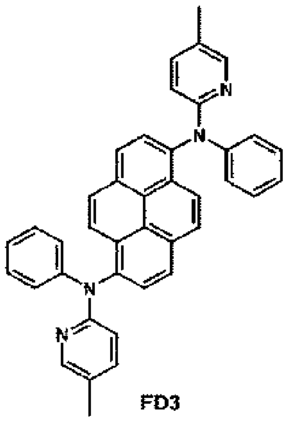

FD3

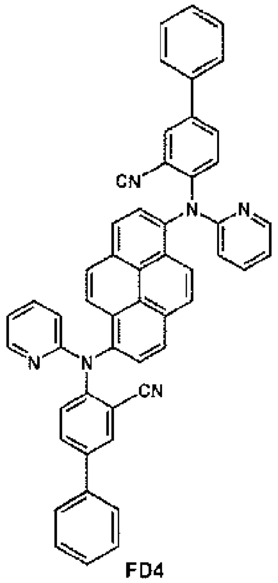
FD4

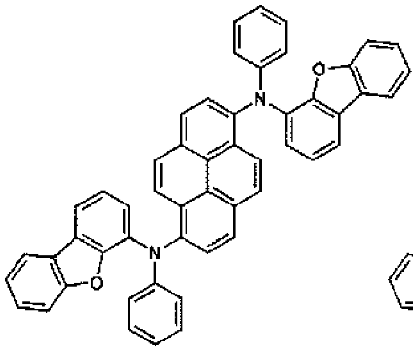
FD5

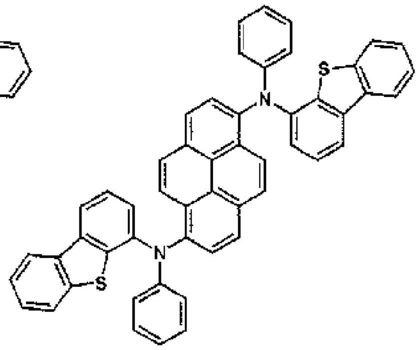
FD6

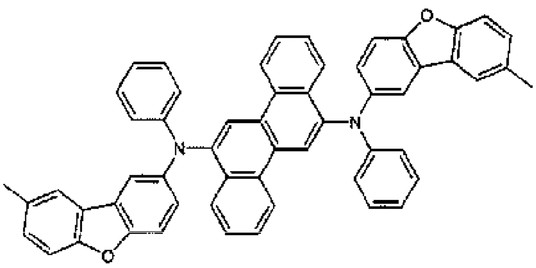
FD7

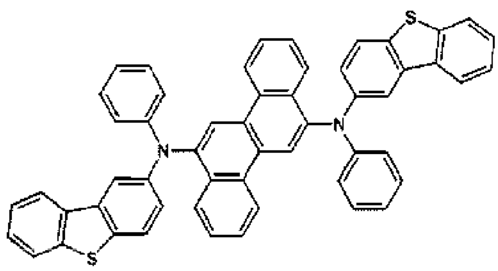
FD8

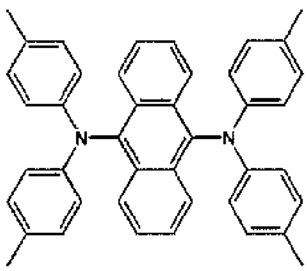
FD9

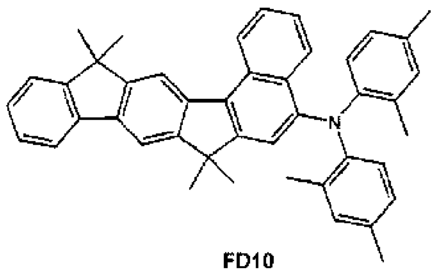
FD10

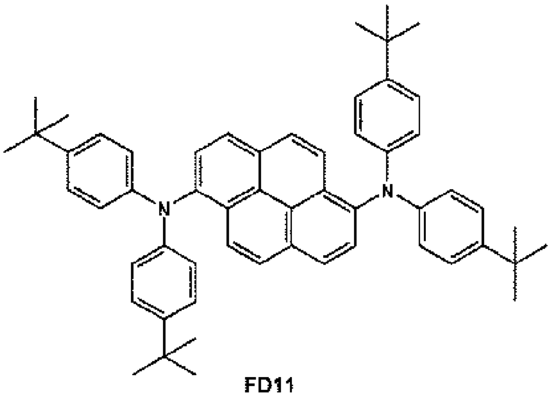
FD11

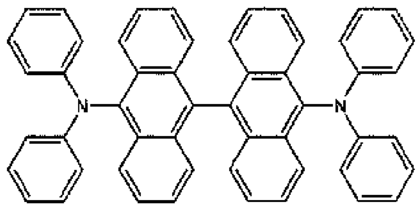
FD12

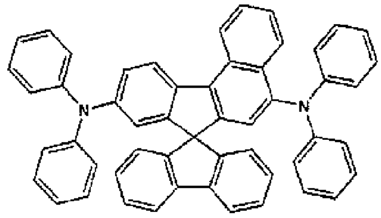

FD13

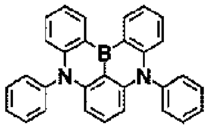

BD1-1

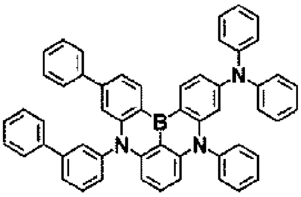

BD1-2

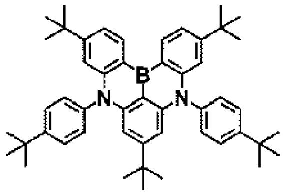

BD1-3

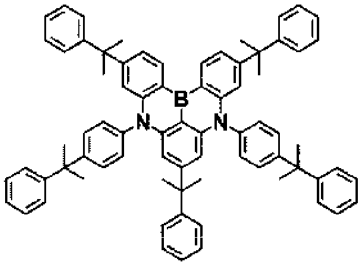

BD1-4

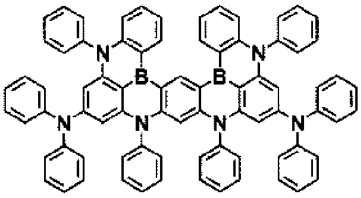

BD1-5

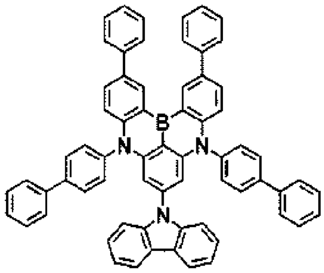

BD1-6

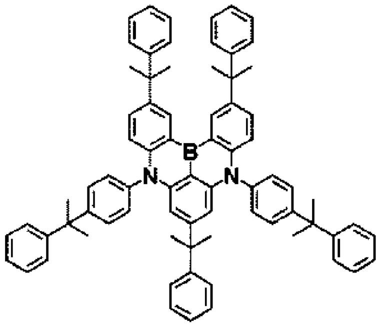

BD1-7

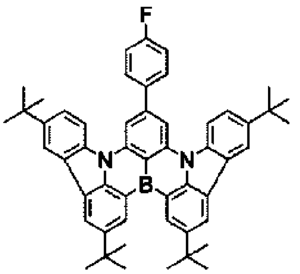

BD1-8

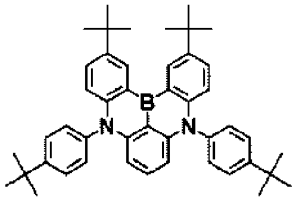

BD1-9

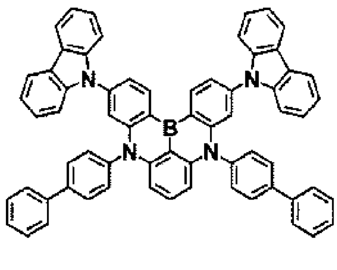

BD1-10

**11.** Dispositif électroluminescent organique selon l'une quelconque des revendications 1 à 10,

ledit hôte et ledit sensibilisateur n'émettant sensiblement pas de lumière, et
ledit émetteur émettant de la lumière.

**12.** Dispositif électroluminescent organique selon l'une quelconque des revendications 1 à 11, ladite condition 1 étant satisfaite :

Condition 1

$$S_1(H) > S_1(S) \geq S_1(E)$$

dans laquelle, dans la condition 1,

Si(H) indique le niveau d'énergie singulet excité le plus faible de l'hôte,
$S_1(S)$ indique le niveau d'énergie singulet excité le plus faible du sensibilisateur, et
$S_1(E)$ indique le niveau d'énergie singulet excité le plus faible de l'émetteur,
lesdits niveaux d'énergie étant déterminés par la théorie fonctionnelle de la densité ; et/ou
ladite condition 2 étant satisfaite :

Condition 2

$$T_1(H) \geq T_1(S)$$

dans laquelle, dans la condition 2,

$T_1(H)$ indique le niveau d'énergie triplet excité le plus faible de l'hôte, et
Ti(S) indique le niveau d'énergie triplet excité le plus faible du sensibilisateur,
lesdits niveaux d'énergie étant déterminés par la théorie fonctionnelle de la densité.

**13.** Dispositif électroluminescent organique selon l'une quelconque des revendications 1 à 12,
la teneur du sensibilisateur dans la couche d'émission se trouvant dans la plage de 1 % en poids à 50 % en poids, la teneur de l'hôte dans la couche d'émission se trouvant dans la plage de 30 % en poids à 90 % en poids, et la teneur de l'émetteur dans la couche d'émission se trouvant dans la plage de 0,01 % en poids à 15 % en poids par rapport au poids total de la couche d'émission.

**14.** Dispositif électroluminescent organique selon la revendication 1, comprenant en outre :

m unités d'émission empilées entre la première électrode et la seconde électrode, chacune comprenant au moins une couche d'émission ; et
m-1 couches génératrices de charges situées entre deux unités d'émission adjacentes parmi les m unités d'émission, chacune des m-1 couches génératrices de charges comprenant une couche génératrice de charges de type n et une couche génératrice de charges de type p,
m représentant un entier de 2 ou plus,
la longueur d'onde d'émission maximale de la lumière émise depuis au moins l'une des m unités d'émission différant de la longueur d'onde d'émission maximale de la lumière émise depuis au moins l'une des autres unités d'émission,
au moins l'une des m couches d'émission étant la couche d'émission comprenant l'hôte, le dopant et le sensibilisateur.

**15.** Dispositif électroluminescent organique selon la revendication 1, comprenant en outre :

m couches d'émission situées entre la première électrode et la seconde électrode,
m représentant un entier de 2 ou plus,
la longueur d'onde d'émission maximale de la lumière émise depuis au moins l'une des m couches d'émission différant de la longueur d'onde d'émission maximale de la lumière émise depuis au moins l'une des autres

couches d'émission,
au moins l'une des m couches d'émission étant la couche d'émission comprenant l'hôte, le sensibilisateur et l'émetteur.

FIG. 1

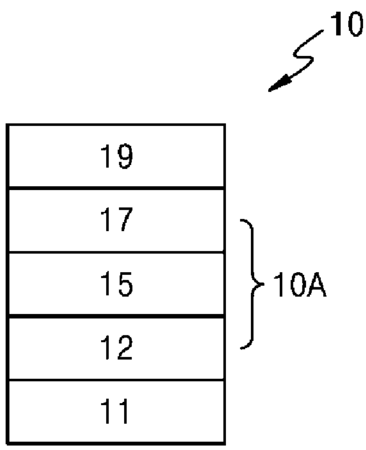

FIG. 2

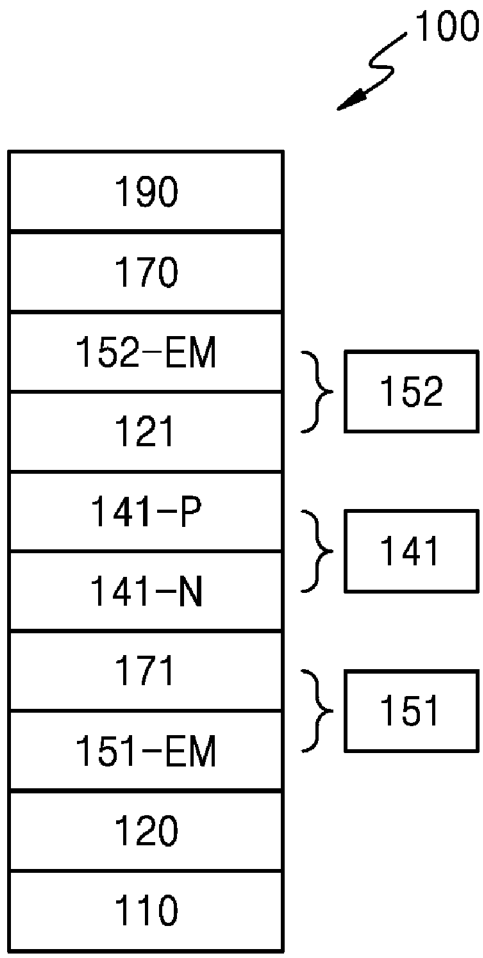

FIG. 3

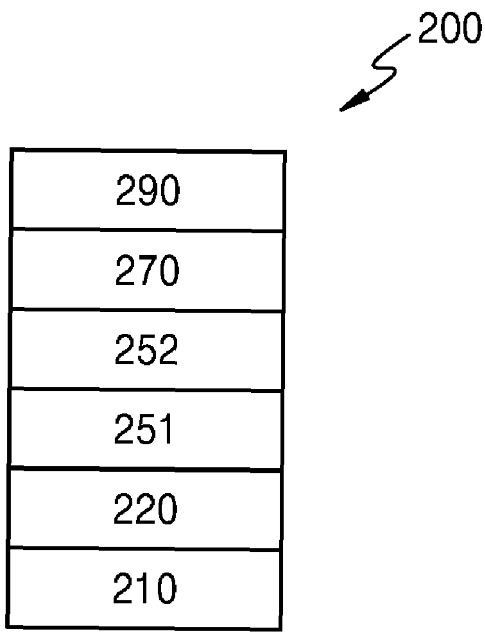

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2021288271 A1